# EUROPEAN PATENT SPECIFICATION

(11) **EP 4 214 771 B1**
(45) Date of publication and mention of the grant of the patent: **31.12.2025**
(21) Application number: 21785779.6
(22) Date of filing: 17.09.2021
(51) Int. Cl.: H10K 50/11

(54) **ORGANIC ELECTROLUMINESCENT DEVICE**
ORGANISCHE ELEKTROLUMINESZENTE VORRICHTUNG
DISPOSITIF ÉLECTROLUMINESCENT ORGANIQUE

(30) Priority: 18.09.2020 EP 20197076; 18.09.2020 EP 20197075; 18.09.2020 EP 20197074; 18.09.2020 EP 20197073; 18.09.2020 EP 20197072; 18.09.2020 EP 20197071; 22.09.2020 EP 20197589; 22.09.2020 EP 20197588; 23.12.2020 EP 20217041; 27.04.2021 EP 21170783; 27.04.2021 EP 21170775; 27.04.2021 EP 21170776; 27.04.2021 EP 21170779; 08.07.2021 EP 21184616; 08.07.2021 EP 21184619; 13.07.2021 EP 21185402; 20.07.2021 EP 21186615
(43) Date of publication of application: 26.07.2023
(60) Divisional application: 25218970.9
(73) Proprietor: Samsung Display Co., Ltd., Yongin-si, Gyeonggi-do 17113 (KR)
(72) Inventor: SHARIFIDEHSARI, Hamed, 73614 Schorndorf (DE); LIAPTSIS, Georgios, 68161 Mannheim (DE); CARBALLO, Jaime Leganés, 73430 Aalen (DE); JOLY, Damien, 76646 Bruchsal (DE)
(74) Representative: Jacobi, Markus Alexander
(86) International application number: PCT/EP2021/075637
(87) International publication number: WO 2022/058512

(56) References cited:
- US-A1- 2020 136 059
- SEREVICIUS TOMAS ET AL: "Achieving Submicrosecond Thermally Activated Delayed Fluorescence Lifetime and Highly Efficient Electroluminescence by Fine-Tuning of the Phenoxazine-Pyrimidine Structure", APPLIED MATERIALS & INTERFACES, vol. 12, no. 9, 4 March 2020 (2020-03-04), US, pages 10727 - 10736, XP055870545, ISSN: 1944-8244, Retrieved from the Internet <URL:https://pubs.acs.org/doi/pdf/10.1021/acsami.9b21394> [retrieved on 20211208], DOI: 10.1021/acsami.9b21394

## Description

The present invention relates to organic electroluminescent devices comprising one or more light-emitting layers B, each of which is composed of one or more sublayers, wherein the one or more sublayers of each light-emitting layer B as a whole comprise at least one host material H^{B}, at least one phosphorescence material P^{B}, at least one small FWHM emitter S^{B}, and optionally at least one TADF material E^{B}, wherein the at least one, preferably each, S^{B} emits light with a full width at half maximum (FWHM) of less than or equal to 0.25 eV. Furthermore, the present invention relates to a method for generating light by means of an organic electroluminescent device according to the present invention.

### Description

Organic electroluminescent devices containing one or more light-emitting layers based on organics such as, e.g. organic light-emitting diodes (OLEDs), light-emitting electrochemical cells (LECs) and light-emitting transistors gain increasing importance. In particular, OLEDs are promising devices for electronic products such as e.g. screens, displays and illumination devices. In contrast to most electroluminescent devices essentially based on inorganics, organic electroluminescent devices based on organics are often rather flexible and producible in particularly thin layers. The OLED-based screens and displays already available today bear either good efficiencies and long lifetimes or good color purity and long lifetimes, but do not combine all three properties, i.e. good efficiency, long lifetime, and good color purity.

The color purity or color point of an OLED is typically provided by CIEx and CIEy coordinates, whereas the color gamut for the next display generation is provided by so-called BT-2020 and DCPI3 values. Generally, in order to achieve these color coordinates, top emitting devices are needed to adjust the color coordinate by changing the cavity. In order to achieve high efficiency in top emitting devices while targeting these color gamut, a narrow emission spectrum in bottom emitting devices is needed.

State-of-the-art phosphorescence emitters exhibit a rather broad emission, which is reflected in a broad emission of phosphorescence-based OLEDs (PHOLEDs) with a full-width-half-maximum (FWHM) of the emission spectrum, which is typically larger than 0.25 eV. The broad emission spectrum of PHOLEDs in bottom devices, leads to high losses in out-coupling efficiency for top emitting device structure while targeting BT-2020 and DCPI3 color gamut.

Additionally, phosphorescence materials are typically based on transition metals, e.g. iridium, which are quite expensive materials within the OLED stack due to their typically low abundance. Thus, transition metal based materials have the most potential for cost reduction of OLEDs. Lowering of the content of transition metals within the OLED stack thus is a key performance indicator for pricing of OLED applications.

Recently, some fluorescence or thermally-activated-delayed-fluorescence (TADF) emitters have been developed that display a rather narrow emission spectrum, which exhibits an FWHM of the emission spectrum, which is typically smaller than or equal to 0.25 eV, and therefore more suitable to achieve BT-2020 and DCPI3 color gamut. However, such fluorescence and TADF emitters typically suffer from low efficiency due to decreasing efficiencies at higher luminance (i.e. the roll-off behaviour of an OLED) as well as low lifetimes due to for example the exciton-polaron annihilation or exciton-exciton annihilation.

These disadvantages may be overcome to some extend by applying so-called hyper approaches. The latter rely on the use of an energy pump which transfers energy to a fluorescent emitter preferably displaying a narrow emission spectrum as stated above. The energy pump may for example be a TADF material displaying reversed-intersystem crossing (RISC) or a transition metal complex displaying efficient intersystem crossing (ISC). However, these approaches still do not provide organic electroluminescent devices combining all of the aforementioned desirable features, namely: good efficiency, long lifetime, and good color purity.

A central element of an organic electroluminescent device for generating light typically is the at least one light-emitting layer placed between an anode and a cathode. When a voltage (and electrical current) is applied to an organic electroluminescent device, holes and electrons are injected from an anode and a cathode, respectively.

Typically, a hole transport layer is(typically) located between a light-emitting layer and an anode, and an electron transport layer is typically located between a light-emitting layer and a cathode. The different layers are sequentially disposed. Excitons of high energy are then generated by recombination of the holes and the electrons in a light-emitting layer. The decay of such excited states (e.g., singlet states such as S1 and/or triplet states such as T1 to the ground state (S0) desirably leads to the emission of light.

The document US 2020/136059 A1 discloses an OLED device comprising multiple complementary luminescent compounds and a host material in the emission layer.

Surprisingly, it has been found that an organic electroluminescent device's light-emitting layer consisting of one or more layers comprising a phosphorescence material, a small full width at half maximum (FWHM) emitter, a host material, and optionally a TADF material, provides an organic electroluminescent device having a long lifetime, a high quantum yield and exhibiting narrow emission, ideally suitable to achieve the BT-2020 and DCPI3 color gamut.

Herein, a phosphorescence material and/or an optional TADF material might transfer energy to a small full width at half maximum (FWHM) emitter displaying emission of light.

The present invention relates to an organic electroluminescent device comprising at least one light-emitting layer B which is composed of one or more sublayers, wherein the one or more sublayers are adjacent to each other and as a whole contain:
(i) at least one host material H^{B}, which has a lowermost excited singlet state energy level E(S1^{H}) and a lowermost excited triplet state energy level E(T1^{H}); and
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1^{S}) and a lowermost excited triplet state energy level E(T1^{S}), wherein S^{B} emits light with a full width at half maximum (FWHM) of less than or equal to 0.25 eV; and optionally
(iv) at least one thermally activated delayed fluorescence (TADF) material E^{B}, which has a lowermost excited singlet state energy level E(S1^{E}) and a lowermost excited triplet state energy level E(T1^{E}),
wherein the one or more sublayers which are located at the outer surface of a light-emitting layer B contain at least one (emitter) material selected from the group consisting of phosphorescence material P^{B}, small FWHM emitter S^{B}, and TADF material E^{B}.

One aspect of the present invention relates to an organic electroluminescent device which comprises at least one light-emitting layer B comprising one or more sublayers, wherein the one or more sublayers are adjacent to each other and as a whole contain:
(i) a host material H^{B}, which has a lowermost excited singlet state energy level E(S1^{H}) and a lowermost excited triplet state energy level E(T1^{H}); and
(ii) a phosphorescence material P^{B}, which has a lowermost excited singlet state energy level E(S1^{P}) and a lowermost excited triplet state energy level E(T1^{P}); and
(iii) a small full width at half maximum (FWHM) emitter S^{B}, which has a lowermost excited singlet state energy level E(S1^{S}) and a lowermost excited triplet state energy level E(T1^{S}), wherein S^{B} emits light with a full width at half maximum (FWHM) of less than or equal to 0.25 eV; and optionally
(iv) a thermally activated delayed fluorescence (TADF) material E^{B}, which has a lowermost excited singlet state energy level E(S1^{E}) and a lowermost excited triplet state energy level E(T1^{E}),
wherein the one or more sublayers which are located at the outer surface of a light-emitting layer B contain at least one (emitter) material selected from the group consisting of phosphorescence material P^{B}, small FWHM emitter S^{B}, and TADF material E^{B}.

In one embodiment of the invention, at least one of the one or more sublayers of the at least one light-emitting layer B comprises:
(iv) at least one thermally activated delayed fluorescence (TADF) material E^{B}, which has a lowermost excited singlet state energy level E(S1^{E}) and a lowermost excited triplet state energy level E(T1^{E}).

In one embodiment of the invention, the organic electroluminescent device comprises at least one light-emitting layer B composed of one or more sublayers, wherein the one or more sublayers of the light-emitting layer B comprise:
(i) at least one host material H^{B}, which has a lowermost excited singlet state energy level E(S1^{H}) and a lowermost excited triplet state energy level E(T1^{H}); and
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1^{S}) and a lowermost excited triplet state energy level E(T1^{S}),
   wherein S^{B} emits light with a full width at half maximum (FWHM) of less than or equal to 0.25 eV; and optionally
(iv) at least one thermally activated delayed fluorescence (TADF) material E^{B}, which has a lowermost excited singlet state energy level E(S1^{E}) and a lowermost excited triplet state energy level E(T1^{E}).

In one embodiment of the invention, the organic electroluminescent device comprises at least one light-emitting layer B composed of one or more sublayers, wherein the one or more sublayers of the light-emitting layer B comprise:
(i) a host material H^{B}, which has a lowermost excited singlet state energy level E(S1^{H}) and a lowermost excited triplet state energy level E(T1^{H}); and
(ii) a phosphorescence material P^{B}, which has a lowermost excited singlet state energy level E(S1^{P}) and a lowermost excited triplet state energy level E(T1^{P}); and
(iii) a small full width at half maximum (FWHM) emitter S^{B}, which has a lowermost excited singlet state energy level E(S1^{S}) and a lowermost excited triplet state energy level E(T1^{S}),
   wherein S^{B} emits light with a full width at half maximum (FWHM) of less than or equal to 0.25 eV; and
(iv) a thermally activated delayed fluorescence (TADF) material E^{B}, which has a lowermost excited singlet state energy level E(S1^{E}) and a lowermost excited triplet state energy level E(T1^{E}).

In one embodiment of the invention, the organic electroluminescent device comprises at least one light-emitting layer B composed of one or more sublayers, wherein the one or more sublayers of the light-emitting layer B comprise:
(i) at least one host material H^{B}, which has a lowermost excited singlet state energy level E(S1^{H}) and a lowermost excited triplet state energy level E(T1^{H}); and
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1^{S}) and a lowermost excited triplet state energy level E(T1^{S}),
   wherein S^{B} emits light with a full width at half maximum (FWHM) of less than or equal to 0.25 eV; and
(iv) at least one thermally activated delayed fluorescence (TADF) material E^{B}, which has a lowermost excited singlet state energy level E(S1^{E}) and a lowermost excited triplet state energy level E(T1^{E}).

In one embodiment of the invention, the organic electroluminescent device comprises at least one light-emitting layer B comprising:
(i) at least one host material H^{B}, which has a lowermost excited singlet state energy level E(S1^{H}) and a lowermost excited triplet state energy level E(T1^{H}); and
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1^{S}) and a lowermost excited triplet state energy level E(T1^{S}), wherein S^{B} emits light with a full width at half maximum (FWHM) of less than or equal to 0.25 eV; and
(iv) at least one thermally activated delayed fluorescence (TADF) material E^{B}, which has a lowermost excited singlet state energy level E(S1^{E}) and a lowermost excited triplet state energy level E(T1^{E}).

In one embodiment of the invention, the organic electroluminescent device comprises a light-emitting layer B composed of exactly one layer comprising:
(i) a host material H^{B}; and
(ii) a phosphorescence material P^{B}; and
(iii) a small full width at half maximum (FWHM) emitter S^{B}; and optionally
(iv) a TADF material E^{B}.

In a preferred embodiment, the organic electroluminescent device comprises a light-emitting layer B composed of exactly one layer comprising:
(i) at least one host material H^{B}; and
(ii) at least one phosphorescence material P^{B}; and
(iii) at least one small full width at half maximum (FWHM) emitter S^{B}; and
(iv) at least one thermally activated delayed fluorescence (TADF) material E^{B}.

### Combination of sublayers

In a preferred embodiment of the invention, the electroluminescent device according to the invention comprises at least one light-emitting layer B consisting of exactly one (sub)layer. In a preferred embodiment of the invention, each light-emitting layer B comprised in the electroluminescent device according to the invention consists of exactly one (sub)layer. In a preferred embodiment of the invention, the electroluminescent device according to the invention comprises exactly one light-emitting layer B consisting of exactly one (sub)layer.

In another embodiment of the invention, the electroluminescent device according to the invention comprises at least one light-emitting layer B composed of more than one sublayer. In another embodiment of the invention, each light-emitting layer B comprised in the electroluminescent device according to the invention comprises more than one sublayer. In another embodiment of the invention, each light-emitting layer B comprised in the electroluminescent device according to the invention consists of more than one sublayer.

In another embodiment of the invention, the electroluminescent device according to the invention comprises exactly one light-emitting layer B composed of more than one sublayer. In another embodiment of the invention, the electroluminescent device according to the invention comprises at least one light-emitting layer B composed of exactly two sublayers.

In another embodiment of the invention, each light-emitting layer B comprised in the electroluminescent device according to the invention is composed of exactly two sublayers. In another embodiment of the invention, the electroluminescent device according to the invention comprises exactly one light-emitting layer B composed of exactly two sublayers.

In another embodiment of the invention, the electroluminescent device according to the invention comprises at least one light-emitting layer B composed of more than two sublayers. In another embodiment of the invention, each light-emitting layer B comprised in the electroluminescent device according to the invention is composed of more than two sublayers.

In another embodiment of the invention, the electroluminescent device according to the invention comprises exactly one light-emitting layer B composed of more than two sublayers.

In one embodiment of the invention, each light-emitting layer B of the organic electroluminescent device according to the invention comprises exactly one, exactly two, or exactly three sublayers.

It is understood that different sublayers of a light-emitting layer B do not necessarily all comprise the same materials or even the same materials in the same ratios.

It is understood that different sublayers of a light-emitting layer B are adjacent to each other.

In one embodiment of the invention, at least one sublayer comprises exactly one TADF material E^{B} and exactly one phosphorescence material P^{B}.

In one embodiment of the invention, an electroluminescent device according to the invention comprises at least one light-emitting layer B composed of more than one sublayers, wherein at least one sublayer does not comprise a TADF material E^{B}, a phosphorescence material P^{B}, or a small FWHM emitter S^{B}.

In one embodiment of the invention, an electroluminescent device according to the invention comprises at least one light-emitting layer B composed of one or more than one sublayers, wherein at least one sublayer comprises at least one host material H^{B}, exactly one phosphorescence material P^{B}, and exactly one small FWHM emitter S^{B}.

In one embodiment of the invention, an electroluminescent device according to the invention comprises at least one light-emitting layer B composed of one or more than one sublayers, wherein at least one sublayer comprises at least one host material H^{B}, exactly one TADF material E^{B}, exactly one phosphorescence material P^{B}, and exactly one small FWHM emitter S^{B}.

In one embodiment of the invention, an electroluminescent device according to the invention comprises at least one light-emitting layer B composed of one or more than one sublayers, wherein at least one sublayer comprises exactly one host material H^{B}, exactly one TADF material E^{B}, exactly one phosphorescence material P^{B}, and exactly one small FWHM emitter S^{B}.

In one embodiment of the invention, an electroluminescent device according to the invention comprises at least one light-emitting layer B composed of one or more than one sublayers, wherein at least one sublayer comprises exactly one host material H^{B}, exactly one phosphorescence material P^{B}, and exactly one small FWHM emitter S^{B}.

In a preferred embodiment of the invention, an electroluminescent device according to the invention comprises at least one light-emitting layer B composed of one or more than one sublayers, wherein at least one sublayer comprises exactly one host material H^{B}.

In a preferred embodiment of the invention, an electroluminescent device according to the invention comprises at least one light-emitting layer B composed of one or more than one sublayers, wherein at least one sublayer comprises exactly one TADF material E^{B}.

In a preferred embodiment of the invention, an electroluminescent device according to the invention comprises at least one light-emitting layer B composed of one or more than one sublayers, wherein at least one sublayer comprises exactly one phosphorescence material P^{B}.

In a preferred embodiment of the invention, an electroluminescent device according to the invention comprises at least one light-emitting layer B composed of one or more than one sublayers, wherein at least one sublayer comprises exactly one small FWHM emitter S^{B}.

In a preferred embodiment of the invention, an electroluminescent device according to the invention comprises at least one light-emitting layer B composed of one or more than one sublayers, wherein at least one sublayer comprises exactly one host material H^{B} and exactly one TADF material E^{B}.

In a preferred embodiment of the invention, an electroluminescent device according to the invention comprises at least one light-emitting layer B composed of one or more than one sublayers, wherein at least one sublayer comprises exactly one host material H^{B} and exactly one phosphorescence material P^{B}.

In a preferred embodiment of the invention, an electroluminescent device according to the invention comprises at least one light-emitting layer B composed of one or more than one sublayers, wherein at least one sublayer comprises exactly one host material H^{B} and exactly one small FWHM emitter S^{B}.

In a preferred embodiment of the invention, an electroluminescent device according to the invention comprises at least one light-emitting layer B composed of one or more than one sublayers, wherein at least one sublayer comprises exactly one TADF material E^{B} and exactly one small FWHM emitter S^{B}.

In a preferred embodiment of the invention, an electroluminescent device according to the invention comprises at least one light-emitting layer B composed of one or more than one sublayers, wherein at least one sublayer comprises exactly one TADF material E^{B} and exactly one phosphorescence material P^{B}.

In a preferred embodiment of the invention, an electroluminescent device according to the invention comprises at least one light-emitting layer B composed of one or more than one sublayers, wherein at least one sublayer comprises exactly one phosphorescence material P^{B} and exactly one small FWHM emitter S^{B}.

In a preferred embodiment of the invention, an electroluminescent device according to the invention comprises at least one light-emitting layer B composed of one or more than one sublayers, wherein at least one sublayer comprises exactly one host material H^{B}, exactly one TADF material E^{B}, and exactly one small FWHM emitter S^{B}.

In a preferred embodiment of the invention, an electroluminescent device according to the invention comprises at least one light-emitting layer B composed of one or more than one sublayers, wherein at least one sublayer comprises exactly one host material H^{B}, exactly one TADF material E^{B}, and exactly one phosphorescence material P^{B}.

In a preferred embodiment of the invention, an electroluminescent device according to the invention comprises at least one light-emitting layer B composed of one or more than one sublayers, wherein at least one sublayer comprises exactly one host material H^{B}, exactly one phosphorescence material P^{B}, and exactly one small FWHM emitter S^{B}.

In a preferred embodiment of the invention, an electroluminescent device according to the invention comprises at least one light-emitting layer B composed of one or more than one sublayers, wherein at least one sublayer comprises exactly one phosphorescence material P^{B}, exactly one TADF material E^{B}, and exactly one small FWHM emitter S^{B}.

In a preferred embodiment of the invention, an electroluminescent device according to the invention comprises at least one light-emitting layer B composed of one or more than one sublayers, wherein at least one sublayer comprises exactly one host material H^{B}, exactly one TADF material E^{B}, exactly one phosphorescence material P^{B}, and exactly one small FWHM emitter S^{B}.

In a preferred embodiment of the invention, a sublayer comprises exactly one TADF material E^{B} and a sublayer (preferably another sublayer) comprises exactly one phosphorescence material P^{B} and exactly one small FWHM emitter S^{B}.

In a preferred embodiment of the invention, an electroluminescent device according to the invention comprises at least one light-emitting layer B comprising (or consisting of) three or more than three sublayers, wherein the first sublayer B1 comprises exactly one TADF material E^{B}, the second sublayer B2 exactly one phosphorescence material P^{B}, and the third sublayer B3 comprises exactly one small FWHM emitter S^{B}.

It is understood that the sublayers of a light-emitting layer B can be fabricated in different orders, e.g., B1 - B2 - B3, B1 - B3 - B2, B2 - B1 - B3, B2 - B3 - B1, B3 - B2 - B1, B3 - B1 - B2, and with one or more different sublayers in between.

In a preferred embodiment of the invention, an electroluminescent device according to the invention comprises at least one light-emitting layer B comprising (or consisting of) two or more than two sublayers, wherein the first sublayer B1 comprises exactly one TADF material E^{B} and exactly one phosphorescence material P^{B}, and the second sublayer B2 comprises exactly one small FWHM emitter S^{B}.

In a preferred embodiment of the invention, an electroluminescent device according to the invention comprises at least one light-emitting layer B comprising (or consisting of) two or more than two sublayers, wherein the first sublayer B1 comprises exactly one TADF material E^{B} and the second sublayer B2 comprises exactly one phosphorescence material P^{B} and exactly one small FWHM emitter S^{B}.

In a preferred embodiment of the invention, an electroluminescent device according to the invention comprises at least one light-emitting layer B comprising (or consisting of) two or more than two sublayers, wherein the first sublayer B1 comprises exactly one phosphorescence material P^{B}, and the second sublayer B2 comprises exactly one TADF material E^{B} and exactly one small FWHM emitter S^{B}.

In a preferred embodiment of the invention, an electroluminescent device according to the invention comprises at least one light-emitting layer B comprising (or consisting of) two or more than two sublayers, wherein the first sublayer B1 comprises exactly one small FWHM emitter S^{B}, and the second sublayer B2 comprises exactly one TADF material E^{B} and exactly one phosphorescence material P^{B}. In a preferred embodiment, sublayers B1 and B2 are (directly) adjacent to each other, in other words, are in (direct) contact with each other.

It is understood that an organic electroluminescent device according to the invention may optionally also comprise one or more light-emitting layers which do not fulfill the requirements given for a light-emitting layer B in the context of the present invention. In other words: An organic electroluminescent device according to the present invention comprises at least one light-emitting layer B as defined herein and may optionally comprise one or more additional light-emitting layers for which the requirements given herein for a light-emitting layer B do not necessarily apply. In another embodiment of the invention, at least one, but not all light-emitting layers comprised in an organic electroluminescent device according to the invention are light-emitting layers B as defined within the specific embodiments of the invention.

In a preferred embodiment of the invention, each light-emitting layer comprised in an organic electroluminescent device according to the invention is a light-emitting layer B as defined within the specific embodiments of the invention.

### Composition of the light-emitting layer(s) (EML) B

The (at least one) host material H^{B}, (at least one) phosphorescence material P^{B}, and the (at least one) small FWHM emitter S^{B} may be comprised in the organic electroluminescent device in any amount and any ratio.

In a preferred embodiment, the (at least one) host material H^{B}, (at least one) phosphorescence material P^{B}, (at least one) thermally activated delayed fluorescence (TADF) material E^{B}, and the (at least one) small FWHM emitter S^{B} may be comprised in the organic electroluminescent device in any amount and any ratio.

In a preferred embodiment of the invention, the electroluminescent device according to the invention comprises at least one light-emitting layer B composed of one or more than one sublayer, wherein each of the at least one sublayer comprises more of the (at least one) host material H^{B} (more specific: H^{P} and/or H^{N} and/or H^{BP}), than of the (at least one) small FWHM emitter S^{B}, according to the weight.

In a preferred embodiment of the invention, the electroluminescent device according to the invention comprises at least one light-emitting layer B composed of one or more than one sublayer, wherein each of the at least one sublayer comprises more of the (at least one) host material H^{B} (more specific: H^{P} and/or H^{N} and/or H^{BP}), than of the (at least one) phosphorescence material P^{B}, according to the weight.

In a preferred embodiment of the invention, the electroluminescent device according to the invention comprises at least one light-emitting layer B composed of one or more than one sublayer, wherein each of the at least one sublayer comprises more of the (at least one) host material H^{B} (more specific: H^{P} and/or H^{N} and/or H^{BP}), than of the (at least one) TADF material E^{B}, according to the weight.

In a preferred embodiment of the invention, each of the at least one light-emitting layer B in an organic electroluminescent device according to the present invention comprises more of the at least one TADF material E^{B} than of the at least one small FWHM emitter S^{B}, according to the weight.

In a preferred embodiment, in the organic electroluminescent device according to the present invention, the at least one light-emitting layer B as a whole (consisting of one (sub)layer or comprising more than one sublayers) comprises (or consists of):
(i) 30-99.8% by weight of one or more host materials H^{B};
(ii) 0.1-30% by weight of one or more phosphorescence materials P^{B}; and
(iii) 0.1-10% by weight of one or more small FWHM emitters S^{B}; and optionally
(v) 0-69.8% by weight of one or more solvents.

In a preferred embodiment, in the organic electroluminescent device according to the present invention, the at least one light-emitting layer B as a whole (consisting of one (sub)layer or comprising more than one sublayers) comprises (or consists of):
(i) 30-99.8% by weight, preferably 60-99.8% by weight, of one or more host materials H^{B};
(ii) 0.1-50% by weight, preferably 0.1-30% by weight, of one or more phosphorescence materials P^{B}; and
(iii) 0.1-20% by weight, preferably 0.1-10% by weight, of one or more small FWHM emitters S^{B}; and optionally
(v) 0-3% by weight of one or more solvents.

In a preferred embodiment, in the organic electroluminescent device according to the present invention, the at least one light-emitting layer B as a whole (consisting of one (sub)layer or comprising more than one sublayers) comprises (or consists of):
(i) 30-99.8% by weight of one or more host materials H^{B};
(ii) 0.1-20% by weight of one or more phosphorescence materials P^{B}; and
(iii) 0.1-10% by weight of one or more small FWHM emitters S^{B}; and optionally
(v) 0-69.8% by weight of one or more solvents.

In a preferred embodiment, in the organic electroluminescent device according to the present invention, the at least one light-emitting layer B as a whole (consisting of one (sub)layer or comprising more than one sublayers) comprises (or consists of):
(i) 30-99.8% by weight, preferably 70-99.8% by weight, of one or more host materials H^{B};
(ii) 0.1-20% by weight of one or more phosphorescence materials P^{B}; and
(iii) 0.1-50% by weight, preferably 0.1-10% by weight, of one or more small FWHM emitters S^{B}; and optionally
(v) 0-3% by weight of one or more solvents.

In a preferred embodiment, wherein E^{B} is optional, in an organic electroluminescent device according to the present invention, the (at least one) light-emitting layer B as a whole (consisting of one (sub)layer or comprising more than one sublayers) comprises (or consists of):
(i) 30-99.8% by weight of one or more host materials H^{B};
(ii) 0.1-30% by weight of one or more phosphorescence materials P^{B}; and
(iii) 0.1-10% by weight of one or more small FWHM emitters S^{B}; and optionally
(iv) 0-69.8 by weight of one or more TADF material E^{B}; and optionally
(v) 0-69.8% by weight of one or more solvents.

In a preferred embodiment, wherein E^{B} is optional, in an organic electroluminescent device according to the present invention, the (at least one) light-emitting layer B as a whole (consisting of one (sub)layer or comprising more than one sublayers) comprises (or consists of):
(i) 30-99.8% by weight of one or more host materials H^{B};
(ii) 0.1-30% by weight of one or more phosphorescence materials P^{B}; and
(iii) 0.1-10% by weight of one or more small FWHM emitters S^{B}; and optionally
(iv) 0-69.8 by weight of one or more TADF material E^{B}; and optionally
(v) 0-3% by weight of one or more solvents.

In a preferred embodiment, wherein E^{B} is optional, in an organic electroluminescent device according to the present invention, the (at least one) light-emitting layer B as a whole (consisting of one (sub)layer or comprising more than one sublayers) comprises (or consists of):
(i) 30-99.8% by weight of one or more host materials H^{B};
(ii) 0.1-20% by weight of one or more phosphorescence materials P^{B}; and
(iii) 0.1-10% by weight of one or more small FWHM emitters S^{B}; and optionally
(iv) 0-69.8 by weight of one or more TADF materials E^{B}; and optionally
(v) 0-69.8% by weight of one or more solvents.

In a preferred embodiment, wherein E^{B} is optional, in an organic electroluminescent device according to the present invention, the (at least one) light-emitting layer B as a whole (consisting of one (sub)layer or comprising more than one sublayers) comprises (or consists of):
(i) 30-99.8% by weight of one or more host materials H^{B};
(ii) 0.1-20% by weight of one or more phosphorescence materials P^{B}; and
(iii) 0.1-10% by weight of one or more small FWHM emitters S^{B}; and optionally
(iv) 0-69.8 by weight of one or more TADF materials E^{B}; and optionally
(v) 0-3% by weight of one or more solvents.

In an even more preferred embodiment, wherein E^{B} is necessary, in an organic electroluminescent device according to the present invention, the (at least one) light-emitting layer B as a whole (consisting of one (sub)layer or comprising more than one sublayers) comprises (or consists of):
(i) 30-87.8% by weight of one or more host materials H^{B};
(ii) 0.1-30% by weight of one or more phosphorescence materials P^{B}; and
(iii) 0.1-10% by weight of one or more small FWHM emitters S^{B}; and
(iv) 12-40% by weight of one or more TADF materials E^{B}; and optionally
(v) 0-57.8% by weight of one or more solvents.

In an even more preferred embodiment, wherein E^{B} is necessary, in an organic electroluminescent device according to the present invention, the (at least one) light-emitting layer B as a whole (consisting of one (sub)layer or comprising more than one sublayers) comprises (or consists of):
(i) 30-87.8% by weight of one or more host materials H^{B};
(ii) 0.1-30% by weight of one or more phosphorescence materials P^{B}; and
(iii) 0.1-10% by weight of one or more small FWHM emitters S^{B}; and
(iv) 12-40% by weight of one or more TADF materials E^{B}; and optionally
(v) 0-3% by weight of one or more solvents.

In an even more preferred embodiment, wherein E^{B} is necessary, in an organic electroluminescent device according to the present invention, the (at least one) light-emitting layer B as a whole (consisting of one (sub)layer or comprising more than one sublayers) comprises (or consists of):
(i) 30-87.8% by weight of one or more host materials H^{B} (also designatable as host compound H^{B});
(ii) 0.1-20% by weight of one or more phosphorescence material P^{B}; and
(iii) 0.1-10% by weight of one or more small FWHM emitters S^{B}; and
(iv) 12-40% by weight of one or more TADF materials E^{B}; and optionally
(v) 0-57.8% by weight of one or more solvents.

In an even more preferred embodiment, wherein E^{B} is necessary, in an organic electroluminescent device according to the present invention, the (at least one) light-emitting layer B as a whole (consisting of one (sub)layer or comprising more than one sublayers) comprises (or consists of):
(i) 30-87.8% by weight of one or more host materials H^{B} (also designatable as host compound H^{B});
(ii) 0.1-20% by weight of one or more phosphorescence material P^{B}; and
(iii) 0.1-10% by weight of one or more small FWHM emitters S^{B}; and
(iv) 12-40% by weight of one or more TADF materials E^{B}; and optionally
(v) 0-3% by weight of one or more solvents.

In one embodiment of the invention, the at least one, preferably each, light-emitting layer B comprises less than or equal to 5% by weight of one or more phosphorescence material P^{B}.

In one embodiment of the invention, the organic electroluminescent device comprises at least one light-emitting layer B comprising:
(i) at least one host material H^{B}, which has a lowermost excited singlet state energy level E(S1^{H}) and a lowermost excited triplet state energy level E(T1^{H});
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1^{S}) and a lowermost excited triplet state energy level E(T1^{S}), wherein S^{B} emits light with a full width at half maximum (FWHM) of less than or equal to 0.25 eV;
(iv) at least one thermally activated delayed fluorescence (TADF) material E^{B}, which has a lowermost excited singlet state energy level E(S1^{E}) and a lowermost excited triplet state energy level E(T1^{E}),
   wherein the relations expressed by the following formulas (1) and (2) apply:

   E(T1^{H}) > E(T1^{P}) (1)

   E(T1^{P}) > E(S1^{B}) (2),

   and wherein the (at least one), preferably each, light-emitter layer B comprises less than or equal to 5% by weight of one or more phosphorescence material P^{B}.

In one embodiment of the invention, the at least one, preferably each, light-emitting layer B comprises or consists of:
(i) 30-96.8% by weight of one or more host materials H^{B} (also designatable as host compound H^{B});
(ii) 0.1-5% by weight of one or more phosphorescence materials P^{B}; and
(iii) 0.1-10% by weight of one or more small FWHM emitters S^{B};
(iv) 3-69.8% by weight of one or more TADF materials E^{B}; and optionally
(v) 0-66.8% by weight of one or more solvents.

In one embodiment of the invention, the at least one, preferably each, light-emitting layer B comprises or consists of:
(i) 30-96.8% by weight of one or more host materials H^{B} (also designatable as host compound H^{B});
(ii) 0.1-5% by weight of one or more phosphorescence materials P^{B}; and
(iii) 0.1-10% by weight of one or more small FWHM emitters S^{B};
(iv) 3-69.8% by weight of one or more TADF materials E^{B}; and optionally
(v) 0-3% by weight of one or more solvents.

In one embodiment of the invention, the at least one, preferably each, light-emitting layer B comprises or consists of:
(i) 30-89.8% by weight of one or more host materials H^{B};
(ii) 0.1-5% by weight of one or more phosphorescence materials P^{B}; and
(iii) 0.1-10% by weight of one or more small FWHM emitters S^{B};
(iv) 10-40% by weight of one or more TADF materials E^{B}; and optionally
(v) 0-59.8% by weight of one or more solvents.

In one embodiment of the invention, the at least one, preferably each, light-emitting layer B comprises or consists of:
(i) 30-89.8% by weight of one or more host materials H^{B};
(ii) 0.1-5% by weight of one or more phosphorescence materials P^{B}; and
(iii) 0.1-10% by weight of one or more small FWHM emitters S^{B};
(iv) 10-52% by weight of one or more TADF materials E^{B}; and optionally
(v) 0-3% by weight of one or more solvents.

In one embodiment of the invention, the at least one, preferably each, light-emitting layer B comprises or consists of:
(i) 30-96.8% by weight of one or more host materials H^{B};
(ii) 0.1-5% by weight of one or more phosphorescence materials P^{B}; and
(iii) 0.1-5% by weight of one or more small FWHM emitters S^{B};
(iv) 3-69.8% by weight of one or more TADF materials E^{B}; and optionally
(v) 0-66.8% by weight of one or more solvents.

In one embodiment of the invention, the at least one, preferably each, light-emitting layer B comprises or consists of:
(i) 30-96.8% by weight of one or more host materials H^{B};
(ii) 0.1-5% by weight of one or more phosphorescence materials P^{B}; and
(iii) 0.1-5% by weight of one or more small FWHM emitters S^{B};
(iv) 3-69.8% by weight of one or more TADF materials E^{B}; and optionally
(v) 0-3% by weight of one or more solvents.

In a particularly preferred embodiment of the invention, the at least one, preferably each, light-emitting layer B comprises or consists of:
(i) 30-87.8% by weight of one or more host materials H^{B};
(ii) 0.1-5% by weight of one or more phosphorescence materials P^{B}; and
(iii) 0.1-5% by weight of one or more small FWHM emitters S^{B};
(iv) 12-40% by weight of one or more TADF materials E^{B}; and optionally
(v) 0-57.8% by weight of one or more solvents.

In a particularly preferred embodiment of the invention, the at least one, preferably each, light-emitting layer B comprises or consists of:
(i) 30-87.8% by weight of one or more host materials H^{B};
(ii) 0.1-5% by weight of one or more phosphorescence materials P^{B}; and
(iii) 0.1-5% by weight of one or more small FWHM emitters S^{B};
(iv) 12-57% by weight of one or more TADF materials E^{B}; and optionally
(v) 0-3% by weight of one or more solvents.

In one embodiment of the invention, the at least one, preferably each, light-emitting layer B comprises less than or equal to 3% by weight, of phosphorescence material P^{B}.

In one embodiment of the invention, the at least one, preferably each, light-emitting layer B comprises less than or equal to 1% by weight, of phosphorescence material P^{B}.

In one embodiment of the invention, the at least one, preferably each, light-emitting layer B comprises 10-40% by weight of one or more TADF material E^{B}.

In one embodiment of the invention, the mass ratio of the (at least one) small full width at half maximum (FWHM) emitter S^{B} to the (at least one) phosphorescence material P^{B} (S^{B}: P^{B}) is ≥1.

In one embodiment of the invention, in at least one light-emitting layer B, the mass ratio of the at least one small full width at half maximum (FWHM) emitter S^{B} to the at least one phosphorescence material P^{B} (S^{B}: P^{B}) is ≥1. In one embodiment of the invention, in each light-emitting layer B, the mass ratio of the at least one small full width at half maximum (FWHM) emitter S^{B} to the at least one phosphorescence material P^{B} (S^{B}: P^{B}) is ≥1.

In one embodiment of the invention, the mass ratio of the (at least one) small full width at half maximum (FWHM) emitter S^{B} to the (at least one) phosphorescence material P^{B} (S^{B}: P^{B}) is <1.

In one embodiment of the invention, in at least one light-emitting layer B, the mass ratio of the at least one small full width at half maximum (FWHM) emitter S^{B} to the at least one phosphorescence material P^{B} (S^{B}: P^{B}) is <1. In one embodiment of the invention, in each light-emitting layer B, the mass ratio of the at least one small full width at half maximum (FWHM) emitter S^{B} to the at least one phosphorescence material P^{B} (S^{B}: P^{B}) is <1.

In one embodiment of the invention, the mass ratio S^{B}: P^{B} is in the range of from 1:1 to 30:1, in the range of from 1.5:1 to 25:1, in the range from 2:1 to 20:1, in the range of from 4:1 to 15:1, in the range of from 5:1 to 12:1, or in the range of from 10:1 to 11:1. For example, the mass ratio S^{B}: P^{B} is in the range of (approximately) 20:1, 15:1, 12:1, 10:1, 8:1, 5:1, 4:1, 2:1, 1.5:1 or 1:1.

In one embodiment of the invention, the mass ratio of the (at least one) small full width at half maximum (FWHM) emitter S^{B} to the (at least one) phosphorescence material P^{B} (S^{B}: P^{B}) is <1.

In one embodiment of the invention, the mass ratio P^{B}: S^{B} is in the range of from 1:1 to 30:1, in the range of from 1.5:1 to 25:1, in the range from 2:1 to 20:1, in the range of from 4:1 to 15:1, in the range of from 5:1 to 12:1, or in the range of from 10:1 to 11:1. For example, the mass ratio S^{B}: P^{B} is in the range of (approximately) 20:1, 15:1, 12:1, 10:1, 8:1, 5:1, 4:1, 2:1, 1.5:1 or 1:1.

As stated previously, it is understood that different sublayers of a light-emitting layer B do not necessarily all comprise the same materials or even the same materials in the same ratios.

### S1-T1-energy relations

In one embodiment of the invention, the relations expressed by the following formulas (1) and (2) apply: $E \left(T{1}^{H}\right) > E \left(T{1}^{P}\right)$ $E \left(T{1}^{P}\right) > E \left(S{1}^{S}\right)$ accordingly, the lowermost excited triplet state T1^{H} of each host material H^{B} is higher in energy than the lowermost excited triplet state T1^{P} of each phosphorescence material P^{B}, and the lowermost excited triplet state T1^{P} of each phosphorescence material P^{B} is higher in energy than the lowermost excited singlet state S1^{S} of each small FWHM emitter S^{B}.

In one embodiment, the aforementioned relations expressed by formulas (1) and (2) apply to materials comprised in the same light-emitting layer B of the organic electroluminescent device according to the invention.

An organic electroluminescent device comprising at least one light-emitting layer B comprising:
(i) at least one host material H^{B}, which has a lowermost excited singlet state energy level E(S1^{H}) and a lowermost excited triplet state energy level E(T1^{H}); and
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1³) and a lowermost excited triplet state energy level E(T1^{S}), wherein S^{B} emits light with a full width at half maximum (FWHM) of less than or equal to 0.25 eV; and
(iv) at least one thermally activated delayed fluorescence (TADF) material E^{B}, which has a lowermost excited singlet state energy level E(S1^{E}) and a lowermost excited triplet state energy level E(T1^{E}),
   wherein the relations expressed by the following formulas (1) and (2) apply: $E \left(T{1}^{H}\right) > E \left(T{1}^{P}\right)$ $E \left(T{1}^{P}\right) > E \left(S{1}^{S}\right)$

In one embodiment, the aforementioned relations expressed by formulas (1) and (2) apply to materials comprised in any of the at least one light-emitting layers B of the organic electroluminescent device according to the invention.

In a preferred embodiment of the invention, the relations expressed by the following formulas (3) and (4) apply. $E \left(T{1}^{H}\right) > E \left(T{1}^{E}\right)$ $E \left(T{1}^{E}\right) > E \left(T{1}^{P}\right)$ accordingly, the lowermost excited triplet state T1^{H} of each host material H^{B} is higher in energy than the lowermost excited triplet state T1^{E} of each TADF material E^{B}, and the lowermost excited triplet state T1^{E} of each TADF material E^{B} is higher in energy than the lowermost excited triplet state T1^{P} of each phosphorescence material P^{B}.

In one embodiment, the aforementioned relations expressed by formulas (3) and (4) apply to materials comprised in any of the at least one light-emitting layers B of the organic electroluminescent device according to the invention. In one embodiment, the aforementioned relations expressed by formulas (3) and (4) apply to materials comprised in the same light-emitting layer B of the organic electroluminescent device according to the invention.

In an alternative embodiment of the invention, the relations expressed by the following formulas (5) and (6) apply. $E \left(T{1}^{P}\right) > E \left(T{1}^{E}\right)$ $E \left(S{1}^{E}\right) > E \left(S{1}^{S}\right)$ accordingly, the lowermost excited triplet state T1^{P} of each phosphorescence material P^{B} is higher in energy than the lowermost excited triplet state T1^{E} of each TADF material E^{B}, and the lowermost excited singlet state S1^{E} of each TADF material E^{B} is higher in energy the lowermost excited singlet state S1^{S} of each small FWHM emitter S^{B}.

In one embodiment, the aforementioned relations expressed by formulas (5) and (6) apply to materials comprised in any of the at least one light-emitting layers B of the organic electroluminescent device according to the invention. In one embodiment, the aforementioned relations expressed by formulas (5) and (6) apply to materials comprised in the same light-emitting layer B of the organic electroluminescent device according to the invention.

In a preferred embodiment of the invention, the relations expressed by the following formulas (1) to (4) apply: $E \left(T{1}^{H}\right) > E \left(T{1}^{P}\right)$ $E \left(T{1}^{P}\right) > E \left(S{1}^{S}\right)$ $E \left(T{1}^{H}\right) > E \left(S{1}^{E}\right)$ $E \left(T{1}^{E}\right) > E \left(T{1}^{P}\right)$

In one embodiment, the aforementioned relations expressed by formulas (1) to (4) apply to materials comprised in any of the at least one light-emitting layers B of the organic electroluminescent device according to the invention. In one embodiment, the aforementioned relations expressed by formulas (1) to (4) apply to materials comprised in the same light-emitting layer B of the organic electroluminescent device according to the invention.

In one embodiment of the invention, the difference (in energy) between the lowermost excited triplet state T1^{P} of each phosphorescence material P^{B} and the lowermost excited triplet state T1^{E} of each TADF material E^{B} is smaller than 0.3 eV: E(T1^{P}) - E(T1^{E}) < 0.3 eV, and E(T1^{E}) - E(T1^{P}) < 0.3 eV, respectively.

In one embodiment of the invention, in at least one of the one or more light-emitting layers B, the difference in energy between the lowermost excited triplet state T1^{P} of the at least one, preferably each, phosphorescence material P^{B} and the lowermost excited triplet state T1^{E} of the at least one, preferably each, TADF material E^{B} is smaller than 0.3 eV: E(T1^{P}) - E(T1^{E}) < 0.3 eV, and E(T1^{E}) - E(T1^{P}) < 0.3 eV, respectively.

In one embodiment of the invention, in each of the one or more light-emitting layers B, the difference in energy between the lowermost excited triplet state T1^{P} of the at least one, preferably each, phosphorescence material P^{B} and the lowermost excited triplet state T1^{E} of the at least one, preferably each, TADF material E^{B} is smaller than 0.3 eV: E(T1^{P}) - E(T1^{E}) < 0.3 eV, and E(T1^{E}) - E(T1^{P}) < 0.3 eV, respectively.

In one embodiment of the invention, the relation expressed by the following formula (4) applies: $E \left(T{1}^{E}\right) > E \left(T{1}^{P}\right)$

In one embodiment, the aforementioned relation expressed by formula (4) applies to materials comprised in any of the at least one light-emitting layers B of the organic electroluminescent device according to the invention. In one embodiment, the aforementioned relation expressed by formula (4) applies to materials comprised in the same light-emitting layer B of the organic electroluminescent device according to the invention.

In a preferred embodiment of the invention, the difference in energy between the lowermost excited triplet state T1^{E} of the at least one, preferably each, TADF material E^{B} and the lowermost excited triplet state T1^{P} of the at least one, preferably each, phosphorescence material P^{B} is smaller than 0.2 eV: E(T1^{E}) - E(T1^{P}) < 0.2 eV.

In a preferred embodiment of the invention, in at least one of the one or more light-emitting layers B, the difference in energy between the lowermost excited triplet state T1^{E} of the at least one, preferably each, TADF material E^{B} and the lowermost excited triplet state T1^{P} of the at least one, preferably each, phosphorescence material P^{B} is smaller than 0.2 eV: E(T1^{E}) - E(T1^{P}) < 0.2 eV.

In a preferred embodiment of the invention, in each of the one or more light-emitting layers B, the difference in energy between the lowermost excited triplet state T1^{E} of the at least one, preferably each, TADF material E^{B} and the lowermost excited triplet state T1^{P} of the at least one, preferably each, phosphorescence material P^{B} is smaller than 0.2 eV: E(T1^{E}) - E(T1^{P}) < 0.2 eV.

In a preferred embodiment of the invention, the difference in energy between the lowermost excited triplet state T1^{P} of the at least one, preferably each, phosphorescence material P^{B} and lowermost excited singlet state S1^{S} (energy level E(S1^{S})) of the at least one, preferably each, small full width at half maximum (FWHM) emitter S^{B} is smaller than 0.3 eV: E(T1^{P}) - E(S1^{S}) < 0.3 eV.

In a preferred embodiment of the invention, in at least one of the one or more light-emitting layers B, the difference in energy between the lowermost excited triplet state T1^{P} of the at least one, preferably each, phosphorescence material P^{B} and lowermost excited singlet state S1^{S} of the at least one, preferably each, small full width at half maximum (FWHM) emitter S^{B} is smaller than 0.3 eV: E(T1^{P}) - E(S1^{S}) < 0.3 eV.

In a preferred embodiment of the invention, in each of the one or more light-emitting layers B, the difference in energy between the lowermost excited triplet state T1^{P} of at least one, preferably each phosphorescence material P^{B} and lowermost excited singlet state S1^{S} of at least one, preferably each small full width at half maximum (FWHM) emitter S^{B} is smaller than 0.3 eV: E(T1^{P}) - E(S1^{S}) < 0.3 eV.

In a preferred embodiment of the invention, the difference in energy between the lowermost excited triplet state T1^{P} of each phosphorescence material P^{B} and lowermost excited singlet state S1^{S} (energy level E(S1^{S})) of each small full width at half maximum (FWHM) emitter S^{B} is smaller than 0.2 eV: E(T1^{P}) - E(S1^{S}) < 0.2 eV.

In a preferred embodiment of the invention, in at least one of the one or more light-emitting layers B, the difference in energy between the lowermost excited triplet state T1^{P} of the at least one, preferably each, phosphorescence material P^{B} and lowermost excited singlet state S1^{S} of the at least one, preferably each, small full width at half maximum (FWHM) emitter S^{B} is smaller than 0.2 eV: E(T1^{P}) - E(S1^{S}) < 0.2 eV.

In a preferred embodiment of the invention, in each of the one or more light-emitting layers B, the difference in energy between the lowermost excited triplet state T1^{P} of the at least one, preferably each, phosphorescence material P^{B} and lowermost excited singlet state S1^{S} of the at least one, preferably each, small full width at half maximum (FWHM) emitter S^{B} is smaller than 0.2 eV: E(T1^{P}) - E(S1^{S}) < 0.2 eV.

### HOMO-LUMO energies

In a preferred embodiment of the invention, the following requirements are fulfilled:
(i) each host material H^{B} has a highest occupied molecular orbital HOMO(H^{B}) having an energy E^{HOMO}(H^{B}); and
(ii) each phosphorescence material P^{B} has a highest occupied molecular orbital HOMO(P^{B}) having an energy E^{HOMO}(P^{B}); and
(iii) each small full width at half maximum (FWHM) emitter S^{B} has a highest occupied molecular orbital HOMO(S^{B}) having an energy E^{HOMO}(S^{B});
   wherein the relations expressed by the following formulas (10) and (11) apply: ${E}^{HOMO} \left({P}^{B}\right) > {E}^{HOMO} \left({H}^{B}\right)$ ${E}^{HOMO} \left({P}^{B}\right) > {E}^{HOMO} \left({S}^{B}\right)$

In one embodiment, the aforementioned relations expressed by formulas (10) and (11) apply to materials comprised in any of the at least one light-emitting layers B of the organic electroluminescent device according to the invention. In one embodiment, the aforementioned relations expressed by formulas (10) and (11) apply to materials comprised in the same light-emitting layer B of the organic electroluminescent device according to the invention.

In one embodiment of the invention, the highest occupied molecular orbital HOMO(S^{B}) of each small full width at half maximum (FWHM) emitter S^{B} having an energy E^{HOMO}(S^{B}) is higher in energy than the highest occupied molecular orbital HOMO(H^{B}) of each host material H^{B} having an energy E^{HOMO}(H^{B}): ${E}^{HOMO} \left({S}^{B}\right) > {E}^{HOMO} \left({H}^{B}\right) .$

In one embodiment of the invention, in at least one of the one or more light-emitting layers B, the highest occupied molecular orbital HOMO(S^{B}) of the at least one, preferably each, small full width at half maximum (FWHM) emitter S^{B} having an energy E^{HOMO}(S^{B}) is higher in energy than the highest occupied molecular orbital HOMO(H^{B}) of the at least one, preferably each, host material H^{B} having an energy E^{HOMO}(H^{B}): ${E}^{HOMO} \left({S}^{B}\right) > {E}^{HOMO} \left({H}^{B}\right) .$

In one embodiment of the invention, in each of the at least one light-emitting layers B, the highest occupied molecular orbital HOMO(S^{B}) of the at least one, preferably each, small full width at half maximum (FWHM) emitter S^{B} having an energy E^{HOMO}(S^{B}) is higher in energy than the highest occupied molecular orbital HOMO(H^{B}) of the at least one, preferably each, host material H^{B} having an energy E^{HOMO}(H^{B}): ${E}^{HOMO} \left({S}^{B}\right) > {E}^{HOMO} \left({H}^{B}\right) .$

In one embodiment of the invention, the highest occupied molecular orbital HOMO(S^{B}) of each small full width at half maximum (FWHM) emitter S^{B} having an energy E^{HOMO}(S^{B}) is higher in energy than the highest occupied molecular orbital HOMO(E^{B}) of each TADF material E^{B} having an energy E^{HOMO}(E^{B}): ${E}^{HOMO} \left({S}^{B}\right) > {E}^{HOMO} \left({E}^{B}\right) .$

In one embodiment of the invention, in at least one of the one or more light-emitting layers B, the highest occupied molecular orbital HOMO(S^{B}) of the at least one, preferably each, small full width at half maximum (FWHM) emitter S^{B} having an energy E^{HOMO}(S^{B}) is higher in energy than the highest occupied molecular orbital HOMO(E^{B}) of the at least one, preferably each, TADF material E^{B} having an energy E^{HOMO}(E^{B}): ${E}^{HOMO} \left({S}^{B}\right) > {E}^{HOMO} \left({E}^{B}\right) .$

In one embodiment of the invention, in each of the at least one light-emitting layers B, the highest occupied molecular orbital HOMO(S^{B}) of the at least one, preferably each, small full width at half maximum (FWHM) emitter S^{B} having an energy E^{HOMO}(S^{B}) is higher in energy than the highest occupied molecular orbital HOMO(E^{B}) of the at least one, preferably each, TADF material E^{B} having an energy E^{HOMO}(E^{B}): ${E}^{HOMO} \left({S}^{B}\right) > {E}^{HOMO} \left({E}^{B}\right) .$

In one embodiment of the invention, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(E^{B}) of the at least one, preferably each, TADF material E^{B} having an energy E^{HOMO}(E^{B}): ${E}^{HOMO} \left({P}^{B}\right) > {E}^{HOMO} \left({E}^{B}\right) .$

In one embodiment of the invention, in at least one of the one or more light-emitting layers B, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(E^{B}) of the at least one, preferably each, TADF material E^{B} having an energy E^{HOMO}(E^{B}): ${E}^{HOMO} \left({P}^{B}\right) > {E}^{HOMO} \left({E}^{B}\right) .$

In one embodiment of the invention, in each of the at least one light-emitting layers B, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(E^{B}) of the at least one, preferably each, TADF material E^{B} having an energy E^{HOMO}(E^{B}): ${E}^{HOMO} \left({P}^{B}\right) > {E}^{HOMO} \left({E}^{B}\right) .$

In one embodiment of the invention, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(H^{B}) of the at least one, preferably each, host material H^{B} having an energy E^{HOMO}(H^{B}): ${E}^{HOMO} \left({P}^{B}\right) > {E}^{HOMO} \left({H}^{B}\right) .$

In one embodiment of the invention, in at least one of the one or more light-emitting layers B, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(H^{B}) of the at least one, preferably each, host material H^{B} having an energy E^{HOMO}(H^{B}): ${E}^{HOMO} \left({P}^{B}\right) > {E}^{HOMO} \left({H}^{B}\right) .$

In one embodiment of the invention, in each of the at least one light-emitting layers B, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(H^{B}) of the at least one, preferably each, host material H^{B} having an energy E^{HOMO}(H^{B}): ${E}^{HOMO} \left({P}^{B}\right) > {E}^{HOMO} \left({H}^{B}\right) .$

In one embodiment of the invention, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(S^{B}) of the at least one, preferably each, small full width at half maximum (FWHM) emitter S^{B} having an energy E^{HOMO}(S^{B}): ${E}^{HOMO} \left({P}^{B}\right) > {E}^{HOMO} \left({S}^{B}\right) .$

In one embodiment of the invention, in at least one of the one or more light-emitting layers B, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(S^{B}) of the at least one, preferably each, small full width at half maximum (FWHM) emitter S^{B} having an energy E^{HOMO}(S^{B}): ${E}^{HOMO} \left({P}^{B}\right) > {E}^{HOMO} \left({S}^{B}\right) .$

In one embodiment of the invention, in each of the at least one light-emitting layers B, the highest occupied molecular orbital HOMO(P^{B}) of the at least one, preferably each, phosphorescence material P^{B} having an energy E^{HOMO}(P^{B}) is higher in energy than the highest occupied molecular orbital HOMO(S^{B}) of the at least one, preferably each, small full width at half maximum (FWHM) emitter S^{B} having an energy E^{HOMO}(S^{B}): ${E}^{HOMO} \left({P}^{B}\right) > {E}^{HOMO} \left({S}^{B}\right) .$

In one embodiment of the invention, the difference (in energy) between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is smaller than 0.3 eV: ${E}^{HOMO} \left({P}^{B}\right) - {E}^{HOMO} \left({S}^{B}\right) < 0.3 eV .$

In one embodiment of the invention, in at least one of the one or more light-emitting layers B, the difference in energy between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is smaller than 0.3 eV: ${E}^{HOMO} \left({P}^{B}\right) - {E}^{HOMO} \left({S}^{B}\right) < 0.3 eV .$

In one embodiment of the invention, in each of the at least one light-emitting layers B, the difference in energy between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is smaller than 0.3 eV: ${E}^{HOMO} \left({P}^{B}\right) - {E}^{HOMO} \left({S}^{B}\right) < 0.3 eV .$

In one embodiment of the invention, the difference (in energy) between the highest occupied molecular orbital HOMO(P^{B}) of each phosphorescence material P^{B} having an energy E^{HOMO}(P^{B}) and the highest occupied molecular orbital HOMO(S^{B}) of each small full width at half maximum (FWHM) emitter S^{B} having an energy E^{HOMO}(S^{B}) is smaller than 0.2 eV: E^{HOMO}(P^{B}) - E^{HOMO}(S^{B}) < 0.2 eV.

In one embodiment of the invention, in at least one of the one or more light-emitting layers B, the difference in energy between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is smaller than 0.2 eV: ${E}^{HOMO} \left({P}^{B}\right) - {E}^{HOMO} \left({S}^{B}\right) < 0.2 eV .$

In one embodiment of the invention, in each of the at least one light-emitting layers B, the difference in energy between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is smaller than 0.2 eV: ${E}^{HOMO} \left({P}^{B}\right) - {E}^{HOMO} \left({S}^{B}\right) < 0.2 eV .$

In a preferred embodiment of the invention, the difference (in energy) between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is larger than 0.0 eV and smaller than 0.3 eV: $0.0 eV < {E}^{HOMO} \left({P}^{B}\right) - {E}^{HOMO} \left({S}^{B}\right) < 0.3 eV .$

In a preferred embodiment of the invention, in at least one of the one or more light-emitting layers B, the difference in energy between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is larger than 0.0 eV and smaller than 0.3 eV: $0.0 eV < {E}^{HOMO} \left({P}^{B}\right) - {E}^{HOMO} \left({S}^{B}\right) < 0.3 eV .$

In a preferred embodiment of the invention, in each of the at least one light-emitting layers B, the difference in energy between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is larger than 0.0 eV and smaller than 0.3 eV: $0.0 eV < {E}^{HOMO} \left({P}^{B}\right) - {E}^{HOMO} \left({S}^{B}\right) < 0.3 eV .$

In one embodiment of the invention, the difference (in energy) between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is larger than or equal to 0.1 eV and smaller than or equal to 0.8 eV: $0.1 eV \leq {E}^{HOMO} \left({P}^{B}\right) - {E}^{HOMO} \left({S}^{B}\right) \leq 0.8 eV .$

In one embodiment of the invention, in at least one of the one or more light-emitting layers B, the difference in energy between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is larger than or equal to 0.1 eV and smaller than or equal to 0.8 eV: $0.1 eV \leq {E}^{HOMO} \left({P}^{B}\right) - {E}^{HOMO} \left({S}^{B}\right) \leq 0.8 eV .$

In one embodiment of the invention, in each of the at least one light-emitting layers B, the difference in energy between the highest occupied molecular orbital HOMO(P^{B}) of the at least one, preferably each, phosphorescence material P^{B} having an energy E^{HOMO}(P^{B}) and the highest occupied molecular orbital HOMO(S^{B}) of the at least one, preferably each, small full width at half maximum (FWHM) emitter S^{B} having an energy E^{HOMO}(S^{B}) is larger than or equal to 0.1 eV and smaller than or equal to 0.8 eV: $0.1 eV \leq {E}^{HOMO} \left({P}^{B}\right) - {E}^{HOMO} \left({S}^{B}\right) \leq 0.8 eV .$

In a preferred embodiment of the invention, the following requirements are fulfilled:
(i) each host material H^{B} has a lowest unoccupied molecular orbital LUMO(H^{B}) having an energy E^{LUMO}(H^{B}); and
(ii) each phosphorescence material P^{B} has a lowest unoccupied molecular orbital LUMO(P^{B}) having an energy E^{LUMO}(P^{B}); and
(iii) each small full width at half maximum (FWHM) emitter S^{B} has a lowest unoccupied molecular orbital LUMO(S^{B}) having an energy E^{LUMO}(S^{B}); and
(iv) each thermally activated delayed fluorescence (TADF) material E^{B} has a lowest unoccupied molecular orbital LUMO(E^{B}) having an energy E^{LUMO}(E^{B}),
   wherein the relations expressed by the following formulas (12) to (13) apply: ${E}^{LUMO} \left({E}^{B}\right) < {E}^{LUMO} \left({H}^{B}\right)$ ${E}^{LUMO} \left({E}^{B}\right) < {E}^{LUMO} \left({P}^{B}\right)$

In one embodiment, the aforementioned relations expressed by formulas (12) and (13) apply to materials comprised in any of the at least one light-emitting layers B of the organic electroluminescent device according to the invention. In one embodiment, the aforementioned relations expressed by formulas (12) and (13) apply to materials comprised in the same light-emitting layer B of the organic electroluminescent device according to the invention.

In one embodiment of the invention, the electroluminescent device comprising a light-emitting layer B composed of one or more sublayers, wherein the one or more sublayers of the light-emitting layer B comprise:
(i) a host material H^{B} having a lowest unoccupied molecular orbital LUMO(H^{B}) having an energy E^{LUMO}(H^{B}); and
(ii) a phosphorescence material P^{B} having a lowest unoccupied molecular orbital LUMO(P^{B}) having an energy E^{LUMO}(P^{B}); and
(iii) a small full width at half maximum (FWHM) emitter S^{B} having a lowest unoccupied molecular orbital LUMO(S^{B}) having an energy E^{LUMO}(S^{B}); and
(iv) a thermally activated delayed fluorescence (TADF) material E^{B} having a lowest unoccupied molecular orbital LUMO(E^{B}) having an energy E^{LUMO}(E^{B}),
wherein the relations expressed by the following formulas (12) to (14) apply: ${E}^{LUMO} \left({E}^{B}\right) < {E}^{LUMO} \left({H}^{B}\right)$ ${E}^{LUMO} \left({E}^{B}\right) < {E}^{LUMO} \left({P}^{B}\right)$ ${E}^{LUMO} \left({E}^{B}\right) < {E}^{LUMO} \left({S}^{B}\right)$

In one embodiment, the aforementioned relations expressed by formulas (12) to (14) apply to materials comprised in any of the at least one light-emitting layers B of the organic electroluminescent device according to the invention. In one embodiment, the aforementioned relations expressed by formulas (12) to (14) apply to materials comprised in the same light-emitting layer B of the organic electroluminescent device according to the invention.

In one embodiment of the invention, the relations expressed by the following formulas (10) to (13) apply: ${E}^{HOMO} \left({P}^{B}\right) > {E}^{HOMO} \left({H}^{B}\right)$ ${E}^{HOMO} \left({P}^{B}\right) > {E}^{HOMO} \left({S}^{B}\right)$ ${E}^{LUMO} \left({E}^{B}\right) < {E}^{LUMO} \left({H}^{B}\right)$ ${E}^{LUMO} \left({E}^{B}\right) < {E}^{LUMO} \left({P}^{B}\right)$

In one embodiment, the aforementioned relations expressed by formulas (10) to (13) apply to materials comprised in any of the at least one light-emitting layers B of the organic electroluminescent device according to the invention. In one embodiment, the aforementioned relations expressed by formulas (10) to (13) apply to materials comprised in the same light-emitting layer B of the organic electroluminescent device according to the invention.

In one embodiment of the invention, the relations expressed by the following formulas (10) to (14) apply: ${E}^{HOMO} \left({P}^{B}\right) > {E}^{HOMO} \left({H}^{B}\right)$ ${E}^{HOMO} \left({P}^{B}\right) > {E}^{HOMO} \left({S}^{B}\right)$ ${E}^{LUMO} \left({E}^{B}\right) < {E}^{LUMO} \left({H}^{B}\right)$ ${E}^{LUMO} \left({E}^{B}\right) < {E}^{LUMO} \left({P}^{B}\right)$ ${E}^{LUMO} \left({E}^{B}\right) < {E}^{LUMO} \left({S}^{B}\right)$

In one embodiment, the aforementioned relations expressed by formulas (10) to (14) apply to materials comprised in any of the at least one light-emitting layers B of the organic electroluminescent device according to the invention. In one embodiment, the aforementioned relations expressed by formulas (10) to (14) apply to materials comprised in the same light-emitting layer B of the organic electroluminescent device according to the invention.

In one embodiment of the invention, the lowest unoccupied molecular orbital LUMO(S^{B}) of the at least one, preferably each, small full width at half maximum (FWHM) emitter S^{B} having an energy E^{LUMO}(S^{B}) is higher in energy than the lowest unoccupied molecular orbital LUMO(E^{B}) of the at least one, preferably each, TADF material E^{B} having an energy E^{LUMO}(E^{B}): ${E}^{LUMO} \left({S}^{B}\right) > {E}^{LUMO} \left({E}^{B}\right) .$

In one embodiment of the invention, in at least one of the one or more light-emitting layers B, the lowest unoccupied molecular orbital LUMO(S^{B}) of the at least one, preferably each, small full width at half maximum (FWHM) emitter S^{B} having an energy E^{LUMO}(S^{B}) is higher in energy than the lowest unoccupied molecular orbital LUMO(E^{B}) of the at least one, preferably each, TADF material E^{B} having an energy E^{LUMO}(E^{B}): ${E}^{LUMO} \left({S}^{B}\right) > {E}^{LUMO} \left({E}^{B}\right) .$

In one embodiment of the invention, in each of the at least one light-emitting layers B, the lowest unoccupied molecular orbital LUMO(S^{B}) of the at least one, preferably each, small full width at half maximum (FWHM) emitter S^{B} having an energy E^{LUMO}(S^{B}) is higher in energy than the lowest unoccupied molecular orbital LUMO(E^{B}) of the at least one, preferably each, TADF material E^{B} having an energy E^{LUMO}(E^{B}): ${E}^{LUMO} \left({S}^{B}\right) > {E}^{LUMO} \left({E}^{B}\right) .$

In one embodiment of the invention, the difference in energy between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is smaller than 0.3 eV: ${E}^{LUMO} \left({S}^{B}\right) - {E}^{LUMO} \left({E}^{B}\right) < 0.3 eV .$

In one embodiment of the invention, in at least one of the one or more light-emitting layers B, the difference in energy between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is smaller than 0.3 eV: ${E}^{LUMO} \left({S}^{B}\right) - {E}^{LUMO} \left({E}^{B}\right) < 0.3 eV .$

In one embodiment of the invention, in each of the at least one light-emitting layers B, the difference in energy between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is smaller than 0.3 eV: ${E}^{LUMO} \left({S}^{B}\right) - {E}^{LUMO} \left({E}^{B}\right) < 0.3 eV .$

In one embodiment of the invention, the difference (in energy) between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is smaller than 0.2 eV: ${E}^{LUMO} \left({S}^{B}\right) - {E}^{LUMO} \left({E}^{B}\right) < 0.2 eV .$

In one embodiment of the invention, in at least one of the one or more light-emitting layers B, the difference in energy between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is smaller than 0.2 eV: ${E}^{LUMO} \left({S}^{B}\right) - {E}^{LUMO} \left({E}^{B}\right) < 0.2 eV .$

In one embodiment of the invention, in each of the at least one light-emitting layers B, the difference in energy between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is smaller than 0.2 eV: ${E}^{LUMO} \left({S}^{B}\right) - {E}^{LUMO} \left({E}^{B}\right) < 0.2 eV .$

In one embodiment of the invention, the difference in energy between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is larger than 0.0 eV and smaller than 0.3 eV: $0.0 eV < {E}^{LUMO} \left({S}^{B}\right) - {E}^{LUMO} \left({E}^{B}\right) < 0.3 eV .$

In one embodiment of the invention, in at least one of the one or more light-emitting layers B, the difference in energy between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is larger than 0.0 eV and smaller than 0.3 eV: $0.0 eV < {E}^{LUMO} \left({S}^{B}\right) - {E}^{LUMO} \left({E}^{B}\right) < 0.3 eV .$

In one embodiment of the invention, in each of the at least one light-emitting layers B, the difference in energy between the lowest unoccupied molecular orbital LUMO(S^{B}) of the at least one, preferably each, small full width at half maximum (FWHM) emitter S^{B} having an energy E^{LUMO}(S^{B}) and the lowest unoccupied molecular orbital LUMO(E^{B}) of the at least one, preferably each, TADF material E^{B} having an energy E^{LUMO}(E^{B}) is larger than 0.0 eV and smaller than 0.3 eV: $0.0 eV < {E}^{LUMO} \left({S}^{B}\right) - {E}^{LUMO} \left({E}^{B}\right) < 0.3 eV .$

In one embodiment of the invention, the lowest unoccupied molecular orbital LUMO(P^{B}) of each phosphorescence material P^{B} having an energy E^{LUMO}(P^{B}) is higher in energy than the lowest unoccupied molecular orbital LUMO(E^{B}) of each TADF material E^{B} having an energy E^{LUMO}(E^{B}). ${E}^{LUMO} \left({P}^{B}\right) > {E}^{LUMO} \left({E}^{B}\right) .$

In one embodiment of the invention, in at least one of the one or more light-emitting layers B, the lowest unoccupied molecular orbital LUMO(P^{B}) of the at least one, preferably each, phosphorescence material P^{B} having an energy E^{LUMO}(P^{B}) is higher in energy than the lowest unoccupied molecular orbital LUMO(E^{B}) of the at least one, preferably each, TADF material E^{B} having an energy E^{LUMO}(E^{B}): ${E}^{LUMO} \left({P}^{B}\right) > {E}^{LUMO} \left({E}^{B}\right) .$

In one embodiment of the invention, in each of the at least one light-emitting layers B, the lowest unoccupied molecular orbital LUMO(P^{B}) of the at least one, preferably each, phosphorescence material P^{B} having an energy E^{LUMO}(P^{B}) is higher in energy than the lowest unoccupied molecular orbital LUMO(E^{B}) of the at least one, preferably each, TADF material E^{B} having an energy E^{LUMO}(E^{B}): ${E}^{LUMO} \left({P}^{B}\right) > {E}^{LUMO} \left({E}^{B}\right) .$

In one embodiment of the invention, the lowest unoccupied molecular orbital LUMO(H^{B}) of the at least one, preferably each, host material H^{B} having an energy E^{LUMO}(H^{B}) is higher in energy than the lowest unoccupied molecular orbital LUMO(E^{B}) of the at least one, preferably each, TADF material E^{B} having an energy E^{LUMO}(E^{B}): ${E}^{LUMO} \left({H}^{B}\right) > {E}^{LUMO} \left({E}^{B}\right) .$

In one embodiment of the invention, in at least one of the one or more light-emitting layers B, the lowest unoccupied molecular orbital LUMO(H^{B}) of the at least one, preferably each, host material H^{B} having an energy E^{LUMO}(H^{B}) is higher in energy than the lowest unoccupied molecular orbital LUMO(E^{B}) of the at least one, preferably each, TADF material E^{B} having an energy E^{LUMO}(E^{B}): ${E}^{LUMO} \left({H}^{B}\right) > {E}^{LUMO} \left({E}^{B}\right) .$

In one embodiment of the invention, in each of the at least one light-emitting layers B, the lowest unoccupied molecular orbital LUMO(H^{B}) of the at least one, preferably each, host material H^{B} having an energy E^{LUMO}(H^{B}) is higher in energy than the lowest unoccupied molecular orbital LUMO(E^{B}) of the at least one, preferably each, TADF material E^{B} having an energy E^{LUMO}(E^{B}): ${E}^{LUMO} \left({H}^{B}\right) > {E}^{LUMO} \left({E}^{B}\right) .$

### Relations of emission maxima

In one embodiment of the invention, the relations expressed by formulas (16) and (17) apply: $\left|{E}^{λmax}\left({P}^{B}\right)-{E}^{λmax}\left({S}^{B}\right)\right| < 0.30 eV$ $\left|{E}^{λmax}\left({E}^{B}\right)-{E}^{λmax}\left({S}^{B}\right)\right| < 0.30 eV$ which means: The difference in energy between the energy of the emission maximum E^{λmax}(P^{B}) of a phosphorescence material P^{B} in the context of the present invention given in electron volt (eV) and the energy of the emission maximum E^{λmax}(S^{B}) of a small FWHM emitter S^{B} in the context of the present invention given in electron volt (eV) is smaller than 0.30 eV. And: The difference in energy between the energy of the emission maximum E^{λmax}(E^{B}) of a TADF material E^{B} in the context of the present invention given in electron volt (eV) and the energy of the emission maximum E^{λmax}(S^{B}) of a small FWHM emitter S^{B} in the context of the present invention given in electron volt (eV) is smaller than 0.30 eV.

In one embodiment, the aforementioned relations expressed by formulas (16) and (17) apply to materials comprised in any of the at least one light-emitting layers B of the organic electroluminescent device according to the invention. In one embodiment, the aforementioned relations expressed by formulas (16) and (17) apply to materials comprised in the same light-emitting layer B of the organic electroluminescent device according to the invention.

An organic electroluminescent device comprising at least one light-emitting layer B which is composed of one or more sublayers, wherein the one or more sublayers are adjacent to each other and as a whole contain:
(i) at least one host material H^{B}; and
(ii) at least one phosphorescence material P^{B}, which has emission maximum λₘₐₓ(P^{B}) with an energy E^{λmax}(P^{B}); and
(iii) at least one small full width at half maximum (FWHM) emitter S^{B}, which has emission maximum λₘₐₓ(S^{B}) with an energy E^{λmax}(S^{B}), wherein S^{B} emits light with a full width at half maximum (FWHM) of less than or equal to 0.25 eV; and
(iv) at least one thermally activated delayed fluorescence (TADF) material E^{B}, which has emission maximum λₘₐₓ(E^{B}) with an energy E^{λmax}(E^{B}),
wherein the one or more sublayers which are located at the outer surface of the light-emitting layer B contain at least one (emitter) material selected from the group consisting of phosphorescence material P^{B}, small FWHM emitter S^{B}, and TADF material E^{B}, wherein the relations expressed by the following formulas (16) and (17) apply: $\left|{E}^{λmax}\left({P}^{B}\right)-{E}^{λmax}\left({S}^{B}\right)\right| < 0.30 eV$ $\left|{E}^{λmax}\left({E}^{B}\right)-{E}^{λmax}\left({S}^{B}\right)\right| < 0.30 eV$

In a preferred embodiment of the invention, the relations expressed by formulas (18) and (19) apply: $\left|{E}^{λmax}\left({P}^{B}\right)-{E}^{λmax}\left({S}^{B}\right)\right| < 0.20 eV$ $\left|{E}^{λmax}\left({E}^{B}\right)-{E}^{λmax}\left({S}^{B}\right)\right| < 0.20 eV$ which means: The difference in energy between the energy of the emission maximum E^{λmax}(P^{B}) of a phosphorescence material P^{B} in the context of the present invention given in electron volt (eV) and the energy of the emission maximum E^{λmax}(S^{B}) of a small FWHM emitter S^{B} in the context of the present invention given in electron volt (eV) is smaller than 0.20 eV. And: The difference in energy between the energy of the emission maximum E^{λmax}(E^{B}) of a TADF material E^{B} in the context of the present invention given in electron volt (eV) and the energy of the emission maximum E^{λmax}(S^{B}) of a small FWHM emitter S^{B} in the context of the present invention given in electron volt (eV) is smaller than 0.20 eV.

In one embodiment, the aforementioned relations expressed by formulas (18) and (19) apply to materials comprised in any of the at least one light-emitting layers B of the organic electroluminescent device according to the invention. In one embodiment, the aforementioned relations expressed by formulas (18) and (19) apply to materials comprised in the same light-emitting layer B of the organic electroluminescent device according to the invention.

One embodiment of the invention refers to an organic electroluminescent device, wherein
(ii) the at least one phosphorescence material P^{B}, has an emission maximum λₘₐₓ(P^{B}) with an energy E^{λmax}(P^{B}); and
(iii) the at least one small full width at half maximum (FWHM) emitter S^{B}, has an emission maximum λₘₐₓ(S^{B}) with an energy E^{λmax}(S^{B}), wherein S^{B} emits light with a full width at half maximum (FWHM) of less than or equal to 0.25 eV; and
(iv) the at least one thermally activated delayed fluorescence (TADF) material E^{B}, has an emission maximum λₘₐₓ(E^{B}) with an energy E^{λmax}(E^{B}),
wherein (18) and (19) apply: $\left|{E}^{λmax}\left({P}^{B}\right)-{E}^{λmax}\left({S}^{B}\right)\right| < 0.20 eV$ $\left|{E}^{λmax}\left({E}^{B}\right)-{E}^{λmax}\left({S}^{B}\right)\right| < 0.20 eV$

In an even more preferred embodiment of the invention, the relations expressed by formulas (20) and (21) apply: $\left|{E}^{λmax}\left({P}^{B}\right)-{E}^{λmax}\left({S}^{B}\right)\right| < 0.1 eV$ $\left|{E}^{λmax}\left({E}^{B}\right)-{E}^{λmax}\left({S}^{B}\right)\right| < 0.10 eV$ which means: The difference in energy between the energy of the emission maximum E^{λmax}(P^{B}) of a phosphorescence material P^{B} in the context of the present invention given in electron volt (eV) and the energy of the emission maximum E^{λmax}(S^{B}) of a small FWHM emitter S^{B} in the context of the present invention given in electron volt (eV) is smaller than 0.10 eV. And: The difference in energy between the energy of the emission maximum E^{λmax}(E^{B}) of a TADF material E^{B} in the context of the present invention given in electron volt (eV) and the energy of the emission maximum E^{λmax}(S^{B}) of a small FWHM emitter S^{B} in the context of the present invention given in electron volt (eV) is smaller than 0.10 eV.

In one embodiment, the aforementioned relations expressed by formulas (20) and (21) apply to materials comprised in any of the at least one light-emitting layers B of the organic electroluminescent device according to the invention. In one embodiment, the aforementioned relations expressed by formulas (20) and (21) apply to materials comprised in the same light-emitting layer B of the organic electroluminescent device according to the invention.

In one embodiment of the invention, the relation expressed by formula (22) applies: ${E}^{λmax} \left({P}^{B}\right) {> E}^{λmax} \left({S}^{B}\right)$ which means that the energy of the emission maximum E^{λmax}(P^{B}) of a phosphorescence material P^{B} in the context of the present invention given in electron volt (eV) is larger than the energy of the emission maximum E^{λmax}(S^{B}) of a small FWHM emitter S^{B} in the context of the present invention given in electron volt (eV).

In one embodiment, the aforementioned relation expressed by formula (22) applies to materials comprised in any of the at least one light-emitting layers B of the organic electroluminescent device according to the invention. In one embodiment, the aforementioned relation expressed by formula (22) applies to materials comprised in the same light-emitting layer B of the organic electroluminescent device according to the invention.

In one embodiment of the invention, the relation expressed by formula (22-a) applies: ${E}^{λmax} \left({E}^{B}\right) {> E}^{λmax} \left({S}^{B}\right)$ which means that the energy of the emission maximum E^{λmax}(E^{B}) of a TADF material E^{B} in the context of the present invention given in electron volt (eV) is larger than the energy of the emission maximum E^{λmax}(S^{B}) of a small FWHM emitter S^{B} in the context of the present invention given in electron volt (eV).

In one embodiment, the aforementioned relation expressed by formula (22-a) applies to materials comprised in any of the at least one light-emitting layers B of the organic electroluminescent device according to the invention. In one embodiment, the aforementioned relation expressed by formula (22-a) applies to materials comprised in the same light-emitting layer B of the organic electroluminescent device according to the invention.

### Device Colors & Performance

A further embodiment of the present invention relates to an electroluminescent device (e.g., an OLED), which emits light at a distinct color point. According to the present invention, the electroluminescent device (e.g., OLED) emits light with a narrow emission band (small full width at half maximum (FWHM)). In a preferred embodiment, the electroluminescent device (e.g., OLED) according to the invention emits light with a FWHM of the main emission peak of below 0.25 eV, more preferably of below 0.20 eV, even more preferably of below 0.15 eV or even below 0.13 eV.

A further embodiment of the present invention relates to an electroluminescent device (e.g., an OLED), which exhibits an external quantum efficiency at 1000 cd/m² (nits) of more than 10%, more preferably of more than 13%, more preferably of more than 15%, even more preferably of more than 18% or even more than 20% and exhibits an emission maximum between 500 nm and 560 nm.

A further embodiment of the present invention relates to an electroluminescent device (e.g., an OLED), which exhibits an external quantum efficiency at 1000 cd/m² of more than 10%, more preferably of more than 13%, more preferably of more than 15%, even more preferably of more than 18% or even more than 20% and exhibits an emission maximum between 510 nm and 550 nm.

A further embodiment of the present invention relates to an electroluminescent device (e.g., an OLED) which exhibits an external quantum efficiency at 1000 cd/m² of more than 10%, more preferably of more than 13%, more preferably of more than 15%, even more preferably of more than 18% or even more than 20% and exhibits an emission maximum between 515 nm and 540 nm.

In a preferred embodiment, the electroluminescent device (e.g., an OLED) exhibits a LT95 value at constant current density J₀ = 15 mA/cm² of more than 100 h, preferably more than 200 h, more preferably more than 400 h, even more preferably more than 750 h or even more than 1000 h.

A further embodiment of the present invention relates to an electroluminescent device (e.g., an OLED), which emits light at a distinct color point. According to the present invention, the electroluminescent device (e.g., OLED) emits light with a narrow emission band (small full width at half maximum (FWHM)). In a preferred embodiment, the electroluminescent device (e.g., OLED) according to the invention emits light with a FWHM of the main emission peak of below 0.25 eV, more preferably of below 0.20 eV, even more preferably of below 0.15 eV or even below 0.13 eV.

A further embodiment of the present invention relates to an electroluminescent device (e.g., an OLED), which emits light with CIEx and CIEy color coordinates close to the CIEx (= 0.170) and CIEy (= 0.797) color coordinates of the primary color green (CIEx = 0.170 and CIEy = 0.797) as defined by ITU-R Recommendation BT.2020 (Rec. 2020) and thus may be suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is typically transparent) devices are used, whereas test devices as used throughout the present application represent bottom-emitting devices (bottom-electrode and substrate are transparent). Accordingly, a further aspect of the present invention relates to an electroluminescent device (e.g., an OLED), whose emission exhibits a CIEx color coordinate of between 0.15 and 0.45 preferably between 0.15 and 0.35, more preferably between 0.15 and 0.30 or even more preferably between 0.15 and 0.25 or even between 0.15 and 0.20 and/ or a CIEy color coordinate of between 0.60 and 0.92, preferably between 0.65 and 0.90, more preferably between 0.70 and 0.88 or even more preferably between 0.75 and 0.86 or even between 0.79 and 0.84.

A further embodiment of the present invention relates to an OLED, which emits light with CIEx and CIEy color coordinates close to the CIEx (= 0.265) and CIEy (= 0.65) color coordinates of the primary color green (CIEx = 0.265 and CIEy = 0.65) as defined by DCIP3. In this context, the term "close to" refers to the ranges of CIEx and CIEy coordinates provided at the end of this paragraph. In commercial applications, typically top-emitting (top-electrode is typically transparent) devices are used, whereas test devices as used throughout the present application represent bottom-emitting devices (bottom-electrode and substrate are transparent). Accordingly, a further aspect of the present invention relates to an OLED, whose bottom emission exhibits a CIEx color coordinate of between 0.2 and 0.45 preferably between 0.2 and 0.35 or more preferably between 0.2 and 0.30 or even more preferably between 0.24 and 0.28 or even between 0.25 and 0.27 and/ or a CIEy color coordinate of between 0.60 and 0.9, preferably between 0.6 and 0.8, more preferably between 0.60 and 0.70 or even more preferably between 0.62 and 0.68 or even between 0.64 and 0.66.

A further embodiment of the present invention relates to an electroluminescent device (e.g., an OLED), which exhibits an external quantum efficiency at 1000 cd/m² of more than 10%, more preferably of more than 13%, more preferably of more than 15%, even more preferably of more than 18% or even more than 20% and exhibits an emission maximum between 420 nm and 500 nm.

A further embodiment of the present invention relates to an electroluminescent device (e.g., an OLED), which exhibits an external quantum efficiency at 1000 cd/m² of more than 10%, more preferably of more than 13%, more preferably of more than 15%, even more preferably of more than 18% or even more than 20% and exhibits an emission maximum between 440 nm and 480 nm.

A further embodiment of the present invention relates to an electroluminescent device (e.g., an OLED), which exhibits an external quantum efficiency at 1000 cd/m² of more than 10%, more preferably of more than 13%, more preferably of more than 15%, even more preferably of more than 18% or even more than 20% and exhibits an emission maximum between 450 nm and 470 nm.

A further embodiment of the present invention relates to an electroluminescent device (e.g., an OLED), which exhibits an external quantum efficiency at 1000 cd/m² of more than 10%, more preferably of more than 13%, more preferably of more than 15%, even more preferably of more than 18% or even more than 20% and/or exhibits an emission maximum between 420 nm and 500 nm, preferably between 430 nm and 490 nm, more preferably between 440 nm and 480 nm, even more preferably between 450 nm and 470 nm and/or exhibits a LT80 value at 500 cd/m² of more than 100 h, preferably more than 200 h, more preferably more than 400 h, even more preferably more than 750 h or even more than 1000 h.

A further embodiment of the present invention relates to an electroluminescent device (e.g., an OLED), which emits light at a distinct color point. According to the present invention, the electroluminescent device (e.g., OLED) emits light with a narrow emission band (small full width at half maximum (FWHM)). In a preferred embodiment, the electroluminescent device (e.g., OLED) according to the invention emits light with a FWHM of the main emission peak of below 0.25 eV, more preferably of below 0.20 eV, even more preferably of below 0.15 eV or even below 0.13 eV.

A further aspect of the present invention relates to an OLED, which emits light with CIEx and CIEy color coordinates close to the CIEx (= 0.131) and CIEy (= 0.046) color coordinates of the primary color blue (CIEx = 0.131 and CIEy = 0.046) as defined by ITU-R Recommendation BT.2020 (Rec. 2020) and thus is suited for the use in Ultra High Definition (UHD) displays, e.g. UHD-TVs. In commercial applications, typically top-emitting (top-electrode is transparent) devices are used, whereas test devices as used throughout the present application represent bottom-emitting devices (bottom-electrode and substrate are transparent). The CIEy color coordinate of a blue device can be reduced by up to a factor of two, when changing from a bottom- to a top-emitting device, while the CIEx remains nearly unchanged (Okinaka et al., Society for Information Display International Symposium Digest of Technical Papers, 2015, 46(1):312-313,DOI:10.1002/sdtp.10480). Accordingly, a further aspect of the present invention relates to an OLED, whose emission exhibits a CIEx color coordinate of between 0.02 and 0.30, preferably between 0.03 and 0.25, more preferably between 0.05 and 0.20 or even more preferably between 0.08 and 0.18 or even between 0.10 and 0.15 and/ or a CIEy color coordinate of between 0.00 and 0.45, preferably between 0.01 and 0.30, more preferably between 0.02 and 0.20 or even more preferably between 0.03 and 0.15 or even between 0.04 and 0.10.

A further aspect of the present invention relates to an electroluminescent device (e.g., an OLED), which exhibits an external quantum efficiency at 1000 cd/m² of more than 8%, more preferably of more than 10%, more preferably of more than 13%, even more preferably of more than 15% or even more than 20% and/or exhibits an emission maximum between 590 nm and 690 nm, preferably between 610 nm and 665 nm, even more preferably between 620 nm and 640 nm and/or exhibits a LT80 value at 500 cd/m² of more than 100 h, preferably more than 200 h, more preferably more than 400 h, even more preferably more than 750 h or even more than 1000 h. Accordingly, a further aspect of the present invention relates to an OLED, whose emission exhibits a CIEy color coordinate of more than 0.25, preferably more than 0.27, more preferably more than 0.29 or even more preferably more than 0.30.

A further embodiment of the present invention relates to an electroluminescent device (e.g., an OLED), which emits light with CIEx and CIEy color coordinates close to the CIEx (= 0.708) and CIEy (= 0.292) color coordinates of the primary color red (CIEx = 0.708 and CIEy = 0.292) as defined by ITU-R Recommendation BT.2020 (Rec. 2020) and thus is suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is transparent) devices are used, whereas test devices as used throughout the present application represent bottom-emitting devices (bottom-electrode and substrate are transparent). Accordingly, a further aspect of the present invention relates to an OLED, whose emission exhibits a CIEx color coordinate of between 0.60 and 0.88, preferably between 0.61 and 0.83, more preferably between 0.63 and 0.78 or even more preferably between 0.66 and 0.76 or even between 0.68 and 0.73 and/ or a CIEy color coordinate of between 0.25 and 0.70, preferably between 0.26 and 0.55, more preferably between 0.27 and 0.45 or even more preferably between 0.28 and 0.40 or even between 0.29 and 0.35.

Accordingly, a further aspect of the present invention relates to an electroluminescent device (e.g., an OLED), which exhibits an external quantum efficiency at 14500 cd/m² of more than 10%, more preferably of more than 13%, more preferably of more than 15%, even more preferably of more than 17% or even more than 20% and/or exhibits an emission maximum between 590 nm and 690 nm, preferably between 610 nm and 665 nm, even more preferably between 620 nm and 640 nm.

One of the purposes of interest of an organic electroluminescent device may be the generation of light. Thus, the present invention further relates to a method for generating light of a desired wavelength range, comprising the step of providing an organic electroluminescent device according to any the present invention.

Accordingly, a further aspect of the present invention relates to a method for generating light of a desired wavelength range, comprising the steps of
(i) providing an organic electroluminescent device according to the present invention; and
(ii) applying an electrical current to said organic electroluminescent device.

A further aspect of the present invention relates to a process of making the organic electroluminescent devices by assembling the elements described above. The present invention also relates to a method for generating green light, in particular by using said organic electroluminescent device.

A further aspect of the invention relates to an organic electroluminescent device, wherein (at least) one, preferably exactly one, of the relations expressed by the following formulas (23) to (25) applies to materials comprised in the same light-emitting layer B: $440 nm < {λ}_{max} \left({S}^{B}\right) < 470 nm$ $510 nm < {λ}_{max} \left({S}^{B}\right) < 550 nm$ $610 nm < {λ}_{max} \left({S}^{B}\right) < 665 nm$ wherein λₘₐₓ(S^{B}) is the emission maximum of the at least one, preferably each, small FWHM emitter S^{B} and is given in nanometers (nm).

In one embodiment of the invention at least one, preferably exactly one, of the relations expressed by the following formulas (23) to (25) applies to materials comprised in any of the at least one light-emitting layers B of the organic electroluminescent device according to the invention.

A further aspect of the invention relates to a method for generating light, comprising the steps of:
(i) providing an organic electroluminescent device according to the present invention
(ii) applying an electrical current to said organic electroluminescent device.

A further aspect of the invention relates to a method for generating light, comprising the steps of:
(i) providing an organic electroluminescent device according to the present invention
(ii) applying an electrical current to said organic electroluminescent device,
wherein the method is for generating light at a wavelength range selected from one of the following wavelength ranges:
(i) from 510 nm to 550 nm, or
(ii) from 440 nm to 470 nm, or
(iii) from 610 nm to 665 nm.

The skilled artisan understands that the at least one TADF material E^{B} and the at least one phosphorescence material P^{B} (vide infra) may be used as emitters in organic electroluminescent devices. However, preferably, in the organic electroluminescent device according to the present invention, the main function of the at least one TADF material E^{B} and the at least one phosphorescence material P^{B} is not emitting light. In a preferred embodiment, upon applying a voltage (and electrical current), the organic electroluminescent device according to the invention emits light, wherein this emission is mainly (i.e. to an extent of more than 50%, preferably of more than 60%, more preferably of more than 70%, even more preferably of more than 80% or even of more than 90%) attributed to fluorescent light emitted by the at least one small FWHM emitter S^{B}. In consequence, the organic electroluminescent device according to the present invention preferably also displays a narrow emission, which is expressed by a small FWHM of the main emission peak of below 0.25 eV, more preferably of below 0.20 eV, even more preferably of below 0.15 eV or even below 0.13 eV.

In a preferred embodiment of the invention, the relation expressed by the following formula (26) applies: $\frac{{FWHM}^{D}}{{FWHM}^{SB}} \leq 1.50$ wherein
FWHM^{D} refers to the full width at half maximum (FWHM) in electron volts (eV) of the main emission peak of the organic electroluminescent device according to the present invention; and
FWHM^{SB} represents the FWHM in electron volts (eV) of the photoluminescence spectrum (fluorescence spectrum, measured at room temperature, i.e. (approximately) 20°C) of a spin coated film of the one or more small FWHM emitters S^{B} in the one or more host materials H^{B} used in the light-emitting layer (EML) of the organic electroluminescent device with the FWHM of FWHM^{D}. This is to say that the spin coated film from which FWHM^{SB} is determined preferably comprises the same small FWHM emitter or emitters S^{B} in the same weight ratios as the light-emitting layer B of the organic electroluminescent device.

If, for example, the light-emitting layer B comprises two small FWHM emitters S^{B} with a concentration of 1% by weight each, the spin coated film preferably also comprises 1% by weight of each of the two small FWHM emitters S^{B}. In this exemplary case, the matrix material of the spin coated film would amount to 98% by weight of the spin coated film. This matrix material of the spin coated film may be selected to reflect the weight-ratio of the host materials H^{B} comprised in the light-emitting layer B of the organic electroluminescent device. If, in the aforementioned example, the light-emitting layer B comprises a single host material H^{B}, this host material would preferably be the sole matrix material of the spin coated film. If, however, in the aforementioned example, the light-emitting layer B comprises two host materials H^{B}, one with a content of 60% by weight and the other with a content of 20% by weight (i.e. in a ratio of 3:1), the aforementioned matrix material of the spin coated film (comprising 1% by weight of each of the two small FWHM emitters S^{B}) would preferably be a 3:1-mixture of the two host materials H^{B} as present in the EML.

If more than one light-emitting layer B is contained in an organic electroluminescent device according to the present invention, the relation expressed by the aforementioned formula (26) preferably applies to all light-emitting layers B comprised in the device.

In one embodiment, for at least one light-emitting layer B of the organic electroluminescent device according to the present invention, the aforementioned ratio FWHM^{D}:FWHM^{SB} is equal to or smaller than 1.50, preferably 1.40, even more preferably 1.30, still even more preferably 1.20, or even 1.10.

In one embodiment, for each light-emitting layer B of the organic electroluminescent device according to the present invention, the aforementioned ratio FWHM^{D}:FWHM^{SB} is equal to or smaller than 1.50, preferably 1.40, even more preferably 1.30, still even more preferably 1.20, or even 1.10.

It should be noted that for the selection of fluorescent emitters for the use as small FWHM emitters S^{B} in the context of the present invention, the FWHM value may be determined as described in a later subchapter of this text (briefly: preferably from a spin coated film of the respective emitter in poly(methyl methacrylate) PMMA with a concentration of 1-5% by weight, in particular 2% by weight, or from a solution, vide infra). This is to say that the FWHM values of the exemplary small FWHM emitters S^{B} listed in Table 1S may not be understood as FWHM^{SB} values in the context of equation (26) and the associated preferred embodiments of the present invention.

The examples and claims further illustrate the invention.

### Host material(s) H^{B}

According to the invention, any of the one or more host materials H^{B} comprised in any of the at least one light-emitting layer B may be a p-host H^{P} exhibiting high hole mobility, an n-host H^{N} exhibiting high electron mobility, or a bipolar host material H^{BP} exhibiting both, high hole mobility and high electron mobility.

An n-host exhibiting high electron mobility in the context of the present invention preferably has a LUMO energy E^{LUMO}(H^{N}) equal to or smaller than -2.50 eV (E^{LUMO}(H^{N}) ≤ -2.50 eV). Preferably, E^{LUMO}(H^{N}) ≤ -2.60 eV, more preferably E^{LUMO}(H^{N}) ≤ -2.65 eV, and even more preferably, E^{LUMO}(H^{N}) ≤ -2.70 eV. The LUMO is the lowest unoccupied molecular orbital. The energy of the LUMO is determined as described in a later subchapter of this text.

A p-host exhibiting high hole mobility in the context of the present invention preferably has a HOMO energy E^{HOMO}(H^{P}) equal to or higher than -6.30 eV (E^{HOMO}(H^{P}) ≥ -6.30 eV), preferably E^{HOMO}(H^{P}) ≥ -5.90 eV, more preferably E^{HOMO}(H^{P}) ≥ -5.70 eV and even more preferably E^{HOMO}(H^{P}) ≥ -5.40 eV or even E^{HOMO}(H^{P}) ≥ -2.60 eV. The HOMO is the highest occupied molecular orbital. The energy of the HOMO is determined as described in a later subchapter of this text.

In one embodiment of the invention, each host material H^{B} is a p-host H^{P} which has a HOMO energy E^{HOMO}(H^{P}) equal to or higher than -6.30 eV (E_{HOMO}(H^{P}) ≥ - 6.30 eV), preferably E^{HOMO}(H^{P}) ≥ -5.90 eV, more preferably E^{HOMO}(H^{P}) ≥ -5.70 eV, and even more preferably E^{HOMO}(H^{P}) ≥ -5.40 eV. The HOMO is the highest occupied molecular orbital. The energy of the HOMO is determined as described in a later subchapter of this text.

In one embodiment of the invention, the at least one, preferably each p-host H^{P} has a HOMO energy E^{HOMO}(H^{P}) smaller than -5.60 eV.

In one embodiment of the invention, the organic electroluminescent device comprising at least one light-emitting layer B which is composed of one or more sublayers, wherein the one or more sublayers are adjacent to each other and as a whole contain:
(i) at least one host material H^{B}, which has a lowermost excited singlet state energy level E(S1^{H}) and a lowermost excited triplet state energy level E(T1^{H});
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1^{S}) and a lowermost excited triplet state energy level E(T1^{S}), wherein S^{B} emits light with a full width at half maximum (FWHM) of less than or equal to 0.25 eV; and optionally
(iv) at least one thermally activated delayed fluorescence (TADF) material E^{B}, which has a lowermost excited singlet state energy level E(S1^{E}) and a lowermost excited triplet state energy level E(T1^{E}),

wherein the one or more sublayers which are located at the outer surface of the light-emitting layer B contain at least one (emitter) material selected from the group consisting of phosphorescence material P^{B}, small FWHM emitter S^{B}, and TADF material E^{B},
wherein the at least one host material H^{B} has a highest occupied molecular orbital HOMO(H^{B}) having an energy E^{HOMO}(H^{B}), which is smaller than -5.60 eV, preferably wherein each host material H^{B} has a highest occupied molecular orbital HOMO(H^{B}) having an energy E^{HOMO}(H^{B}), which is smaller than -5.60 eV.

A bipolar host exhibiting high electron mobility in the context of the present invention preferably has a LUMO energy E^{LUMO}(H^{BP}) equal to or smaller than -2.50 eV (E^{LUMO}(H^{BP}) ≤ -2.50 eV). Preferably, E^{LUMO}(H^{BP}) ≤ -2.60 eV, more preferably E^{LUMO}(H^{BP}) ≤ -2.65 eV, and even more preferably, E^{LUMO}(H^{BP}) ≤ -2.70 eV. The LUMO is the lowest unoccupied molecular orbital. The energy of the LUMO is determined as described in a later subchapter of this text.

A bipolar host exhibiting high hole mobility in the context of the present invention preferably has a HOMO energy E^{HOMO}(H^{BP}) equal to or higher than -6.30 eV (E^{HOMO}(H^{BP}) ≥ -6.30 eV), preferably E^{HOMO}(H^{BP}) ≥ -5.90 eV. More, preferably, E^{HOMO}(H^{BP}) ≥ -5.70 eV and still even more preferably E^{HOMO}(H^{BP}) ≥ -5.40 eV. The HOMO is the highest occupied molecular orbital. The energy of the HOMO is determined as described in a later subchapter of this text.

In one embodiment of the invention, a bipolar host material H^{BP}, preferably each bipolar host material H^{BP} fulfills both of the following requirements:
(i) It has a LUMO energy E^{LUMO}(H^{BP}) equal to or smaller than -2.50 eV (E^{LUMO}(H^{BP}) ≤ -2.50 eV). Preferably, E^{LUMO}(H^{BP}) ≤ -2.60 eV, more preferably E^{LUMO}(H^{BP}) ≤ - 2.65 eV, and even more preferably, E^{LUMO}(H^{BP}) ≤ -2.70 eV. The LUMO is the lowest unoccupied molecular orbital. The energy of the LUMO is determined as described in a later subchapter of this text.
(ii) It has a HOMO energy E^{HOMO}(H^{BP}) equal to or higher than -6.30 eV (E^{HOMO}(H^{BP}) ≥ -6.30 eV), preferably E^{HOMO}(H^{BP}) ≥ -5.90 eV. More preferably, E^{HOMO}(H^{BP}) ≥-5.70 eV and still even more preferably E^{HOMO}(H^{BP}) ≥ -5.40 eV. The HOMO is the highest occupied molecular orbital. The energy of the HOMO is determined as described in a later subchapter of this text.

The person skilled in the art knows which materials are suitable host materials for use in organic electroluminescent devices such as those of the present invention. See for example: Y. Tao, C. Yang, J. Quin, Chemical Society Reviews 2011, 40, 2943, DOI: 10.1039/C0CS00160K; K.S. Yook, J.Y. Lee, The Chemical Record 2015, 16(1), 159, DOI: 10.1002/tcr.201500221; T. Chatterjee, K.-T. Wong, Advanced Optical Materials 2018, 7(1), 1800565, DOI: 10.1002/adom.201800565; Q. Wang, Q.-S. Tian, Y.-L. Zhang, X. Tang, L.-S. Liao, Journal of Materials Chemistry C 2019, 7, 11329, DOI: 10.1039/C9TC03092A.

Furthermore, for example, US2006006365 (A1), US2006208221 (A1), US2005069729 (A1), EP1205527 (A1), US2009302752 (A1), US20090134784 (A1), US2009302742 (A1), US2010187977 (A1), US2010187977 (A1), US2012068170 (A1), US2012097899 (A1), US2006121308 (A1), US2006121308 (A1), US2009167166 (A1), US2007176147 (A1), US2015322091 (A1), US2011105778 (A1), US2011201778 (A1), US2011121274 (A1), US2009302742 (A1), US2010187977 (A1), US2010244009 (A1), US2009136779 (A1), EP2182040 (A2), US2012202997 (A1), US2019393424 (A1), US2019393425 (A1), US2020168819 (A1), US2020079762 (A1), and US2012292576 (A1) disclose host materials that may be used in organic electroluminescent devices according to the present invention. It is understood that this does not imply that the present invention is limited to organic electroluminescent devices comprising host materials disclosed in the cited references. It is also understood that any host materials used in the state of the art may also be suitable host materials H^{B} in the context of the present invention.

In one embodiment of the invention, each light-emitting layer B of an organic electroluminescent device according to the invention comprises one or more p-hosts H^{P}. In one embodiment of the invention, each light-emitting layer B of an organic electroluminescent device according to the invention comprises only a single host material and this host material is a p-host H^{P}.

In one embodiment of the invention, each light-emitting layer B of an organic electroluminescent device according to the invention comprises one or more n-hosts H^{N}. In another embodiment of the invention, each light-emitting layer B of an organic electroluminescent device according to the invention comprises only a single host material and this host material is an n-host H^{N}.

In one embodiment of the invention, each light-emitting layer B of an organic electroluminescent device according to the invention comprises one or more bipolar hosts H^{BP}. In one embodiment of the invention, each light-emitting layer B of an organic electroluminescent device according to the invention comprises only a single host material and this host material is a bipolar host H^{BP}.

In another embodiment of the invention, at least one light-emitting layer B of an organic electroluminescent device according to the invention comprises at least two different host materials H^{B}. In this case, the more than one host materials H^{B} present in the respective light-emitting layer B may either all be p-hosts H^{P} or all be n-hosts H^{N}, or all be bipolar hosts H^{BP}, but may also be a combination thereof.

It is understood that, if an organic electroluminescent device according to the invention comprises more than one light-emitting layer B, any of them may, independently of the one or more other light-emitting layers B, comprise either one host material H^{B} or more than one host materials H^{B} for which the above-mentioned definitions apply. It is further understood that different light-emitting layers B comprised in an organic electroluminescent device according to the invention do not necessarily all comprise the same materials or even the same materials in the same concentrations.

It is understood that, if a light-emitting layer B of an organic electroluminescent device according to the invention is composed of more than one sublayer, any of them may, independently of the one or more other sublayers, comprise either one host material H^{B} or more than one host materials H^{B} for which the above-mentioned definitions apply. It is further understood that different sublayers of a light-emitting layer B comprised in an organic electroluminescent device according to the invention do not necessarily all comprise the same materials or even the same materials in the same concentrations.

If comprised in the same light-emitting layer B of an organic electroluminescent device according to the invention, at least one p-host H^{P} and at least one n-host H^{N} may optionally form an exciplex. The person skilled in the art knows how to choose pairs of H^{P} and H^{N}, which form an exciplex and the selection criteria, including HOMO- and/or LUMO-energy level requirements of H^{P} and H^{N}. This is to say that, in case exciplex formation may be aspired, the highest occupied molecular orbital (HOMO) of the p-host material H^{P} may be at least 0.20 eV higher in energy than the HOMO of the n-host material H^{N} and the lowest unoccupied molecular orbital (LUMO) of the p-host material H^{P} may be at least 0.20 eV higher in energy than the LUMO of the n-host material H^{N}.

In a preferred embodiment of the invention, at least one host material H^{B} (e.g., H^{P}, H^{N}, and/or H^{BP}) is an organic host material, which, in the context of the invention, means that it does not contain any transition metals. In a preferred embodiment of the invention, all host materials H^{B} (H^{P}, H^{N}, and/or H^{BP}) in the electroluminescent device of the present invention are organic host materials, which, in the context of the invention, means that they do not contain any transition metals. Preferably, at least one host material H^{B}, more preferably all host materials H^{B} (H^{P}, H^{N} and/or H^{BP}) predominantly consist of the elements hydrogen (H), carbon (C), and nitrogen (N), but may for example also comprise oxygen (O), boron (B), silicon (Si), fluorine (F), and bromine (Br).

In one embodiment of the invention, each host material H^{B} is a p-host H^{P}.

In a preferred embodiment of the invention, a p-host H^{P}, optionally comprised in any of the at least one light-emitting layer B as a whole (consisting of one (sub)layer or comprising more than one sublayers), comprises or consists of:
- one first chemical moiety, comprising or consisting of a structure according to any of the formulas H^{P}-I, H^{P}-II, H^{P}-III, H^{P}-IV, H^{P}-V, H^{P}-VI, H^{P}-VII, H^{P}-VIII, H^{P}-IX, and H^{P}-X: 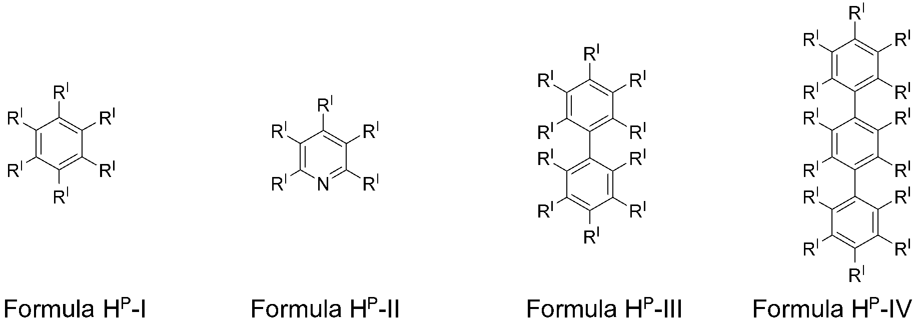 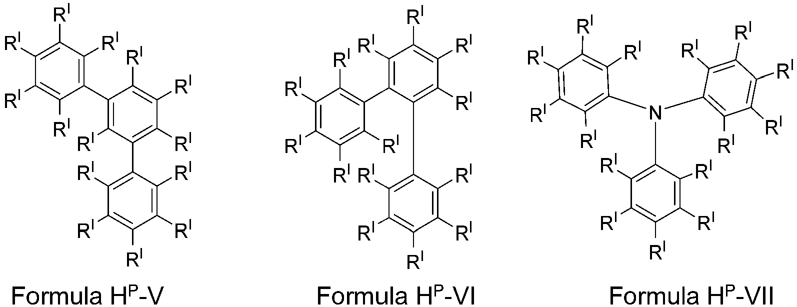 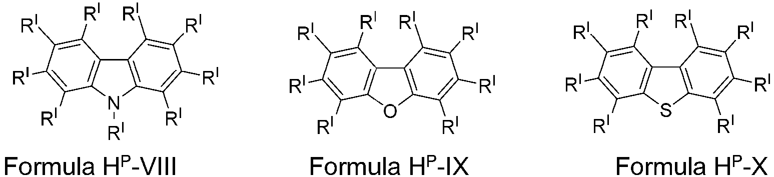 and
- one or more second chemical moieties, each comprising or consisting of a structure according to any of formulas H^{P}-XI, H^{P}-XII, H^{P}-XIII, H^{P}-XIV, H^{P}-XV, H^{P}-XVI, H^{P}-XVII, H^{P}-XVIII, and H^{P}-XIX:

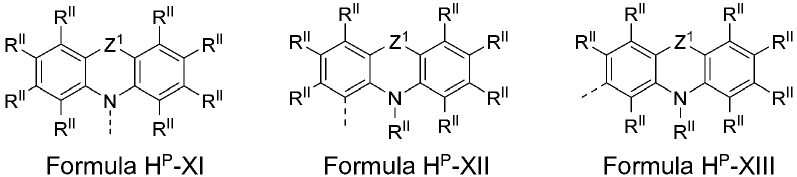

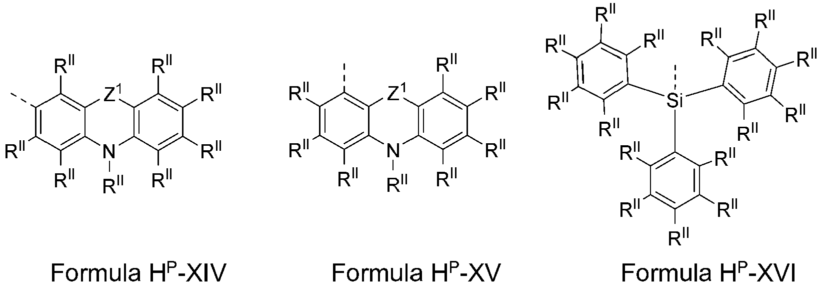

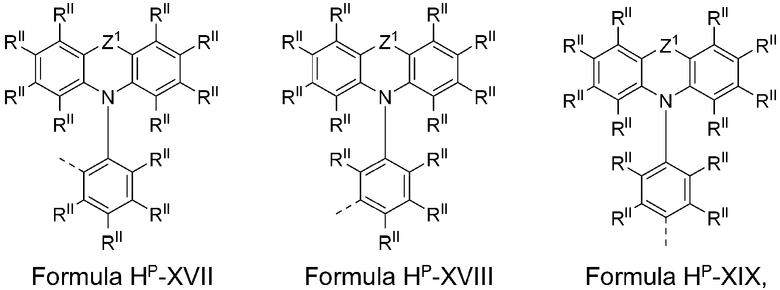

wherein each of the at least one second chemical moieties which is present in the p-host material H^{P} is linked to the first chemical moiety via a single bond which is represented in the formulas above by a dashed line;
wherein
Z¹ is at each occurrence independently of each other selected from the group consisting of a direct bond, C(R^{II})₂, C=C(R^{II})₂, C=O, C=NR^{II}, NR^{II}, O, Si(R^{II})₂, S, S(O) and S(O)₂;
R^{I} is at each occurrence independently of each other a binding site of a single bond linking the first chemical moiety to a second chemical moiety or is selected from the group consisting of: hydrogen, deuterium, Me, ⁱPr, and ^{t}Bu, and
Ph, which is optionally substituted with one or more substituents independently of each other selected from the group consisting of: Me, ⁱPr, ^{t}Bu, and Ph;
wherein at least one R^{I} is a binding site of a single bond linking the first chemical moiety to a second chemical moiety;
R^{II} is at each occurrence independently of each other selected from the group consisting of: hydrogen, deuterium, Me, ⁱPr, ^{t}Bu, and
Ph, which is optionally substituted with one or more substituents independently of each other selected from the group consisting of: Me, ⁱPr, ^{t}Bu, and Ph;
wherein two or more adjacent substituents R^{II} may optionally form an aliphatic or aromatic or heteroaromatic, carbo- or heterocyclic ring system so that the fused ring system consisting of a structure according to any of formulas H^{P}-XI, H^{P}-XII, H^{P}-XIII, H^{P}-XIV, H^{P}-XV, H^{P}-XVI, H^{P}-XVII, H^{P}-XVIII, and H^{P}-XIX as well as the additional rings optionally formed by adjacent substituents R^{II} comprises in total 12-60 carbon atoms, preferably 14-32 carbon atoms.

In an even more preferred embodiment of the invention, Z¹ is at each occurrence a direct bond and adjacent substituents R^{II} do not combine to form an additional ring system.

In a still even more preferred embodiment of the invention, a p-host H^{P} optionally comprised in an organic electroluminescent device according to the invention is selected from the group consisting of the following structures:

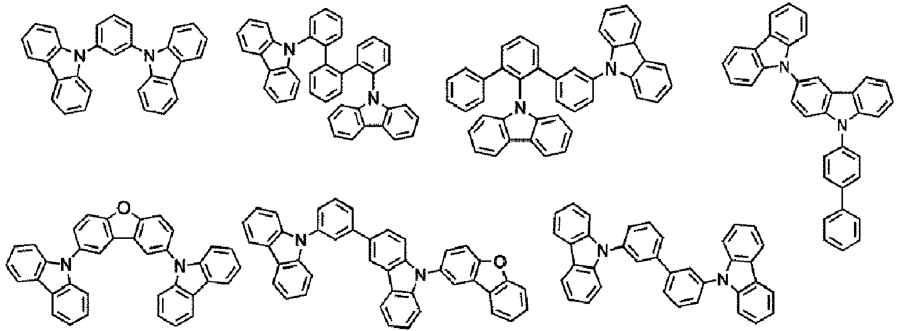

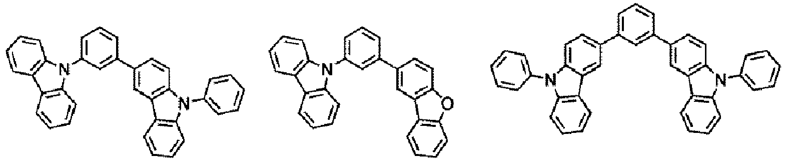

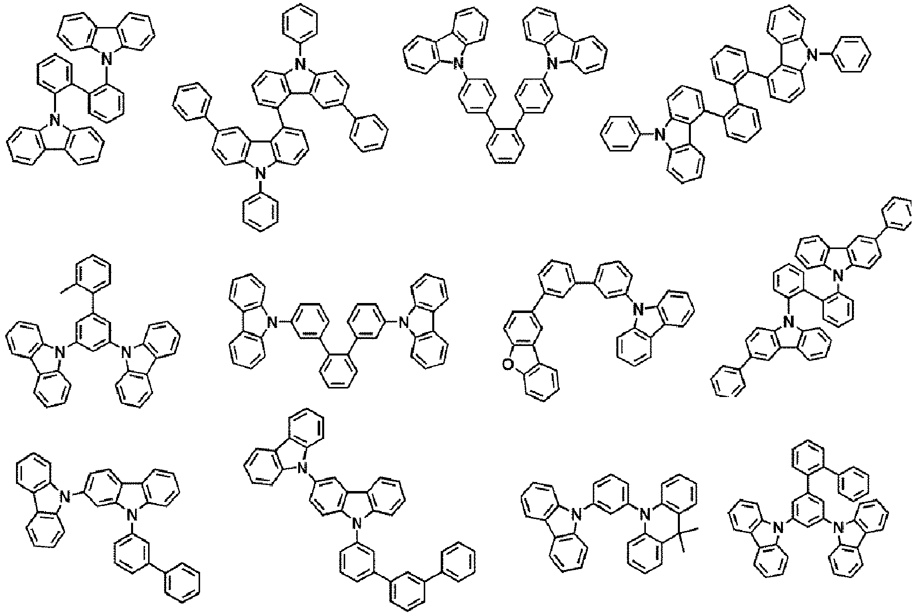

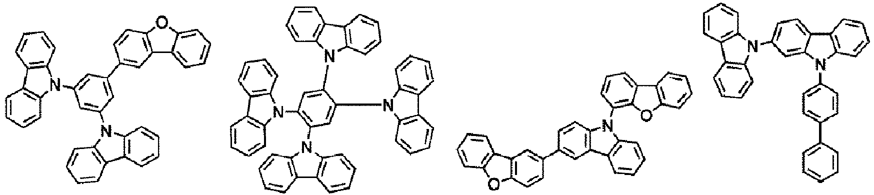

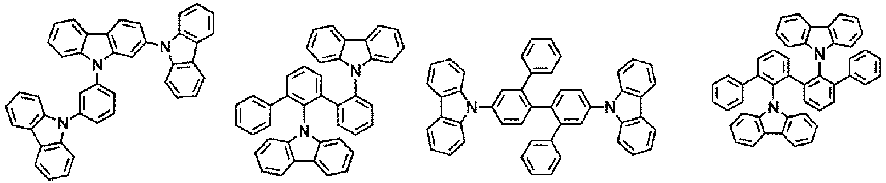

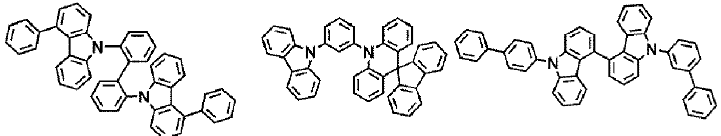

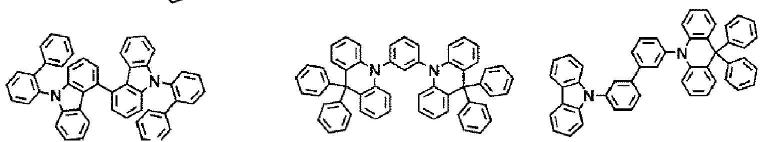

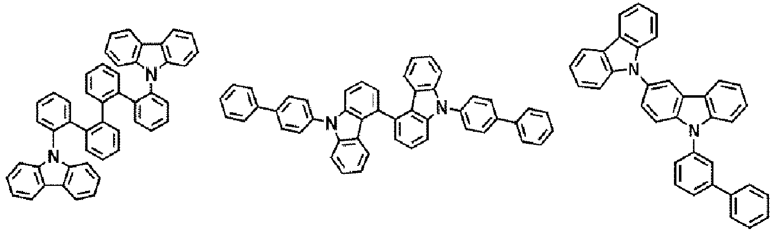

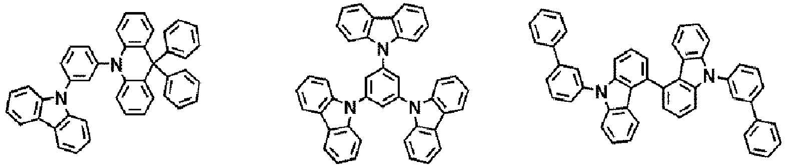

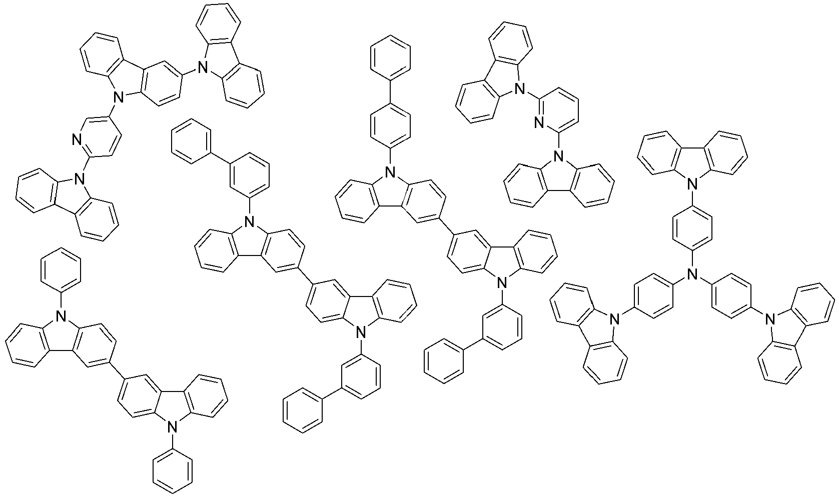

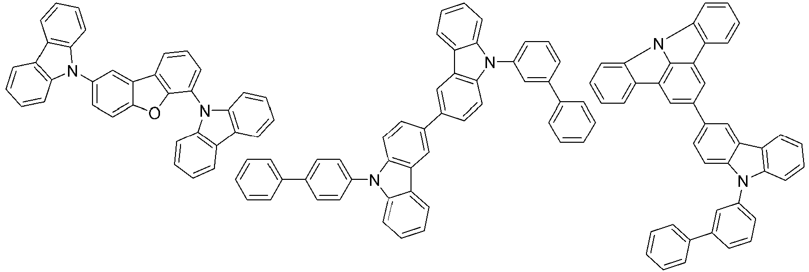

In a preferred embodiment of the invention, an n-host H^{N} optionally comprised in any of the at least one light-emitting layer B as a whole (consisting of one (sub)layer or comprising more than one sublayers) comprises or consists of a structure according to any of the formulas H^{N}-I, H^{N}-II, and H^{N}-III: 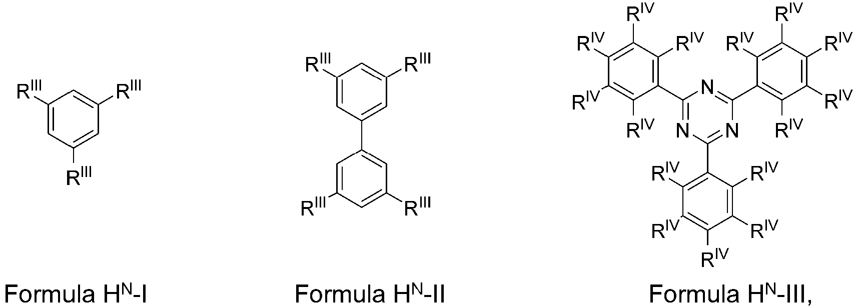
wherein R^{III} and R^{IV} are at each occurrence independently of each other selected from the group consisting of: hydrogen, deuterium, Me, ⁱPr, ^{t}Bu, CN, CF₃,
Ph, which is optionally substituted with one or more substituents independently of each other selected from the group consisting of: Me, ⁱPr, ^{t}Bu, and Ph; and
a structure represented by any of the formulas H^{N}-IV, H^{N}-V, H^{N}-VI, H^{N}-VII, H^{N}-VIII, H^{N}-IX, H^{N}-X, H^{N}-XI, H^{N}-XII, H^{N}-XIII, and H^{N}-XIV: 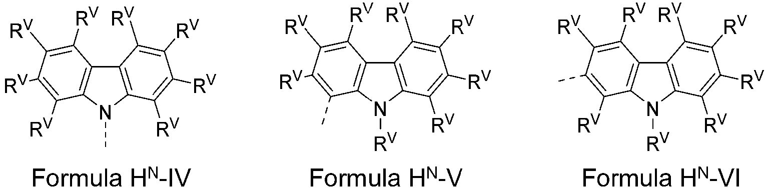 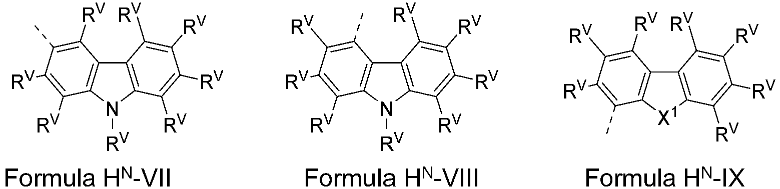 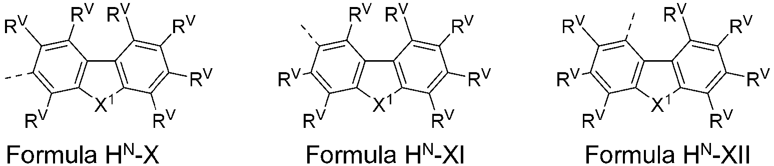 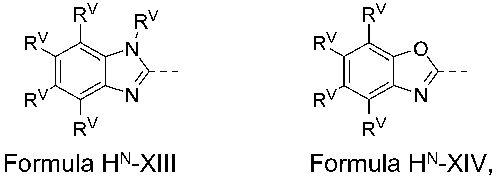
wherein
the dashed line indicates the binding site of a single bond connecting the structure according to any of formulas H^{N}-IV, H^{N}-V, H^{N}-VI, H^{N}-VII, H^{N}-VIII, H^{N}-IX, H^{N}-X, H^{N}-XI, H^{N}-XII, H^{N}-XIII, and H^{N}-XIV to a structure according to any of the formulas H^{N}-I, H^{N}-II, and H^{N}-III;
X¹ is oxygen (O), sulfur (S) or C(R^{V})₂;
R^{V} is at each occurrence independently of each other selected from the group consisting of: hydrogen, deuterium, Me, ⁱPr, ^{t}Bu, and
Ph, which is optionally substituted with one or more substituents independently of each other selected from the group consisting of: Me, ⁱPr, ^{t}Bu, and Ph;
wherein two or more adjacent substituents R^{V} may optionally form an aliphatic or aromatic or heteroaromatic, carbo- or heterocyclic ring system so that the fused ring system consisting of a structure according to any of formulas H^{N}-IV, H^{N}-V, H^{N}-VI, H^{N}-VII, H^{N}-VIII, H^{N}-IX, H^{N}-X, H^{N}-XI, H^{N}-XII, H^{N}-XIII, and H^{N}-XIV as well as the additional rings optionally formed by adjacent substituents R^{V} comprises in total 8-60 carbon atoms, preferably 12-40 carbon atoms, more preferably 14-32 carbon atoms; and
wherein in formulas H^{N}-I and H^{N}-II, at least one substituent R^{III} is CN.

In an even more preferred embodiment of the invention, an n-host H^{N} optionally comprised in an organic electroluminescent device according to the invention is selected from the group consisting of the following structures:

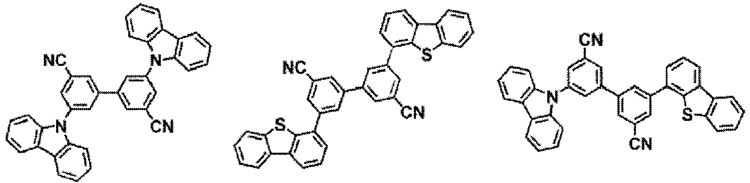

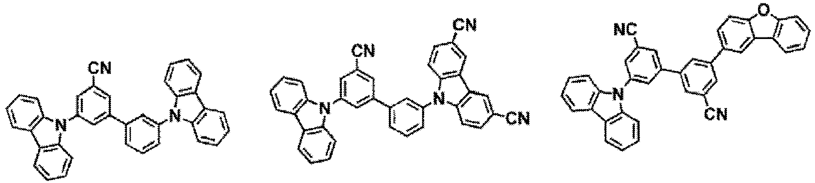

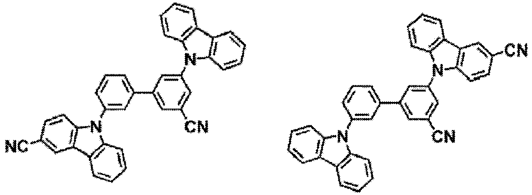

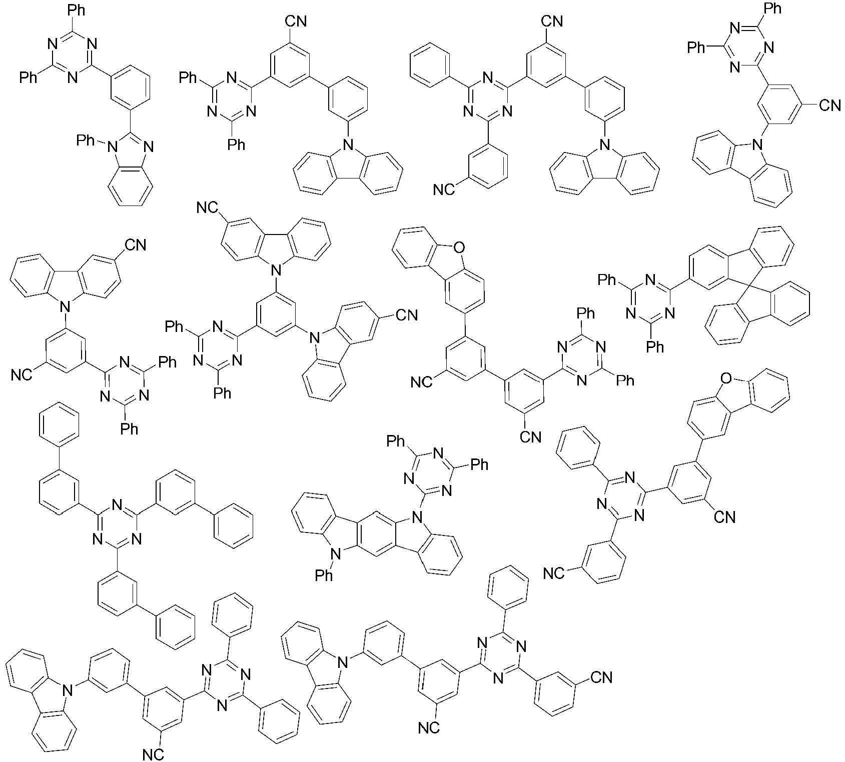

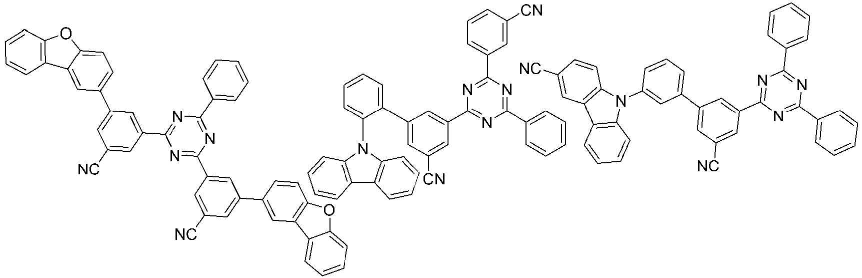

In one embodiment of the invention, no n-host H^{N} comprised in any light-emitting layer B of an organic electroluminescent device according to the invention contains any phosphine oxide groups and, in particular, no n-host H^{N} is bis[2-(diphenylphosphino)phenyl] ether oxide (DPEPO).

### TADF material(s) E^{B}

According to the invention, a thermally activated delayed fluorescence (TADF) material E^{B} is characterized by exhibiting a ΔE_{ST} value, which corresponds to the energy difference between the lowermost excited singlet state energy level E(S1^{E}) and the lowermost excited triplet state energy level E(T1^{E}), of less than 0.4 eV, preferably of less than 0.3 eV, more preferably of less than 0.2 eV, even more preferably of less than 0.1 eV, or even of less than 0.05 eV. Thus, ΔE_{ST} of a TADF material E^{B} according to the invention is sufficiently small to allow for thermal repopulation of the lowermost excited singlet state S1^{E} from the lowermost excited triplet state T1^{E} (also referred to as up-intersystem crossing or reverse intersystem crossing, RISC) at room temperature (RT, i.e., (approximately) 20°C).

Preferably, in the context of the present invention, TADF materials display both, prompt fluorescence when the emissive S1^{E} state is reached in the cause of the charge carrier (hole and electron) recombination and delayed fluorescence when the emissive S1^{E} state is reached via thermally activated RISC from the T1^{E} state.

It is understood that a small FWHM emitter S^{B} comprised in a light-emitting layer B of an organic electroluminescent device according to the invention may optionally also have a ΔE_{ST} value of less than 0.4 eV and exhibit thermally activated delayed fluorescence (TADF). However, for any small FWHM emitter S^{B} in the context of the invention, this is only an optional feature.

In a preferred embodiment of the invention, there is spectral overlap between the emission spectrum of at least one TADF material E^{B} and the absorption spectrum of at least one small FWHM emitter S^{B} (when both spectra are measured under comparable conditions). In this case, the at least one TADF material E^{B} may transfer energy to the at least one small FWHM emitter S^{B}.

According to the invention, a TADF material E^{B} has an emission maximum in the visible wavelength range of from 380 nm to 800 nm, typically measured with 10% by weight of the TADF material E^{B} in poly(methyl methacrylate) PMMA at room temperature (i.e., (approximately) 20°C).

In one embodiment of the invention, each TADF material E^{B} has an emission maximum in the deep blue wavelength range of from 380 nm to 470 nm, preferably 400 nm to 470 nm, typically measured with 10% by weight of the TADF material E^{B} in poly(methyl methacrylate) PMMA at room temperature (i.e., (approximately) 20°C).

In one embodiment of the invention, each TADF material E^{B} has an emission maximum in the green wavelength range of from 480 nm to 560 nm, preferably 500 nmto 560 nm, typically measured with 10% by weight of the TADF material E^{B} in poly(methyl methacrylate) PMMA at room temperature (i.e., (approximately) 20°C).

In one embodiment of the invention, each TADF material E^{B} has an emission maximum in the red wavelength range of from 600 nm to 665 nm, preferably 610 nm to 665 nm, typically measured with 10% by weight of the TADF material E^{B} in poly(methyl methacrylate) PMMA at room temperature (i.e., (approximately) 20°C). In a preferred embodiment of the invention, the emission maximum (peak emission) of a TADF material E^{B} is at a shorter wavelength than the emission maximum (peak emission) of a small FWHM emitter S^{B} in the context of the present invention.

In a preferred embodiment of the invention, each TADF material E^{B} is an organic TADF material, which, in the context of the invention, means that it does not contain any transition metals. Preferably, each TADF material E^{B} according to the invention predominantly consists of the elements hydrogen (H), carbon (C), and nitrogen (N), but may for example also comprise oxygen (O), boron (B), silicon (Si), fluorine (F), and bromine (Br).

In a preferred embodiment of the invention, each TADF material E^{B} has a molecular weight equal to or smaller than 800 g/mol.

In one embodiment of the invention, a TADF emitter E^{B} exhibits a photoluminescence quantum yield (PLQY) equal to or higher than 30%, typically measured with 10% by weight of the TADF material E^{B} in poly(methyl methacrylate) PMMA at room temperature (i.e., (approximately) 20°C).

In a preferred embodiment of the invention, a TADF emitter E^{B} exhibits a photoluminescence quantum yield (PLQY) equal to or higher than 50%, typically measured with 10% by weight of the TADF material E^{B} in poly(methyl methacrylate) PMMA at room temperature (i.e., (approximately) 20°C).

In an even more preferred embodiment of the invention, a TADF emitter E^{B} exhibits a photoluminescence quantum yield (PLQY) equal to or higher than 70%, typically measured with 10% by weight of the TADF material E^{B} in poly(methyl methacrylate) PMMA at room temperature (i.e., (approximately) 20°C).

In one embodiment of the invention, the at least one, preferably each TADF material E^{B}
(i) is characterized by exhibiting a ΔE_{ST} value, which corresponds to the energy difference between the lowermost excited singlet state energy level E(S1^{E}) and the lowermost excited triplet state energy level E(T1^{E}), of less than 0.4 eV; and
(ii) displays a photoluminescence quantum yield (PLQY) of more than 30%.

In one embodiment of the invention, the energy E^{LUMO}(E^{B}) of the lowest unoccupied molecular orbital LUMO(E^{B}) of each TADF material E^{B} is smaller than -2.6 eV.

The person skilled in the art knows how to design TADF molecules E^{B} according to the invention and the structural features that such molecules typically display. Briefly, to facilitate the reverse intersystem crossing (RISC), ΔE_{ST} is usually decreased and, in the context of the present invention, ΔE_{ST} is smaller than 0.4 eV, as stated above. This is oftentimes achieved by designing TADF molecules E^{B} so that the HOMO and LUMO are spatially largely separated on (electron-) donor and (electron-) acceptor groups, respectively. These groups are usually bulky or connected via spiro-junctions so that they are twisted and the spatial overlap of the HOMO and the LUMO is reduced. However, minimizing the spatial overlap of the HOMO and the LUMO also results in a reduction of the photoluminescence quantum yield (PLQY) of the TADF material, which is unfavorable. Therefore, in practice, these two effects are both taken into account to achieve a reduction of ΔE_{ST} as well as a high PLQY.

One common approach for the design of TADF materials is to covalently attach one or more (electron-) donor moieties on which the HOMO is distributed and one or more (electron-) acceptor moieties on which the LUMO is distributed to the same bridge, herein referred to as linker group. A TADF material E^{B} may for example also comprise two or three linker groups which are bonded to the same acceptor moiety and additional donor and acceptor moieties may be bonded to each of these two or three linker groups.

One or more donor moieties and one or more acceptor moieties may also be bonded directly to each other (without the presence of a linker group).

Typical donor moieties are derivatives of diphenyl amine, carbazole, acridine, phenoxazine, and related structures.

Benzene-, biphenyl-, and to some extend also terphenyl-derivatives are common linker groups.

Nitrile groups are very common acceptor moieties in TADF molecules and known examples thereof include:
(i) carbazolyl dicyanobenzene compounds
   such as 2CzPN (4,5-di(9*H*-carbazol-9-yl)phthalonitrile), DCzIPN (4,6-di(9H-carbazol-9-yl)isophthalonitrile), 4CzPN (3,4,5,6-tetra(9H-carbazol-9-yl)phthalonitrile), 4CzIPN (2,4,5,6-Tetra(9*H*-carbazol-9-yl)isophthalonitrile), 4CzTPN (2,4,5,6-tetra(9*H*-carbazol-9-yl)terephthalonitrile), and derivatives thereof;
(ii) carbazolyl cyanopyridine compounds
   such as 4CzCNPy (2,3,5,6-tetra(9H-carbazol-9-yl)-4-cyanopyridine) and derivatives thereof;
(iii) carbazolyl cyanobiphenyl compounds
   such as CNBPCz (4,4',5,5'-tetra(9H-carbazol-9-yl)-[1,1'-biphenyl]-2,2'-dicarbonitrile), CzBPCN (4,4',6,6'-tetra(9H-carbazol-9-yl)-[1,1'-biphenyl]-3,3'-dicarbonitrile), DDCzIPN (3,3',5,5'-tetra(9H-carbazol-9-yl)-[1,1'-biphenyl]-2,2',6,6'-tetracarbonitrile) and derivatives thereof;
wherein in these materials, one or more of the nitrile groups may be replaced my fluorine (F) or trifluoromethyl (CF₃) as acceptor moieties.

Nitrogen-heterocycles such as triazine-, pyrimidine-, triazole-, oxadiazole-, thiadiazole-, heptazine-, 1,4-diazatriphenylene-, benzothiazole-, benzoxazole-, quinoxaline-, and diazafluorene-derivatives are also well-known acceptor moieties used for the construction of TADF molecules. Known examples of TADF molecules comprising for example a triazine acceptor include PIC-TRZ (7,7'-(6-([1,1'-biphenyl]-4-yl)-1,3,5-triazine-2,4-diyl)bis(5-phenyl-5,7-dihydroindolo[2,3-b]carbazole)), mBFCzTrz (5-(3-(4,6-diphenyl-1,3,5-triazin-2-yl)phenyl)-5H-benzofuro[3,2-c]carbazole), and DCzTrz (9,9'-(5-(4,6-diphenyl-1,3,5-triazin-2-yl)-1,3-phenylene)bis(9H-carbazole)).

Another group of TADF materials comprises diaryl ketones such as benzophenone or (heteroaryl)aryl ketones such as 4-benzoylpyridine, 9,10-anthraquinone, 9H-xanthen-9-one, and derivatives thereof as acceptor moieties to which the donor moieties (usually carbazolyl substituents) are bonded. Examples of such TADF molecules include BPBCz (bis(4-(9'-phenyl-9*H*,9'*H*-[3,3'-bicarbazol]-9-yl)phenyl)methanone), mDCBP ((3,5-di(9H-carbazol-9-yl)phenyl)(pyridin-4-yl)methanone), AQ-DTBu-Cz (2,6-bis(4-(3,6-di-tert-butyl-9H-carbazol-9-yl)phenyl)anthracene-9,10-dione), and MCz-XT (3-(1,3,6,8-tetramethyl-9H-carbazol-9-yl)-9H-xanthen-9-one), respectively.

Sulfoxides, in particular diphenyl sulfoxides, are also commonly used as acceptor moieties for the construction of TADF materials and known examples include 4-PC-DPS (9-phenyl-3-(4-(phenylsulfonyl)phenyl)-9H-carbazole), DitBu-DPS (9,9'-(sulfonylbis(4,1-phenylene))bis(9H-carbazole)), and TXO-PhCz (2-(9-phenyl-9H-carbazol-3-yl)-9H-thioxanthen-9-one 10,10-dioxide).

Exemplarily, all groups of TADF molecules mentioned above may provide suitable TADF materials E^{B} for use according to the present invention, given that the specific materials fulfills the aforementioned basic requirement, namely the ΔE_{ST} value being smaller than 0.4 eV.

The person skilled in the art knows that not only the structures named above, but many more materials may be suitable TADF materials E^{B} in the context of the present invention. The skilled artisan is familiar with the design principles of such molecules and also knows how to design such molecules with a certain emission color (e.g. blue, green or red emission).

See for example: H. Tanaka, K. Shizu, H. Nakanotani, C. Adachi, Chemistry of Materials 2013, 25(18), 3766, DOI: 10.1021/cm402428a; J. Li, T. Nakagawa, J. MacDonald, Q. Zhang, H. Nomura, H. Miyazaki, C. Adachi, Advanced Materials 2013, 25(24), 3319, DOI: 10.1002/adma.201300575; K. Nasu, T. Nakagawa, H. Nomura, C.-J. Lin, C.-H. Cheng, M.-R. Tseng, T. Yasudaad, C. Adachi, Chemical Communications 2013, 49(88), 10385, DOI: 10.1039/c3cc44179b; Q. Zhang, B. Li1, S. Huang, H. Nomura, H. Tanaka, C. Adachi, Nature Photonics 2014, 8(4), 326, DOI: 10.1038/nphoton.2014.12; B. Wex, B.R. Kaafarani, Journal of Materials Chemistry C 2017, 5, 8622, DOI: 10.1039/c7tc02156a; Y. Im, M. Kim, Y.J. Cho, J.-A. Seo, K.S. Yook, J.Y. Lee, Chemistry of Materials 2017, 29(5), 1946, DOI: 10.1021/acs.chemmater.6b05324; T.-T. Bui, F. Goubard, M. Ibrahim-Ouali, D. Gigmes, F. Dumur, Beilstein Journal of Organic Chemistry 2018, 14, 282, DOI: 10.3762/bjoc.14.18; X. Liang, Z.-L. Tu, Y.-X. Zheng, Chemistry - A European Journal 2019, 25(22), 5623, DOI: 10.1002/chem.201805952.

Furthermore, for example, US2015105564 (A1), US2015048338 (A1), US2015141642 (A1), US2014336379 (A1), US2014138670 (A1), US2012241732 (A1), EP3315581 (A1), EP3483156 (A1), and US2018053901 (A1) disclose TADF materials E^{B} that may be used in organic electroluminescent devices according to the present invention. It is understood that this does not imply that the present invention is limited to organic electroluminescent devices comprising TADF materials disclosed in the cited references. It is also understood that any TADF materials used in the state of the art may also be suitable TADF materials E^{B} in the context of the present invention.

In one embodiment of the invention, each TADF material E^{B} comprises one or more chemical moieties independently of each other selected from the group consisting of CN, CF₃, and an optionally substituted 1,3,5-triazinyl group.

In one embodiment of the invention, each TADF material E^{B} comprises one or more chemical moieties independently of each other selected from the group consisting of CN and an optionally substituted 1,3,5-triazinyl group.

In one embodiment of the invention, each TADF material E^{B} comprises one or more optionally substituted 1,3,5-triazinyl group.

In one embodiment of the invention, each TADF material E^{B} comprises one or more chemical moieties independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic, carbo- or heterocyclic ring systems.

In a preferred embodiment of the invention, the at least one, preferably each TADF material E^{B} comprises
- one or more first chemical moiety, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic, carbo- or heterocyclic ring systems;
- one or more second chemical moiety, independently of each other selected from the group consisting of CN, CF3, and an optionally substituted 1,3,5-triazinyl group.

In an even more preferred embodiment of the invention, the at least one, preferably each TADF material E^{B} comprises
- one or more first chemical moiety, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic, carbo- or heterocyclic ring systems;
- one or more second chemical moiety, independently of each other selected from the group consisting of CN and an optionally substituted 1,3,5-triazinyl group.

In a still even more preferred embodiment of the invention, the at least one, preferably each TADF material E^{B} comprises
- one or more first chemical moiety, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic, carbo- or heterocyclic ring systems;
- one or more optionally substituted 1,3,5-triazinyl group.

The person skilled in the art knows that the expression "derivatives thereof" means that the respective parent structure may be optionally substituted or any atom within the respective parent structure may be replaced by an atom of another element for example.

In one embodiment of the invention, the organic electroluminescent device comprising at least one light-emitting layer B comprising:
(i) at least one host material H^{B}, which has a lowermost excited singlet state energy level E(S1^{H}) and a lowermost excited triplet state energy level E(T1^{H}); and
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1^{S}) and a lowermost excited triplet state energy level E(T1^{S}), wherein S^{B} emits light with a full width at half maximum (FWHM) of less than or equal to 0.25 eV; and
(iv) at least one thermally activated delayed fluorescence (TADF) material E^{B}, which has a lowermost excited singlet state energy level E(S1^{E}) and a lowermost excited triplet state energy level E(T1^{E}),
   wherein the relations expressed by the following formulas (1) and (2) apply: $E \left({T 1}^{H}\right) > E \left(T{1}^{P}\right)$ $E \left({T 1}^{H}\right) > E \left({T 1}^{E}\right)$ wherein each TADF material E^{B} comprises
   - one or more first chemical moiety, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic, carbo- or heterocyclic ring systems;
   - one or more second chemical moiety, independently of each other selected from the group consisting of CN and an optionally substituted 1,3,5-triazinyl group.

In one embodiment of the invention, each TADF material E^{B} comprises
- one or more first chemical moiety, each comprising or consisting of a structure according to formula D-I: 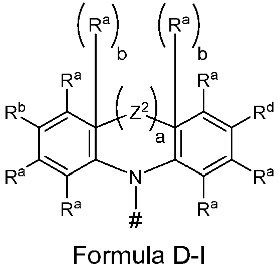 and
- optionally, one or more second chemical moiety, each independently of each other selected from CN, CF₃, and a structure according to any of formulas A-I, A-II, A-III, and A-IV: 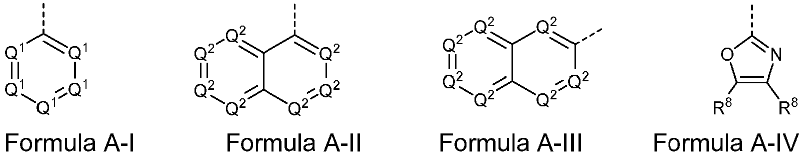 and
- one third chemical moiety comprising or consisting of a structure according to any of formulas L-I, L-II, L-III, L-IV, L-V, L-VI, L-VII, and L-VIII: 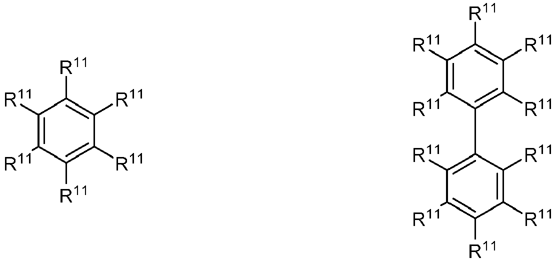 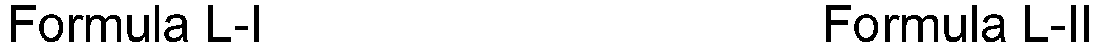 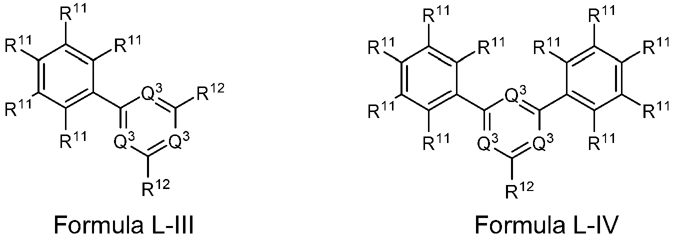 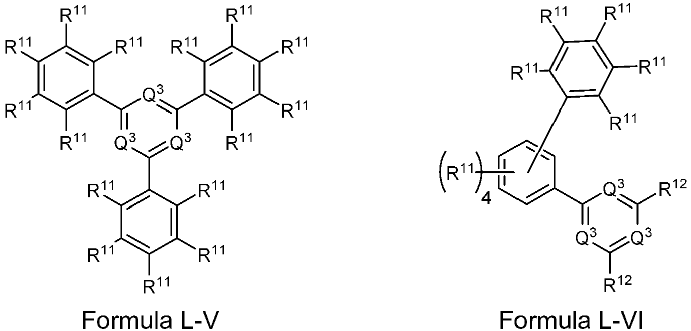 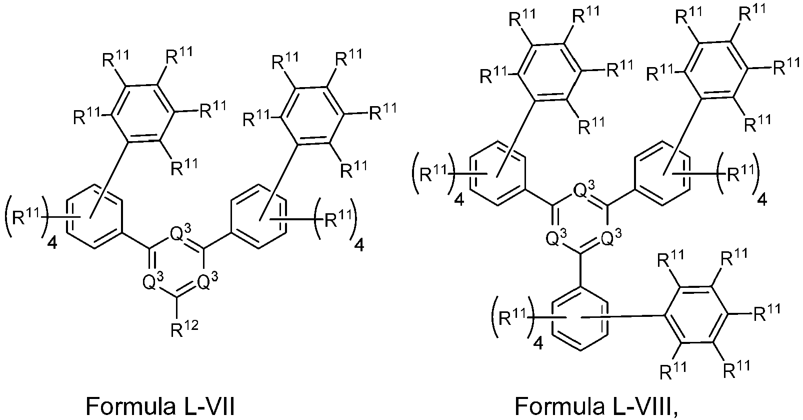 wherein
   the one or more first chemical moiety and the one or more second chemical moiety are covalently bonded via a single bond to the third chemical moiety;
   wherein in formula D-I:
   # represents the binding site of a single bond linking the respective first chemical moiety according to formula D-I to the third chemical moiety;
   Z² is at each occurrence independently of each other selected from the group consisting of a direct bond, CR¹R², C=CR¹R², C=O, C=NR¹, NR¹, O, SiR¹R², S, S(O) and S(O)₂;
   R^{a}, R^{b}, R^{d}, R¹, and R² are at each occurrence independently of each other selected from the group consisting of: hydrogen, deuterium, N(R³)₂, OR³, Si(R³)₃, B(OR³)₂, OSO₂R³, CF₃, CN, F, Cl, Br, I,
   C₁-C₄₀-alkyl,
      which is optionally substituted with one or more substituents R³ and
      wherein one or more non-adjacent CH₂-groups are optionally substituted by R³C=CR³, C=C, Si(R³)₂, Ge(R³)₂, Sn(R³)₂, C=O, C=S, C=Se, C=NR³, P(=O)(R³), SO, SO₂, NR³, O, S or CONR³;
   C₁-C₄₀-alkoxy,
      which is optionally substituted with one or more substituents R³ and
      wherein one or more non-adjacent CH₂-groups are optionally substituted by R³C=CR³, C=C, Si(R³)₂, Ge(R³)₂, Sn(R³)₂, C=O, C=S, C=Se, C=NR³, P(=O)(R³), SO, SO₂, NR³, O, S or CONR³;
   C₁-C₄₀-thioalkoxy,
      which is optionally substituted with one or more substituents R³ and
      wherein one or more non-adjacent CH₂-groups are optionally substituted by R³C=CR³, C=C, Si(R³)₂, Ge(R³)₂, Sn(R³)₂, C=O, C=S, C=Se, C=NR³, P(=O)(R³), SO, SO₂, NR³, O, S or CONR³;
   C₂-C₄₀-alkenyl,
      which is optionally substituted with one or more substituents R³ and
      wherein one or more non-adjacent CH₂-groups are optionally substituted by R³C=CR³, C=C, Si(R³)₂, Ge(R³)₂, Sn(R³)₂, C=O, C=S, C=Se, C=NR³, P(=O)(R³), SO, SO₂, NR³, O, S or CONR³;
   C₂-C₄₀-alkynyl,
      which is optionally substituted with one or more substituents R³ and
      wherein one or more non-adjacent CH₂-groups are optionally substituted by R³C=CR³, C=C, Si(R³)₂, Ge(R³)₂, Sn(R³)₂, C=O, C=S, C=Se, C=NR³, P(=O)(R³), SO, SO₂, NR³, O, S or CONR³;
   C₆-C₆₀-aryl,
      which is optionally substituted with one or more substituents R³; and
   C₃-C₆₀-heteroaryl,
      which is optionally substituted with one or more substituents R³;
   R³ is at each occurrence independently of each other selected from the group consisting of: hydrogen, deuterium, N(R⁴)₂, OR⁴, Si(R⁴)₃, B(OR⁴)₂, OSO₂R⁴, CF₃, CN, F, Br, I,
   C₁-C₄₀-alkyl,
      which is optionally substituted with one or more substituents R⁴ and
      wherein one or more non-adjacent CH₂-groups are optionally substituted by R⁴C=CR⁴, C=C, Si(R⁴)₂, Ge(R⁴)₂, Sn(R⁴)₂, C=O, C=S, C=Se, C=NR⁴, P(=O)(R⁴), SO, SO₂, NR⁴, O, S or CONR⁴;
   C₁-C₄₀-alkoxy,
      which is optionally substituted with one or more substituents R⁴ and
      wherein one or more non-adjacent CH₂-groups are optionally substituted by R⁴C=CR⁴, C=C, Si(R⁴)₂, Ge(R⁴)₂, Sn(R⁴)₂, C=O, C=S, C=Se, C=NR⁴, P(=O)(R⁴), SO, SO₂, NR⁴, O, S or CONR⁴;
   C₁-C₄₀-thioalkoxy,
      which is optionally substituted with one or more substituents R⁴ and
      wherein one or more non-adjacent CH₂-groups are optionally substituted by R⁴C=CR⁴, C=C, Si(R⁴)₂, Ge(R⁴)₂, Sn(R⁴)₂, C=O, C=S, C=Se, C=NR⁴, P(=O)(R⁴), SO, SO₂, NR⁴, O, S or CONR⁴;
   C₂-C₄₀-alkenyl,
      which is optionally substituted with one or more substituents R⁴ and
      wherein one or more non-adjacent CH₂-groups are optionally substituted by R⁴C=CR⁴, C=C, Si(R⁴)₂, Ge(R⁴)₂, Sn(R⁴)₂, C=O, C=S, C=Se, C=NR⁴, P(=O)(R⁴), SO, SO₂, NR⁴, O, S or CONR⁴;
   C₂-C₄₀-alkynyl,
      which is optionally substituted with one or more substituents R⁴ and
      wherein one or more non-adjacent CH₂-groups are optionally substituted by R⁴C=CR⁴, C=C, Si(R⁴)₂, Ge(R⁴)₂, Sn(R⁴)₂, C=O, C=S, C=Se, C=NR⁴, P(=O)(R⁴), SO, SO₂, NR⁴, O, S or CONR⁴;
   C₆-C₆₀-aryl,
      which is optionally substituted with one or more substituents R⁴; and
   C₃-C₅₇-heteroaryl,
      which is optionally substituted with one or more substituents R⁴;
   wherein, optionally, any substituents R^{a}, R^{b}, R^{d}, R¹, R², R³, and R⁴ independently of each other form a mono- or polycyclic, aliphatic or aromatic or heteroaromatic, carbo- or heterocyclic and/or benzo-fused ring system with one or more adjacent substituents selected from R^{a}, R^{b}, R^{d}, R¹, R², R³, and R⁴; wherein the optionally so formed ring system may optionally be substituted with one or more substituents R⁵;
   R⁴ and R⁵ are at each occurrence independently of each other selected from the group consisting of: hydrogen, deuterium, OPh, CF₃, CN, F,
   C₁-C₅-alkyl,
      wherein one or more hydrogen atoms are optionally, independently of each other substituted by deuterium, CN, CF₃, or F;
   C₁-C₅-alkoxy,
      wherein one or more hydrogen atoms are optionally, independently of each other substituted by deuterium, CN, CF₃, or F;
   C₁-C₅-thioalkoxy,
      wherein one or more hydrogen atoms are optionally, independently of each other substituted by deuterium, CN, CF₃, or F;
   C₂-C₅-alkenyl,
      wherein one or more hydrogen atoms are optionally, independently of each other substituted by deuterium, CN, CF₃, or F;
   C₂-C₅-alkynyl,
      wherein one or more hydrogen atoms are optionally, independently of each other substituted by deuterium, CN, CF₃, or F;
   C₆-C₁₈-aryl,
      wherein one or more hydrogen atoms are optionally, independently of each other substituted by deuterium, C₁-C₅-alkyl, Ph or CN;
   C₃-C₁₇-heteroaryl,
      wherein one or more hydrogen atoms are optionally, independently of each other substituted by deuterium, Ph or C₁-C₅-alkyl;
   N(C₆-C₁₈-aryl)₂;
   N(C₃-C₁₇-heteroaryl)₂, and
   N(C₃-C₁₇-heteroaryl)(C₆-C₁₈-aryl);
   a is an integer and is 0 or 1;
   b is an integer and is at each occurrence 0 or 1, wherein both b are always identical;
   wherein both integers b are 0 when integer a is 1 and integer a is 0 when both integers b are 1;
   wherein in formulas A-I, A-II, A-III, A-IV:
      the dashed line indicates a single bond linking the respective second chemical moiety according to formula A-I, A-II, A-III or A-IV to the third chemical moiety;
      Q¹ is at each occurrence independently of each other selected from nitrogen (N), CR⁶, and CR⁷, with the provision that in formula A-I, two adjacent groups Q¹ cannot both be nitrogen (N); wherein, if none of the groups Q¹ in formula A-I is nitrogen (N), at least one of the groups Q¹ is CR⁷;
      Q² is at each occurrence independently of each other selected from nitrogen (N), and CR⁶, with the provisions that in formulas A-II and A-III, at least one group Q² is nitrogen (N) and that two adjacent groups Q² cannot both be nitrogen (N);
      R⁶ and R⁸ are at each occurrence independently of each other selected from the group consisting of: hydrogen, deuterium, N(R⁹)₂, OR⁹, Si(R⁹)₃, B(OR⁹)₂, OSO₂R⁹, CF₃, CN, F, Cl, Br, I,
      C₁-C₄₀-alkyl,
         which is optionally substituted with one or more substituents R⁹ and
         wherein one or more non-adjacent CH₂-groups are optionally substituted by R⁹C=CR⁹, C=C, Si(R⁹)₂, Ge(R⁹)₂, Sn(R⁹)₂, C=O, C=S, C=Se, C=NR⁹, P(=O)(R⁹), SO, SO₂, NR⁹, O, S or CONR⁹;
      C₁-C₄₀-alkoxy,
         which is optionally substituted with one or more substituents R⁹ and
         wherein one or more non-adjacent CH₂-groups are optionally substituted by R⁹C=CR⁹, C=C, Si(R⁹)₂, Ge(R⁹)₂, Sn(R⁹)₂, C=O, C=S, C=Se, C=NR⁹, P(=O)(R⁹), SO, SO₂, NR⁹, O, S or CONR⁹;
      C₁-C₄₀-thioalkoxy,
         which is optionally substituted with one or more substituents R⁹ and
         wherein one or more non-adjacent CH₂-groups are optionally substituted by R⁹C=CR⁹, C=C, Si(R⁹)₂, Ge(R⁹)₂, Sn(R⁹)₂, C=O, C=S, C=Se, C=NR⁹, P(=O)(R⁹), SO, SO₂, NR⁹, O, S or CONR⁹;
      C₂-C₄₀-alkenyl,
         which is optionally substituted with one or more substituents R⁹ and
         wherein one or more non-adjacent CH₂-groups are optionally substituted by R⁹C=CR⁹, C≡C, Si(R⁹)₂, Ge(R⁹)₂, Sn(R⁹)₂, C=O, C=S, C=Se, C=NR⁹, P(=O)(R⁹), SO, SO₂, NR⁹, O, S or CONR⁹;
      C₂-C₄₀-alkynyl,
         which is optionally substituted with one or more substituents R⁹ and
         wherein one or more non-adjacent CH₂-groups are optionally substituted by R⁹C=CR⁹, C=C, Si(R⁹)₂, Ge(R⁹)₂, Sn(R⁹)₂, C=O, C=S, C=Se, C=NR⁹, P(=O)(R⁹), SO, SO₂, NR⁹, O, S or CONR⁹;
      C₆-C₆₀-aryl,
         which is optionally substituted with one or more substituents R⁹; and
      C₃-C₆₀-heteroaryl,
         which is optionally substituted with one or more substituents R⁹;
      R⁹ is at each occurrence independently of each other selected from the group consisting of: hydrogen, deuterium, N(R¹⁰)₂, OR¹⁰, Si(R¹⁰)₃, B(OR¹⁰)₂, OSO₂R¹⁰, CF₃, CN, F, Cl, Br, I,
      C₁-C₄₀-alkyl,
         which is optionally substituted with one or more substituents R¹⁰ and
         wherein one or more non-adjacent CH₂-groups are optionally substituted by R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S or CONR¹⁰;
      C₁-C₄₀-alkoxy,
         which is optionally substituted with one or more substituents R¹⁰ and
         wherein one or more non-adjacent CH₂-groups are optionally substituted by R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S or CONR¹⁰;
      C₁-C₄₀-thioalkoxy,
         which is optionally substituted with one or more substituents R¹⁰ and
         wherein one or more non-adjacent CH₂-groups are optionally substituted by R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S or CONR¹⁰;
      C₂-C₄₀-alkenyl,
         which is optionally substituted with one or more substituents R¹⁰ and
         wherein one or more non-adjacent CH₂-groups are optionally substituted by R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S or CONR¹⁰;
      C₂-C₄₀-alkynyl,
         which is optionally substituted with one or more substituents R¹⁰ and
         wherein one or more non-adjacent CH₂-groups are optionally substituted by R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S or CONR¹⁰;
      C₆-C₆₀-aryl,
         which is optionally substituted with one or more substituents R¹⁰; and C₃-C₆₀-heteroaryl,
         which is optionally substituted with one or more substituents R¹⁰;
      R¹⁰ is at each occurrence independently of each other selected from the group consisting of: hydrogen, deuterium, OPh, CF₃, CN, F,
      C₁-C₅-alkyl,
         wherein one or more hydrogen atoms are optionally, independently of each other substituted by deuterium, CN, CF₃, or F;
      C₁-C₅-alkoxy,
         wherein one or more hydrogen atoms are optionally, independently of each other substituted by deuterium, CN, CF₃, or F;
      C₁-C₅-thioalkoxy,
         wherein one or more hydrogen atoms are optionally, independently of each other substituted by deuterium, CN, CF₃, or F;
      C₂-C₅-alkenyl,
         wherein one or more hydrogen atoms are optionally, independently of each other substituted by deuterium, CN, CF₃, or F;
      C₂-C₅-alkynyl,
         wherein one or more hydrogen atoms are optionally, independently of each other substituted by deuterium, CN, CF₃, or F;
      C₆-C₁₈-aryl,
         wherein one or more hydrogen atoms are optionally, independently of each other substituted by deuterium, C₁-C₅-alkyl, Ph or CN;
      C₃-C₁₇-heteroaryl,
         wherein one or more hydrogen atoms are optionally, independently of each other substituted by deuterium, Ph or C₁-C₅-alkyl;
      N(C₆-C₁₈-aryl)₂;
      N(C₃-C₁₇-heteroaryl)₂, and
      N(C₃-C₁₇-heteroaryl)(C₆-C₁₈-aryl);
      R⁷ is at each occurrence independently of each other selected from the group consisting of CN, CF₃ and a structure according to formula EWG-I: 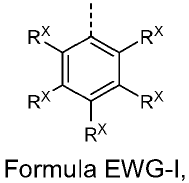
      wherein R^{X} is defined as R⁶, with the provision that at least one group R^{X} in formula EWG-I is CN or CF₃;
      wherein the two adjacent groups R⁸ in formula A-IV optionally form an aromatic ring, which is fused to the structure of formula A-IV and optionally substituted with one or more substituents R¹⁰; wherein the optionally so formed fused ring system comprises in total 9 to 18 ring atoms;
      wherein in formulas L-I, L-II, L-III, L-IV, L-V, L-VI, L-VII, and L-VIII:
         Q³ is at each occurrence independently of each other selected from nitrogen (N) and CR¹², with the provision that at least one Q³ is nitrogen (N);
         R¹¹ is at each occurrence independently of each other either the binding site of a single bond connecting a first or a second chemical moiety to the third chemical moiety or is independently of each other selected from the group consisting of: hydrogen, deuterium, F, Cl, Br, I,
         C₁-C₅-alkyl,
            wherein one or more hydrogen atoms are optionally substituted by deuterium;
         C₆-C₁₈-aryl,
            wherein one or more hydrogen atoms are optionally, independently of each other substituted by deuterium, C₁-C₅-alkyl groups, C₆-C₁₈-aryl groups, F, Cl, Br, and I;
         R¹² is defined as R⁶;
         wherein the maximum number of first and second chemical moieties attached to the third chemical moiety is only limited by the number of available binding sites on the third chemical moiety (in other words: the number of substituents R¹¹), with the aforementioned provision, that each TADF material E^{B} comprises at least one first chemical moiety, at least one second chemical moiety, and exactly one third chemical moiety.

In a preferred embodiment of the invention,
Z² is at each occurrence independently of each other selected from the group consisting of a direct bond, CR¹R², C=CR¹R², C=O, C=NR¹, NR¹, O, SiR¹R², S, S(O) and S(O)₂;
R^{a}, R^{b}, R^{d}, R¹, and R² are at each occurrence independently of each other selected from the group consisting of: hydrogen, deuterium, N(R³)₂, OR³, Si(R³)₃, CF₃, CN, F, Cl, Br, I,
C₁-C₄₀-alkyl,
   which is optionally substituted with one or more substituents R³ and
   wherein one or more non-adjacent CH₂-groups are optionally substituted by R³C=CR³, C=C, Si(R³)₂, Ge(R³)₂, Sn(R³)₂, C=O, C=S, C=Se, C=NR³, P(=O)(R³), SO, SO₂, NR³, O, S or CONR³;
C₆-C₆₀-aryl,
   which is optionally substituted with one or more substituents R³; and
C₃-C₆₀-heteroaryl,
   which is optionally substituted with one or more substituents R³;
R³ is at each occurrence independently of each other selected from the group consisting of: hydrogen, deuterium, N(R⁴)₂, OR⁴, Si(R⁴)₃, CF₃, CN, F, Br, I,
C₁-C₄₀-alkyl,
   which is optionally substituted with one or more substituents R⁴ and
   wherein one or more non-adjacent CH₂-groups are optionally substituted by R⁴C=CR⁴, C=C, Si(R⁴)₂, Ge(R⁴)₂, Sn(R⁴)₂, C=O, C=S, C=Se, C=NR⁴, P(=O)(R⁴), SO, SO₂, NR⁴, O, S or CONR⁴;
C₆-C₆₀-aryl,
   which is optionally substituted with one or more substituents R⁴; and
C₃-C₅₇-heteroaryl,
   which is optionally substituted with one or more substituents R⁴;
wherein, optionally, any of the substituents R^{a}, R^{b}, R^{d}, R¹, R², R³, and R⁴ independently of each other form a mono- or polycyclic, aliphatic or aromatic or heteroaromatic, carbo- or heterocyclic and/or benzo-fused ring system with one or more adjacent substituents selected from R^{a}, R^{b}, R^{d}, R¹, R², R³, and R⁴; wherein the optionally so formed ring system may optionally be substituted with one or more substituents R⁵;
R⁴ and R⁵ are at each occurrence independently of each other selected from the group consisting of: hydrogen, deuterium, CF₃, CN, F,
C₁-C₅-alkyl,
   wherein one or more hydrogen atoms are optionally, independently of each other substituted by deuterium, CN, CF₃, or F;
C₆-C₁₈-aryl,
   wherein one or more hydrogen atoms are optionally, independently of each other substituted by deuterium, C₁-C₅-alkyl, Ph or CN;
C₃-C₁₇-heteroaryl,
   wherein one or more hydrogen atoms are optionally, independently of each other substituted by deuterium, C₁-C₅-alkyl or Ph;
N(C₆-C₁₈-aryl)₂;
N(C₃-C₁₇-heteroaryl)₂, and
N(C₃-C₁₇-heteroaryl)(C₆-C₁₈-aryl);
a is an integer and is 0 or 1;
b is an integer and is at each occurrence 0 or 1, wherein both b are always identical;
wherein both integers b are 0 when integer a is 1 and integer a is 0 when both integers b are 1;
Q¹ is at each occurrence independently of each other selected from nitrogen (N), CR⁶, and CR⁷, with the provision that in formula A-I, two adjacent groups Q¹ cannot both be nitrogen (N); wherein, if none of the groups Q¹ in formula A-I is nitrogen (N), at least one of the groups Q¹ is CR⁷;
Q² is at each occurrence independently of each other selected from nitrogen (N), and CR⁶, with the provision that in formulas A-II and A-III, at least one group Q² is nitrogen (N) and that two adjacent groups Q² cannot both be nitrogen (N);
R⁶ and R⁸ are at each occurrence independently of each other selected from the group consisting of: hydrogen, deuterium, N(R⁹)₂, OR⁹, Si(R⁹)₃, CF₃, CN, F, Cl, Br, I,
C₁-C₄₀-alkyl,
   which is optionally substituted with one or more substituents R⁹ and
   wherein one or more non-adjacent CH₂-groups are optionally substituted by R⁹C=CR⁹, C=C, Si(R⁹)₂, Ge(R⁹)₂, Sn(R⁹)₂, C=O, C=S, C=Se, C=NR⁹, P(=O)(R⁹), SO, SO₂, NR⁹, O, S or CONR⁹;
C₆-C₆₀-aryl,
   which is optionally substituted with one or more substituents R⁹; and
C₃-C₆₀-heteroaryl,
   which is optionally substituted with one or more substituents R⁹;
R⁹ is at each occurrence independently of each other selected from the group consisting of: hydrogen, deuterium, N(R¹⁰)₂, OR¹⁰, Si(R¹⁰)₃, CF₃, CN, F, Cl, Br, I,
C₁-C₄₀-alkyl,
   which is optionally substituted with one or more substituents R¹⁰ and
   wherein one or more non-adjacent CH₂-groups are optionally substituted by R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S or CONR¹⁰;
C₆-C₆₀-aryl,
   which is optionally substituted with one or more substituents R¹⁰; and
C₃-C₆₀-heteroaryl,
   which is optionally substituted with one or more substituents R¹⁰;
R¹⁰ is at each occurrence independently of each other selected from the group consisting of: hydrogen, deuterium, OPh, CF₃, CN, F,
C₁-C₅-alkyl,
   wherein one or more hydrogen atoms are optionally, independently of each other substituted by deuterium, CN, CF₃, or F;
C₆-C₁₈-aryl,
   wherein one or more hydrogen atoms are optionally, independently of each other substituted by deuterium, C₁-C₅-alkyl, Ph or CN;
C₃-C₁₇-heteroaryl,
   wherein one or more hydrogen atoms are optionally, independently of each other substituted by deuterium, C₁-C₅-alkyl or Ph;
N(C₆-C₁₈-aryl)₂;
N(C₃-C₁₇-heteroaryl)₂, and
N(C₃-C₁₇-heteroaryl)(C₆-C₁₈-aryl);
R⁷ is at each occurrence independently of each other selected from the group consisting of CN, CF₃ and a structure according to formula EWG-I: 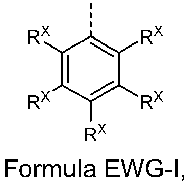
wherein R^{X} is defined as R⁶, with the provision, that at least one group R^{X} is CN or CF₃;
wherein the two adjacent groups R⁸ in formula A-IV optionally form an aromatic ring, which is fused to the structure of formula A-IV and optionally substituted with one or more substituents R¹⁰; wherein the optionally so formed fused ring system comprises in total 9 to 18 ring atoms;
Q³ is at each occurrence independently of each other selected from nitrogen (N) and CR¹², with the provision that at least one Q³ is nitrogen (N);
R¹¹ is at each occurrence independently of each other either the binding site of a single bond connecting a first or a second chemical moiety to the third chemical moiety or is independently of each other selected from the group consisting of: hydrogen, deuterium,
C₁-C₅-alkyl,
   wherein one or more hydrogen atoms are optionally substituted by deuterium;
C₆-C₁₈-aryl, wherein one or more hydrogen atoms are optionally, independently of each other substituted by deuterium, C₁-C₅-alkyl groups, and C₆-C₁₈-aryl groups;
R¹² is defined as R⁶;
wherein the maximum number of first and second chemical moieties attached to the third chemical moiety is only limited by the number of available binding sites on the third chemical moiety (in other words: the number of substituents R¹¹) (preferably, with the aforementioned provision, that each TADF material E^{B} comprises at least one first chemical moiety, at least one second chemical moiety, and exactly one third chemical moiety).

In an even more preferred embodiment of the invention,
Z² is at each occurrence independently of each other selected from the group consisting of a direct bond, CR¹R², C=CR¹R², C=O, C=NR¹, NR¹, O, SiR¹R², S, S(O) and S(O)₂;
R^{a}, R^{b}, R^{d}, R¹, and R² are at each occurrence independently of each other selected from the group consisting of: hydrogen, deuterium, N(R³)₂, OR³, Si(R³)₃, CF₃, CN, F, Cl, Br, I,
C₁-C₅-alkyl,
   which is optionally substituted with one or more substituents R³
C₆-C₁₈-aryl,
   which is optionally substituted with one or more substituents R³; and
C₃-C₁₇-heteroaryl,
   which is optionally substituted with one or more substituents R³;
R³ is at each occurrence independently of each other selected from the group consisting of: hydrogen, deuterium, N(R⁴)₂, Si(R⁴)₃, CF₃, CN, F,
C₁-C₅-alkyl,
   which is optionally substituted with one or more substituents R⁴ and
C₆-C₁₈-aryl,
   which is optionally substituted with one or more substituents R⁴; and
C₃-C₁₇-heteroaryl,
   which is optionally substituted with one or more substituents R⁴;
wherein, optionally, any of the substituents R^{a}, R^{b}, R^{d}, R¹, R² and R³ independently of each other form a mono- or polycyclic, aliphatic or aromatic or heteroaromatic, carbo- or heterocyclic and/or benzo-fused ring system with one or more adjacent substituents selected from R^{a}, R^{b}, R^{d}, R¹, R², and R³; wherein the optionally so formed ring system may optionally be substituted with one or more substituents R⁵;
R⁴ and R⁵ are at each occurrence independently of each other selected from the group consisting of: hydrogen, deuterium, CF₃, CN, F, Me, ⁱPr, ^{t}Bu, N(Ph)₂, and
Ph, wherein one or more hydrogen atoms are optionally, independently of each other substituted by deuterium, Me, ⁱPr, ^{t}Bu, and Ph;
a is an integer and is 0 or 1;
b is an integer and is at each occurrence 0 or 1, wherein both b are always identical;
wherein both integers b are 0 when integer a is 1 and integer a is 0 when both integers b are 1;
Q¹ is at each occurrence independently of each other selected from nitrogen (N), CR⁶, and CR⁷, with the provision that in formula A-I, two adjacent groups Q¹ cannot both be nitrogen (N); wherein, if none of the groups Q¹ in formula A-I is nitrogen (N), at least one of the groups Q¹ is CR⁷;
Q² is at each occurrence independently of each other selected from nitrogen (N), and CR⁶, with the provision that in formulas A-II and A-III, at least one group Q² is nitrogen (N) and that two adjacent groups Q² cannot both be nitrogen (N);
R⁶ and R⁸ are at each occurrence independently of each other selected from the group consisting of: hydrogen, deuterium, N(R⁹)₂, OR⁹, Si(R⁹)₃, CF₃, CN, F,
C₁-C₅-alkyl,
   which is optionally substituted with one or more substituents R⁹;
C₆-C₁₈-aryl,
   which is optionally substituted with one or more substituents R⁹; and
C₃-C₁₇-heteroaryl,
   which is optionally substituted with one or more substituents R⁹;
R⁹ is at each occurrence independently of each other selected from the group consisting of: hydrogen, deuterium, N(R¹⁰)₂, OR¹⁰, Si(R¹⁰)₃, CF₃, CN, F,
C₁-C₅-alkyl,
   which is optionally substituted with one or more substituents R¹⁰ C₆-C₁₈-aryl,
   which is optionally substituted with one or more substituents R¹⁰; and C₃-C₁₇-heteroaryl,
   which is optionally substituted with one or more substituents R¹⁰;
R¹⁰ is at each occurrence independently of each other selected from the group consisting of: hydrogen, deuterium, Me, ⁱPr, ^{t}Bu, CF₃, CN, F, N(Ph)₂, and
Ph, wherein one or more hydrogen atoms are optionally, independently of each other substituted by deuterium, Me, ⁱPr, ^{t}Bu, Ph, CN, CF₃, or F.
R⁷ is at each occurrence independently of each other selected from the group consisting of CN, CF₃ and a structure according to formula EWG-I: 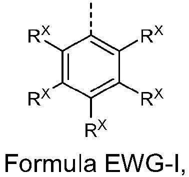
wherein R^{X} is defined as R⁶, with the provision, that at least one group R^{X} is CN or CF₃;
wherein the two adjacent groups R⁸ in formula A-IV optionally form an aromatic ring, which is fused to the structure of formula A-IV and optionally substituted with one or more substituents R¹⁰; wherein the optionally so formed fused ring system comprises in total 9 to 18 ring atoms;
Q³ is at each occurrence independently of each other selected from nitrogen (N) and CR¹², with the provision that at least one Q³ is nitrogen (N);
R¹¹ is at each occurrence independently of each other either the binding site of a single bond connecting a first or a second chemical moiety to the third chemical moiety or is independently of each other selected from the group consisting of: hydrogen, deuterium,
C₁-C₅-alkyl,
   wherein one or more hydrogen atoms are optionally substituted by deuterium;
C₆-C₁₈-aryl,
   which is optionally substituted with one or more substituents independently of each other selected from the group consisting of: deuterium, Me, ⁱPr, ^{t}Bu, and Ph;
R¹² is defined as R⁶;
wherein the maximum number of first and second chemical moieties attached to the third chemical moiety is only limited by the number of available binding sites on the third chemical moiety (in other words: the number of substituents R¹¹) (preferably with the aforementioned provision, that each TADF material E^{B} comprises at least one first chemical moiety, at least one second chemical moiety, and exactly one third chemical moiety).

In a still even more preferred embodiment of the invention,
Z² is at each occurrence independently of each other selected from the group consisting of a direct bond, CR¹R², C=O, NR¹, O, SiR¹R², S, S(O) and S(O)₂;
R^{a}, R^{b}, R^{d}, R¹, and R² are at each occurrence independently of each other selected from the group consisting of: hydrogen, deuterium, N(R³)₂, OR³, Si(R³)₃, CF₃, CN,
C₁-C₅-alkyl,
   which is optionally substituted with one or more substituents R³
C₆-C₁₈-aryl,
   which is optionally substituted with one or more substituents R³; and
C₃-C₁₇-heteroaryl,
   which is optionally substituted with one or more substituents R³;
R³ is at each occurrence independently of each other selected from the group consisting of: hydrogen, deuterium, CF₃, CN, F, Me, ⁱPr, ^{t}Bu, N(Ph)₂,
Ph, wherein one or more hydrogen atoms are optionally, independently of each other substituted by deuterium, Me, ⁱPr, ^{t}Bu, and Ph;
wherein, optionally, any of the substituents R^{a}, R^{b}, R^{d}, R¹, and R² independently of each other form a mono- or polycyclic, aliphatic or aromatic or heteroaromatic, carbo- or heterocyclic and/or benzo-fused ring system with one or more adjacent substituents selected from R^{a}, R^{b}, R^{d}, R¹, and R²; wherein the optionally so formed ring system may optionally be substituted with one or more substituents independently of each other selected from the group consisting of: hydrogen, deuterium, Me, ⁱPr, ^{t}Bu, CN, CF₃, F, and
Ph, wherein one or more hydrogen atoms are optionally, independently of each other substituted by deuterium, Me, ⁱPr, ^{t}Bu, and Ph;
wherein an optionally so formed fused ring system constructed from the structure according to formula D-1 and the attached rings formed by adjacent substituents comprises in total 13 to 30 ring atoms, preferably 16 to 30 ring atoms;
a is an integer and is 0 or 1;
b is an integer and is at each occurrence 0 or 1, wherein both b are always identical;
wherein both integers b are 0 when integer a is 1 and integer a is 0 when both integers b are 1;
Q¹ is at each occurrence independently of each other selected from nitrogen (N), CR⁶, and CR⁷, with the provision that in formula A-I, two adjacent groups Q¹ cannot both be nitrogen (N); wherein, if none of the groups Q¹ in formula A-I is nitrogen (N), at least one of the groups Q¹ is CR⁷;
Q² is at each occurrence independently of each other selected from nitrogen (N), and CR⁶, with the provision that in formulas A-II and A-III, at least one group Q² is nitrogen (N) and that two adjacent groups Q² cannot both be nitrogen (N);
R⁶ and R⁸ are at each occurrence independently of each other selected from the group consisting of: hydrogen, deuterium, N(R⁹)₂, OR⁹, Si(R⁹)₃, CF₃, CN, F,
C₁-C₅-alkyl,
   which is optionally substituted with one or more substituents R⁹;
C₆-C₁₈-aryl,
   which is optionally substituted with one or more substituents R⁹; and C₃-C₁₇-heteroaryl,
   which is optionally substituted with one or more substituents R⁹;
R⁹ is at each occurrence independently of each other selected from the group consisting of: hydrogen, deuterium, Me, ⁱPr, ^{t}Bu, CF₃, CN, F, N(Ph)₂, and
Ph, wherein one or more hydrogen atoms are optionally, independently of each other substituted by deuterium, Me, ⁱPr, ^{t}Bu, Ph, CN, CF₃, or F.
R⁷ is at each occurrence independently of each other selected from the group consisting of CN, CF₃ and a structure according to formula EWG-I: 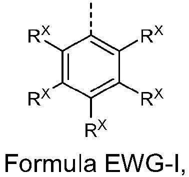
wherein R^{X} is defined as R⁶, with the provision, that at least one group R^{X} is CN or CF₃;
wherein the two adjacent groups R⁸ in formula A-IV optionally form an aromatic ring, which is fused to the structure of formula A-IV and optionally substituted with one or more substituents independently of each other selected from the group consisting of: hydrogen, deuterium, Me, ⁱPr, ^{t}Bu, CF₃, CN, and
Ph, wherein one or more hydrogen atoms are optionally, independently of each other substituted by deuterium, Me, ⁱPr, ^{t}Bu, Ph, CN or CF₃;
wherein the optionally so formed fused ring system comprises in total 9 to 18 ring atoms;
Q³ is at each occurrence independently of each other selected from nitrogen (N) and CR¹², with the provision that at least one Q³ is nitrogen (N);
R¹¹ is at each occurrence independently of each other either the binding site of a single bond connecting a first or a second chemical moiety to the third chemical moiety or is independently of each other selected from the group consisting of: hydrogen, deuterium, Me, ⁱPr, ^{t}Bu, and
Ph, which is optionally substituted with one or more substituents independently of each other selected from the group consisting of: deuterium, Me, ⁱPr, ^{t}Bu, and Ph;
R¹² is defined as R⁶;
wherein the maximum number of first and second chemical moieties attached to the third chemical moiety is only limited by the number of available binding sites on the third chemical moiety (in other words: the number of substituents R¹¹) (preferably with the aforementioned provision, that each TADF material E^{B} comprises at least one first chemical moiety, at least one second chemical moiety, and exactly one third chemical moiety).

In a still even more preferred embodiment of the invention,
Z² is at each occurrence independently of each other selected from the group consisting of a direct bond, CR¹R², C=O, NR¹, O, SiR¹R², S, S(O) and S(O)₂;
R^{a}, R^{b}, and R^{d} are at each occurrence independently of each other selected from the group consisting of: hydrogen, deuterium, N(R³)₂, OR³, Si(R³)₃, CF₃, CN, Me, ⁱPr, ^{t}Bu,
Ph, wherein one or more hydrogen atoms are optionally, independently of each other substituted by deuterium, Me, ⁱPr, ^{t}Bu, and Ph;
carbazolyl, wherein one or more hydrogen atoms are optionally, independently of each other substituted by deuterium, Me, ⁱPr, ^{t}Bu, and Ph;
triazinyl, wherein one or more hydrogen atoms are optionally, independently of each other substituted by deuterium, Me, ⁱPr, ^{t}Bu, and Ph;
pyrimidinyl, wherein one or more hydrogen atoms are optionally, independently of each other substituted by deuterium, Me, ⁱPr, ^{t}Bu, and Ph;
pyridinyl, wherein one or more hydrogen atoms are optionally, independently of each other substituted by deuterium, Me, ⁱPr, ^{t}Bu, and Ph;
R¹ and R² are at each occurrence independently of each other selected from the group consisting of: hydrogen, deuterium, N(R³)₂, OR³, Si(R³)₃, CF₃, CN,
C₁-C₅-alkyl,
   which is optionally substituted with one or more substituents R³
C₆-C₁₈-aryl,
   which is optionally substituted with one or more substituents R³; and
C₃-C₁₇-heteroaryl,
   which is optionally substituted with one or more substituents R³;
R³ is at each occurrence independently of each other selected from the group consisting of: hydrogen, deuterium, CF₃, CN, F, Me, ⁱPr, ^{t}Bu, and
Ph, wherein one or more hydrogen atoms are optionally, independently of each other substituted by deuterium, Me, ⁱPr, ^{t}Bu, and Ph;
wherein, optionally, any of the substituents R^{a}, R^{b}, R^{d}, R¹, and R² independently of each other form a mono- or polycyclic, aliphatic or aromatic or heteroaromatic, carbo- or heterocyclic and/or benzo-fused ring system with one or more adjacent substituents selected from R^{a}, R^{b}, R^{d}, R¹, and R²; wherein the optionally so formed ring system may optionally be substituted with one or more substituents independently of each other selected from the group consisting of: hydrogen, deuterium, Me, ⁱPr, ^{t}Bu, CN, CF₃, F, and
Ph, wherein one or more hydrogen atoms are optionally, independently of each other substituted by deuterium, Me, ⁱPr, ^{t}Bu, and Ph;
wherein an optionally so formed fused ring system constructed from the structure according to formula D1 and the attached rings formed by adjacent substituents comprises in total 13 to 30 ring atoms, preferably 16 to 30 ring atoms;
a is an integer and is 0 or 1;
b is an integer and is at each occurrence 0 or 1, wherein both b are always identical;
wherein both integers b are 0 when integer a is 1 and integer a is 0 when both integers b are 1;
Q¹ is at each occurrence independently of each other selected from nitrogen (N), CR⁶, and CR⁷, with the provision that in formula A-I, two adjacent groups Q¹ cannot both be nitrogen (N); wherein, if none of the groups Q¹ in formula A-I is nitrogen (N), at least one of the groups Q¹ is CR⁷;
Q² is at each occurrence independently of each other selected from nitrogen (N), and CR⁶, with the provision that in formulas A-II and A-III, at least one group Q² is nitrogen (N) and that two adjacent groups Q² cannot both be nitrogen (N);
R⁶ and R⁸ are at each occurrence independently of each other selected from the group consisting of: hydrogen, deuterium, N(R⁹)₂, OR⁹, Si(R⁹)₃, CF₃, CN, F,
C₁-C₅-alkyl,
   which is optionally substituted with one or more substituents R⁹;
C₆-C₁₈-aryl,
   which is optionally substituted with one or more substituents R⁹; and
C₃-C₁₇-heteroaryl,
   which is optionally substituted with one or more substituents R⁹;
R⁹ is at each occurrence independently of each other selected from the group consisting of: hydrogen, deuterium, Me, ⁱPr, ^{t}Bu, CF₃, CN, F, N(Ph)₂, and
Ph, wherein one or more hydrogen atoms are optionally, independently of each other substituted by deuterium, Me, ⁱPr, ^{t}Bu, Ph, CN, CF₃, or F.

R⁷ is at each occurrence independently of each other selected from the group consisting of CN, CF₃ and a structure according to formula EWG-I: 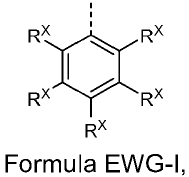
wherein R^{X} is defined as R⁶, with the provision, that at least one group R^{X} is CN or CF₃;
wherein the two adjacent groups R⁸ in formula A-IV optionally form an aromatic ring, which is fused to the structure of formula A-IV and optionally substituted with one or more substituents independently of each other selected from the group consisting of: hydrogen, deuterium, Me, ⁱPr, ^{t}Bu, and
Ph, wherein one or more hydrogen atoms are optionally, independently of each other substituted by deuterium, Me, ⁱPr, ^{t}Bu, Ph;
wherein the optionally so formed fused ring system comprises in total 9 to 18 ring atoms;
Q³ is at each occurrence independently of each other selected from nitrogen (N) and CR¹², with the provision that at least one Q³ is nitrogen (N);
R¹¹ is at each occurrence independently of each other either the binding site of a single bond connecting a first or a second chemical moiety to the third chemical moiety or is independently of each other selected from the group consisting of: hydrogen, deuterium, Me, ⁱPr, ^{t}Bu, and
Ph, which is optionally substituted with one or more substituents independently of each other selected from the group consisting of: deuterium, Me, ⁱPr, ^{t}Bu, and Ph;
R¹² is defined as R⁶;
wherein the maximum number of first and second chemical moieties attached to the third chemical moiety is only limited by the number of available binding sites on the third chemical moiety (in other words: the number of substituents R¹¹) (preferably with the aforementioned provision, that each TADF material E^{B} comprises at least one first chemical moiety, at least one second chemical moiety, and exactly one third chemical moiety).

In a still even more preferred embodiment of the invention,
Z² is at each occurrence independently of each other selected from the group consisting of a direct bond, CR¹R², C=O, NR¹, O, SiR¹R², S, S(O) and S(O)₂;
R^{a}, R^{b}, and R^{d} are at each occurrence independently of each other selected from the group consisting of: hydrogen, deuterium, N(R³)₂, OR³, Si(R³)₃, CF₃, CN, Me, ⁱPr, ^{t}Bu,
Ph, wherein one or more hydrogen atoms are optionally, independently of each other substituted by deuterium, Me, ⁱPr, ^{t}Bu, and Ph; and
carbazolyl, wherein one or more hydrogen atoms are optionally, independently of each other substituted by deuterium, Me, ⁱPr, ^{t}Bu, and Ph;
R¹ and R² are at each occurrence independently of each other selected from the group consisting of: hydrogen, deuterium, OR³, Si(R³)₃,
C₁-C₅-alkyl,
   which is optionally substituted with one or more substituents R³
C₆-C₁₈-aryl,
   which is optionally substituted with one or more substituents R³; and
R³ is at each occurrence independently of each other selected from the group consisting of: hydrogen, deuterium, CF₃, CN, F, Me, ⁱPr, ^{t}Bu, and
Ph, wherein one or more hydrogen atoms are optionally, independently of each other substituted by deuterium, Me, ⁱPr, ^{t}Bu, and Ph;
wherein, optionally, any of the substituents R^{a}, R^{b}, R^{d}, R¹, and R² independently of each other form a mono- or polycyclic, aliphatic or aromatic or heteroaromatic, carbo- or heterocyclic and/or benzo-fused ring system with one or more substituents selected from R^{a}, R^{b}, R^{d}, R¹, and R²; wherein the optionally so formed ring system may optionally be substituted with one or more substituents independently of each other selected from the group consisting of: hydrogen, deuterium, Me, ⁱPr, ^{t}Bu, CN, CF₃, F, and
Ph, wherein one or more hydrogen atoms are optionally, independently of each other substituted by deuterium, Me, ⁱPr, ^{t}Bu, and Ph;
wherein an optionally so formed fused ring system constructed from the structure according to formula D1 and the attached rings formed by adjacent substituents comprises in total 13 to 30 ring atoms, preferably 16 to 30 ring atoms;
a is an integer and is 0 or 1;
b is an integer and is at each occurrence 0 or 1, wherein both b are always identical;
wherein both integers b are 0 when integer a is 1 and integer a is 0 when both integers b are 1;
Q¹ is at each occurrence independently of each other selected from nitrogen (N), CR⁶, and CR⁷, with the provision that in formula A-I, two adjacent groups Q¹ cannot both be nitrogen (N); wherein, if none of the groups Q¹ in formula A-I is nitrogen (N), at least one of the groups Q¹ is CR⁷;
Q² is at each occurrence independently of each other selected from nitrogen (N), and CR⁶, with the provision that in formulas A-II and A-III, at least one group Q² is nitrogen (N) and that two adjacent groups Q² cannot both be nitrogen (N);
R⁶ and R⁸ are at each occurrence independently of each other selected from the group consisting of: hydrogen, deuterium, OPh, N(Ph)₂, Si(Me)₃, Si(Ph)₃, CF₃, CN, F, Me, ⁱPr, ^{t}Bu,
Ph, wherein one or more hydrogen atoms are optionally, independently of each other substituted by deuterium, Me, ⁱPr, ^{t}Bu, and Ph;
carbazolyl, wherein one or more hydrogen atoms are optionally, independently of each other substituted by deuterium, Me, ⁱPr, ^{t}Bu, and Ph;
R⁷ is at each occurrence independently of each other selected from the group consisting of CN, CF₃ and a structure according to formula EWG-I: 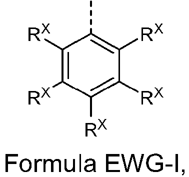
wherein R^{X} is defined as R⁶, with the provision, that at least one group R^{X} is CN or CF₃;
wherein the two adjacent groups R⁸ in formula A-IV optionally form an aromatic ring, which is fused to the structure of formula A-IV and optionally substituted with one or more substituents hydrogen, deuterium, Me, ⁱPr, ^{t}Bu, and
Ph, wherein one or more hydrogen atoms are optionally, independently of each other substituted by deuterium, Me, ⁱPr, ^{t}Bu, Ph;
wherein the optionally so formed fused ring system comprises in total 9 to 18 ring atoms;
Q³ is at each occurrence independently of each other selected from nitrogen (N) and CR¹², with the provision that at least one Q³ is nitrogen (N);
R¹¹ is at each occurrence independently of each other either the binding site of a single bond connecting a first or a second chemical moiety to the third chemical moiety or is independently of each other selected from the group consisting of: hydrogen, deuterium, Me, ⁱPr, ^{t}Bu, and
Ph, which is optionally substituted with one or more substituents independently of each other selected from the group consisting of: deuterium, Me, ⁱPr, ^{t}Bu, and Ph;
R¹² is defined as R⁶;
wherein the maximum number of first and second chemical moieties attached to the third chemical moiety is only limited by the number of available binding sites on the third chemical moiety (in other words: the number of substituents R¹¹), (preferably with the aforementioned provision, that each TADF material E^{B} comprises at least one first chemical moiety, at least one second chemical moiety, and exactly one third chemical moiety).

In a still even more preferred embodiment of the invention,
Z² is at each occurrence independently of each other selected from the group consisting of a direct bond, CR¹R², C=O, NR¹, O, SiR¹R², S, S(O) and S(O)₂;
R^{a}, R^{b}, and R^{d} are at each occurrence independently of each other selected from the group consisting of: hydrogen, deuterium, N(Ph)₂, Si(Me)₃, Si(Ph)₃, CF₃, CN, Me, ⁱPr, ^{t}Bu,
Ph, wherein one or more hydrogen atoms are optionally, independently of each other substituted by deuterium, Me, ⁱPr, ^{t}Bu, and Ph; and
carbazolyl, wherein one or more hydrogen atoms are optionally, independently of each other substituted by deuterium, Me, ⁱPr, ^{t}Bu, and Ph;
R¹ and R² are at each occurrence independently of each other selected from the group consisting of: hydrogen, deuterium, Me, ⁱPr, ^{t}Bu,
Ph, wherein one or more hydrogen atoms are optionally, independently of each other substituted by deuterium, Me, ⁱPr, ^{t}Bu, and Ph;
wherein, optionally, any of the substituents R^{a}, R^{b}, R^{d}, R¹, and R² independently of each other form a mono- or polycyclic, aliphatic or aromatic or heteroaromatic, carbo- or heterocyclic and/or benzo-fused ring system with one or more substituents selected from R^{a}, R^{b}, R^{d}, R¹, and R²; wherein the optionally so formed ring system may optionally be substituted with one or more substituents independently of each other selected from the group consisting of: hydrogen, deuterium, Me, ⁱPr, ^{t}Bu, CN, CF₃, F, and
Ph, wherein one or more hydrogen atoms are optionally, independently of each other substituted by deuterium, Me, ⁱPr, ^{t}Bu, and Ph;
wherein an optionally so formed fused ring system constructed from the structure according to formula D1 and the attached rings formed by adjacent substituents comprises in total 13 to 30 ring atoms, preferably 16 to 30 ring atoms;
a is an integer and is 0 or 1;
b is an integer and is at each occurrence 0 or 1, wherein both b are always identical;
wherein both integers b are 0 when integer a is 1 and integer a is 0 when both integers b are 1;
Q¹ is at each occurrence independently of each other selected from nitrogen (N), CR⁶, and CR⁷, with the provision that in formula A-I, two adjacent groups Q¹ cannot both be nitrogen (N); wherein, if none of the groups Q¹ in formula A-I is nitrogen (N), at least one of the groups Q¹ is CR⁷;
Q² is at each occurrence independently of each other selected from nitrogen (N), and CR⁶, with the provision that in formulas A-II and A-III, at least one group Q² is nitrogen (N) and that two adjacent groups Q² cannot both be nitrogen (N);
R⁶ and R⁸ are at each occurrence independently of each other selected from the group consisting of: hydrogen, deuterium, N(Ph)₂, Si(Me)₃, Si(Ph)₃, Me, ⁱPr, ^{t}Bu,
Ph, wherein one or more hydrogen atoms are optionally, independently of each other substituted by deuterium, Me, ⁱPr, ^{t}Bu, and Ph;
carbazolyl, wherein one or more hydrogen atoms are optionally, independently of each other substituted by deuterium, Me, ⁱPr, ^{t}Bu, and Ph;
R⁷ is at each occurrence independently of each other selected from the group consisting of CN, CF₃ and a structure according to formula EWG-I: 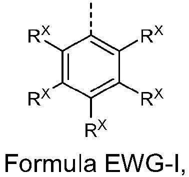
wherein R^{X} is defined as R⁶, but may also be CN or CF₃, with the provision, that at least one group R^{X} is CN or CF₃;
wherein the two adjacent groups R⁸ in formula A-IV optionally form an aromatic ring, which is fused to the structure of formula A-IV and optionally substituted with one or more substituents hydrogen, deuterium, Me, ⁱPr, ^{t}Bu, and
Ph, wherein one or more hydrogen atoms are optionally, independently of each other substituted by deuterium, Me, ⁱPr, ^{t}Bu, Ph;
wherein the optionally so formed fused ring system comprises in total 9 to 18 ring atoms;
Q³ is at each occurrence independently of each other selected from nitrogen (N) and CR¹², with the provision that at least one Q³ is nitrogen (N);
R¹¹ is at each occurrence independently of each other either the binding site of a single bond connecting a first or a second chemical moiety to the third chemical moiety or is independently of each other selected from the group consisting of: hydrogen, deuterium, Me, ⁱPr, ^{t}Bu, and
Ph, which is optionally substituted with one or more substituents independently of each other selected from the group consisting of: deuterium, Me, ⁱPr, ^{t}Bu, and Ph;
R¹² is defined as R⁶;
wherein the maximum number of first and second chemical moieties attached to the third chemical moiety is only limited by the number of available binding sites on the third chemical moiety (in other words: the number of substituents R¹¹) (preferably with the aforementioned provision, that each TADF material E^{B} comprises at least one first chemical moiety, at least one second chemical moiety, and exactly one third chemical moiety).

In a particularly preferred embodiment of the invention,
Z² is at each occurrence independently of each other selected from the group consisting of a direct bond, CR¹R², C=O, NR¹, O, SiR¹R², S, S(O) and S(O)₂;
R^{a}, R^{b}, and R^{d} are at each occurrence independently of each other selected from the group consisting of: hydrogen, deuterium, CF₃, CN, Me, ⁱPr, ^{t}Bu, and
Ph, wherein one or more hydrogen atoms are optionally, independently of each other substituted by deuterium, Me, ⁱPr, ^{t}Bu, and Ph;
R¹ and R² are at each occurrence independently of each other selected from the group consisting of: hydrogen, deuterium, Me, ⁱPr, ^{t}Bu, and
Ph, wherein one or more hydrogen atoms are optionally, independently of each other substituted by deuterium, Me, ⁱPr, ^{t}Bu, and Ph;
wherein, optionally, any of the substituents R^{a}, R^{b}, R^{d}, R¹, and R² independently of each other form a mono- or polycyclic, aliphatic or aromatic or heteroaromatic, carbo- or heterocyclic and/or benzo-fused ring system with one or more substituents selected from R^{a}, R^{b}, R^{d}, R¹, and R²; wherein the optionally so formed ring system may optionally be substituted with one or more substituents independently of each other selected from the group consisting of: hydrogen, deuterium, Me, ⁱPr, ^{t}Bu, CN, CF₃, and
Ph, wherein one or more hydrogen atoms are optionally, independently of each other substituted by deuterium, Me, ⁱPr, ^{t}Bu, and Ph;
wherein an optionally so formed fused ring system constructed from the structure according to formula D1 and the attached rings formed by adjacent substituents comprises in total 13 to 30 ring atoms, preferably 16 to 30 ring atoms;
a is an integer and is 0 or 1;
b is an integer and is at each occurrence 0 or 1, wherein both b are always identical;
wherein both integers b are 0 when integer a is 1 and integer a is 0 when both integers b are 1;
Q¹ is at each occurrence independently of each other selected from nitrogen (N), CR⁶, and CR⁷, with the provision that in formula A-I, two adjacent groups Q¹ cannot both be nitrogen (N); wherein, if none of the groups Q¹ in formula A-I is nitrogen (N), at least one of the groups Q¹ is CR⁷;
Q² is at each occurrence independently of each other selected from nitrogen (N), and CR⁶, with the provision that in formulas A-II and A-III, at least one group Q² is nitrogen (N) and that two adjacent groups Q² cannot both be nitrogen (N);
R⁶ and R⁸ are at each occurrence independently of each other selected from the group consisting of: hydrogen, deuterium, N(Ph)₂, Me, ⁱPr, ^{t}Bu,
Ph, wherein one or more hydrogen atoms are optionally, independently of each other substituted by deuterium, Me, ⁱPr, ^{t}Bu, and Ph; and
carbazolyl, wherein one or more hydrogen atoms are optionally, independently of each other substituted by deuterium, Me, ⁱPr, ^{t}Bu, and Ph;
R⁷ is at each occurrence independently of each other selected from the group consisting of CN, CF₃ and a structure according to formula EWG-I: 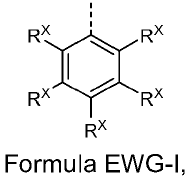
wherein R^{X} is defined as R⁶, but may also be CN or CF₃, with the provision, that at least one group R^{X} is CN or CF₃;
wherein the two adjacent groups R⁸ in formula A-IV optionally form an aromatic ring, which is fused to the structure of formula A-IV and optionally substituted with one or more substituents hydrogen, deuterium, Me, ⁱPr, ^{t}Bu, and
Ph, wherein one or more hydrogen atoms are optionally, independently of each other substituted by deuterium, Me, ⁱPr, ^{t}Bu, Ph;
wherein the optionally so formed fused ring system comprises in total 9 to 18 ring atoms;
Q³ is at each occurrence independently of each other selected from nitrogen (N) and CR¹², with the provision that at least one Q³ is nitrogen (N);
R¹¹ is at each occurrence independently of each other either the binding site of a single bond connecting a first or a second chemical moiety to the third chemical moiety or is independently of each other selected from the group consisting of: hydrogen, deuterium, Me, ⁱPr, ^{t}Bu, and
Ph, which is optionally substituted with one or more substituents independently of each other selected from the group consisting of: deuterium, Me, ⁱPr, ^{t}Bu, and Ph;
R¹² is defined as R⁶;
wherein the maximum number of first and second chemical moieties attached to the third chemical moiety is only limited by the number of available binding sites on the third chemical moiety (in other words: the number of substituents R¹¹) (preferably with the aforementioned provision, that each TADF material E^{B} comprises at least one first chemical moiety, at least one second chemical moiety, and exactly one third chemical moiety).

In a preferred embodiment of the invention, a is always 1 and b is always 0.

In a preferred embodiment of the invention, Z² is at each occurrence a direct bond.

In a preferred embodiment of the invention, R^{a} is at each occurrence hydrogen.

In a preferred embodiment of the invention, R^{a} and R^{d} are at each occurrence hydrogen.

In a preferred embodiment of the invention, Q³ is at each occurrence nitrogen (N).

In one embodiment of the invention, at least one group R^{X} in formula EWG-I is CN.

In a preferred embodiment of the invention, exactly one group R^{X} in formula EWG-I is CN.

In a preferred embodiment of the invention, exactly one group R^{X} in formula EWG-I is CN and no group R^{X} in formula EWG-I is CF₃.

Examples of first chemical moieties according to the present invention are shown below, which does of course not imply that the present invention is limited to these examples: 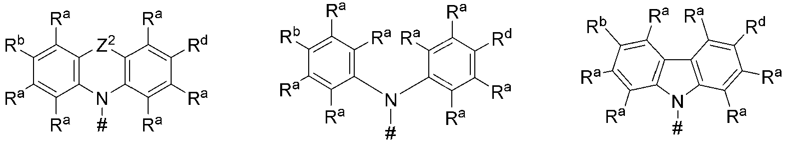 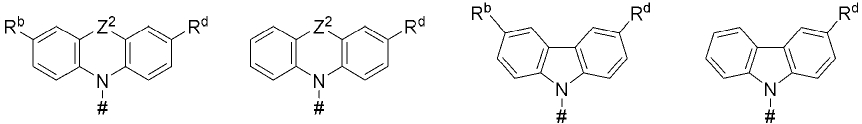 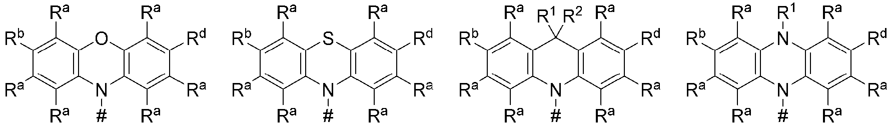 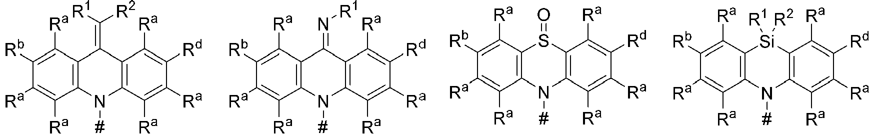 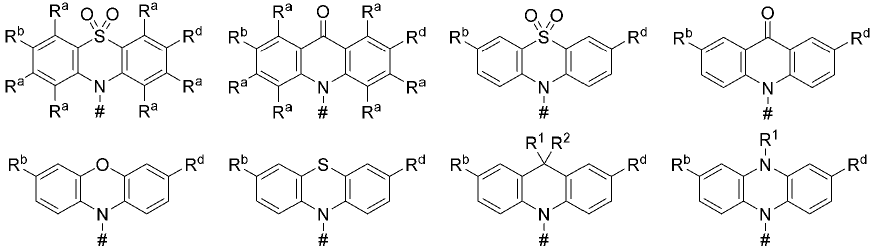 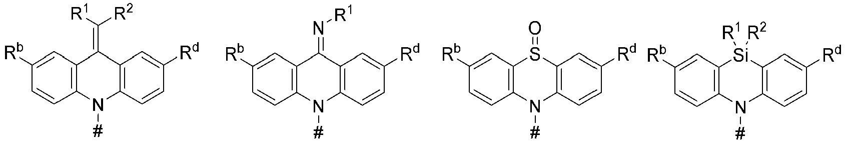 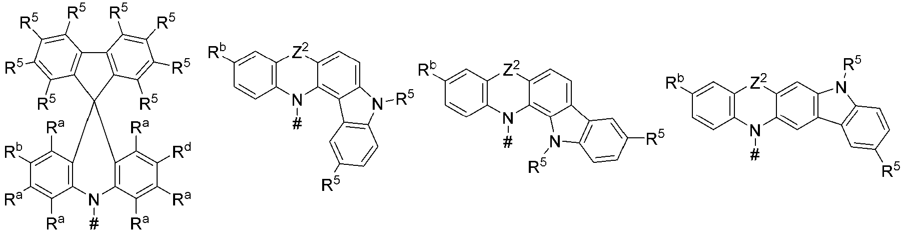 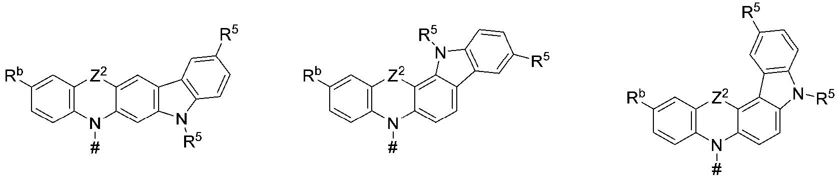 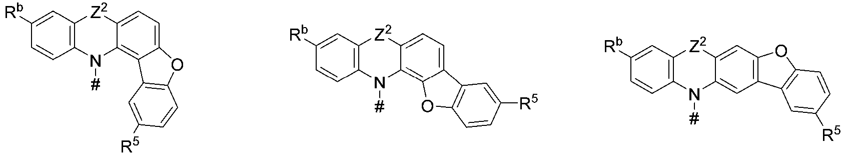 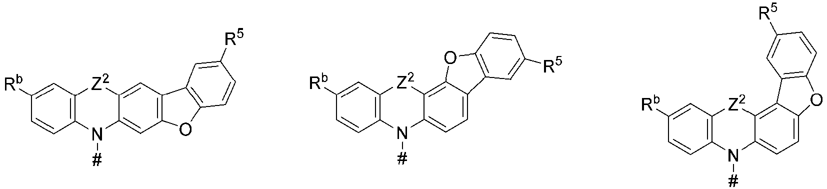 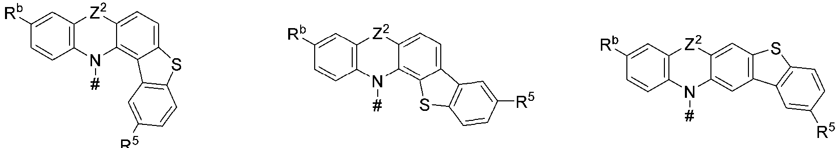 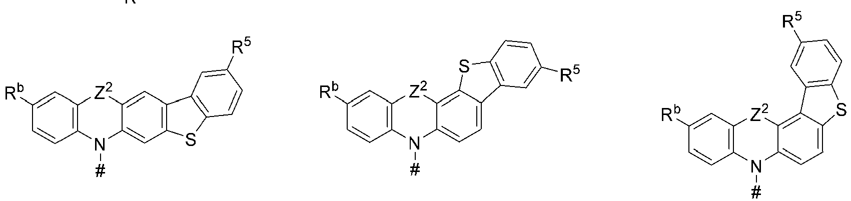 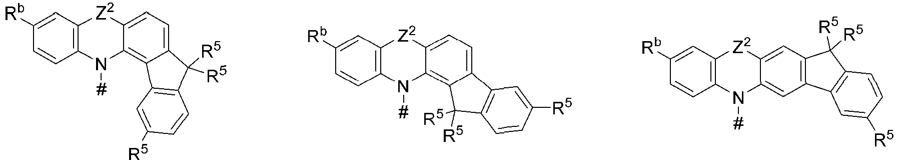 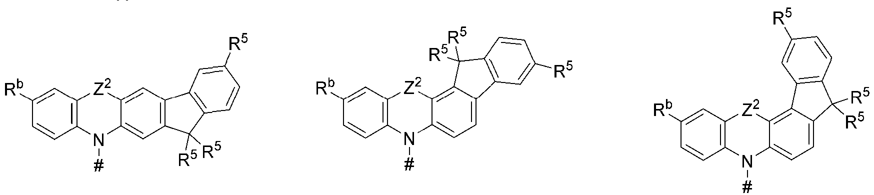 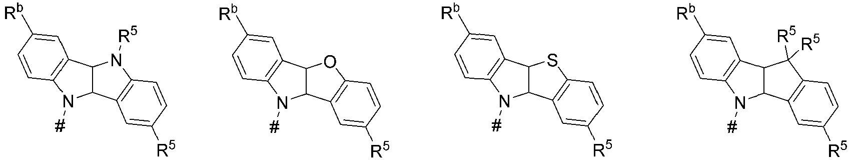 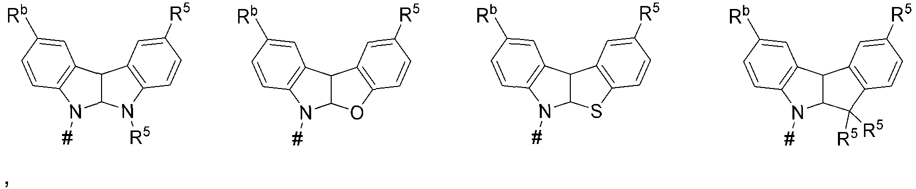 wherein the aforementioned definitions apply.

Examples of second chemical moieties according to the present invention are shown below, which does of course not imply that the present invention is limited to these examples: 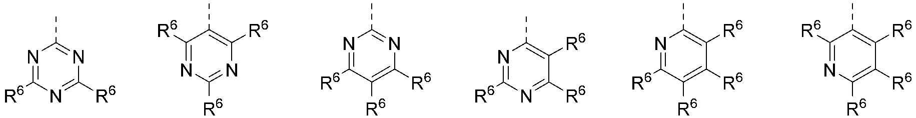 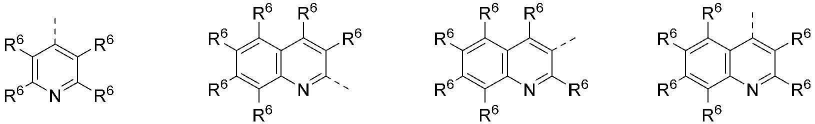 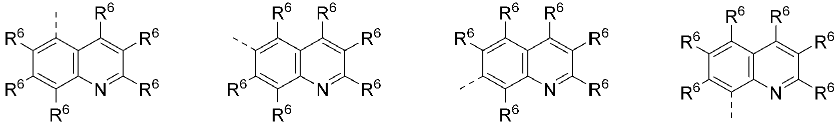 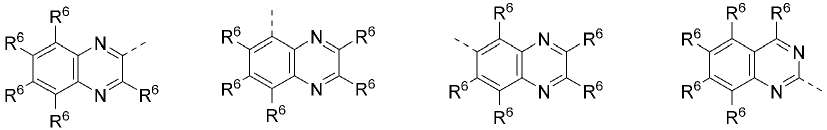 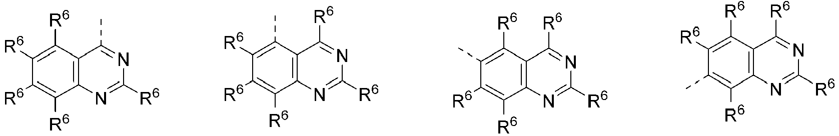 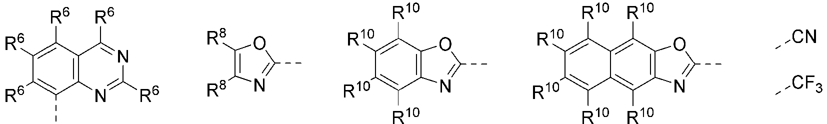 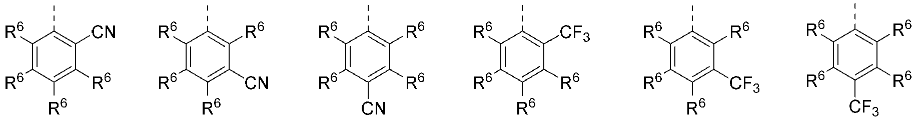 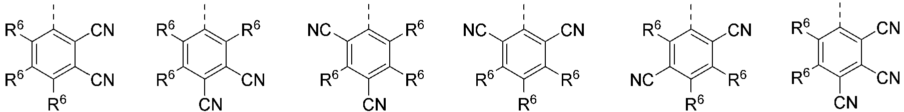 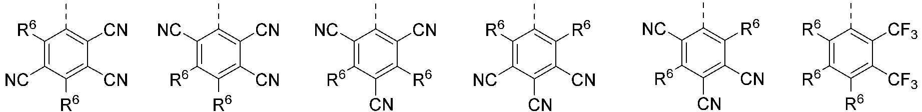 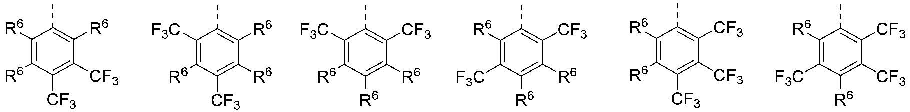 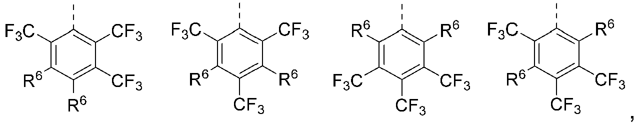 wherein the aforementioned definitions apply.

In a preferred embodiment of the invention, each TADF material E^{B} has a structure represented by any of formulas E^{B}-I, E^{B}-II, E^{B}-III, E^{B}-IV, E^{B}-V, E^{B}-VI, E^{B}-VII, E^{B}-VIII, E^{B}-IX, E^{B}-X, and E^{B}-XI: 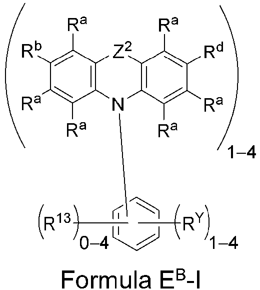 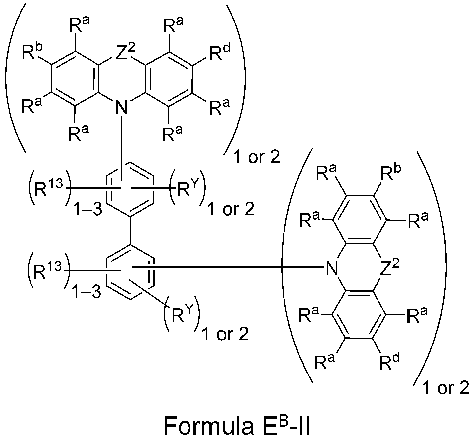 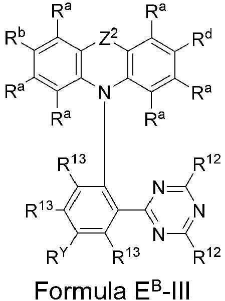 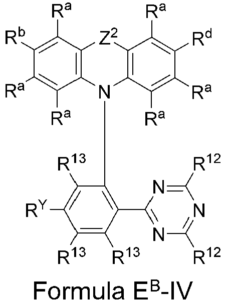 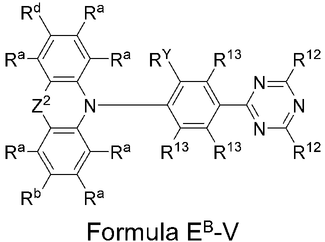 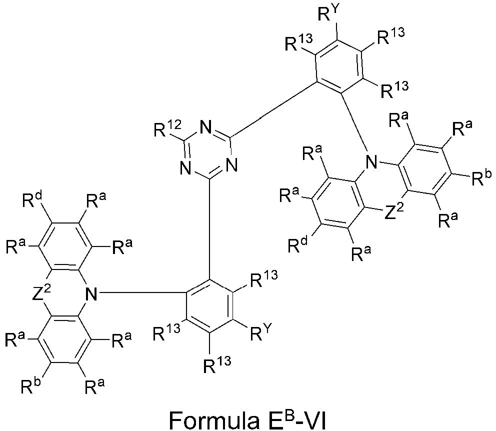 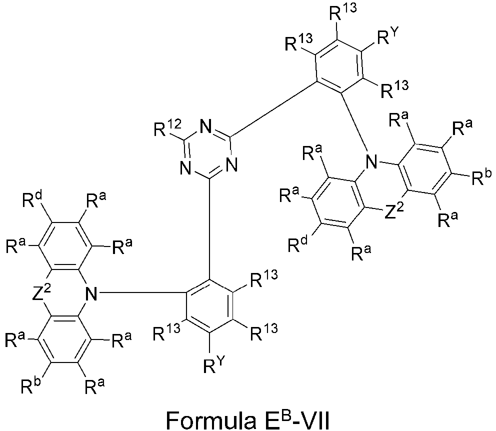 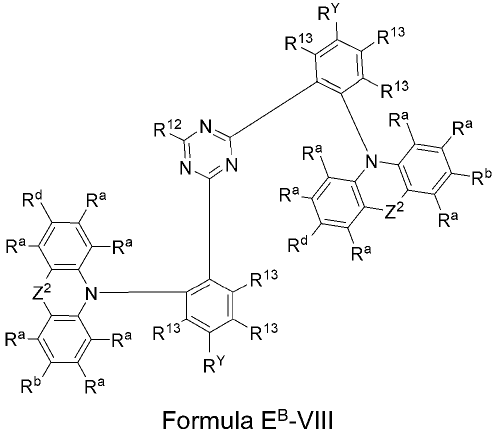 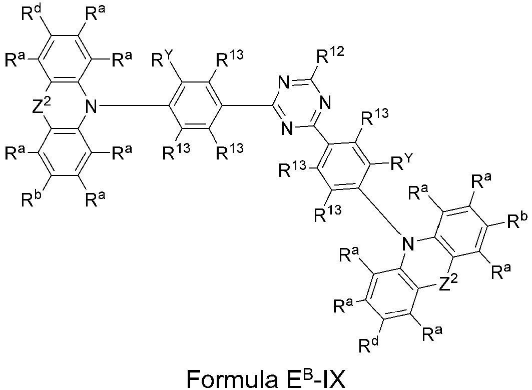 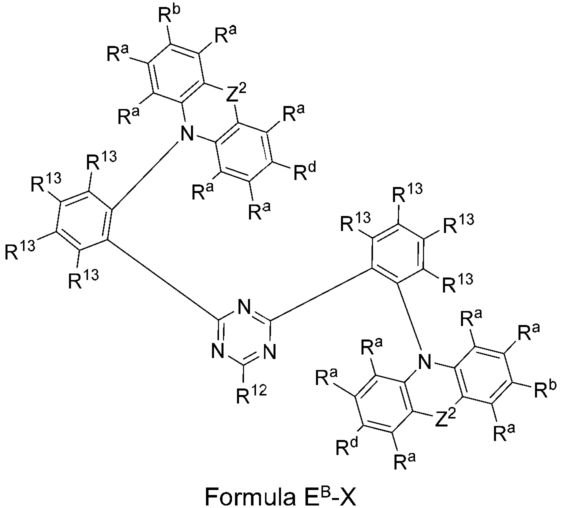 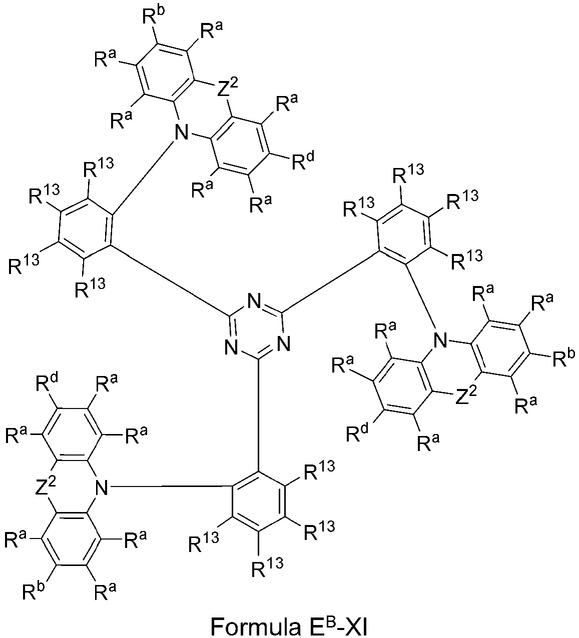 wherein
R¹³ is defined as R¹¹ with the provision that R¹³ cannot be a binding site of a single bond connecting a first or a second chemical moiety to the third chemical moiety;
R^{Y} is selected from CN and CF₃ or R^{Y} comprises or consists of a structure according to formula BN-I: 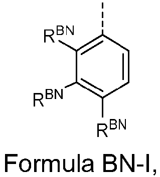
which is bonded to the structure of formula E^{B}-I, E^{B}-II, E^{B}-III, E^{B}-IV, E^{B}-V, E^{B}-VI, E^{B}-VII, E^{B}-VIII or E^{B}-IX via a single bond indicated by the dashed line and wherein exactly one R^{BN} group is CN while the other two R^{BN} groups are both hydrogen (H);
and wherein apart from that the above-mentioned definitions apply.

In a preferred embodiment of the invention, R¹³ is at each occurrence hydrogen.

In one embodiment of the invention, R^{Y} is at each occurrence CN.

In one embodiment of the invention, R^{Y} is at each occurrence CF₃.

In one embodiment of the invention, R^{Y} is at each occurrence a structure represented by formula BN-I.

In a preferred embodiment of the invention, R^{Y} is at each occurrence independently of each other selected from CN and a structure represented by formula BN-I.

In a preferred embodiment of the invention, each TADF material E^{B} has a structure represented by any of formulas E^{B}-I, E^{B}-II, E^{B}-III, E^{B}-IV, E^{B}-V, E^{B}-VI, E^{B}-VII, and E^{B}-X, wherein the aforementioned definitions apply.

In a preferred embodiment of the invention, each TADF material E^{B} has a structure represented by any of formulas E^{B}-I, E^{B}-III, E^{B}-V, E^{B}-VI, and E^{B}-X, wherein the aforementioned definitions apply.

Examples of TADF materials E^{B} for use in organic electroluminescent devices according to the invention are listed in the following, whereat this does not imply that only the shown examples are suitable TADF materials E^{B} in the context of the present invention.

Non-limiting examples of TADF materials E^{B} according formula E^{B}-I are shown below:

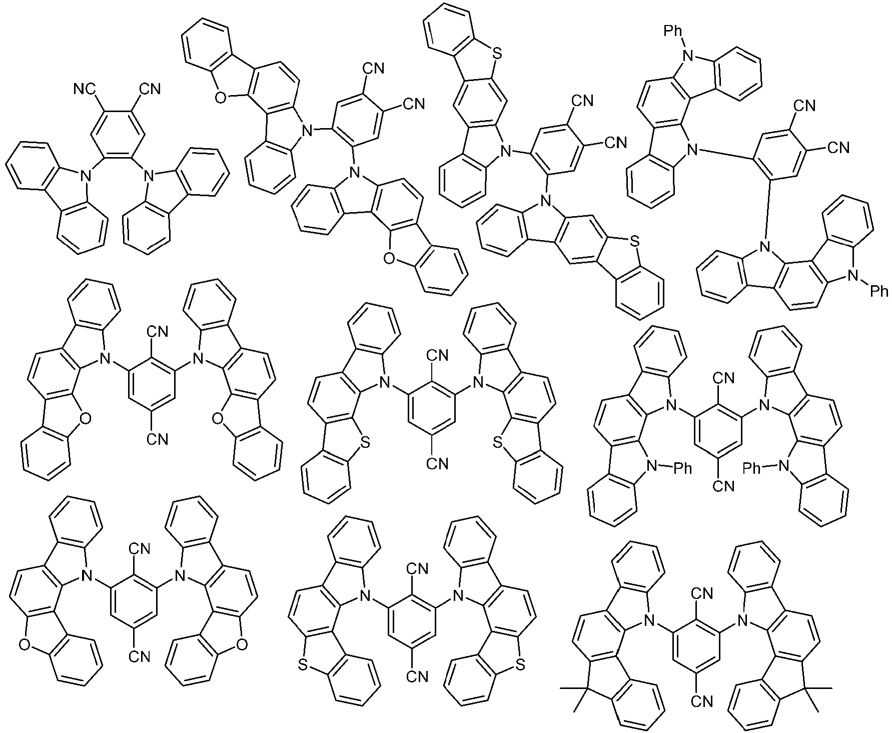

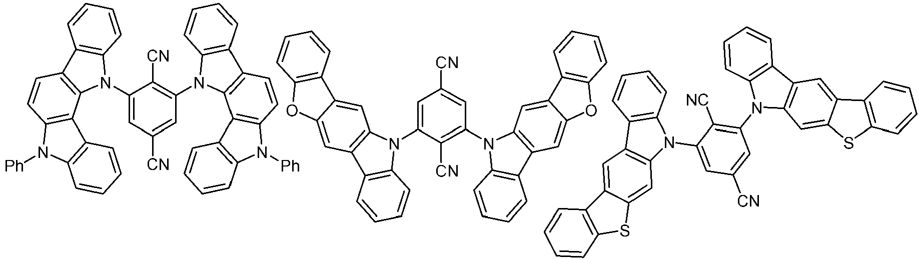

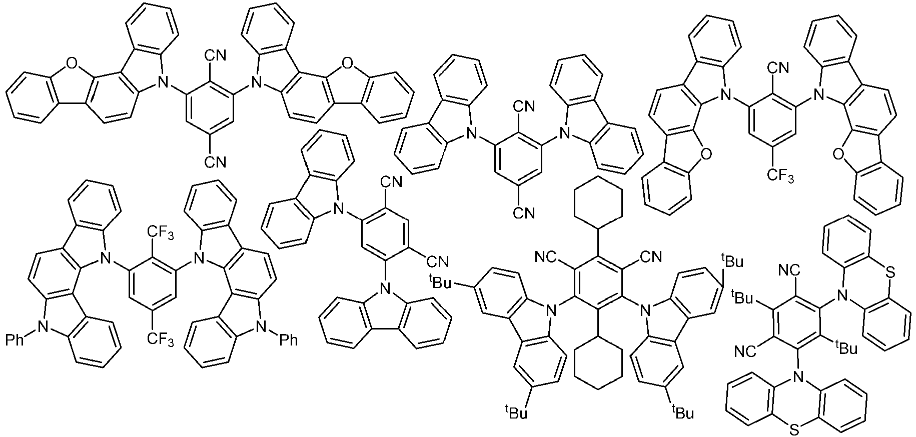

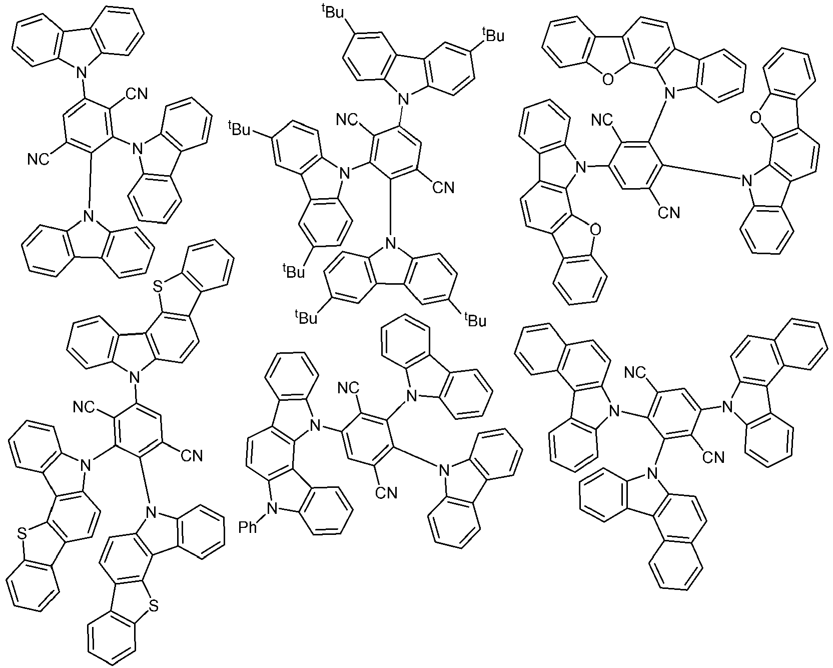

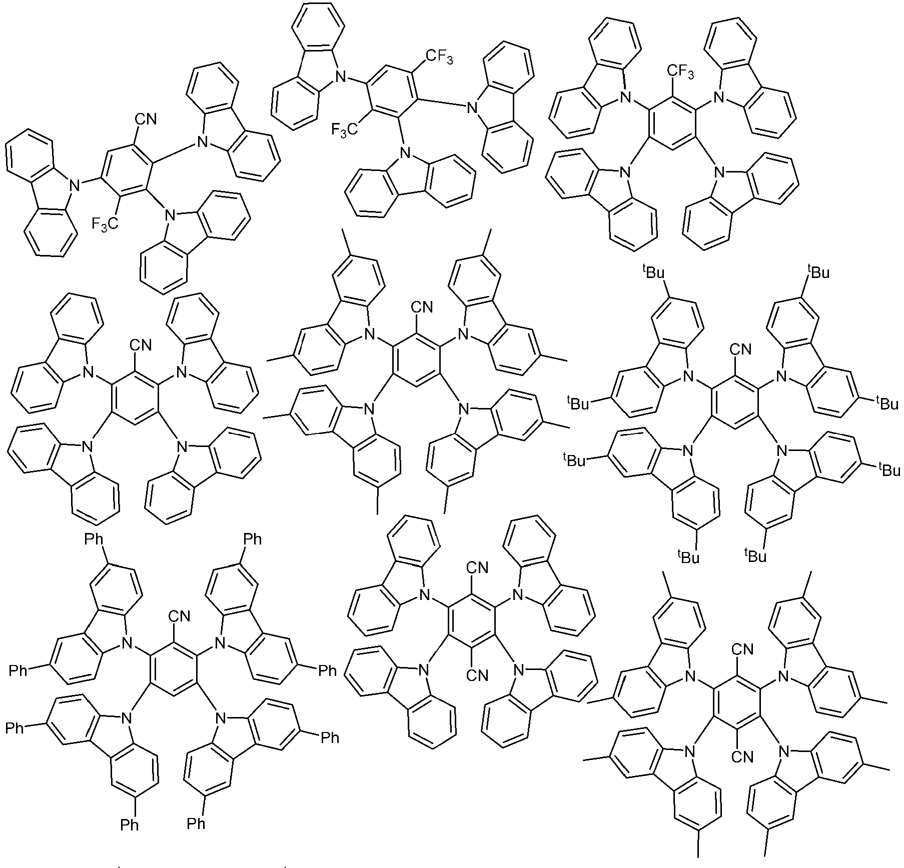

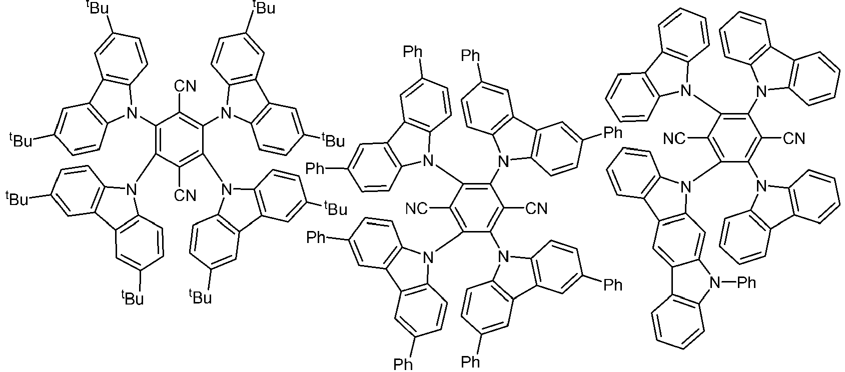

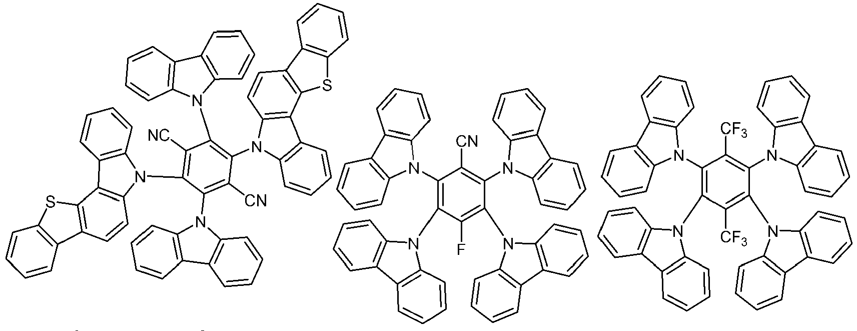

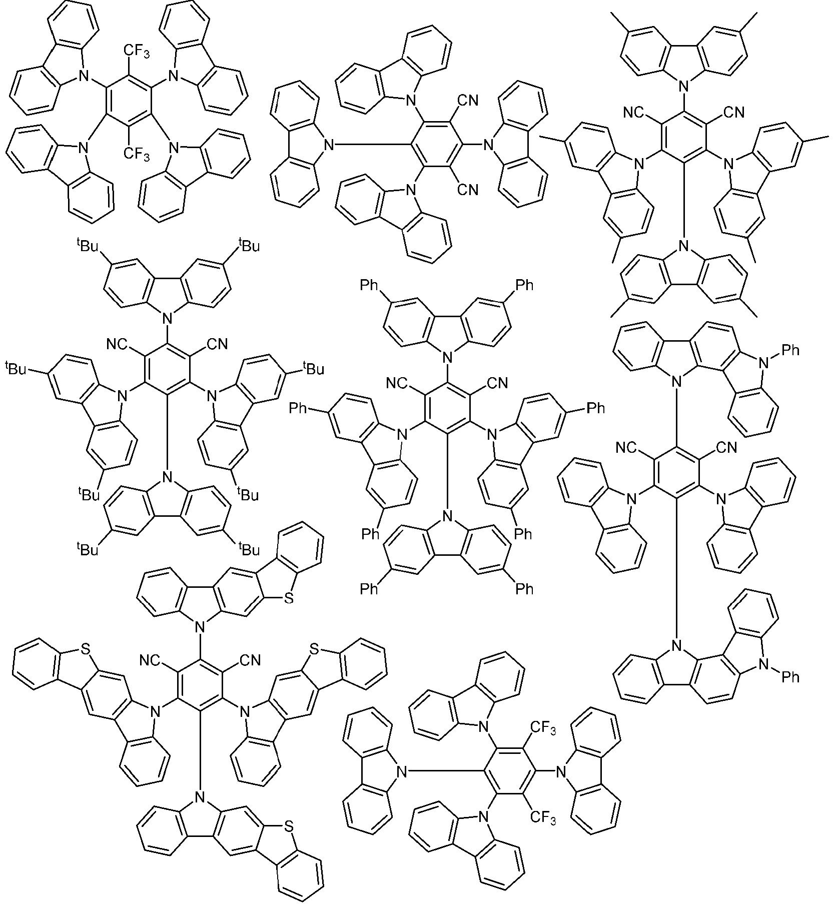

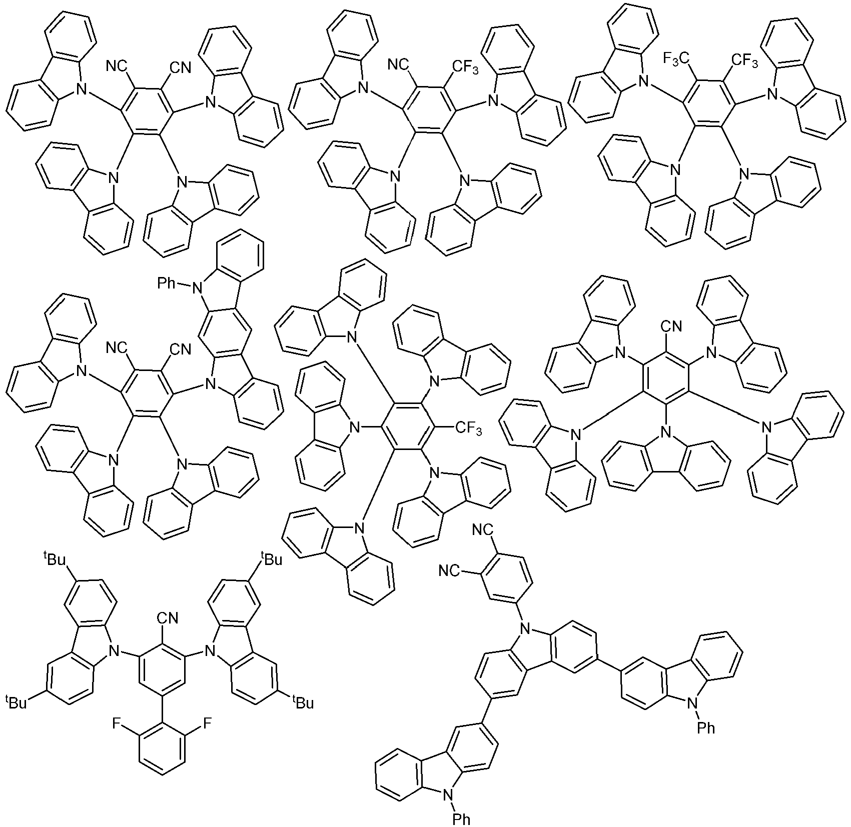

Non-limiting examples of TADF materials E^{B} according formula E^{B}-II are shown below:

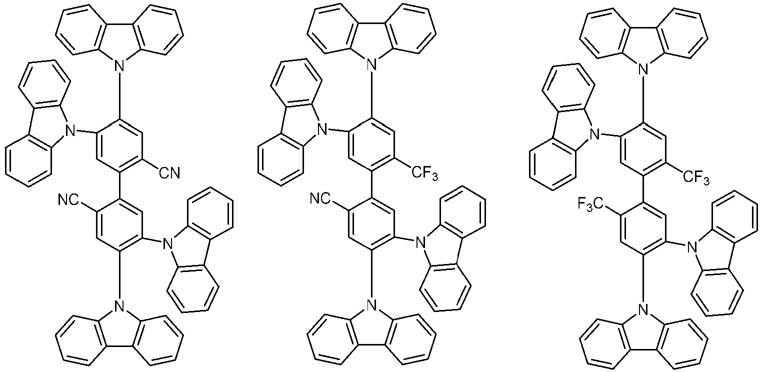

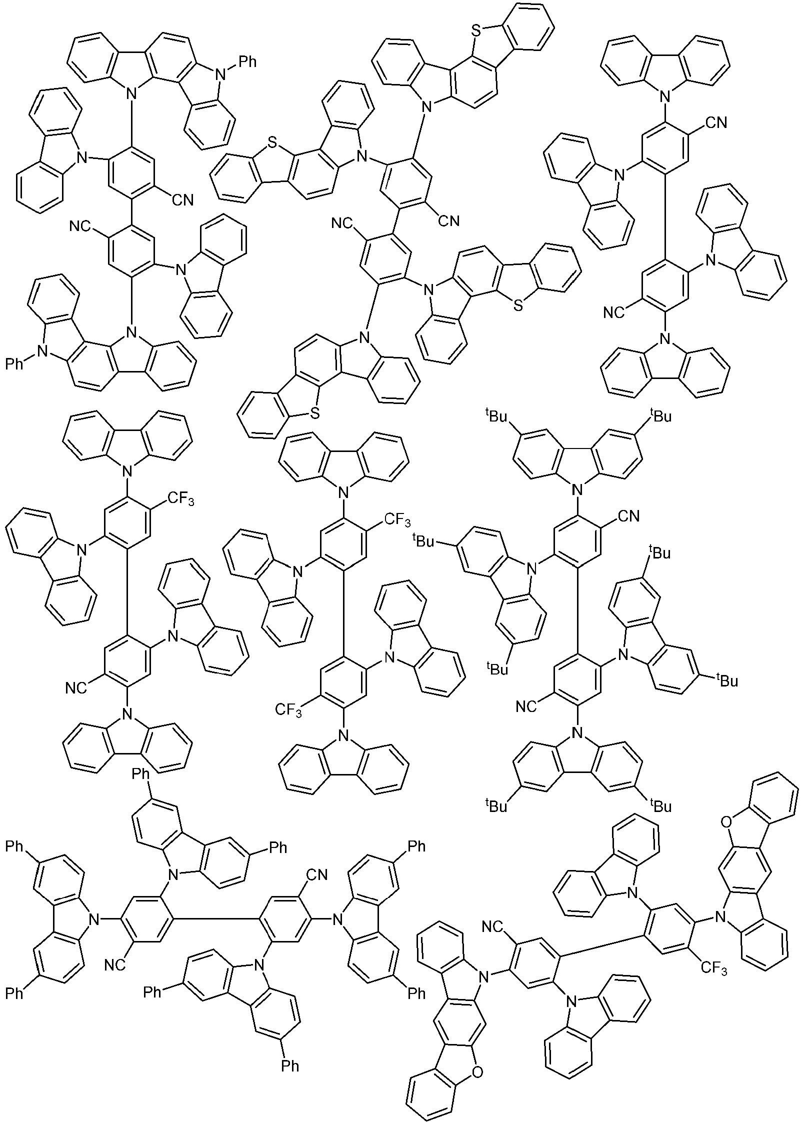

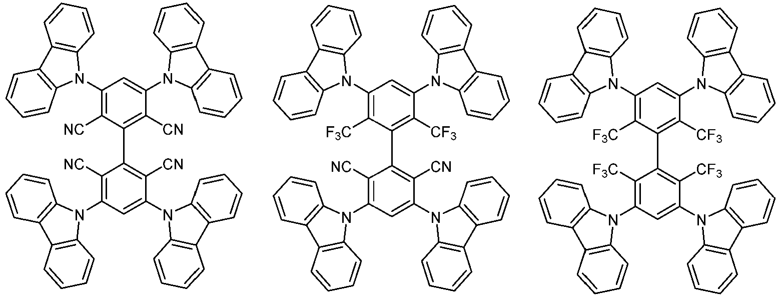

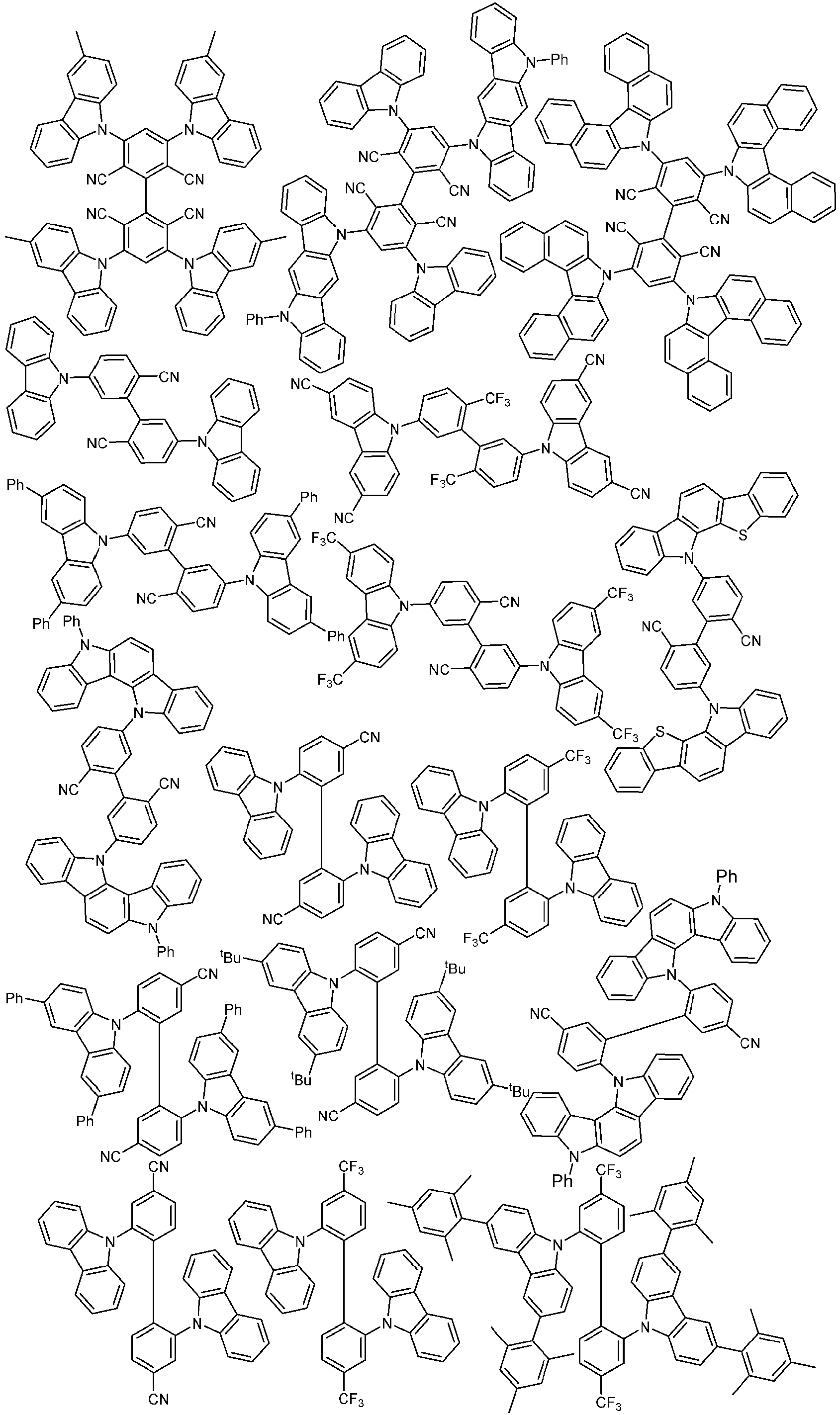

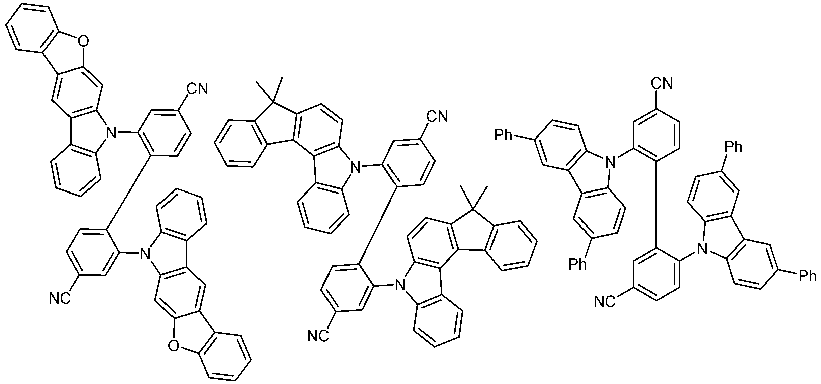

Non-limiting examples of TADF materials E^{B} according formula E^{B}-III are shown below:

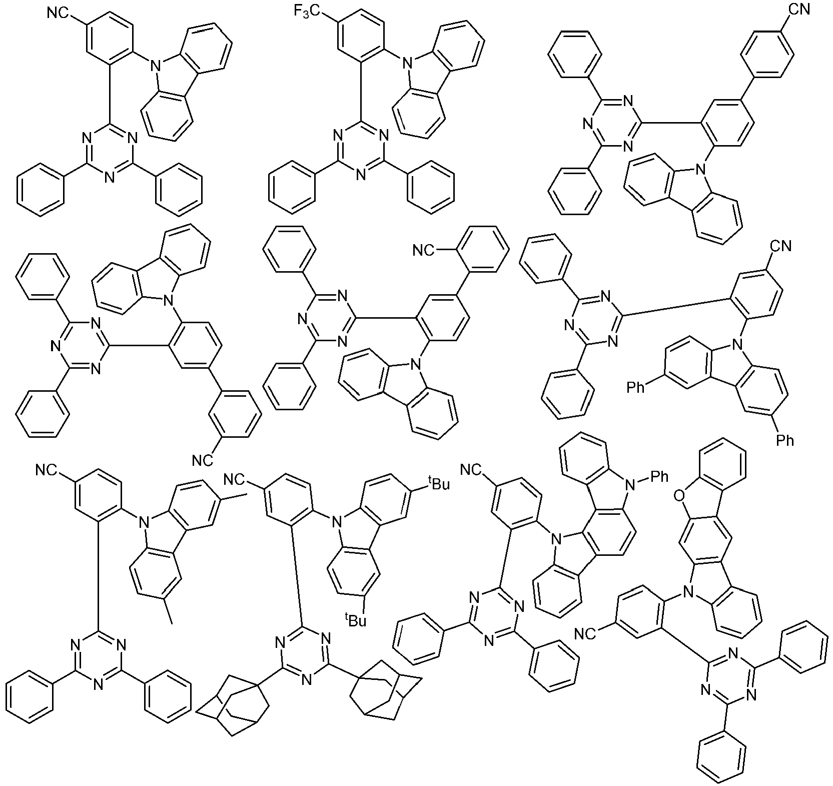

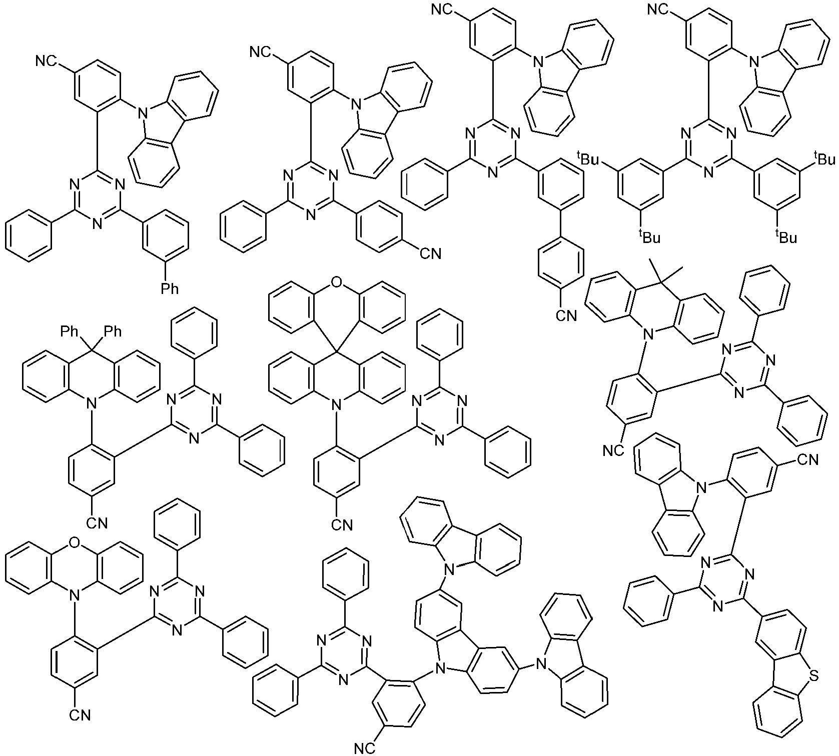

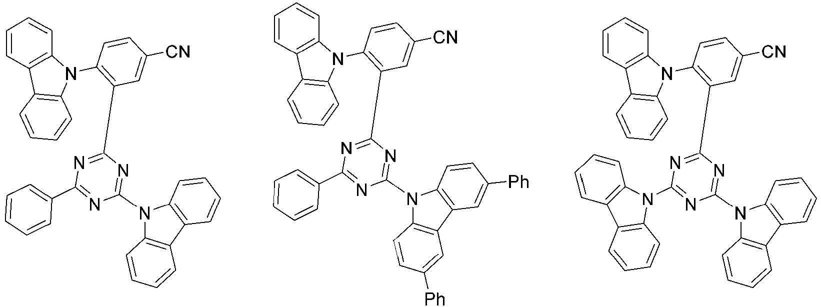

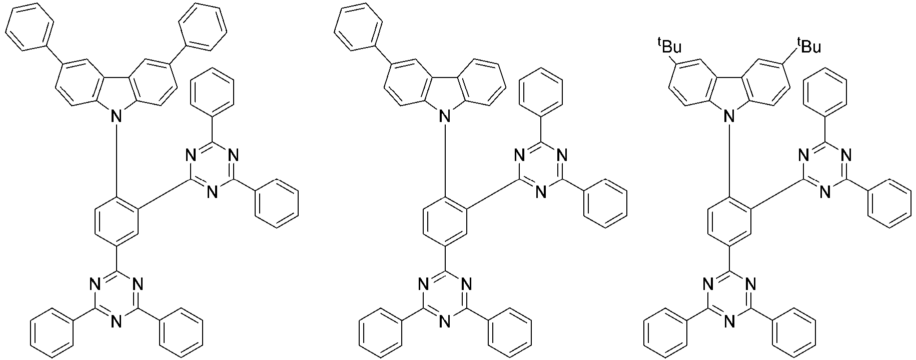

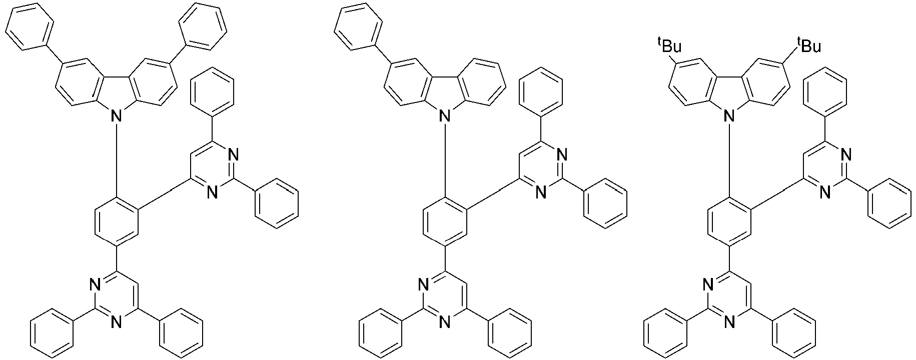

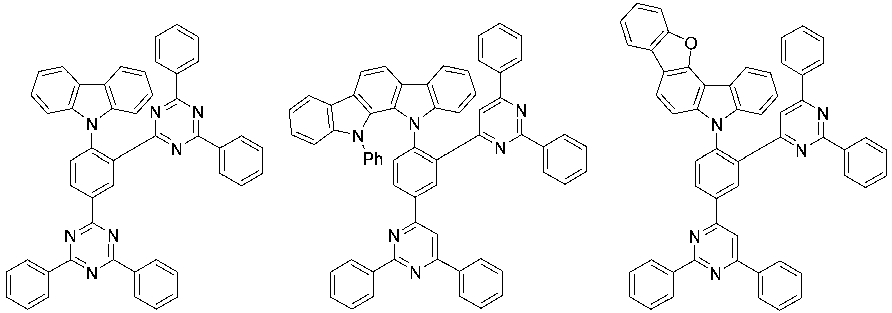

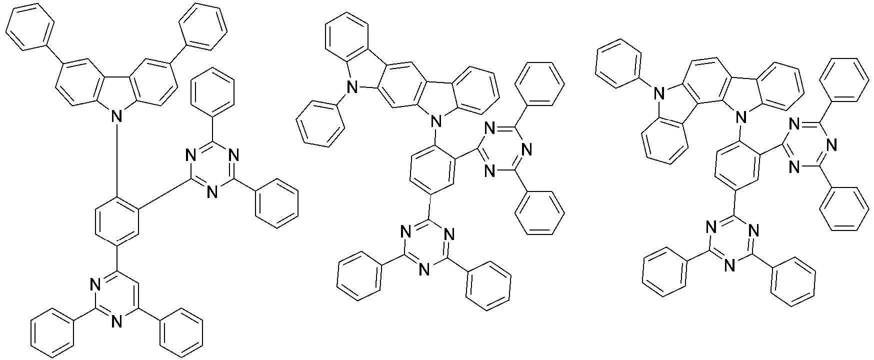

Non-limiting examples of TADF materials E^{B} according formula E^{B}-IV are shown below:

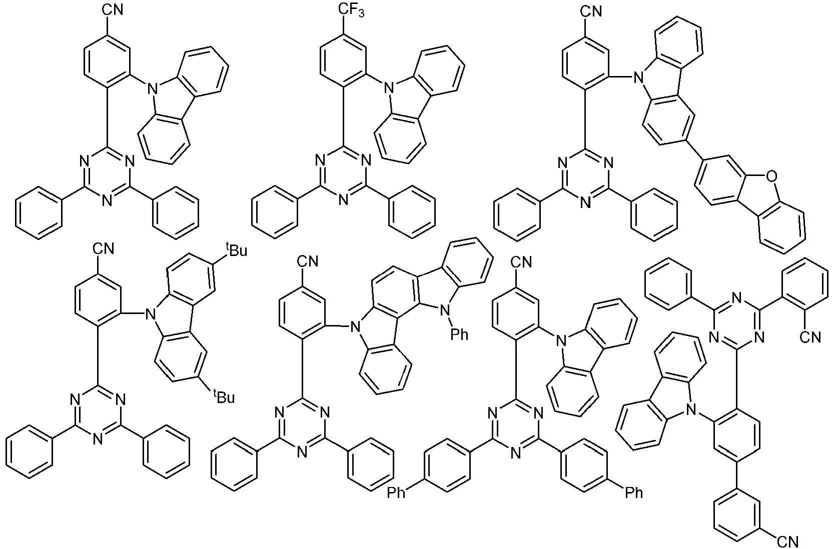

Non-limiting examples of TADF materials E^{B} according formula E^{B}-V are shown below:

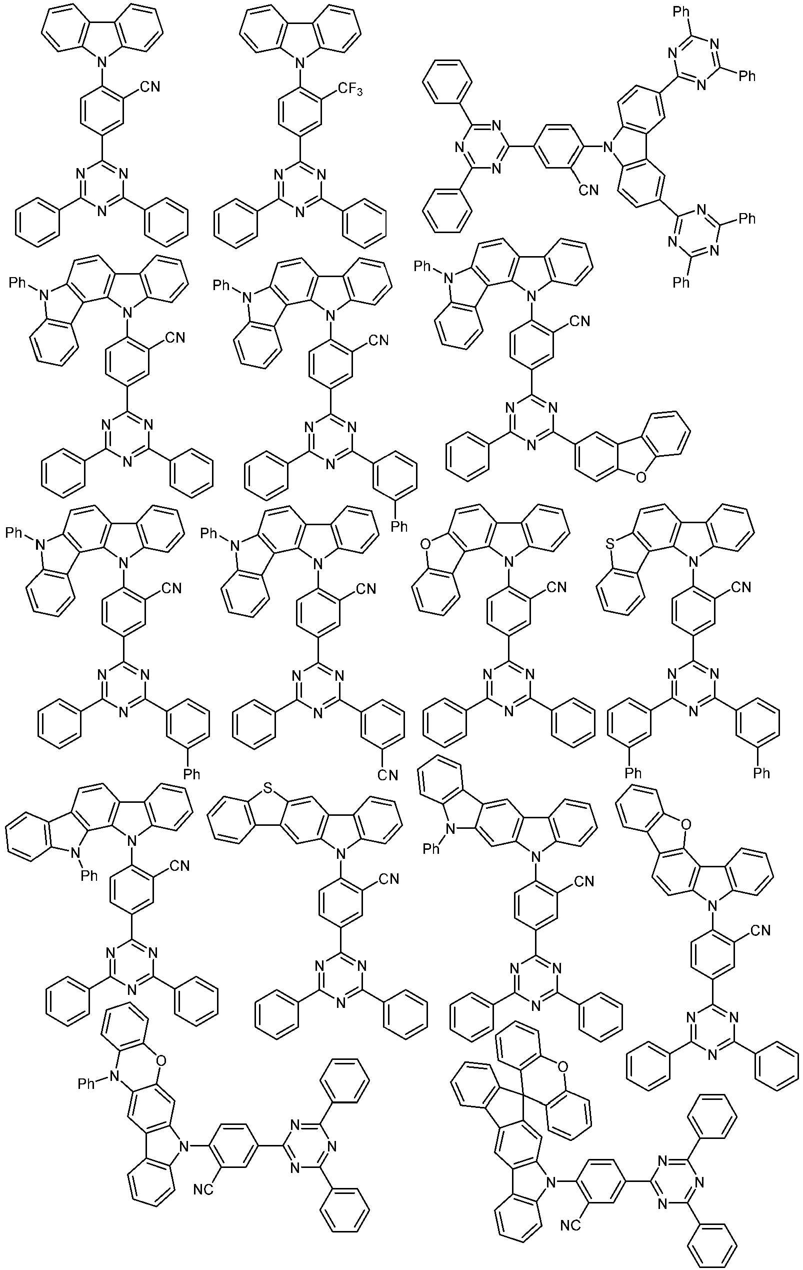

Non-limiting examples of TADF materials E^{B} according formula E^{B}-VI are shown below:

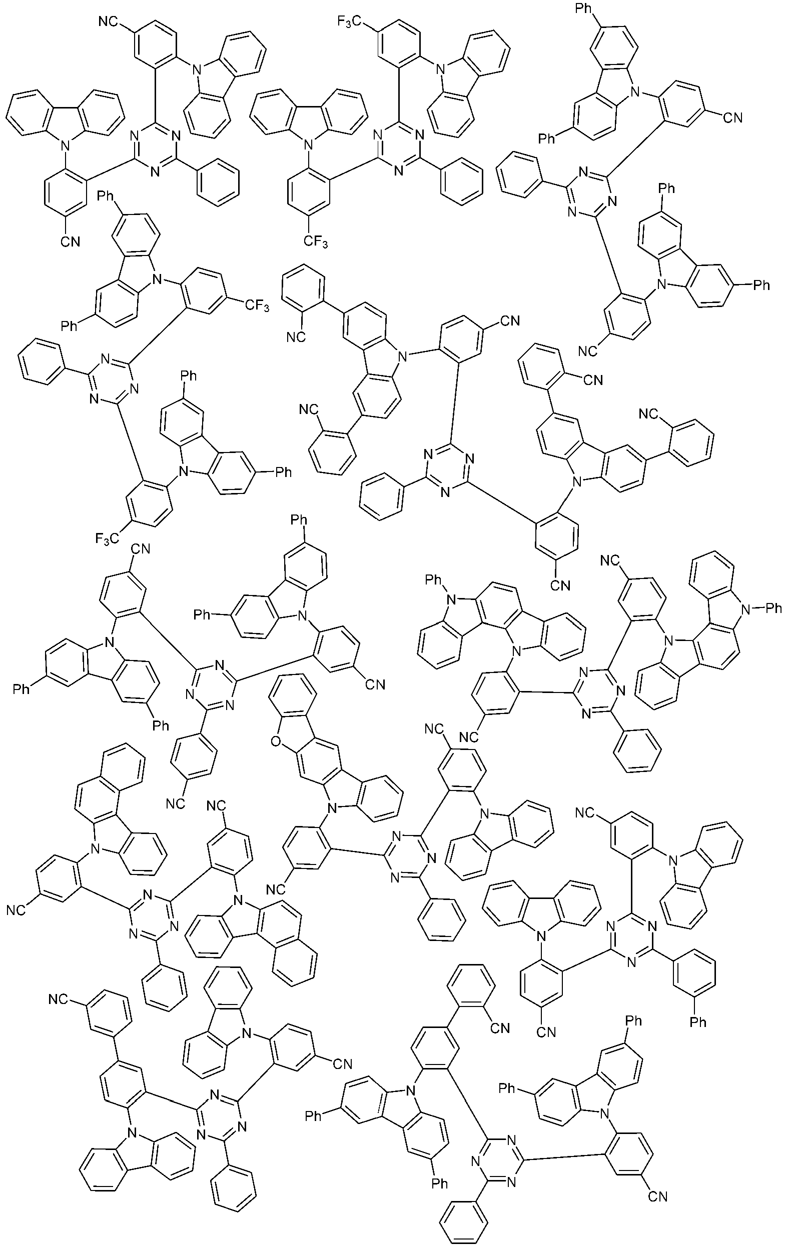

Non-limiting examples of TADF materials E^{B} according formula E^{B}-VII are shown below:

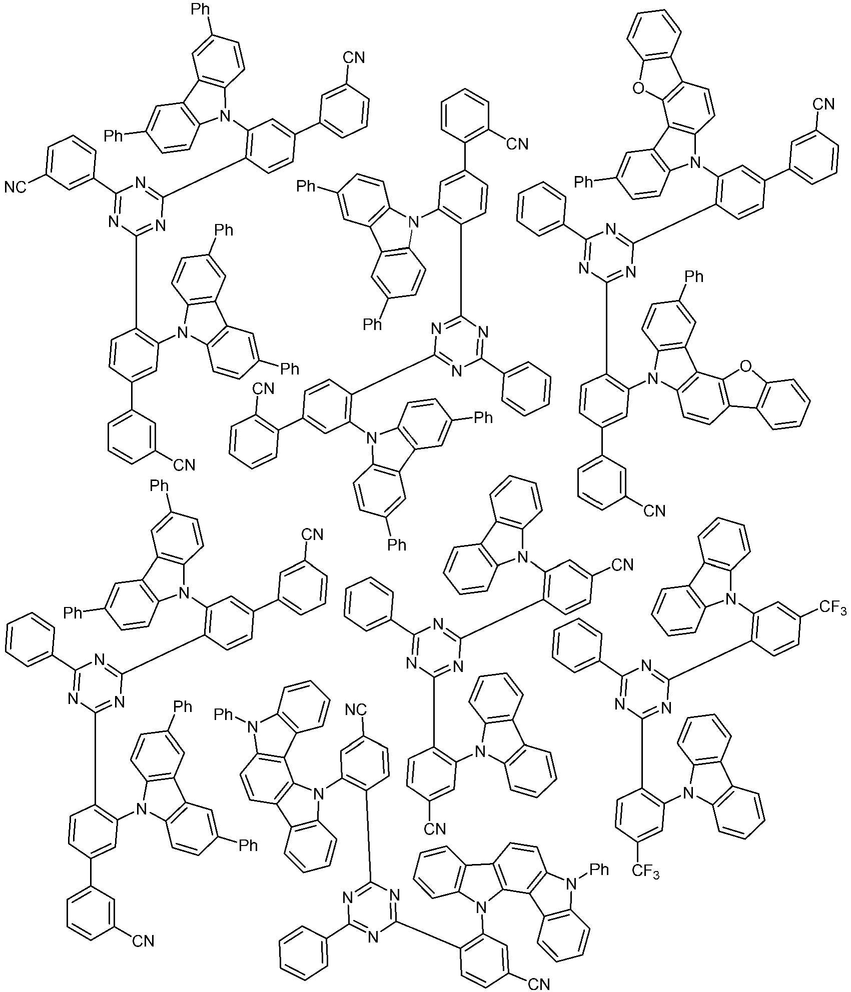

Non-limiting examples of TADF materials E^{B} according formula E^{B}-VIII are shown below:

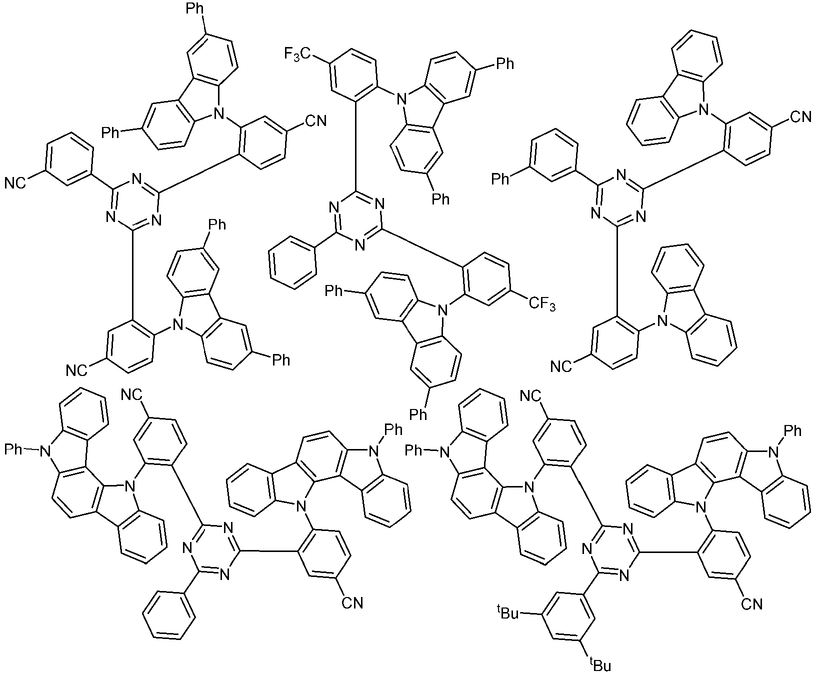

Non-limiting examples of TADF materials E^{B} according formula E^{B}-IX are shown below:

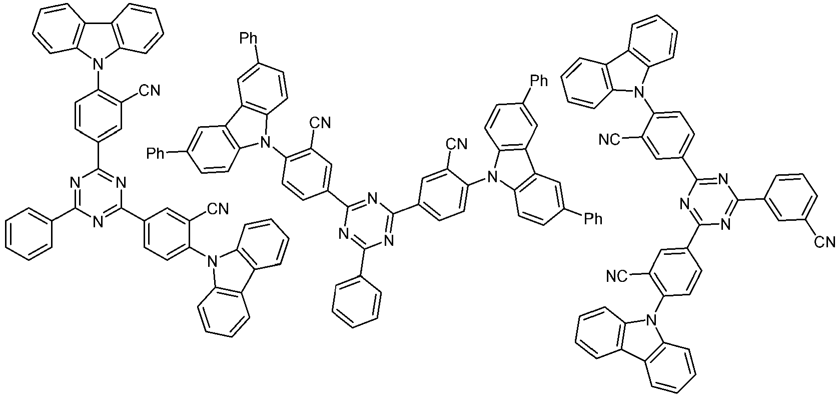

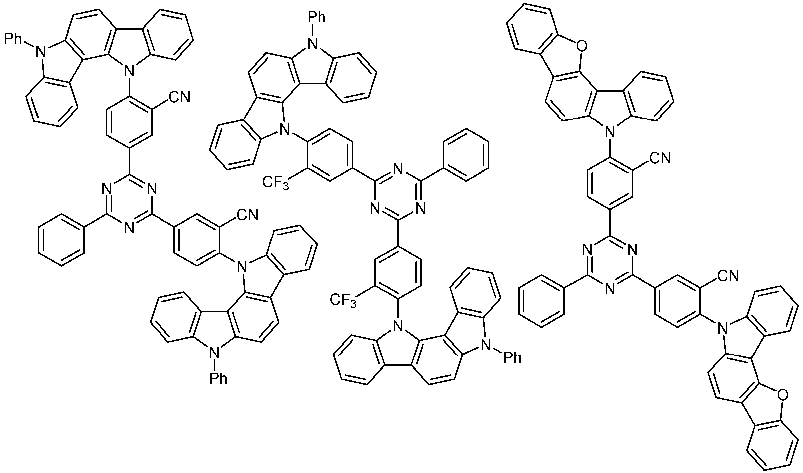

Non-limiting examples of TADF materials E^{B} according formula E^{B}-X are shown below:

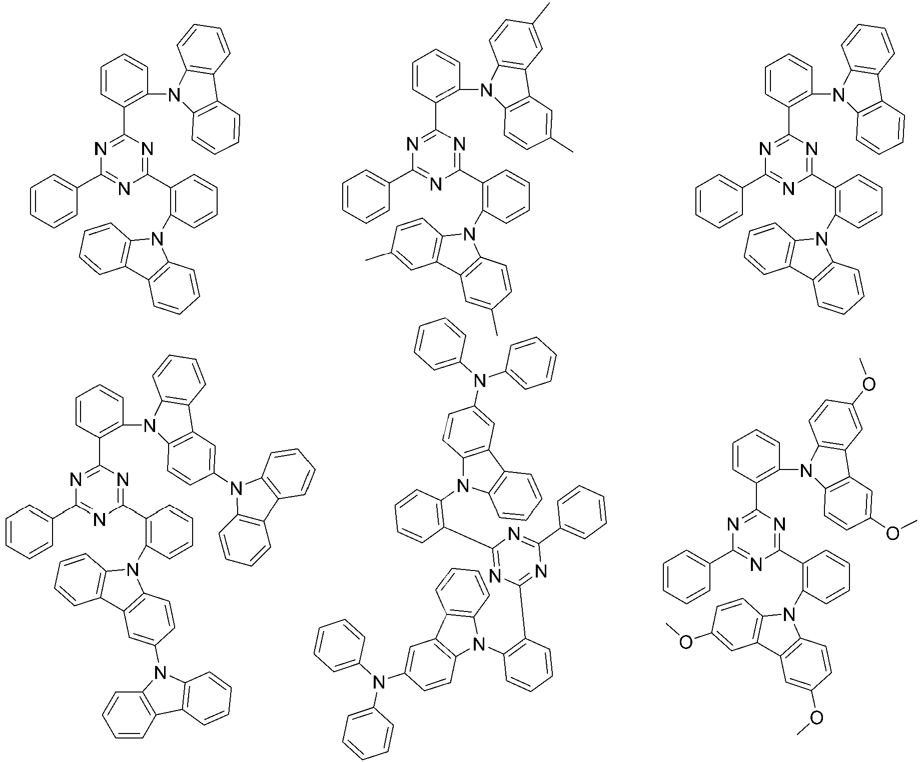

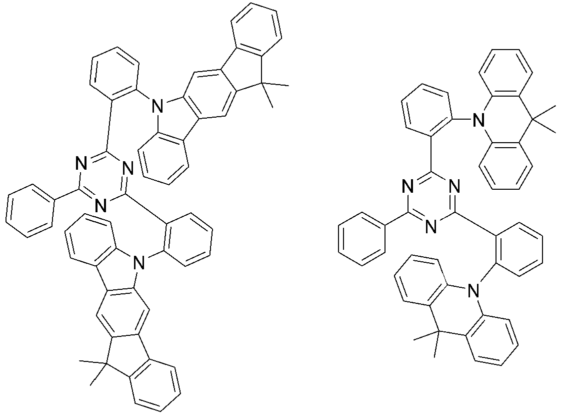

Non-limiting examples of TADF materials E^{B} according formula E^{B}-XI are shown below:

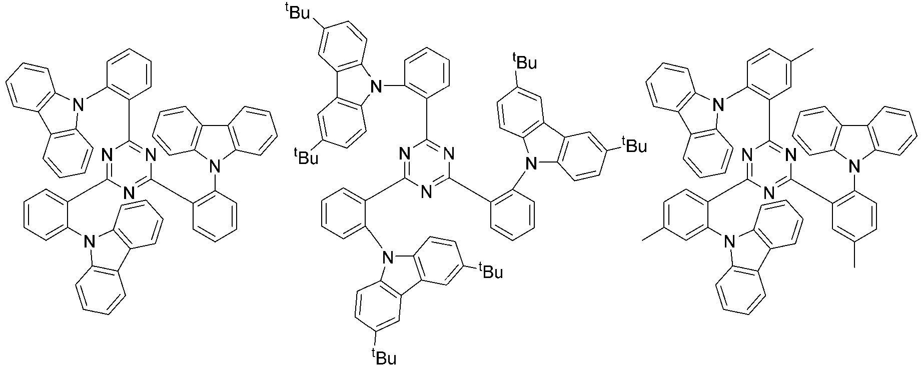

The synthesis of TADF materials E^{B} can be accomplished via standard reactions and reaction conditions known to the skilled artisan. Typically, in a first step, a coupling reaction, preferably a palladium-catalyzed coupling reaction, may be performed, which is exemplarily shown below for the synthesis of TADF materials E^{B} according to any of formulas E^{B}-III, E^{B}-IV, and E^{B}-V:

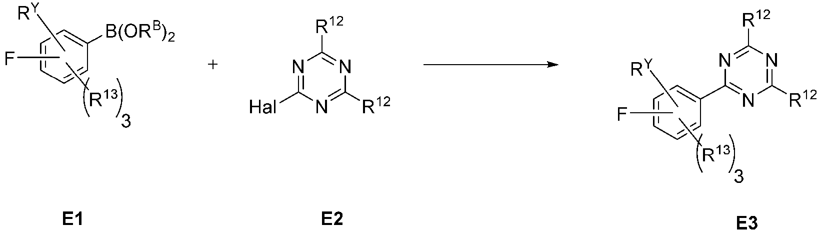

**E1** can be any boronic acid (R^{B}=H) or an equivalent boronic acid ester (R^{B} = alkyl or aryl), in particular two R^{B} may form a ring to give e.g. boronic acid pinacol esters. As second reactant **E2** is used, wherein Hal refers to halogen and may be I, Br or Cl, but preferably is Br. Reaction conditions of such palladium-catalyzed coupling reactions are known the person skilled in the art, e.g. from WO 2017/005699, and it is known that the reacting groups of **E1** and **E2** can be interchanged as shown below to optimize the reaction yields:

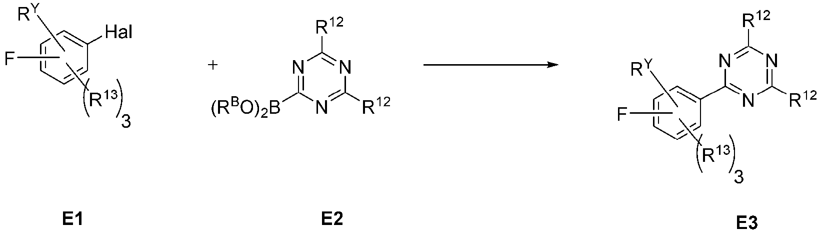

In a second step, the TADF molecules are obtained via the reaction of a nitrogen heterocycle in a nucleophilic aromatic substitution with the aryl halide, preferably aryl fluoride E3. Typical conditions include the use of a base, such as tribasic potassium phosphate or sodium hydride, for example, in an aprotic polar solvent, such as dimethyl sulfoxide (DMSO) or N,N-dimethylformamide (DMF), for example.

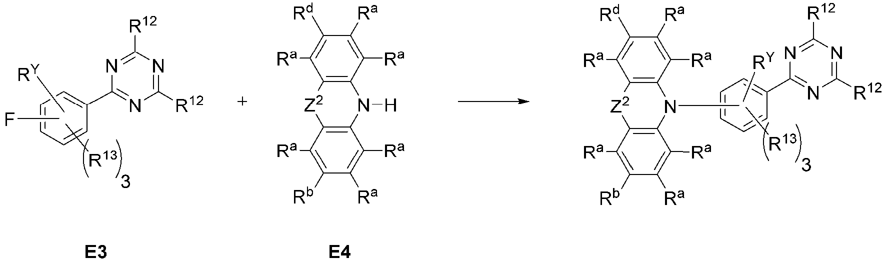

In particular, the donor molecule **E4** is a 3,6-substituted carbazole (e.g., 3,6-dimethylcarbazole, 3,6-diphenylcarbazole, 3,6-di-*tert*-butylcarbazole), a 2,7-substituted carbazole (e.g., 2,7-dimethylcarbazole, 2,7-diphenylcarbazole, 2,7-di-*tert*-butylcarbazole), a 1,8-substituted carbazole (e.g., 1,8-dimethylcarbazole, 1,8-diphenylcarbazole, 1,8-di-*tert*-butylcarbazole), a 1-substituted carbazole (e.g., 1-methylcarbazole, 1-phenylcarbazole, 1-tert-butylcarbazole), a 2-substituted carbazole (e.g., 2-methylcarbazole, 2-phenylcarbazole, 2-tert-butylcarbazole), or a 3-substituted carbazole (e.g., 3-methylcarbazole, 3-phenylcarbazole, *3-tert-*butylcarbazole).

Alternatively, a halogen-substituted carbazole, particularly 3-bromocarbazole, can be used as **E4.**

In a subsequent reaction, a boronic acid ester functional group or boronic acid functional group may be exemplarily introduced at the position of the one or more halogen substituents, which was introduced via **E4,** to yield the corresponding carbazol-3-yl-boronic acid ester or carbazol-3-yl-boronic acid, e.g., via the reaction with bis(pinacolato)diboron (CAS No. 73183-34-3). Subsequently, one or more substituents R^{a,} R^{b} or R^{d} may be introduced in place of the boronic acid ester group or the boronic acid group via a coupling reaction with the corresponding halogenated reactant, e.g. R^{a}-Hal, preferably R^{a}-Cl and R^{a}-Br.

Alternatively, one or more substituents R^{a,} R^{b} or R^{d} may be introduced at the position of the one or more halogen substituents, which was introduced via D-H, via the reaction with a boronic acid of the substituent R^{a} [R^{a}-B(OH)₂], R^{b} [R^{b}-B(OH)₂] or R^{d} [R^{d}-B(OH)₂] or a corresponding boronic acid ester.

Further TADF materials E^{B} may be obtained analogously. A TADF material E^{B} may also be obtained by any alternative synthesis route suitable for this purpose.

An alternative synthesis route may comprise the introduction of a nitrogen heterocycle via copper-or palladium-catalyzed coupling to an aryl halide or aryl pseudohalide, preferably an aryl bromide, an aryl iodide, aryl triflate or an aryl tosylate.

### Phosphorescence material(s) P^{B}

The phosphorescence materials P^{B} in the context of the present invention utilize the intramolecular spin-orbit interaction (heavy atom effect) caused by metal atoms to obtain light emission from triplets.

Generally, it is understood, that all phosphorescent complexes that are used in organic electroluminescent devices in the state of the art may also be used in an organic electroluminescent device according to the present invention.

It is common knowledge to those skilled in the art that phosphorescence materials P^{B} used in organic electroluminescent devices are oftentimes complexes of Ir, Pt, Pd, Au, Os, Eu, Ru, Re, Ag and Cu, in the context of this invention preferably of Ir, Pt, and Pd, more preferably of Ir and Pt. The skilled artisan knows which materials are suitable as phosphorescence materials in organic electroluminescent devices and how to synthesize them. Furthermore, the skilled artisan is familiar with the design principles of phosphorescent complexes for use in organic electroluminescent devices and knows how to tune the emission of the complexes by means of structural variations.

See for example: C.-L. Ho, H. Li, W.-Y. Wong, Journal of Organometallic Chemistry 2014, 751, 261, DOI: 10.1016/j.jorganchem.2013.09.035; T. Fleetham, G. Li, J. Li, Advanced Science News 2017, 29, 1601861, DOI: 10.1002/adma.201601861; A.R.B.M. Yusoff, A.J. Huckaba, M.K. Nazeeruddin, Topics in Current Chemistry (Z) 2017, 375:39, 1, DOI: 10.1007/s41061-017-0126-7; T.-Y. Li, J. Wuc, Z.-G. Wua, Y.-X. Zheng, J.-L. Zuo, Y. Pan, Coordination Chemistry Reviews 2018, 374, 55, DOI: 10.1016/j.ccr.2018.06.014.

For example, US2020274081 (A1), US20010019782 (A1), US20020034656 (A1), US20030138657 (A1), US2005123791 (A1), US20060065890 (A1), US20060134462 (A1), US20070034863 (A1), US20070111026 (A1), US2007034863 (A1), US2007138437 (A1), US20080020237 (A1), US20080297033 (A1), US2008210930 (A1), US20090115322 (A1), US2009104472 (A1), US20100244004 (A1), US2010105902 (A1), US20110057559 (A1), US2011215710 (A1), US2012292601 (A1), US2013165653 (A1), US20140246656 (A1), US20030068526 (A1), US20050123788 (A1), US2005260449 (A1), US20060127696 (A1), US20060202194 (A1), US20070087321 (A1), US20070190359 (A1), US2007104979 (A1), US2007224450 (A1), US20080233410 (A1), US200805851 (A1), US20090039776 (A1), US20090179555 (A1), US20100090591 (A1), US20100295032 (A1), US20030072964 (A1), US20050244673 (A1), US20060008670 (A1), US20060134459 (A1), US20060251923 (A1), US20070103060 (A1), US20070231600 (A1), US2007104980 (A1), US2007278936 (A1), US20080261076 (A1), US2008161567 (A1), US20090108737 (A1), US2009085476 (A1), US20100148663 (A1), US2010102716 (A1), US2010270916 (A1), US20110204333 (A1), US2011285275 (A1), US2013033172 (A1), US2013334521 (A1), US2014103305 (A1), US2003068536 (A1), US2003085646 (A1), US2006228581 (A1), US2006197077 (A1), US2011114922 (A1), US2011114922 (A1), US2003054198 (A1), and EP2730583 (A1) disclose phosphorescence materials that may be used as phosphorescence materials P^{B} in the context of the present invention. It is understood that this does not imply that the present invention is limited to organic electroluminescent devices comprising a phosphorescence materials described in one of the named references.

As laid out in US2020274081 (A1), examples of phosphorescent complexes for use in organic electroluminescent devices such as those of the present invention include the complexes shown below. Again, it is understood that the present invention is not limited to these examples.

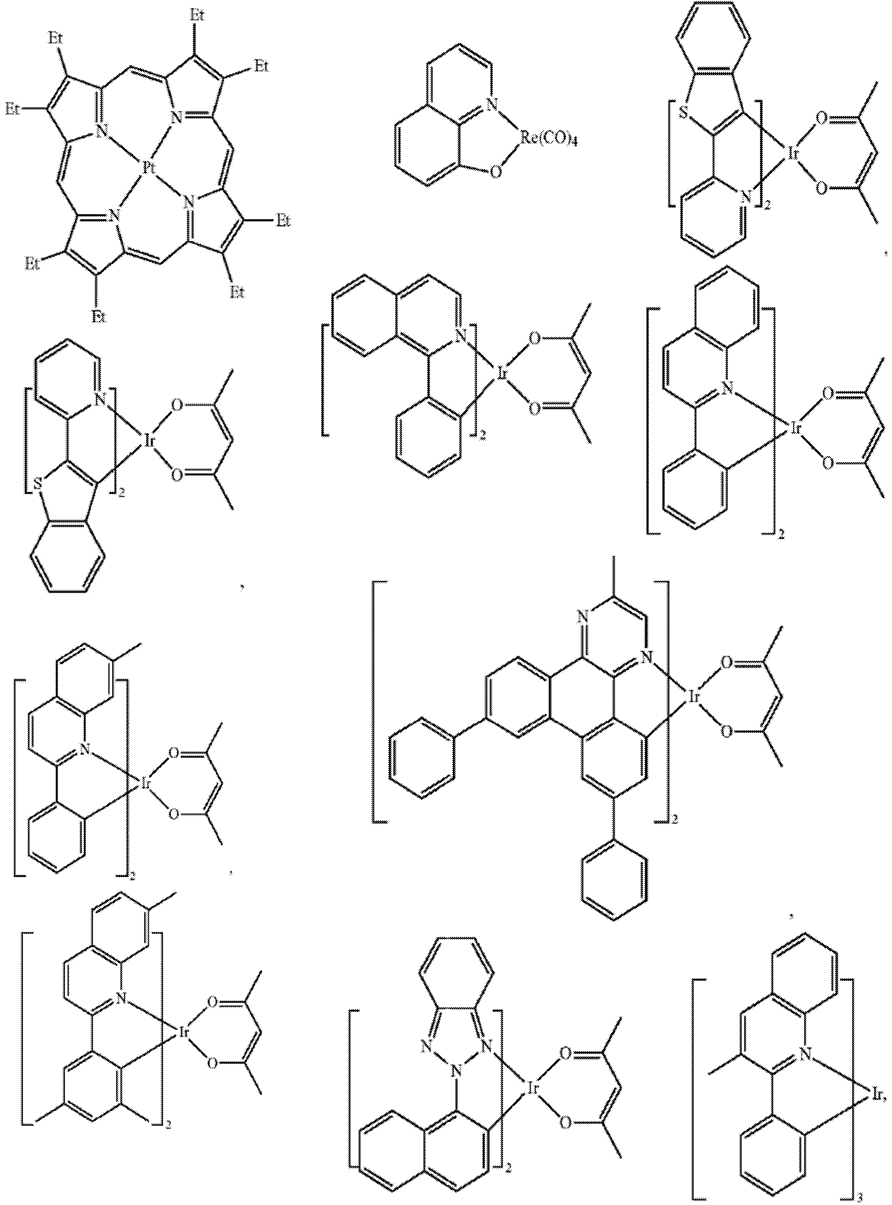

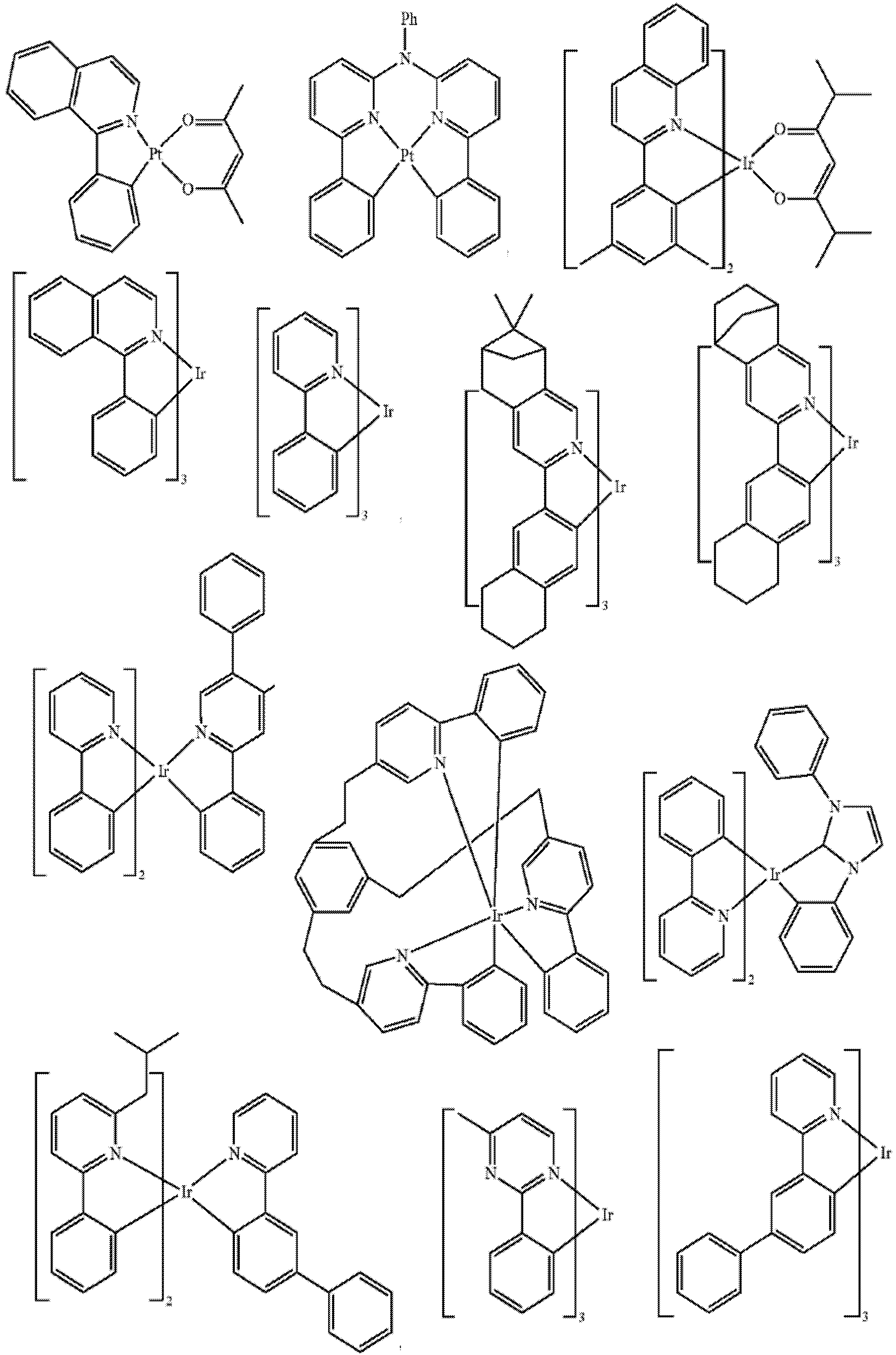

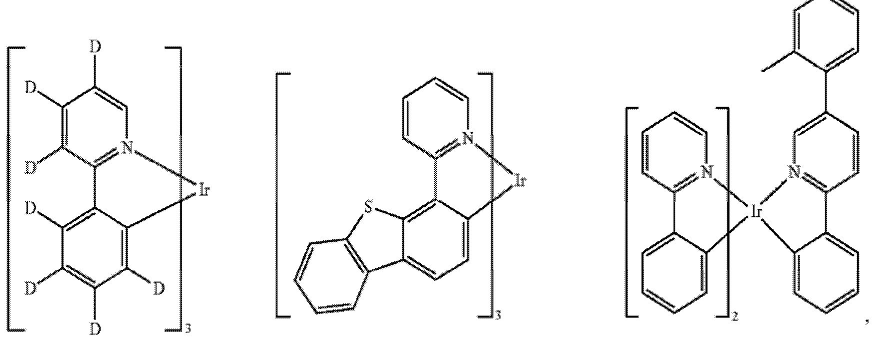

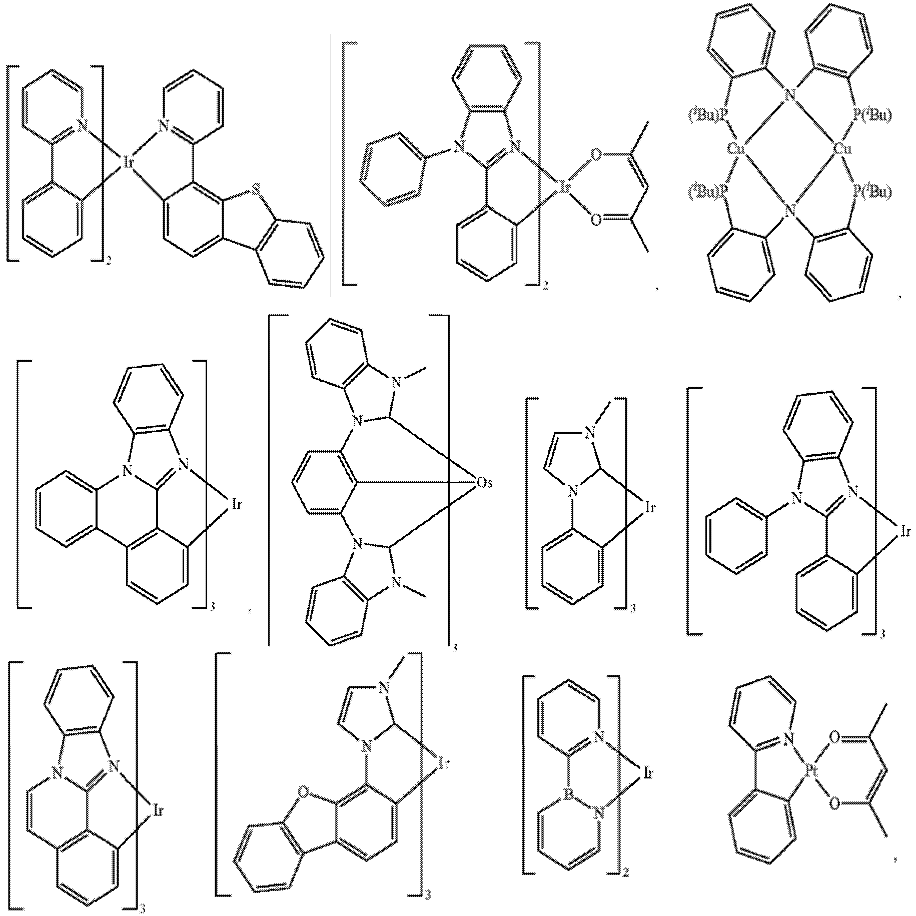

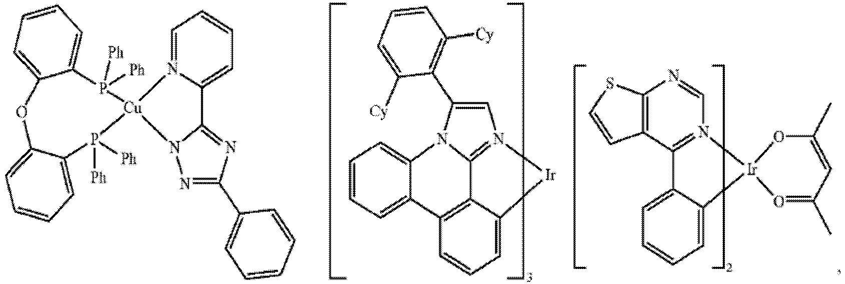

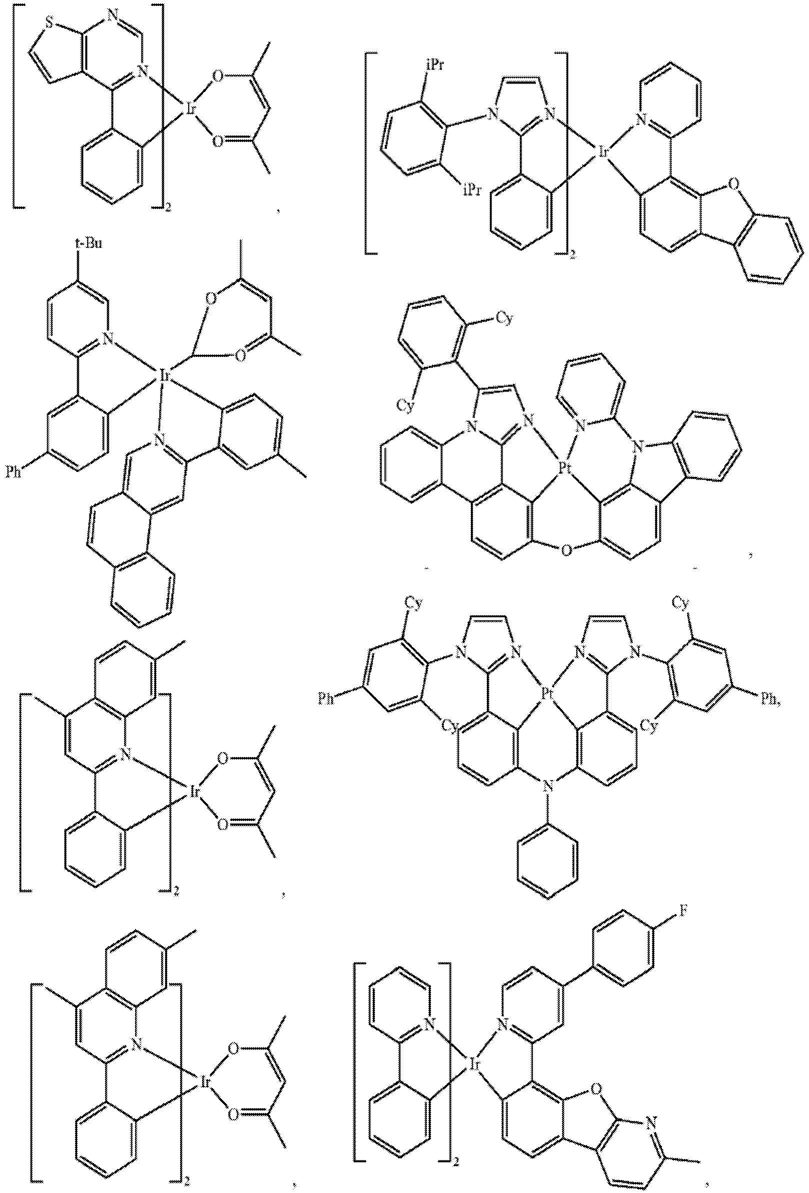

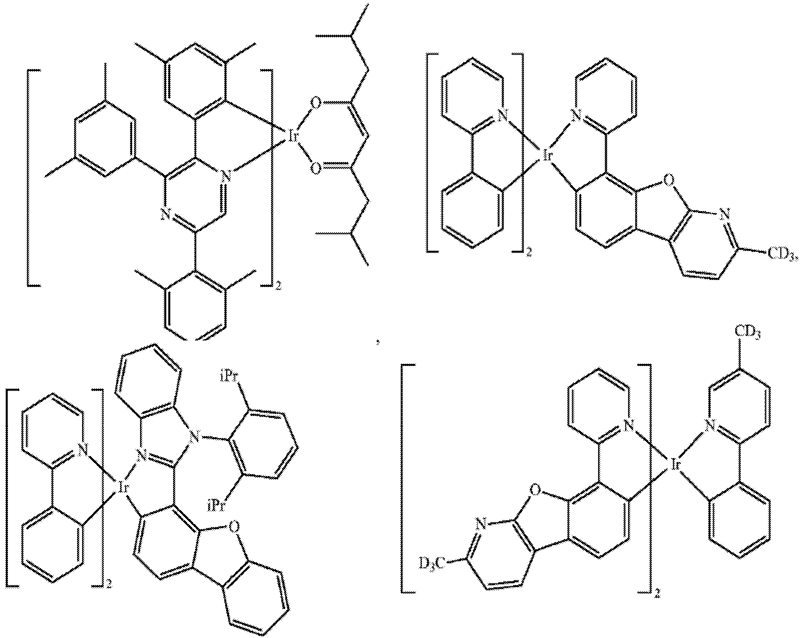

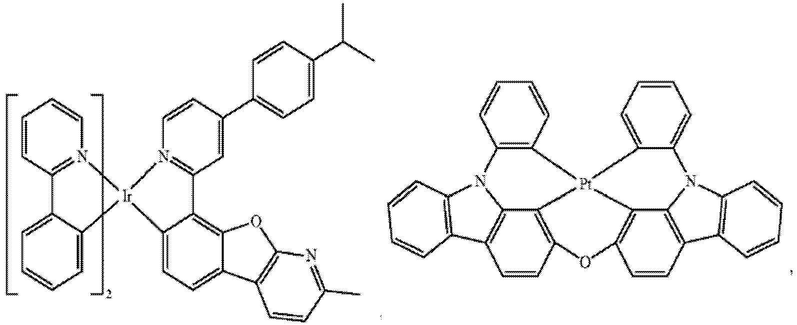

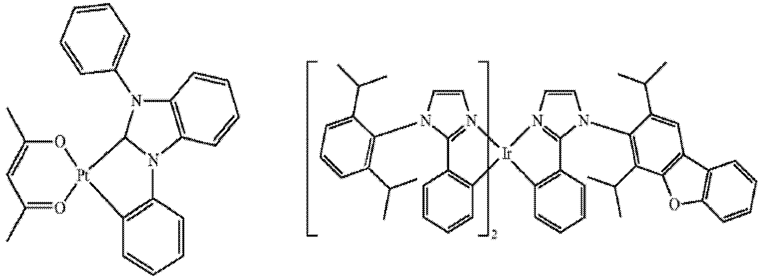

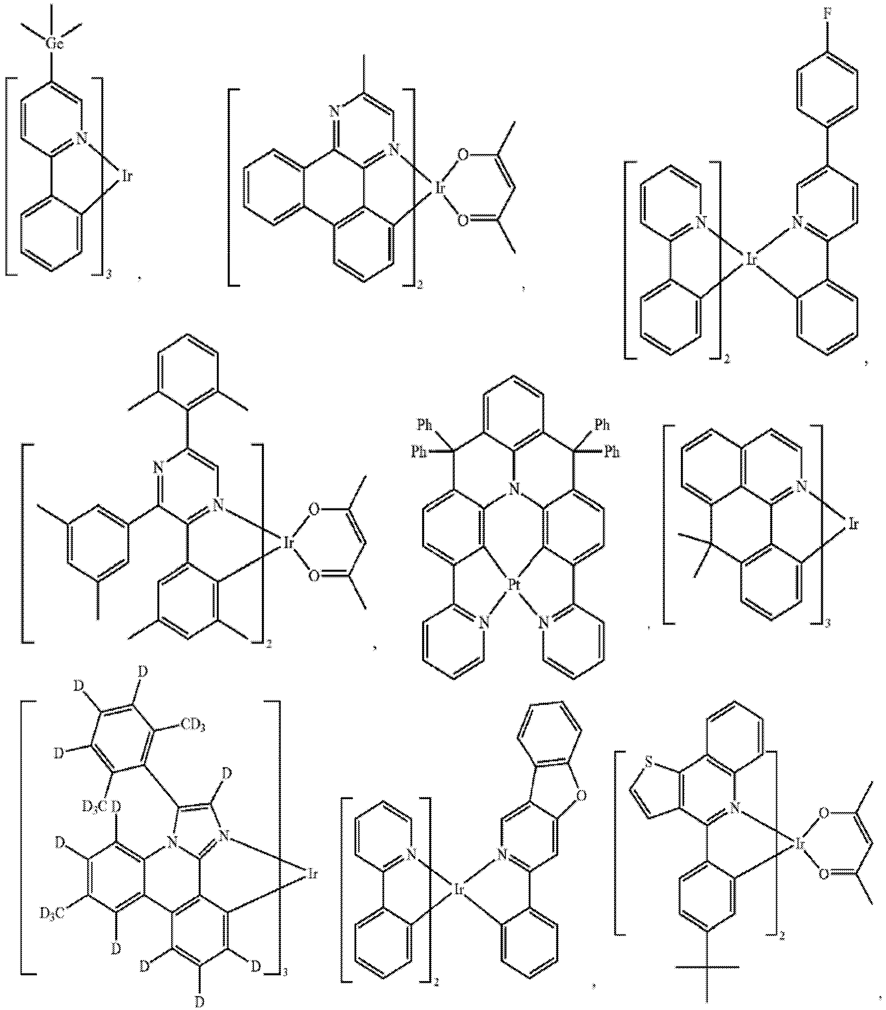

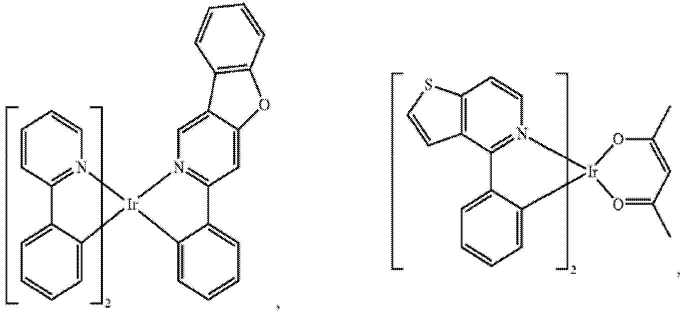

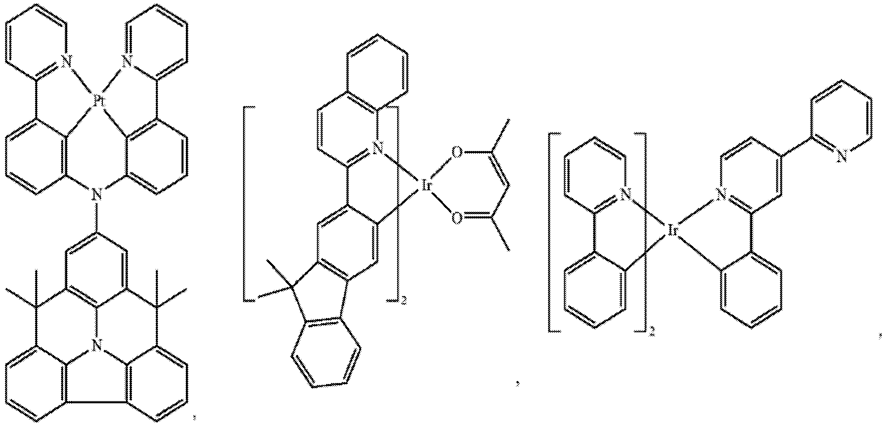

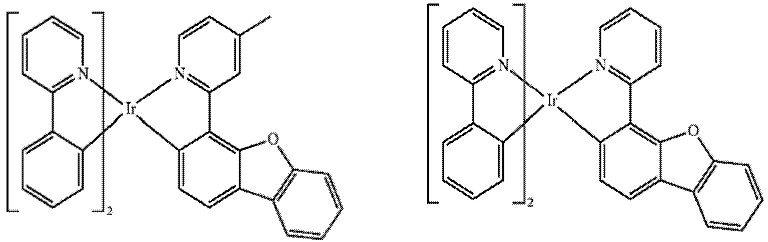

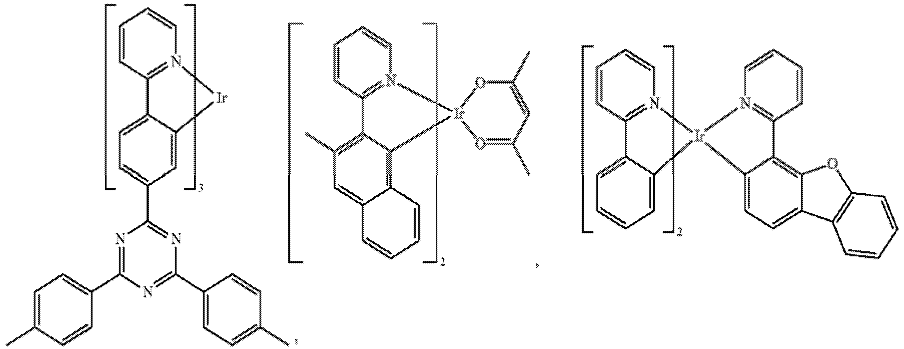

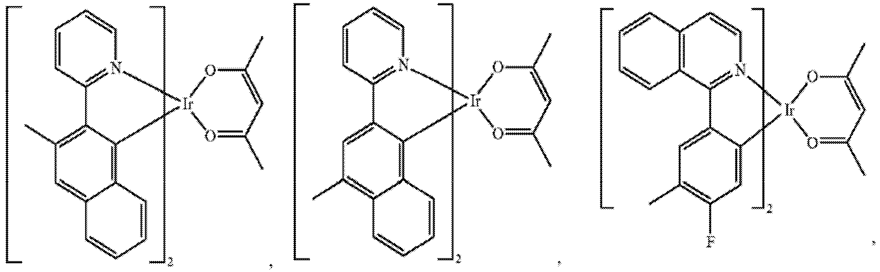

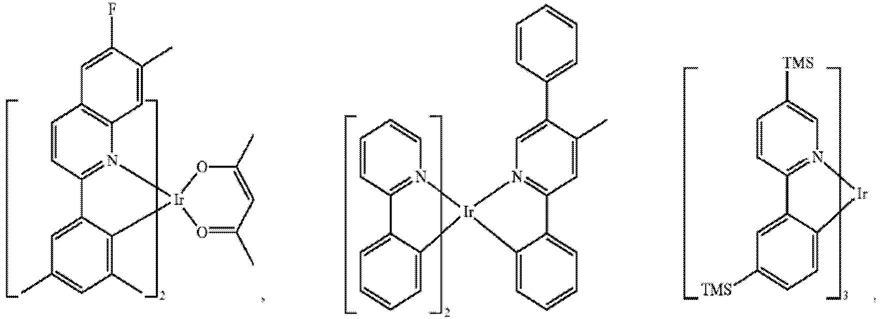

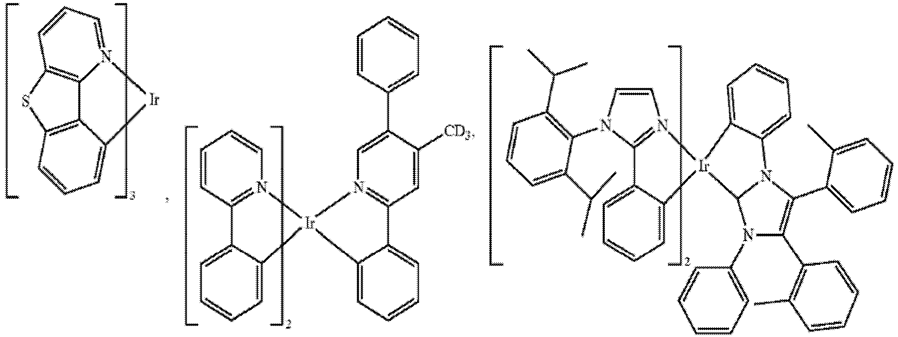

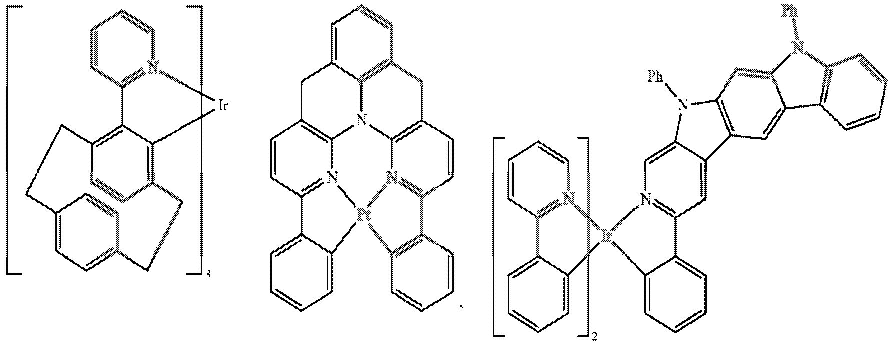

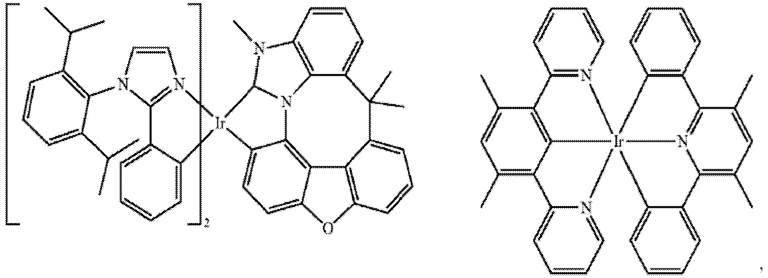

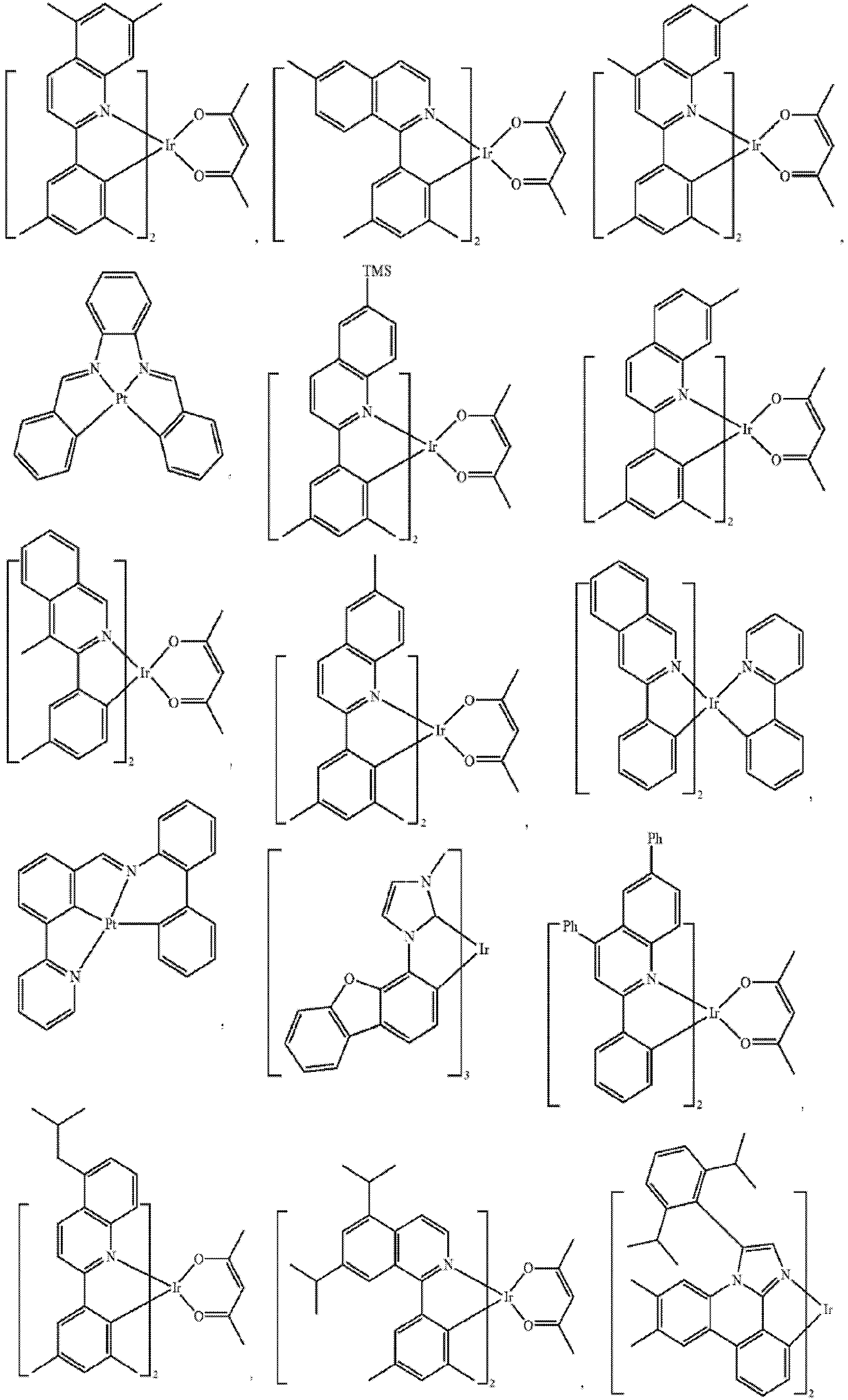

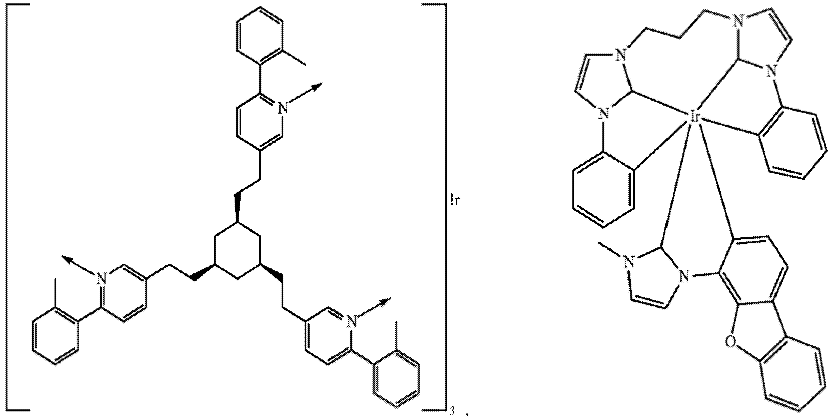

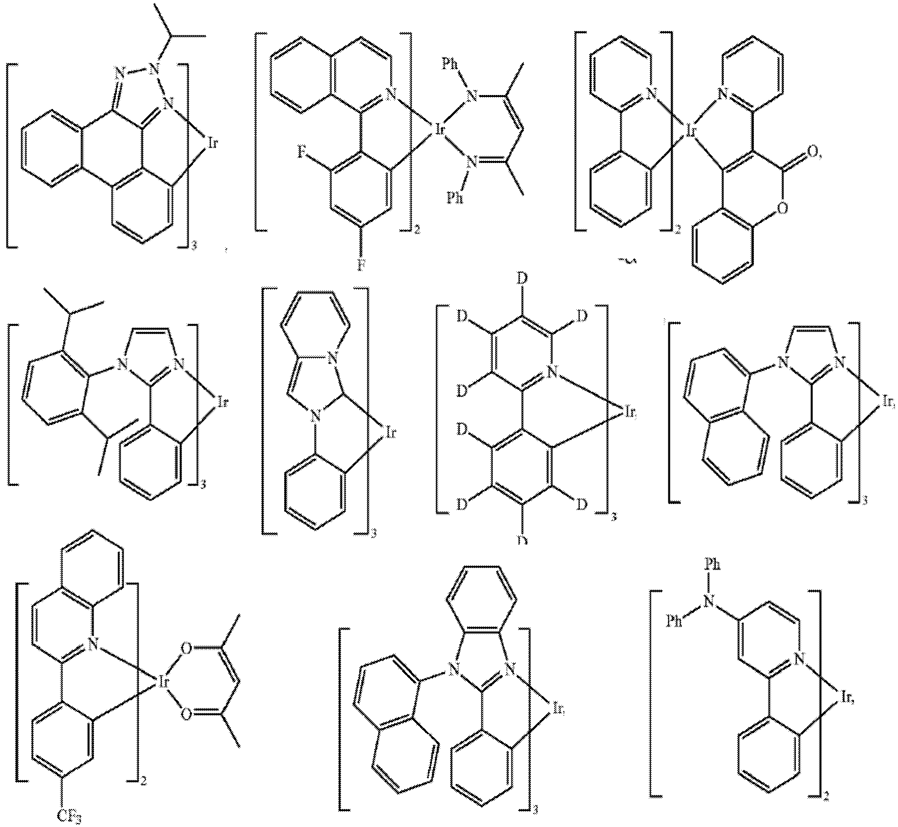

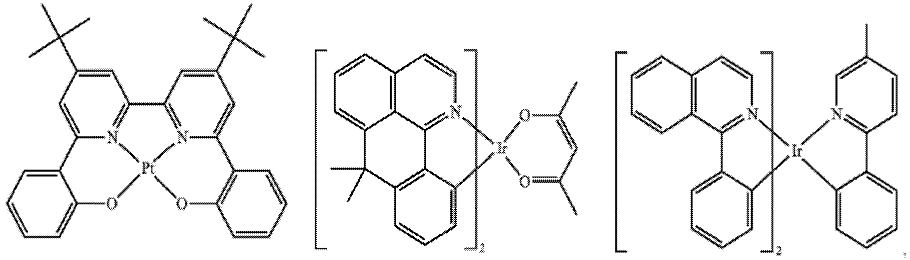

As stated above, the skilled artisan will realize that any phosphorescent complexes used in the state of the art may be suitable as phosphorescence materials P^{B} in the context of the present invention.

In one embodiment of the invention, each phosphorescence material P^{B} comprises Iridium (Ir).

In one embodiment of the invention, the at least one phosphorescence material P^{B}, preferably each phosphorescence material P^{B}, is an organometallic complex comprising either iridium (Ir) or platinum (Pt).

In one embodiment of the invention, the at least one phosphorescence material P^{B}, preferably each phosphorescence material P^{B}, is an organometallic complex comprising iridium (Ir).

In one embodiment of the invention, the at least one phosphorescence material P^{B}, preferably each phosphorescence material P^{B}, is an organometallic complex comprising platinum (Pt).

Non-limiting examples of phosphorescence materials P^{B} also include compounds represented by the following general formula P^{B}-I,

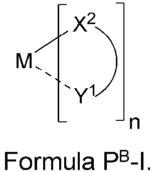

In formula P^{B}-I, M is selected from the group consisting of Ir, Pt, Au, Eu, Ru, Re, Ag and Cu;
n is an integer of 1 to 3; and
X² and Y¹ together form at each occurrence independently from each other a bidentate monoanionic ligand.

In one embodiment of the invention, each phosphorescence materials P^{B} comprises or consists of a structure according to formula P^{B}-I, 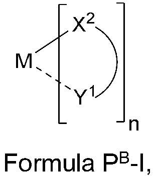
wherein, M is selected from the group consisting of Ir, Pt, Au, Eu, Ru, Re, Ag and Cu;
n is an integer of 1 to 3; and
X² and Y¹ together form at each occurrence independently from each other a bidentate monoanionic ligand.

Examples of the compounds represented by the formula P^{B}-I include compounds represented by the following general formula P^{B}-II or general formula P^{B}-III:

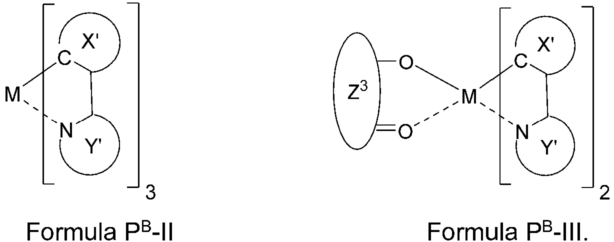

In formulas P^{B}-II and P^{B}-III, X' is an aromatic ring which is carbon(C)-bonded to M and Y' is a ring, which is nitrogen(N)-coordinated to M to form a ring.

X' and Y' are bonded, and X' and Y' may form a new ring. In formula P^{B}-III, Z³ is a bidentate ligand having two oxygens(O). In the formulas P^{B}-II and P^{B}-III, M is preferably Ir from the viewpoint of high efficiency and long lifetime.

In the formulas P^{B}-II and P^{B}-III, the aromatic ring X' is for example a C₆-C₃₀-aryl, preferably a C₆-C₁₆-aryl, even more preferably a C₆-C₁₂-aryl, and particularly preferably a C₆-C₁₀-aryl, wherein X' at each occurrence is optionally substituted with one or more substituents R^{E}.

In the formulas P^{B}-II and P^{B}-III, Y' is for example a C₂-C₃₀-heteroaryl, preferably a C₂-C₂₅-heteroaryl, more preferably a C₂-C₂₀-heteroaryl, even more preferably a C₂-C₁₅-heteroaryl, and particularly preferably a C₂-C₁₀-heteroaryl, wherein Y' at each occurrence is optionally substituted with one or more substituents R^{E}. Furthermore, Y' may be, for example, a C₁-C₅-heteroaryl, which is optionally substituted with one or more substituents R^{E}.

In the formulas P^{B}-II and P^{B}-III, the bidentate ligand having two oxygens(O) Z³ is for example a C₂-C₃₀-bidentate ligand having two oxygens, a C₂-C₂₅-bidentate ligand having two oxygens, more preferably a C₂-C₂₀-bidentate ligand having two oxygens, even more preferably a C₂-C₁₅-bidentate ligand having two oxygens, and particularly preferably a C₂-C₁₀-bidentate ligand having two oxygens, wherein Z³ at each occurrence is optionally substituted with one or more substituents R^{E}. Furthermore, Z³ may be, for example, a C₂-C₅- bidentate ligand having two oxygens, which is optionally substituted with one or more substituents R^{E}.

R^{E} is at each occurrence independently from another selected from the group consisting of hydrogen, deuterium, N(R^{5E})₂, OR^{5E},
SR^{5E}, Si(R^{5E})₃, CF₃, CN, halogen,
C₁-C₄₀-alkyl, which is optionally substituted with one or more substituents R^{5E} and wherein one or more non-adjacent CH₂-groups are optionally substituted by R^{5E}C=CR^{5E}, C≡C, Si(R^{5E})₂, Ge(R^{5E})₂, Sn(R^{5E})₂, C=O, C=S, C=Se, C=NR^{5E}, P(=O)(R^{5E}), SO, SO₂, NR^{5E}, O, S or CONR^{5E};
C₁-C₄₀-thioalkoxy, which is optionally substituted with one or more substituents R^{5E} and wherein one or more non-adjacent CH₂-groups are optionally substituted by R^{5E}C=CR^{5E}, C≡C, Si(R^{5E})₂, Ge(R^{5E})₂, Sn(R^{5E})₂, C=O, C=S, C=Se, C=NR^{5E}, P(=O)(R^{5E}), SO, SO₂, NR^{5E}, O, S or CONR^{5E};
C₆-C₆₀-aryl, which is optionally substituted with one or more substituents R^{5E}; and
C₃-C₅₇-heteroaryl, which is optionally substituted with one or more substituents R^{5E}.

R^{5E} is at each occurrence independently from another selected from the group consisting of hydrogen, deuterium, N(R^{6E})₂, OR^{6E}, SR^{6E}, Si(R^{6E})₃, CF₃, CN, F,
C₁-C₄₀-alkyl, which is optionally substituted with one or more substituents R^{6E} and wherein one or more non-adjacent CH₂-groups are optionally substituted by R^{6E}C=CR^{6E}, C≡C, Si(R^{6E})₂, Ge(R^{6E})₂, Sₙ(R^{6E})₂, C=O, C=S, C=Se, C=NR^{6E}, P(=O)(R^{6E}), SO, SO₂, NR^{6E}, O, S or CONR^{6E};
C₆-C₆₀-aryl, which is optionally substituted with one or more substituents R^{6E}; and
C₃-C₅₇-heteroaryl, which is optionally substituted with one or more substituents R^{6E}
R^{6E} is at each occurrence independently from another selected from the group consisting of hydrogen, deuterium, OPh, CF₃, CN, F,
C₁-C₅-alkyl, wherein one or more hydrogen atoms are optionally, independently from each other substituted by deuterium, CN, CF₃, or F;
C₁-C₅-alkoxy,
   wherein one or more hydrogen atoms are optionally, independently from each other substituted by deuterium, CN, CF₃, or F;
C₁-C₅-thioalkoxy,
   wherein one or more hydrogen atoms are optionally, independently from each other substituted by deuterium, CN, CF₃, or F;
C₆-C₁₈-aryl, which is optionally substituted with one or more C₁-C₅-alkyl substituents;
C₃-C₁₇-heteroaryl,
   which is optionally substituted with one or more C₁-C₅-alkyl substituents;
N(C₆-C₁₈-aryl)₂;
N(C₃-C₁₇-heteroaryl)₂, and
N(C₃-C₁₇-heteroaryl)(C₆-C₁₈-aryl).

The substituents R^{E}, R^{5E}, or R^{6E} independently from each other optionally may form a mono- or polycyclic, aliphatic, aromatic, heteroaromatic and/or benzo-fused ring system with one or more substituents R^{E}, R^{5E}, R^{6E}, and/or with X', Y' and Z³.

Examples of the compound represented by formula P^{B}-II include Ir(ppy)₃, Ir(ppy)₂(acac), Ir(mppy)₃, Ir(PPy)₂(m-bppy), and Btplr(acac), Ir(btp)₂(acac), Ir(2-phq)₃, Hex-Ir(phq)₃, Ir(fbi)₂(acac), fac-Tris(2-(3-p-xylyl)phenyl)pyridine iridium(III), Eu(dbm)₃(Phen), Ir(piq)₃, Ir(piq)₂(acac), Ir(Fiq)₂(acac), Ir(Flq)₂(acac), Ru(dtb-bpy)₃-2(PF6), Ir(2-phq)₃, Ir(BT)₂(acac), Ir(DMP)₃, Ir(Mpq)₃, Ir(phq)₂tpy, fac-Ir(ppy)₂Pc, Ir(dp)PQ₂, Ir(Dpm)(Piq)₂, Hex-Ir(piq)₂(acac), Hex-Ir(piq)₃, Ir(dmpq)₃, Ir(dmpq)₂(acac), FPQIrpic and the like.

Other examples of the compound represented by formula P^{B}-II include compounds represented by the following formulas P^{B}-II-1 to P^{B}-II-11. In the structural formula, "Me" represents a methyl group.

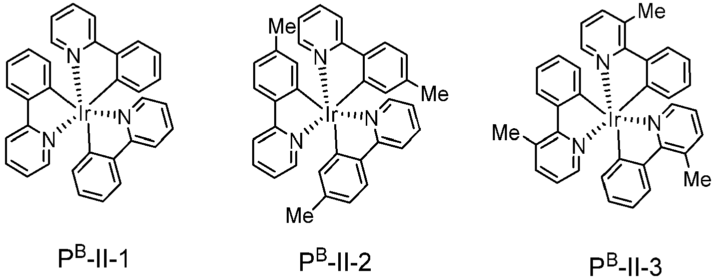

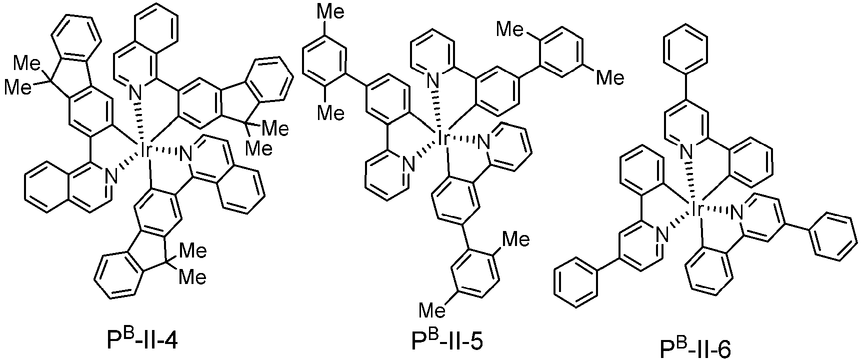

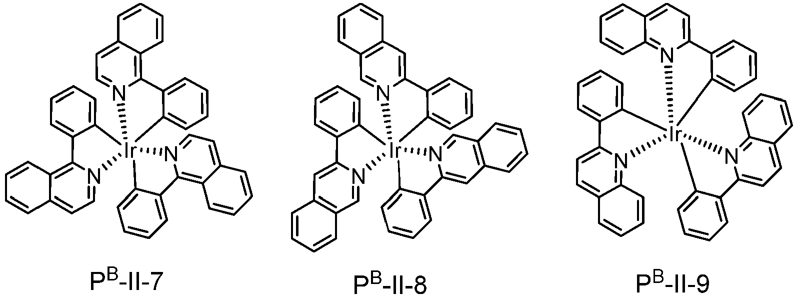

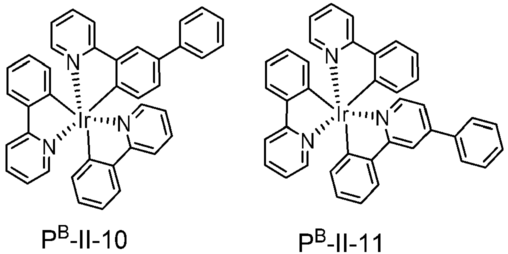

Other examples of the compound represented by the formula P^{B}-III include compounds represented by the following formulas P^{B}-III-1 to P^{B}-III-6. In the structural formula, "Me" represents a methyl group.

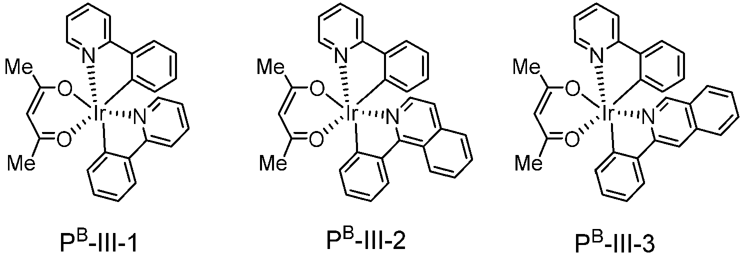

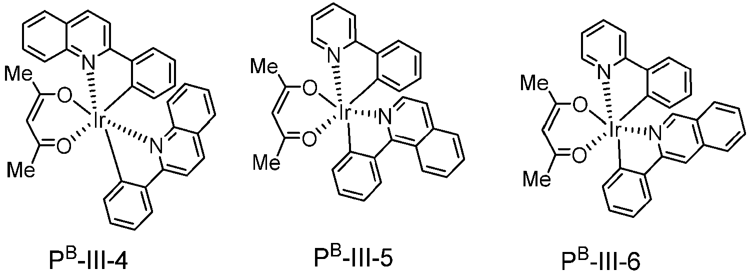

Furthermore, the iridium complexes described in US2003017361 (A1), US2004262576 (A1), WO2010027583 (A1), US2019245153 (A1), US2013119354 (A1), US2019233451 (A1), may be used. From the viewpoint of high efficiency in phosphorescence materials, Ir(ppy)₃ and Hex-Ir(ppy)₃ are often used for green light emission.

### Small FWHM emitter(s) S^{B}

A small full width at half maximum (FWHM) emitter S^{B} in the context of the present invention is any emitter that has an emission spectrum, which exhibits an FWHM of less than or equal to 0.25 eV (≤ 0.25 eV), typically measured from a spin-coated film with 1 to 5% by weight, in particular with 2% by weight of emitter in poly(methyl methacrylate) PMMA at room temperature (i.e., (approximately) 20°C). Alternatively, emission spectra of small FWHM emitters S^{B} may be measured in a solution, typically with 0.001-0.2 mg/mL of the emitter S^{B} in dichloromethane or toluene at room temperature (i.e., (approximately) 20°C).

In a preferred embodiment of the invention, a small FWHM emitter S^{B} is any emitter that has an emission spectrum, which exhibits an FWHM of ≤ 0.24 eV, more preferably of ≤ 0.23 eV, even more preferably of ≤ 0.22 eV, of ≤ 0.21 eV or of ≤ 0.20 eV, measured from a spin-coated film with 1 to 5% by weight, in particular with 2% by weight of emitter S^{B} in PMMA at room temperature. Alternatively, emission spectra of small FWHM emitters S^{B} may be measured in a solution, typically with 0.001-0.2 mg/mL of the emitter S^{B} in dichloromethane or toluene at room temperature (i.e., (approximately) 20°C). In other embodiments of the present invention, each small FWHM emitter S^{B} exhibits an FWHM of ≤ 0.19 eV, of ≤ 0.18 eV, of ≤ 0.17 eV, of ≤ 0.16 eV, of ≤ 0.15 eV, of ≤ 0.14 eV, of ≤ 0.13 eV, of ≤ 0.12 eV, or of ≤ 0.11 eV.

In one embodiment of the invention, each small FWHM emitter S^{B} emits light with an emission maximum in the wavelength range of from 400 nm to 470 nm, measured (with 1 to 5% by weight, in particular with 2% by weight of the emitter S^{B}) in PMMA at room temperature.

In one embodiment of the invention, each small FWHM emitter S^{B} emits light with an emission maximum in the wavelength range of from 500 nm to 560 nm, measured (with 1 to 5% by weight, in particular with 2% by weight of the emitter S^{B}) in PMMA at room temperature.

In one embodiment of the invention, each small FWHM emitter S^{B} emits light with an emission maximum in the wavelength range of from 610 nm to 665 nm, measured (with 1 to 5% by weight, in particular with 2% by weight of the emitter S^{B}) in PMMA at room temperature.

In one embodiment of the invention, each small FWHM emitter S^{B} emits light with an emission maximum in the wavelength range of from 400 nm to 470 nm, measured with 0.001-0.2 mg/mL of the emitter S^{B} in dichloromethane or toluene at room temperature (i.e., (approximately) 20°C).

In one embodiment of the invention, each small FWHM emitter S^{B} emits light with an emission maximum in the wavelength range of from 500 nm to 560 nm, measured with 0.001-0.2 mg/mL of the emitter S^{B} in dichloromethane or toluene at room temperature (i.e., (approximately) 20°C).

In one embodiment of the invention, each small FWHM emitter S^{B} emits light with an emission maximum in the wavelength range of from 610 nm to 665 nm, measured with 0.001-0.2 mg/mL of the emitter S^{B} in dichloromethane or toluene at room temperature (i.e., (approximately) 20°C).

It is understood that a TADF material E^{B} comprised in a light-emitting layer B of an organic electroluminescent device according to the invention may optionally also be an emitter with an emission spectrum which exhibits an FWHM of less than or equal to 0.25 eV (≤ 0.25 eV). Optionally, a TADF material E^{B} comprised in a light-emitting layer B of an organic electroluminescent device according to the invention may also exhibit an emission maximum within the wavelength ranges specified above (namely: 400 nm to 470 nm, 500 nm to 560 nm, 610 nm to 665 nm).

In one embodiment of the invention, one of the relations expressed by the following formulas (23) to (25) applies: $440 nm < {λ}_{max} \left({S}^{B}\right) < 470 nm$ $510 nm < {λ}_{max} \left({S}^{B}\right) < 550 nm$ $610 nm < {λ}_{max} \left({S}^{B}\right) < 665 nm$ wherein λₘₐₓ(S^{B}) refers to the emission maximum of a small FWHM emitter S^{B} in the context of the present invention.

In one embodiment, the aforementioned relations expressed by formulas (23) to (25) apply to materials comprised in any of the at least one light-emitting layer B of the organic electroluminescent device according to the invention. In one embodiment, the aforementioned relations expressed by formulas (23) to (25) apply to materials comprised in the same light-emitting layer B of the organic electroluminescent device according to the invention.

In a preferred embodiment of the invention, each small FWHM emitter S^{B} is an organic emitter, which, in the context of the invention, means that it does not contain any transition metals. Preferably, each small FWHM emitter S^{B} according to the invention predominantly consists of the elements hydrogen (H), carbon (C), nitrogen (N), and boron (B), but may for example also comprise oxygen (O), silicon (Si), fluorine (F), and bromine (Br).

In a preferred embodiment of the invention, each small FWHM emitter S^{B} is a fluorescent emitter, which in the context of the present invention means that, upon electronic excitation (for example in an optoelectronic device according to the invention), the emitter is capable of emitting light at room temperature, wherein the emissive excited state is a singlet state.

In one embodiment of the invention, a small FWHM emitter S^{B} exhibits a photoluminescence quantum yield (PLQY) equal to or higher than 50%, measured (with 1 to 5% by weight, in particular with 2% by weight of the emitter S^{B}) in PMMA at room temperature.

In a preferred embodiment of the invention, a small FWHM emitter S^{B} exhibits a photoluminescence quantum yield (PLQY) equal to or higher than 60%, measured (with 1 to 5% by weight, in particular with 2% by weight of the emitter S^{B}) in PMMA at room temperature.

In an even more preferred embodiment of the invention, a small FWHM emitter S^{B} exhibits a photoluminescence quantum yield (PLQY) equal to or higher than 70%, measured (with 1 to 5% by weight, in particular with 2% by weight of the emitter S^{B}) in PMMA at room temperature.

In a still even more preferred embodiment of the invention, a small FWHM emitter S^{B} exhibits a photoluminescence quantum yield (PLQY) equal to or higher than 80%, measured (with 1 to 5% by weight, in particular with 2% by weight of the emitter S^{B}) in PMMA at room temperature.

In a particularly preferred embodiment of the invention, a small FWHM emitter S^{B} exhibits a photoluminescence quantum yield (PLQY) equal to or higher than 90%, measured (with 1 to 5% by weight, in particular with 2% by weight of the emitter S^{B}) in PMMA at room temperature.

In one embodiment of the invention, a small FWHM emitter S^{B} exhibits a photoluminescence quantum yield (PLQY) equal to or higher than 50%, measured with 0.001-0.2 mg/mL of the emitter S^{B} in dichloromethane or toluene at room temperature (i.e., (approximately) 20°C).

In a preferred embodiment of the invention, a small FWHM emitter S^{B} exhibits a photoluminescence quantum yield (PLQY) equal to or higher than 60%, measured with 0.001-0.2 mg/mL of the emitter S^{B} in dichloromethane or toluene at room temperature (i.e., (approximately) 20°C).

In an even more preferred embodiment of the invention, a small FWHM emitter S^{B} exhibits a photoluminescence quantum yield (PLQY) equal to or higher than 70%, measured with 0.001-0.2 mg/mL of the emitter S^{B} in dichloromethane or toluene at room temperature (i.e., (approximately) 20°C).

In a still even more preferred embodiment of the invention, a small FWHM emitter S^{B} exhibits a photoluminescence quantum yield (PLQY) equal to or higher than 80%, measured with 0.001-0.2 mg/mL of the emitter S^{B} in dichloromethane or toluene at room temperature (i.e., (approximately) 20°C).

In a particularly preferred embodiment of the invention, a small FWHM emitter S^{B} exhibits a photoluminescence quantum yield (PLQY) equal to or higher than 90%, measured with 0.001-0.2 mg/mL of the emitter S^{B} in dichloromethane or toluene at room temperature (i.e., (approximately) 20°C).

The person skilled in the art knows how to design small FWHM emitters S^{B} which fulfill the above-mentioned requirements or preferred features.

A class of molecules suitable to provide small FWHM emitters S^{B} in the context of the present invention are the well-known 4,4-difluoro-4-bora-3a,4a-diaza-s-indacene (BODIPY)-based materials, whose structural features and application in organic electroluminescent devices have been reviewed in detail and are common knowledge to those skilled in the art. The state of the art also reveals how such materials may be synthesized and how to arrive at an emitter with a certain emission color.

See for example: J. Liao, Y. Wang, Y. Xu, H. Zhao, X. Xiao, X. Yang, Tetrahedron 2015, 71(31), 5078, DOI: 10.1016/j.tet.2015.05.054; B.M Squeo, M. Pasini, Supramolecular Chemistry 2020, 32(1), 56-70, DOI: 10.1080/10610278.2019.1691727; M. Poddar, R. Misra, Coordination Chemistry Reviews 2020, 421, 213462-213483; DOI: 10.1016/j.ccr.2020.213462.

The skilled artisan is also familiar with the fact that the BODIPY base structure shown below 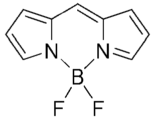 is not ideally suitable as emitter in an organic electroluminescent device, for example due to intermolecular π-π interactions and the associated self-quenching. It is common knowledge to those skilled in the art that one may arrive at more suitable emitter molecules for organic electroluminescent devices by attaching bulky groups as substituents to the BODIPY core structure shown above. These bulky groups may for example (among many others) be aryl, heteroaryl, alkyl or alkoxy substituents or condensed polycyclic aromatics, or heteroaromatics, all of which may optionally be substituted. The choice of suitable substituents at the BODIPY core is obvious for the skilled artisan and can easily be derived from the state of the art. The same holds true for the multitude of synthetic pathways which have been established for the synthesis and subsequent modification of such molecules.

See for example: B.M Squeo, M. Pasini, Supramolecular Chemistry 2020, 32(1), 56-70, DOI: 10.1080/10610278.2019.1691727; M. Poddar, R. Misra, Coordination Chemistry Reviews 2020, 421, 213462-213483; DOI: 10.1016/j.ccr.2020.213462.

Examples of BODIPY-based emitters that may be suitable as small FWHM emitters S^{B} in the context of the present invention are shown below:

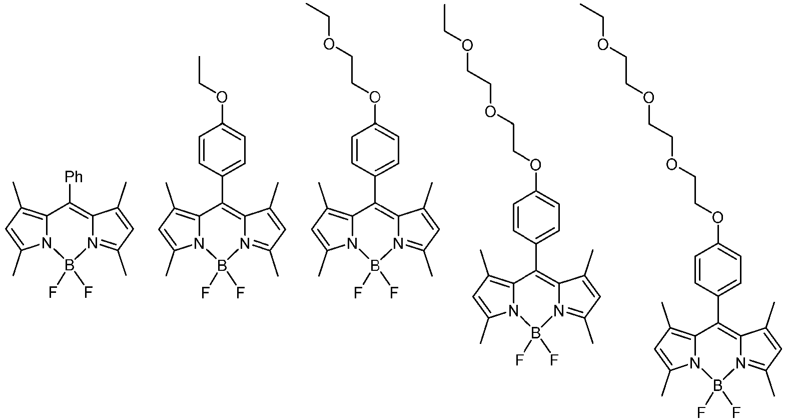

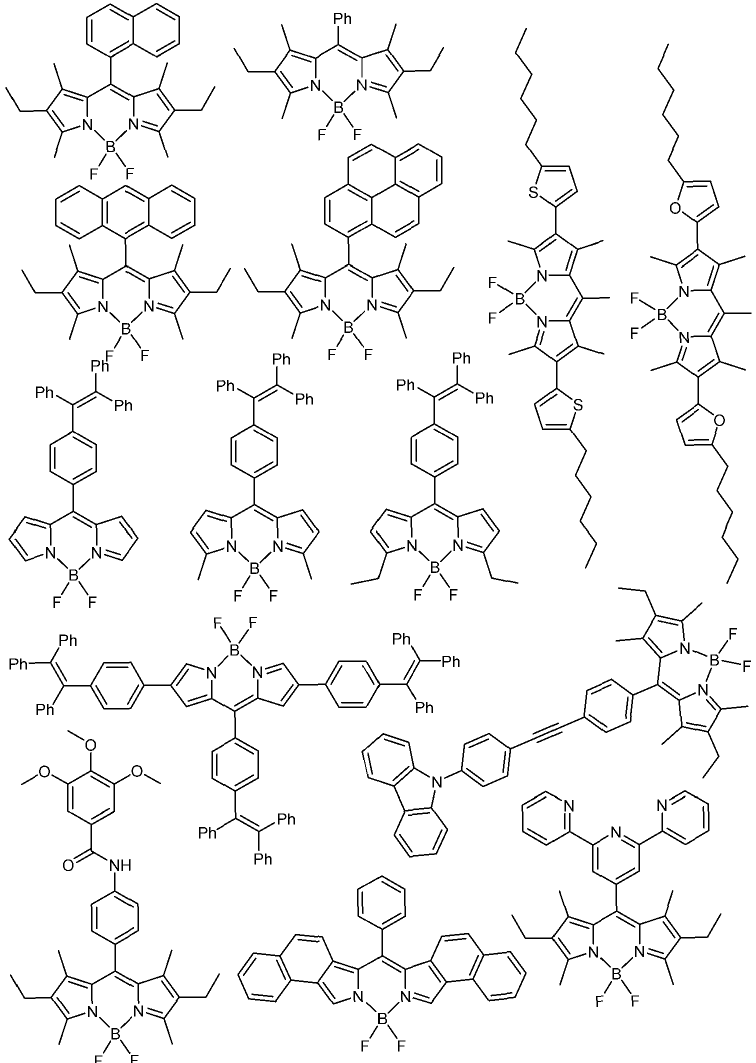

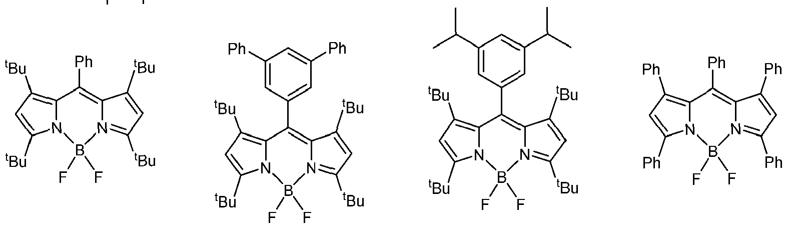

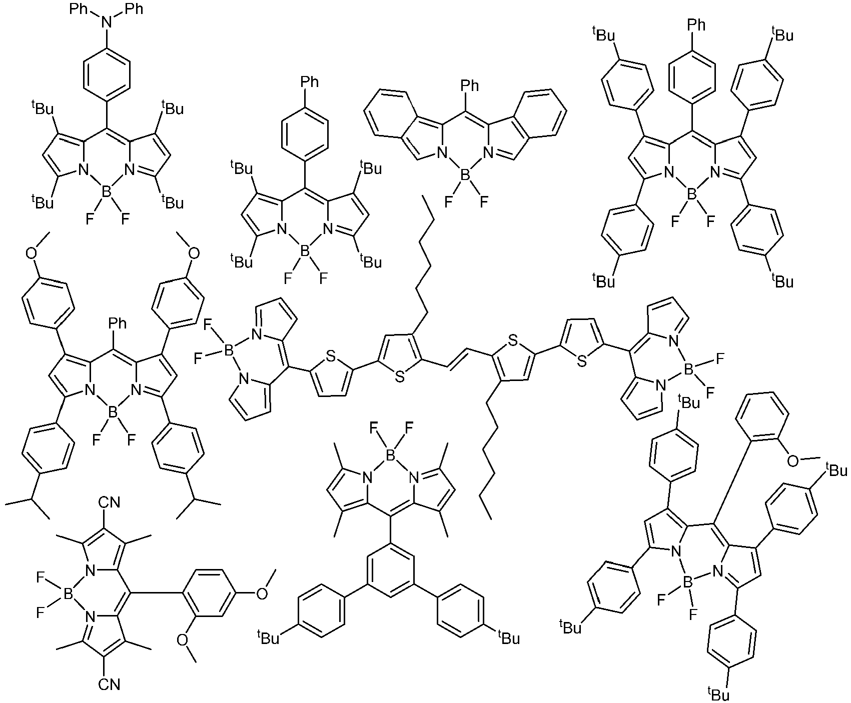

It is understood that this does not imply that BODIPY-derivatives with other structural features than those shown above are not suited as small FWHM emitters S^{B} in the context of the present invention.

For example, the BODIPY-derived structures disclosed in US2020251663 (A1), EP3671884 (A1), US20160230960 (A1), US20150303378 (A1) or derivatives thereof may be suitable small FWHM emitters S^{B} for use according to the present invention.

Furthermore, it is known to those skilled in the art, that one may also arrive at emitters for organic electroluminescent devices by replacing one or both of the fluorine substituents attached to the central boron atom of the BODIPY core structure by alkoxy or aryloxy groups which are attached via the oxygen atom and may optionally be substituted, preferably with electron-withdrawing substituents such as fluorine (F) or trifluoromethyl (CF₃). Such molecules are for example disclosed in US2012037890 (A1) and the person skilled in the art understands that these BODIPY-related compounds may also be suitable small FWHM emitters S^{B} in the context of the present invention. Examples of such emitter molecules are shown below, which does not imply that only the shown structures may be suitable small FWHM emitters S^{B} in the context of the present invention:

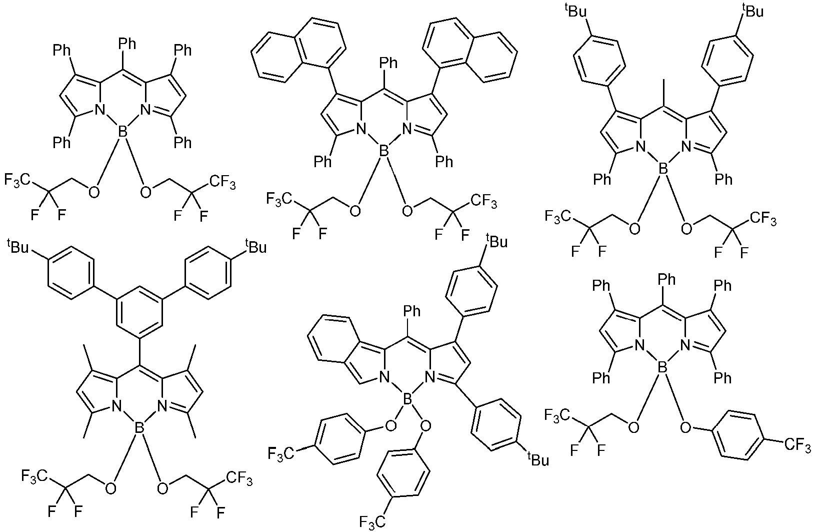

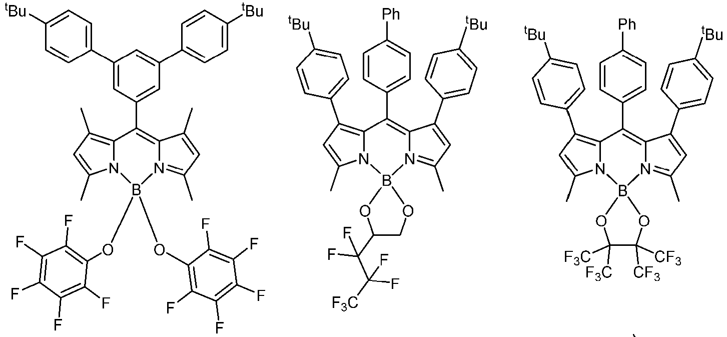

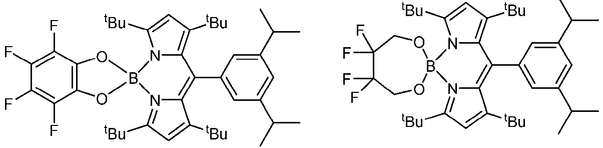

Additionally, the BODIPY-related boron-containing emitters disclosed in US20190288221 (A1) constitute a group of emitters that may provide suitable small FWHM emitters S^{B} for use according to the present invention.

Another class of molecules suitable to provide small FWHM emitters S^{B} in the context of the invention are *near-range-charge-transfer* (NRCT) emitters.

Typical NRCT emitters are described in the literature to show a delayed component in the time-resolved photoluminescence spectrum and exhibit a near-range HOMO-LUMO separation. See for example: T. Hatakeyama, K. Shiren, K. Nakajima, S. Nomura, S. Nakatsuka, K. Kinoshita, J. Ni, Y. Ono, and T. Ikuta, Advanced Materials 2016, 28(14), 2777, DOI: 10.1002/adma.201505491.

Typical NRCT emitters only show one emission band in the emission spectrum, wherein typical fluorescence emitters display several distinct emission bands due to vibrational progression.

The skilled artisan knows how to design and synthesize NRCT emitters that may be suitable as small FWHM emitters S^{B} in the context of the present invention. For example, the emitters disclosed in EP3109253 (A1) may be used as small FWHM emitters S^{B} in the context of the present invention.

Furthermore, for example, US2014058099 (A1), US2009295275 (A1), US2012319052 (A1), EP2182040 (A2), US2018069182 (A1), US2019393419 (A1), US2020006671 (A1), US2020098991 (A1), US2020176684 (A1), US2020161552 (A1), US2020227639 (A1), US2020185635 (A1), EP3686206 (A1), EP3686206 (A1), WO2020217229 (A1), WO2020208051 (A1), and US2020328351 (A1) disclose emitter materials that may be suitable as small FWHM emitters S^{B} for use according to the present invention.

A group of emitters that may be used as small FWHM emitters S^{B} in the context of the present invention are the boron (B)-containing emitters comprising or consisting of a structure according to the following formula DABNA-I: 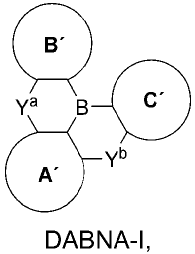 wherein
each of ring A', ring B', and ring C' independently of each other represents an aromatic or heteroaromatic ring, each comprising 5 to 24 ring atoms, out of which, in case of a heteroaromatic ring, 1 to 3 ring atoms are heteroatoms independently of each other selected from N, O, S, and Se; wherein
one or more hydrogen atoms in each of the aromatic or heteroaromatic rings A', B', and C' are optionally and independently of each other substituted by a substituent R^{DABNA-1}, which is at each occurrence independently of each other selected from the group consisting of: deuterium, N(R^{DABNA}-²)₂, OR^{DABNA-2}, SR^{DABNA-2}, Si(R^{DABNA-2})₃, B(OR^{DABNA-2})₂, OSO₂R^{DABNA-2}, CF₃, CN, halogen (F, Cl, Br, I),
C₁-C₄₀-alkyl,
   which is optionally substituted with one or more substituents R^{DABNA-2} and wherein one or more non-adjacent CH₂-groups are optionally substituted by R^{DABNA-2}C=CR^{DABNA-2}, C≡C, Si(R^{DABNA-2})₂, Ge(R^{DABNA-2})₂, Sn(R^{DABNA-2})₂, C=O, C=S, C=Se, C=NR^{DABNA-2}, P(=O)(R^{DABNA-2}), SO, SO₂, NR^{DABNA-2}, O, S or CONR^{DABNA-2};
C₁-C₄₀-alkoxy,
   which is optionally substituted with one or more substituents R^{DABNA-2} and wherein one or more non-adjacent CH₂-groups are optionally substituted by R^{DABNA-2}C=CR^{DABNA-2}, C≡C, Si(R^{DABNA-2})₂, Ge(R^{DABNA-2})₂, Sn(R^{DABNA-2})₂, C=O, C=S, C=Se, C=NR^{DABNA-2}, P(=O)(R^{DABNA-2}), SO, SO₂, NR^{DABNA-2}, O, S or CONR^{DABNA-2};
C₁-C₄₀-thioalkoxy,
   which is optionally substituted with one or more substituents R^{DABNA-2} and wherein one or more non-adjacent CH₂-groups are optionally substituted by R^{DABNA-2}C=CR^{DABNA-2}, C≡C, Si(R^{DABNA-2})₂, Ge(R^{DABNA-2})₂, Sn(R^{DABNA-2})₂, C=O, C=S, C=Se, C=NR^{DABNA-2}, P(=O)(R^{DABNA-2}), SO, SO₂, NR^{DABNA-2}, O, S or CONR^{DABNA-2};
C₂-C₄₀-alkenyl,
   which is optionally substituted with one or more substituents R^{DABNA-2} and wherein one or more non-adjacent CH₂-groups are optionally substituted by R^{DABNA-2}C=CR^{DABNA-2}, C≡C, Si(R^{DABNA-2})₂, Ge(R^{DABNA-2})₂, Sn(R^{DABNA-2})₂, C=O, C=S, C=Se, C=NR^{DABNA-2}, P(=O)(R^{DABNA-2}), SO, SO₂, NR^{DABNA-2}, O, S or CONR^{DABNA-2};
C₂-C₄₀-alkynyl,
   which is optionally substituted with one or more substituents R^{DABNA-2} and wherein one or more non-adjacent CH₂-groups are optionally substituted by R^{DABNA-2}C=CR^{DABNA-2}, Si(R^{DABNA-2})₂, Ge(R^{DABNA-2})₂, Sn(R^{DABNA-2})₂, C=O, C=S, C=Se, C=NR^{DABNA-2}, P(=O)(R^{DABNA-2}), SO, SO₂, NR^{DABNA-2}, O, S or CONR^{DABNA-2};
C₆-C₆₀-aryl,
   which is optionally substituted with one or more substituents R^{DABNA-2};
C₃-C₅₇-heteroaryl,
   which is optionally substituted with one or more substituents R^{DABNA-2};
and aliphatic, cyclic amines comprising 4 to 18 carbon atoms and 1 to 3 nitrogen atoms;
R^{DABNA-2} is at each occurrence independently of each other selected from the group consisting of: hydrogen, deuterium, N(R^{DABNA-6})₂, OR^{DABNA-6}, SR^{DABNA-6}, Si(R^{DABNA-6})₃, B(OR^{DABNA-6})₂, OSO₂R^{DABNA-6}, CF₃, CN, halogen (F, Cl, Br, I),
C₁-C₅-alkyl,
   which is optionally substituted with one or more substituents R^{DABNA-6} and wherein one or more non-adjacent CH₂-groups are optionally substituted by R^{DABNA-6}C=CR^{DABNA-6}, C≡C, Si(R^{DABNA-2})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₁-C₅-alkoxy,
   which is optionally substituted with one or more substituents R^{DABNA-6} and wherein one or more non-adjacent CH₂-groups are optionally substituted by R^{DABNA-6}C=CR^{DABNA-6}, C≡C, Si(R^{DABNA-2})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₁-C₅-thioalkoxy,
   which is optionally substituted with one or more substituents R^{DABNA-6} and wherein one or more non-adjacent CH₂-groups are optionally substituted by R^{DABNA-6}C=CR^{DABNA-6}, C≡C, Si(R^{DABNA-2})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₂-C₅-alkenyl,
   which is optionally substituted with one or more substituents R^{DABNA-6} and wherein one or more non-adjacent CH₂-groups are optionally substituted by R^{DABNA-6}C=CR^{DABNA-6}, C≡C, Si(R^{DABNA-2})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₂-C₅-alkynyl,
   which is optionally substituted with one or more substituents R^{DABNA-6} and wherein one or more non-adjacent CH₂-groups are optionally substituted by R^{DABNA-6}C=CR^{DABNA-6}, Si(R^{DABNA-6})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₆-C₁₈-aryl,
   which is optionally substituted with one or more substituents R^{DABNA-6};
C₃-C₁₇-heteroaryl,
   which is optionally substituted with one or more substituents R^{DABNA-6};
and aliphatic, cyclic amines comprising 4 to 18 carbon atoms and 1 to 3 nitrogen atoms;
wherein two or more adjacent substituents selected from R^{DABNA-1} and R^{DABNA-2} optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms;
Y^{a} and Y^{b} are independently of each other selected from a direct (single) bond, NR^{DABNA-3}, O, S, Si(R^{DABNA-2})₂, Si(R^{DABNA-3})₂, BR^{DABNA-3}, and Se;
R^{DABNA-3} is at each occurrence independently of each other selected from the group consisting of: hydrogen, deuterium, N(R^{DABNA-4})₂, OR^{DABNA-4}, SR^{DABNA-4}, Si(R^{DABNA-4})₃, B(OR^{DABNA-4})₂, OSO₂R^{DABNA-4}, CF₃, CN, halogen (F, Cl, Br, I),
C₁-C₄₀-alkyl,
   which is optionally substituted with one or more substituents R^{DABNA-4} and wherein one or more non-adjacent CH₂-groups are optionally substituted by R^{DABNA-4}C=CR^{DABNA-4}, C≡C, Si(R^{DABNA-2})₂, Ge(R^{DABNA-4})₂, Sn(R^{DABNA-4})₂, C=O, C=S, C=Se, C=NR^{DABNA-4}, P(=O)(R^{DABNA-4}), SO, SO₂, NR^{DABNA-4}, O, S or CONR^{DABNA-4};
C₁-C₄₀-alkoxy,
   which is optionally substituted with one or more substituents R^{DABNA-4} and wherein one or more non-adjacent CH₂-groups are optionally substituted by R^{DABNA-4}C=CR^{DABNA-4}, C≡C, Si(R^{DABNA-2})₂, Ge(R^{DABNA-4})₂, Sn(R^{DABNA-4})₂, C=O, C=S, C=Se, C=NR^{DABNA-4}, P(=O)(R^{DABNA-4}), SO, SO₂, NR^{DABNA-4}, O, S or CONR^{DABNA-4};
C₁-C₄₀-thioalkoxy,
   which is optionally substituted with one or more substituents R^{DABNA-4} and wherein one or more non-adjacent CH₂-groups are optionally substituted by R^{DABNA-4}C=CR^{DABNA-4}, C≡C, Si(R^{DABNA-2})₂, Ge(R^{DABNA-4})₂, Sn(R^{DABNA-4})₂, C=O, C=S, C=Se, C=NR^{DABNA-4}, P(=O)(R^{DABNA-4}), SO, SO₂, NR^{DABNA-4}, O, S or CONR^{DABNA-4};
C₂-C₄₀-alkenyl,
   which is optionally substituted with one or more substituents R^{DABNA-4} and wherein one or more non-adjacent CH₂-groups are optionally substituted by R^{DABNA-4}C=CR^{DABNA-4}, C≡C, Si(R^{DABNA-2})₂, Ge(R^{DABNA-4})₂, Sn(R^{DABNA-4})₂, C=O, C=S, C=Se, C=NR^{DABNA-4}, P(=O)(R^{DABNA-4}), SO, SO₂, NR^{DABNA-4}, O, S or CONR^{DABNA-4};
C₂-C₄₀-alkynyl,
   which is optionally substituted with one or more substituents R^{DABNA-4} and wherein one or more non-adjacent CH₂-groups are optionally substituted by R^{DABNA-4}C=CR^{DABNA-4}, Si(R^{DABNA-4})₂, Ge(R^{DABNA-4})₂, Sn(R^{DABNA-4})₂, C=O, C=S, C=Se, C=NR^{DABNA-4}, P(=O)(R^{DABNA-4}), SO, SO₂, NR^{DABNA-4}, O, S or CONR^{DABNA-4};
C₆-C₆₀-aryl,
   which is optionally substituted with one or more substituents R^{DABNA-4};
C₃-C₅₇-heteroaryl,
   which is optionally substituted with one or more substituents R^{DABNA-4};
and aliphatic, cyclic amines comprising 4 to 18 carbon atoms and 1 to 3 nitrogen atoms;
R^{DABNA-4} is at each occurrence independently of each other selected from the group consisting of: hydrogen, deuterium, N(R^{DABNA-5})₂, OR^{DABNA-5}, SR^{DABNA-5}, Si(R^{DABNA-5})₃, B(OR^{DABNA-5})₂, OSO₂R^{DABNA-5}, CF₃, CN, halogen (F, Cl, Br, I),
C₁-C₄₀-alkyl,
   which is optionally substituted with one or more substituents R^{DABNA-5} and wherein one or more non-adjacent CH₂-groups are optionally substituted by R^{DABNA-5}C=CR^{DABNA-5}, C≡C, Si(R^{DABNA-2})₂, Ge(R^{DABNA-5})2, Sn(R^{DABNA-5})₂, C=O, C=S, C=Se, C=NR^{DABNA-5}, P(=O)(R^{DABNA-5}), SO, SO₂, NR^{DABNA-5}, O, S or CONR^{DABNA-5};
C₁-C₄₀-alkoxy,
   which is optionally substituted with one or more substituents R^{DABNA-5} and wherein one or more non-adjacent CH₂-groups are optionally substituted by R^{DABNA-5}C=CR^{DABNA-5}, C≡C, Si(R^{DABNA-2})₂, Ge(R^{DABNA-5})₂, Sn(R^{DABNA-5})₂, C=O, C=S, C=Se, C=NR^{DABNA-5}, P(=O)(R^{DABNA-5}), SO, SO₂, NR^{DABNA-5}, O, S or CONR^{DABNA-5};
C₁-C₄₀-thioalkoxy,
   which is optionally substituted with one or more substituents R^{DABNA-5} and wherein one or more non-adjacent CH₂-groups are optionally substituted by R^{DABNA-5}C=CR^{DABNA-5}, C≡C, Si(R^{DABNA-2})₂, Ge(R^{DABNA-5})₂, Sn(R^{DABNA-5})₂, C=O, C=S, C=Se, C=NR^{DABNA-5}, P(=O)(R^{DABNA-5}), SO, SO₂, NR^{DABNA-5}, O, S or CONR^{DABNA-5};
C₂-C₄₀-alkenyl,
   which is optionally substituted with one or more substituents R^{DABNA-5} and wherein one or more non-adjacent CH₂-groups are optionally substituted by R^{DABNA-5}C=CR^{DABNA-5}, C≡C, Si(R^{DABNA-2})₂, Ge(R^{DABNA-5})₂, Sn(R^{DABNA-5})₂, C=O, C=S, C=Se, C=NR^{DABNA-5}, P(=O)(R^{DABNA-5}), SO, SO₂, NR^{DABNA-5}, O, S or CONR^{DABNA-5};
C₂-C₄₀-alkynyl,
   which is optionally substituted with one or more substituents R^{DABNA-5} and wherein one or more non-adjacent CH₂-groups are optionally substituted by R^{DABNA-5}C=CR^{DABNA-5}, Si(R^{DABNA-5})₂, Ge(R^{DABNA-5})₂, Sn(R^{DABNA-5})₂, C=O, C=S, C=Se, C=NR^{DABNA-5}, P(=O)(R^{DABNA-5}), SO, SO₂, NR^{DABNA-5}, O, S or CONR^{DABNA-5};
C₆-C₆₀-aryl,
   which is optionally substituted with one or more substituents R^{DABNA-5}; C₃-C₅₇-heteroaryl,
   which is optionally substituted with one or more substituents R^{DABNA-5};
and aliphatic, cyclic amines comprising 4 to 18 carbon atoms and 1 to 3 nitrogen atoms;
R^{DABNA-5} is at each occurrence independently of each other selected from the group consisting of: hydrogen, deuterium, N(R^{DABNA-6})₂, OR^{DABNA-6}, SR^{DABNA-6}, Si(R^{DABNA-6})₃, B(OR^{DABNA-6})₂, OSO₂R^{DABNA-6}, CF₃, CN, halogen (F, Cl, Br, I),
C₁-C₅-alkyl,
   which is optionally substituted with one or more substituents R^{DABNA-6} and wherein one or more non-adjacent CH₂-groups are optionally substituted by R^{DABNA-6}C=CR^{DABNA-6}, C≡C, Si(R^{DABNA-2})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₁-C₅-alkoxy,
   which is optionally substituted with one or more substituents R^{DABNA-6} and wherein one or more non-adjacent CH₂-groups are optionally substituted by R^{DABNA-6}C=CR^{DABNA-6}, C≡C, Si(R^{DABNA-2})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₁-C₅-thioalkoxy,
   which is optionally substituted with one or more substituents R^{DABNA-6} and wherein one or more non-adjacent CH₂-groups are optionally substituted by R^{DABNA-6}C=CR^{DABNA-6}, C≡C, Si(R^{DABNA-2})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₂-C₅-alkenyl,
   which is optionally substituted with one or more substituents R^{DABNA-6} and wherein one or more non-adjacent CH₂-groups are optionally substituted by R^{DABNA-6}C=CR^{DABNA-6}, C≡C, Si(R^{DABNA-2})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₂-C₅-alkynyl,
   which is optionally substituted with one or more substituents R^{DABNA-6} and wherein one or more non-adjacent CH₂-groups are optionally substituted by R^{DABNA-6}C=CR^{DABNA-6}, Si(R^{DABNA-6})₂, Ge(R^{DABNA-6})₂, Sn(R^{DABNA-6})₂, C=O, C=S, C=Se, C=NR^{DABNA-6}, P(=O)(R^{DABNA-6}), SO, SO₂, NR^{DABNA-6}, O, S or CONR^{DABNA-6};
C₆-C₁₈-aryl,
   which is optionally substituted with one or more substituents R^{DABNA-6};
C₃-C₁₇-heteroaryl,
   which is optionally substituted with one or more substituents R^{DABNA-6};
and aliphatic, cyclic amines comprising 4 to 18 carbon atoms and 1 to 3 nitrogen atoms;
wherein two or more adjacent substituents selected from R^{DABNA-3}, R^{DABNA-4}, and R^{DABNA-5} optionally form a mono- or polycyclic, aliphatic or aromatic or heteroaromatic, carbocyclic or heterocyclic ring system with each other, wherein the optionally so formed ring system comprises in total 8 to 30 ring atoms;
R^{DABNA-6} is at each occurrence independently of each other selected from the group consisting of: hydrogen, deuterium, OPh (Ph = phenyl), SPh, CF₃, CN, F, Si(C₁-C₅-alkyl)₃, Si(Ph)₃,
C₁-C₅-alkyl,
   wherein optionally one or more hydrogen atoms are independently substituted by deuterium, Ph, CN, CF₃, or F;
C₁-C₅-alkoxy,
   wherein optionally one or more hydrogen atoms are independently substituted by deuterium, CN, CF₃, or F;
C₁-C₅-thioalkoxy,
   wherein optionally one or more hydrogen atoms are independently substituted by deuterium, CN, CF₃, or F;
C₂-C₅-alkenyl,
   wherein optionally one or more hydrogen atoms are independently substituted by deuterium, CN, CF₃, or F;
C₂-C₅-alkynyl,
   wherein optionally one or more hydrogen atoms are independently substituted by deuterium, CN, CF₃, or F;
C₆-C₁₈-aryl,
   wherein optionally one or more hydrogen atoms are independently substituted by deuterium, CN, CF₃, F, C₁-C₅-alkyl, SiMe₃, SiPh₃ or C₆-C₁₈-aryl substituents;
C₃-C₁₇-heteroaryl,
   wherein optionally one or more hydrogen atoms are independently substituted by deuterium, CN, CF₃, F, C₁-C₅-alkyl, SiMe₃, SiPh₃ or C₆-C₁₈-aryl substituents;
N(C₆-C₁₈-aryl)₂,
N(C₃-C₁₇-heteroaryl)₂; and
N(C₃-C₁₇-heteroaryl)(C₆-C₁₈-aryl);
wherein in case, one of Y^{a} and Y^{b} is or both of of Y^{a} and Y^{b} are NR^{DABNA-3}, C(R^{DABNA-3})₂, Si(R^{DABNA-3})₂, or BR^{DABNA-3} the one or the two substituents R^{DABNA-3} may optionally and independently of each other bond to one or both of the adjacent rings A' and B' (for Y^{a} = NR^{DABNA-3}, C(R^{DABNA-3})₂, Si(R^{DABNA-3})₂, or BR^{DABNA-3}) or A' and C' (for Y^{b} = NR^{DABNA-3}, C(R^{DABNA-3})₂, Si(R^{DABNA-3})₂, or BR^{DABNA-3}) via a direct (single) bond or via a connecting atom or atom group being in each case independently selected from NR^{DABNA-1}, O, S, C(R^{DABNA-1})₂, Si(R^{DABNA-1})₂, BR^{DABNA-1}, and Se;
and wherein optionally, two or more, preferably two, structures of formula DABNA-I are conjugated with each other, preferably fused to each other by sharing at least one, more preferably exactly one, bond;
wherein optionally two or more, preferably two, structures of formula DABNA-I are present in the emitter and share at least one, preferably exactly one, aromatic or heteroaromatic ring (i.e. this ring may be part of both structures of formula DABNA-I) which preferably is any of the rings A', B', and C' of formula DABNA-I, but may also be any aromatic or heteroaromatic substituent selected from R^{DABNA-1}, R^{DABNA-2}, R^{DABNA-3}, R^{DABNA-4}, R^{DABNA-5}, and R^{DABNA-6}, in particular R^{DABNA-3}, or any aromatic or heteroaromatic ring formed by two or more adjacent substituents as stated above, wherein the shared ring may constitute the same or different moieties of the two or more structures of formula DABNA-I that share the ring (i.e. the shared ring may for example be ring C' of both structures of formula DABNA-I optionally comprised in the emitter or the shared ring may for example be ring B' of one and ring C' of the other structure of formula DABNA-I optionally comprised in the emitter); and
wherein optionally at least one of R^{DABNA-1}, R^{DABNA-2}, R^{DABNA-3}, R^{DABNA-4}, R^{DABNA-5} and R^{DABNA-6} is replaced by a bond to a further chemical entity of formula DABNA-I and/or wherein optionally at least one hydrogen atom of any of R^{DABNA-1}, R^{DABNA-2}, R^{DABNA-3}, R^{DABNA-4}, R^{DABNA-5}, and R^{DABNA-6} is replaced by a bond to a further chemical entity of formula DABNA-I.

In one embodiment of the invention, in at least one, preferably each, light-emitting layer B, at least one of the one or more small FWHM emitters S^{B} comprises a structure according to formula DABNA-I.

In one embodiment of the invention, in at least one, preferably each, light-emitting layer B, each small FWHM emitter S^{B} comprises a structure according to formula DABNA-I.

In one embodiment of the invention, in at least one, preferably each, light-emitting layer B, at least one of the one or more small FWHM emitters S^{B} consists of a structure according to formula DABNA-I.

In one embodiment of the invention, in at least one, preferably each, light-emitting layer B, each small FWHM emitter S^{B} consists of a structure according to formula DABNA-I.

In a preferred embodiment of the invention, in which in at least one, preferably each, light-emitting layer B, at least one, preferably each, of the one or more small FWHM emitters S^{B} comprises or consists of a structure according to formula DABNA-I, A', B', and C' are all aromatic rings with 6 ring atoms each (i.e. they are all benzene rings).

In one embodiment of the invention, in which in at least one, preferably each, light-emitting layer B, at least one, preferably each, of the one or more small FWHM emitters S^{B} comprises or consists of a structure according to formula DABNA-I, Y^{a} and Y^{b} are independently of each other selected from NR^{DABNA-3}, O, S, C(R^{DABNA-3})₂, and Si(R^{DABNA-3})₂.

In a preferred embodiment of the invention, in which in at least one, preferably each, light-emitting layer B, at least one, preferably each, of the one or more small FWHM emitters S^{B} comprises or consists of a structure according to formula DABNA-I, Y^{a} and Y^{b} are independently of each other selected from NR^{DABNA-3}, O, and S.

In an even more preferred embodiment of the invention, in which in at least one, preferably each, light-emitting layer B, at least one, preferably each, of the one or more small FWHM emitters S^{B} comprises or consists of a structure according to formula DABNA-I, Y^{a} and Y^{b} are independently of each other selected from NR^{DABNA-3}, and O.

In a particularly preferred embodiment of the invention, in which in at least one, preferably each, light-emitting layer B, at least one, preferably each, of the one or more small FWHM emitters S^{B} comprises or consists of a structure according to formula DABNA-I, Y^{a} and Y^{b} are both NR^{DABNA-3}.

In a particularly preferred embodiment of the invention, in which in at least one, preferably each, light-emitting layer B, at least one, preferably each, of the one or more small FWHM emitters S^{B} comprises or consists of a structure according to formula DABNA-I, Y^{a} and Y^{b} are identical and are both NR^{DABNA-3}.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-1}, is at each occurrence independently of each other selected from the group consisting of: hydrogen, deuterium, N(R^{DABNA-2})₂, OR^{DABNA-2}, SR^{DABNA-2}, Si(R^{DABNA-2})₃, CF₃, CN, F,
C₁-C₅-alkyl,
   which is optionally substituted with one or more substituents R^{DABNA-2};
C₁-C₅-alkoxy,
   which is optionally substituted with one or more substituents R^{DABNA-2};
C₁-C₅-thioalkoxy,
   which is optionally substituted with one or more substituents R^{DABNA-2};
C₆-C₁₈-aryl,
   which is optionally substituted with one or more substituents R^{DABNA-2};
C₃-C₁₇-heteroaryl,
   which is optionally substituted with one or more substituents R^{DABNA-2};
R^{DABNA-2} is at each occurrence independently of each other selected from the group consisting of: hydrogen, deuterium, N(R^{DABNA-6})₂, OR^{DABNA-6}, SR^{DABNA-6}, Si(R^{DABNA-6})₃, CF₃, CN, F,
C₁-C₅-alkyl,
   which is optionally substituted with one or more substituents R^{DABNA-6};
C₆-C₁₈-aryl,
   which is optionally substituted with one or more substituents R^{DABNA-6};
C₃-C₁₇-heteroaryl,
   which is optionally substituted with one or more substituents R^{DABNA-6};
wherein two or more adjacent substituents selected from R^{DABNA-1} and R^{DABNA-2} optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-1}, is at each occurrence independently of each other selected from the group consisting of: hydrogen, deuterium, N(R^{DABNA-2})₂, OR^{DABNA-2}, SR^{DABNA-2}, Si(R^{DABNA-2})₃,
C₁-C₅-alkyl,
   which is optionally substituted with one or more substituents R^{DABNA-2};
C₆-C₁₈-aryl,
   which is optionally substituted with one or more substituents R^{DABNA-2};
C₃-C₁₇-heteroaryl,
   which is optionally substituted with one or more substituents R^{DABNA-2};
R^{DABNA-2} is at each occurrence independently of each other selected from the group consisting of: hydrogen, deuterium, N(R^{DABNA-6})₂, OR^{DABNA-6}, SR^{DABNA-6}, Si(R^{DABNA-6})₃, CF₃, CN, F,
C₁-C₅-alkyl,
   which is optionally substituted with one or more substituents R^{DABNA-6};
C₆-C₁₈-aryl,
   which is optionally substituted with one or more substituents R^{DABNA-6};
C₃-C₁₇-heteroaryl,
   which is optionally substituted with one or more substituents R^{DABNA-6};
wherein two or more adjacent substituents selected from R^{DABNA-1} and R^{DABNA-2} optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-1}, is at each occurrence independently of each other selected from the group consisting of: hydrogen, deuterium, N(R^{DABNA-2})₂, OR^{DABNA-2}, SR^{DABNA-2},
C₁-C₅-alkyl,
   which is optionally substituted with one or more substituents R^{DABNA-2};
C₆-C₁₈-aryl,
   which is optionally substituted with one or more substituents R^{DABNA-2};
C₃-C₁₇-heteroaryl,
   which is optionally substituted with one or more substituents R^{DABNA-2};
R^{DABNA-2} is at each occurrence independently of each other selected from the group consisting of: hydrogen, deuterium, N(Ph)₂, OPh, CN, Me, ⁱPr, ^{t}Bu, Si(Me)₃,
Ph,
   which is optionally substituted with one or more substituents R^{DABNA-6};
C₃-C₁₇-heteroaryl,
   which is optionally substituted with one or more substituents R^{DABNA-6};
wherein two or more adjacent R^{DABNA-1} form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-1}, is at each occurrence independently of each other selected from the group consisting of: hydrogen, deuterium, N(Ph)₂, OPh, Me, ⁱPr, ^{t}Bu, Si(Me)₃,
Ph,
   wherein one or more hydrogen atoms are optionally, independently from each other substituted by deuterium, Me, ⁱPr, ^{t}Bu, Ph, or CN;
C₃-C₁₇-heteroaryl,
   wherein one or more hydrogen atoms are optionally, independently from each other substituted by deuterium, Me, ⁱPr, ^{t}Bu, Ph, or CN;
wherein two or more adjacent substituents R^{DABNA-1} optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-1}, is at each occurrence independently of each other selected from the group consisting of: hydrogen, deuterium, N(Ph)₂, Me, ⁱPr, ^{t}Bu,
Ph,
   wherein one or more hydrogen atoms are optionally, independently from each other substituted by deuterium, Me, ⁱPr, ^{t}Bu, Ph or CN;
carbazolyl,
   wherein one or more hydrogen atoms are optionally, independently from each other substituted by deuterium, Me, ⁱPr, ^{t}Bu, Ph or CN;
triazinyl,
   wherein one or more hydrogen atoms are optionally, independently from each other substituted by deuterium, Me, ⁱPr, ^{t}Bu, or Ph;
pyrimidinyl,
   wherein one or more hydrogen atoms are optionally, independently from each other substituted by deuterium, Me, ⁱPr, ^{t}Bu, or Ph;
pyridinyl,
   wherein one or more hydrogen atoms are optionally, independently from each other substituted by deuterium, Me, ⁱPr, ^{t}Bu, or Ph;
wherein two or more adjacent substituents R^{DABNA-1} optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters S^{B} comprises or consists of a structure according to formula DABNA-I, adjacent substituents selected from R^{DABNA-1} and R^{DABNA-2} do not form a mono- or polycyclic, aliphatic or aromatic or heteroaromatic, carbocyclic or heterocyclic ring system which is fused to the adjacent ring A', B' or C'.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-3} is at each occurrence independently of each other selected from the group consisting of: hydrogen, deuterium,
C₁-C₄-alkyl,
   which is optionally substituted with one or more substituents R^{DABNA-4};
C₆-C₁₈-aryl,
   which is optionally substituted with one or more substituents R^{DABNA-4};
C₃-C₁₇-heteroaryl,
   which is optionally substituted with one or more substituents R^{DABNA-4};
R^{DABNA-4} is at each occurrence independently of each other selected from the group consisting of: hydrogen, deuterium, N(R^{DABNA-5})₂, OR^{DABNA-5}, SR^{DABNA-5}, Si(C₁-C₅-alkyl)₃, CF₃, CN, F,
C₁-C₅-alkyl,
   which is optionally substituted with one or more substituents R^{DABNA-5};
C₆-C₁₈-aryl,
   which is optionally substituted with one or more substituents R^{DABNA-5};
C₃-C₁₇-heteroaryl,
   which is optionally substituted with one or more substituents R^{DABNA-5};
R^{DABNA-5} is at each occurrence independently of each other selected from the group consisting of: hydrogen, deuterium, N(Ph)₂, OPh, Si(Me)₃, CF₃, CN, F,
C₁-C₅-alkyl,
   wherein one or more hydrogen atoms are optionally, independently from each other substituted by deuterium;
C₆-C₁₈-aryl,
   wherein one or more hydrogen atoms are optionally, independently from each other substituted by deuterium, Me, ⁱPr, ^{t}Bu, Ph, or CN;
C₃-C₁₇-heteroaryl,
   wherein one or more hydrogen atoms are optionally, independently from each other substituted by deuterium, Me, ⁱPr, ^{t}Bu, Ph, or CN;
wherein two or more adjacent substituents selected from R^{DABNA-3}, R^{DABNA-4}, and R^{DABNA-5} optionally form a mono- or polycyclic, aliphatic or aromatic or heteroaromatic, carbocyclic or heterocyclic ring system with each other, wherein the optionally so formed ring system comprises in total 8 to 30 ring atoms.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-3} is at each occurrence independently of each other selected from the group consisting of: hydrogen, deuterium,
C₁-C₄-alkyl,
   which is optionally substituted with one or more substituents R^{DABNA-4};
C₆-C₁₈-aryl,
   which is optionally substituted with one or more substituents R^{DABNA-4};
C₃-C₁₇-heteroaryl,
   which is optionally substituted with one or more substituents R^{DABNA-4};
R^{DABNA-4} is at each occurrence independently of each other selected from the group consisting of: hydrogen, deuterium, N(Ph)₂, OPh, Si(Me)₃, CF₃, CN, F,
C₁-C₅-alkyl,
   wherein one or more hydrogen atoms are optionally, independently from each other substituted by deuterium;
C₆-C₁₈-aryl,
   wherein one or more hydrogen atoms are optionally, independently from each other substituted by deuterium, Me, ⁱPr, ^{t}Bu, Ph, or CN;
C₃-C₁₇-heteroaryl,
   wherein one or more hydrogen atoms are optionally, independently from each other substituted by deuterium, Me, ⁱPr, ^{t}Bu, Ph, or CN;
wherein two or more adjacent substituents selected from R^{DABNA-3} and R^{DABNA-4} do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-3} is at each occurrence independently of each other selected from the group consisting of: hydrogen, deuterium,
C₁-C₄-alkyl,
   which is optionally substituted with one or more substituents R^{DABNA-4};
C₆-C₁₈-aryl,
   which is optionally substituted with one or more substituents R^{DABNA-4};
C₃-C₁₇-heteroaryl,
   which is optionally substituted with one or more substituents R^{DABNA-4};
R^{DABNA-4} is at each occurrence independently of each other selected from the group consisting of: hydrogen, deuterium, CN, F,
C₁-C₅-alkyl,
   wherein one or more hydrogen atoms are optionally, independently from each other substituted by deuterium;
C₆-C₁₈-aryl,
   wherein one or more hydrogen atoms are optionally, independently from each other substituted by deuterium, Me, ⁱPr, ^{t}Bu, Ph, or CN;
C₃-C₁₇-heteroaryl,
   wherein one or more hydrogen atoms are optionally, independently from each other substituted by deuterium, Me, ⁱPr, ^{t}Bu, Ph, or CN;
wherein two or more adjacent substituents selected from R^{DABNA-3} and R^{DABNA-4} do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-3} is at each occurrence independently of each other selected from the group consisting of: hydrogen, deuterium, Me, ⁱPr, ^{t}Bu,
C₆-C₁₈-aryl,
   wherein one or more hydrogen atoms are optionally, independently from each other substituted by deuterium, Me, ⁱPr, ^{t}Bu, Ph, or CN;
wherein two or more adjacent substituents selected from R^{DABNA-3} do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-3} is at each occurrence independently of each other selected from the group consisting of: hydrogen, deuterium, Me, ⁱPr, ^{t}Bu, and
Ph,
wherein one or more hydrogen atoms are optionally, independently from each other substituted by deuterium, Me, ⁱPr, ^{t}Bu, Ph, or CN;
wherein two or more adjacent substituents selected from R^{DABNA-3} do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-6} is at each occurrence independently of each other selected from the group consisting of: hydrogen, deuterium, OPh (Ph = phenyl), SPh, CF₃, CN, F, Si(C₁-C₅-alkyl)₃, Si(Ph)₃,
C₁-C₅-alkyl,
   wherein optionally one or more hydrogen atoms are independently substituted by deuterium, Ph, CN, CF₃, or F;
C₆-C₁₈-aryl,
   wherein optionally one or more hydrogen atoms are independently substituted by deuterium, CN, CF₃, F, C₁-C₅-alkyl, SiMe₃, SiPh₃ or C₆-C₁₈-aryl substituents;
C₃-C₁₇-heteroaryl,
   wherein optionally one or more hydrogen atoms are independently substituted by deuterium, CN, CF₃, F, C₁-C₅-alkyl, SiMe₃, SiPh₃ or C₆-C₁₈-aryl substituents;
N(C₆-C₁₈-aryl)₂,
N(C₃-C₁₇-heteroaryl)₂; and
N(C₃-C₁₇-heteroaryl)(C₆-C₁₈-aryl).

In one embodiment of the invention, in which in at least one, preferably each, light-emitting layer B, at least one, preferably each, of the one or more small FWHM emitters S^{B} comprises or consists of a structure according to formula DABNA-I, R^{DABNA-6} is at each occurrence independently of each other selected from the group consisting of: hydrogen, deuterium, N(Ph)₂, OPh (Ph = phenyl), SPh, CF₃, CN, F, Si(Me)₃, Si(Ph)₃,
C₁-C₅-alkyl,
   wherein optionally one or more hydrogen atoms are independently substituted by deuterium, Ph, CN, CF₃, or F;
C₆-C₁₈-aryl,
   wherein optionally one or more hydrogen atoms are independently substituted by deuterium, CN, CF₃, F, Me, ⁱPr, ^{t}Bu, SiMe₃, SiPh₃ or Ph;
C₃-C₁₇-heteroaryl,
   wherein optionally one or more hydrogen atoms are independently substituted by deuterium, CN, CF₃, F, , Me, ⁱPr, ^{t}Bu, SiMe₃, SiPh₃ or Ph.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-6} is at each occurrence independently of each other selected from the group consisting of: hydrogen, deuterium, N(Ph)₂, CN, F, Me, ⁱPr, ^{t}Bu,
Ph,
   wherein optionally one or more hydrogen atoms are independently substituted by deuterium, CN, Me, ⁱPr, ^{t}Bu, or Ph;
C₃-C₁₇-heteroaryl,
   wherein optionally one or more hydrogen atoms are independently substituted by deuterium, CN, Me, ⁱPr, ^{t}Bu, or Ph.

In one embodiment of the invention, in which in at least one, preferably each, light-emitting layer B, at least one, preferably each, of the one or more small FWHM emitters S^{B} comprises or consists of a structure according to formula DABNA-I,
R^{DABNA-6} is at each occurrence independently of each other selected from the group consisting of: hydrogen, deuterium, Me, ⁱPr, ^{t}Bu,
Ph,
   wherein optionally one or more hydrogen atoms are independently substituted by deuterium, Me, ⁱPr, ^{t}Bu, or Ph.

In one embodiment of the invention, in which in at least one, preferably each, light-emitting layer B, at least one, preferably each, of the one or more small FWHM emitters S^{B} comprises or consists of a structure according to formula DABNA-I, when Y^{a} and/or Y^{b} is/are NR^{DABNA-3}, C(R^{DABNA-3})₂, Si(R^{DABNA-3})₂, or BR^{DABNA-3}, the one or the two substituents R^{DABNA-3} do not bond to one or both of the adjacent rings A' and B' (for Y^{a} = NR^{DABNA-3}, C(R^{DABNA-3})₂, Si(R^{DABNA-3})₂, or BR^{DABNA-3}) or A' and C' (for Y^{b} = NR^{DABNA-3}, C(R^{DABNA-3})₂, Si(R^{DABNA-3})₂, or BR^{DABNA-3}).

In one embodiment, small FWHM emitters S^{B} in the context of the present invention may optionally also be multimers (e.g. dimers) of the aforementioned formula DABNA-I, which means that their structure comprises more than one subunits, each of which has a structure according to formula DABNA-I. In this case, the skilled artisan will understand that the two or more subunits according to formula DABNA-I may for example be conjugated, preferably fused to each other (i.e. sharing at least one bond, wherein the respective substituents attached to the atoms forming that bond may no longer be present). The two or more subunits may also share at least one, preferably exactly one, aromatic or heteroaromatic ring. This means that, for example, a small FWHM emitter S^{B} may comprise two or more subunits each having a structure of formula DABNA-I, wherein these two subunits share one aromatic or heteroaromatic ring (i.e. the respective ring is part of both subunits). As a result, the respective multimeric (e.g., dimeric) emitter S^{B} may not contain two whole subunits according to formula DABNA-I as the shared ring is only present once. Nevertheless, the skilled artisan will understand that herein, such an emitter is still considered a multimer (for example a dimer if two subunits having a structure of formula DABNA-I are comprised) of formula DABNA-I. The same holds true for multimers sharing more than one ring. It is preferred that the multimers are dimers comprising two subunits, each having a structure of formula DABNA-I.

In one embodiment of the invention, in at least one, preferably each, light-emitting layer B, at least one, preferably each small FWHM emitter S^{B}, is a dimer of formula DABNA-I as described above, which means that the emitter comprises two subunits, each having a structure according to formula DABNA-I.

In one embodiment of the invention, in at least one, preferably each, light-emitting layer B, at least one, preferably each, of the one or more small FWHM emitters S^{B} comprises or consists of two or more, preferably of exactly two, structures according to formula DABNA-I (i.e. subunits),
wherein these subunits share at least one, preferably exactly one, aromatic or heteroaromatic ring (i.e. this ring may be part of both structures of formula DABNA-I) and wherein the shared ring(s) may be any of the rings A', B', and C' of formula DABNA-I, but may also be any aromatic or heteroaromatic substituent selected from R^{DABNA-1}, R^{DABNA-2}, R^{DABNA-3}, R^{DABNA-4}, R^{DABNA-5}, and R^{DABNA-6}, in particular R^{DABNA-3}, or any aromatic or heteroaromatic ring formed by two or more adjacent substituents as stated above, wherein the shared ring may constitute the same or different moieties of the two or more structures of formula DABNA-I that share the ring (i.e. the shared ring may for example be ring C' of both structures of formula DABNA-I optionally comprised in the emitter or the shared ring may for example be ring B' of one and ring C' of the other structure of formula DABNA-I optionally comprised in the emitter).

In one embodiment of the invention, in at least one, preferably each, light-emitting layer B, at least one, preferably each, of the one or more small FWHM emitters S^{B} comprises or consists of two or more, preferably of exactly two, structures according to formula DABNA-I (i.e. subunits),
wherein at least one of R^{DABNA-1}, R^{DABNA-2}, R^{DABNA-3}, R^{DABNA-4} , R^{DABNA-5}, and R^{DABNA-6} is replaced by a bond to a further chemical entity of formula DABNA-I and/or wherein at least **one** hydrogen atom of any of R^{DABNA-1}, R^{DABNA-2}, R^{DABNA-3}, R^{DABNA-4}, R^{DABNA-5}, and R^{DABNA-6} is replaced by a bond to a further chemical entity of formula DABNA-I.

Non-limiting examples of emitters comprising or consisting of a structure according to formula DABNA-I that may be used as small FWHM emitters S^{B} according to the present invention are listed below.

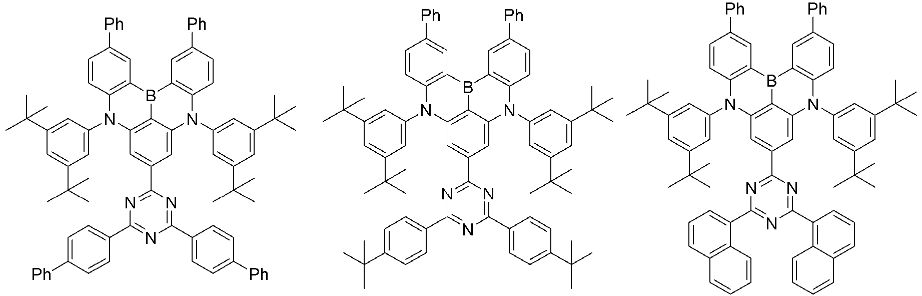

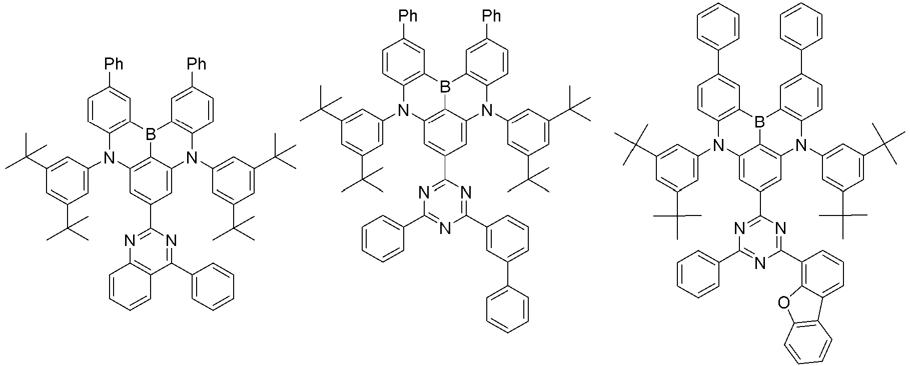

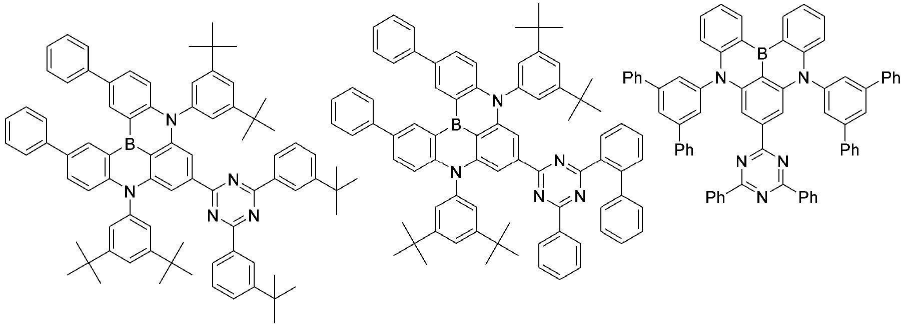

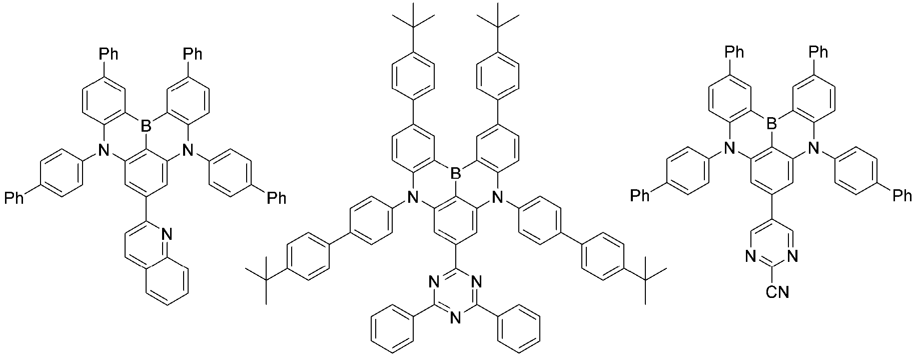

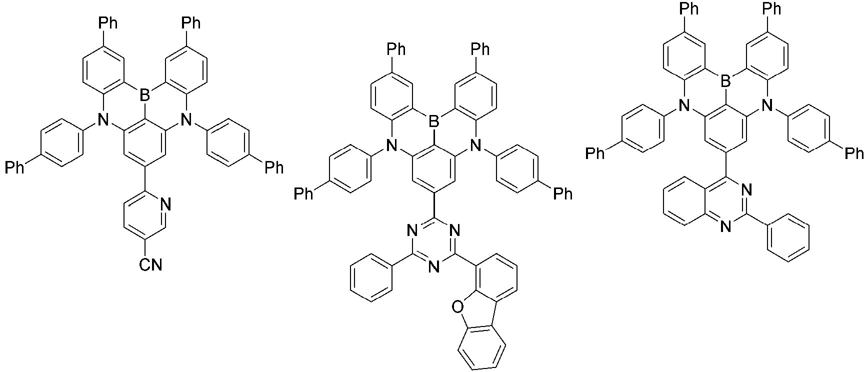

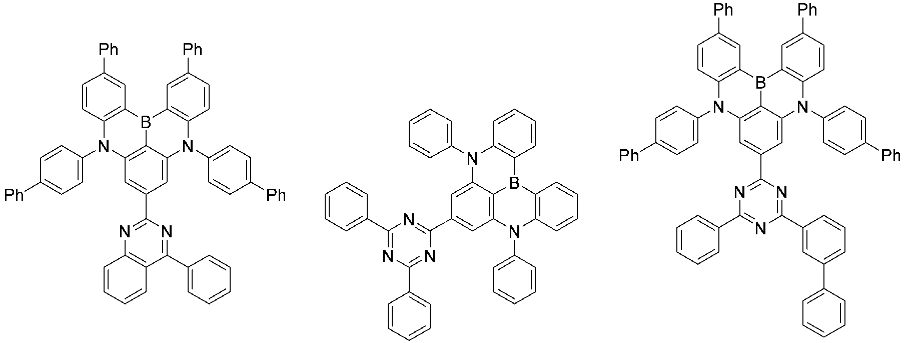

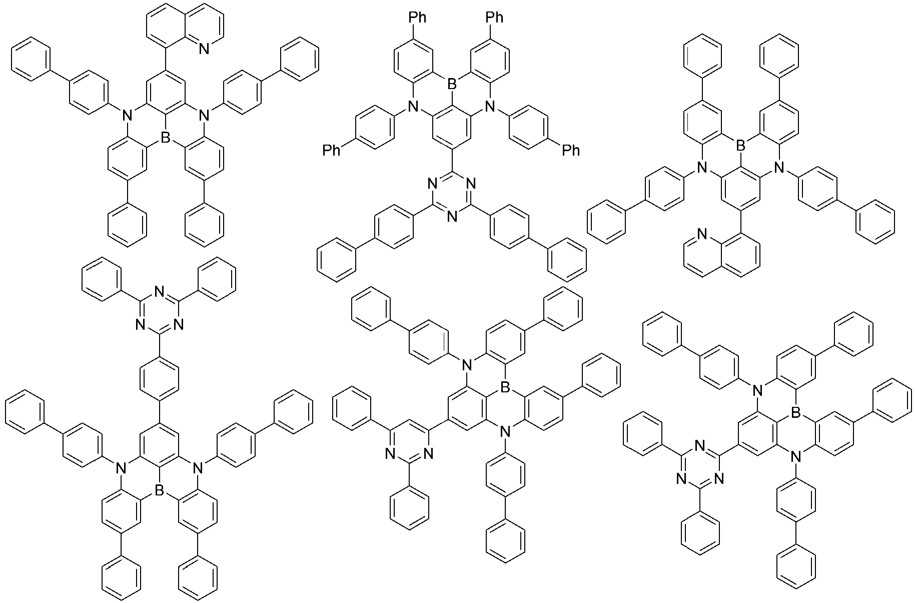

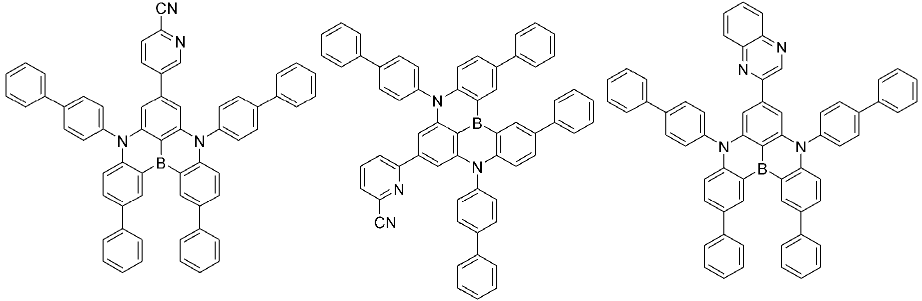

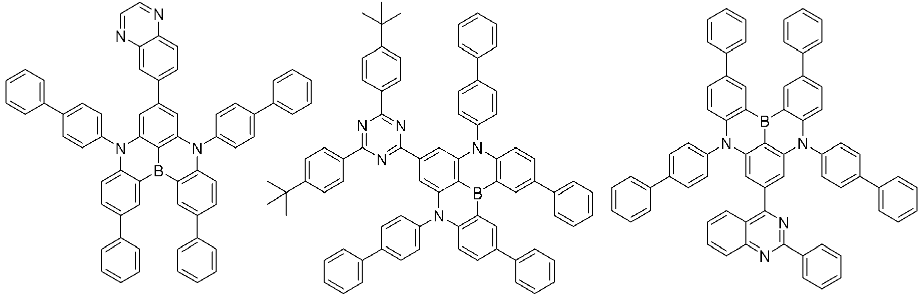

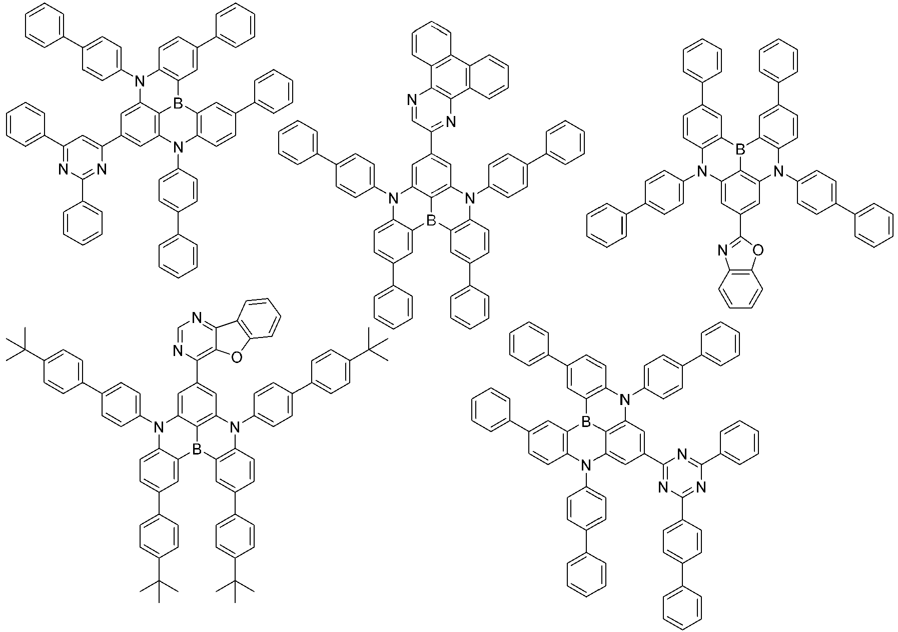

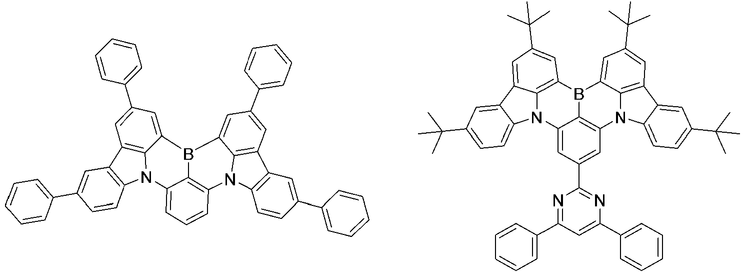

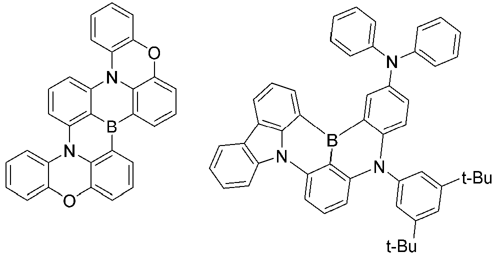

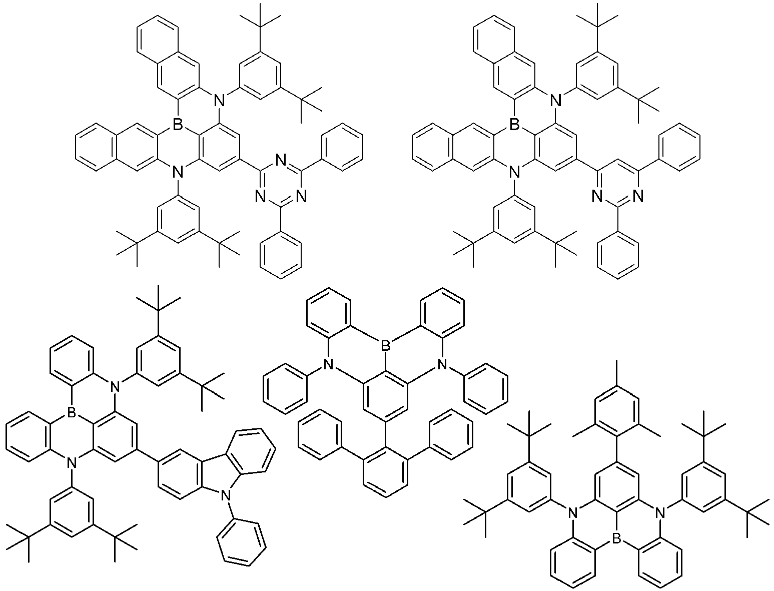

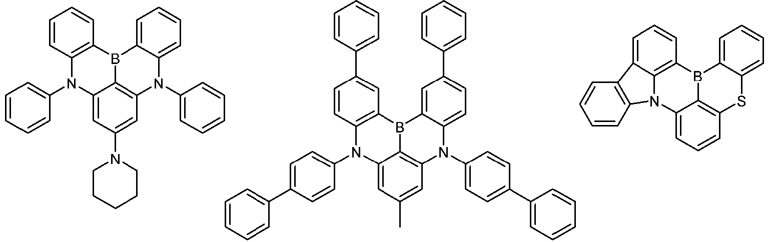

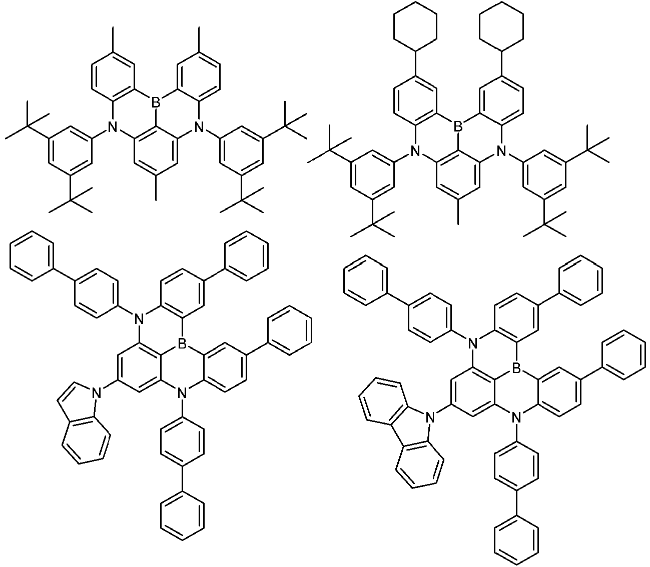

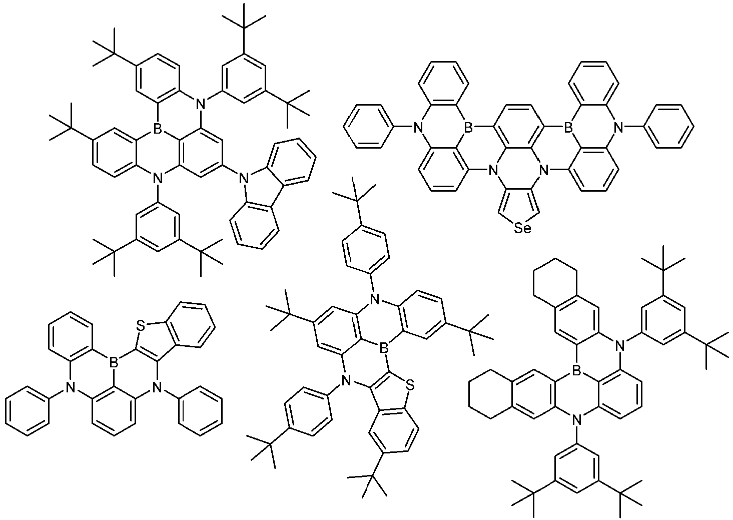

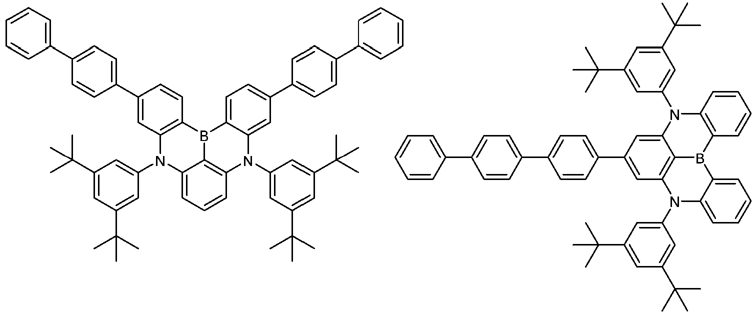

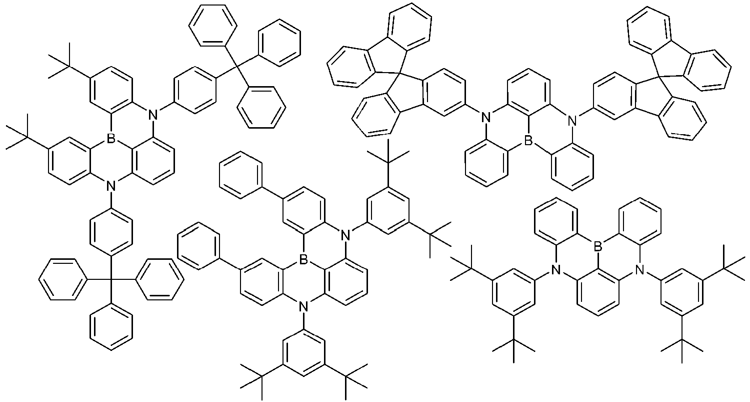

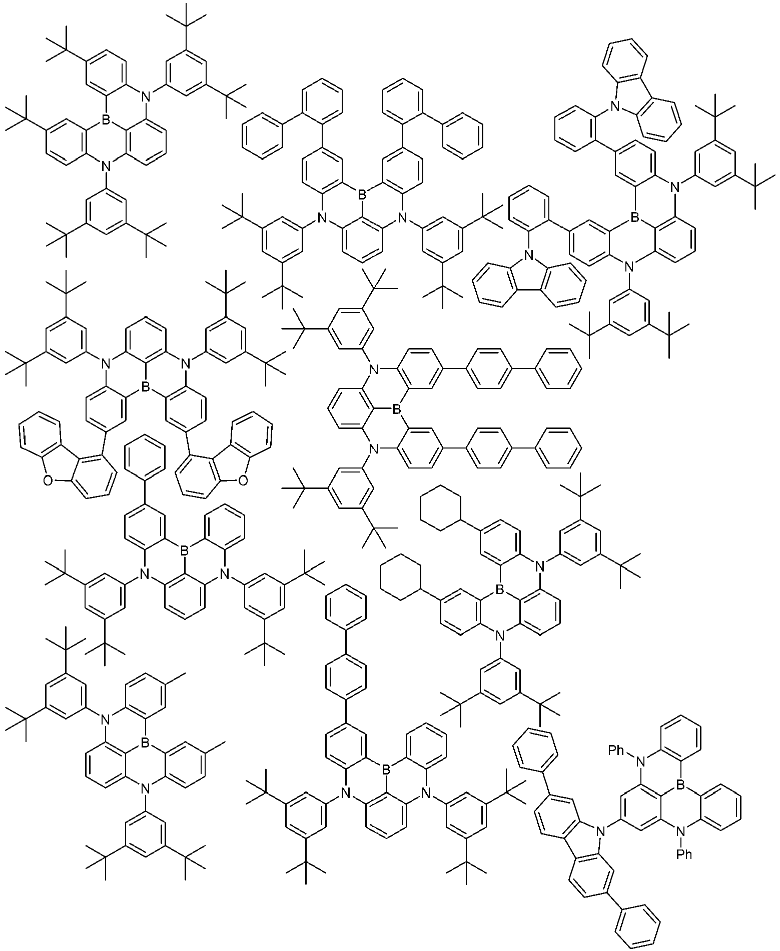

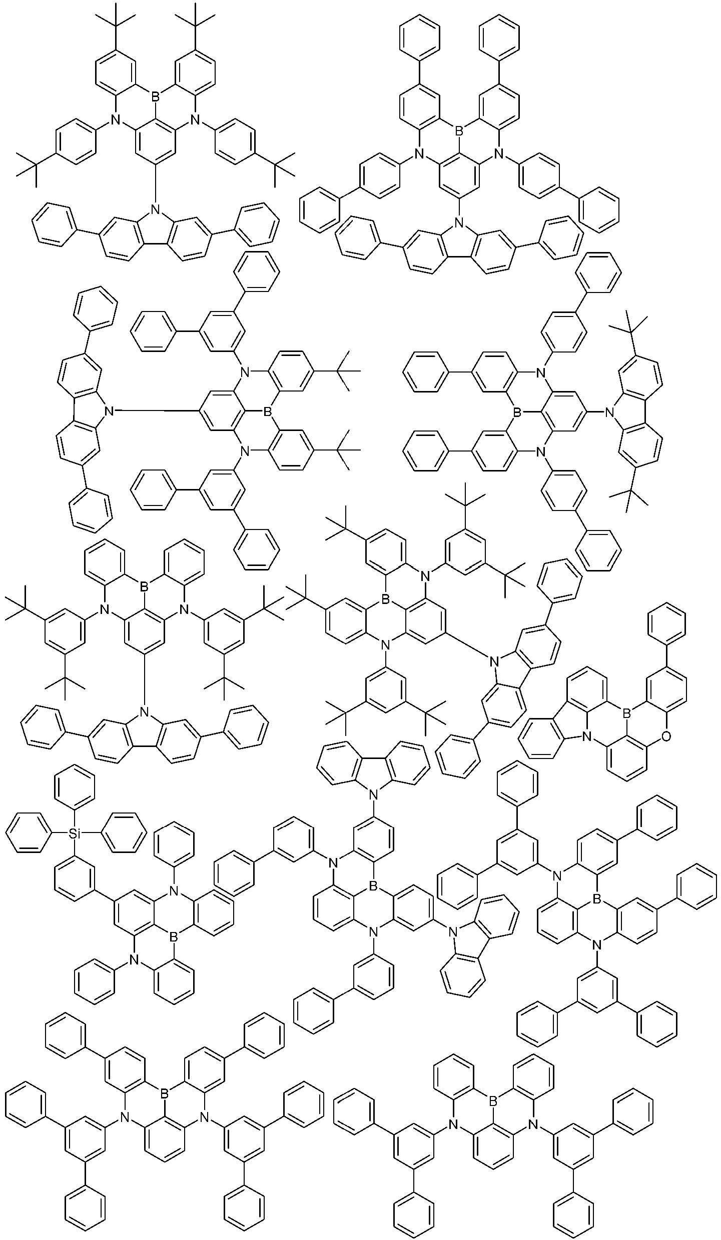

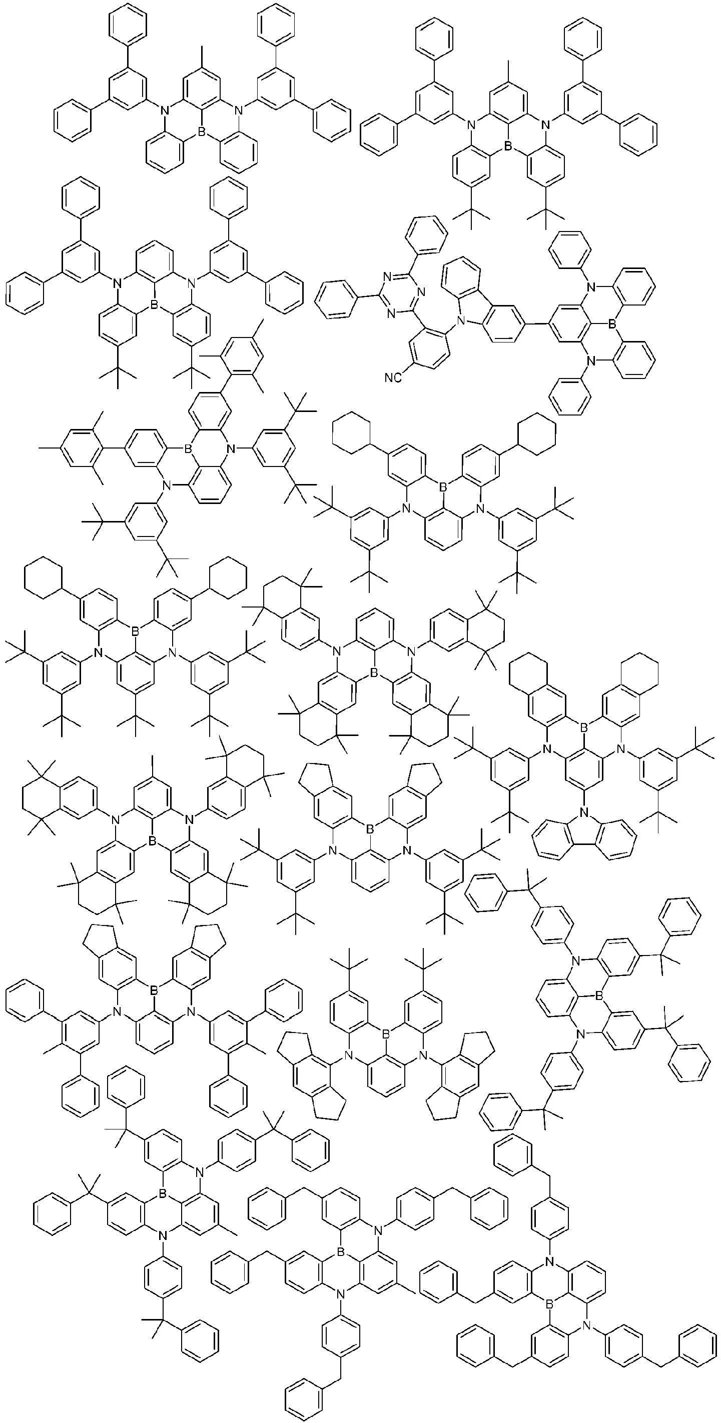

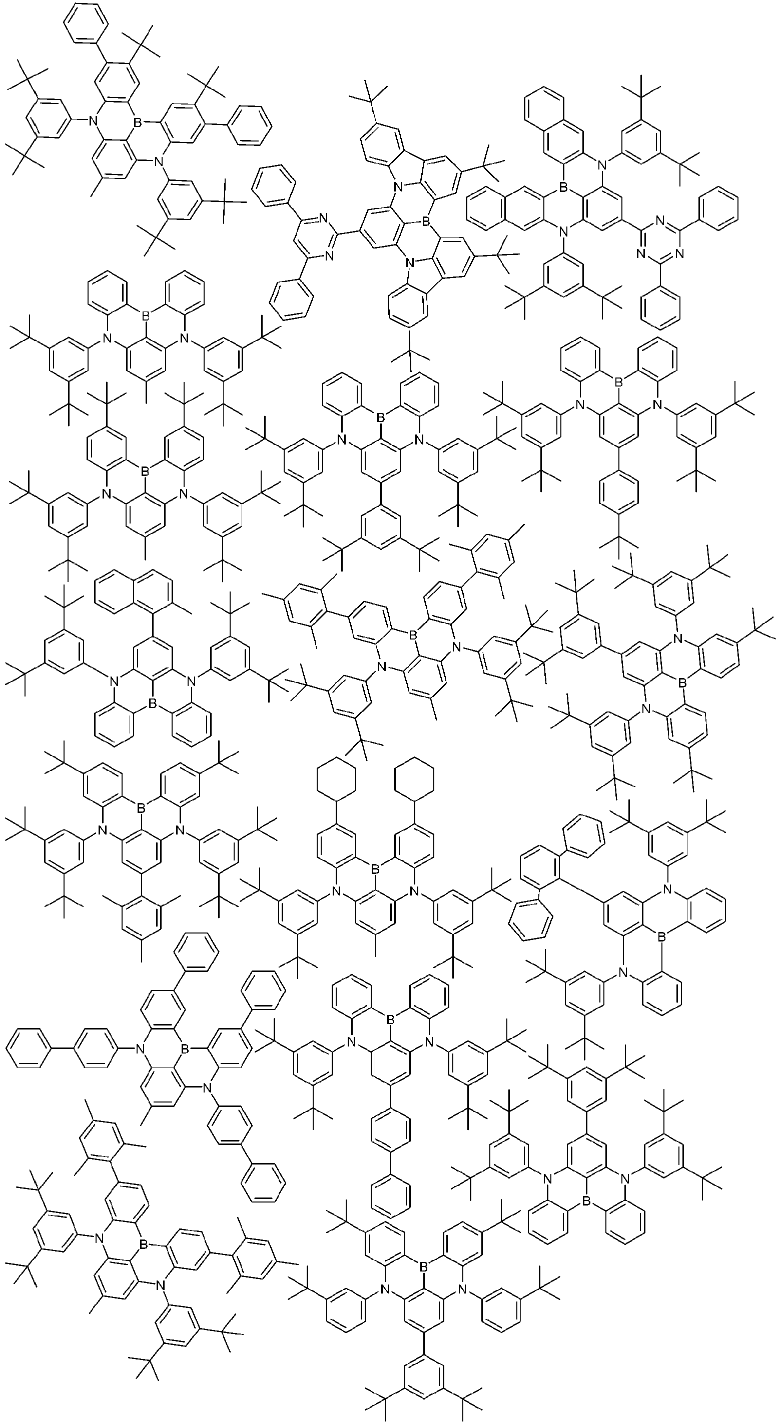

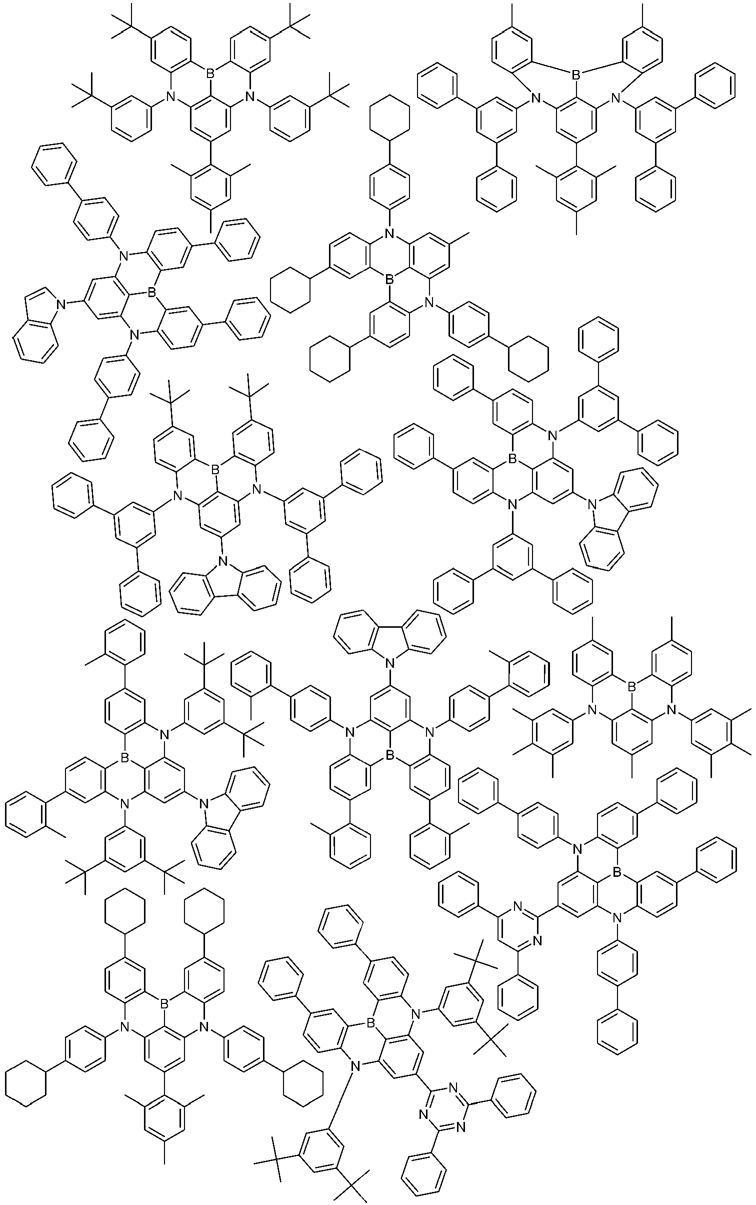

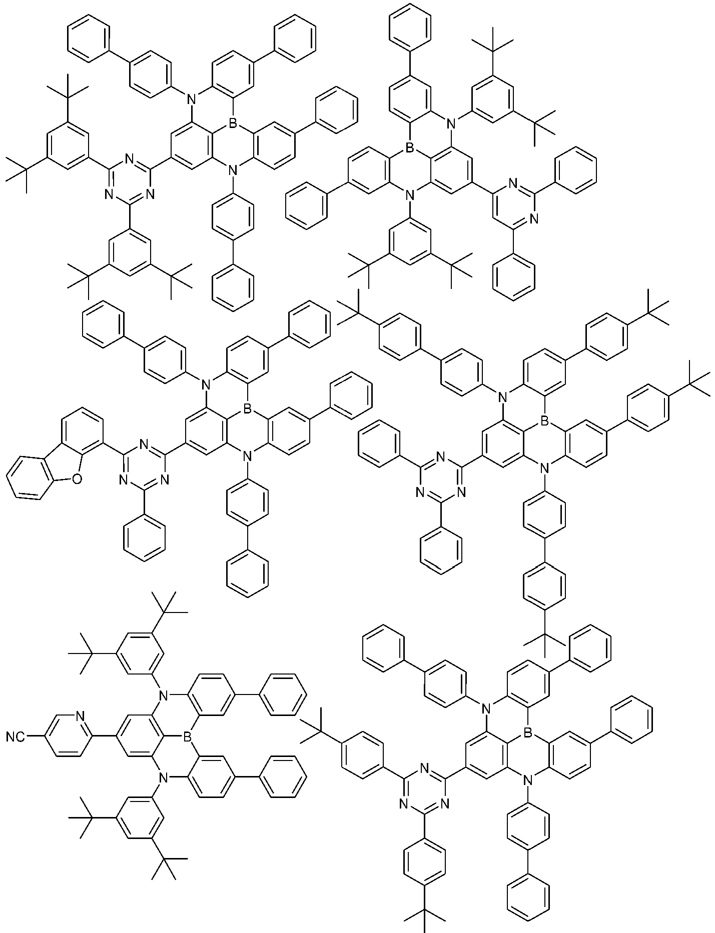

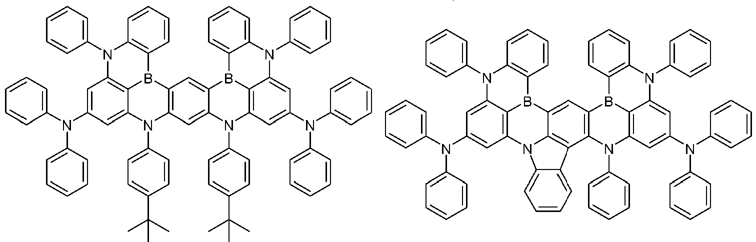

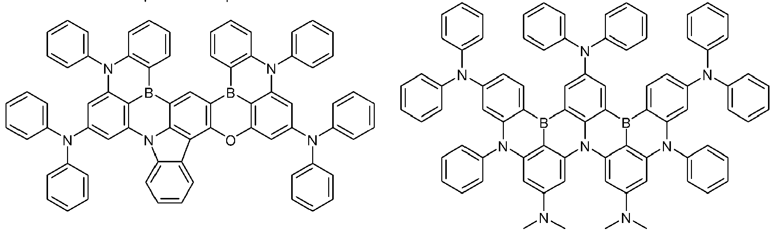

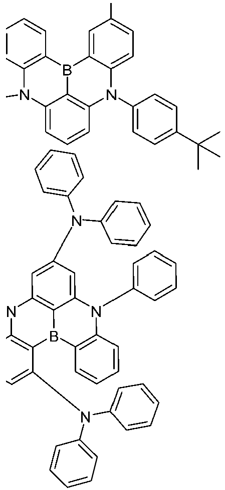

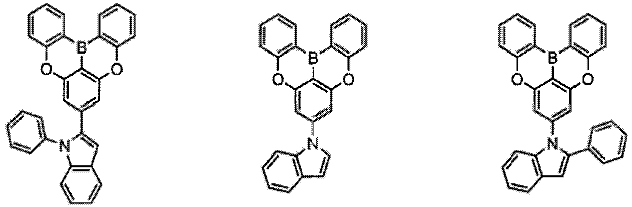

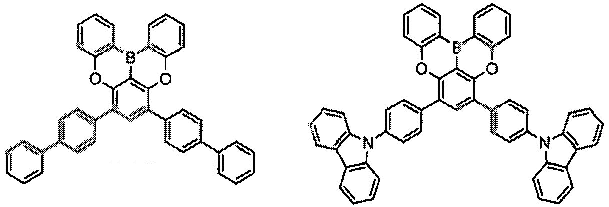

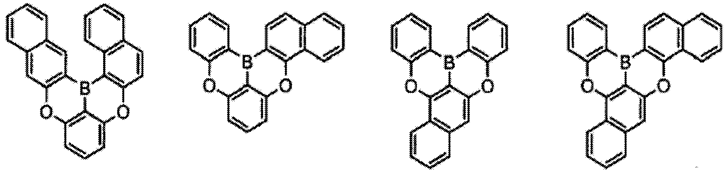

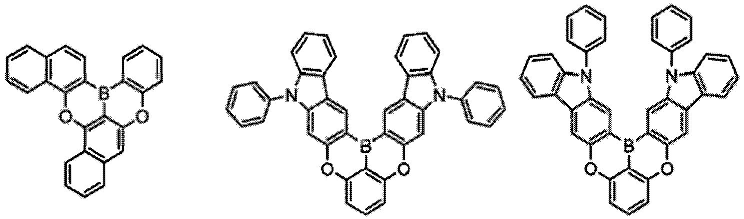

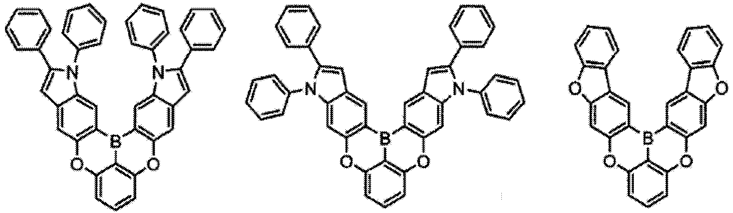

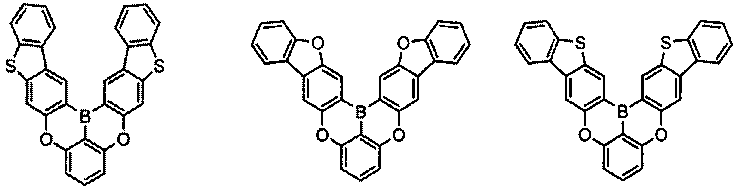

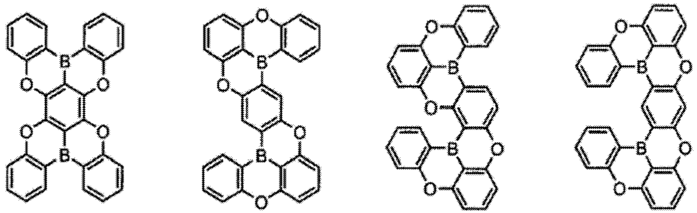

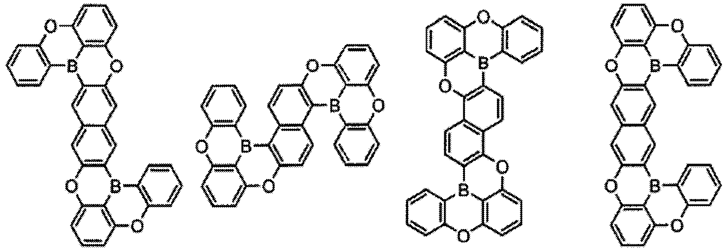

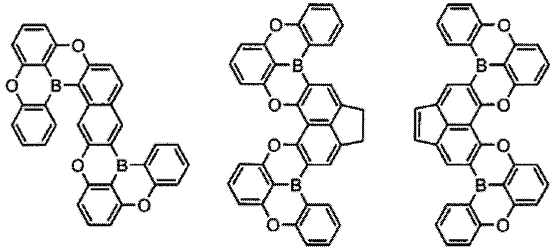

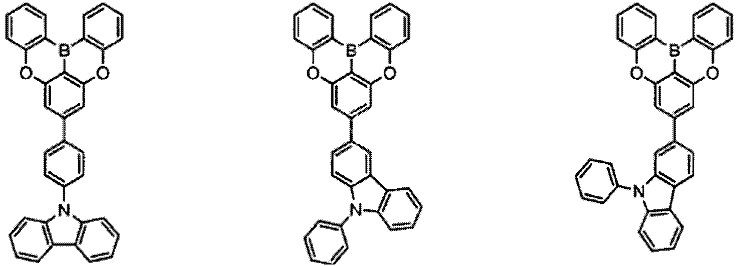

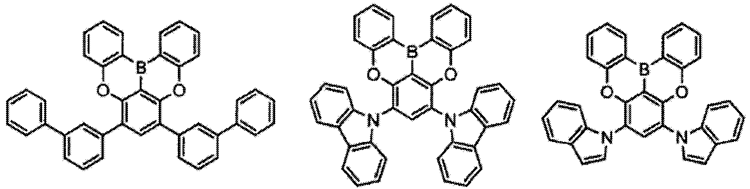

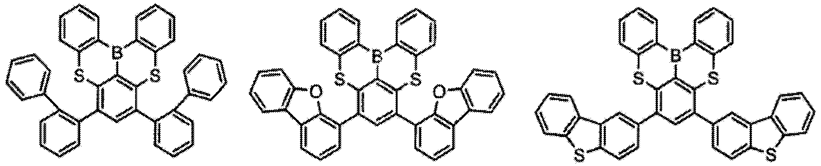

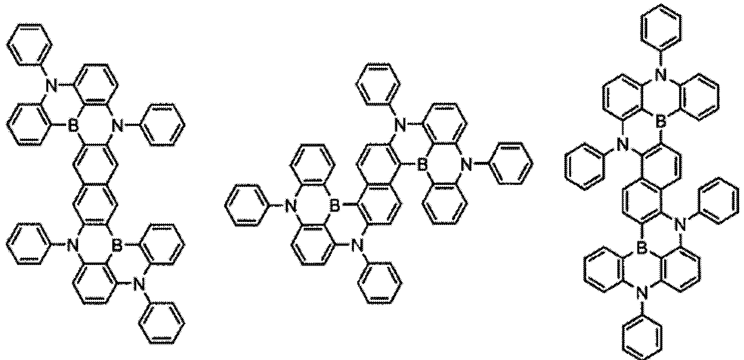

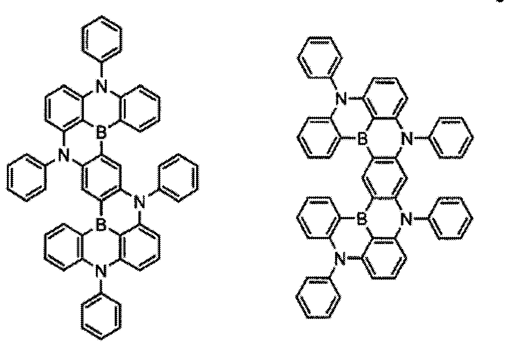

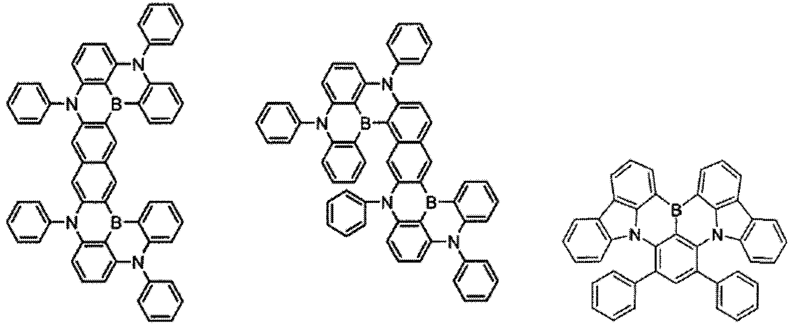

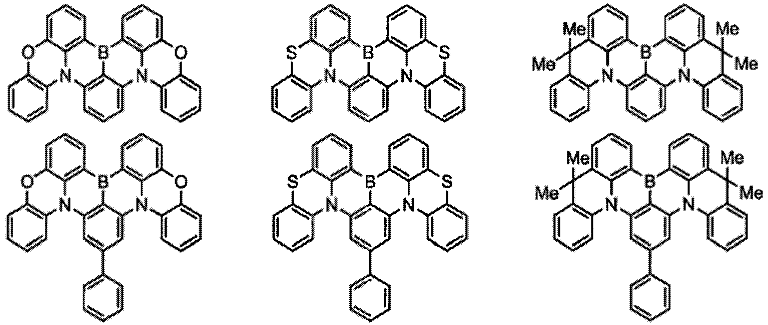

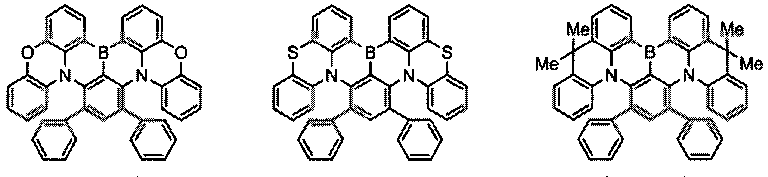

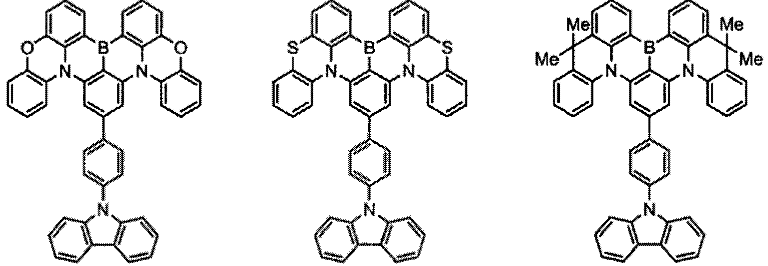

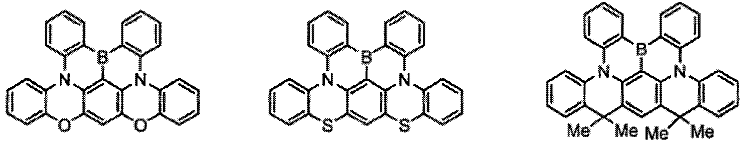

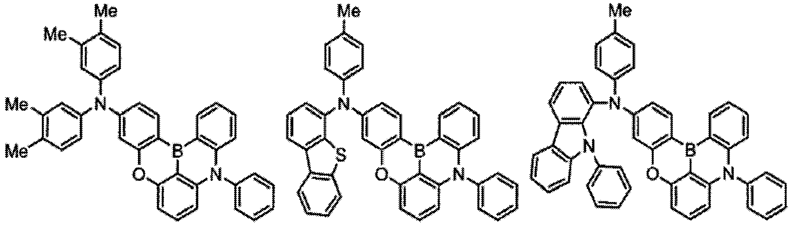

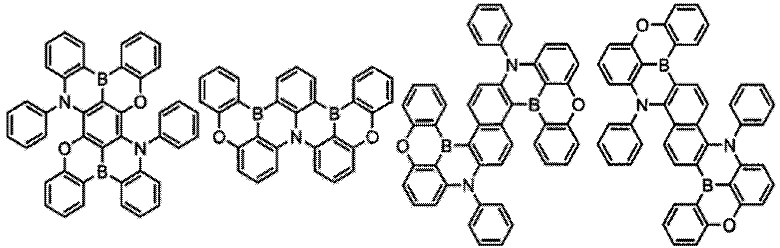

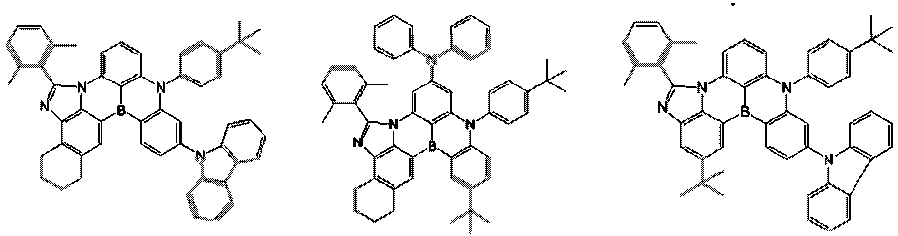

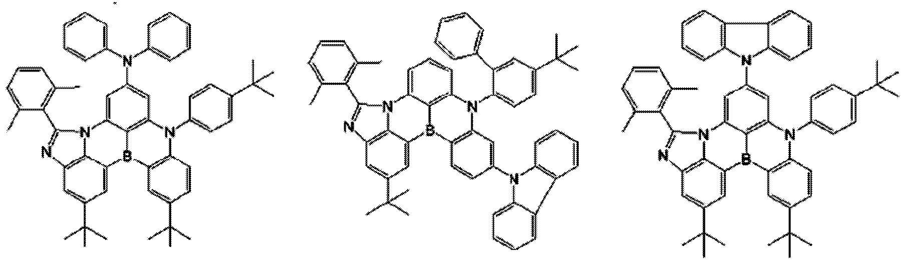

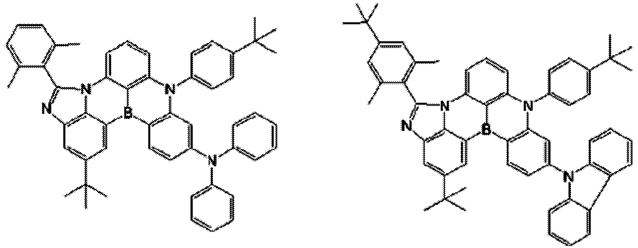

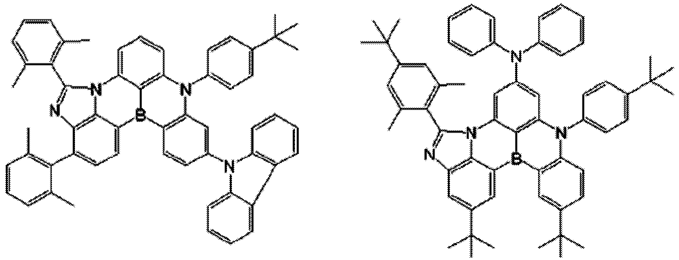

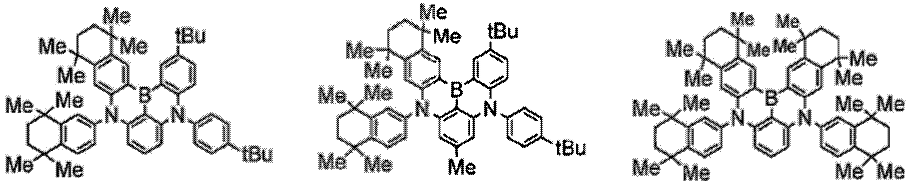

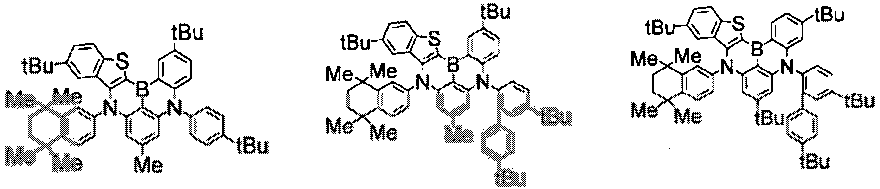

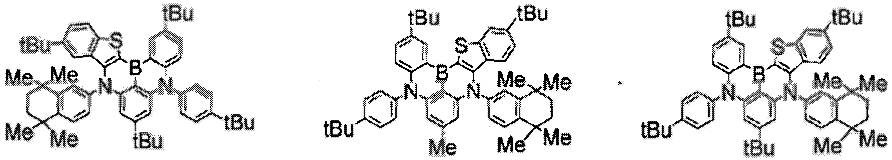

A group of emitters that may be used as small FWHM emitters S^{B} in the context of the present invention are emitters comprising or consisting of a structure according to the following formula BNE-1 or a multimer thereof: 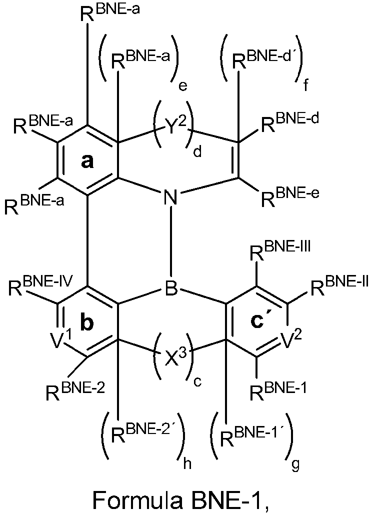 wherein,
c and d are both integers and independently of each other selected from 0 and 1;
e and f are both integers and selected from 0 and 1, wherein e and f are (always) identical (i.e. both 0 or both 1);
g and h are both integers and selected from 0 and 1, wherein g and h are (always) identical (i.e. both 0 or both 1);
if d is 0, e and f are both 1, and if d is 1, e and f are both 0;
if c is 0, g and h are both 1, and if c is 1, g and h are both 0;
V¹ is selected from nitrogen (N) and CR^{BNE-V};
V² is selected from nitrogen (N) and CR^{BNE-I};
X³ is selected from the group consisting of a direct bond, CR^{BNE-3}R ^{BNE-4}, C=CRBNE-3RBNE-⁴, C=O, C=NR^{BNE-3}, NR^{BNE-3}, O, SiR^{BNE-3}R^{BNE-4}, S, S(O) and S(O)2;
Y² is selected from the group consisting of a direct bond, CR^{BNE-3'}R ^{BNE-4'}, C=CR^{BNE-3'}R^{BNE-4'}, C=O, C=NR^{BNE-3'}, NR^{BNE-3'}, O, SiR^{BNE-3'}R^{BNE-4'}, S, S(O) and S(O)₂;
R^{BNE-1}, R^{BNE-2}, R^{BNE-1'}, R^{BNE-2'}, R^{BNE-3}, R^{BNE-4}, R^{BNE-3'}, R^{BNE-4'}, R^{BNE-I}, R^{BNE-II}, R^{BNE-III}, R^{BNE-IV}, and R^{BNE-V} are each independently of each other selected from the group consisting of: hydrogen, deuterium, N(R^{BNE-5})₂, OR^{BNE-5}, Si(R^{BNE-5})₃, B(OR^{BNE-5} )₂, B(R^{BNE-5})₂, OSO₂R^{BNE-5}, CF₃, CN, F, Cl, Br, I,
C₁-C₄₀-alkyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-alkoxy,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-thioalkoxy,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkenyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})2, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkynyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})2, C=O, C=S, C=Se, C=NR^{BNE-5}, P(=O)(R^{BNE-5}), SO, SO₂, NR^{BNE-5}, O, S or CONR^{BNE-5};
C₆-C₆₀-aryl,
   which is optionally substituted with one or more substituents R^{BNE-5}; and
C₂-C₅₇-heteroaryl,
   which is optionally substituted with one or more substituents R^{BNE-5};
R^{BNE-d}, R^{BNE-d'}, and R^{BNE-e} are independently of each other selected from the group consisting of: hydrogen, deuterium, N(R^{BNE-5})₂, OR^{BNE-5}, Sᵢ(R^{BNE-5})₃, B(OR^{BNE-5})₂, B(R^{BNE-5})₂, OSO₂R^{BNE-5}, CF₃, CN, F, Cl, Br, I,
C₁-C₄₀-alkyl,
   which is optionally substituted with one or more substituents R^{BNE-a} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-alkoxy,
   which is optionally substituted with one or more substituents R^{BNE-a} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-thioalkoxy,
   which is optionally substituted with one or more substituents R^{BNE-a} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkenyl,
   which is optionally substituted with one or more substituents R^{BNE-a} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkynyl,
   which is optionally substituted with one or more substituents R^{BNE-a} and wherein one or more non-adjacent CH₂-groups are optionally substituted by R^{BNE-}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₆-C₆₀-aryl,
   which is optionally substituted with one or more substituents R^{BNE-a}; and
C₂-C₅₇-heteroaryl,
   which is optionally substituted with one or more substituents R^{BNE-a};
R^{BNE-a} is at each occurrence independently of each other selected from the group consisting of: hydrogen, deuterium, N(R^{BNE-5})₂, OR^{BNE-5}, Sᵢ(R^{BNE-5})₃, B(OR^{BNE-5})₂, B(R^{BNE-5})₂, OSO₂R^{BNE-5}, CF₃, CN, F, Cl, Br, I,
C₁-C₄₀-alkyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-alkoxy,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-thioalkoxy,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkenyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkynyl,
   which is optionally substituted with one or more substituents R^{BNE-5} and wherein one or more non-adjacent CH₂-groups are optionally substituted by R^{BNE}-C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₆-C₆₀-aryl,
   which is optionally substituted with one or more substituents R^{BNE-5}; and
C₂-C₅₇-heteroaryl,
   which is optionally substituted with one or more substituents R^{BNE-5};
R^{BNE-5} is at each occurrence independently of each other selected from the group consisting of: hydrogen, deuterium, N(R^{BNE-6})₂, OR^{BNE-6}, Si(R^{BNE-6})₃, B(OR^{BNE-6})₂, B(R^{BNE-6})₂, OSO₂R^{BNE-6}, CF₃, CN, F, Cl, Br, I,
C₁-C₄₀-alkyl,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂, C=O, C=S, C=Se, C=NR^{BNE-6}, P(=O)(R^{BNE-6}), SO, SO₂, NR^{BNE-6}, O, S or CONR^{BNE-6};
C₁-C₄₀-alkoxy,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂, C=O, C=S, C=Se, C=NR^{BNE-6}, P(=O)(R^{BNE-6}), SO, SO₂, NR^{BNE-6}, O, S or CONR^{BNE-6};
C₁-C₄₀-thioalkoxy,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂, C=O, C=S, C=Se, C=NR^{BNE-6}, P(=O)(R^{BNE-6}), SO, SO₂, NR^{BNE-6}, O, S or CONR^{BNE-6};
C₂-C₄₀-alkenyl,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂, C=O, C=S, C=Se, C=NR^{BNE-6}, P(=O)(R^{BNE-6}), SO, SO₂, NR^{BNE-6}, O, S or CONR^{BNE-6};
C₂-C₄₀-alkynyl, which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂, C=O, C=S, C=Se, C=NR^{BNE-6}, P(=O)(R^{BNE-6}), SO, SO₂, NR^{BNE-6}, O, S or CONR^{BNE-6};
C₆-C₆₀-aryl,
   which is optionally substituted with one or more substituents R^{BNE-6}; and
C₂-C₅₇-heteroaryl,
   which is optionally substituted with one or more substituents R^{BNE-6};
R^{BNE-6} is at each occurrence independently from another selected from the group consisting of: hydrogen, deuterium, OPh, CF₃, CN, F,
C₁-C₅-alkyl,
   wherein one or more hydrogen atoms are optionally, independently of each other substituted by deuterium, CN, CF₃, Ph or F;
C₁-C₅-alkoxy,
   wherein one or more hydrogen atoms are optionally, independently of each other substituted by deuterium, CN, CF₃, or F;
C₁-C₅-thioalkoxy,
   wherein one or more hydrogen atoms are optionally, independently of each other substituted by deuterium, CN, CF₃, or F;
C₂-C₅-alkenyl,
   wherein one or more hydrogen atoms are optionally, independently of each other substituted by deuterium, CN, CF₃, or F;
C₂-C₅-alkynyl,
   wherein one or more hydrogen atoms are optionally, independently of each other substituted by deuterium, CN, CF₃, or F;
C₆-C₁₈-aryl,
   which is optionally substituted with one or more C₁-C₅-alkyl substituents;
C₂-C₁₇-heteroaryl,
   which is optionally substituted with one or more C₁-C₅-alkyl substituents;
N(C₆-C₁₈-aryl)₂;
N(C₂-C₁₇-heteroaryl)₂, and
N(C₂-C₁₇-heteroaryl)(C₆-C₁₈-aryl);
wherein R^{BNE-III}, and R^{BNE-e} optionally combine to form a direct single bond; and
wherein two or more of substituents R^{BNE-a}, R^{BNE-d}, R^{BNE-d'}, R^{BNE-e}, R^{BNE-3'}, R^{BNE-4'}, R^{BNE-5} optionally form a mono- or polycyclic, aliphatic or aromatic, carbo- or heterocyclic and/or benzo-fused ring system with each other;
wherein two or more of the substituents R^{BNE-1}, R^{BNE-2}, R^{BNE-1'}, R^{BNE-2'}, R^{BNE-3}, R^{BNE- 4}, R^{BNE-5}, R^{BNE-I}, R^{BNE-II}, R^{BNE-III}, R^{BNE-IV}, R^{BNE-V} optionally form a mono- **or polycyclic,** aliphatic or aromatic, carbo- or heterocyclic and/or benzo-fused ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from R^{BNE-1}, R^{BNE-2}, R^{BNE-1'}, R^{BNE-2'}, R^{BNE-3}, R^{BNE-4}, R^{BNE-3'}, R^{BNE-4'}, R^{BNE-5}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, and R^{BNE-d'}, or any aromatic or heteroaromatic ring formed by two or more substituents as stated above, wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of R^{BNE-1}, R^{BNE-2}, R^{BNE-1'}, R^{BNE-2'}, R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1 and/or wherein optionally at least one hydrogen atom of any of R^{BNE-1}, R^{BNE-2}, R^{BNE-1'}, R^{BNE-2'}, R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1.

In one embodiment of the invention, at least one of the one or more small FWHM emitters S^{B} comprises a structure according to formula BNE-1.

In one embodiment of the invention, each small FWHM emitter S^{B} comprises a structure according to formula BNE-1.

In one embodiment of the invention, at least one of the one or more small FWHM emitters S^{B} consists of a structure according to formula BNE-1.

In one embodiment of the invention, each small FWHM emitter S^{B} consists of a structure according to formula BNE-1.

In one embodiment of the invention, in which at least one, preferably each, of the one or more small FWHM emitters S^{B} comprises or consists of a structure according to formula BNE-1, V¹ is CR^{BNE-V} and V² is CR^{BNE-I}.

In one embodiment of the invention, in which at least one, preferably each, of the one or more small FWHM emitters S^{B} comprises or consists of a structure according to formula BNE-1, V¹ and V² are both nitrogen (N).

In one embodiment of the invention, in which at least one, preferably each, of the one or more small FWHM emitters S^{B} comprises or consists of a structure according to formula BNE-1, V¹ is nitrogen (N) and V² is CR^{BNE-I}.

In one embodiment of the invention, in which at least one, preferably each, of the one or more small FWHM emitters S^{B} comprises or consists of a structure according to formula BNE-1, V¹ is CR^{BNE-V} and V² is nitrogen (N).

In one embodiment of the invention, in which at least one, preferably each, of the one or more small FWHM emitters S^{B} comprises or consists of a structure according to formula BNE-1, c and d are both 0.

In one embodiment of the invention, in which at least one, preferably each, of the one or more small FWHM emitters S^{B} comprises or consists of a structure according to formula BNE-1, c is 0 and d is 1.

In one embodiment of the invention, in which at least one, preferably each, of the one or more small FWHM emitters S^{B} comprises or consists of a structure according to formula BNE-1, c is 1 and d is 0.

In a preferred embodiment of the invention, in which at least one, preferably each, of the one or more small FWHM emitters S^{B} comprises or consists of a structure according to formula BNE-1, c and d are both 1.

In one embodiment of the invention, in which at least one, preferably each, of the one or more small FWHM emitters S^{B} comprises or consists of a structure according to formula BNE-1,
X³ is selected from the group consisting of a direct bond, CR^{BNE-3}R ^{BNE-4}, C=O, NR^{BNE-3}, O, S, SiR^{BNE-3}R^{BNE-4}; and
Y² is selected from the group consisting of a direct bond, CR^{BNE-3'}R ^{BNE-4'}, C=O, NR^{BNE-3'}, O, S, SiR^{BNE-3'}R^{BNE-4'}.

In one embodiment of the invention, in which at least one, preferably each, of the one or more small FWHM emitters S^{B} comprises or consists of a structure according to formula BNE-1,
X³ is selected from the group consisting of a direct bond, CR^{BNE-3}R ^{BNE-4}, NR^{BNE-3}, O, S, SiR^{BNE-3}R^{BNE-4}; and
Y² is selected from the group consisting of a direct bond, CR^{BNE-3'}R ^{BNE-4'}, NR^{BNE-3'}, O, S, SiR^{BNE-3'}R^{BNE-4'}.

In one embodiment of the invention, in which at least one, preferably each, of the one or more small FWHM emitters S^{B} comprises or consists of a structure according to formula BNE-1,
X³ is selected from the group consisting of a direct bond, CR^{BNE-3}R ^{BNE-4}, NR^{BNE-3}, O, S, SiR^{BNE-3}R^{BNE-4}; and
Y² is a direct bond.

In one embodiment of the invention, in which at least one, preferably each, of the one or more small FWHM emitters S^{B} comprises or consists of a structure according to formula BNE-1,
X³ is a direct bond or NR^{BNE-3}; and
Y² is a direct bond.

In one embodiment of the invention, in which at least one, preferably each, of the one or more small FWHM emitters S^{B} comprises or consists of a structure according to formula BNE-1,
X³ is NR^{BNE-3}; and
Y² is a direct bond.

In one embodiment of the invention, in which at least one, preferably each, of the one or more small FWHM emitters S^{B} comprises or consists of a structure according to formula BNE-1,
R^{BNE-1}, R^{BNE-2}, R^{BNE-1'}, R^{BNE-2'}, R^{BNE-3}, R^{BNE-4}, R^{BNE-3'}, R^{BNE-4'},R^{BNE-I}, R^{BNE-II}, R^{BNE-III}, R^{BNE-IV}, and R^{BNE-V} are each independently of each other selected from the group consisting of: hydrogen, deuterium, N(R^{BNE-5})₂, OR^{BNE-5}, Sᵢ(R^{BNE-5})₃, B(OR^{BNE-5})₂, B(R^{BNE-5})₂, OSO₂R^{BNE-5}, CF₃, CN, F, Cl, Br, I,
C₁-C₄₀-alkyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-alkoxy,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-thioalkoxy,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkenyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkynyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₆-C₆₀-aryl,
   which is optionally substituted with one or more substituents R^{BNE-5}; and
C₂-C₅₇-heteroaryl,
   which is optionally substituted with one or more substituents R^{BNE-5};
R^{BNE-d}, R^{BNE-d'}, and R^{BNE-e} are independently of each other selected from the group consisting of: hydrogen, deuterium, CF₃, CN, F, Cl, Br, I,
C₁-C₄₀-alkyl,
   which is optionally substituted with one or more substituents R^{BNE-a} and wherein one or more non-adjacent CH₂-groups are optionally substituted by R^{BNE-5}C=CR^{BNE-5}, C≡C Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₆-C₆₀-aryl,
   which is optionally substituted with one or more substituents R^{BNE-a}; and
C₂-C₅₇-heteroaryl,
   which is optionally substituted with one or more substituents R^{BNE-a};
R^{BNE-a} is at each occurrence independently of each other selected from the group consisting of: hydrogen, deuterium, N(R^{BNE-5})₂, OR^{BNE-5}, Si(R^{BNE-5})₃, B(OR^{BNE-5})₂, B(R^{BNE-5})₂, OSO₂R^{BNE-5} ,CF₃, CN, F, Cl, Br, I,
C₁-C₄₀-alkyl,
   which is optionally substituted with one or more substituents R^{BNE-5} and wherein one or more non-adjacent CH₂-groups are optionally substituted by R^{BNE-5}C=CR^{BNE-5}, C≡C Si(R^{BNE-5})₂, Ge(R^{BNE-5})2, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-alkoxy,
   which is optionally substituted with one or more substituents R^{BNE-5} and wherein one or more non-adjacent CH₂-groups are optionally substituted by R^{BNE-5}C=CR^{BNE-5}, C≡C Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₁-C₄₀-thioalkoxy,
   which is optionally substituted with one or more substituents R^{BNE-5} and wherein one or more non-adjacent CH₂-groups are optionally substituted by R^{BNE-5}C=CR^{BNE-5}, C≡C Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkenyl,
   which is optionally substituted with one or more substituents R^{BNE-5} and wherein one or more non-adjacent CH₂-groups are optionally substituted by R^{BNE-5}C=CR^{BNE-5}, C≡C Si(R^{BNE-5})₂, Ge(R^{BNE-5})2, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₂-C₄₀-alkynyl,
   which is optionally substituted with one or more substituents R^{BNE-5} and wherein one or more non-adjacent CH₂-groups are optionally substituted by R^{BNE}-C=CR^{BNE-5}, C≡C, Si(R^{BNE-5})₂, Ge(R^{BNE-5})₂ , Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₆-C₆₀-aryl,
   which is optionally substituted with one or more substituents R^{BNE-5}; and
C₂-C₅₇-heteroaryl,
   which is optionally substituted with one or more substituents R^{BNE-5};
R^{BNE-5} is at each occurrence independently of each other selected from the group consisting of: hydrogen, deuterium, N(R^{BNE-6})₂, OR^{BNE-6}, Si(R^{BNE-6})₃, B(OR^{BNE-6})₂, B(R^{BNE-6})₂, OSO₂R^{BNE-6}, CF₃, CN, F, Cl, Br, I,
C₁-C₄₀-alkyl,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂ , C=O, C=S, C=Se, C=NR^{BNE-6}, P(=O)(R^{BNE-6}), SO, SO₂, NR^{BNE-6}, O, S or CONR^{BNE-6};
C₁-C₄₀-alkoxy,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂, C=O, C=S, C=Se, C=NR^{BNE-6}, P(=O)(R^{BNE-6}), SO, SO₂, NR^{BNE-6}, O, S or CONR^{BNE-6};
C₁-C₄₀-thioalkoxy,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂ , C=O, C=S, C=Se, C=NR^{BNE-6}, P(=O)(R^{BNE-6}), SO, SO₂, NR^{BNE-6}, O, S or CONR^{BNE-6};
C₂-C₄₀-alkenyl,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂ , C=O, C=S, C=Se, C=NR^{BNE-6}, P(=O)(R^{BNE-6}), SO, SO₂, NR^{BNE-6}, O, S or CONR^{BNE-6};
C₂-C₄₀-alkynyl,
   which is optionally substituted with one or more substituents R^{BNE-6} and wherein one or more non-adjacent CH₂-groups are optionally substituted by R^{BNE-6}C=CR^{BNE-6}, C≡C, Si(R^{BNE-6})₂, Ge(R^{BNE-6})₂, Sn(R^{BNE-6})₂ , C=O, C=S, C=Se, C=NR^{BNE-6}, P(=O)(R^{BNE-6}), SO, SO₂, NR^{BNE-6}, O, S or CONR^{BNE-6};
C₆-C₆₀-aryl,
   which is optionally substituted with one or more substituents R^{BNE-6}; and
C₂-C₅₇-heteroaryl,
   which is optionally substituted with one or more substituents R^{BNE-6};
R^{BNE-6} is at each occurrence independently from another selected from the group consisting of: hydrogen, deuterium, OPh, CF₃, CN, F,
C₁-C₅-alkyl,
   wherein one or more hydrogen atoms are optionally, independently from each other substituted by deuterium, CN, CF₃, Ph or F;
C₁-C₅-alkoxy,
   wherein one or more hydrogen atoms are optionally, independently from each other substituted by deuterium, CN, CF₃, or F;
C₁-C₅-thioalkoxy,
   wherein one or more hydrogen atoms are optionally, independently from each other substituted by deuterium, CN, CF₃, or F;
C₂-C₅-alkenyl,
   wherein one or more hydrogen atoms are optionally, independently from each other substituted by deuterium, CN, CF₃, or F;
C₂-C₅-alkynyl,
   wherein one or more hydrogen atoms are optionally, independently from each other substituted by deuterium, CN, CF₃, or F;
C₆-C₁₈-aryl,
   which is optionally substituted with one or more C₁-C₅-alkyl substituents;
C₂-C₁₇-heteroaryl,
   which is optionally substituted with one or more C₁-C₅-alkyl substituents;
N(C₆-C₁₈-aryl)₂;
N(C₂-C₁₇-heteroaryl)₂, and
N(C₂-C₁₇-heteroaryl)(C₆-C₁₈-aryl);
wherein R^{BNE-III} and R^{BNE-e} optionally combine to form a direct single bond; and
wherein two or more of substituents R^{BNE-a}, R^{BNE-d}, R^{BNE-d'}, R^{BNE-e}, R^{BNE-3'}, R^{BNE-4'} R^{BNE-5} optionally form a mono- or polycyclic, aliphatic or aromatic, carbo- or heterocyclic and/or benzo-fused ring system with each other;
wherein two or more of the substituents R^{BNE-1}, R^{BNE-2}, R^{BNE-1'}, R^{BNE-2'}, R^{BNE-3}, R^{BNE-4}, R^{BNE-5}, R^{BNE-I}, R^{BNE-II}, R^{BNE-III}, R^{BNE-IV}, R^{BNE-V} optionally form a mono- or polycyclic, aliphatic or aromatic, carbo- or heterocyclic and/or benzo-fused ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from R^{BNE-1}, R^{BNE-2}, R^{BNE-1'}, R^{BNE-2'}, R^{BNE-3}, R^{BNE-4}, R^{BNE-3'}, R^{BNE-4'}, R^{BNE-5}, R^{BNE-6}, R^{BNE-I}, R^{BNE-II}, R^{BNE-III}, R^{BNE-IV} R^{BNE-V}, R^{BNE-a}, R^{BNE-e}, R^{BNE-d}, and R^{BNE-d'}, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of R^{BNE-1}, R^{BNE-2}, R^{BNE-1'}, R^{BNE-2}', R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1 and/or wherein optionally at least one hydrogen atom of any of R^{BNE-I}, R^{BNE-2}, R^{BNE-1'}, R^{BNE-2'} , R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1.

In one embodiment of the invention, in which at least one, preferably each, of the one or more small FWHM emitters S^{B} comprises or consists of a structure according to formula BNE-1,
R^{BNE-1}, R^{BNE-2}, R^{BNE-I'}, R^{BNE-2'}, R^{BNE-3}, R^{BNE-4}, R^{BNE-3'}, R^{BNE-4'}, R^{BNE-I}, R^{BNE-II}, R^{BNE-III}, R^{BNE-IV}, and R^{BNE-V} are each independently of each other selected from the group consisting of: hydrogen, deuterium, N(R^{BNE-5})2, OR^{BNE-5}, Si(R^{BNE-5})₃, B(R^{BNE-5})₂, CF₃, CN, F, Cl, Br, I,
C₁-C₁₈-alkyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O C=S, C=Se, C=NR^{BNE-5}, P(=O)(R^{BNE-5}), SO, SO₂, NR^{BNE-5}, O, S or CONR^{BNE-5};
C₆-C₃₀-aryl,
   which is optionally substituted with one or more substituents R^{BNE-5}; and
C₂-C₂₉-heteroaryl,
   which is optionally substituted with one or more substituents R^{BNE-5};
R^{BNE-d}, R^{BNE-d'}, and R^{BNE-e} are independently of each other selected from the group consisting of: hydrogen, deuterium, CF₃, CN, F, Cl, Br, I,
C₁-C₁₈-alkyl,
   which is optionally substituted with one or more substituents R^{BNE-a} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₆-C₃₀-aryl,
   which is optionally substituted with one or more substituents R^{BNE-a}; and
C₂-C₂₉-heteroaryl,
   which is optionally substituted with one or more substituents R^{BNE-a};
R^{BNE-a} is at each occurrence independently of each other selected from the group consisting of: hydrogen, deuterium, N(R^{BNE-5})2, OR^{BNE-5}, Si(R^{BNE-5})₃, B(R^{BNE-5})₂, CF₃, CN, F, Cl, Br, I,
C₁-C₁₈-alkyl,
   which is optionally substituted with one or more substituents R^{BNE-5} and wherein one or more non-adjacent CH₂-groups are optionally substituted by R^{BNE-5}C=CR^{BNE-5}, C≡C, Si(R^{BNE-5})₂, Ge(R^{BNE-5})₂, Sn(R^{BNE-5})₂, C=O, C=S, C=Se, C=NR^{BNE-5}, P(=O)(R^{BNE-5}), SO, SO₂, NR^{BNE-5}, O, S or CONR^{BNE-5};
C₆-C₃₀-aryl,
   which is optionally substituted with one or more substituents R^{BNE-5}; and
C₂-C₂₉-heteroaryl,
   which is optionally substituted with one or more substituents R^{BNE-5};
R^{BNE-5} is at each occurrence independently from another selected from the group consisting of: hydrogen, deuterium, OPh, CF₃, CN, F,
C₁-C₅-alkyl,
   wherein one or more hydrogen atoms are optionally, independently from each other substituted by deuterium, CN, CF₃, or F;
C₁-C₅-alkoxy,
   wherein one or more hydrogen atoms are optionally, independently from each other substituted by deuterium, CN, CF₃, or F;
C₁-C₅-thioalkoxy,
   wherein one or more hydrogen atoms are optionally, independently from each other substituted by deuterium, CN, CF₃, or F;
C₂-C₅-alkenyl,
   wherein one or more hydrogen atoms are optionally, independently from each other substituted by deuterium, CN, CF₃, or F;
C₂-C₅-alkynyl,
   wherein one or more hydrogen atoms are optionally, independently from each other substituted by deuterium, CN, CF₃, or F;
C₆-C₁₈-aryl,
   which is optionally substituted with one or more C₁-C₅-alkyl substituents;
C₂-C₁₇-heteroaryl,
   which is optionally substituted with one or more C₁-C₅-alkyl substituents;
N(C₆-C₁₈-aryl)₂;
N(C₂-C₁₇-heteroaryl)₂, and
N(C₂-C₁₇-heteroaryl)(C₆-C₁₈-aryl);
wherein R^{BNE-III} and R^{BNE-e} optionally combine to form a direct single bond; and
wherein two or more of substituents R^{BNE-a}, R^{BNE-d}, R^{BNE-d'}, R^{BNE-e}, R^{BNE-3'}, R^{BNE-4'} R^{BNE-5} optionally form a mono- or polycyclic, aliphatic or aromatic, carbo- or heterocyclic and/or benzo-fused ring system with each other;
wherein two or more of the substituents R^{BNE-1}, R^{BNE-2}, R^{BNE-1'}, R^{BNE-2'}, R^{BNE-3}, R^{BNE-4}, R^{BNE-5}, R^{BNE-I}, R^{BNE-II}, R^{BNE-III}, R^{BNE-IV}, R^{BNE-V} optionally form a mono- or polycyclic, aliphatic or aromatic, carbo- or heterocyclic and/or benzo-fused ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from R^{BNE-1}, R^{BNE-2}, R^{BNE-1'}, R^{BNE-2'}, R^{BNE-3}, R^{BNE-4}, R^{BNE-3'}, R^{BNE-4'}, R^{BNE-5}, R^{BNE-6}, R^{BNE-I}, R^{BNE-II}, R^{BNE-III}, R^{BNE-IV} R^{BNE-V}, R^{BNE-a}, R^{BNE-e}, R^{BNE-d}, and R^{BNE-d'}, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of R^{BNE-1}, R^{BNE-2}, R^{BNE-1'}, R^{BNE-2}', R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1 and/or wherein optionally at least one hydrogen atom of any of R^{BNE-1}, R^{BNE-2}, R^{BNE-1'}, R^{BNE-2'}, R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1.

In one embodiment of the invention, in which at least one, preferably each, of the one or more small FWHM emitters S^{B} comprises or consists of a structure according to formula BNE-1,
R^{BNE-1}, R^{BNE-2}, R^{BNE-1'}, R^{BNE-2'}, R^{BNE-3}, R^{BNE-4}, R^{BNE-3'}, R^{BNE-4'}, R^{BNE-I}, R^{BNE-II}, R^{BNE-III}, R^{BNE-IV}, and R^{BNE-V} are each independently of each other selected from the group consisting of: hydrogen, deuterium, N(R^{BNE-5})2, OR^{BNE-5}, Si(R^{BNE-5})₃, B(R^{BNE-5})₂, CF₃, CN, F,
C₁-C₅-alkyl,
   which is optionally substituted with one or more substituents R^{BNE-5};
C₆-C₁₈-aryl,
   which is optionally substituted with one or more substituents R^{BNE-5}; and
C₂-C₁₇-heteroaryl,
   which is optionally substituted with one or more substituents R^{BNE-5};
R^{BNE-d}, R^{BNE-d'}, and R^{BNE-e} are independently of each other selected from the group consisting of: hydrogen, deuterium, CF₃, CN, F,
C₁-C₅-alkyl,
   which is optionally substituted with one or more substituents R^{BNE-a};
C₆-C₁₈-aryl,
   which is optionally substituted with one or more substituents R^{BNE-a}; and
C₂-C₁₇-heteroaryl,
   which is optionally substituted with one or more substituents R^{BNE-a};
R^{BNE-a} is at each occurrence independently of each other selected from the group consisting of: hydrogen, deuterium, N(R^{BNE-5})₂, OR^{BNE-5}, Si(R^{BNE-5})₃, B(R^{BNE-5})₂, CF₃, CN, F,
C₁-C₅-alkyl,
   which is optionally substituted with one or more substituents R^{BNE-5};
C₆-C₁₈-aryl,
   which is optionally substituted with one or more substituents R^{BNE-5}; and
C₂-C₁₇-heteroaryl,
   which is optionally substituted with one or more substituents R^{BNE-5};
R^{BNE-5} is at each occurrence independently from another selected from the group consisting of: hydrogen, deuterium, OPh, CF₃, CN, F,
C₁-C₅-alkyl,
   wherein one or more hydrogen atoms are optionally, independently from each other substituted by deuterium, CN, CF₃, or F;
C₁-C₅-alkoxy,
   wherein one or more hydrogen atoms are optionally, independently from each other substituted by deuterium, CN, CF₃, or F;
C₆-C₁₈-aryl,
   which is optionally substituted with one or more C₁-C₅-alkyl substituents;
C₂-C₁₇-heteroaryl,
   which is optionally substituted with one or more C₁-C₅-alkyl substituents;
N(C₆-C₁₈-aryl)₂;
N(C₂-C₁₇-heteroaryl)₂, and
N(C₂-C₁₇-heteroaryl)(C₆-C₁₈-aryl);
wherein R^{BNE-III} and R^{BNE-e} optionally combine to form a direct single bond; and
wherein two or more of substituents R^{BNE-a}, R^{BNE-d}, R^{BNE-d'}, R^{BNE-e}, R^{BNE-3'}, R^{BNE-4'}, R^{BNE-5} optionally form a mono- or polycyclic, aliphatic or aromatic, carbo- or heterocyclic and/or benzo-fused ring system with each other;
wherein two or more of the substituents R^{BNE-1}, R^{BNE-2}, R^{BNE-1'}, R^{BNE-2'} , R^{BNE-3}, R^{BNE-4}, R^{BNE-5}, R^{BNE-I}, R^{BNE-II}, R^{BNE-III}, R^{BNE-IV}, R^{BNE-V} optionally form a mono- or polycyclic, aliphatic or aromatic, carbo- or heterocyclic and/or benzo-fused ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from R^{BNE-1}, R^{BNE-2}, R^{BNE-1'}, R^{BNE-2'}, R^{BNE-3}, R^{BNE-4}, R^{BNE-3'}, R^{BNE-4'}, R^{BNE-5}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, and R^{BNE-d'}, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of R^{BNE-1}, R^{BNE-2}, R^{BNE-1'}, R^{BNE-2}', R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1 and/or wherein optionally at least one hydrogen atom of any of R^{BNE-1}, R^{BNE-2}, R^{BNE-1'}, R^{BNE-2'}, R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1.

In one embodiment of the invention, in which at least one, preferably each, of the one or more small FWHM emitters S^{B} comprises or consists of a structure according to formula BNE-1,
R^{BNE-1}, R^{BNE-2}, R^{BNE-1'}, R^{BNE-2'}, R^{BNE-3}, R^{BNE-4}, R^{BNE-3'}, R^{BNE-4'}, R^{BNE-I}, R^{BNE-II}, R^{BNE-III}, R^{BNE-IV}, and R^{BNE-V} are each independently of each other selected from the group consisting of: hydrogen, deuterium, N(R^{BNE-5})2, OR^{BNE-5}, Si(R^{BNE-5})₃, B(R^{BNE-5})₂, CF₃, CN, F,
C₁-C₅-alkyl,
   which is optionally substituted with one or more substituents R^{BNE-5};
C₆-C₁₈-aryl,
   which is optionally substituted with one or more substituents R^{BNE-5}; and
C₂-C₁₇-heteroaryl,
   which is optionally substituted with one or more substituents R^{BNE-5};
R^{BNE-d}, R^{BNE-d'}, and R^{BNE-e} are independently of each other selected from the group consisting of: hydrogen, deuterium,
C₁-C₅-alkyl,
   which is optionally substituted with one or more substituents R^{BNE-a};
C₆-C₁₈-aryl,
   which is optionally substituted with one or more substituents R^{BNE-a}; and
C₂-C₁₇-heteroaryl,
   which is optionally substituted with one or more substituents R^{BNE-a};
R^{BNE-a} is at each occurrence independently of each other selected from the group consisting of: hydrogen, deuterium, N(R^{BNE-5})2, OR^{BNE-5}, Si(R^{BNE-5})₃, B(R^{BNE-5})₂, CF₃, CN, F,
C₁-C₅-alkyl,
   which is optionally substituted with one or more substituents R^{BNE-5};
C₆-C₁₈-aryl,
   which is optionally substituted with one or more substituents R^{BNE-5}; and
C₂-C₁₇-heteroaryl,
   which is optionally substituted with one or more substituents R^{BNE-5};
R^{BNE-5} is at each occurrence independently from another selected from the group consisting of: hydrogen, deuterium, OPh, CF₃, CN, F,
C₁-C₅-alkyl,
   wherein one or more hydrogen atoms are optionally, independently from each other substituted by deuterium, CN, CF₃, or F;
C₆-C₁₈-aryl,
   which is optionally substituted with one or more C₁-C₅-alkyl substituents;
C₂-C₁₇-heteroaryl,
   which is optionally substituted with one or more C₁-C₅-alkyl substituents;
N(C₆-C₁₈-aryl)₂;
N(C₂-C₁₇-heteroaryl)₂, and
N(C₂-C₁₇-heteroaryl)(C₆-C₁₈-aryl);
wherein R^{BNE-III} and R^{BNE-e} optionally combine to form a direct single bond; and
wherein two or more of substituents R^{BNE-a}, R^{BNE-d}, R^{BNE-d'}, R^{BNE-e}, R^{BNE-3'}, R^{BNE-4'}, R^{BNE-5} optionally form a mono- or polycyclic, aliphatic or aromatic, carbo- or heterocyclic and/or benzo-fused ring system with each other;
wherein two or more of the substituents R^{BNE-1}, R^{BNE-2}, R^{BNE-1'}, R^{BNE-2'} , R^{BNE-3}, R^{BNE-4}, R^{BNE-5}, R^{BNE-I}, R^{BNE-II}, R^{BNE-III}, R^{BNE-IV}, R^{BNE-V} optionally form a mono- or polycyclic, aliphatic or aromatic, carbo- or heterocyclic and/or benzo-fused ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from R^{BNE-1}, R^{BNE-2}, R^{BNE-1'}, R^{BNE-2'}, R^{BNE-3}, R^{BNE-4}, R^{BNE-3'}, R^{BNE-4'}, R^{BNE-5}, R^{BNE-6}, R^{BNE-I}, R^{BNE-II}, R^{BNE-III} , R^{BNE-IV} R^{BNE-V}, R^{BNE-a}, R^{BNE-e}, R^{BNE-d}, and R^{BNE-d'}, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of R^{BNE-I}, R^{BNE-2}, R^{BNE-1'}, R^{BNE-2}', R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1 and/or wherein optionally at least one hydrogen atom of any of R^{BNE-1}, R^{BNE-2}, R^{BNE-1'}, R^{BNE-2'}, R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1.

In one embodiment of the invention, in which at least one, preferably each, of the one or more small FWHM emitters S^{B} comprises or consists of a structure according to formula BNE-1, R^{BNE-III} and R^{BNE-e} combine to form a direct single bond.

In one embodiment of the invention, in which at least one, preferably each, of the one or more small FWHM emitters S^{B} comprises or consists of a structure according to formula BNE-1, R^{BNE-III} and R^{BNE-e} do not combine to form a direct single bond.

In one embodiment, fluorescent emitters suitable as small FWHM emitters S^{B} in the context of the present invention may optionally also be multimers (e.g. dimers) of the aforementioned formula BNE-1, which means that their structure comprises more than one subunits, each of which has a structure according to formula BNE-1. In this case, the skilled artisan will understand that the two or more subunits according to formula BNE-1 may for example be conjugated, preferably fused to each other (i.e. sharing at least one bond, wherein the respective substituents attached to the atoms forming that bond may no longer be present). The two or more subunits may also share at least one, preferably exactly one, aromatic or heteroaromatic ring. This means that, for example, a small FWHM emitter S^{B} may comprise two or more subunits each having a structure of formula BNE-1, wherein these two subunits share one aromatic or heteroaromatic ring (i.e. the respective ring is part of both subunits). As a result, the respective multimeric (e.g., dimeric) emitter S^{B} may not contain two whole subunits according to formula BNE-1 as the shared ring is only present once. Nevertheless, the skilled artisan will understand that herein, such an emitter is still considered a multimer (for example a dimer if two subunits having a structure of formula BNE-1 are comprised) of formula BNE-1. The same holds true for multimers sharing more than one ring. It is preferred that the multimers are dimers comprising two subunits, each having a structure of formula BNE-1.

In one embodiment of the invention, at least one small FWHM emitter S^{B}, preferably each small FWHM emitter S^{B}, is a dimer of formula BNE-1 as described above, which means that the emitter comprises two subunits, each having a structure according to formula BNE-1.

In one embodiment of the invention, at least one, preferably each, of the one or more small FWHM emitters S^{B} comprises or consists of two or more, preferably of exactly two, structures according to formula BNE-1 (i.e. subunits),
wherein these two subunits are conjugated, preferably fused to each other by sharing at least one, more preferably exactly one, bond.

In one embodiment of the invention, at least one, preferably each, of the one or more small FWHM emitters S^{B} comprises or consists of two or more, preferably of exactly two, structures according to formula BNE-1 (i.e. subunits),
wherein these two subunits share at least one, preferably exactly one, aromatic or heteroaromatic ring (i.e. this ring is part of both structures of formula BNE-1) which preferably is any of the rings a, b, and c' of formula BNE-1, but may also be any aromatic or heteroaromatic substituent selected from R^{BNE-1}, R^{BNE-2}, R^{BNE-1'}, R^{BNE-2'}, R^{BNE-3}, R^{BNE-4}, R^{BNE-3'} , R^{BNE-4'} , R^{BNE-5}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, and R^{BNE-d'}, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter).

In one embodiment of the invention, at least one, preferably each, of the one or more small FWHM emitters S^{B} comprises or consists of a structure according to formula BNE-1 (i.e. subunits),
wherein at least one of R^{BNE-1}, R^{BNE-2}, R^{BNE-1'}, R^{BNE-2'}, R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1 and/or wherein optionally at least one hydrogen atom of any of R^{BNE-1}, R^{BNE-2}, R^{BNE-1'}, R^{BNE-2'}, R^{BNE-3}, R^{BNE-4}, R^{BNE-5}, R^{BNE-3'}, R^{BNE-4'}, R^{BNE-6}, R^{BNE-I}, R^{BNE-II}, R^{BNE-III}, R^{BNE-IV}, R^{BNE-V}, R^{BNE-a}, R^{BNE-e}, R^{BNE-d}, or R^{BNE-d'} is replaced by a bond to a further chemical entity of formula BNE-1.

Non-limiting examples of fluorescent emitters comprising or consisting of a structure according to the aforementioned formula BNE-1 that may be used as small FWHM emitters in the context of the present invention are shown below:

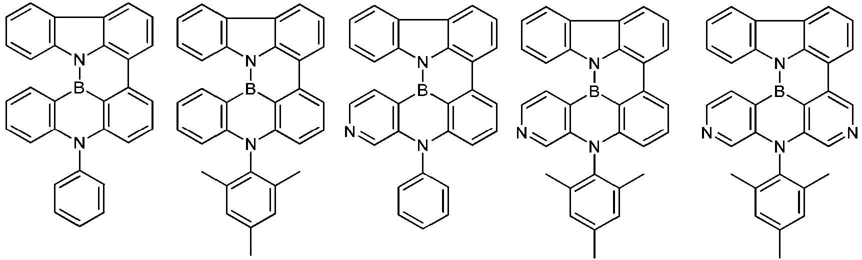

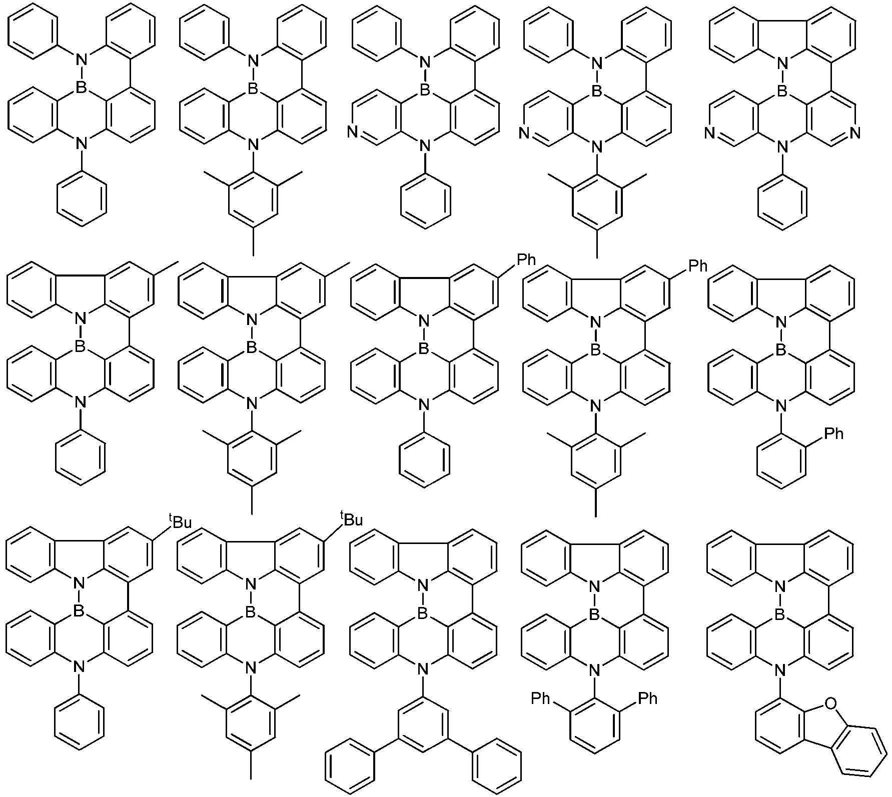

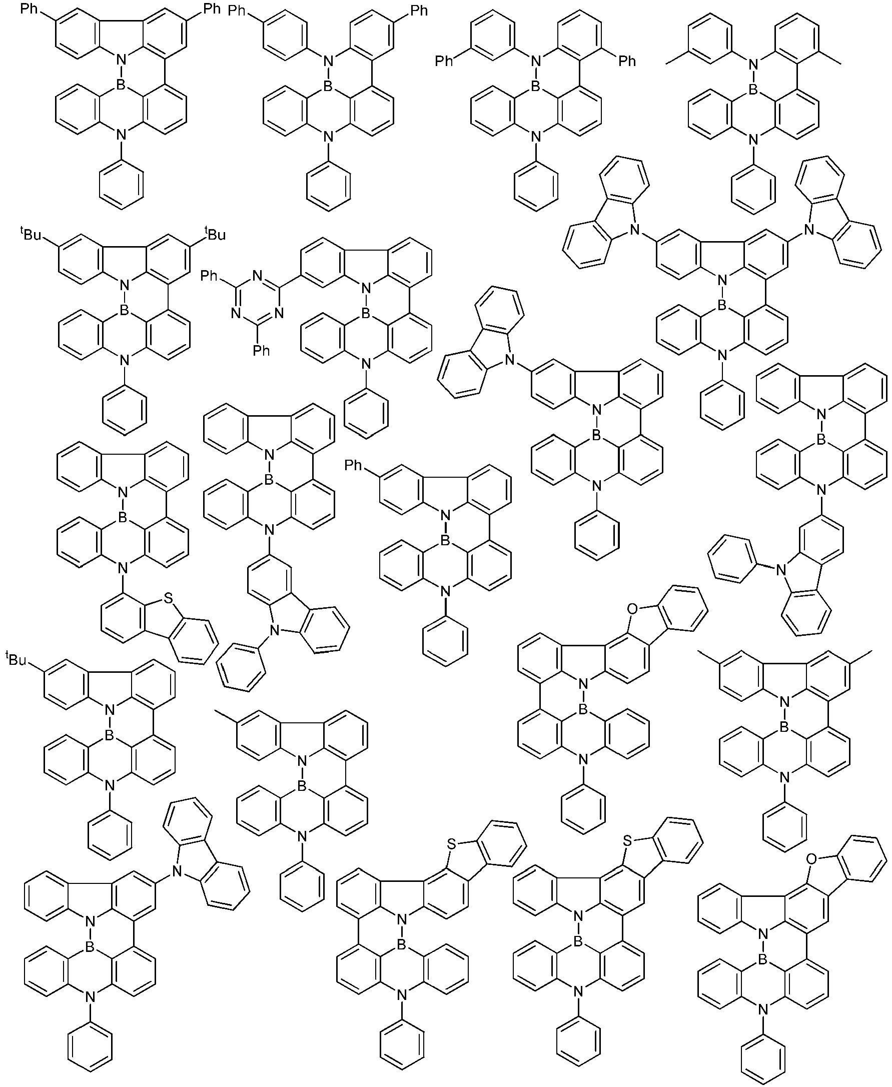

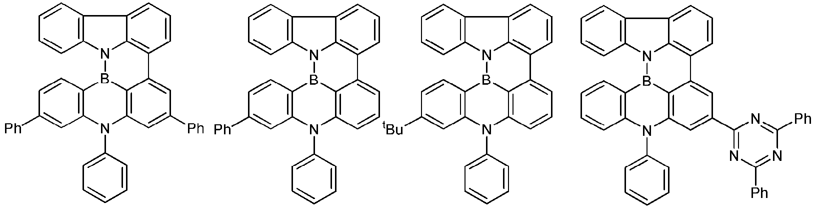

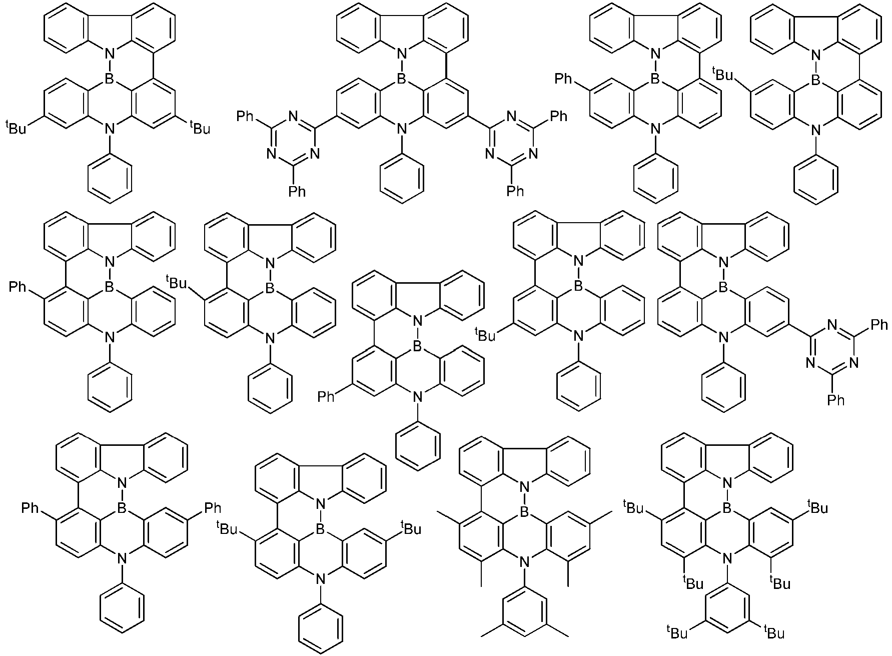

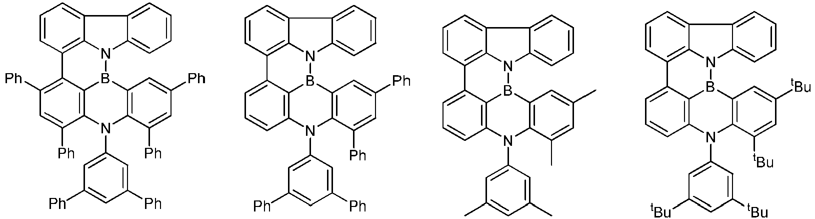

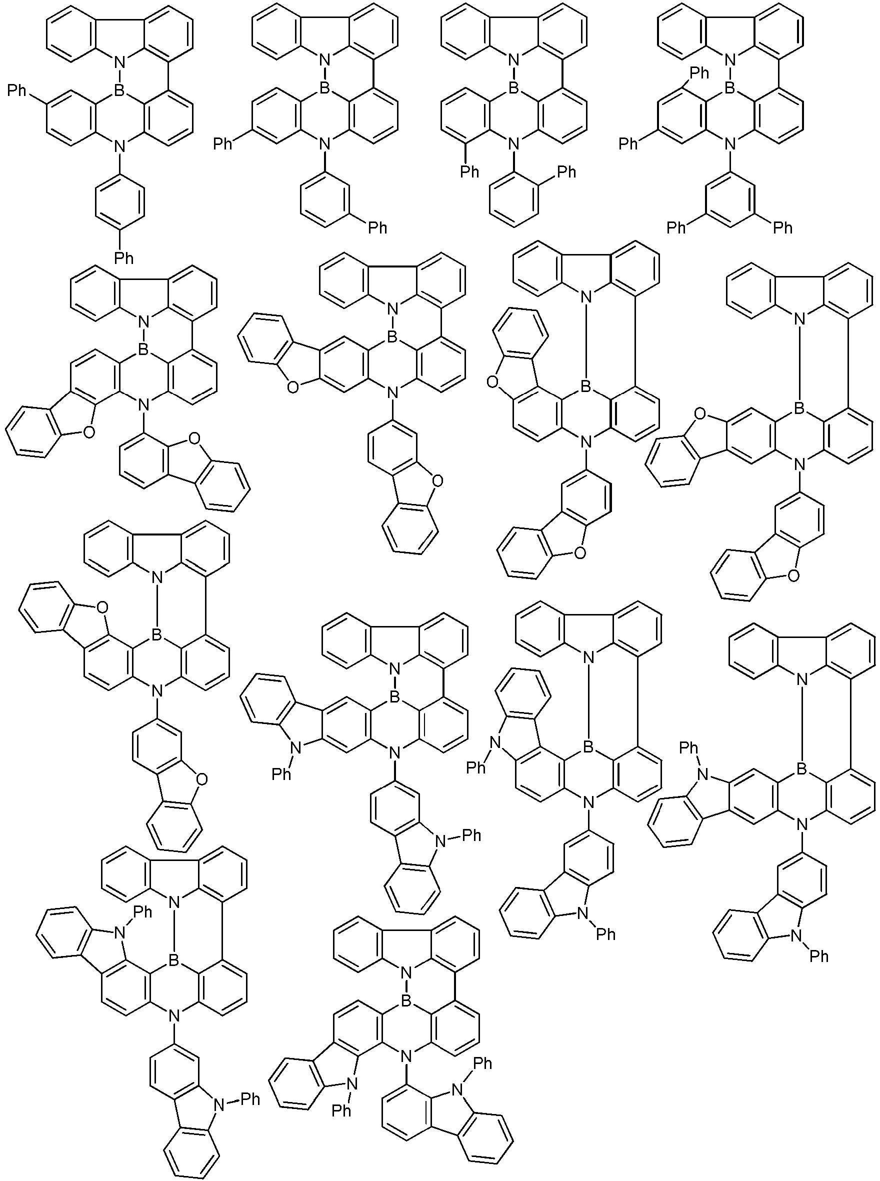

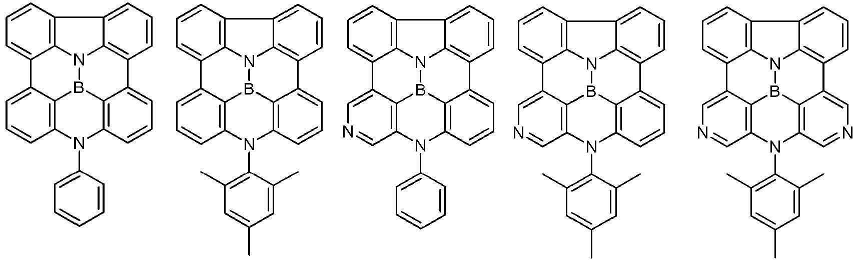

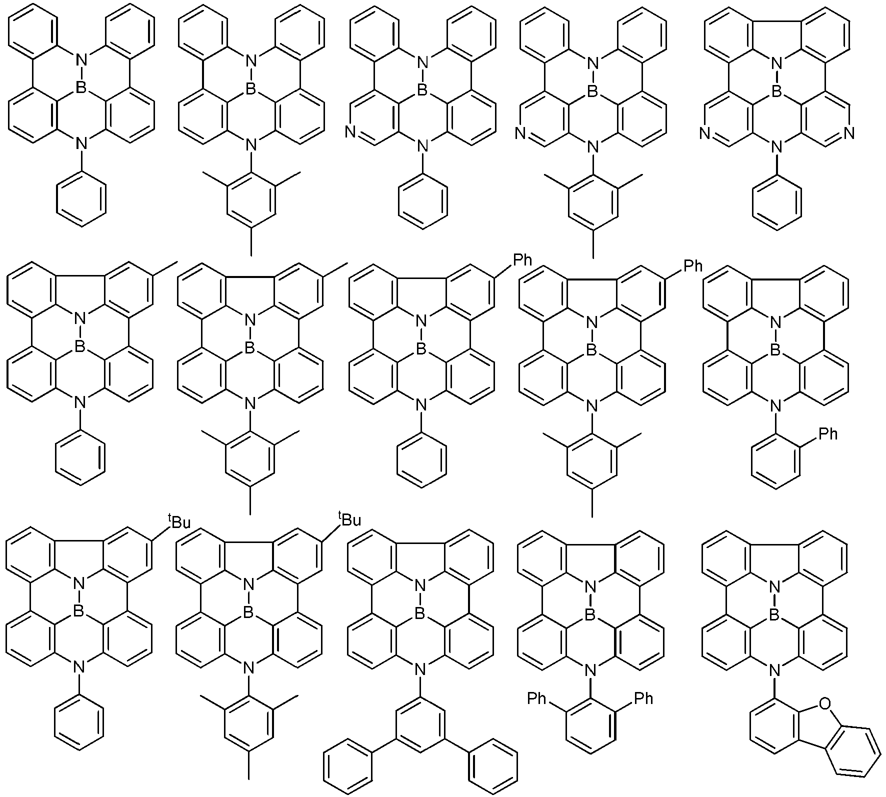

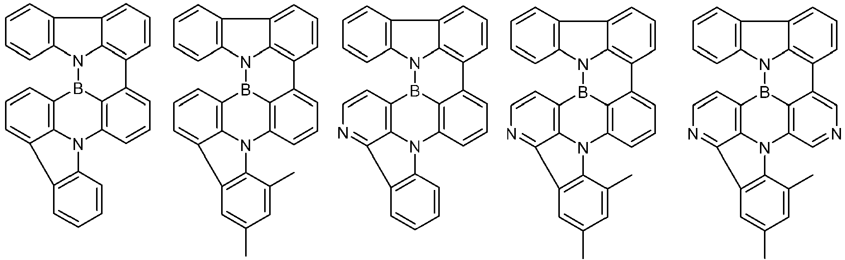

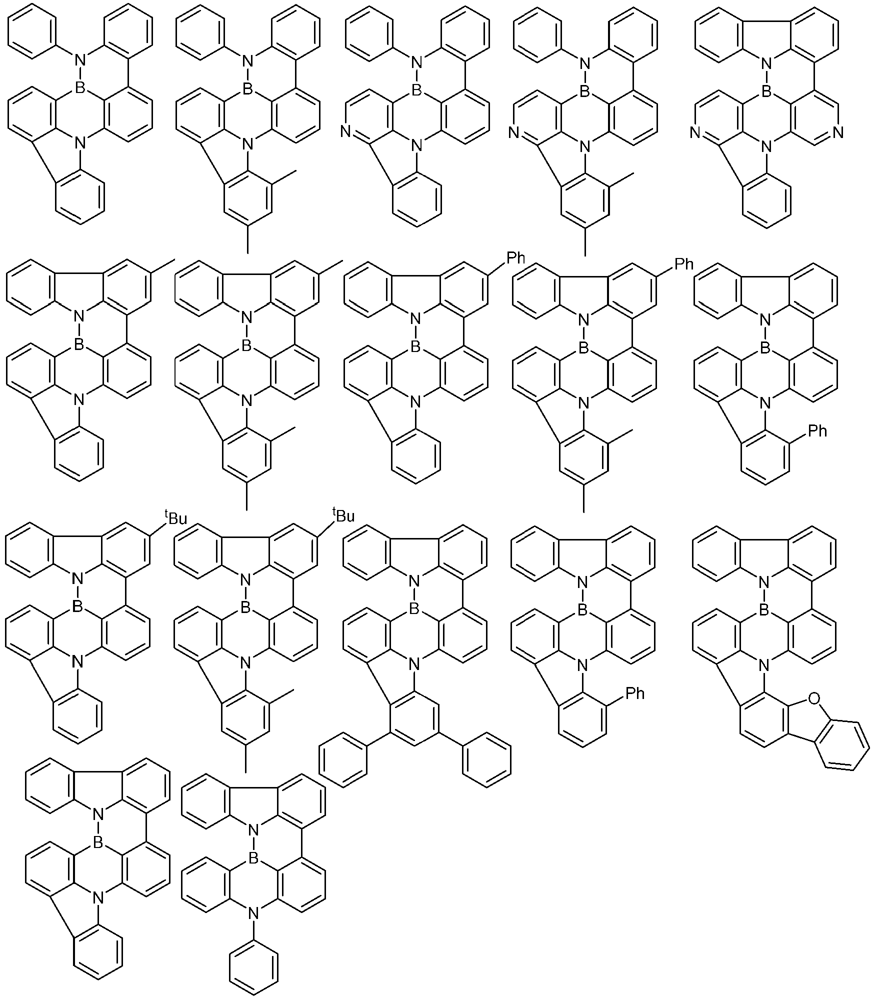

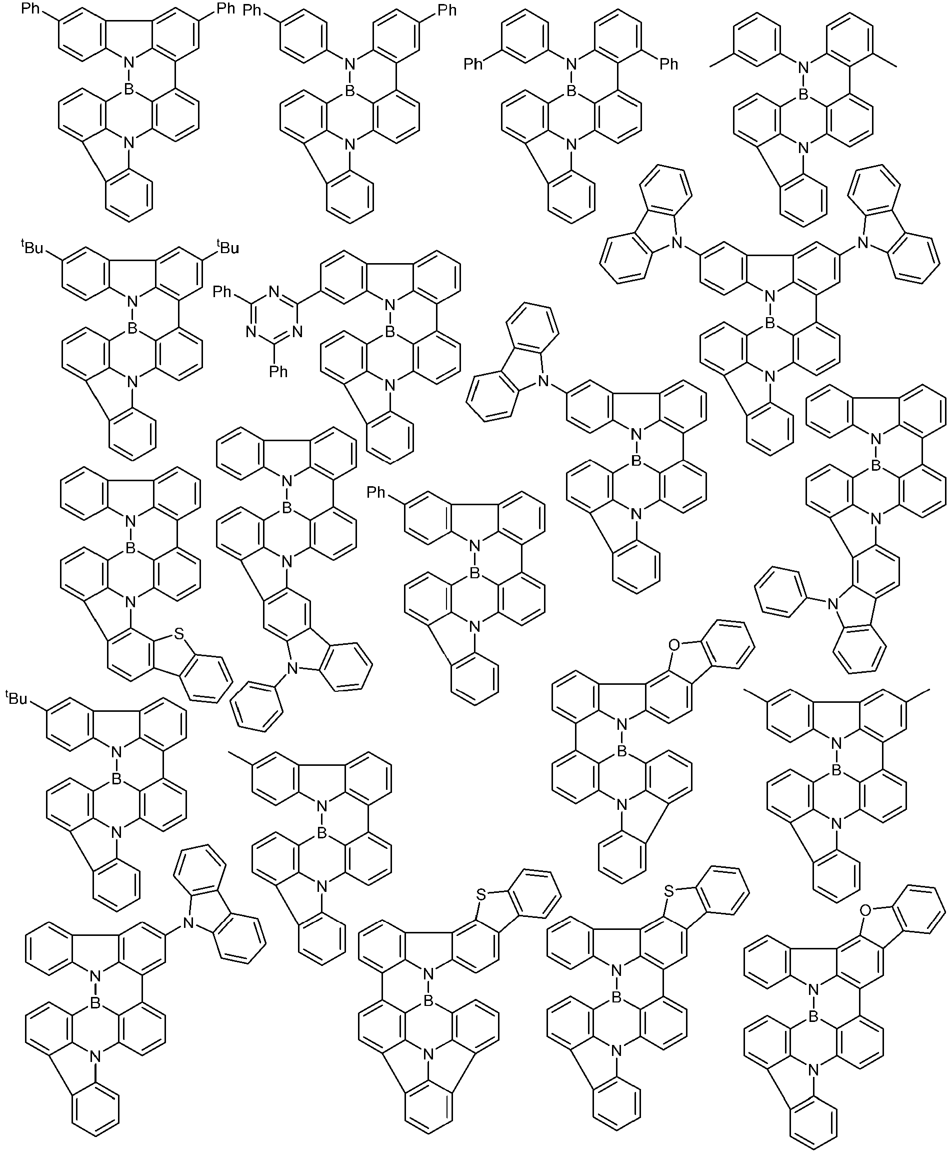

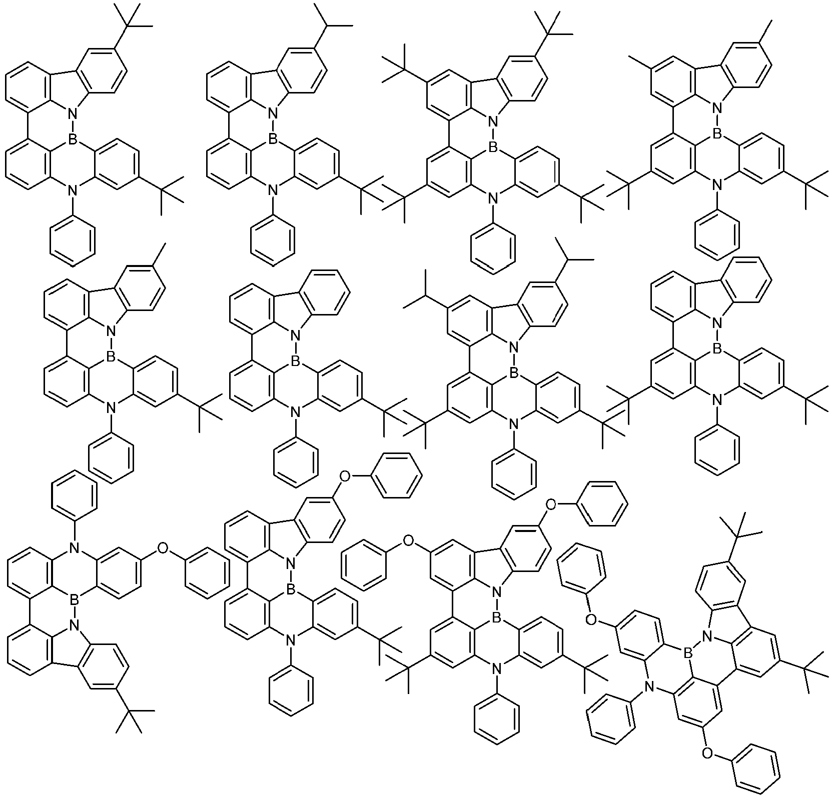

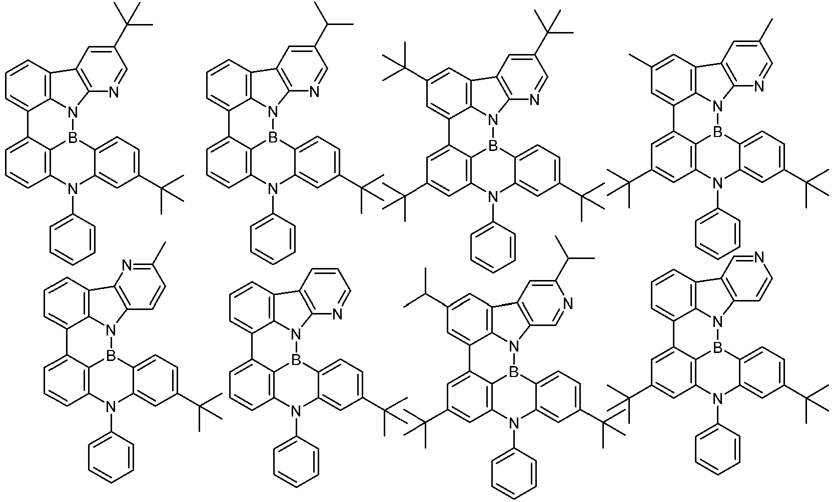

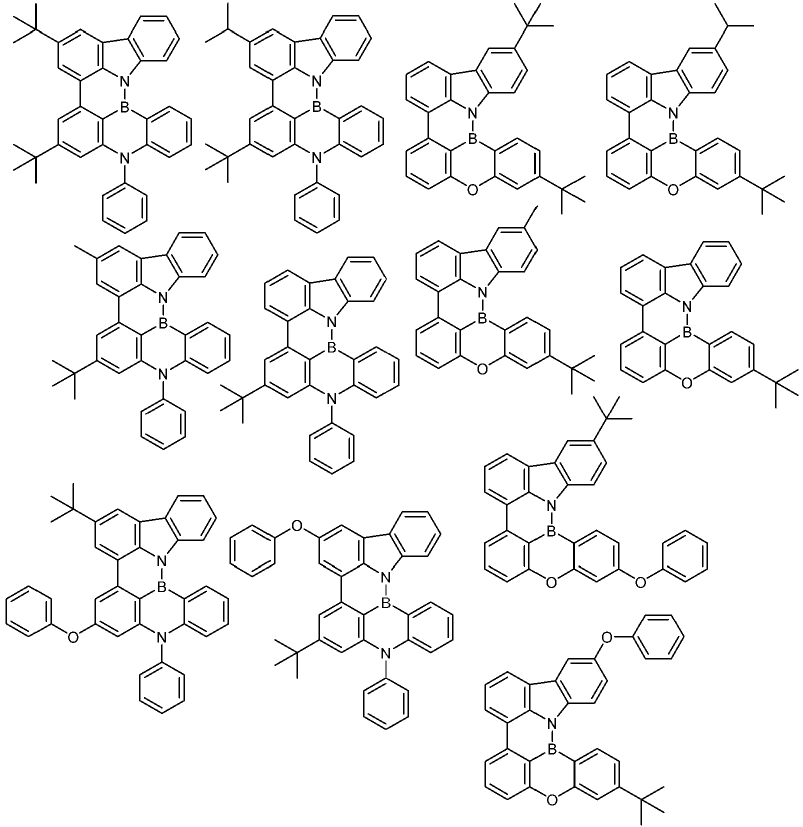

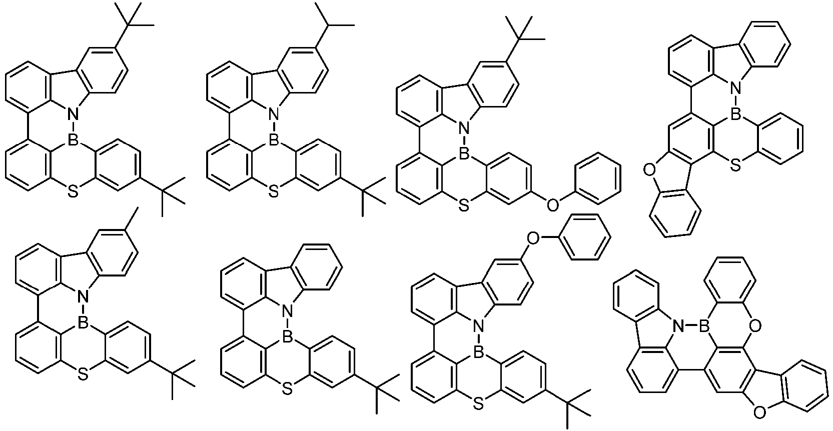

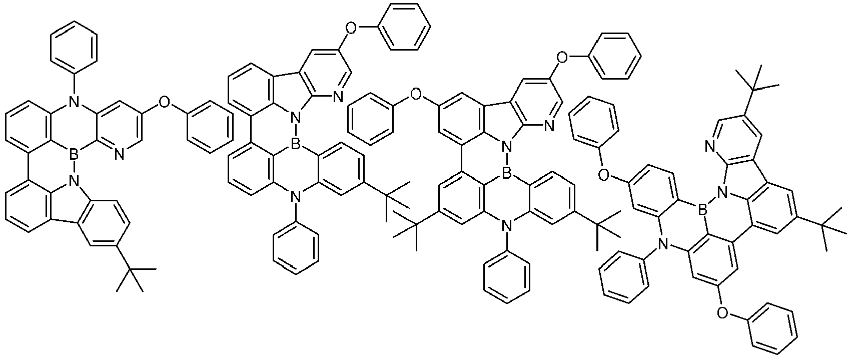

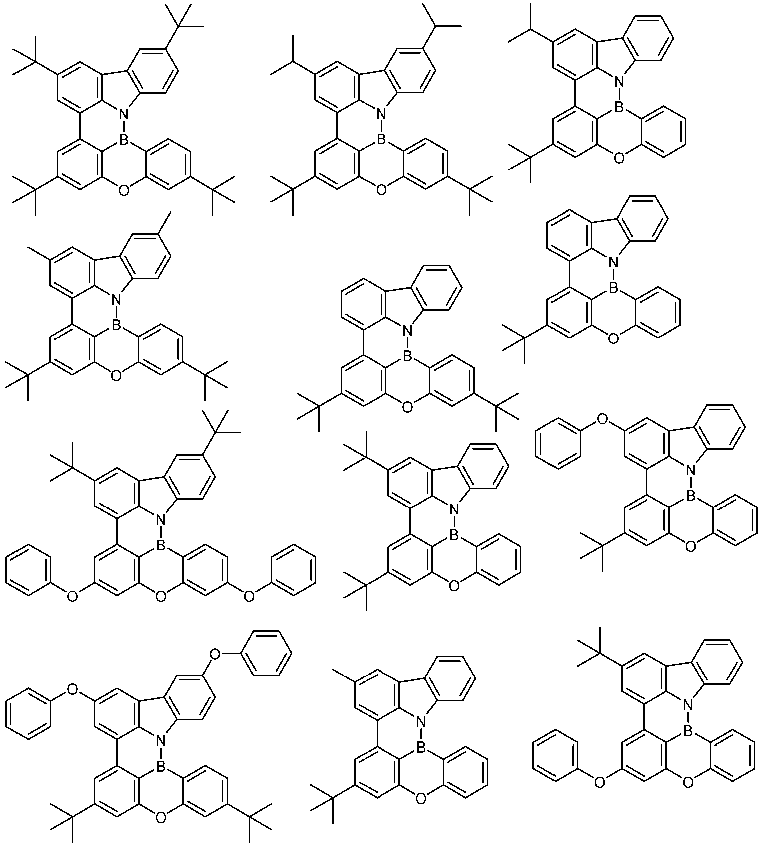

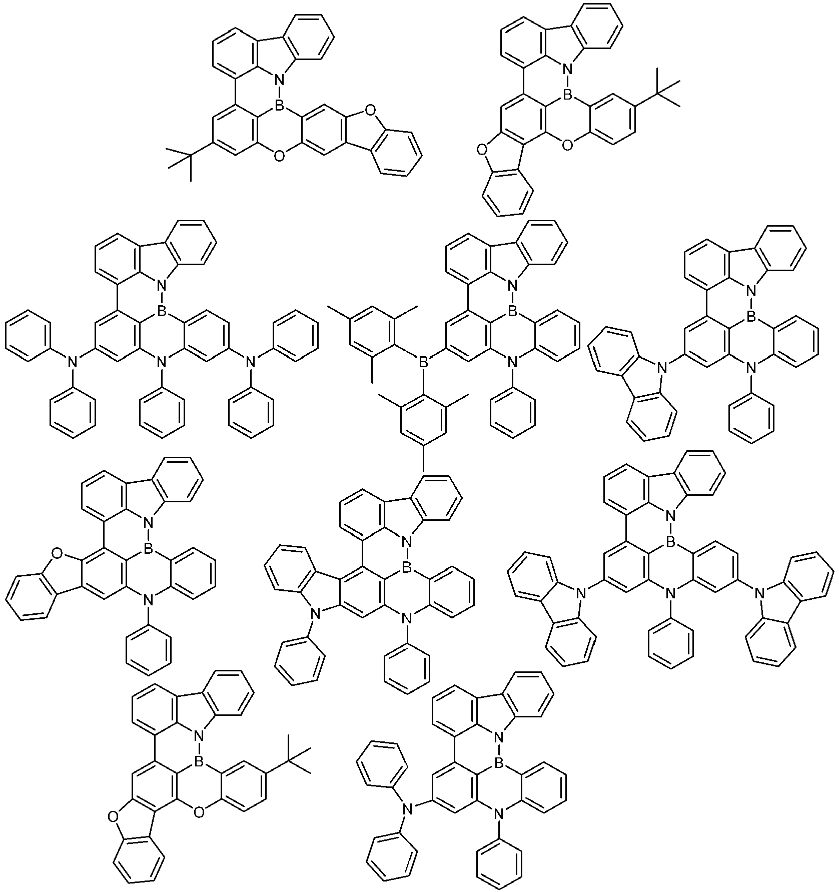

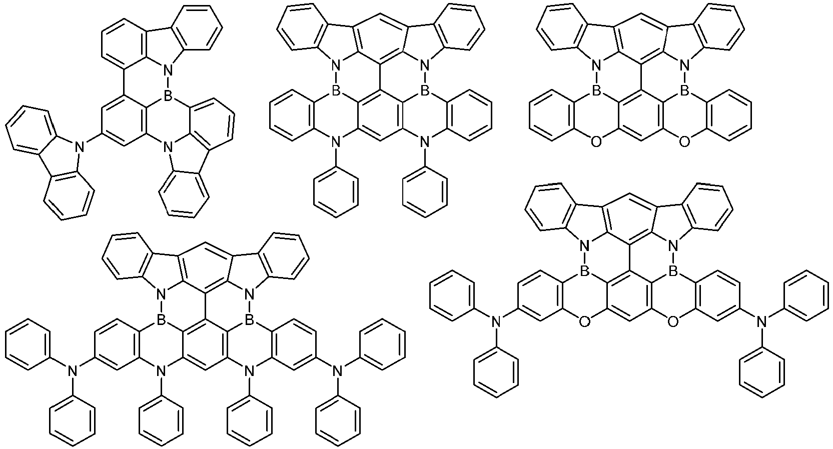

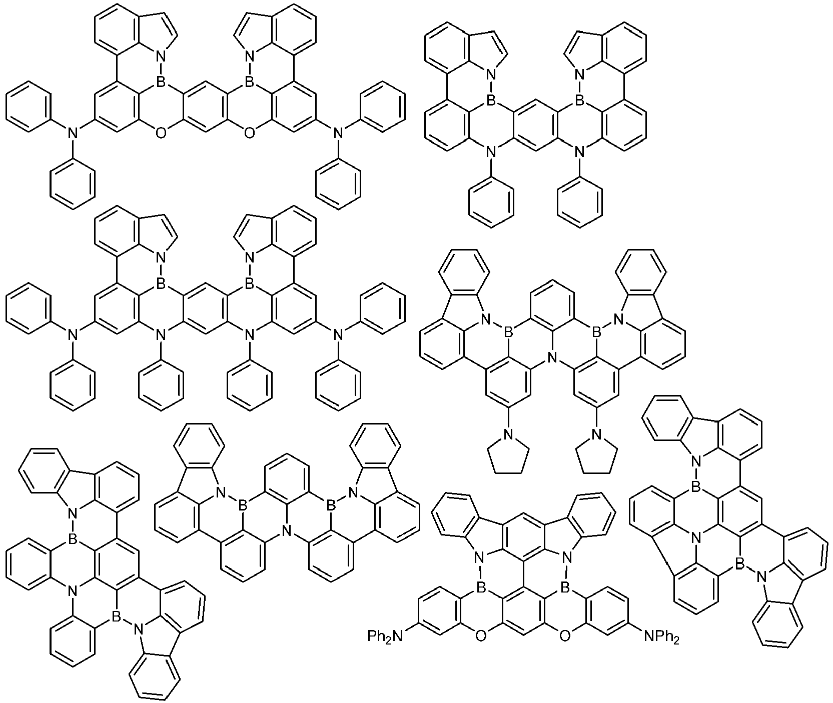

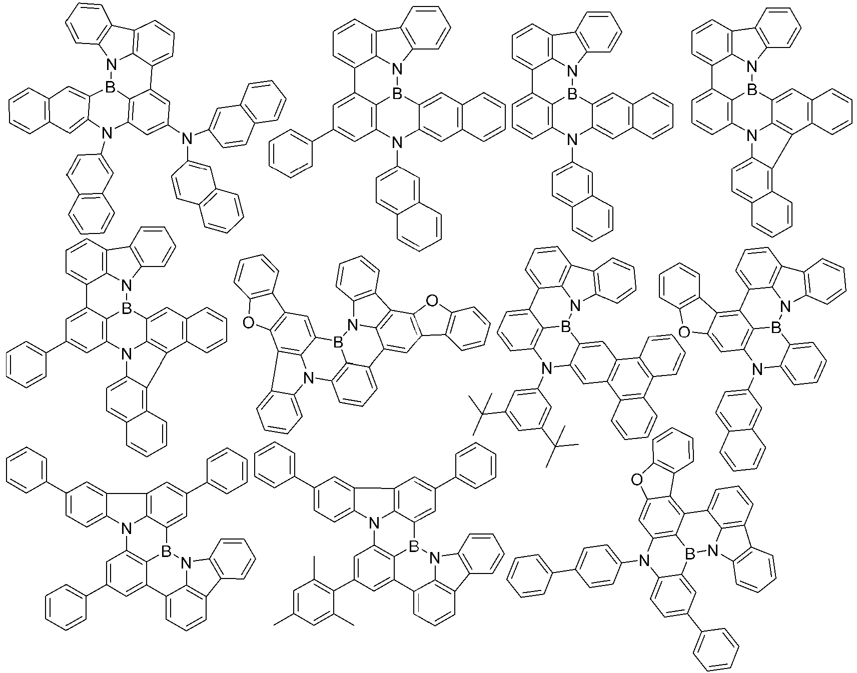

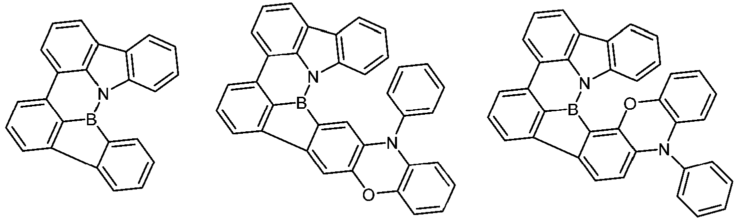

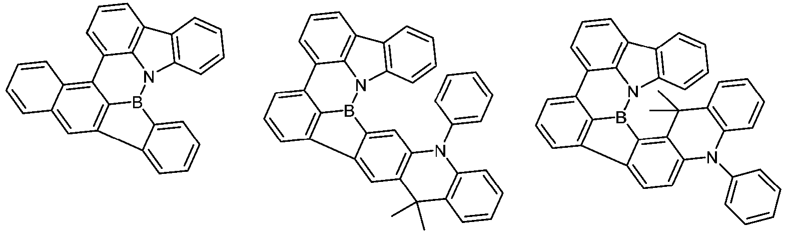

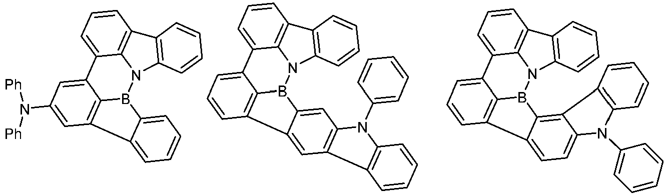

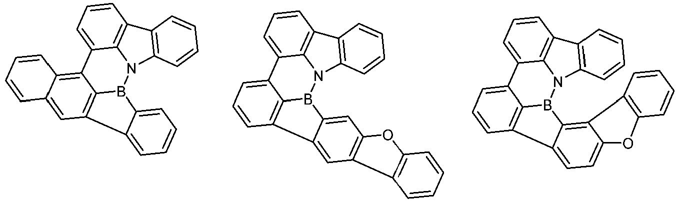

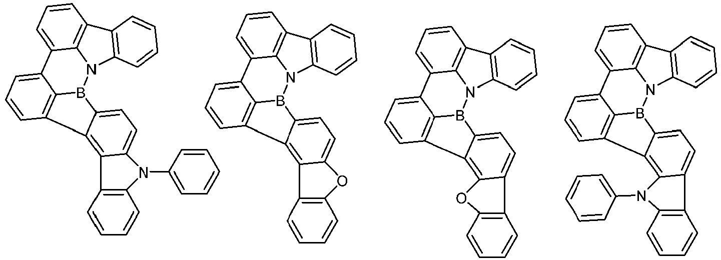

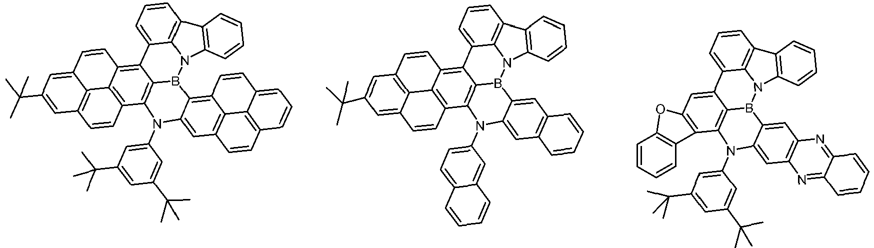

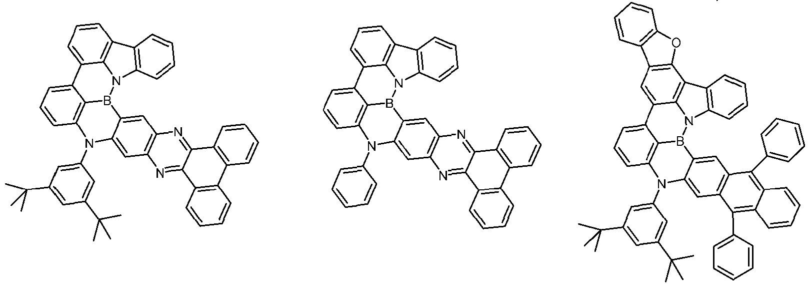

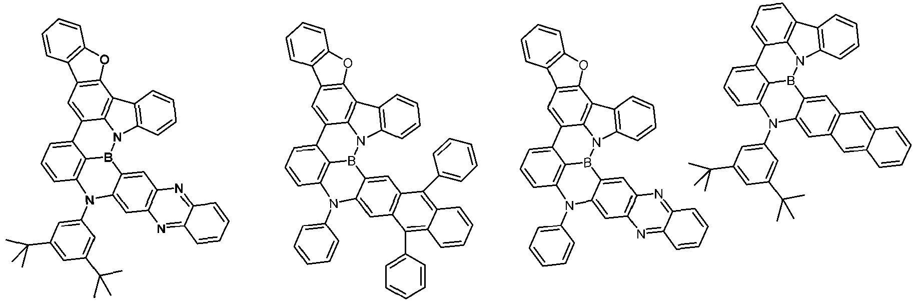

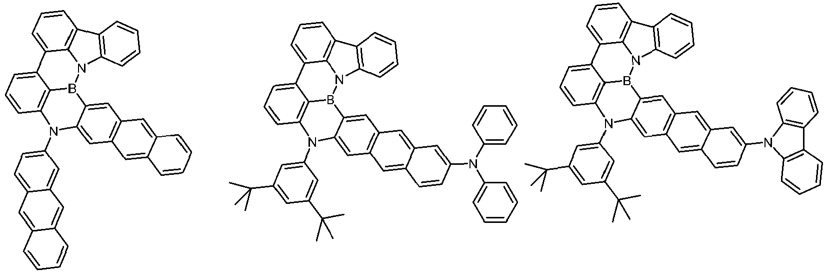

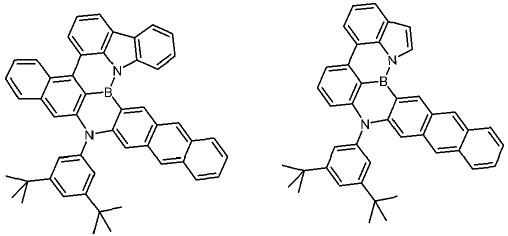

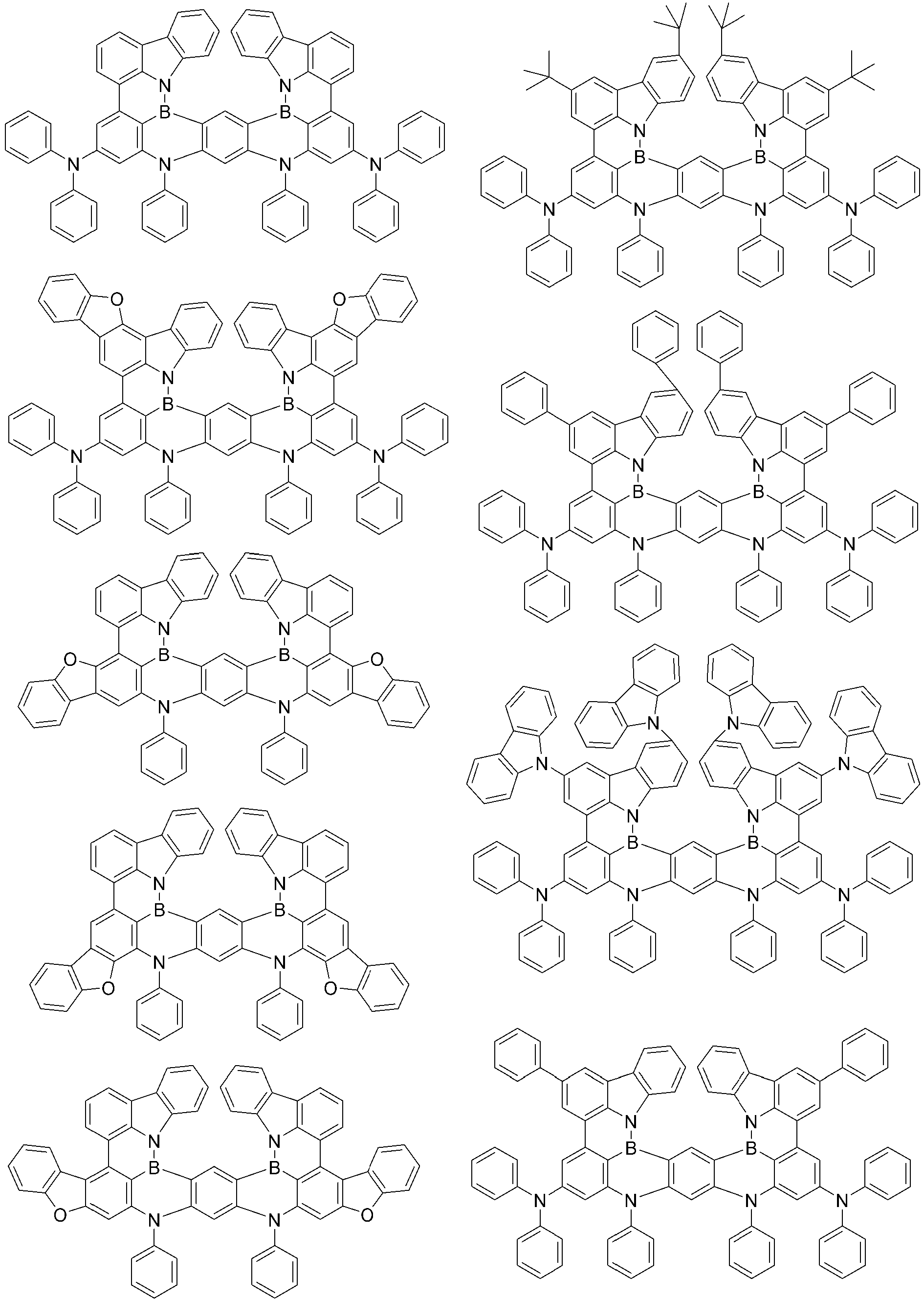

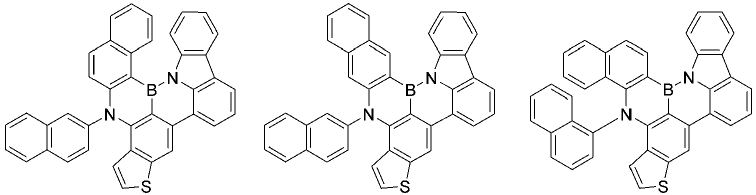

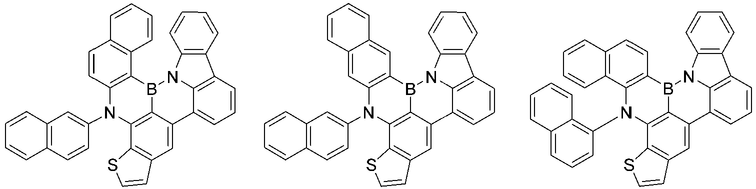

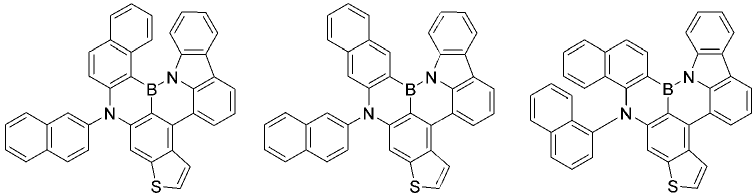

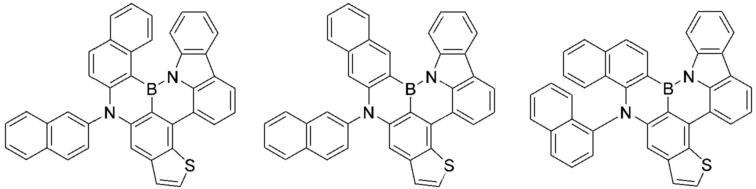

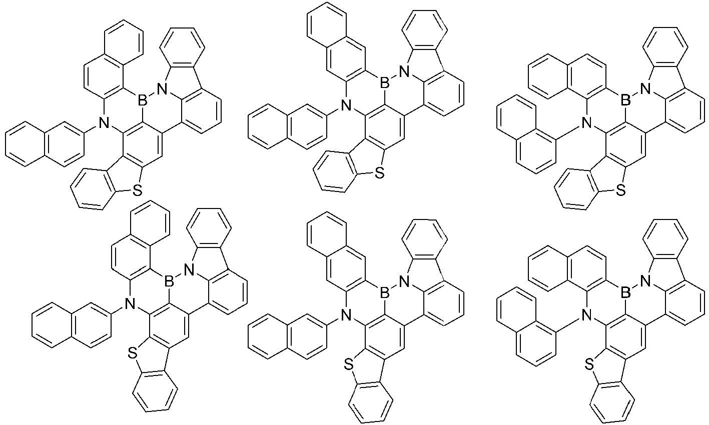

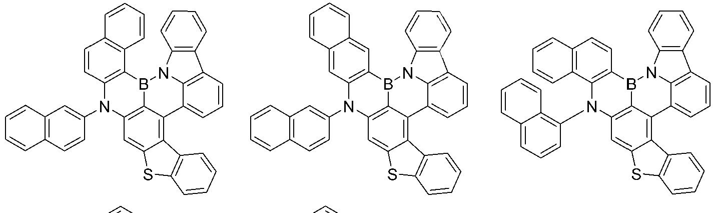

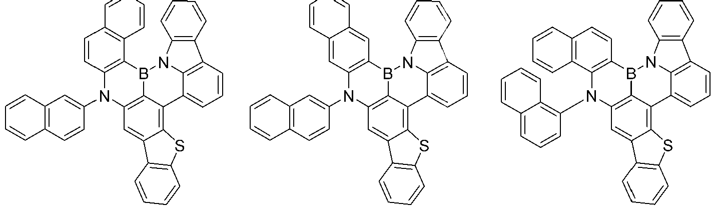

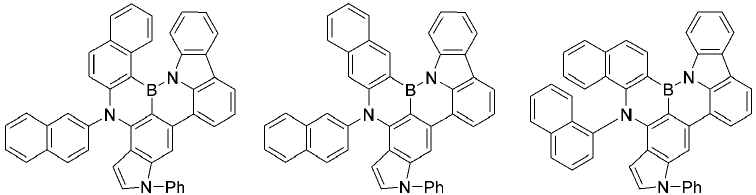

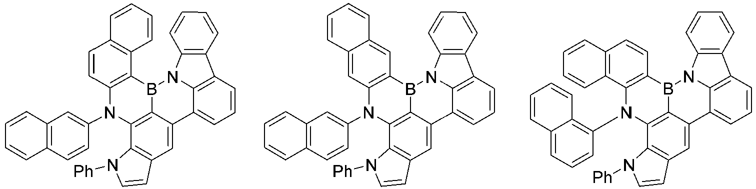

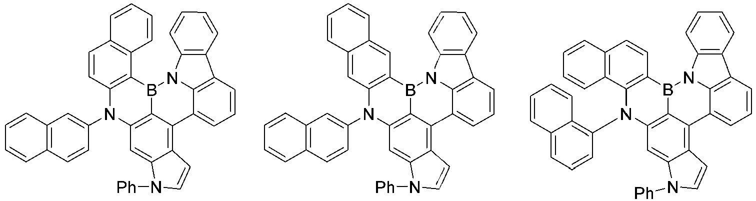

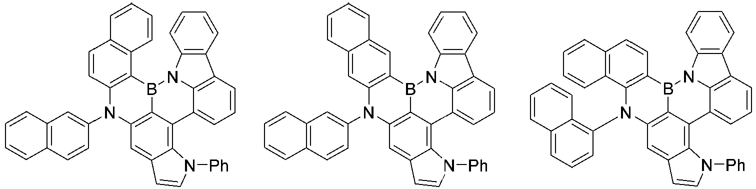

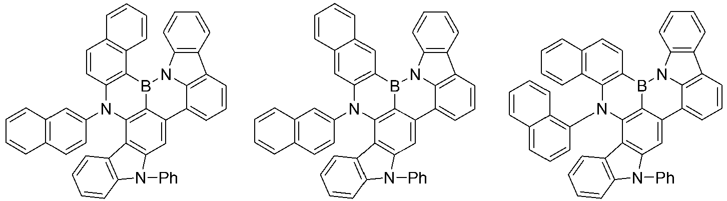

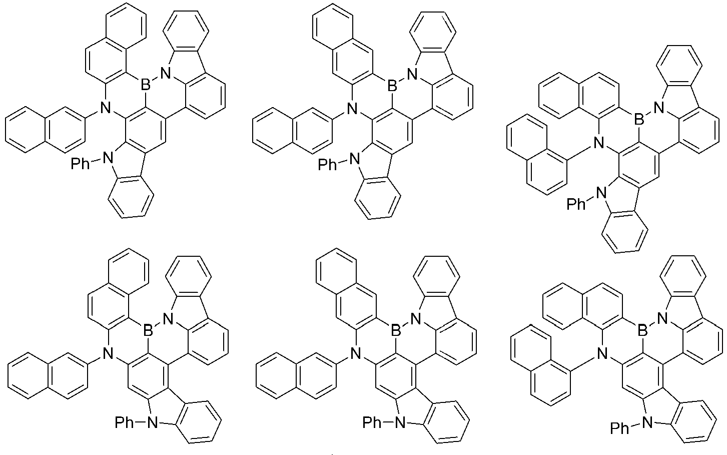

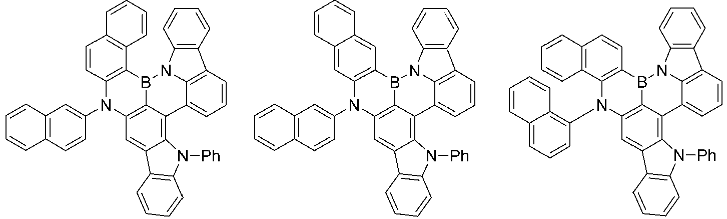

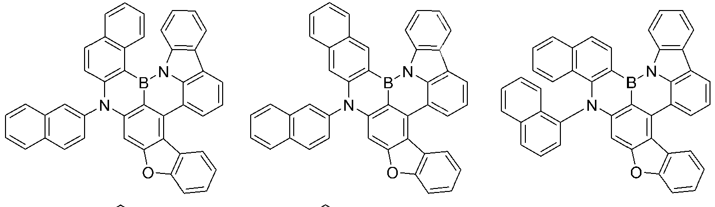

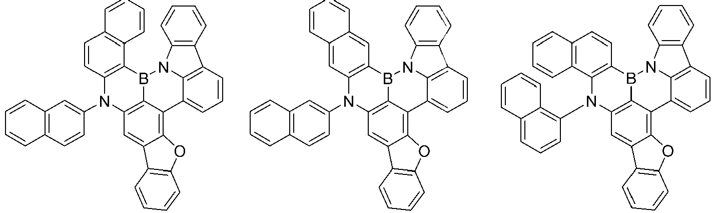

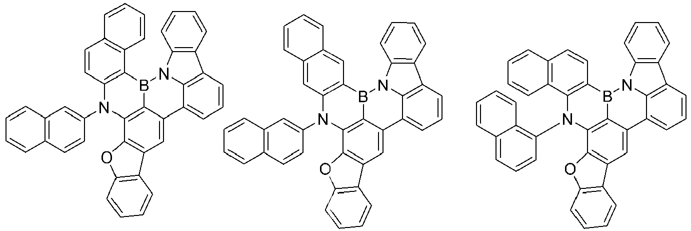

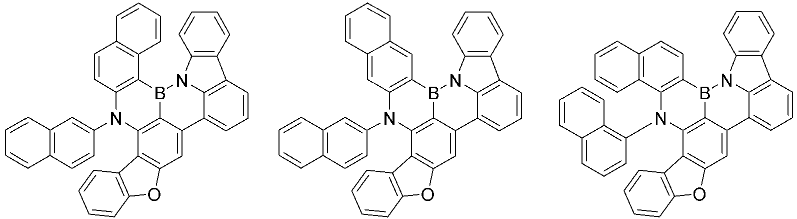

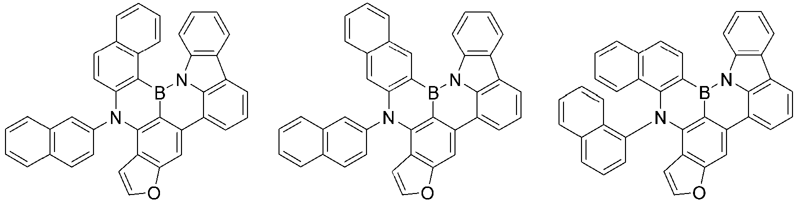

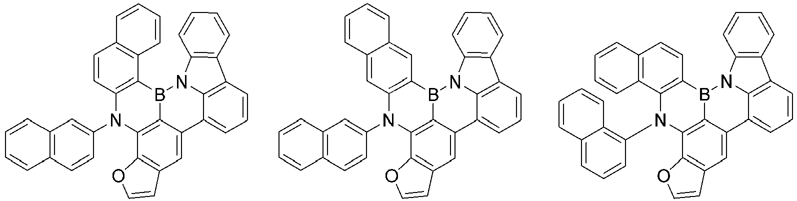

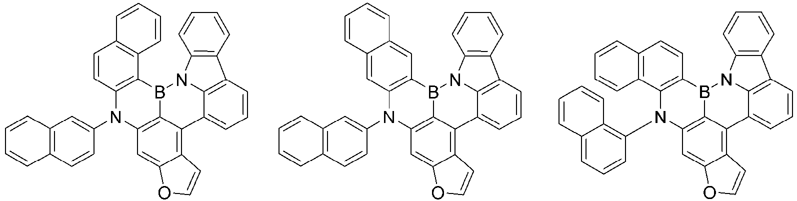

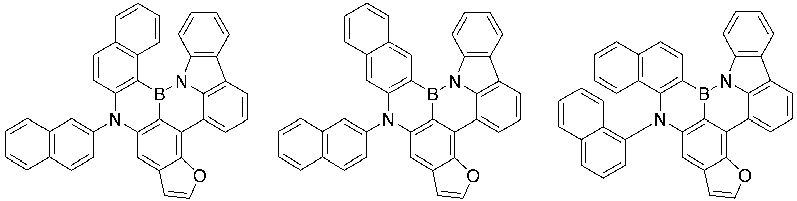

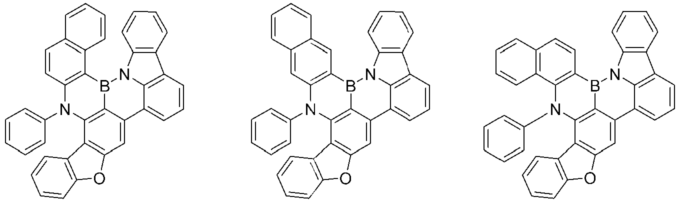

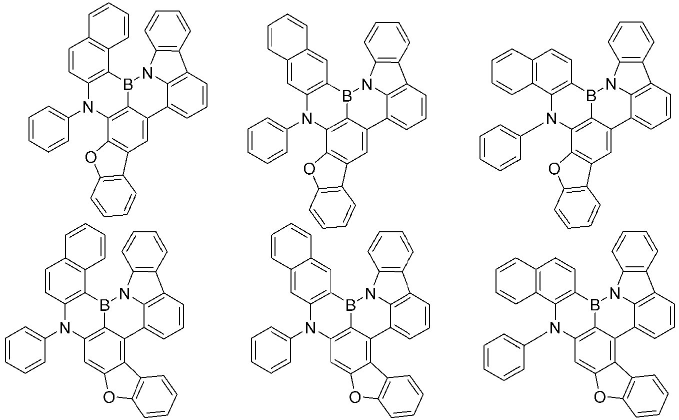

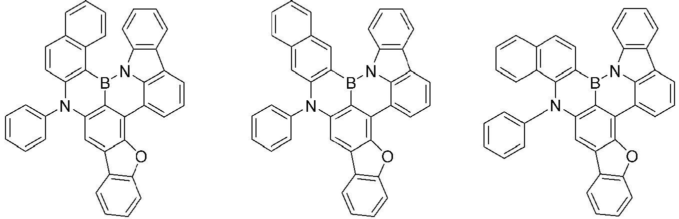

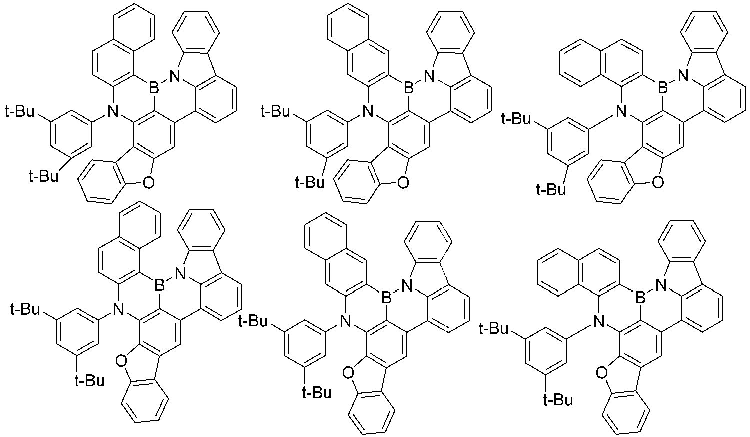

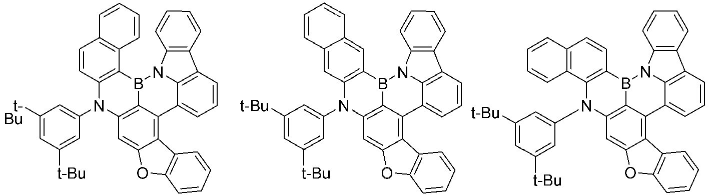

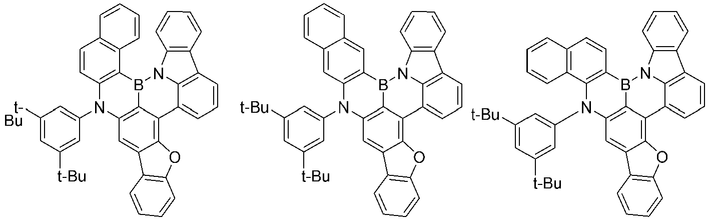

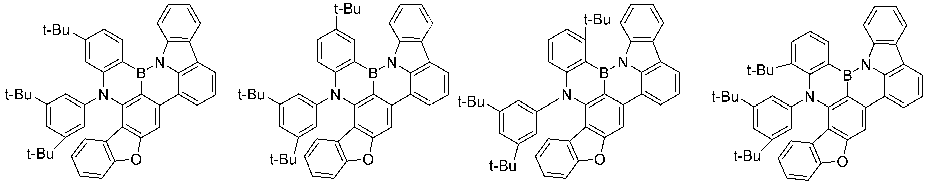

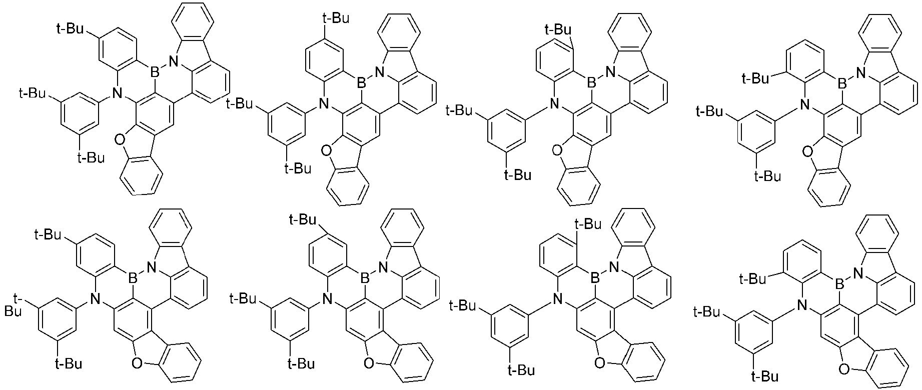

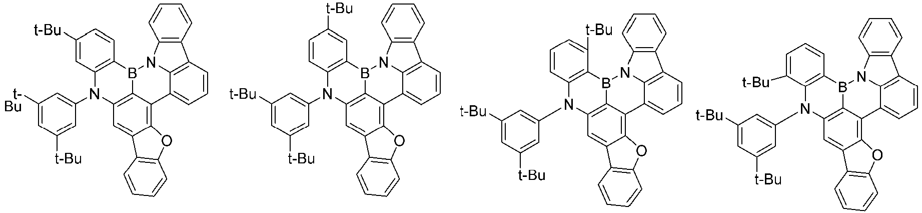

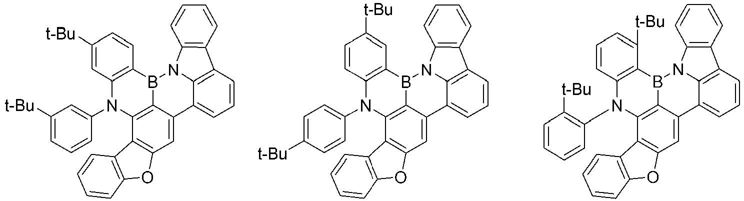

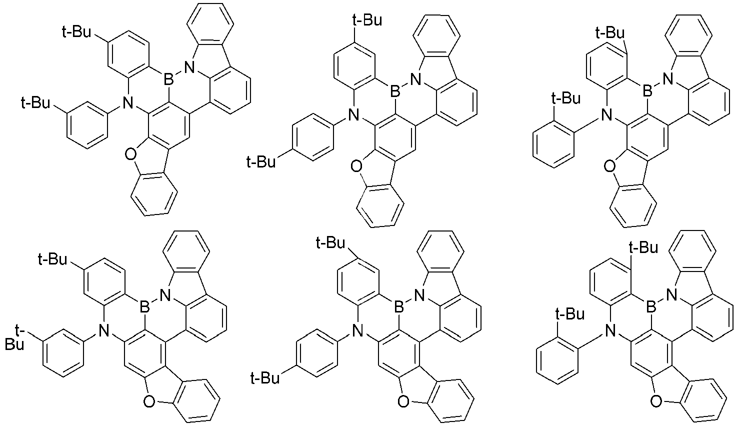

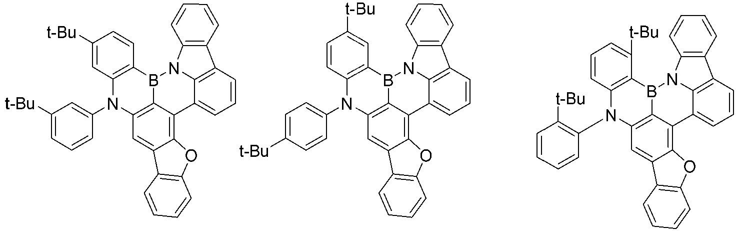

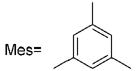

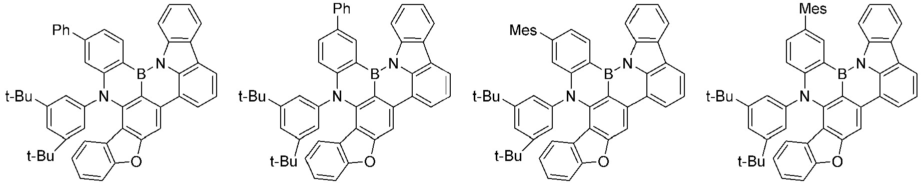

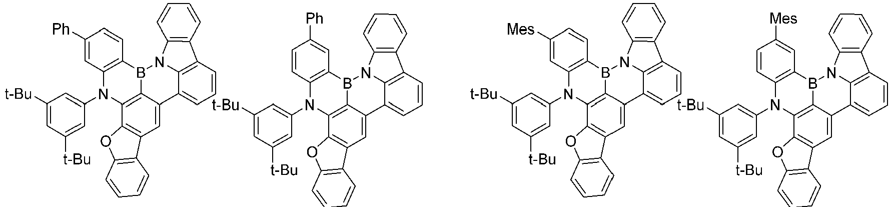

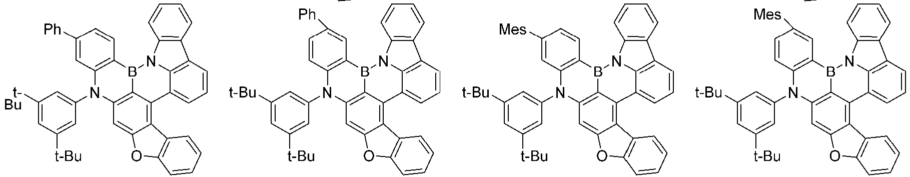

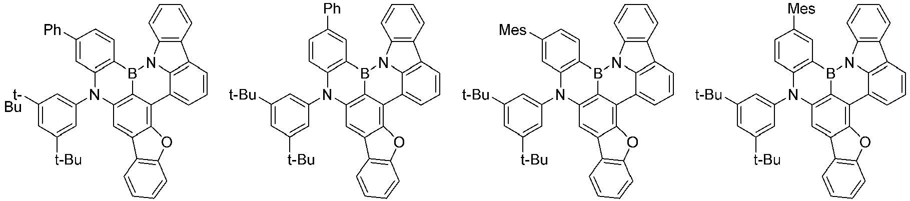

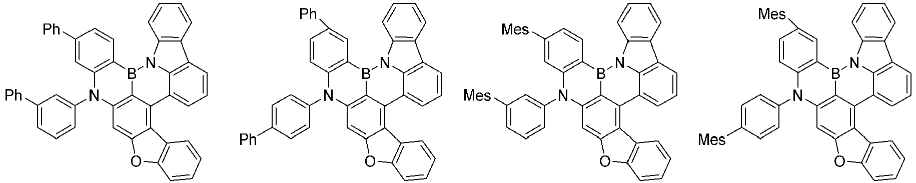

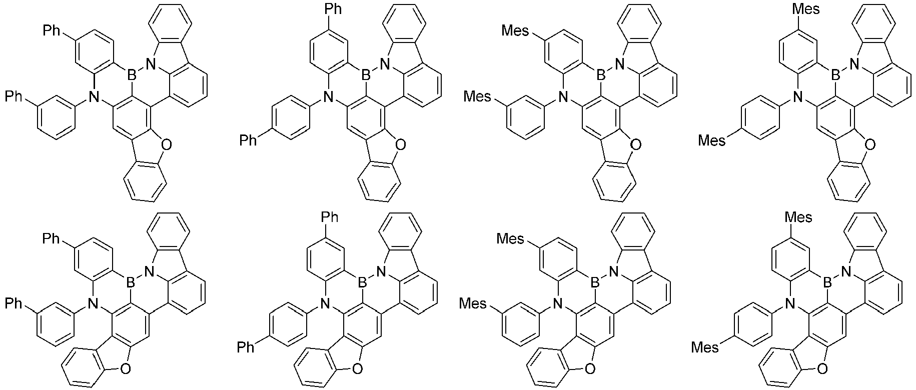

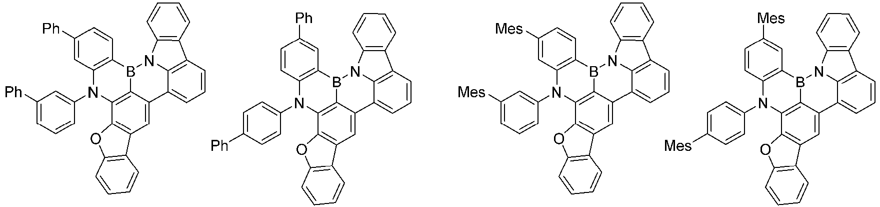

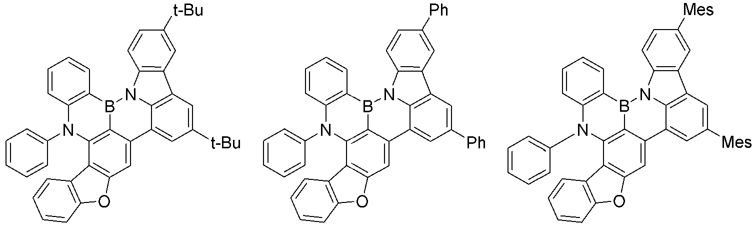

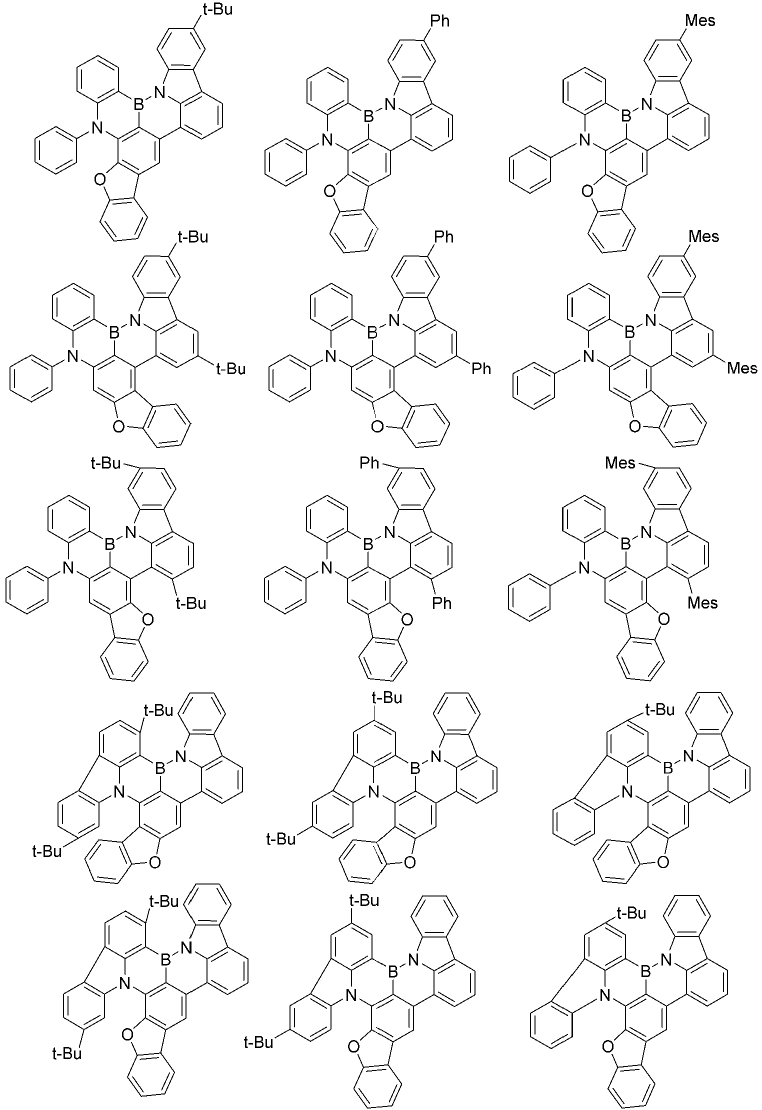

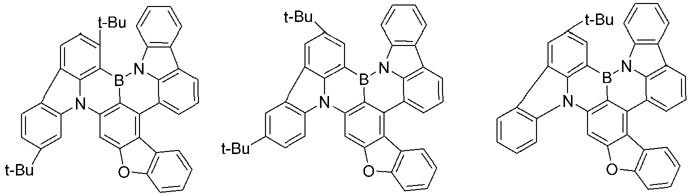

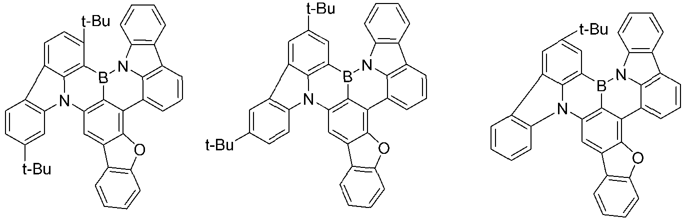

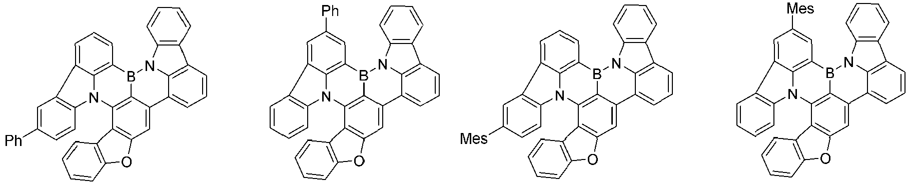

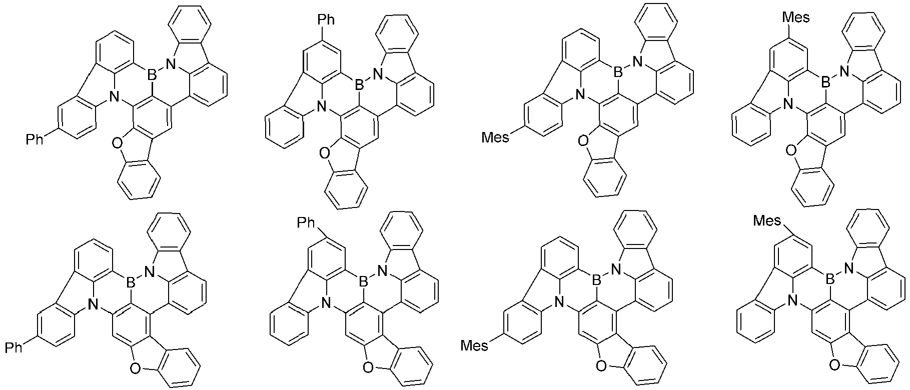

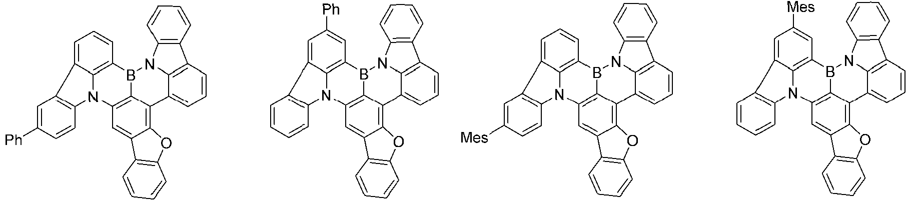

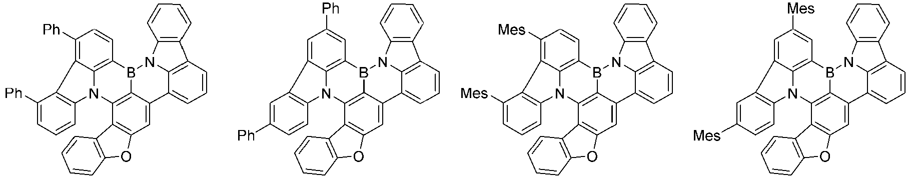

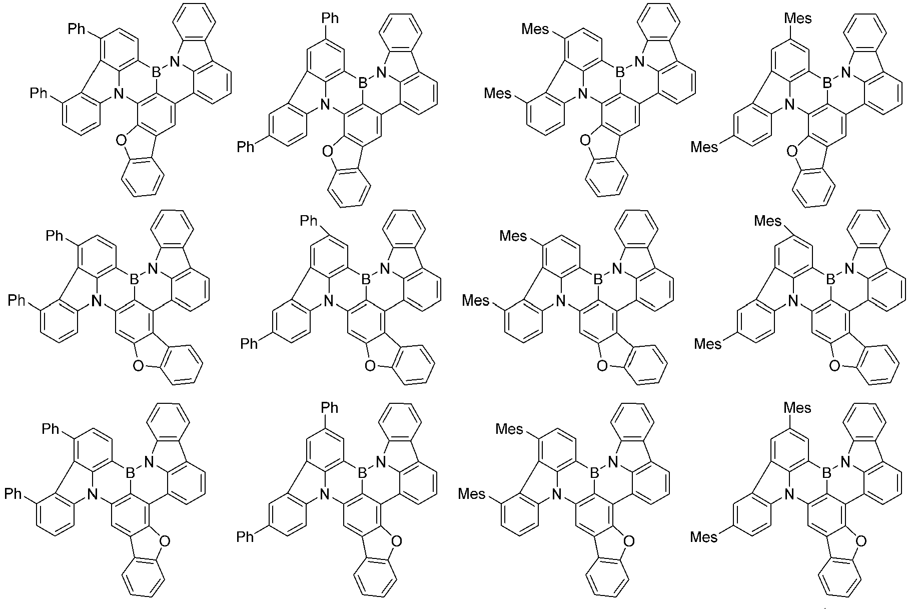

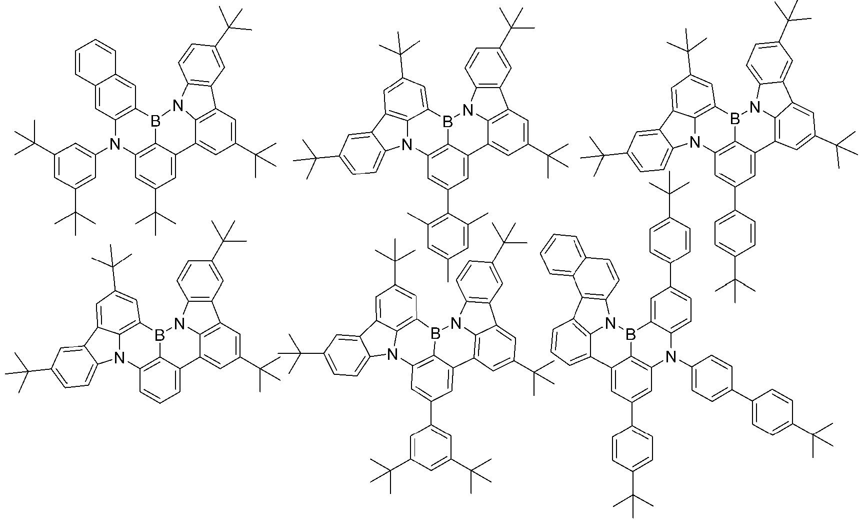

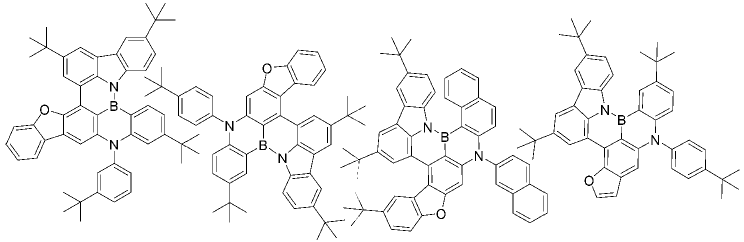

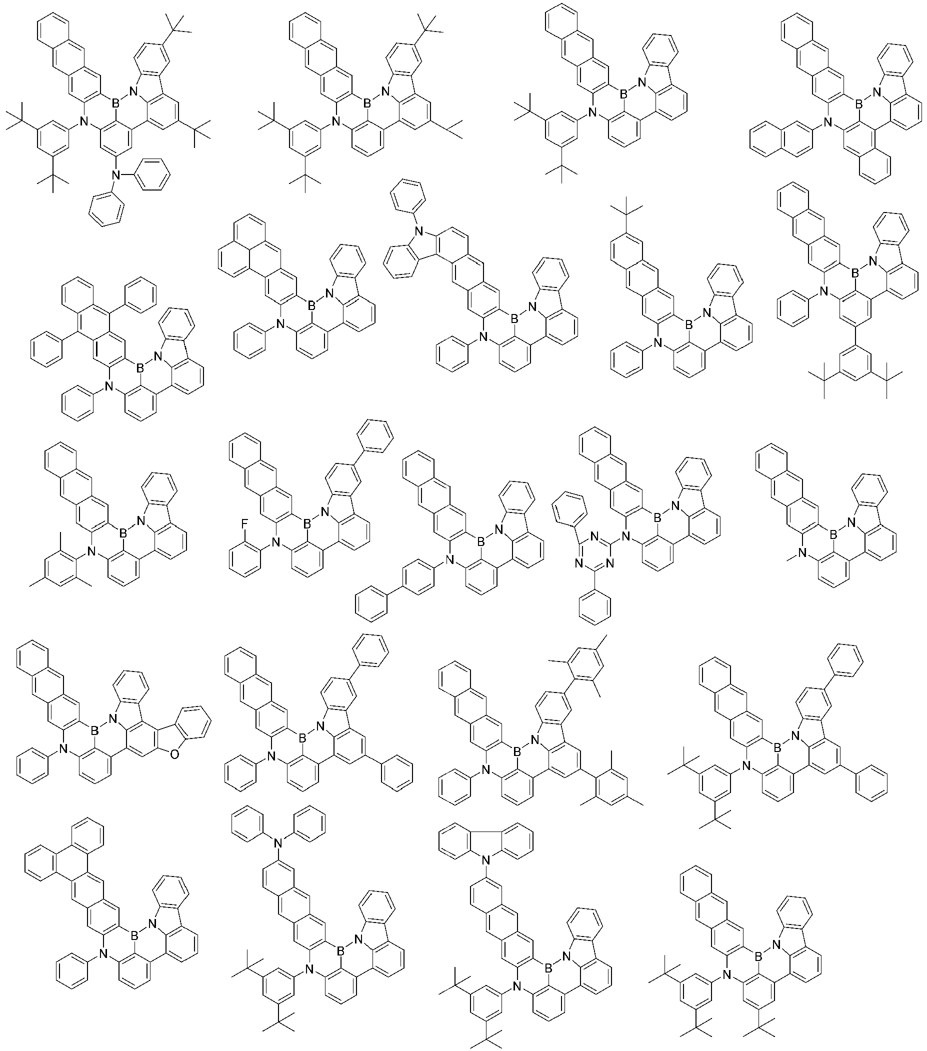

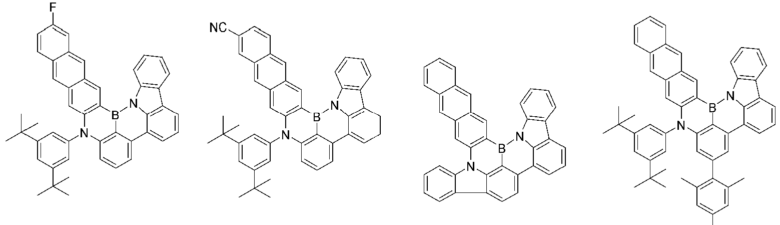

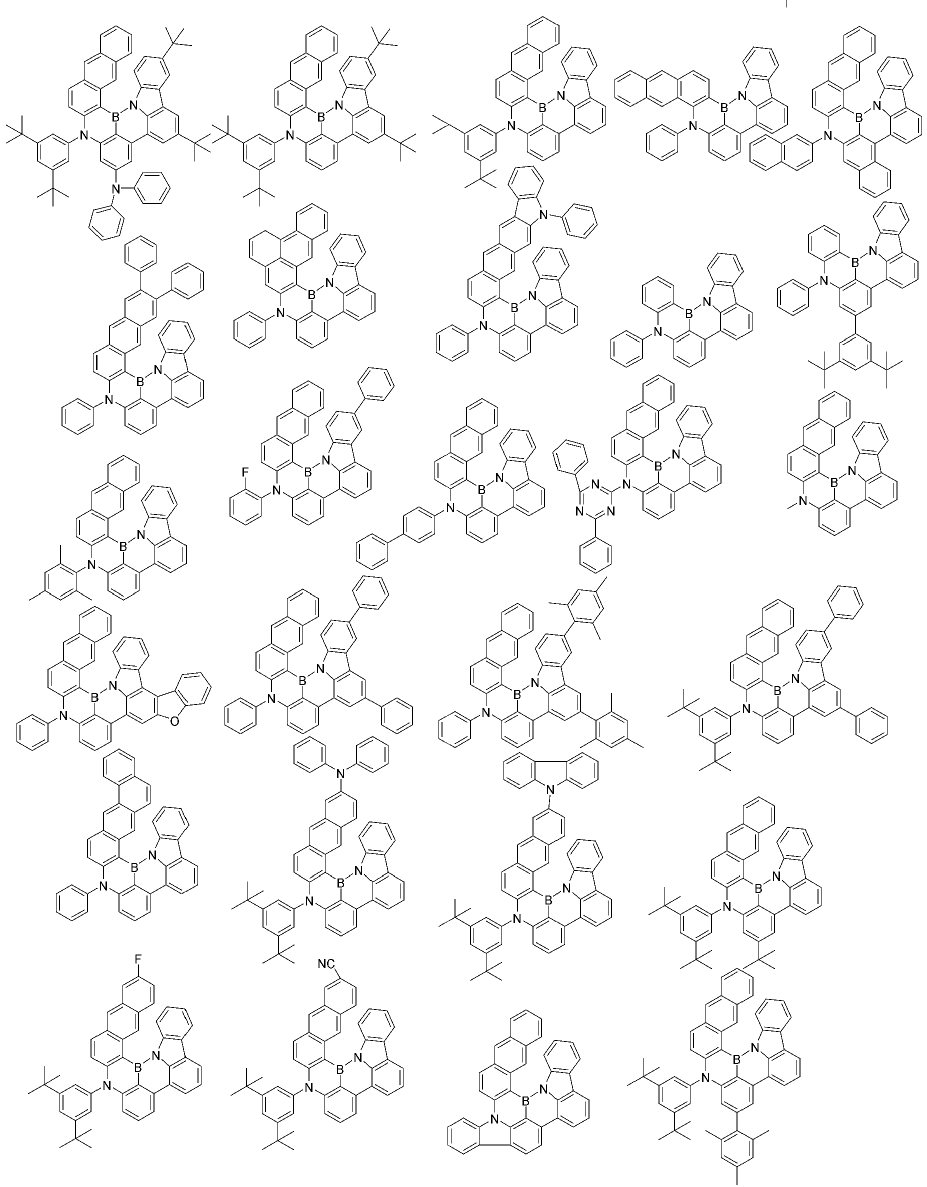

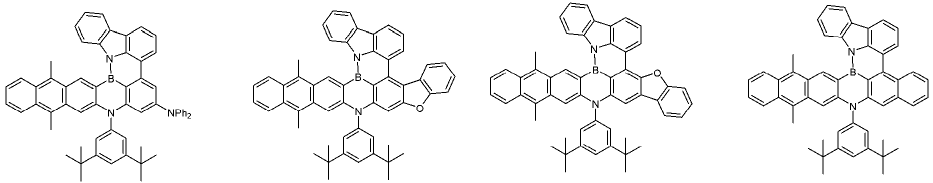

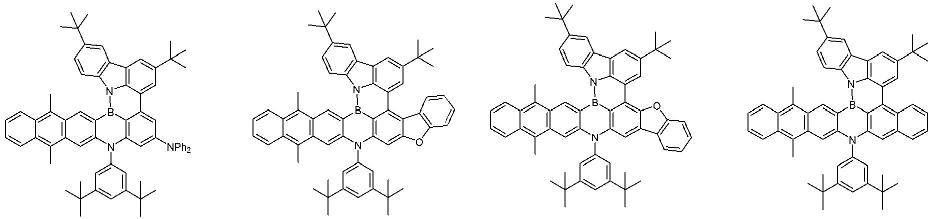

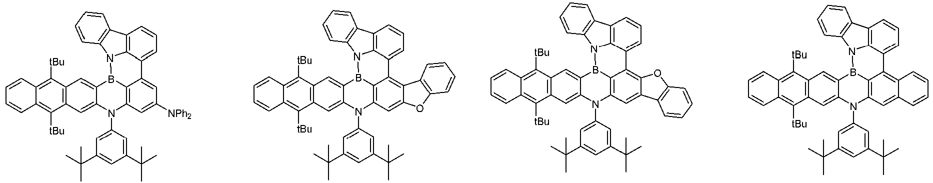

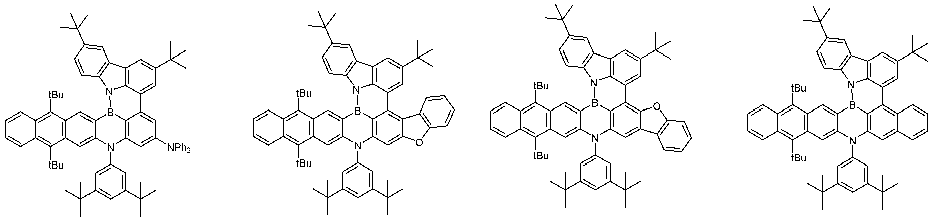

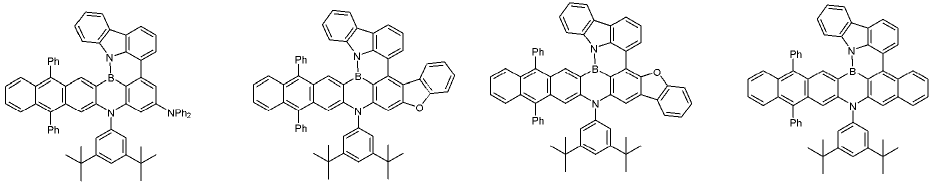

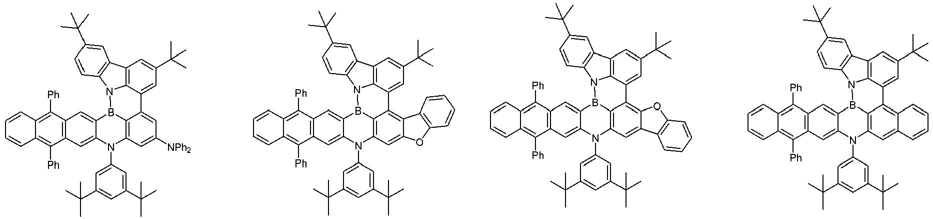

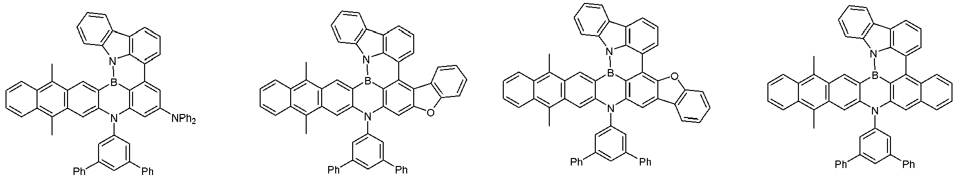

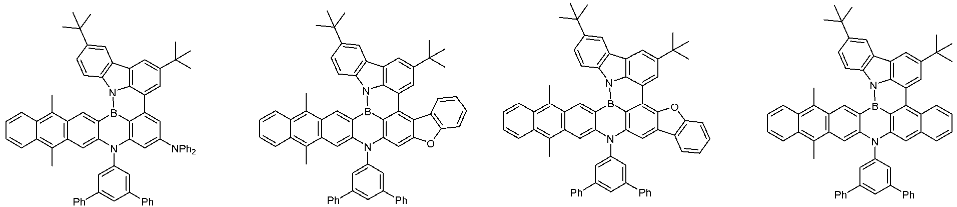

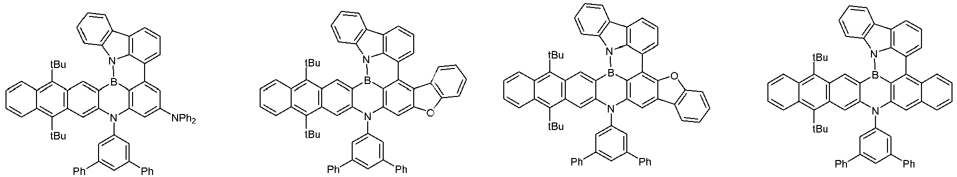

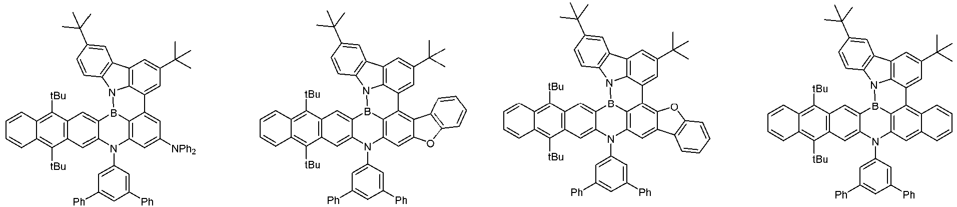

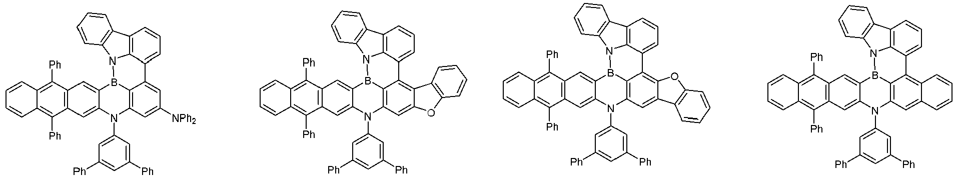

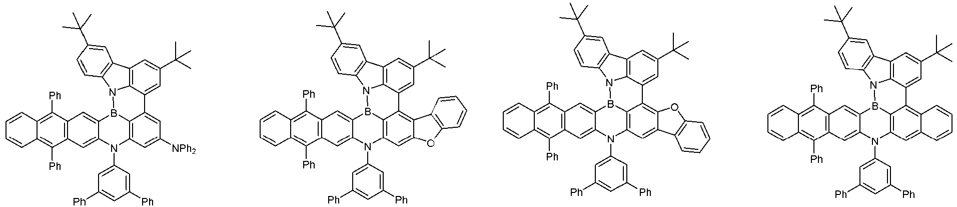

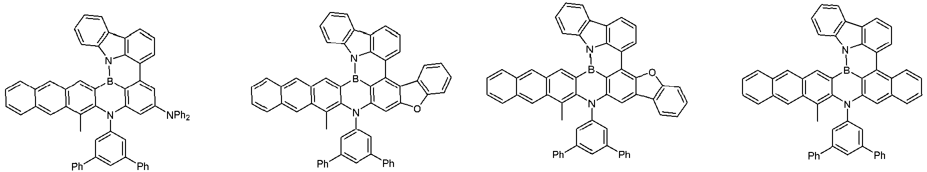

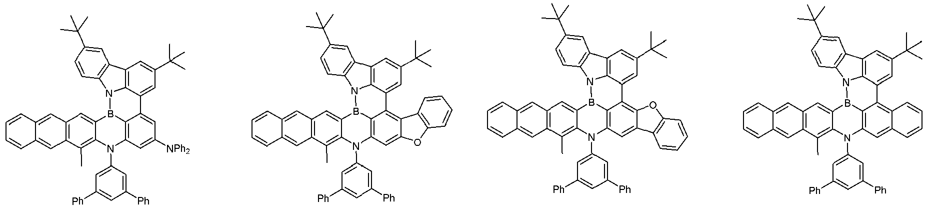

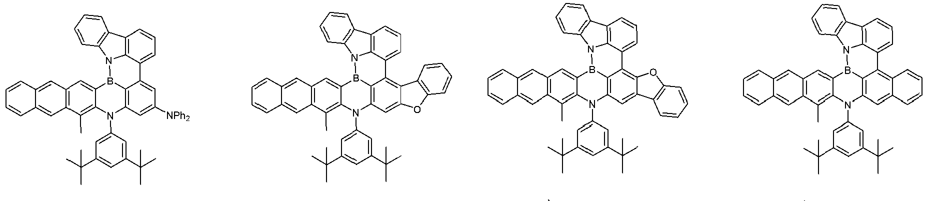

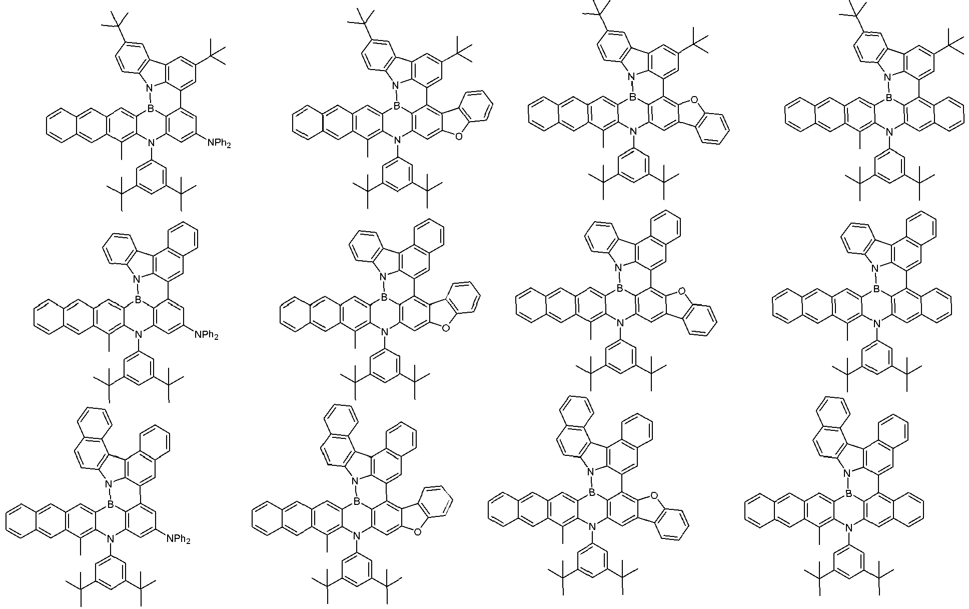

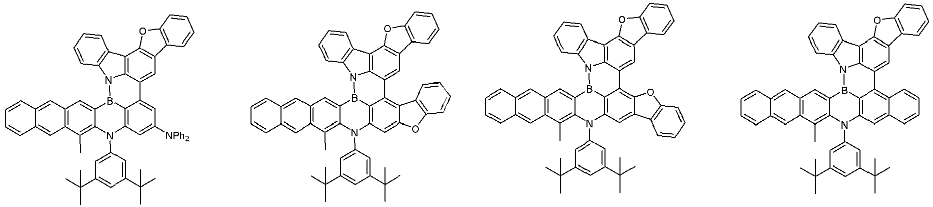

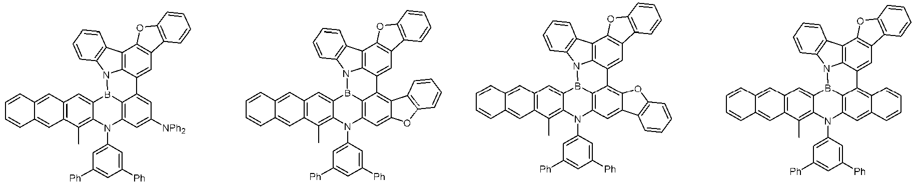

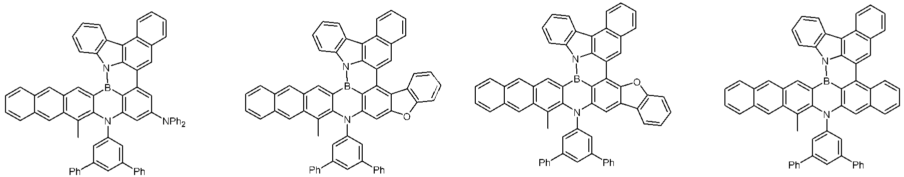

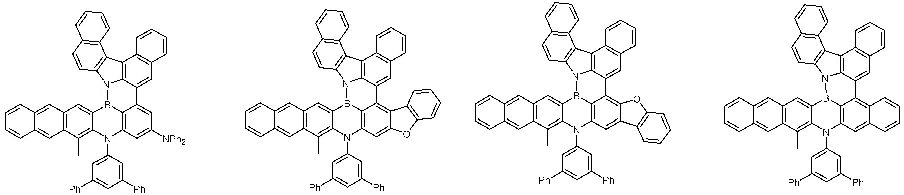

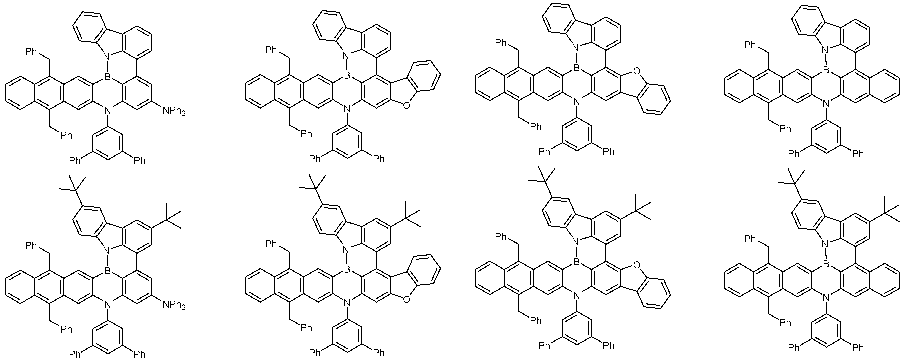

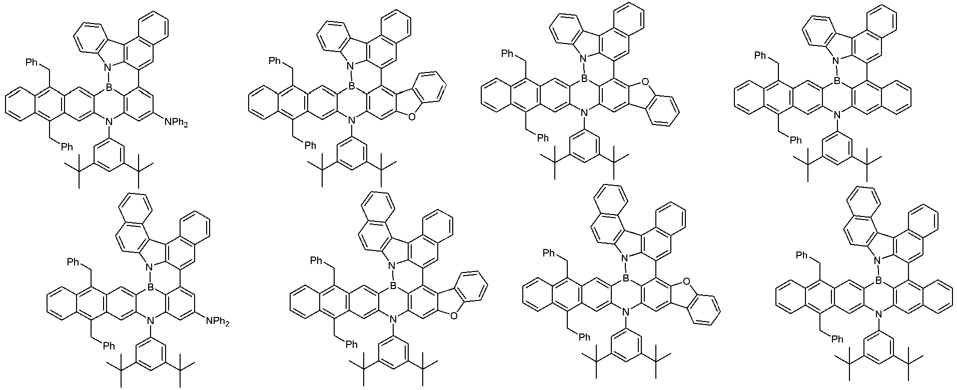

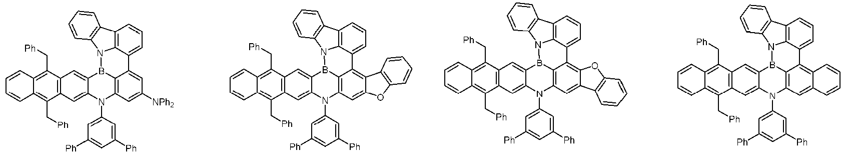

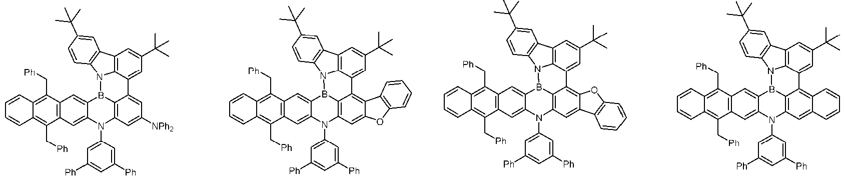

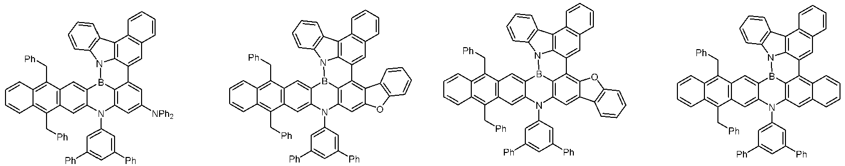

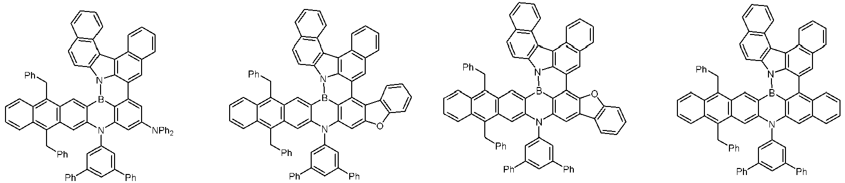

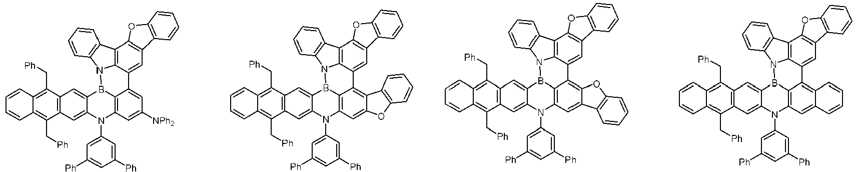

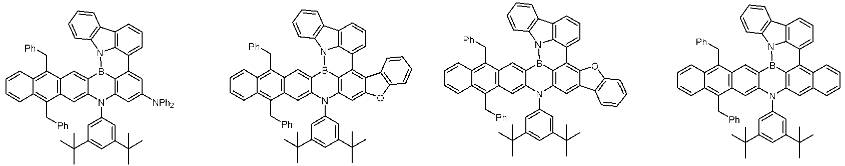

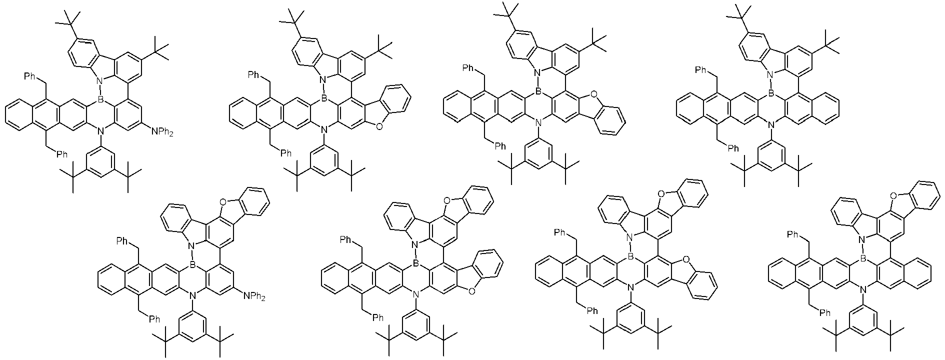

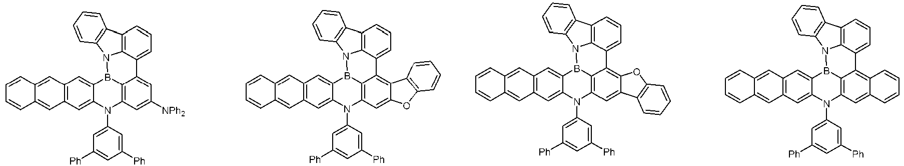

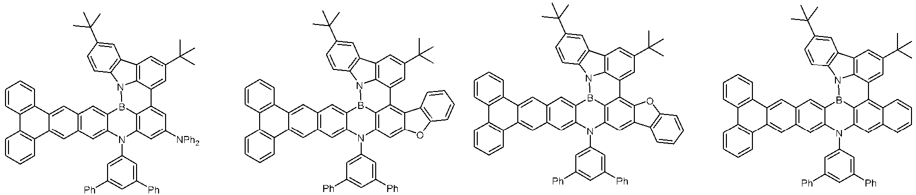

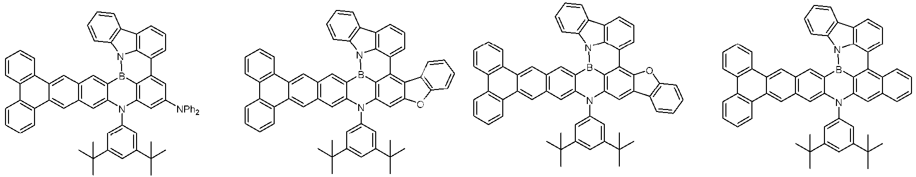

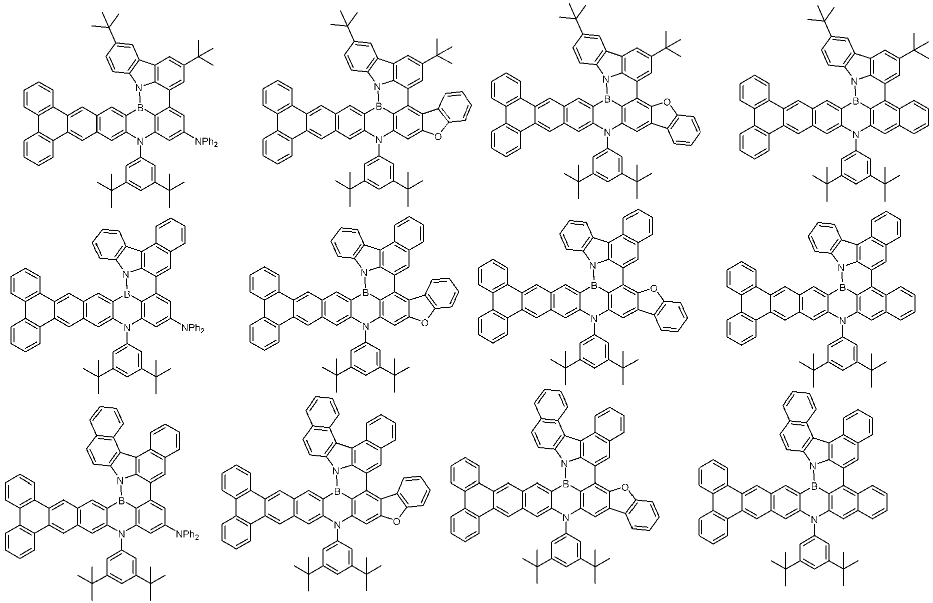

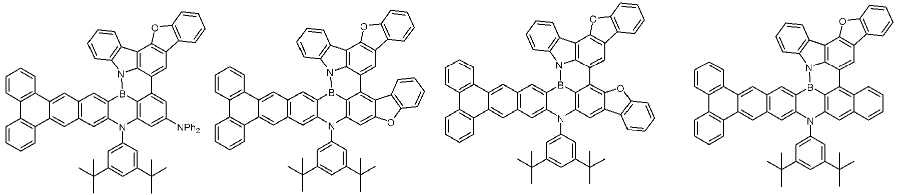

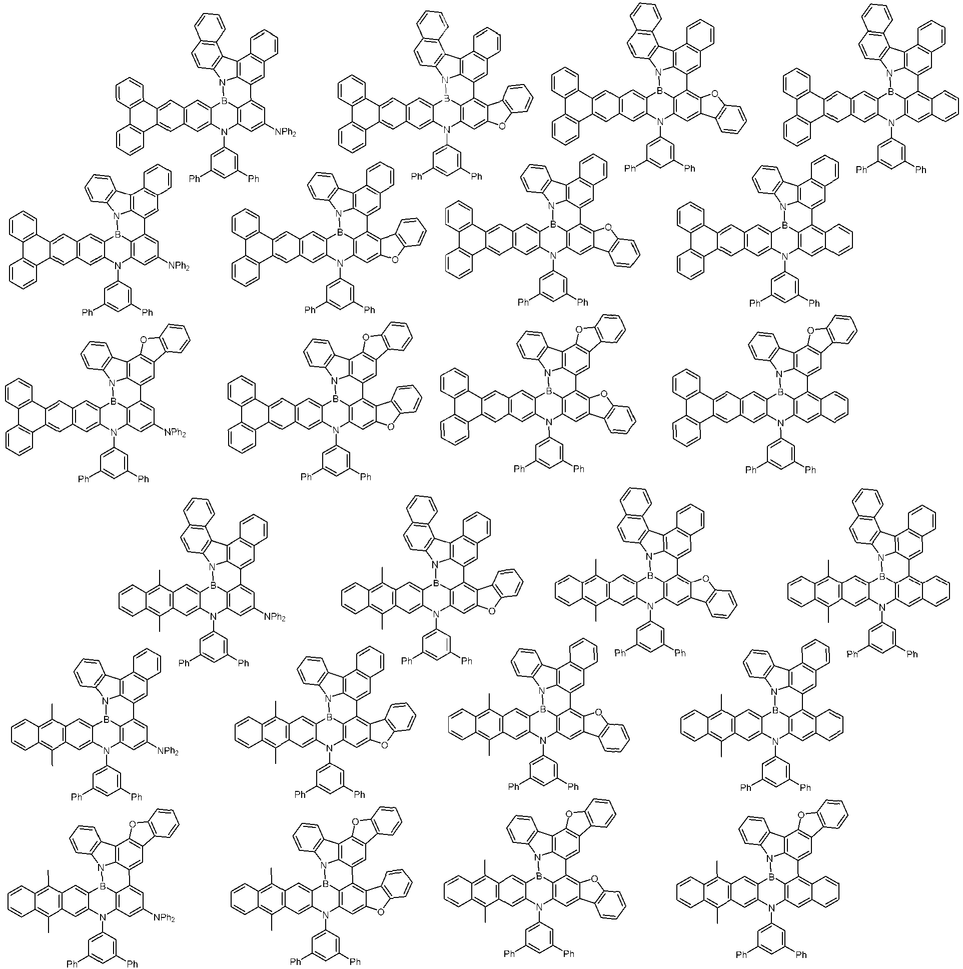

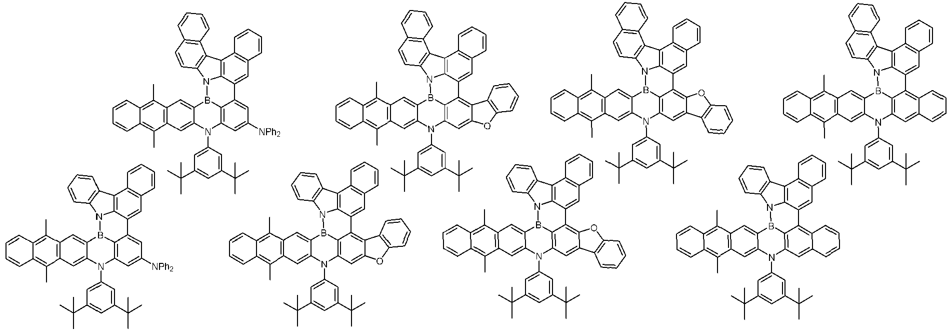

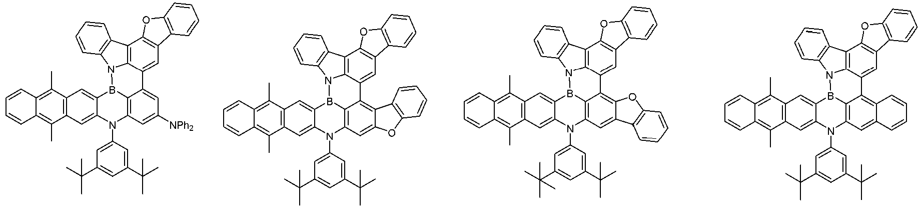

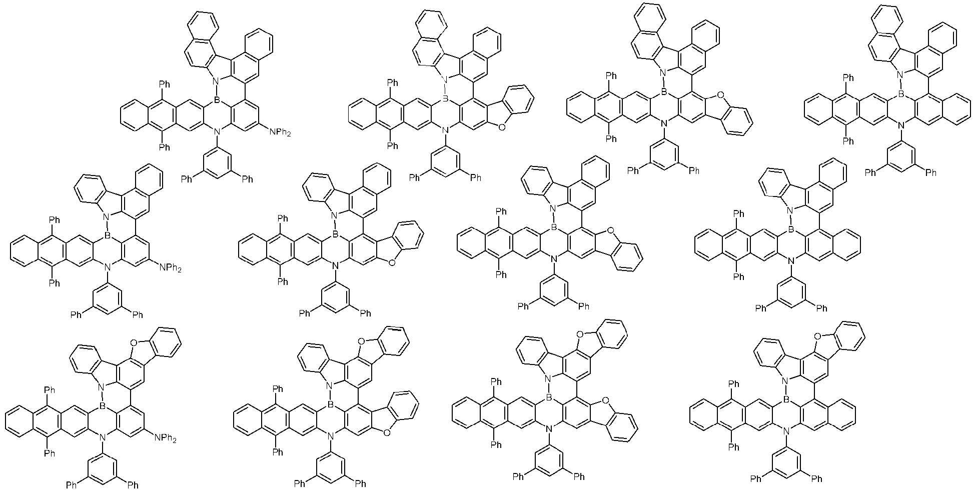

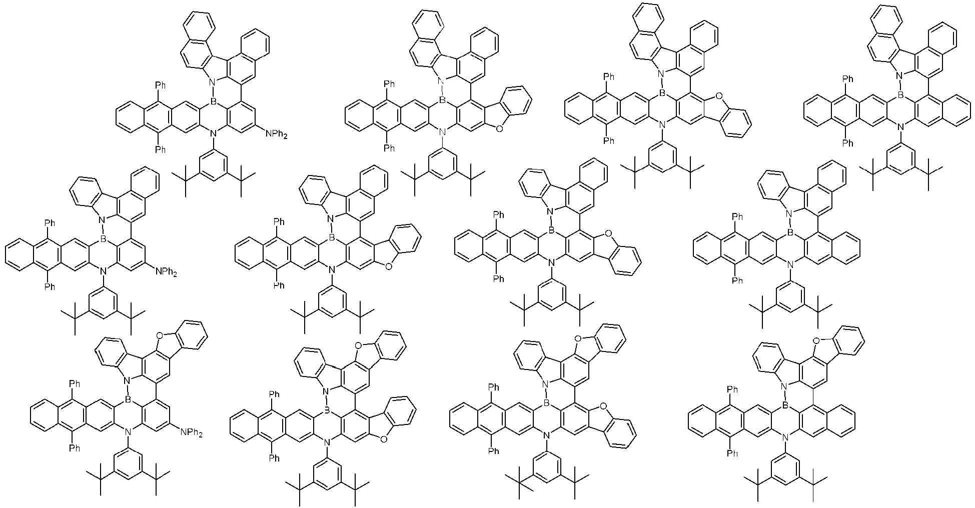

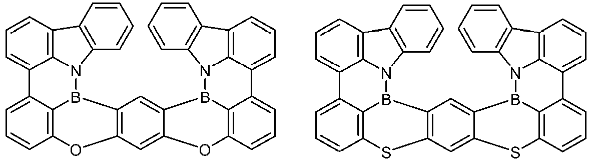

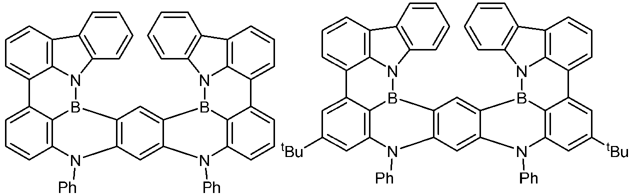

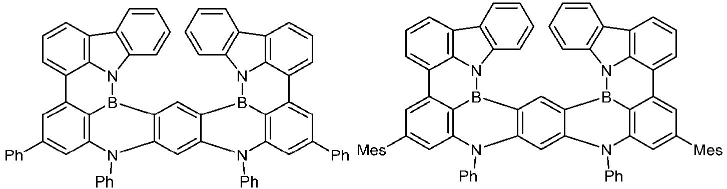

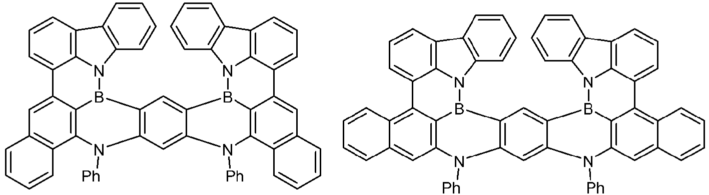

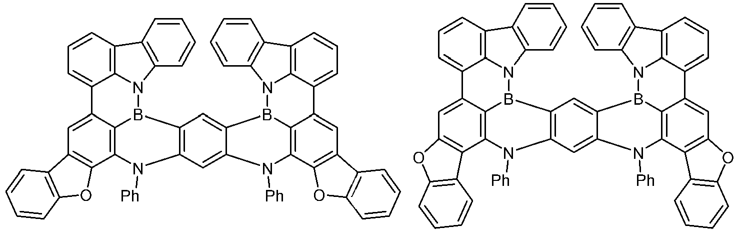

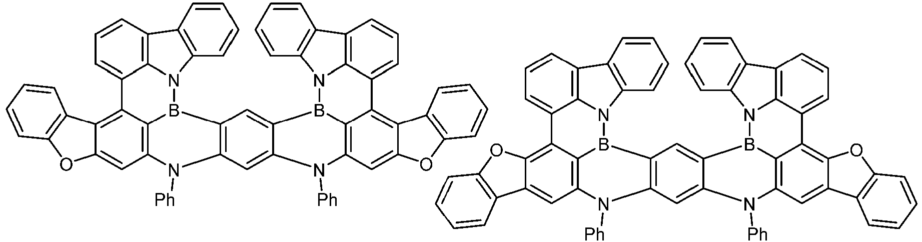

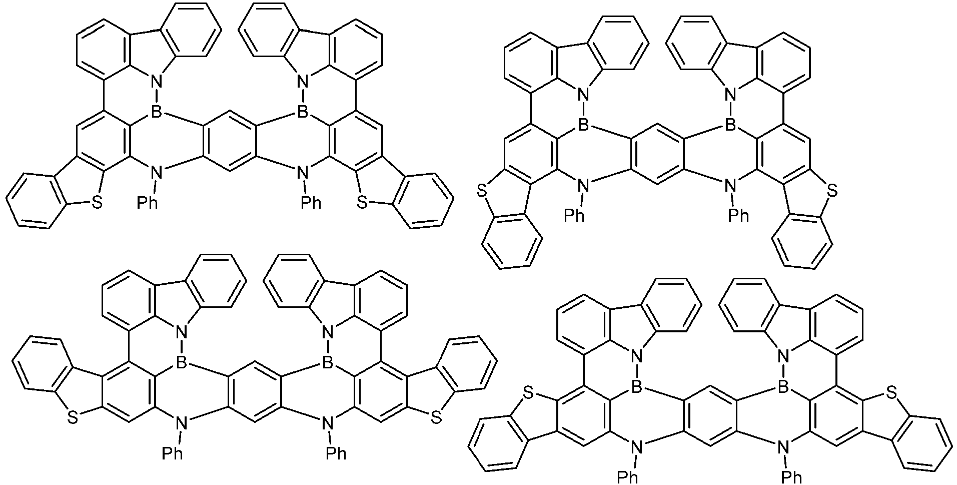

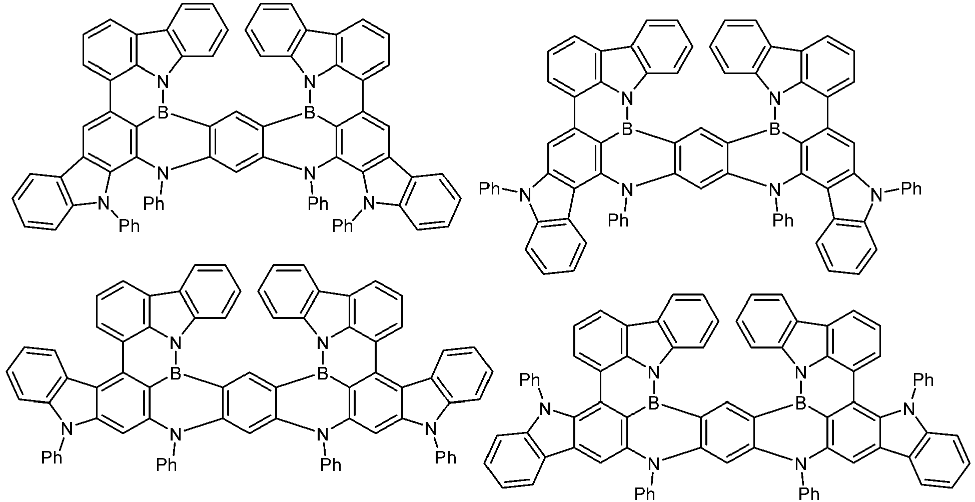

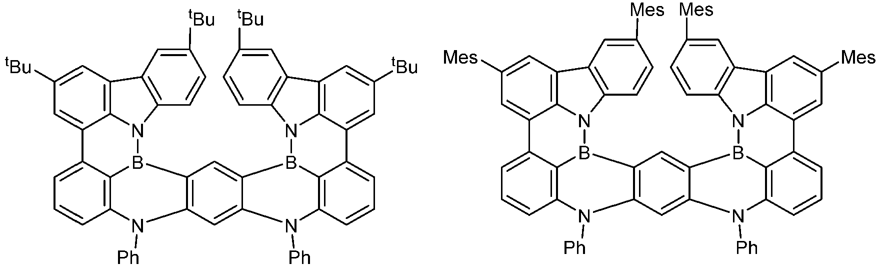

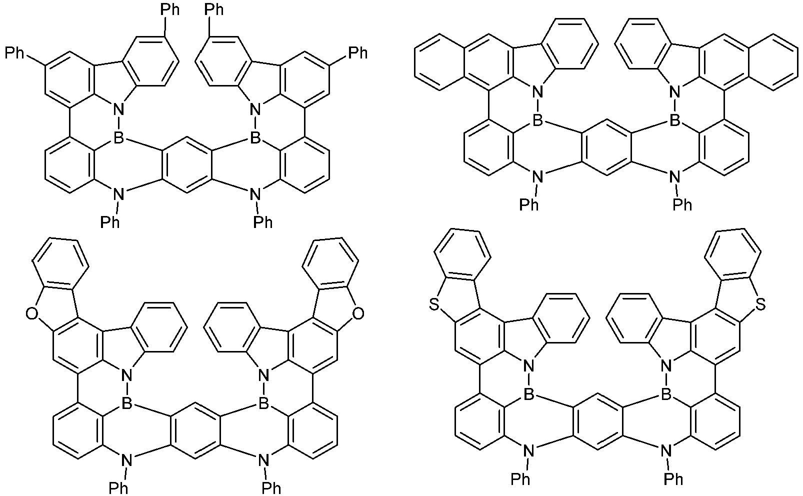

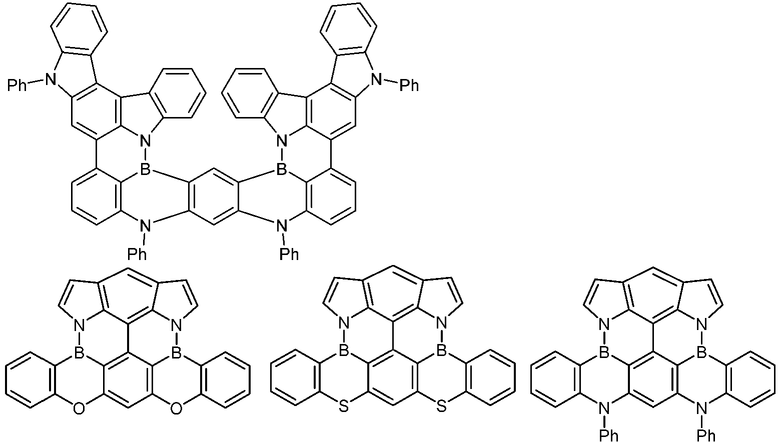

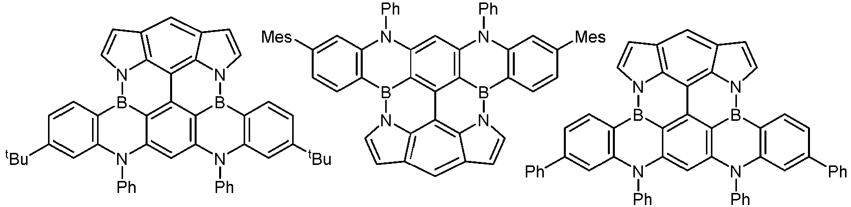

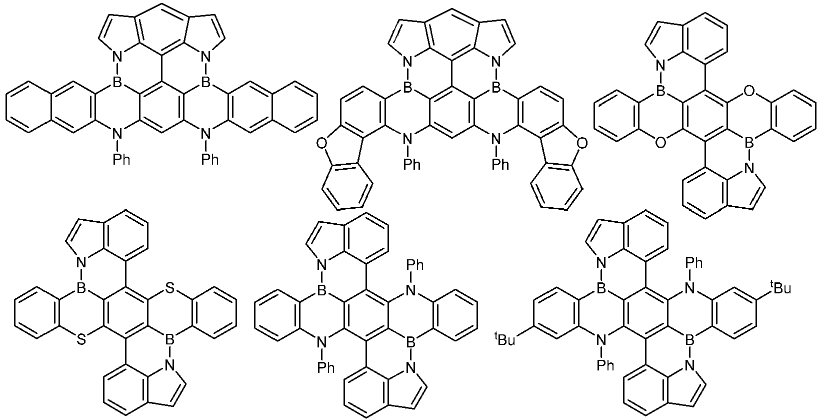

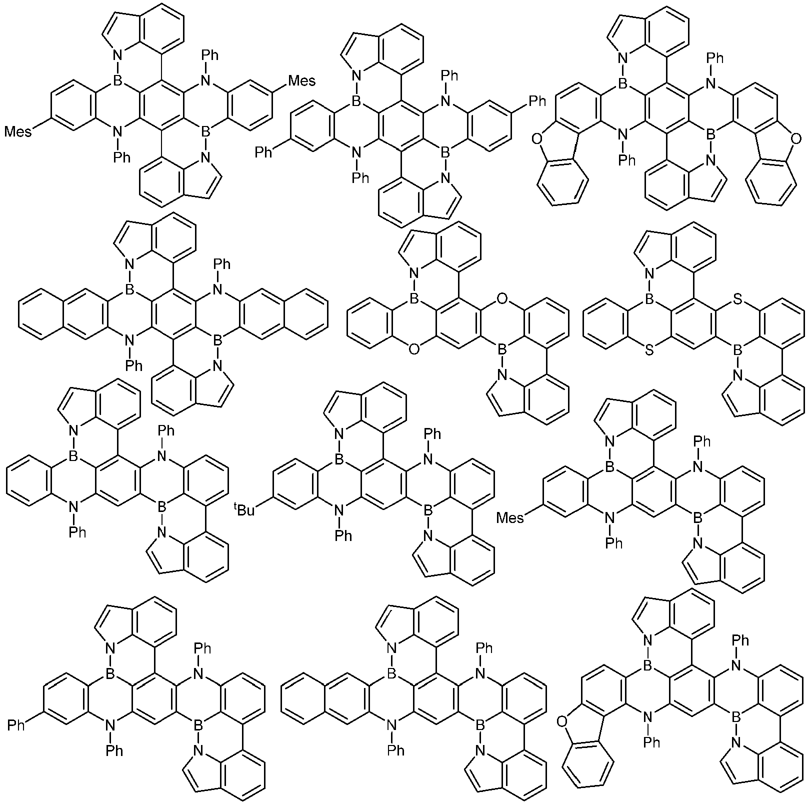

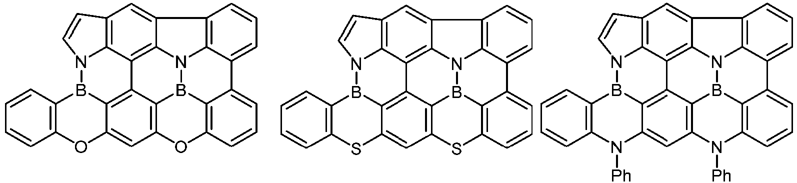

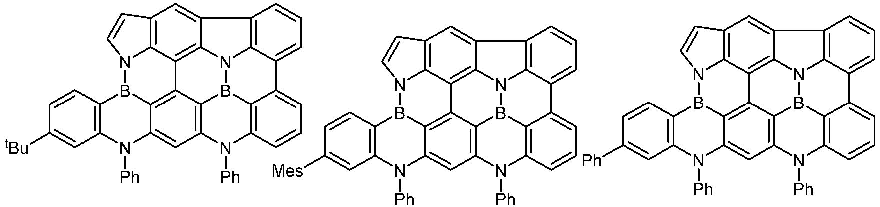

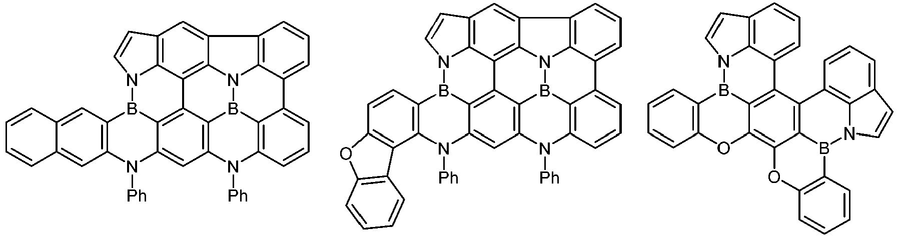

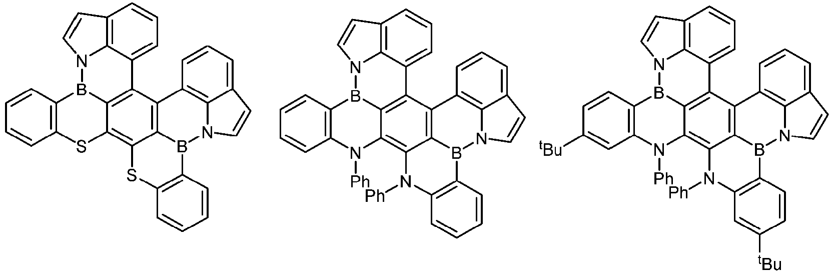

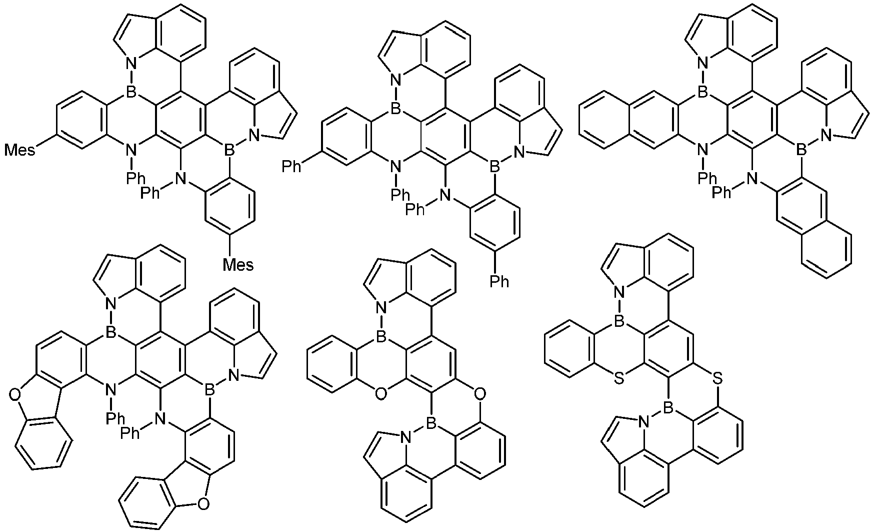

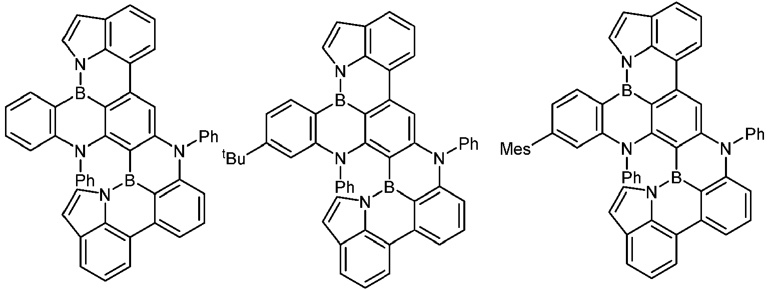

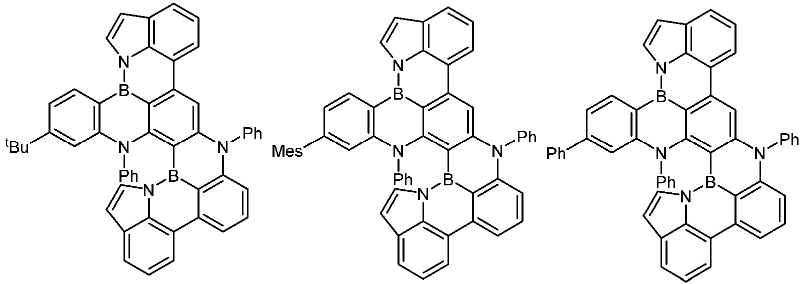

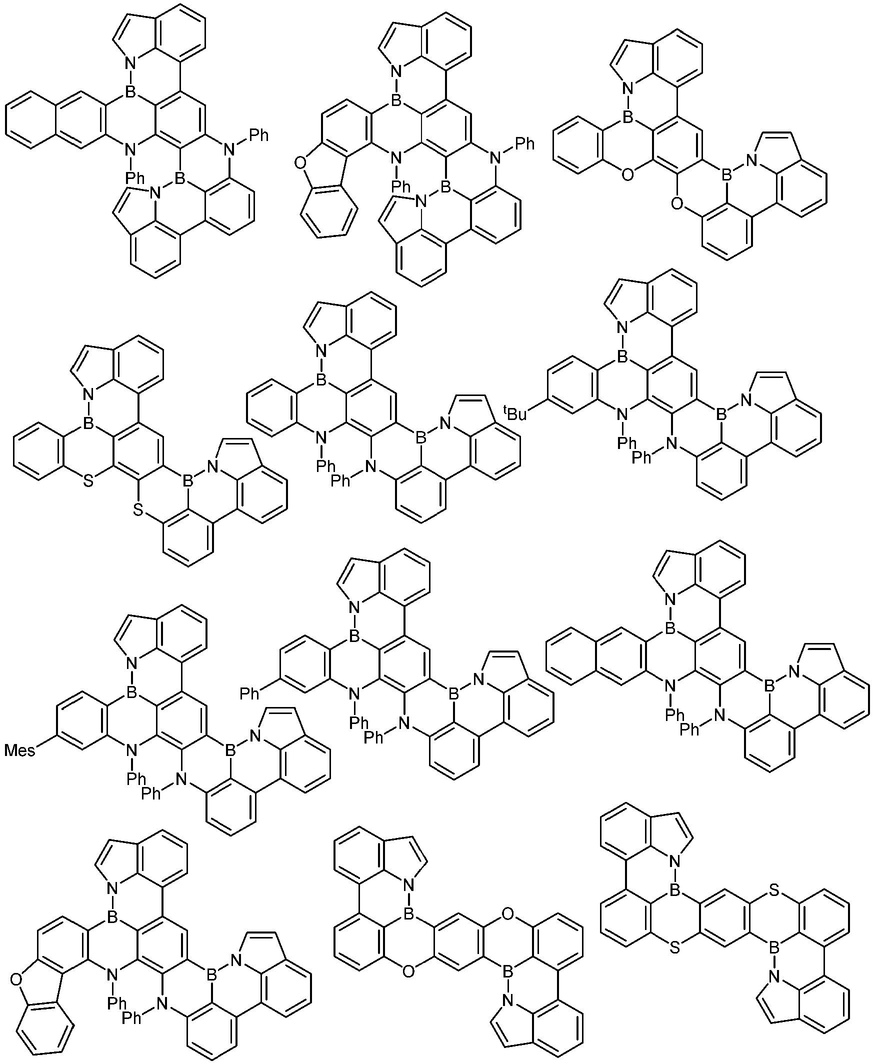

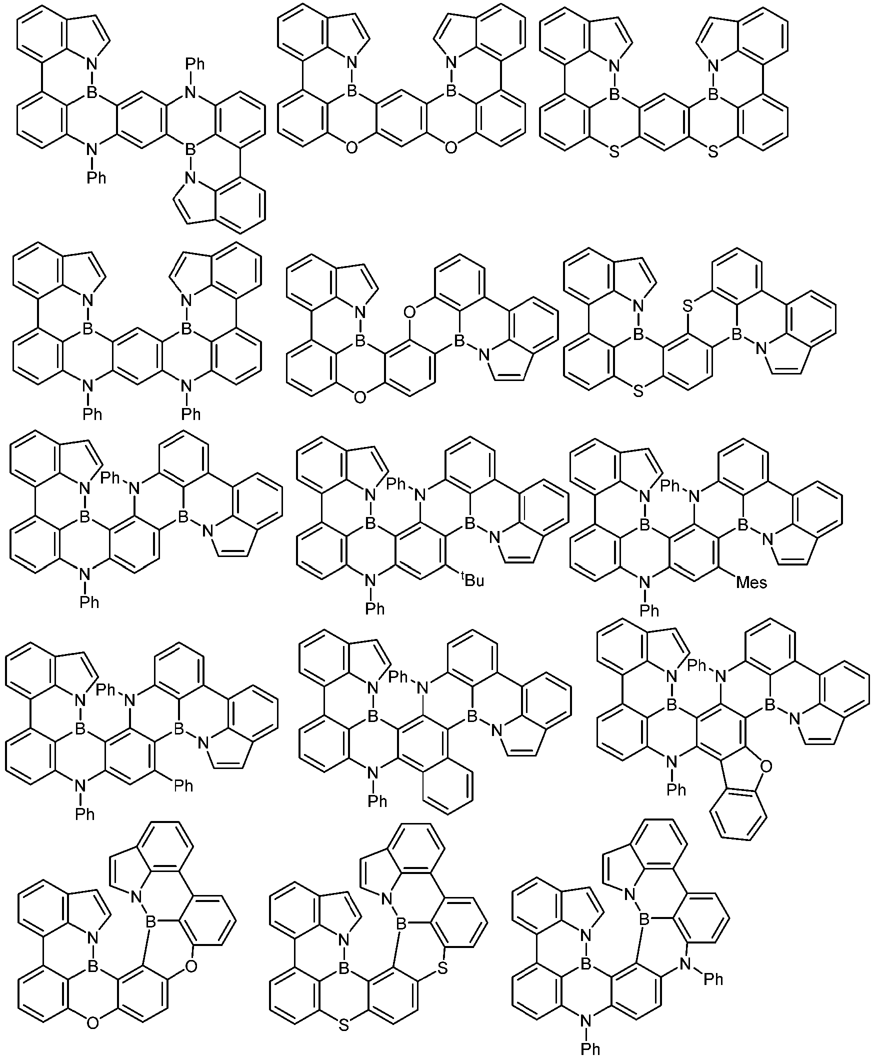

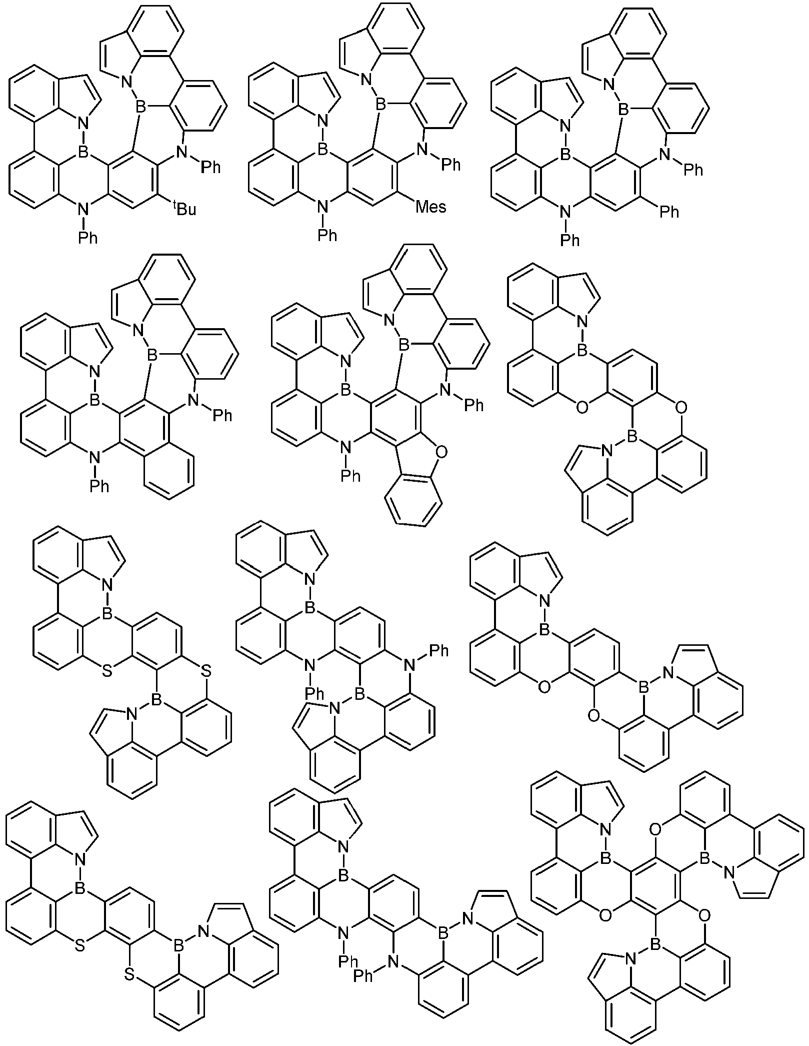

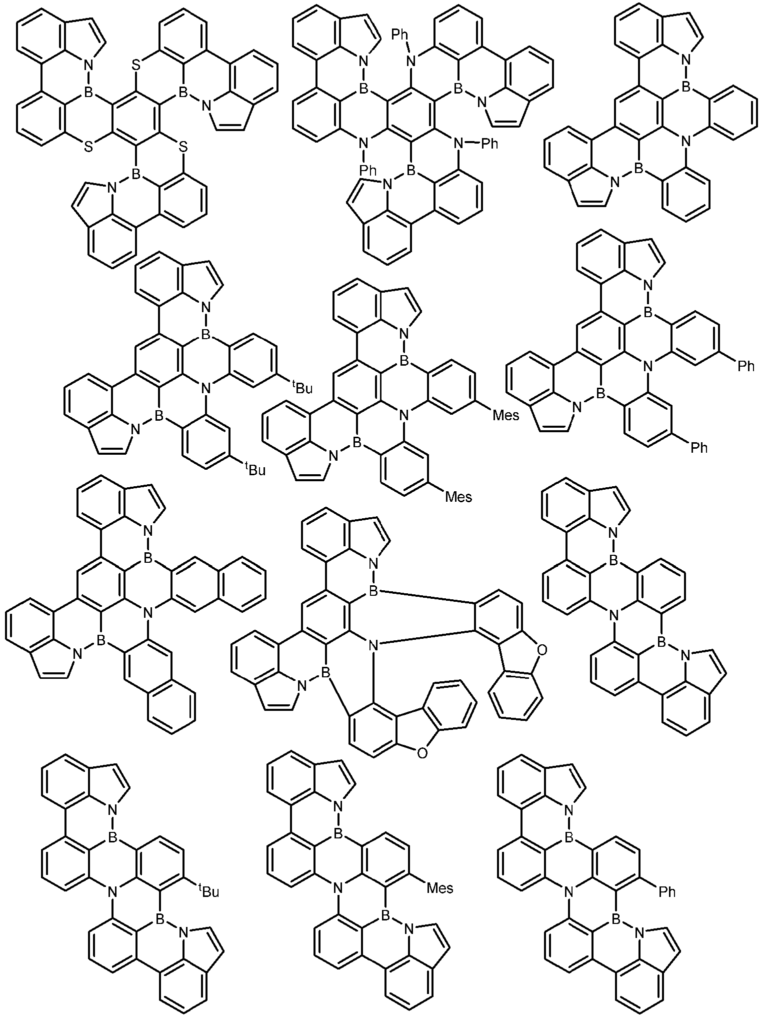

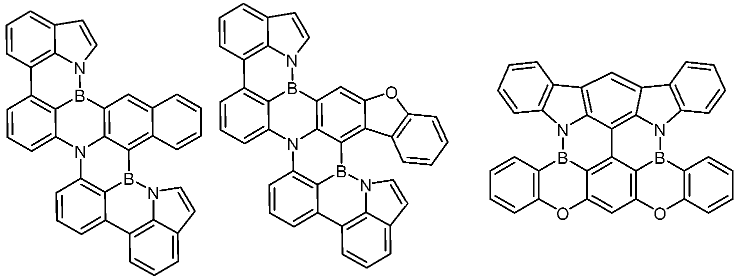

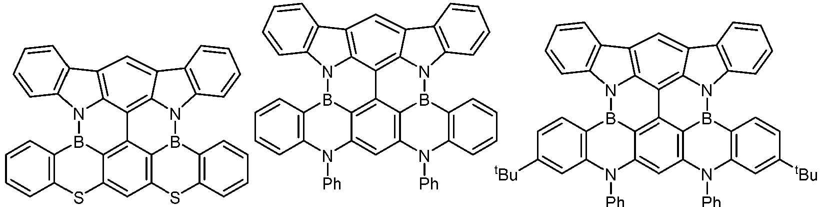

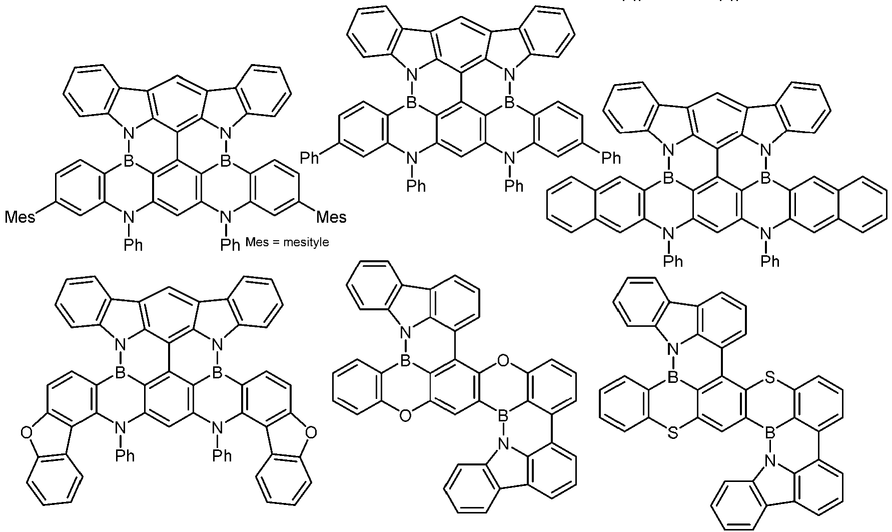

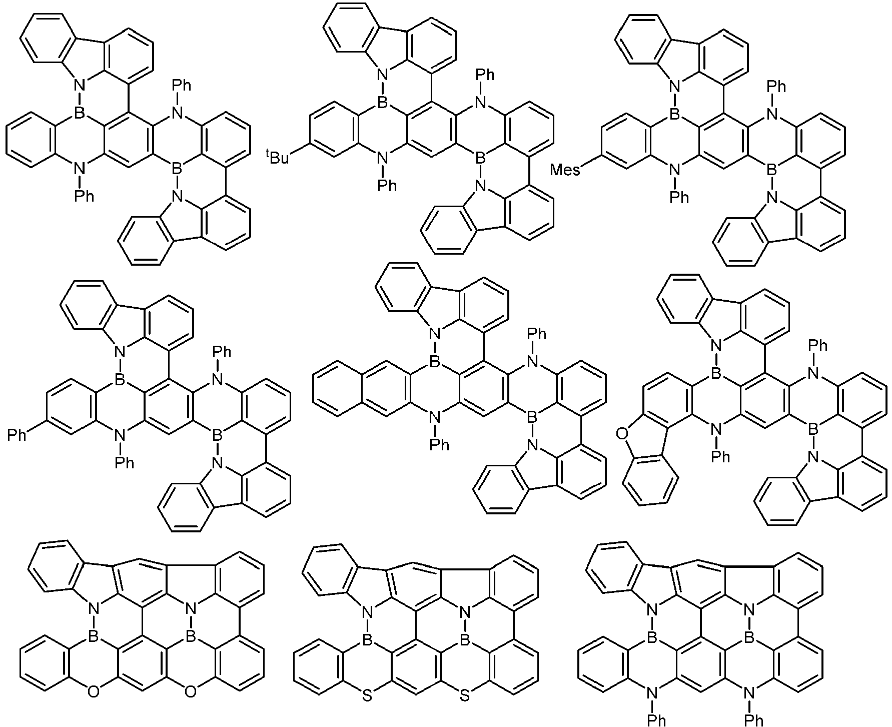

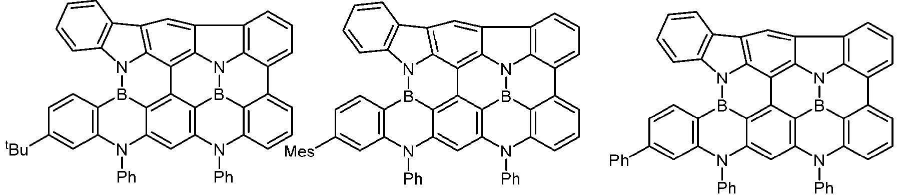

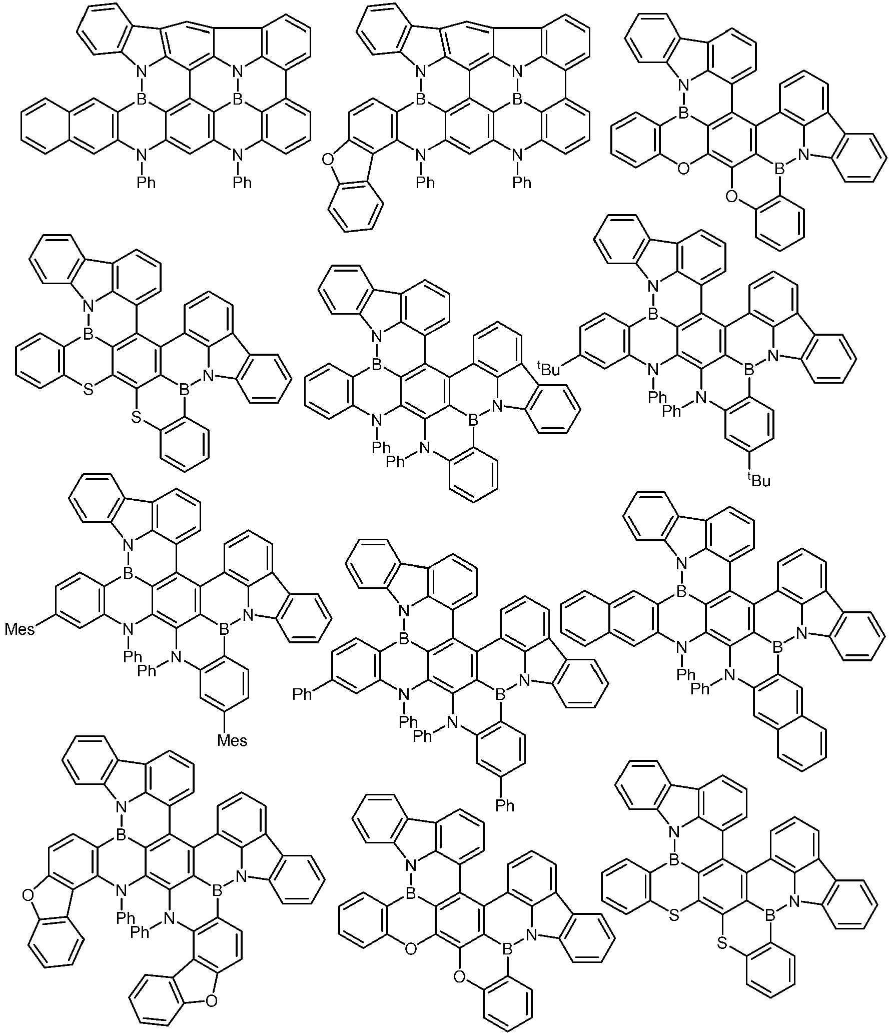

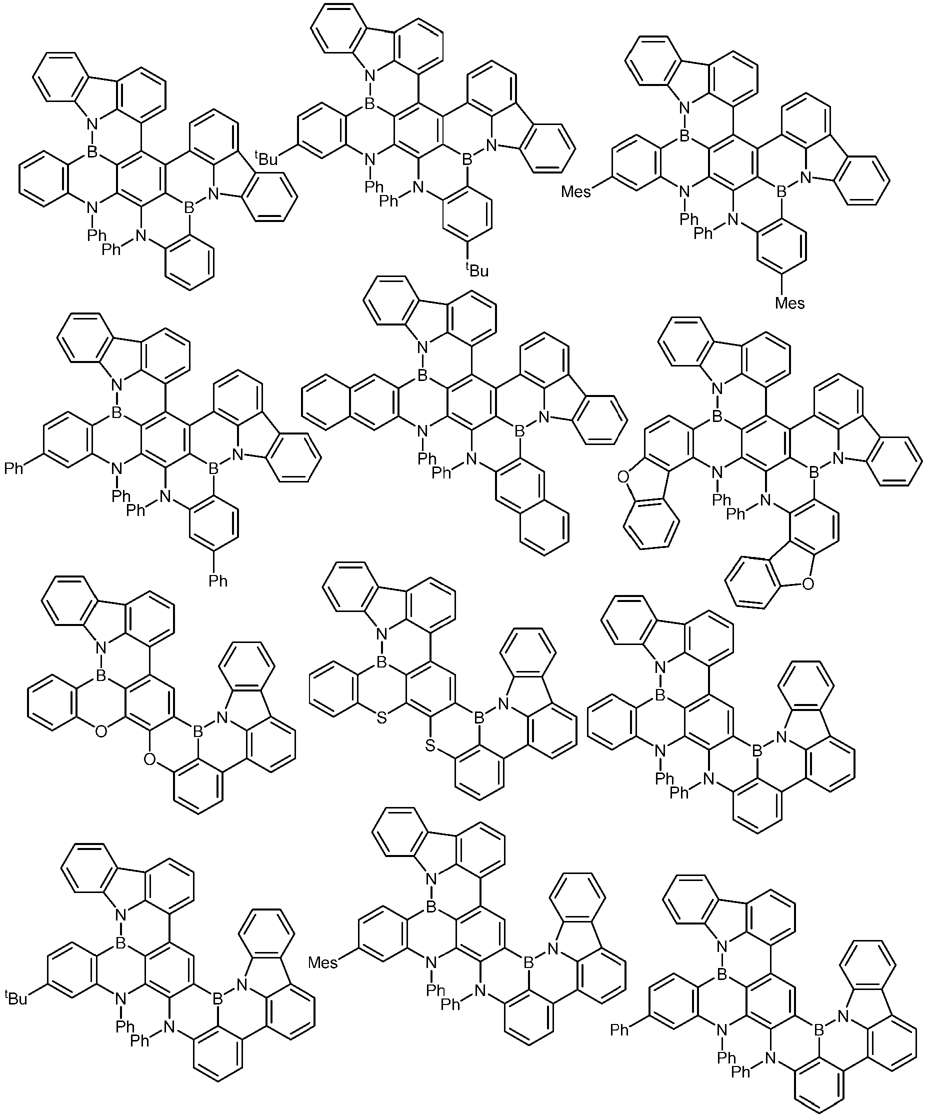

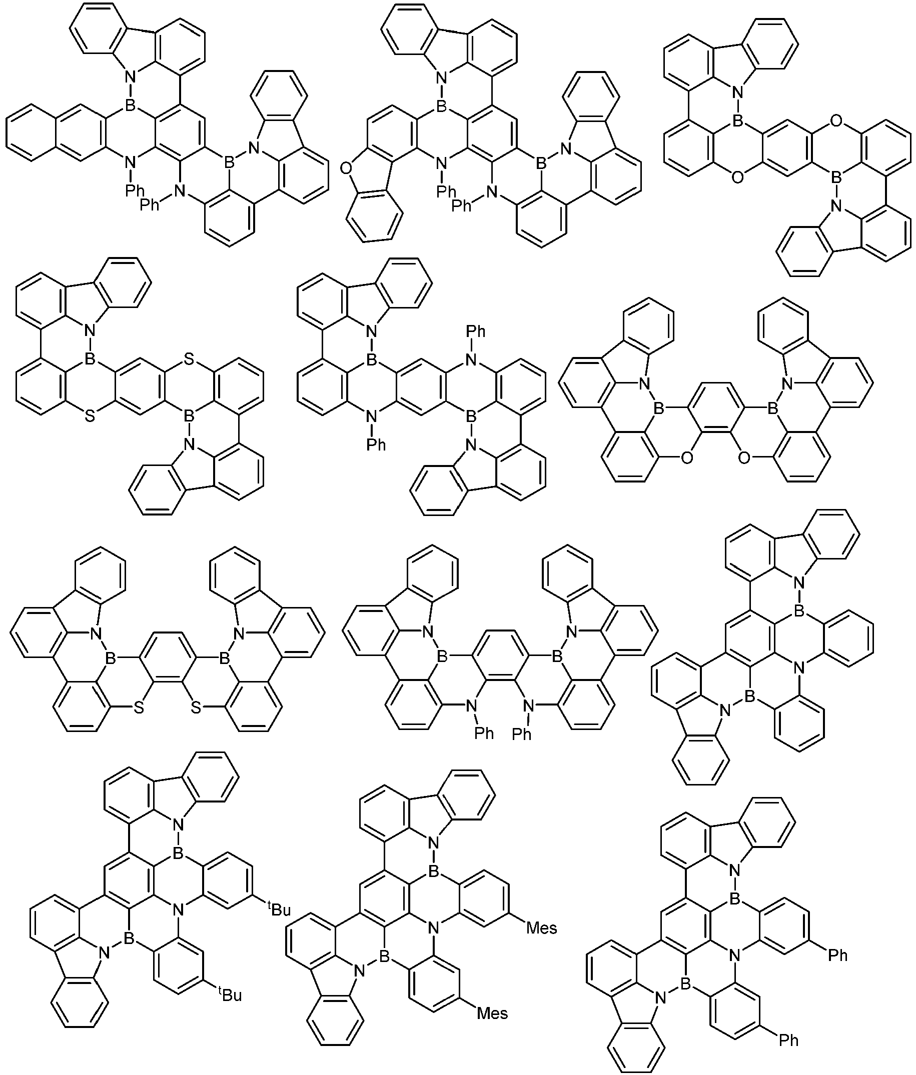

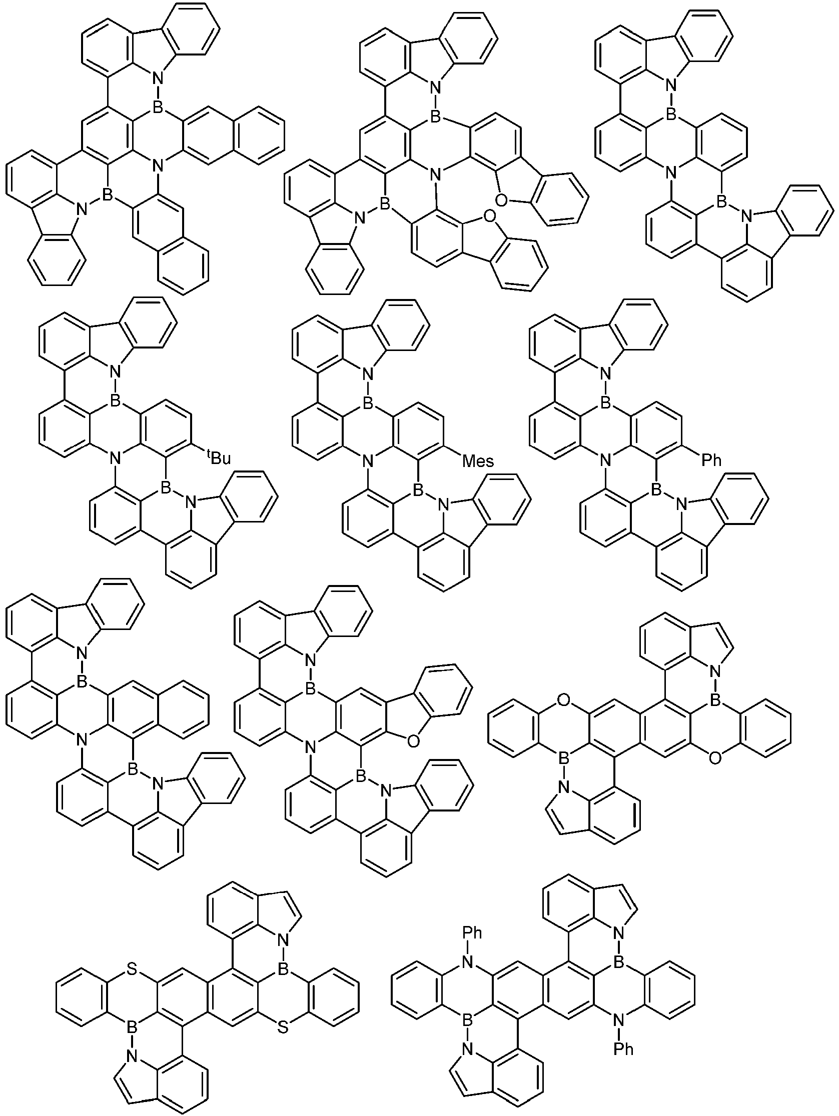

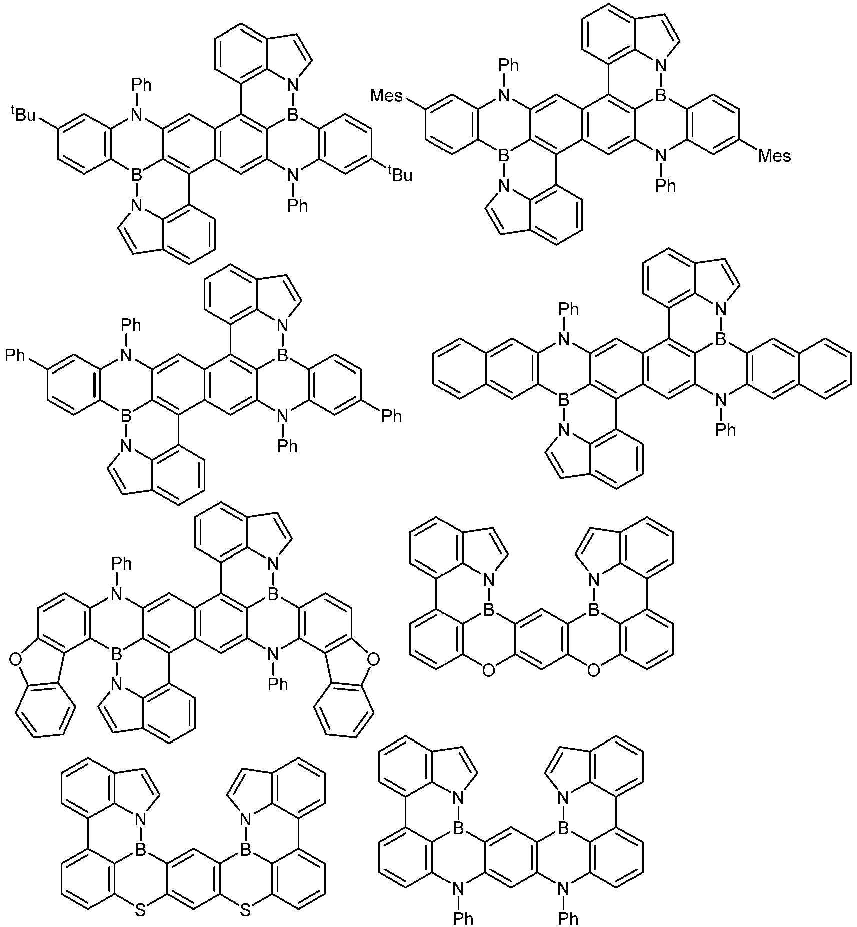

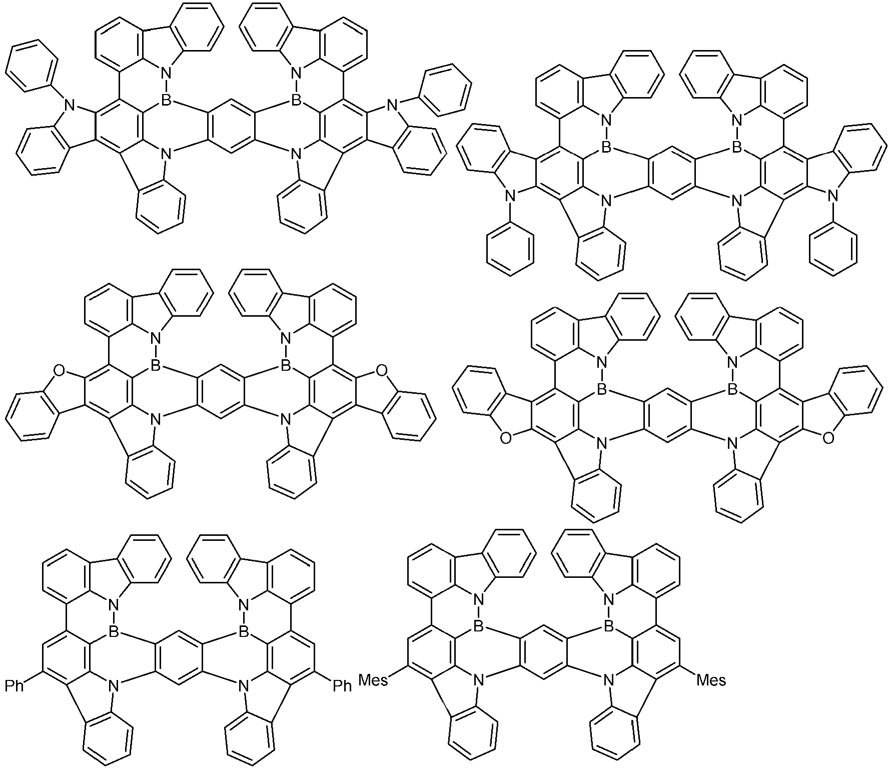

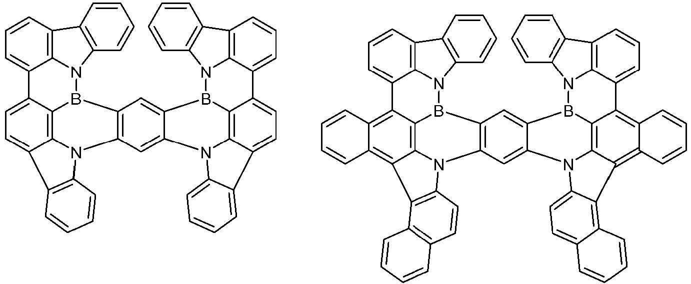

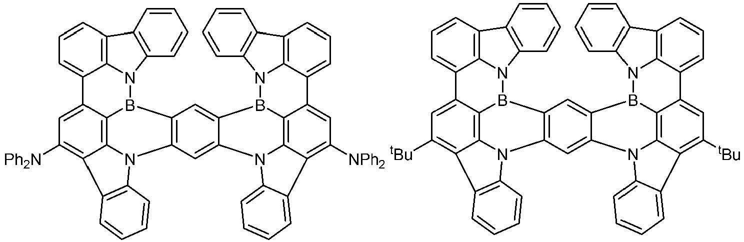

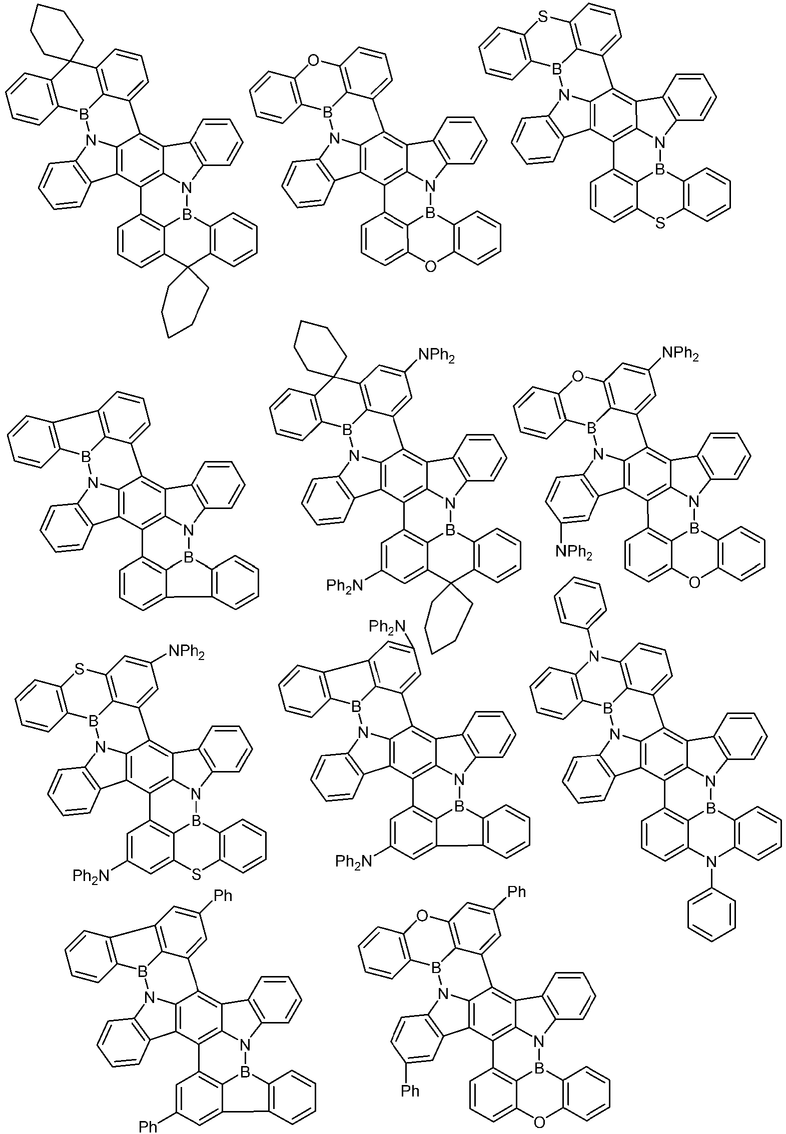

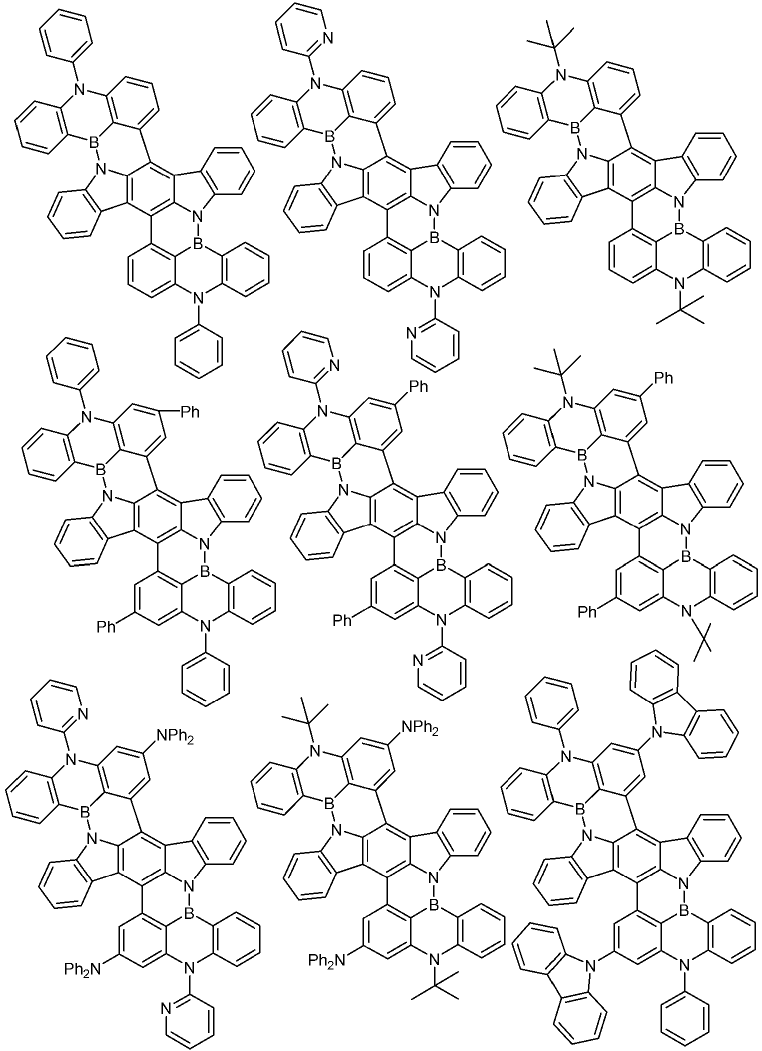

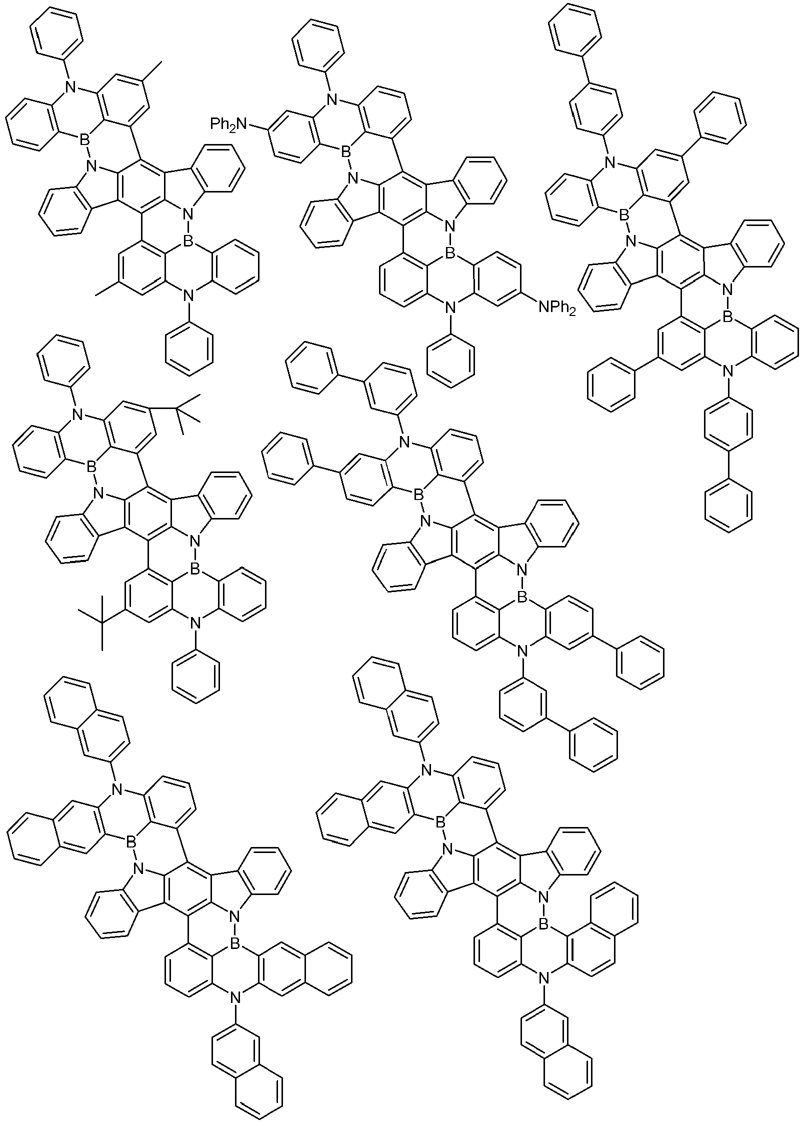

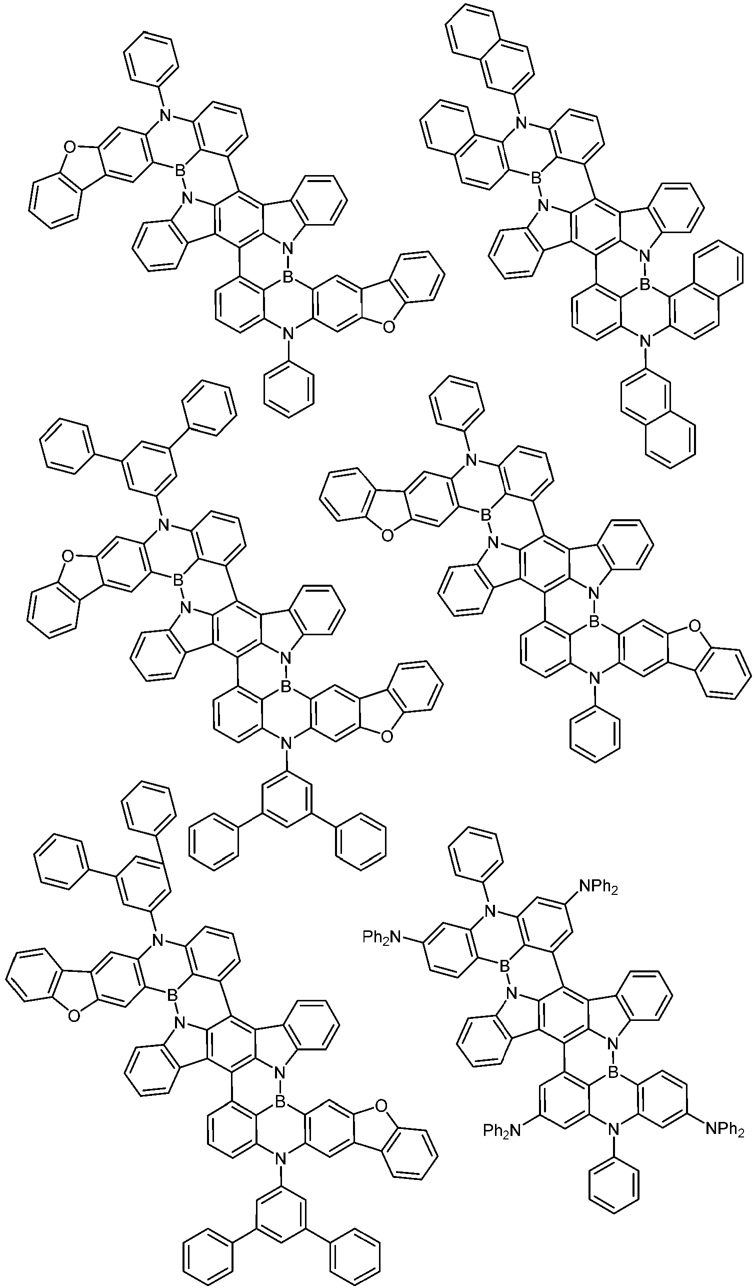

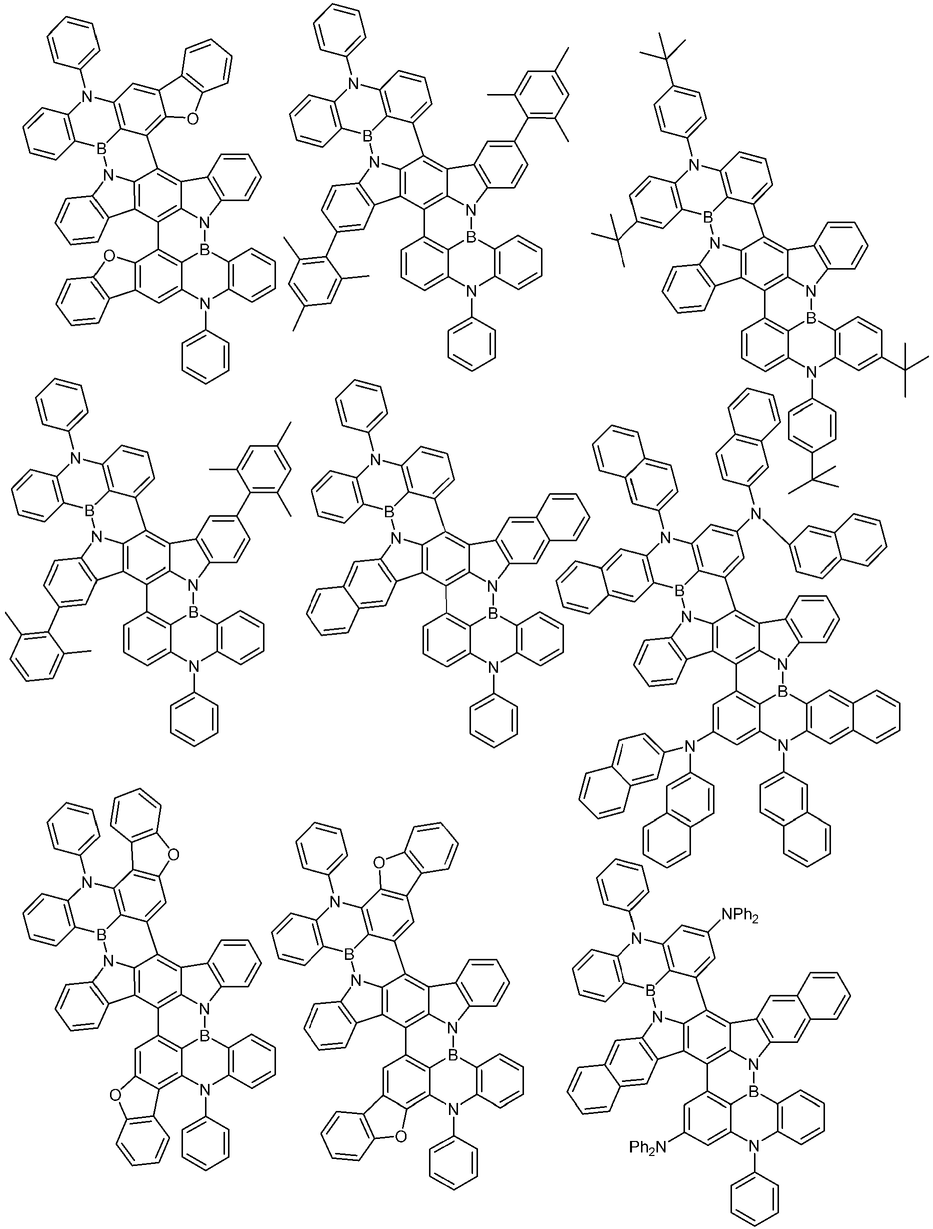

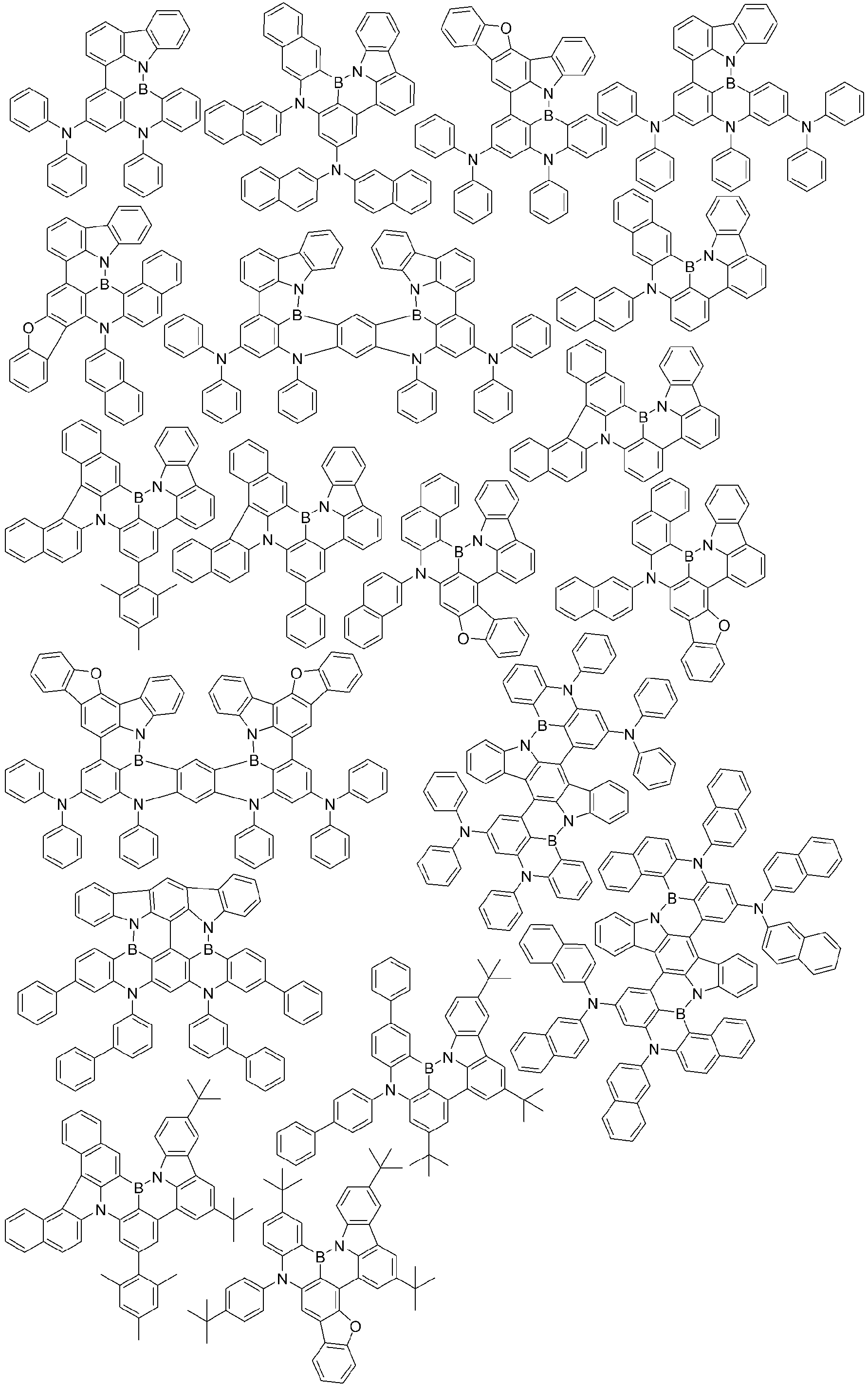

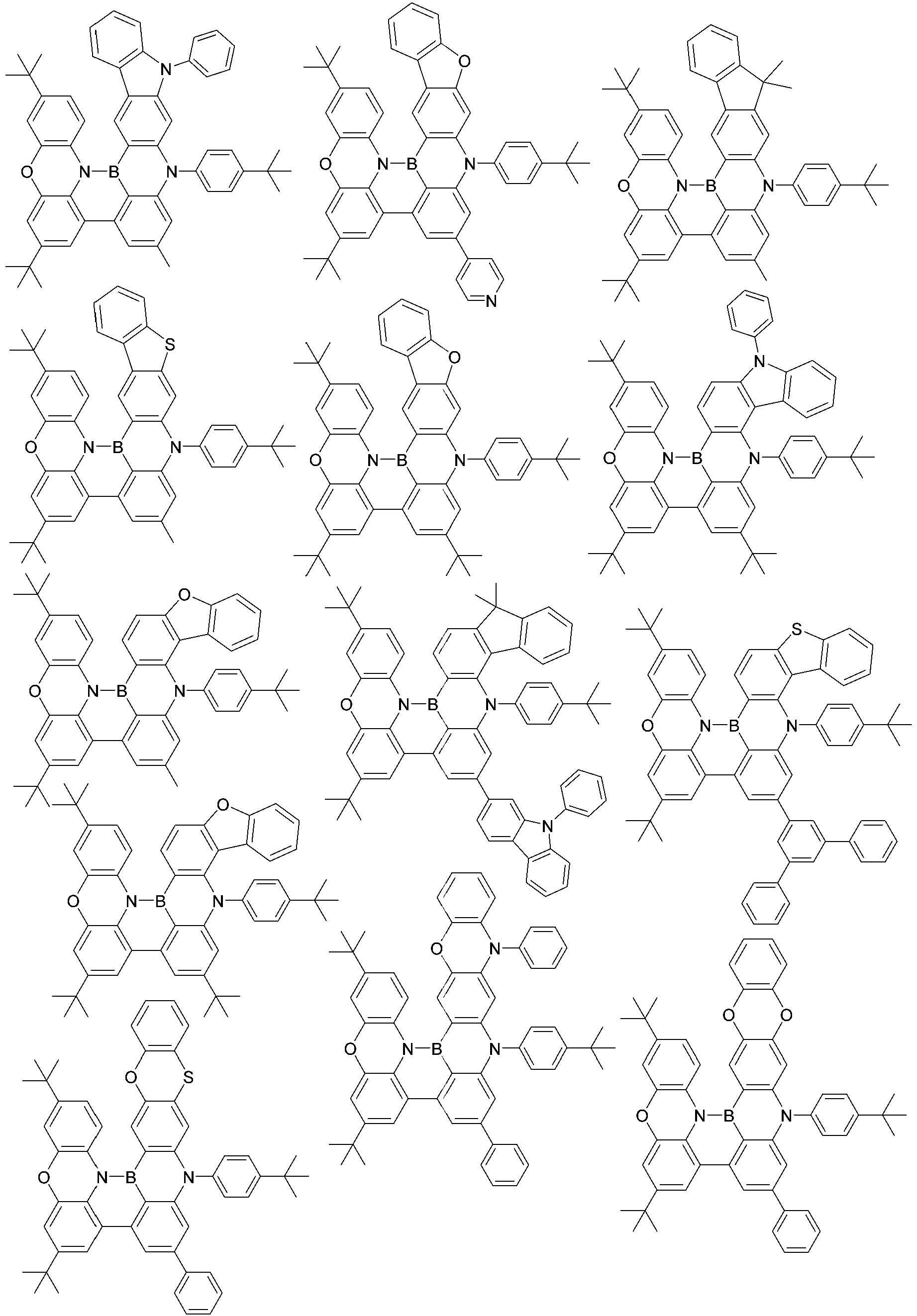

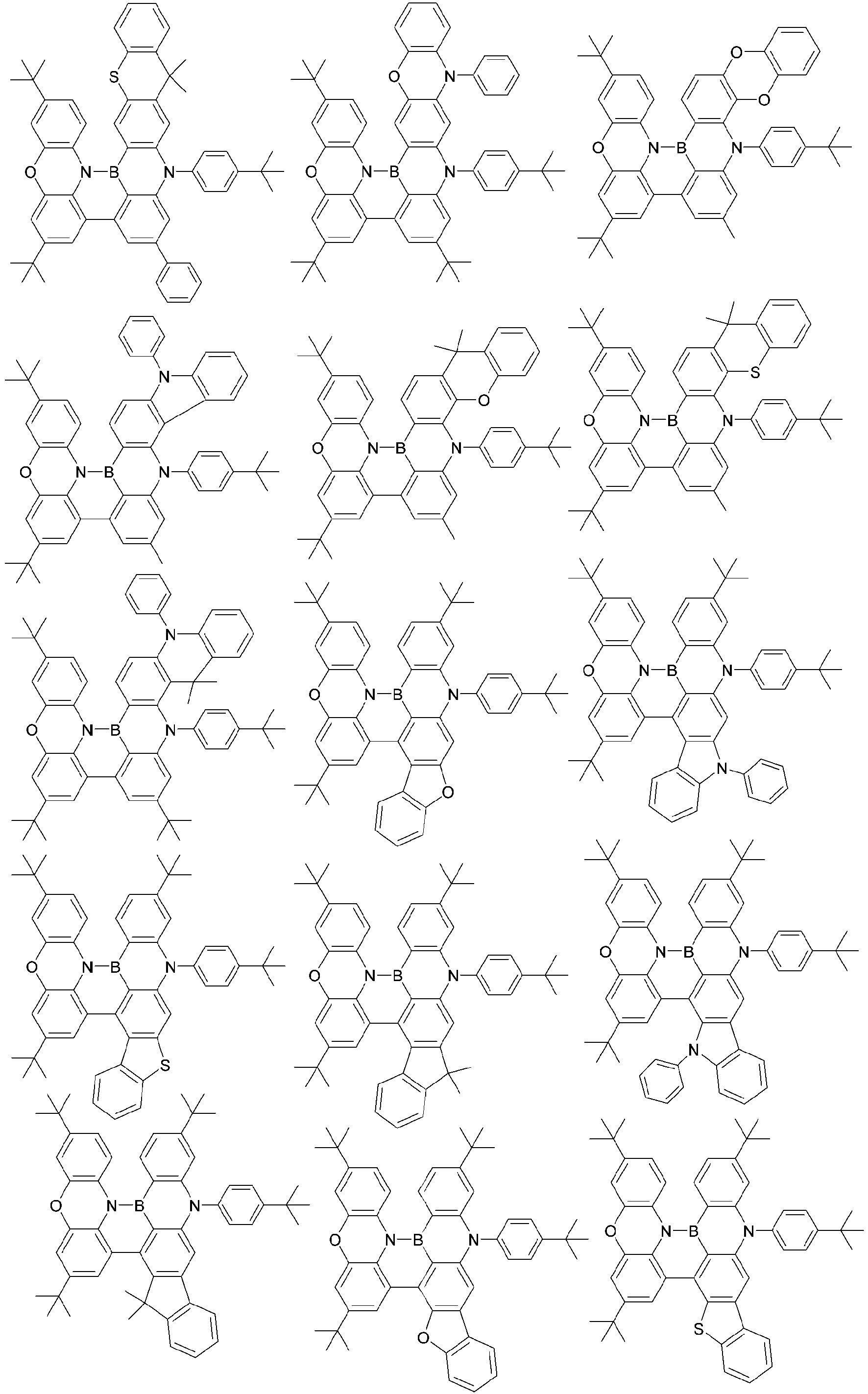

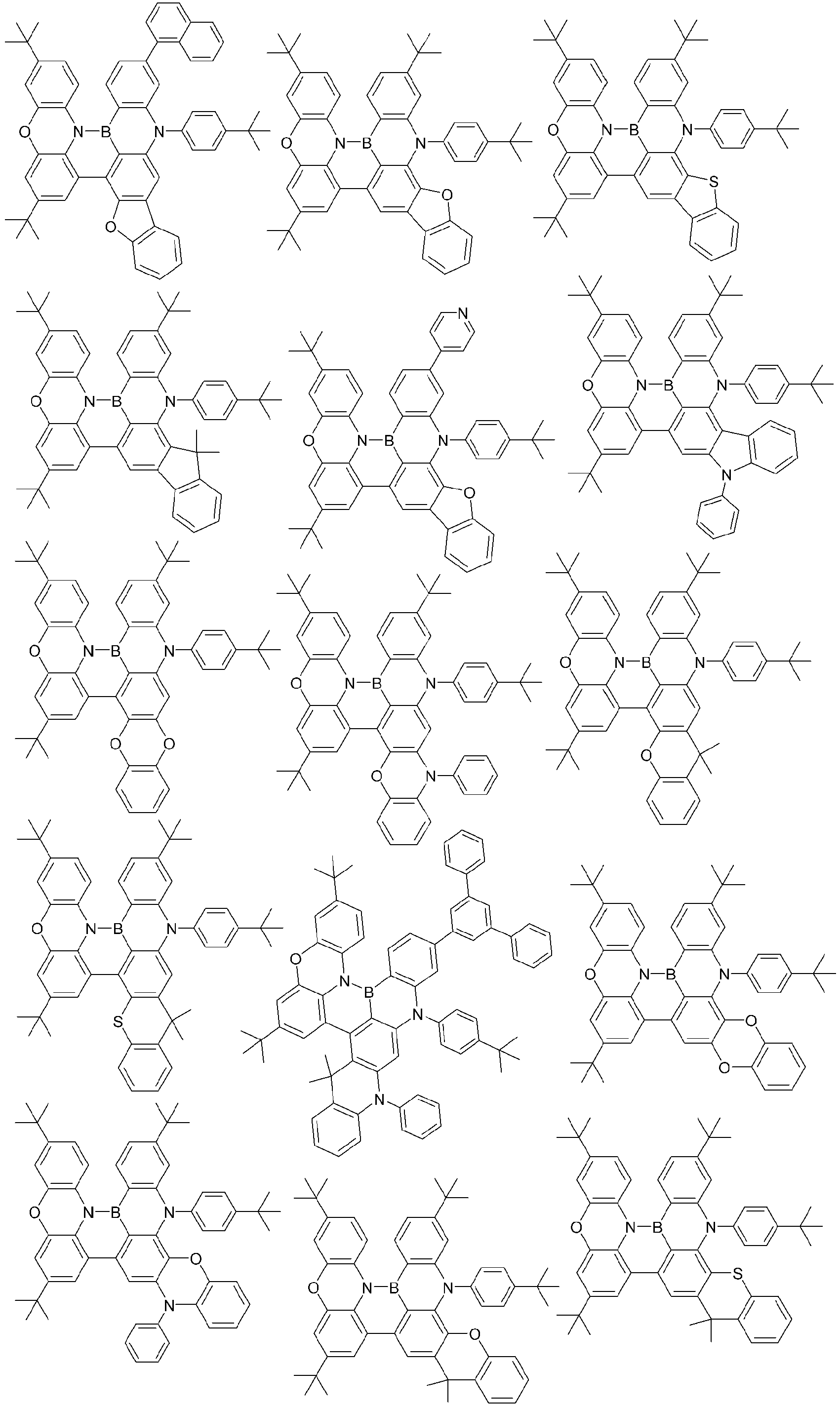

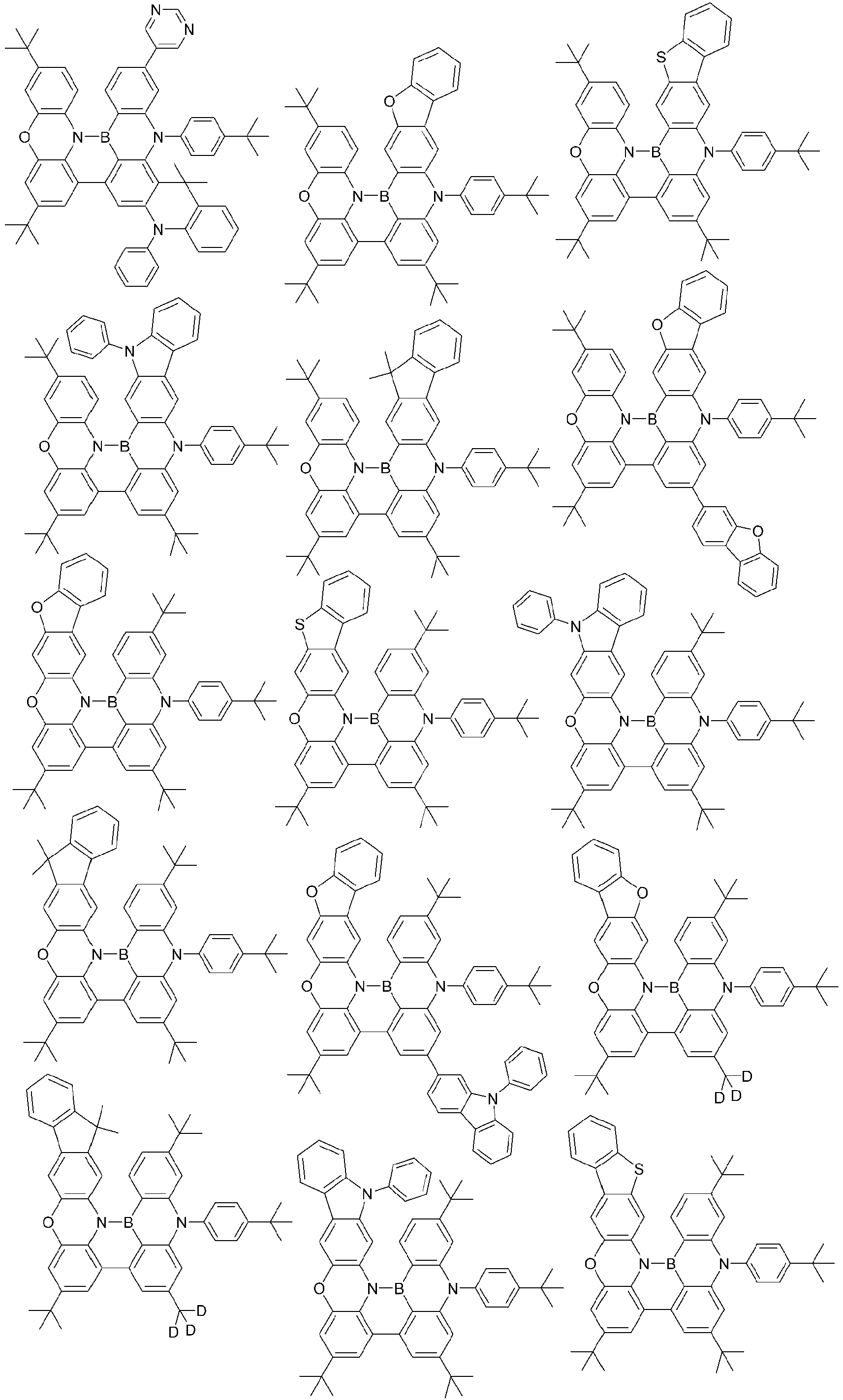

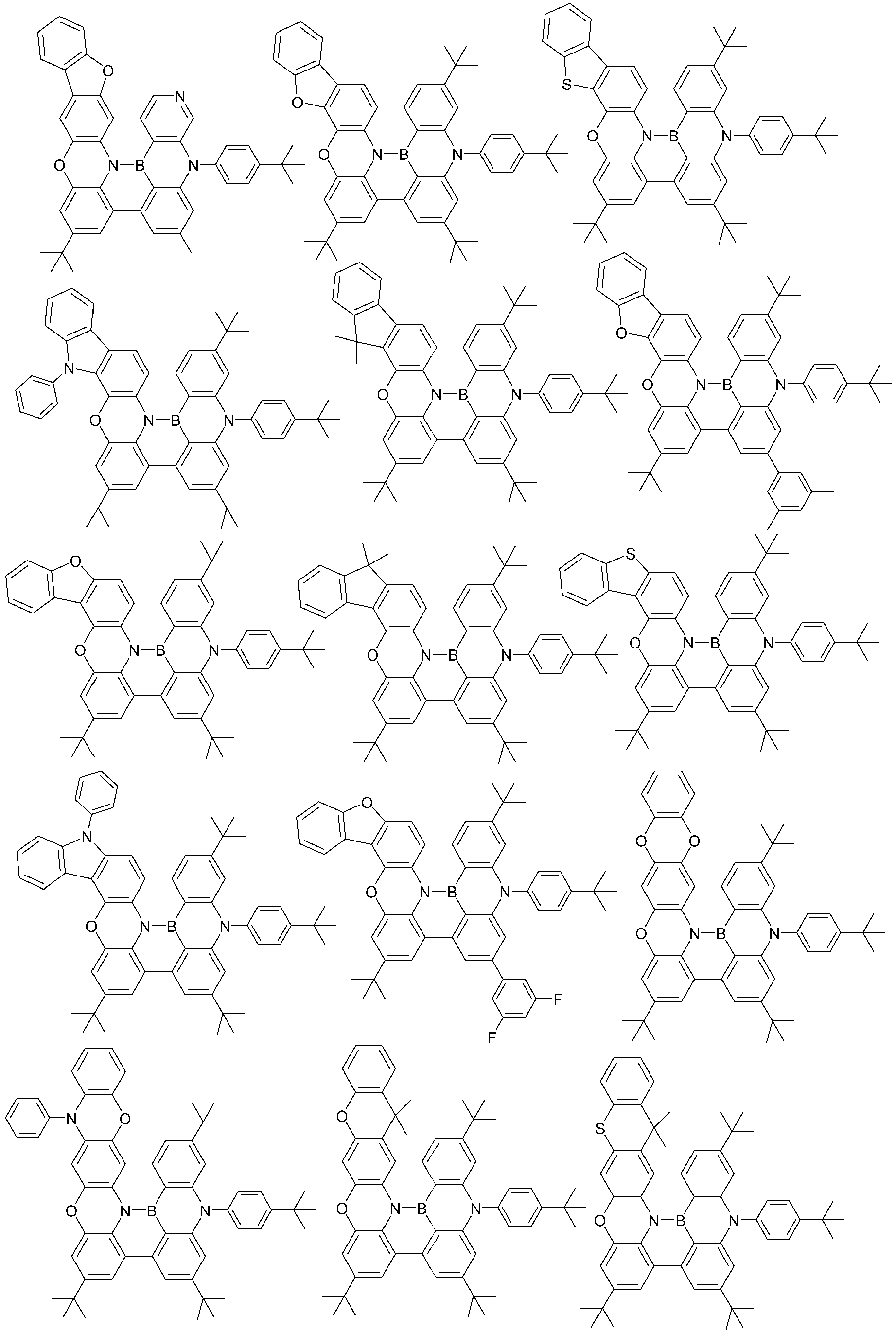

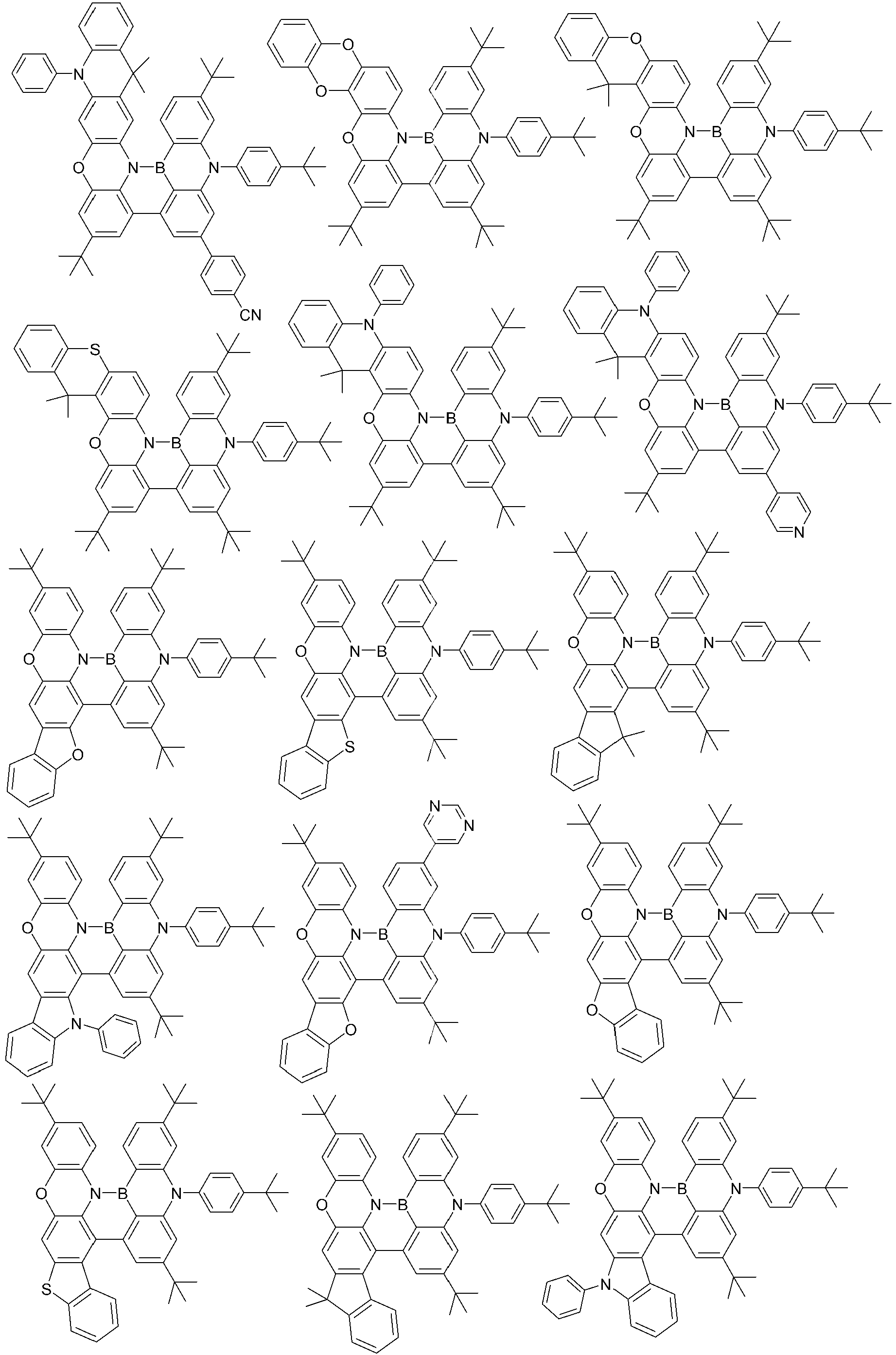

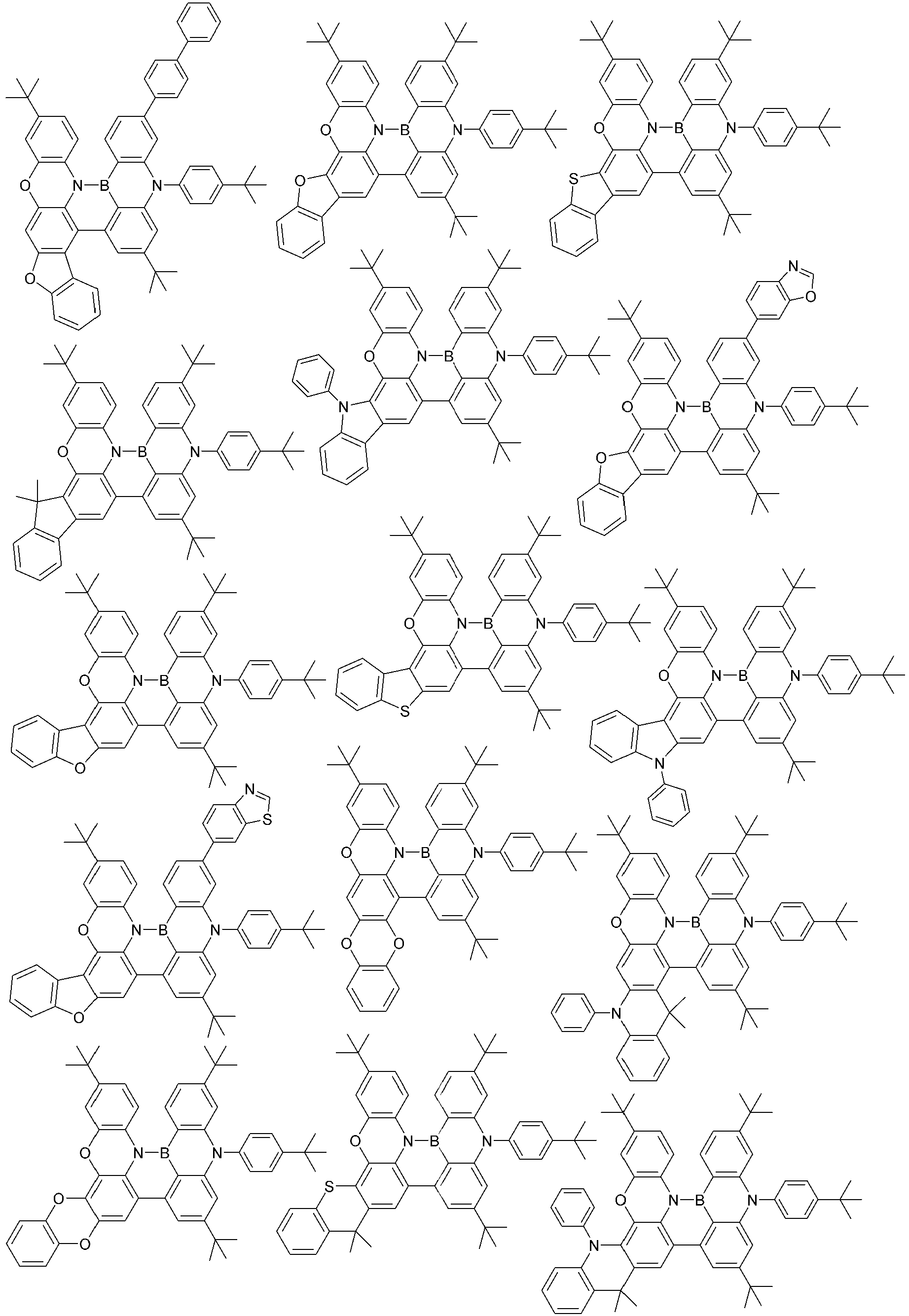

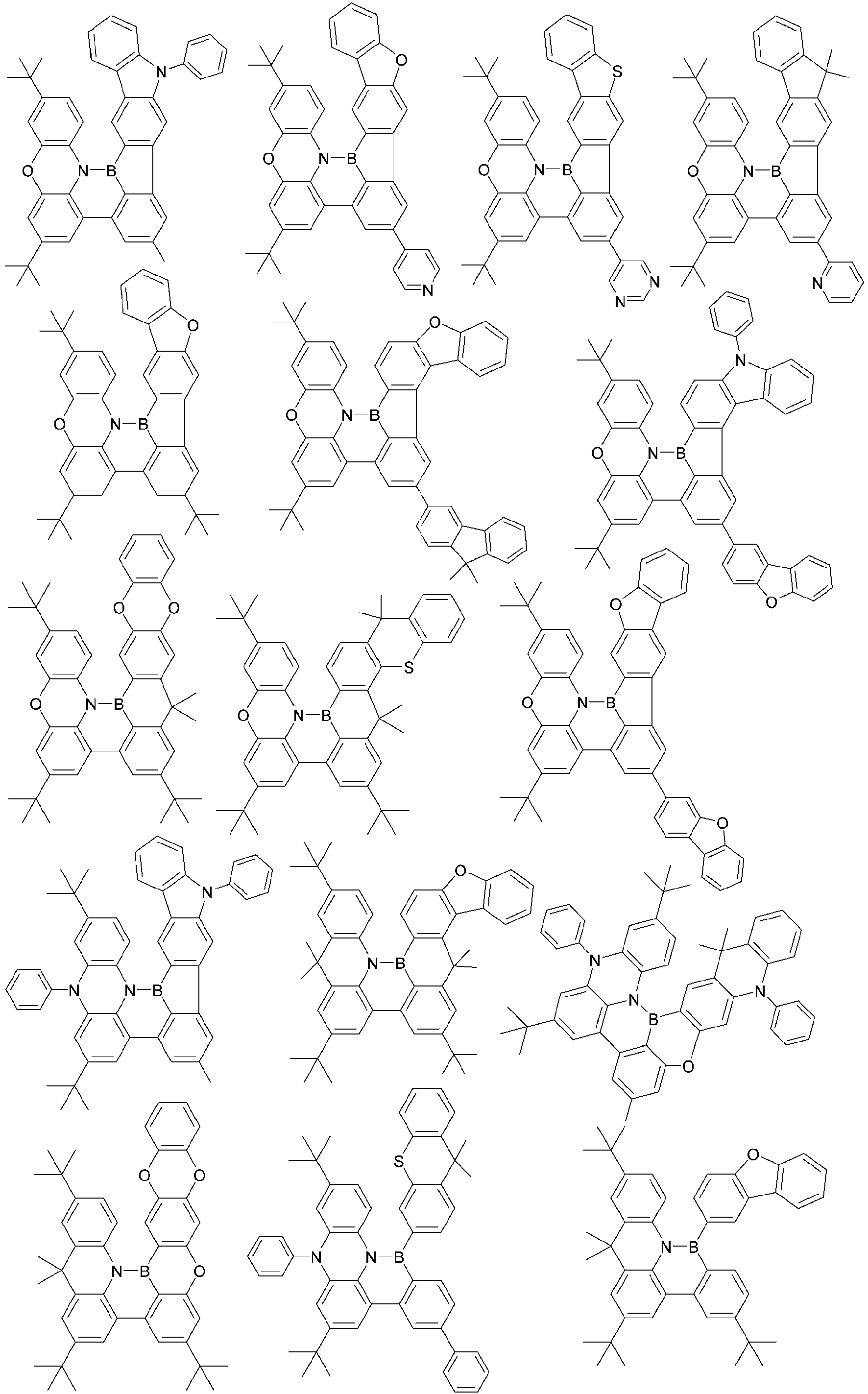

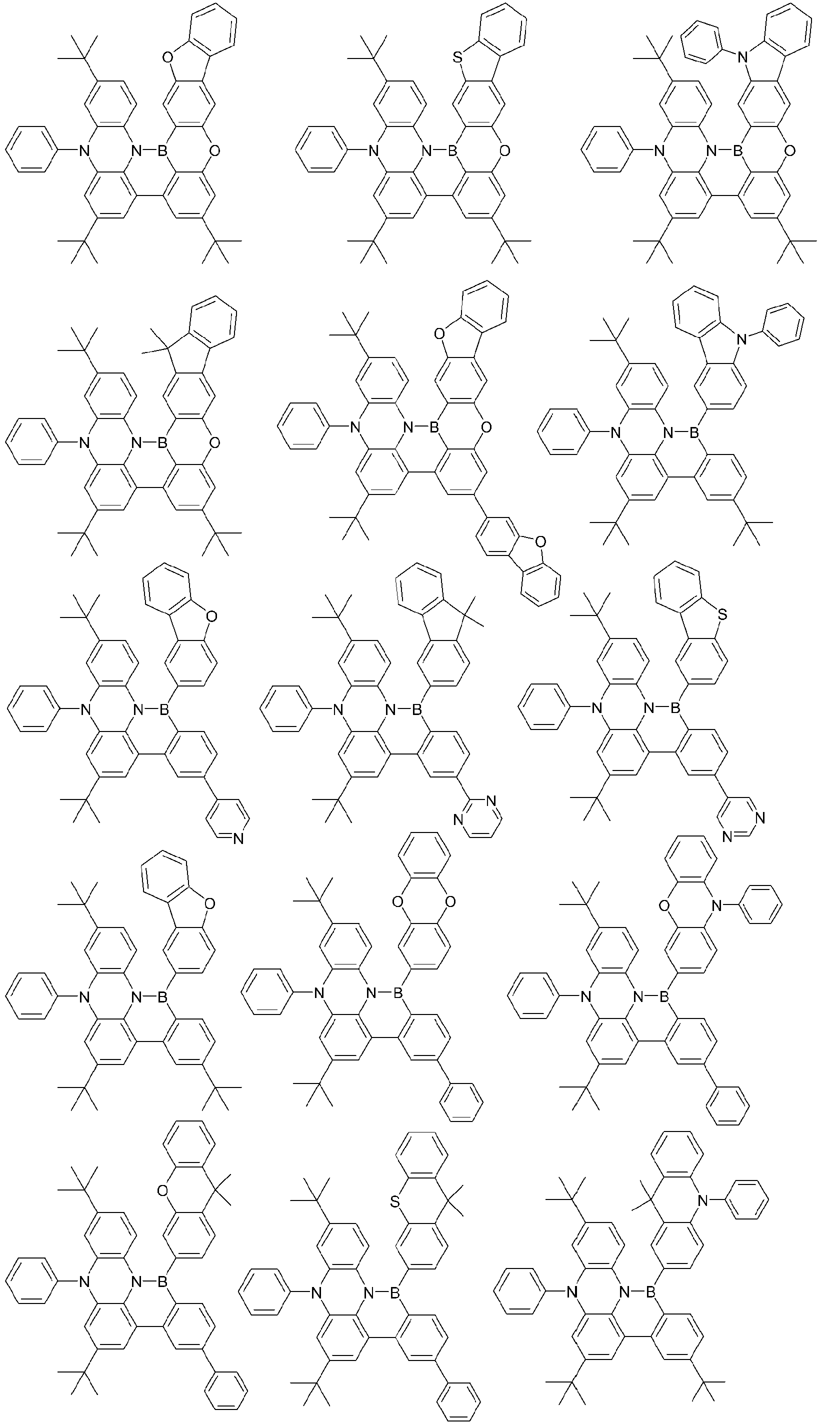

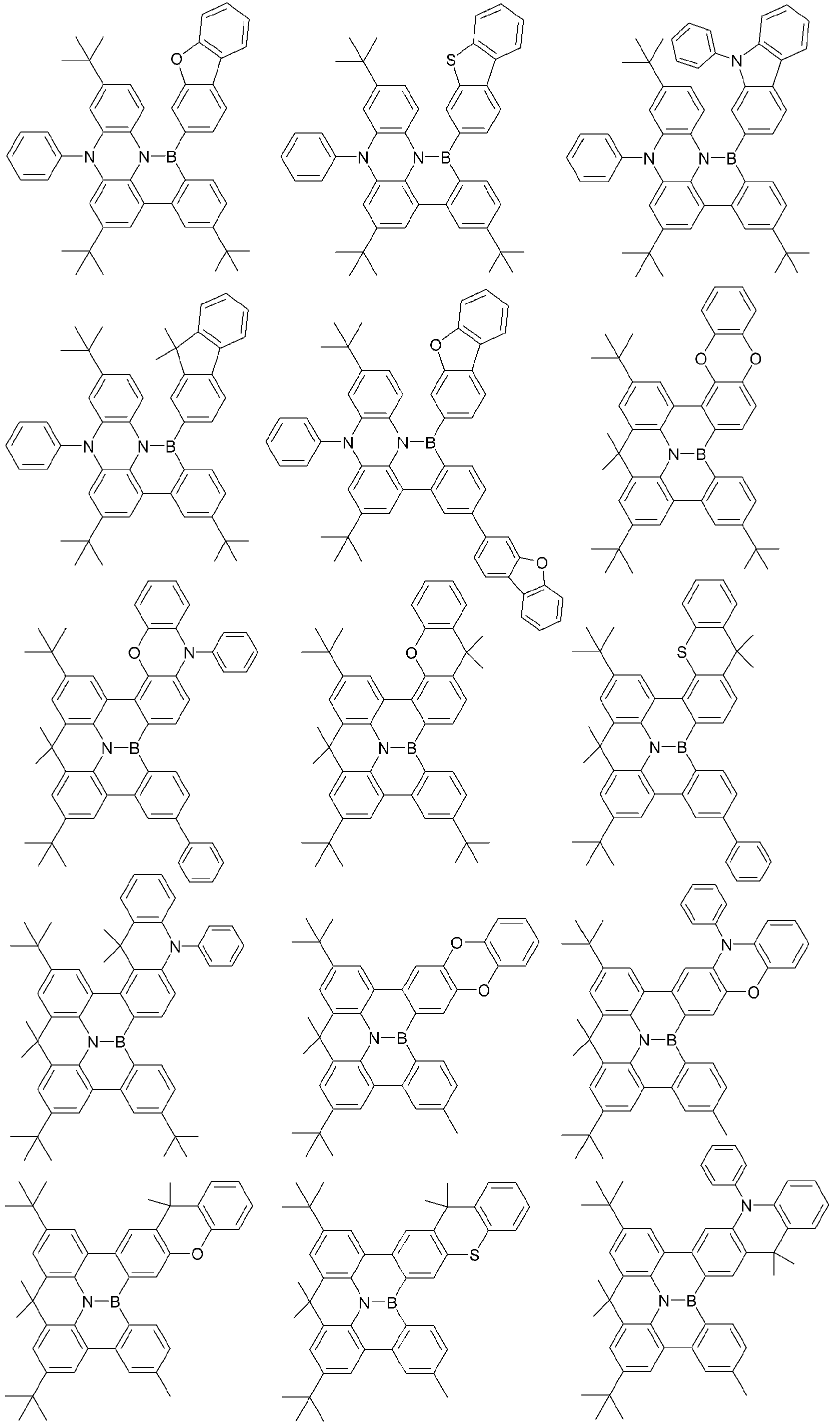

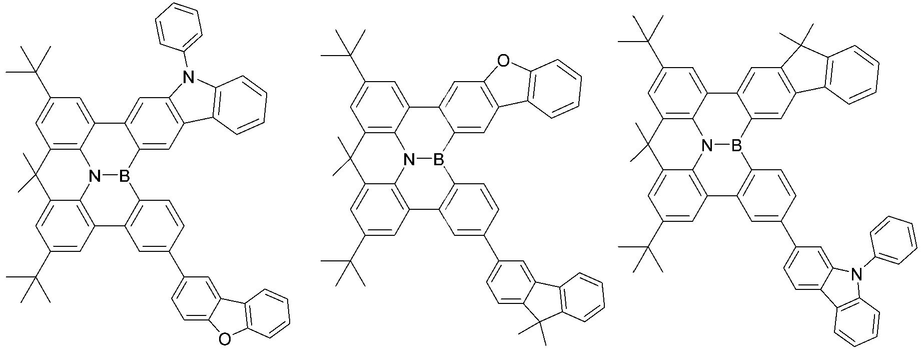

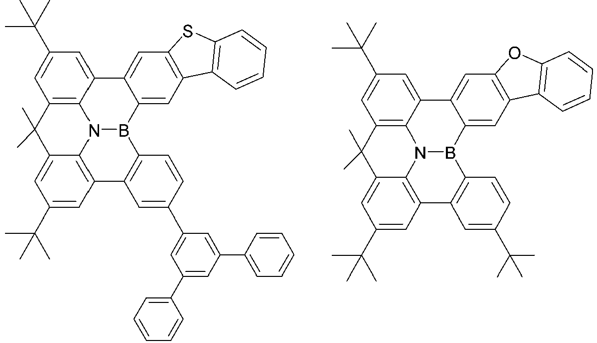

The synthesis of small FWHM emitters S^{B} comprising or consisting of a structure according to formula BNE-1 can be accomplished via standard reactions and reaction conditions known to the skilled artisan.

Typically, the synthesis comprises transition-metal catalyzed cross coupling reactions and a borylation reaction, all of which are known to the skilled artisan.

For example, WO2020135953 (A1) teaches how to synthesize small FWHM emitters S^{B} comprising or consisting of a structure according to formula BNE-1. Furthermore, US2018047912 (A1) teaches how to synthesize small FWHM emitters S^{B} comprising or consisting of a structure according to formula BNE-1, in particular with c and d being 0.

It is understood that the emitters disclosed in US2018047912 (A1) and WO2020135953 (A1) may also be used as small FWHM emitters S^{B} in the context of the present invention.

One approach to design fluorescent emitters relies on the use of fluorescent polycyclic aromatic or heteroaromatic core structures. The latter are, in the context of the present invention, any structures comprising more than one aromatic or heteroaromatic ring, preferably more than two such rings, which are, even more preferably, fused to each other or linked via more than one direct bond or linking atom. In other words, the fluorescent core structures comprise at least one, preferably only one, rigid conjugated π-system.

The skilled artisan knows how to select a core structure for a fluorescent emitter, for example from US2017077418 (A1). Examples of common core structures of fluorescent emitters are listed below, wherein this does not imply that only these cores may provide small FWHM emitters S^{B} suitable for the use according to the present invention:

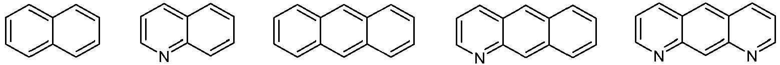

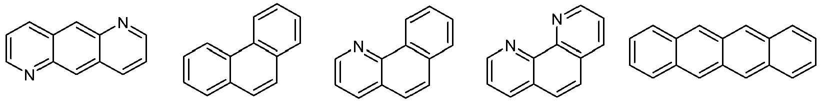

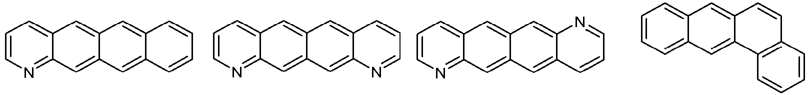

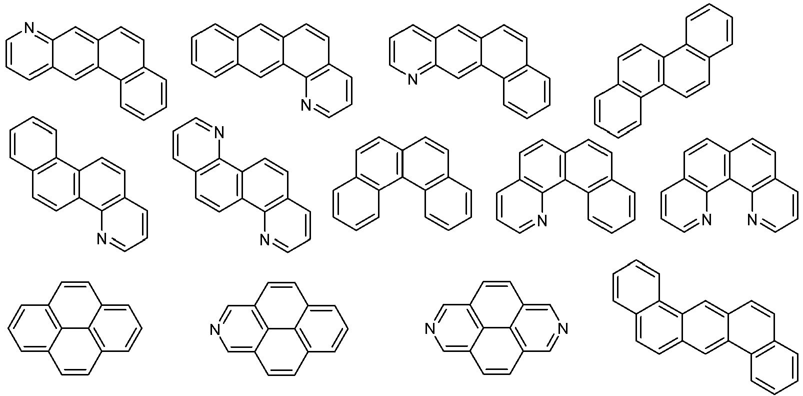

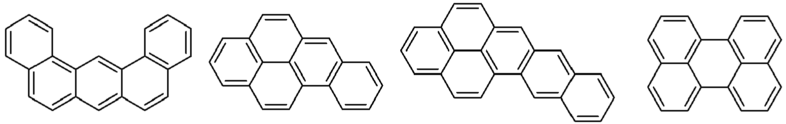

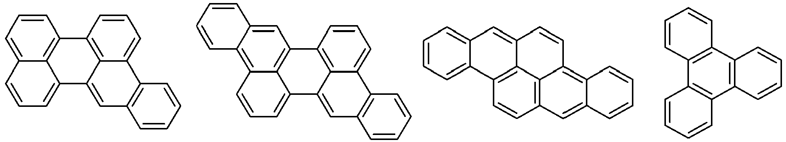

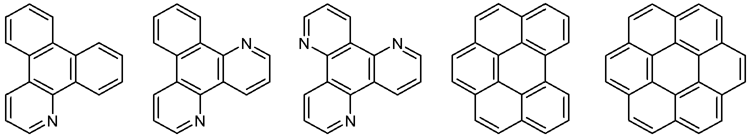

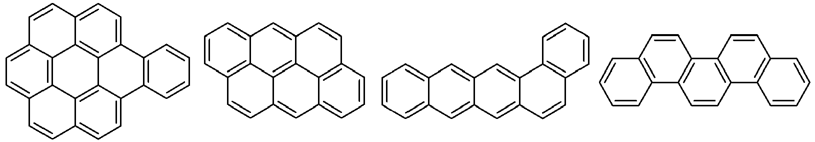

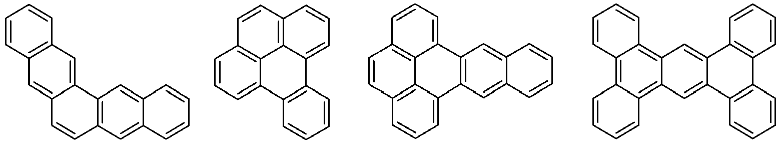

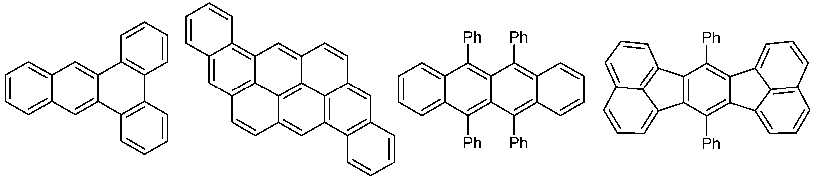

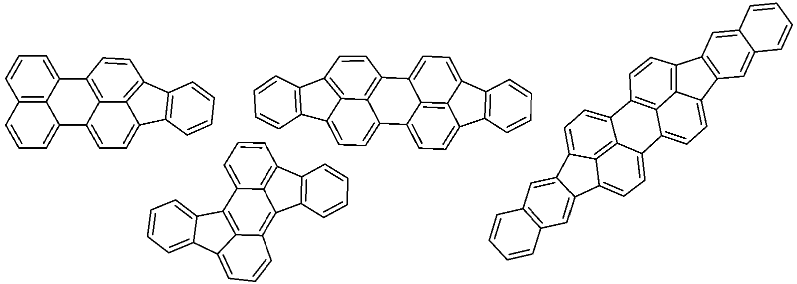

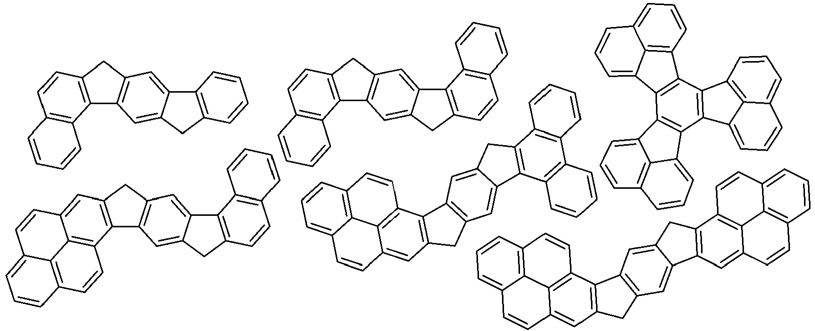

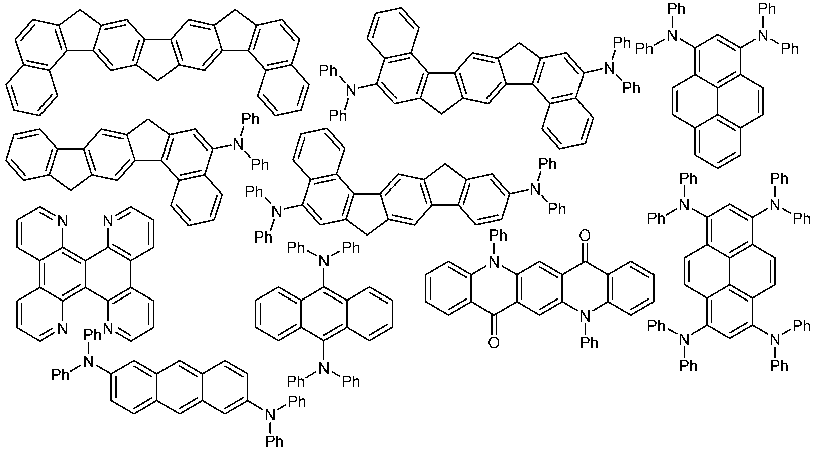

The term fluorescent core structure in this context indicates that any molecule comprising the core may potentially be used as fluorescent emitter. The person skilled in the art knows that the core structure of such a fluorescent emitter may be optionally substituted and which substituents are suitable in this regard, for example from: US2017077418 (A1), M. Zhu. C. Yang, Chemical Society Reviews 2013, 42, 4963, DOI: 10.1039/c3cs35440g; S. Kima, B. Kimb, J. Leea, H. Shina,Y.-Il Parkb, J. Park, Materials Science and Engineering R: Reports 2016, 99, 1, DOI: 10.1016/j.mser.2015.11.001; K.R.J. Thomas, N. Kapoor, M.N.K.P. Bolisetty, J.-H. Jou, Y.-L. Chen, Y.-C. Jou, The Journal of Organic Chemistry 2012, 77(8), 3921, DOI: 10.1021/jo300285v; M. Vanga, R.A. Lalancette, F. Jäkle, Chemistry - A European Journal 2019, 25(43), 10133, DOI: 10.1002/chem.201901231.

Small FWHM emitters S^{B} for use according to the present invention may be obtained from the aforementioned fluorescent core structures, for example, by attaching sterically demanding substituents to the core that hinder the contact between the fluorescent core and adjacent molecules in the respective layer of an organic electroluminescent device.

In the context of the present invention, a compound, for example a fluorescent emitter is considered to be sterically shielded, when a subsequently defined shielding parameter is equal to or below a certain limit which is also defined in a later subchapter of this text.

It is preferred that the substituents used to sterically shield a fluorescent emitter are not just bulky (i.e. sterically demanding), but also electronically inert, which in the context of the present invention means, that these substituents do not comprise an active atom as defined in a later subchapter of this text. It is understood that this does not imply that only electronically inert (in other words: not active) substituents may be attached to a fluorescent core structure such as the ones shown above. Active substituents may also be attached to the core structure and may be introduced on purpose to tune the photophysical properties of a fluorescent core structure. In this case, it is preferred, that the active atoms introduced via one or more substituents are again shielded by electronically inert (i.e. not active) substituents.

Based on the aforementioned information and common knowledge from the state of the art, the skilled artisan understands how to choose substituents for a fluorescent core structure that may induce steric shielding of the latter and that are electronically inert as stated above. In particular, US2017077418 (A1) discloses substituents suitable as electronically inert (in other words: not active) shielding substituents. Examples of such substituents include linear, branched or cyclic alkyl groups with 3 to 40 carbon atoms, preferably 3 to 20 carbon atoms, more preferably with 4 to 10 carbon atoms, wherein one or more hydrogen atoms may be replaced by a substituent, preferably by deuterium or fluorine. Other examples include alkoxy groups with 3 to 40 carbon atoms, preferably 3 to 20 carbon atoms, more preferably with 4 to 10 carbon atoms, wherein one or more hydrogen atoms may be replaced by a substituent, preferably by deuterium or fluorine. It is understood that these alkyl and alkoxy substituents may be substituted by substituents other than deuterium and fluorine, for example by aryl groups. In this case, it is preferred that the aryl group as substituent comprises 6 to 30 aromatic ring atoms, more preferably 6 to 18 aromatic ring atoms, most preferably 6 aromatic ring atoms, and is preferably not a fused aromatic system such as anthracene, pyrene and the like. Other examples include aryl groups with 6 to 30 aromatic ring atoms, more preferably with 6 to 24 aromatic ring atoms. One or more hydrogen atom in these aryl substituents may be substituted and preferred substituents are for example aryl groups with 6 to 30 carbon atoms and linear, branched or cyclic alkyl groups with 1 to 20 carbon atoms. All substituents may be further substituted. It is understood that all sterically demanding and preferably also electronically inert (in other words: not active) substituents disclosed in US2017077418 (A1) may serve to sterically shield a fluorescent core (such as those described above) to afford sterically shielded fluorescent emitters suitable as small FWHM emitters S^{B} for use according to the present invention.

Below, non-limiting examples of substituents are shown that may be used as sterically demanding (i.e. shielding) and electronically inert (i.e. not active) substituents in the context of the present invention (disclosed in US2017077418 (A1)): 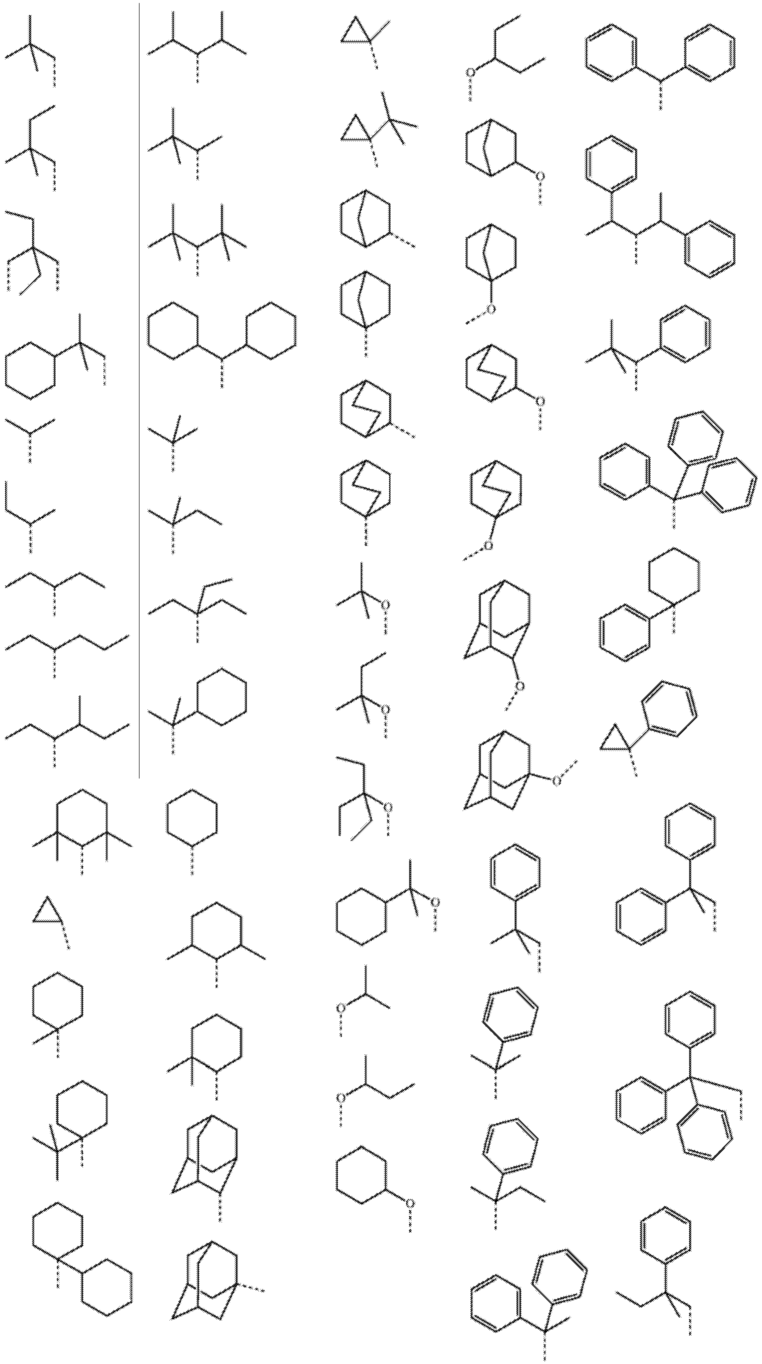 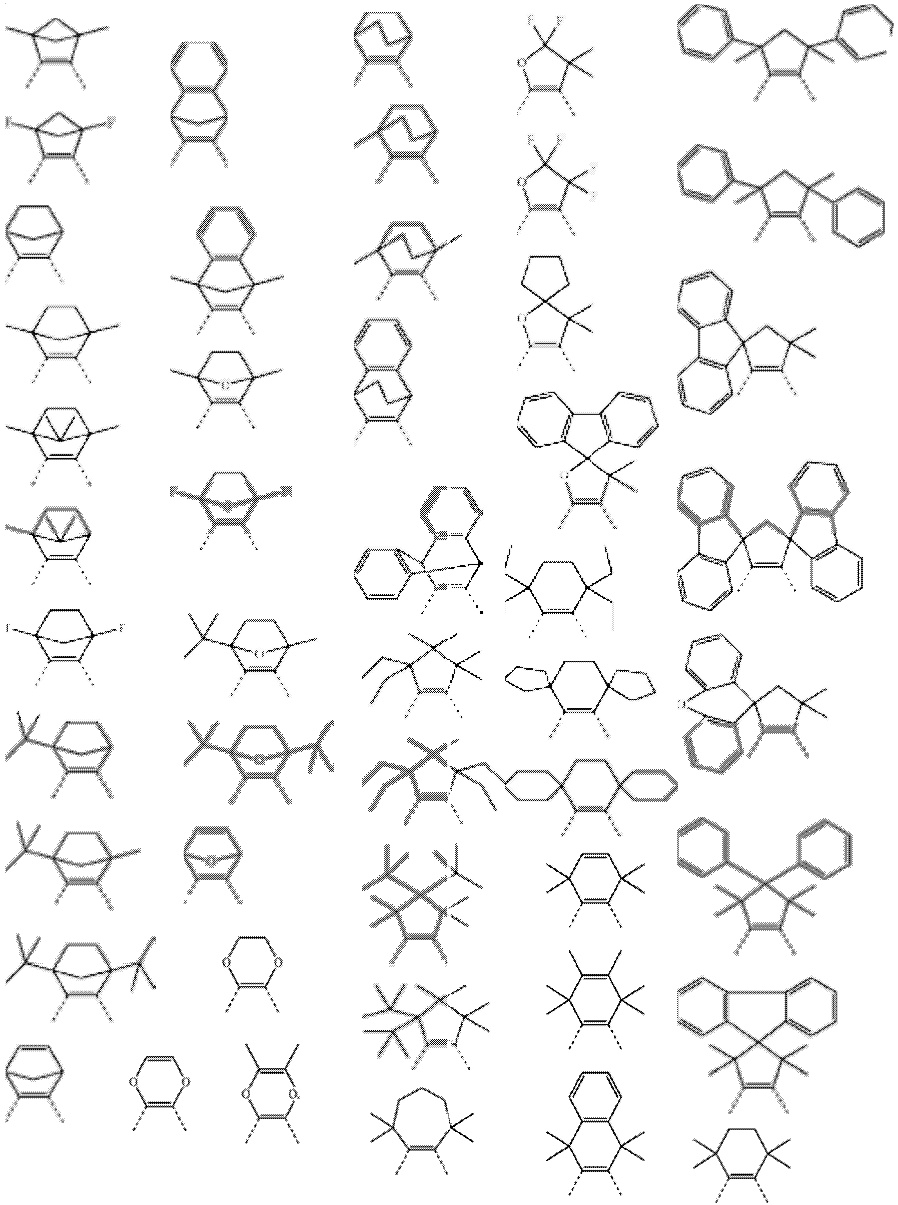 , wherein each dashed line represents a single bond connecting the respective substituent to a core structure, preferably to a fluorescent core structure. As known to the skilled artisan, trialkylsilyl groups are also suitable for use as sterically demanding and electronically inert substituents.

It is also understood that a fluorescent core may not just bear such sterically shielding substituents, but may also be substituted by further, non-shielding substituents that may or may not be active groups in the context of the present invention (see below for a definition).

Below, examples of sterically shielded fluorescent emitters from US2017077418 (A1) are shown that may be used as small FWHM emitters S^{B} in the context of the present invention. This does not imply that the present invention is limited to organic electroluminescent devices comprising the shown emitters.

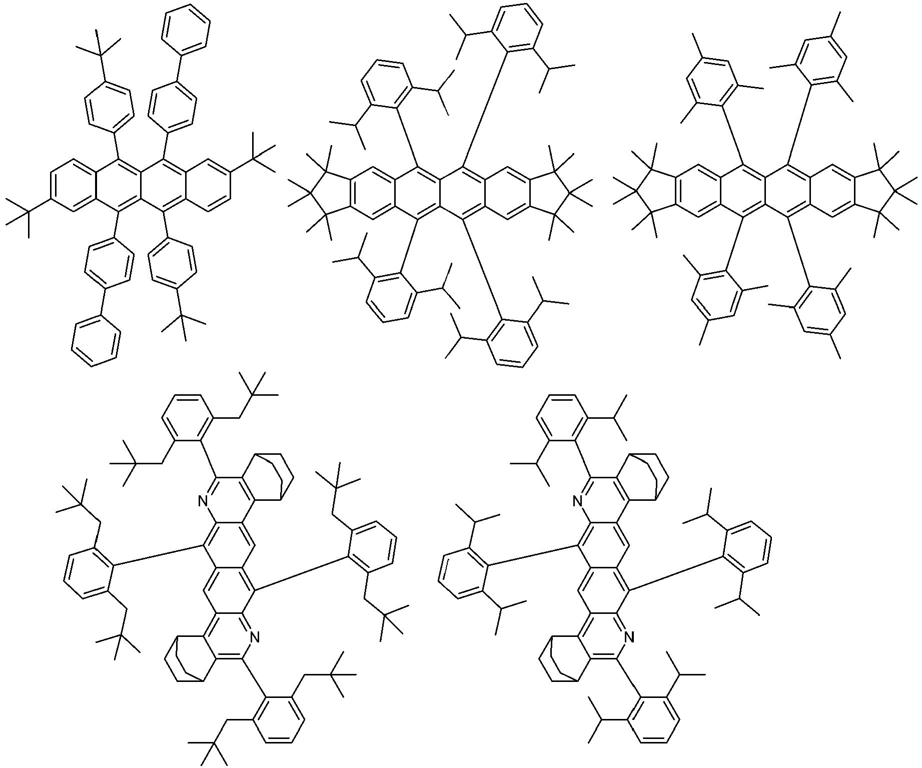

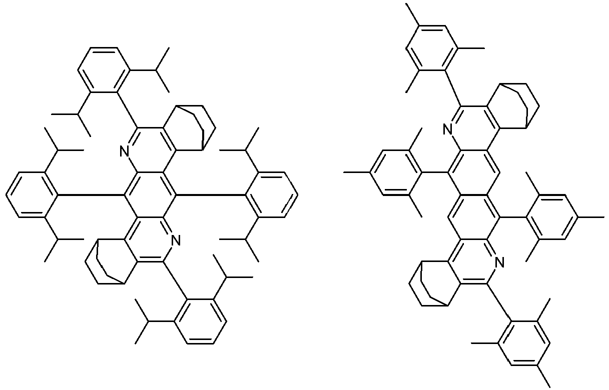

From the state of the art (for example from US2017077418 (A1)), the skilled artisan also knows how to synthesize sterically shielded fluorescent molecules that may be suitable as small FWHM emitters S^{B} in the context of the present invention.

It is understood that sterically shielding substituents (that may or may not be electronically inert as stated above) may be attached to any fluorescent molecules, for example to the aforementioned polycyclic aromatic or heteroaromatic fluorescent cores, the BODIPY-derived structures and the NRCT emitters shown herein and to emitters comprising a structure of formula BNE-1. This may result in sterically shielded fluorescent emitters that may be suitable as small FWHM emitters S^{B} according to the invention.

In one embodiment of the invention, the at least one, preferably each, small FWHM emitter S^{B} fulfills at least one of the following requirements:
(i) it is a boron (B)-containing emitter, which means that at least one atom within each small FWHM emitter S^{B} is boron (B);
(ii) it comprises a polycyclic aromatic or heteroaromatic core structure, wherein at least two aromatic rings are fused together (e.g. anthracene, pyrene or aza-derivatives thereof).

In one embodiment of the invention, the at least one, preferably each small FWHM emitter S^{B} fulfills at least one of the following requirements
(i) it is a boron (B)-containing emitter, which means that at least one atom within the (respective) small FWHM emitter S^{B} is boron (B);
(ii) it comprises a polycyclic aromatic or heteroaromatic core structure, wherein at least two aromatic rings are fused together (e.g. anthracene, pyrene or aza-derivatives thereof).

In one embodiment of the invention, each small FWHM emitter S^{B} is a boron (B)-containing emitter, which means that at least one atom within each small FWHM emitter S^{B} is boron (B).

In one embodiment of the invention, each small FWHM emitter S^{B} comprises a polycyclic aromatic or heteroaromatic core structure, wherein at least two aromatic rings are fused together (e.g. anthracene, pyrene or aza-derivatives thereof).

In one embodiment of the invention, the at least one, preferably each, small FWHM emitter S^{B} fulfills at least one (or both) of the following requirements:
(i) it is a boron (B)-containing emitter, which means that at least one atom within each small FWHM emitter S^{B} is boron (B);
(ii) it comprises a pyrene core structure.

In one embodiment of the invention, the at least one, preferably each small FWHM emitter S^{B} fulfills at least one (or both) of the following requirements
(i) it is a boron (B)-containing emitter, which means that at least one atom within the (respective) small FWHM emitter S^{B} is boron (B);
(ii) it comprises a pyrene core structure.

In one embodiment of the invention, each small FWHM emitter S^{B} comprises a pyrene core structure.

In a preferred embodiment of the invention, each small FWHM emitter S^{B} is a boron (B)- and nitrogen (N)-containing emitter, which means that at least one atom within each small FWHM emitter S^{B} is boron (B) and at least one atom within each small FWHM emitter S^{B} is nitrogen (N).

### Steric Shielding

### Determination of the shielding parameter A

The shielding parameter A of a molecule can be determined as exemplarily described in the following for (fluorescent) emitters, such as those mentioned above. It will be understood that the shielding parameter A typically refers to the unit Angstrom (Å²). This does not imply that only such compounds may be sterically shielded in the context of the present invention, nor that a shielding parameter can only be determined for such compounds.

### 1. Determination of the energy levels of the molecular orbitals

The energy levels of the molecular orbitals may be determined via quantum chemical calculations. For this purpose, in the present case, the Turbomole software package (Turbomole GmbH), version 7.2, may be used. First, a geometry optimization of the ground state of the molecule may be performed using density functional theory (DFT), employing the def2-SV(P) basis set and the BP-86 functional. Subsequently, on the basis of the optimized geometry, a single-point energy calculation for the electronic ground state may be performed employing the B3-LYP functional. From the energy calculation, the highest occupied molecular orbital (HOMO), for example, may obtained as the highest-energy orbital occupied by two electrons, and the lowest unoccupied molecular orbital (LUMO) as the lowest-energy unoccupied orbital. The energy levels may be obtained in an analogous manner for the other molecular orbitals such as HOMO-1, HOMO-2, ... LUMO+1, LUMO+2 etc.

The method described herein is independent of the software package used. Examples of other frequently utilized programs for this purpose may be "Gaussian09" (Gaussian Inc.) and Q-Chem 4.1 (Q-Chem, Inc.).

### 2. Charge-exchanging molecular orbitals of the (fluorescent) compound

Charge-exchanging molecular orbitals of the (fluorescent) compound may be considered to be the HOMO and LUMO, and all molecular orbitals that may be separated in energy by 75 meV or less from the HOMO or LUMO.

### 3. Determination of the active atoms of a molecular orbital

For each charge-exchanging molecular orbital, a determination of which atoms may be active may be conducted. In other words, a generally different set of active atoms may be found for each molecular orbital. There follows a description of how the active atoms of the HOMO may be determined. For all other charge-exchanging molecular orbitals (e.g. HOMO-1, LUMO, LUMO+1, etc.), the active atoms may be determined analogously.

The HOMO may be calculated as described above. To determine the active atoms, the surface on which the orbital has an absolute value of 0.035 ("isosurface with cutoff 0.035") is inspected. For this purpose, in the present case, the Jmol software (http://jmol.sourceforge.net/), version 14.6.4, is used. Atoms around which orbital lobes with values equal to or larger than the cutoff value may be localized may be considered active. Atoms around which no orbital lobes with values equal to or larger than the cutoff value may be localized may be considered inactive.

### (d) Determination of the active atoms in the (fluorescent) compound

If one atom is active in at least one charge-exchanging molecular orbital, it may be considered to be active in respect of the (fluorescent) compound. Only atoms that may be inactive (non-active) in all charge-exchanging molecular orbitals may be inactive in respect of the (fluorescent) compound.

### (e) Determination of the shielding parameter A

In a first step, the solvent accessible surface area SASA may be determined for all active atoms according to the method described in B. Lee, F.M. Richards, Journal of Molecular Biology 1971, 55(3), 379, DOI: 10.1016/0022-2836(71)90324-X. For this purpose, the van-der-Waals surface of the atoms of a molecule may be considered to be impenetrable. The SASA of the entire molecule may be then defined as the area of the surface which may be traced by the center of a hard sphere (also called probe) with radius r (the so-called probe radius) while it may be rolled over all accessible points in space at which its surface may be in direct contact with the van-der-Waals surface of the molecule. The SASA value can also be determined for a subset of the atoms of a molecule. In that case, only the surface traced by the center of the probe at points where the surface of the probe may be in contact with the van-der-Waals surface of the atoms that may be part of the subset may be considered. The Lee-Richards algorithm used to determine the SASA for the present purpose may be part of the program package Free SASA (S. Mitternacht, Free SASA: An open source C library for solvent accessible surface area calculations. F1000Res. 2016; 5:189. Published 2016 Feb 18. doi:10.12688/f1000research.7931.1). The van-der-Waals radii r*_{VDW}* of the relevant elements may be compiled in the following reference: M. Mantina, A.C. Chamberlin, R. Valero, C.J. Cramer, D.G. Truhlar, The Journal of Physical Chemistry A 2009, 113(19), 5806, DOI: 10.1021/jp8111556. The probe radius r may be set to be 4 Å (r = 4 Å) for all SASA determinations for the present purpose.

In the context of the present invention, the shielding parameter A may be obtained by dividing the solvent accessible surface area of the subset of active atoms (labeled S to distinguish from the SASA of the entire molecule) by the number n of active atoms: $A = S / n$

In the context of the present invention, a compound may be defined as sterically well-shielded if the shielding parameter A has a value below 2 Å² (A < 2.0 Å²).

In the context of the present invention, a compound may be defined as sterically shielded if the shielding parameter A has a value of 1.0 to 5.0 Å² (1.0 Å² ≤ A ≤ 5.0 Å²), preferably 2.0 Å² to 5.0 Å² (2.0 Å² ≤ A ≤ 5.0 Å²).

Below, exemplary (fluorescence) emitters are shown, alongside their shielding parameters A, which were determined as stated above. It will be understood that this does not imply that the present invention is limited to organic electroluminescent devices comprising one of the shown emitters. The depicted emitter compounds are merely non-limiting examples that represent optional embodiments of the invention.

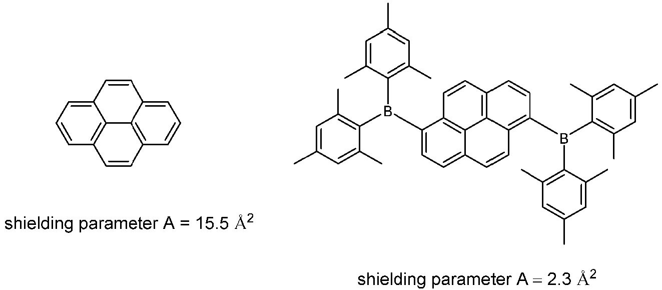

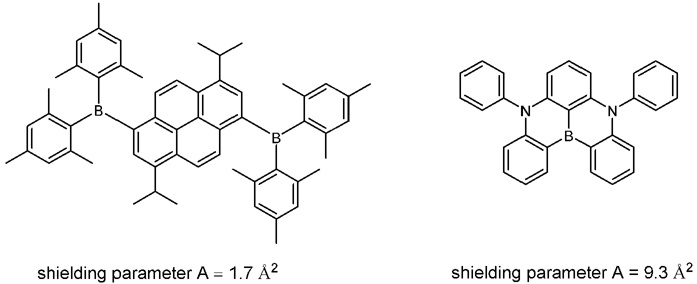

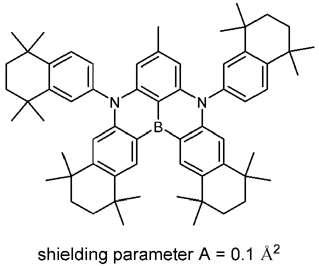

In one embodiment of the invention, each small FWHM emitter S^{B} comprised in an organic electroluminescent device according to the invention exhibits a shielding parameter A equal to or smaller than 5.0 Å².

In a preferred embodiment of the invention, each small FWHM emitter S^{B} comprised in an organic electroluminescent device according to the invention exhibits a shielding parameter A equal to or smaller than 2.0 Å².

The person skilled in the art understands that not only a fluorescent emitter such as a small FWHM emitter S^{B} according to the present invention may be sterically shielded by attaching shielding substituents. It is understood that for example also a TADF material E^{B} in the context of the present invention and also a phosphorescence material P^{B} in the context of the present invention may be shielded.

### Distance between the TADF material E^{B} and the phosphorescence material P^{B}

Herein, the average intermolecular distance d between a TADF material E^{B} and a phosphorescence material P^{B} is calculated as follows: $d = \frac{{ρ}_{{E}^{B}} ⋅ {R}_{{E}^{B} \to {P}^{B}}}{{ρ}_{{E}^{B}} + {ρ}_{{P}^{B}}} + \frac{{ρ}_{{P}^{B}} ⋅ {R}_{{P}^{B} \to {E}^{B}}}{{ρ}_{{E}^{B}} + {ρ}_{{P}^{B}}}$ , wherein *ρ_{EB}* and *ρ_{PB}* are the (spatial) concentrations of a TADF material E^{B} and a phosphorescence material P^{B}, respectively. *R*_{*EB*→}*_{PB}* and *R*_{*PB*→}*_{EB}* are the average distances from a random molecule of a TADF material E^{B} to the next (meaning nearest) molecule of a phosphorescence material P^{B} and vice versa. They are calculated as follows: ${R}_{{E}^{B} \to {P}^{B}} = 0.874 ⋅ {\left(\frac{3}{4 {πρ}_{{P}^{B}}}\right)}^{\frac{1}{3}}$ ${R}_{{P}^{B} \to {E}^{B}} = 0.874 ⋅ {\left(\frac{3}{4 {πρ}_{{E}^{B}}}\right)}^{\frac{1}{3}}$

In one embodiment of the invention, the average intermolecular distance d between a TADF material E^{B} and a phosphorescence material P^{B} fulfills the following requirement: 0.5 nm ≤ d ≤ 5.0 nm.

In one embodiment of the invention, the organic electroluminescent device comprises at least one light-emitting layer B comprising:
(i) at least one host material H^{B}, which has a lowermost excited singlet state energy level E(S1^{H}) and a lowermost excited triplet state energy level E(T1^{H});
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1³) and a lowermost excited triplet state energy level E(T1^{S}), wherein S^{B} emits light with a full width at half maximum (FWHM) of less than or equal to 0.25 eV;
(iv) at least one thermally activated delayed fluorescence (TADF) material E^{B}, which has a lowermost excited singlet state energy level E(S1^{E}) and a lowermost excited triplet state energy level E(T1^{E}),
   wherein the relations expressed by the following formulas (1) and (2) apply: $E \left({T 1}^{H}\right) > E \left({T 1}^{P}\right)$ $E \left({T 1}^{P}\right) > E \left({S 1}^{S}\right)$ and wherein the average intermolecular distance d between a TADF material E^{B} and a phosphorescence material P^{B} fulfills the following requirement: 0.5 nm ≤ d ≤ 5.0 nm.

In one embodiment of the invention, the average intermolecular distance d between a TADF material E^{B} and a phosphorescence material P^{B} fulfills the following requirement: 1.0 nm ≤ d ≤ 5.0 nm.

In a preferred embodiment of the invention, the average intermolecular distance d between a TADF material E^{B} and a phosphorescence material P^{B} fulfills the following requirement: 1.0 nm ≤ d ≤ 4.0 nm.

In a preferred embodiment of the invention, the average intermolecular distance d between a TADF material E^{B} and a phosphorescence material P^{B} fulfills the following requirement: 0.7 nm ≤ d ≤ 4.0 nm.

In one embodiment of the invention, the organic electroluminescent device comprises at least one light-emitting layer B which is composed of one or more sublayers, wherein within the one (sub)layer or within at least one sublayer, the average intermolecular distance d between a TADF material E^{B} and a phosphorescence material P^{B} fulfills the following requirement: 0.5 nm ≤ d ≤ 5.0 nm.

### Excited state lifetimes

A detailed description on how the excited state lifetimes are measured is provided in a following subchapter of this text.

In one embodiment of the invention, a TADF material E^{B} in the context of the present invention exhibits an excited state lifetime τ(E^{B}) equal to or shorter than 110 µs, preferably equal to or shorter than 100 µs. In one embodiment of the invention, each TADF material E^{B} in the context of the present invention exhibits an excited state lifetime τ(E^{B}) equal to or shorter than 110 µs, preferably equal to or shorter than 100 µs.

In one embodiment of the invention, a TADF material E^{B} in the context of the present invention exhibits an excited state lifetime τ(E^{B}) equal to or shorter than 75 µs. In one embodiment of the invention, each TADF material E^{B} in the context of the present invention exhibits an excited state lifetime τ(E^{B}) equal to or shorter than 75 µs.

In one embodiment of the invention, a TADF material E^{B} in the context of the present invention exhibits an excited state lifetime τ(E^{B}) equal to or shorter than 50 µs. In one embodiment of the invention, the at least one, preferably each, TADF material E^{B} exhibits an excited state lifetime τ(E^{B}) equal to or shorter than 50 µs.

In a preferred embodiment of the invention, a TADF material E^{B} in the context of the present invention exhibits an excited state lifetime τ(E^{B}) equal to or shorter than 10 µs. In one embodiment of the invention, the at least one, preferably each, TADF material E^{B} exhibits an excited state lifetime τ(E^{B}) equal to or shorter than 10 µs.

In an even more preferred embodiment of the invention, a TADF material E^{B} in the context of the present invention exhibits an excited state lifetime τ(E^{B}) equal to or shorter than 5 µs. In one embodiment of the invention, the at least one, preferably each, TADF material E^{B} exhibits an excited state lifetime τ(E^{B}) equal to or shorter than 5 µs.

In one embodiment of the invention, a phosphorescence material P^{B} in the context of the present invention exhibits an excited state lifetime τ(P^{B}) equal to or shorter than 50 µs. In one embodiment of the invention, the at least one, preferably each, phosphorescence material P^{B} exhibits an excited state lifetime τ(P^{B}) equal to or shorter than 50 µs.

In a preferred embodiment of the invention, a phosphorescence material P^{B} in the context of the present invention exhibits an excited state lifetime τ(P^{B}) equal to or shorter than 10 µs. In one embodiment of the invention, the at least one, preferably each, phosphorescence material P^{B} exhibits an excited state lifetime τ(P^{B}) equal to or shorter than 10 µs.

In an even more preferred embodiment of the invention, a phosphorescence material P^{B} in the context of the present invention exhibits an excited state lifetime τ(P^{B}) equal to or shorter than 5 µs. In one embodiment of the invention, the at least one, preferably each, phosphorescence material P^{B} exhibits an excited state lifetime τ(P^{B}) equal to or shorter than 5 µs.

In one embodiment of the invention, in an organic electroluminescent device according to the invention, the addition of one or more TADF material E^{B} into one or more sublayers of the one or more light-emitting layers B comprising at least one host material H^{B}, at least one phosphorescence material P^{B}, and at least one small FWHM emitter S^{B} results in a decreased excited state lifetime of the organic electroluminescent device. In a preferred embodiment of the invention the aforementioned addition of a TADF material E^{B} according to the invention decreases the excited state lifetime of the organic electroluminescent device by at least 50%.

### Device architecture

The person skilled in the art will notice that the at least one light-emitting layer B will typically be incorporated in an organic electroluminescent device of the present invention. Preferably, such an organic electroluminescent device comprises at least the following layers: at least one light-emitting layer B, at least one anode layer A and at least one cathode layer C.

Preferably, at least one light-emitting layer B is located between an anode layer A and a cathode layer C. Accordingly, the general set-up is preferably A - B - C. This does of course not exclude the presence of one or more optional further layers. These can be present at each side of A, of B and/or of C.

Preferably, the anode layer A is located on the surface of a substrate. The substrate may be formed by any material or composition of materials. Most frequently, glass slides are used as substrates. Alternatively, thin metal layers (e.g., copper, gold, silver or aluminum films) or plastic films or slides may be used. This may allow a higher degree of flexibility. As at least one of both electrodes should be (essentially) transparent in order to allow light emission from the electroluminescent device (e.g., OLED). Usually, the anode layer A is mostly composed of materials allowing to obtain an (essentially) transparent film. Preferably, the anode layer A comprises a large content or even consists of transparent conductive oxides (TCOs).

Such an anode layer A may exemplarily comprise indium tin oxide, aluminum zinc oxide, fluor tin oxide, indium zinc oxide, PbO, SnO, zirconium oxide, molybdenum oxide, vanadium oxide, wolfram oxide, graphite, doped Si, doped Ge, doped GaAs, doped polyaniline, doped polypyrrol and/or doped polythiophene and mixtures of two or more thereof.

Particularly preferably, the anode layer A (essentially) consists of indium tin oxide (ITO) (e.g., (InO₃)_{0.9}(SnO₂)_{0.1}). The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), MoO₂, V₂O₅, CuPC or Cul, in particular a mixture of PEDOT and PSS. The hole injection layer (HIL) may also prevent the diffusion of metals from the anode layer A into the hole transport layer (HTL). The HIL may exemplarily comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl)bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)-benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to the anode layer A or hole injection layer (HIL) typically a hole transport layer (HTL) is located. Herein, any hole transport compound may be used. Exemplarily, electron-rich heteroaromatic compounds such as triarylamines and/or carbazoles may be used as hole transport compound. The HTL may decrease the energy barrier between the anode layer A and the light-emitting layer B (serving as emitting layer (EML)). The hole transport layer (HTL) may also be an electron blocking layer (EBL). Preferably, hole transport compounds bear comparably high energy levels of their triplet states T1. Exemplarily the hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)-amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, the HTL may comprise a p-doped layer, which may be composed of an inorganic or organic dopant in an organic hole-transporting matrix. Transition metal oxides such as vanadium oxide, molybdenum oxide or tungsten oxide may exemplarily be used as inorganic dopant. Tetrafluorotetracyanoquinodimethane (F4-TCNQ), copper-pentafluorobenzoate (Cu(I)pFBz) or transition metal complexes may exemplarily be used as organic dopant.

The EBL may exemplarily comprise mCP (1,3-bis(carbazol-9-yl)benzene), TCTA, 2-TNATA, mCBP (3,3-di(9H-carbazol-9-yl)biphenyl), 9-[3-(dibenzofuran-2-yl)phenyl]-9*H*-carbazole, 9-[3-(dibenzofuran-2-yl)phenyl]-9*H*-carbazole, 9-[3-(dibenzothiophen-2-yl)phenyl]-9*H*-carbazole, 9-[3,5-bis(2-dibenzofuranyl)phenyl]-9*H*-carbazole, 9-[3,5-bis(2-dibenzothiophenyl)phenyl]-9*H*-carbazole, tris-Pcz, CzSi (9-(4-tert-butylphenyl)-3,6-bis(triphenylsilyl)-9H-carbazole), and/or DCB (N,N'-dicarbazolyl-1,4-dimethylbenzene).

The composition of the at least one light-emitting layer B has been described above. Any of the one or more light-emitting layers B according to the invention preferably bears a thickness of not more than 1 mm, more preferably of not more than 0.1 mm, even more preferably of not more than 10 µm, even more preferably of not more than 1 µm, and particularly preferably of not more than 0.1 µm.

In the electron transport layer (ETL), any electron transporter may be used. Exemplarily, compounds poor of electrons such as, e.g., benzimidazoles, pyridines, triazoles, oxadiazoles (e.g., 1,3,4-oxadiazole), phosphinoxides and sulfone, may be used. Exemplarily, an electron transporter ETM may also be a star-shaped heterocycle such as 1 ,3,5-tri(1-phenyl-1H-benzo[d]imidazol-2-yl)phenyl (TPBi). The ETM may exemplarily be NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the electron transport layer may be doped with materials such as Liq (8-hydroxyquinolinolatolithium). Optionally, a second electron transport layer may be located between electron transport layer and the cathode layer C. The electron transport layer (ETL) may also block holes or a hole-blocking layer (HBL) is introduced.

The HBL may, for example, comprise HBM1: 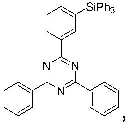 BCP (2,9-dimethyl-4,7-diphenyl-1,10-phenanthroline = Bathocuproine), BAIq (bis(8-hydroxy-2-methylquinoline)-(4-phenylphenoxy)aluminum), NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), DTST (2,4-diphenyl-6-(3'-triphenylsilylphenyl)-1,3,5-triazine), DTDBF (2,8-bis(4,6-diphenyl-1,3,5-triazinyl)dibenzofurane) and/or TCB/TCP (1,3,5-tris(N-carbazolyl)benzol/ 1,3,5-tris(carbazol)-9-yl) benzene).

Adjacent to the electron transport layer (ETL), a cathode layer C may be located. Exemplarily, the cathode layer C may comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer C may also consist of (essentially) intransparent (non-transparent) metals such as Mg, Ca or Al. Alternatively or additionally, the cathode layer C may also comprise graphite and or carbon nanotubes (CNTs). Alternatively, the cathode layer C may also consist of nanoscale silver wires.

In a preferred embodiment, the organic electroluminescent device comprises at least the following layers:
A) an anode layer A containing at least one component selected from the group consisting of indium tin oxide, indium zinc oxide, PbO, SnO, graphite, doped silicium, doped germanium, doped GaAs, doped polyaniline, doped polypyrrole, doped polythiophene, and mixtures of two or more thereof;
B) a light-emitting layer B according to present invention as described herein; and
C) a cathode layer C containing at least one component selected from the group consisting of Al,Au, Ag, Pt, Cu, Zn, Ni, Fe, Pb, In, W, Pd, LiF, Ca, Ba, Mg, and mixtures or alloys of two or more thereof,
wherein the light-emitting layer B is located between the anode layer A and the a cathode layer C.

In one embodiment, when the organic electroluminescent device is an OLED, it may optionally comprise the following layer structure:
A) an anode layer A, exemplarily comprising indium tin oxide (ITO); HTL) a hole transport layer HTL;
B) a light-emitting layer B according to present invention as described herein; ETL) an electron transport layer ETL; and
C) a cathode layer, exemplarily comprising Al, Ca and/or Mg.

Preferably, the order of the layers herein is A - HTL - B - ETL - C.

Furthermore, the organic electroluminescent device may optionally comprise one or more protective layers protecting the device from damaging exposure to harmful species in the environment including, exemplarily moisture, vapor and/or gases.

An electroluminescent device (e.g., an OLED) may further, optionally, comprise a protection layer between the electron transport layer (ETL) D and the cathode layer C (which may be designated as electron injection layer (EIL)). This layer may comprise lithium fluoride, caesium fluoride, silver, Liq (8-hydroxyquinolinolatolithium), Li₂O, BaF₂, MgO and/or NaF.

Unless otherwise specified, any of the layers, including any of the sublayers, of the various embodiments may be deposited by any suitable method. The layers in the context of the present invention, including at least one light-emitting layer B (which may consist of a single (sub)layer or may comprise more than one sublayers) and/or one or more sublayers thereof, may optionally be prepared by means of liquid processing (also designated as "film processing", "fluid processing", "solution processing" or "solvent processing"). This means that the components comprised in the respective layer are applied to the surface of a part of a device in liquid state. Preferably, the layers in the context of the present invention, including the at least one light-emitting layer B and/or one or more sublayers thereof, may be prepared by means of spin-coating. This method well-known to those skilled in the art allows obtaining thin and (essentially) homogeneous layers and/or sublayers.

Alternatively, the layers in the context of the present invention, including the at least one light-emitting layer B and/or one or more sublayers thereof, may be prepared by other methods based on liquid processing such as, e.g., casting (e.g., drop-casting) and rolling methods, and printing methods (e.g., inkjet printing, gravure printing, blade coating). This may optionally be carried out in an inert atmosphere (e.g., in a nitrogen atmosphere).

In another preferred embodiment, the layers in the context of the present invention, including the at least one light-emitting layer B and/or one or more sublayers thereof, may be prepared by any other method known in the art, including but not limited to vacuum processing methods well-known to those skilled in the art such as, e.g., thermal (co-)evaporation, organic vapor phase deposition (OVPD), and deposition by organic vapor jet printing (OVJP).

When preparing layers, optionally including one or more sublayers thereof, by means of liquid processing, the solutions including the components of the (sub)layers (i.e., with respect to the light-emitting layer B of the present invention, at least one host material H^{B}, at least one phosphorescence material P^{B}, at least one small FWHM emitter S^{B}, and optionally a (i.e., at least one) TADF material E^{B}) may further comprise a volatile organic solvent. Such volatile organic solvent may optionally be one selected from the group consisting of tetrahydrofuran, dioxane, chlorobenzene, diethylene glycol diethyl ether, 2-(2-ethoxyethoxy)ethanol, gamma-butyrolactone, N-methyl pyrrolidinon, ethoxyethanol, xylene, toluene, anisole, phenetol, acetonitrile, tetrahydrothiophene, benzonitrile, pyridine, trihydrofuran, triarylamine, cyclohexanone, acetone, propylene carbonate, ethyl acetate, benzene and PGMEA (propylen glycol monoethyl ether acetate). Also a combination of two or more solvents may be used. After applied in liquid state, the layer may subsequently be dried and/or hardened by any means of the art, exemplarily at ambient conditions, at increased temperature (e.g., about 50°C or about 60°C) or at diminished pressure.

The organic electroluminescent device as a whole may also form a thin layer of a thickness of not more than 5 mm, more than 2 mm, more than 1 mm, more than 0.5 mm, more than 0.25 mm, more than 100 µm, or more than 10 µm.

An organic electroluminescent device (e.g., an OLED) may be a small-sized (e.g., having a surface not larger than 5 mm², or even not larger than 1 mm²), medium-sized (e.g., having a surface in the range of 0.5 to 20 cm²), or a large-sized (e.g., having a surface larger than 20 cm²). An organic electroluminescent device (e.g., an OLED) according to the present invention may optionally be used for generating screens, as large-area illuminating device, as luminescent wallpaper, luminescent window frame or glass, luminescent label, luminescent poser or flexible screen or display. Next to the common uses, an organic electroluminescent device (e.g., an OLED) may exemplarily also be used as luminescent films, "smart packaging" labels, or innovative design elements. Further they are usable for cell detection and examination (e.g., as bio labelling).

### Further definitions and information

As used throughout, the term "layer" in the context of the present invention preferably refers to a body that bears an extensively planar geometry. It is understood that the same is true for all "sublayers" which a layer may compose.

As used herein, the terms organic electroluminescent device and optoelectronic light-emitting device may be understood in the broadest sense as any device comprising one or more light-emitting layers B, each comprising as a whole at least one host material H^{B}, at least one phosphorescence material P^{B}, at least one small FWHM emitter S^{B}, and optionally one or more TADF material E^{B}, for all of which the above-mentioned definitions apply.

The organic electroluminescent device may be understood in the broadest sense as any device based on organic materials that is suitable for emitting light in the visible or nearest ultraviolet (UV) range, i.e., in the wavelength range from 380 to 800 nm. Preferably, an organic electroluminescent device may be able to emit light in the visible range, i.e., from 400 to 800 nm.

Preferably, an organic electroluminescent device has a main emission peak in the visible range, i.e., from 380 to 800 nm, more preferably from 400 to 800 nm.

In one embodiment of the invention, the organic electroluminescent device emits green light from 500 to 560 nm. In one embodiment of the invention, the organic electroluminescent device has a main emission peak in the range of from 500 to 560 nm.

In a preferred embodiment of the invention, the organic electroluminescent device emits green light from 510 to 550 nm. In one embodiment of the invention, the organic electroluminescent device has a main emission peak in the range of from 510 to 550 nm.

In an even more preferred embodiment of the invention, the organic electroluminescent device emits green light from 515 to 540 nm. In one embodiment of the invention, the organic electroluminescent device has a main emission peak in the range of from 515 to 540 nm.

In one embodiment of the invention, the organic electroluminescent device emits blue light from 420 to 500 nm. In one embodiment of the invention, the organic electroluminescent device has a main emission peak in the range of from 420 to 500 nm.

In a preferred embodiment of the invention, the organic electroluminescent device emits blue light from 440 to 480 nm. In one embodiment of the invention, the organic electroluminescent device has a main emission peak in the range of from 440 to 480 nm.

In an even more preferred embodiment of the invention, the organic electroluminescent device emits blue light from 450 to 470 nm. In one embodiment of the invention, the organic electroluminescent device has a main emission peak in the range of from 450 to 470 nm.

In one embodiment of the invention, the organic electroluminescent device emits red or orange light from 590 to 690 nm. In one embodiment of the invention, the organic electroluminescent device has a main emission peak in the range of from 590 to 690 nm.

In a preferred embodiment of the invention, the organic electroluminescent device emits red or orange light from 610 to 665 nm. In one embodiment of the invention, the organic electroluminescent device has a main emission peak in the range of from 610 to 665 nm.

In an even more preferred embodiment of the invention, the organic electroluminescent device emits red light from 620 to 640 nm. In one embodiment of the invention, the organic electroluminescent device has a main emission peak in the range of from 620 to 640 nm.

In a preferred embodiment of the invention, the organic electroluminescent device is a device selected from the group consisting of an organic light-emitting diode (OLED), a light-emitting electrochemical cell (LEC), and a light-emitting transistor.

Particularly preferably, the organic electroluminescent device is an organic light-emitting diode (OLED). Optionally, the organic electroluminescent device as a whole may be intransparent (non-transparent), semi-transparent or (essentially) transparent.

As used throughout the present application, the term "cyclic group" may be understood in the broadest sense as any mono-, bi- or polycyclic moieties.

As used throughout the present application, the terms "ring" and "ring system" may be understood in the broadest sense as any mono-, bi- or polycyclic moieties.

The term "ring atom" refers to any atom which is part of the cyclic core of a ring or a ring structure, and not part of a substituent optionally attached to it.

As used throughout the present application, the term "carbocycle" may be understood in the broadest sense as any cyclic group in which the cyclic core structure comprises only carbon atoms that may of course be substituted with hydrogen or any other substituents defined in the specific embodiments of the invention. It is understood that the term "carbocyclic" as adjective refers to cyclic groups in which the cyclic core structure comprises only carbon atoms that may of course be substituted with hydrogen or any other substituents defined in the specific embodiments of the invention.

As used throughout the present application, the term "heterocycle" may be understood in the broadest sense as any cyclic group in which the cyclic core structure comprises not just carbon atoms, but also at least one heteroatom. It is understood that the term "heterocyclic" as adjective refers to cyclic groups in which the cyclic core structure comprises not just carbon atoms, but also at least one heteroatom. The heteroatoms may, unless stated otherwise in specific embodiments, at each occurrence be the same or different and be individually selected from the group consisting of N, O, S, and Se. All carbon atoms or heteroatoms comprised in a heterocycle in the context of the invention may of course be substituted with hydrogen or any other substituents defined in the specific embodiments of the invention.

As used throughout the present application, the term "aromatic ring system" may be understood in the broadest sense as any bi- or polycyclic aromatic moiety.

As used throughout the present application, the term "heteroaromatic ring system" may be understood in the broadest sense as any bi- or polycyclic heteroaromatic moiety.

As used throughout the present application, the term "fused" when referring to aromatic or heteroaromatic ring systems means that the aromatic or hetroaromatic rings that are "fused" share at least one bond that is part of both ring systems. For example naphthalene (or naphthyl when referred to as substituent) or benzothiophene (or benzothiophenyl when referred to as substituent) are considered fused aromatic ring systems in the context of the present invention, in which two benzene rings (for naphthalene) or a thiophene and a benzene (for benzothiophene) share one bond. It is also understood that sharing a bond in this context includes sharing the two atoms that build up the respective bond and that fused aromatic or heteroaromatic ring systems can be understood as one aromatic or heteroaromatic system. Additionally, it is understood, that more than one bond may be shared by the aromatic or heteroaromatic rings building up a fused aromatic or heteroaromatic ring system (e.g. in pyrene). Furthermore, it will be understood that aliphatic ring systems may also be fused and that this has the same meaning as for aromatic or heteroaromatic ring systems, with the exception of course, that fused aliphatic ring systems are not aromatic.

As used throughout the present application, the terms "aryl" and "aromatic" may be understood in the broadest sense as any mono-, bi- or polycyclic aromatic moieties. Accordingly, an aryl group contains 6 to 60 aromatic ring atoms, and a heteroaryl group contains 5 to 60 aromatic ring atoms, of which at least one is a heteroatom. Notwithstanding, throughout the application the number of aromatic ring atoms may be given as subscripted number in the definition of certain substituents. In particular, the heteroaromatic ring includes one to three heteroatoms. Again, the terms "heteroaryl" and "heteroaromatic" may be understood in the broadest sense as any mono-, bi- or polycyclic hetero-aromatic moieties that include at least one heteroatom. The heteroatoms may at each occurrence be the same or different and be individually selected from the group consisting of N, O, S, and Se. Accordingly, the term "arylene" refers to a divalent substituent that bears two binding sites to other molecular structures and thereby serving as a linker structure. In case, a group in the exemplary embodiments is defined differently from the definitions given here, for example, the number of aromatic ring atoms or number of heteroatoms differs from the given definition, the definition in the exemplary embodiments is to be applied. According to the invention, a condensed (annulated) aromatic or heteroaromatic polycycle is built of two or more single aromatic or heteroaromatic cycles, which formed the polycycle via a condensation reaction.

In particular, as used throughout the present application the term "aryl group" or "heteroaryl group" comprises groups which can be bound via any position of the aromatic or heteroaromatic group, derived from benzene, naphthalene, anthracene, phenanthrene, pyrene, dihydropyrene, chrysene, perylene, fluoranthene, benzanthracene, benzphenanthrene, tetracene, pentacene, benzpyrene, furan, benzofuran, isobenzofuran, dibenzofuran, thiophene, benzothiophene, isobenzothiophene, dibenzothiophene; selenophene, benzoselenophene, isobenzoselenophene, dibenzoselenophene; pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, purine, pteridine, indolizine and benzothiadiazole or combinations of the abovementioned groups.

In certain embodiments of the invention, adjacent substituents bonded to an aromatic or heteroaromatic ring may together form an additional aliphatic or aromatic, carbocyclic or heterocyclic ring system which is fused to the aromatic or heteroaromatic ring to which the substituents are bonded. It is understood that the optionally so formed fused ring system will be larger (meaning it comprises more ring atoms) than the aromatic or heteroaromatic ring to which the adjacent substituents are bonded. In these cases, the "total" amount of ring atoms comprised in the fused ring system is to be understood as the sum of ring atoms comprised in the aromatic or heteroaromatic ring to which the adjacent substituents are bonded and the ring atoms of the additional ring system formed by the adjacent substituents, wherein, however, the carbon atoms that are shared by the ring systems which are fused are counted once and not twice. For example, a benzene ring may have two adjacent substituents that form another benzene ring so that a naphthalene core is built. This naphthalene core then comprises 10 ring atoms as two carbon atoms are shared by the two benzene rings and thus only counted once and not twice. The term "adjacent substituents" in this context refers to substituents attached to the same or to neighbouring ring atoms (e.g., of a ring system).

As used throughout the present application, the term "aliphatic" when referring to ring systems may be understood in the broadest sense and means that none of the rings that build up the ring system is an aromatic or heteroaromatic ring. It is understood that such an aliphatic ring system may be fused to one or more aromatic rings so that some (but not all) carbon- or heteroatoms comprised in the core structure of the aliphatic ring system are part of an attached aromatic ring.

As used above and herein, the term "alkyl group" may be understood in the broadest sense as any linear, branched, or cyclic alkyl substituent. In particular, the term alkyl comprises the substituents methyl (Me), ethyl (Et), n-propyl (ⁿPr), i-propyl (ⁱPr), cyclopropyl, n-butyl (ⁿBu), i-butyl (ⁱBu), s-butyl (^{s}Bu), t-butyl (^{t}Bu), cyclobutyl, 2-methylbutyl, n-pentyl, s-pentyl, t-pentyl, 2-pentyl, neo-pentyl, cyclopentyl, n-hexyl, s-hexyl, t-hexyl, 2-hexyl, 3-hexyl, neo-hexyl, cyclohexyl, 1-methylcyclopentyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2,2,2]octyl, 2-bicyclo[2,2,2]-octyl, 2-(2,6-dimethyl)octyl, 3-(3,7-dimethyl)octyl, adamantyl, 2,2,2-trifluorethyl, 1,1-dimethyl-n-hex-1-yl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1,1-diethyl-n-octadec-1-yl, 1-(n-propyl)-cyclohex-1-yl, 1-(n-butyl)-cyclohex-1-yl, 1-(n-hexyl)-cyclohex-1-yl, 1-(n-octyl)-cyclohex-1-yl and 1-(n-decyl)-cyclohex-1-yl.

As used above and herein, the term "alkenyl" comprises linear, branched, and cyclic alkenyl substituents. The term alkenyl group exemplarily comprises the substituents ethenyl, propenyl, butenyl, pentenyl, cyclopentenyl, hexenyl, cyclohexenyl, heptenyl, cycloheptenyl, octenyl, cyclooctenyl or cyclooctadienyl.

As used above and herein, the term "alkynyl" comprises linear, branched, and cyclic alkynyl substituents. The term alkynyl group exemplarily comprises ethynyl, propynyl, butynyl, pentynyl, hexynyl, heptynyl or octynyl.

As used above and herein, the term "alkoxy" comprises linear, branched, and cyclic alkoxy substituents. The term alkoxy group exemplarily comprises methoxy, ethoxy, n-propoxy, i-propoxy, n-butoxy, i-butoxy, s-butoxy, t-butoxy and 2-methylbutoxy.

As used above and herein, the term "thioalkoxy" comprises linear, branched, and cyclic thioalkoxy substituents, in which the O of the exemplarily alkoxy groups is replaced by S.

As used above and herein, the terms "halogen" and "halo" may be understood in the broadest sense as being preferably fluorine, chlorine, bromine or iodine.

All hydrogen atoms (H) comprised in any structure referred to herein may at each occurrence independently of each other, and without this being indicated specifically, be replaced by deuterium (D). The replacement of hydrogen by deuterium is common practice and obvious for the person skilled in the art who also knows how to achieve this synthetically.

It is understood that when a molecular fragment is described as being a substituent or otherwise attached to another moiety, its name may be written as if it were a fragment (e.g. naphthyl, dibenzofuryl) or as if it were the whole molecule (e.g. naphthalene, dibenzofuran). As used herein, these different ways of designating a substituent or attached fragment are considered to be equivalent.

When referring to concentrations or compositions and unless stated otherwise, percentages refer to weight percentages, which has the same meaning as percent by weight or% by weight ((weight/weight), (w/w), wt.%).

Orbital and excited state energies can be determined either by means of experimental methods or by calculations employing quantum-chemical methods, in particular density functional theory calculations. Herein, the energy of the highest occupied molecular orbital E^{HOMO} is determined by methods known to the person skilled in the art from cyclic voltammetry measurements with an accuracy of 0.1 eV. The energy of the lowest unoccupied molecular orbital E^{LUMO} may be determined by methods known to the person skilled in the art from cyclic voltammetry measurements with an accuracy of 0.1 eV. Alternatively, and herein preferably, E^{LUMO} is calculated as E^{HOMO} + E^{gap}, wherein the energy of the first excited singlet state S1 (vide infra) is used as E^{gap}, unless stated otherwise, for host materials H^{B}, TADF materials E^{B}, and small FWHM emitters S^{B}. This is to say that for host materials H^{B}, TADF materials E^{B}, and small FWHM emitters S^{B}, E^{gap} is determined from the onset of the emission spectrum at room temperature (i.e. approx. 20°C) (steady-state spectrum; for TADF materials E^{B} a film of 10% by weight of E^{B} in poly(methyl methacrylate) (PMMA) is typically used; for small FWHM emitters S^{B}, a film of 1-5%, preferably 2% by weight of S^{B} in PMMA is typically used; for host materials H^{B}, a neat film of the respective host material H^{B} is typically used). For phosphorescence materials P^{B}, E^{gap} is also determined from the onset of the emission spectrum at room temperature (i.e. approx. 20°C) (steady-state spectrum, typically measured from a film of 10% by weight of P^{B} in PMMA).

Absorption spectra are recorded at room temperature (i.e. approximately 20°C). For TADF materials E^{B}, absorption spectra are typically measured from a film of 10% by weight of E^{B} in poly(methyl methacrylate) (PMMA). For small FWHM emitters S^{B} absorption spectra are typically measured from a film of 1-5%, preferably 2% by weight of S^{B} in PMMA. For host materials H^{B} absorption spectra are typically measured from a neat film of the host material H^{B}. For phosphorescence materials P^{B}, absorption spectra are typically measured from a film of 10% by weight of P^{B} in PMMA. Alternatively, absorption spectra may also be recorded from solutions of the respective molecules, for example in dichloromethane or toluene, wherein the concentration of the solution is typically chosen so that the maximum absorbance preferably is in a range of 0.1 to 0.5.

The onset of an absorption spectrum is determined by computing the intersection of the tangent to the absorption spectrum with the x-axis. The tangent to the absorption spectrum is set at the low-energy side of the absorption band and at the point at half maximum of the maximum intensity of the absorption spectrum.

Unless stated otherwise, the energy of the first excited triplet state T1 is determined from the onset the phosphorescence spectrum at 77K (steady-state spectrum; for TADF materials E^{B} a film of 10% by weight of E^{B} in PMMA is typically used; for small FWHM emitters S^{B} a film of 1-5%, preferably 2% by weight of S^{B} in PMMA is typically used; for host materials H^{B}, a neat film of the respective host material H^{B} is typically used; for phosphorescence materials P^{B} a film of 10% by weight of P^{B} in PMMA is typically used and the measurement is typically performed at room temperature, i.e. approximately 20°C). As laid out for instance in EP2690681A1, it is acknowledged that for TADF materials E^{B} with small ΔE_{ST} values, intersystem crossing and reverse intersystem crossing may both occur even at low temperatures. In consequence, the emission spectrum at 77K may include emission from both, the S1 and the T1 state. However, as also described in EP2690681A1, the contribution / value of the triplet energy is typically considered dominant.

Unless stated otherwise, the energy of the first excited singlet state S1 is determined from the onset the fluorescence spectrum at room temperature (i.e. approx. 20°C) (steady-state spectrum; for TADF materials E^{B} a film of 10% by weight of E^{B} in PMMA is typically used; for small FWHM emitters S^{B} a film of 1-5%, preferably 2% by weight of S^{B} in PMMA is typically used; for host materials H^{B}, a neat film of the respective host material H^{B} is typically used; for phosphorescence materials P^{B} a film of 10% by weight of P^{B} in PMMA is typically used). For phosphorescence materials P^{B} displaying efficient intersystem crossing however, room temperature emission may be (mostly) phosphorescence and not fluorescence. In this case, the onset of the emission spectrum at room temperature (i.e. approx. 20°C) is used to determine the energy of the first excited triplet state T1 as stated above.

The onset of an emission spectrum is determined by computing the intersection of the tangent to the emission spectrum with the x-axis. The tangent to the emission spectrum is set at the high-energy side of the emission band and at the point at half maximum of the maximum intensity of the emission spectrum.

The ΔE_{ST} value, which corresponds to the energy difference between the first excited singlet state (S1) and the first excited triplet state (T1), is determined based on the first excited singlet state energy and the first excited triplet state energy, which were determined as stated above.

As known to the skilled artisan, the full width at half maximum (FWHM) of an emitter (for example a small FWHM emitter S^{B}) is readily determined from the respective emission spectrum (fluorescence spectrum for fluorescent emitters and phosphorescence spectrum for phosphorescent emitters). For small FWHM emitters S^{B}, the fluorescence spectrum is typically used. All reported, FWHM values typically refer to the main emission peak (i.e. the peak with the highest intensity). The means of determining the FWHM (herein preferably reported in electron volts, eV) are part of the common knowledge of those skilled in the art. Given for example that the main emission peak of an emission spectrum reaches its half maximum emission (i.e. 50% of the maximum emission intensity) at the two wavelengths λ₁ and λ₂, both obtained in nanometers (nm) from the emission spectrum, the FWHM in electron volts (eV) is commonly (and herein) determined using the following equation: $FWHM \left[eV\right] = \left|\frac{1239.84}{{λ}_{2} \left[nm\right]}-\frac{1239.84}{{λ}_{1} \left[nm\right]}\right|$

As used herein, if not defined more specifically in a particular context, the designation of the colors of emitted and/or absorbed light is as follows:

| | |
|---|---|
| violet: | wavelength range of >380-420 nm; |
| deep blue: | wavelength range of >420-475 nm; |
| sky blue: | wavelength range of >475-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

The invention is illustrated by the following examples and the claims.

### Examples

### Cyclic voltammetry

Cyclic voltammograms of solutions having concentration of 10⁻³ mol/l of the organic molecules in dichloromethane or a suitable solvent and a suitable supporting electrolyte (e.g. 0.1 mol/l of tetrabutylammonium hexafluorophosphate) are measured. The measurements are conducted at room temperature and under nitrogen atmosphere with a three-electrode assembly (working and counter electrodes: Pt wire, reference electrode: Pt wire) and calibrated using FeCp₂/FeCp₂⁺ as internal standard. HOMO and LUMO data was corrected using ferrocene as internal standard against SCE.

### Density functional theory calculation

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. However, herein, orbital and excited state energies are preferably determined experimentally as stated above.

All orbital and excited state energies reported herein (see experimental results) havbeen determined experimentally. Def2-SVP basis sets and a m4-grid for numerical integration were used. The Turbomole program package was used for all calculations.

### Photophysical measurements

### Sample pretreatment: vacuum-evaporation

As stated before, photophysical measurements of individual compounds (for example organic molecules or transition metal complexes) that may be comprised in a light-emitting layer B of the organic electroluminescent device according to the present invention (i.e. host materials H^{B}, TADF materials E^{B}, phosphorescent materials P^{B} or small FWHM emitters S^{B}) were typically performed using either neat films (in case of host materials H^{B}) or films of the respective material in poly(methyl methacrylate) (PMMA) (for TADF materials E^{B}, phosphorescent materials P^{B}, and small FWHM emitters S^{B}). These films were spin coated films and, unless stated differently for specific measurements, the concentration of the materials in the PMMA-films was 10% by weight for TADF materials E^{B} and for phosphorescent materials P^{B} or 1-5%, preferably 2% by weight for small FWHM emitters S^{B}. Alternatively (not preferred), and as stated previously, some photophysical measurements may also be performed from solutions of the respective molecules, for example in dichloromethane or toluene, wherein the concentration of the solution is typically chosen so that the maximum absorbance preferably is in a range of 0.1 to 0.5.

For the purpose of further studying compositions of certain materials as present in the EML of organic electroluminescent devices (according to the present invention or comparative), the samples for photophysical measurements were produced from the same materials used for device fabrication by vacuum deposition of 50 nm of the respective light-emitting layer B on quartz substrates. Photophysical characterization of the samples are conducted under nitrogen atmosphere.

### Absorption measurements

A Thermo Scientific Evolution 201 UV-Visible Spectrophotometer is used to determine the wavelength of the absorption maximum of the sample in the wavelength region above 270 nm. This wavelength is used as excitation wavelength for photoluminescence spectral and quantum yield measurements.

### Photoluminescence spectra

Steady-state emission spectra are recorded using a Horiba Scientific, Modell FluoroMax-4 equipped with a 150 W Xenon-Arc lamp, excitation- and emissions monochromators. The samples are placed in a cuvette and flushed with nitrogen during the measurements.

### Photoluminescence quantum yield measurements

For photoluminescence quantum yield (PLQY) measurements an integrating sphere, the *Absolute PL Quantum Yield Measurement C9920-03G* system (*Hamamatsu Photonics*) is used. The samples are kept under nitrogen atmosphere throughout the measurement. Quantum yields are determined using the software U6039-05 and given in%. The yield is calculated using the equation: ${Φ}_{PL} = \frac{{n}_{photon} , emited}{{n}_{photon} , absorbed} = \frac{\int \frac{λ}{hc} \left[{Int}_{emitted}^{sample}\left(λ\right)-{Int}_{absorbed}^{sample}\left(λ\right)\right] dλ}{\int \frac{λ}{hc} \left[{Int}_{emitted}^{reference}\left(λ\right)-{Int}_{absorbed}^{refecence}\left(λ\right)\right] dλ}$ wherein nₚₕₒₜₒₙ denotes the photon count and Int. is the intensity. For quality assurance, anthracene in ethanol (known concentration) is used as reference.

### TCSPC (Time-correlated single-photon counting)

Excited state population dynamics are determined employing Edinburgh Instruments FS5 Spectrofluoremeters, equipped with an emission monochromator, a temperature stabilized photomultiplier as detector unit and a pulsed LED (310 nm central wavelength, 910 ps pulse width) as excitation source. The samples are placed in a cuvette and flushed with nitrogen during the measurements.

### Full decay dynamics

The full excited state population decay dynamics over several orders of magnitude in time and signal intensity is achieved by carrying out TCSPC measurements in 4 time windows: 200 ns, 1 µs, and 20 µs, and a longer measurement spanning > 80 µs. The measured time curves are then processed in the following way:
1. A background correction is applied by determining the average signal level before excitation and subtracting.
2. The time axes are aligned by taking the initial rise of the main signal as reference.
3. The curves are scaled onto each other using overlapping measurement time regions.
4. The processed curves are merged to one curve.

### Data Analysis

Data analysis was done using monoexponential and bi-exponential fitting of prompt fluorescence(PF) and delayed fluorescence(DF) decays separately. The ratio of delayed and prompt fluorescence (n- value) is calculated by the integration of respective photoluminescence decays in time. $\frac{\int {I}_{DF} \left(t\right) dt}{\int {I}_{PF} \left(t\right) dt} = n$

The average excited state life time is calculated by taking the average of prompt and delayed fluorescence decay time, weighted with the respective contributions of PF and DF.

### Production and characterization of organic electroluminescence devices

Via vacuum-deposition methods OLED devices comprising organic molecules according to the invention can be produced. If a layer contains more than one compound, the weight-percentage of one or more compounds is given in%. The total weight-percentage values amount to 100%, thus if a value is not given, the fraction of this compound equals to the difference between the given values and 100%.

The not fully optimized OLEDs are characterized using standard methods and measuring electroluminescence spectra, the external quantum efficiency (in%) in dependency on the intensity, calculated using the light detected by the photodiode, and the current. The FWHM of the devices is determined from the electroluminescence spectra as stated previously for photoluminescence spectra (fluorescence or phosphorescence). The reported FWHM refers to the main emission peak (i.e. the peak with the highest emission intensity). The OLED device lifetime is extracted from the change of the luminance during operation at constant current density. The LT50 value corresponds to the time, where the measured luminance decreased to 50% of the initial luminance, analogously LT80 corresponds to the time point, at which the measured luminance decreased to 80% of the initial luminance, LT97 to the time point, at which the measured luminance decreased to 97% of the initial luminance etc.

Accelerated lifetime measurements are performed (e.g. applying increased current densities). Exemplarily LT80 values at 500 cd/m² are determined using the following equation: $LT 80 \left(500\frac{{cd}^{2}}{{m}^{2}}\right) = LT 80 \left({L}_{0}\right) {\left(\frac{{L}_{0}}{500 \frac{{cd}^{2}}{{m}^{2}}}\right)}^{1.6}$ wherein *L₀* denotes the initial luminance at the applied current density. The values correspond to the average of several pixels (typically two to eight).

### Experimental results

### Stack materials

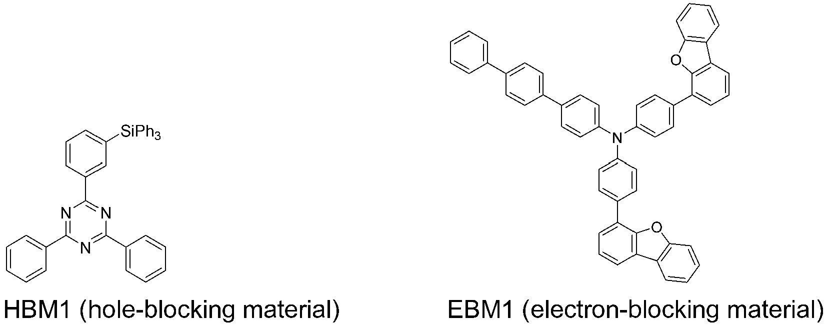

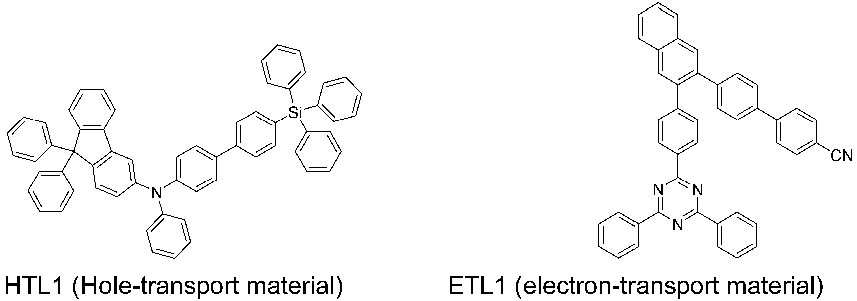

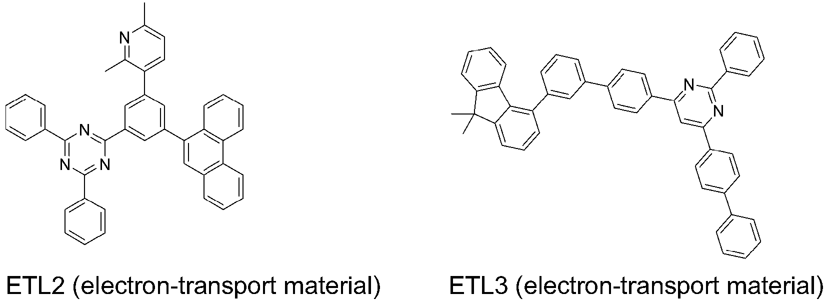

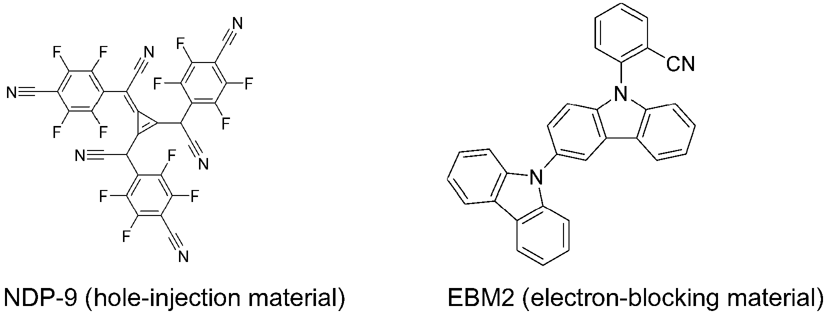

### Host materials H^{B}

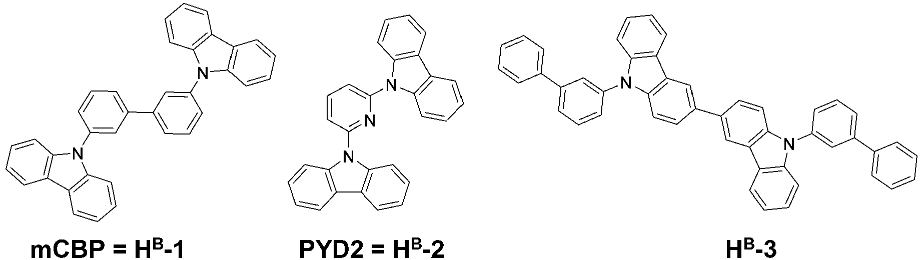

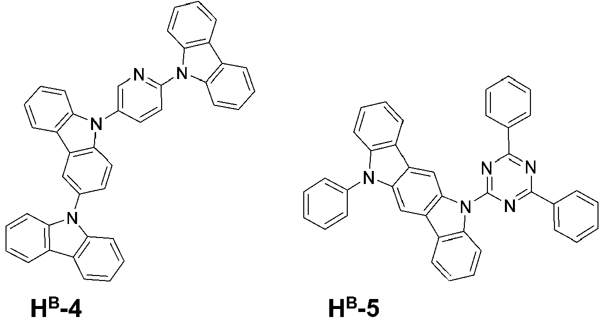

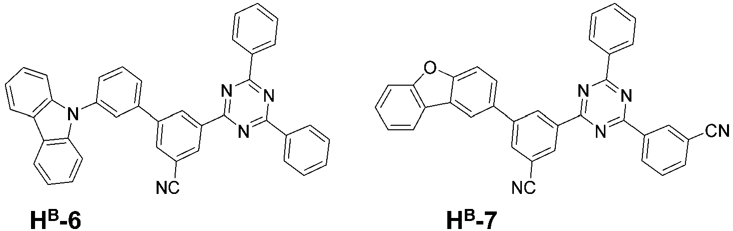

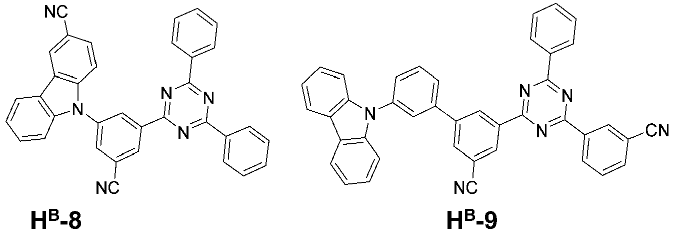

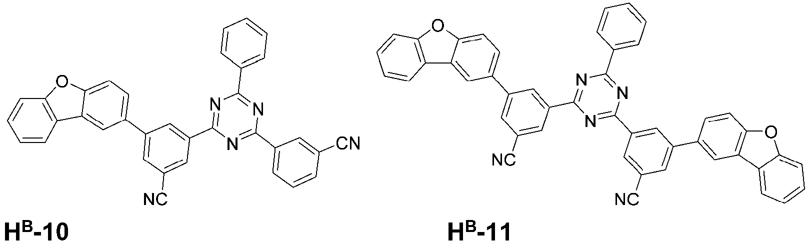

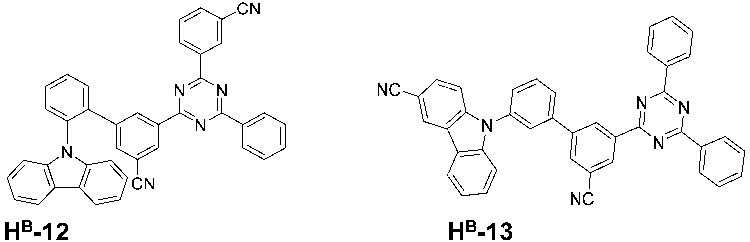

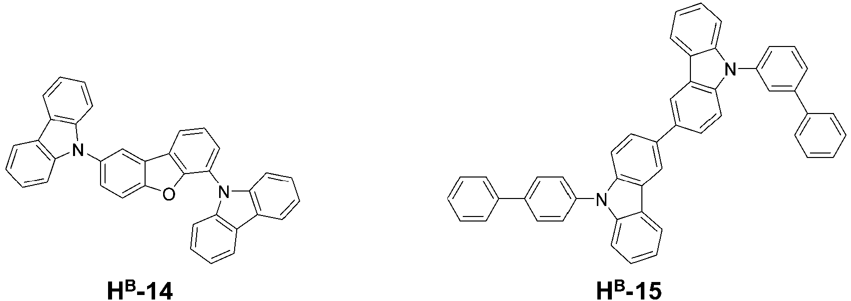

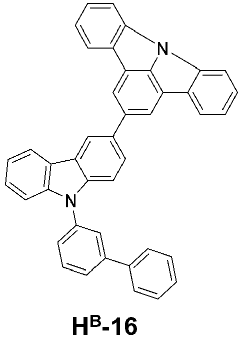

**Table 1H. Properties of the host materials.**

| | **Example compound** | **E^{HOMO} [eV]** | **E^{LUMO} [eV]** | **E(S1) [eV]** | **E(T1) [eV]** |
|---|---|---|---|---|---|
| **H^{B}** | **HBM1** | | -2.91 | | 2.94 |
| | **EBM1** | -5.54 | -2.46 | 3.08 | 2.36 |
| | **mCBP** | -6.02 | -2.42 | 3.6 | 2.82 |
| | **PYD2** | -6.08 | -2.55 | 3.53 | 2.81 |
| | **H^{B}-3** | -5.66 | -2.35 | 3.31 | 2.71 |
| | **H^{B}-4** | -5.85 | -2.43 | 3.42 | 2.84 |
| | **H^{B}-5** | -5.91 | -2.89 | 2.79 | |
| | **H^{B}-6** | -5.94 | -2.93 | 3.01 | 2.78 |
| | **H^{B}-7** | | | 3.27 | 2.71 |
| | **H^{B}-8** | | | 2.94 | 2.70 |
| | **H^{B}-9** | -5.97 | -3.10 | 2.88 | 2.77 |
| | **H^{B}-10** | | | 3.15 | 2.75 |
| | **H^{B}-11** | -6.04 | -3.10 | 2.94 | 2.86 |
| | **H^{B}-12** | -6.23 | -3.02 | 3.21 | 2.76 |
| | **H^{B}-13** | -6.23 | -3.12 | 3.21 | 2.76 |
| | **H^{E}-14** | -5.99 | -2.48 | 3.51 | 2.97 |
| | **H^{B}-15** | -5.64 | -2.36 | 3.28 | 2.70 |
| | **H^{B}-16** | -5.68 | -2.55 | 3.13 | 2.81 |

### TADF materials E^{B}

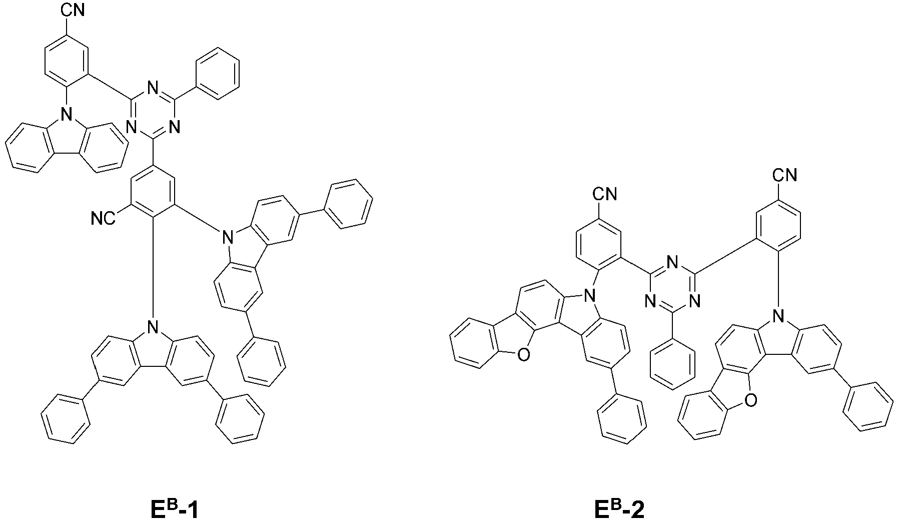

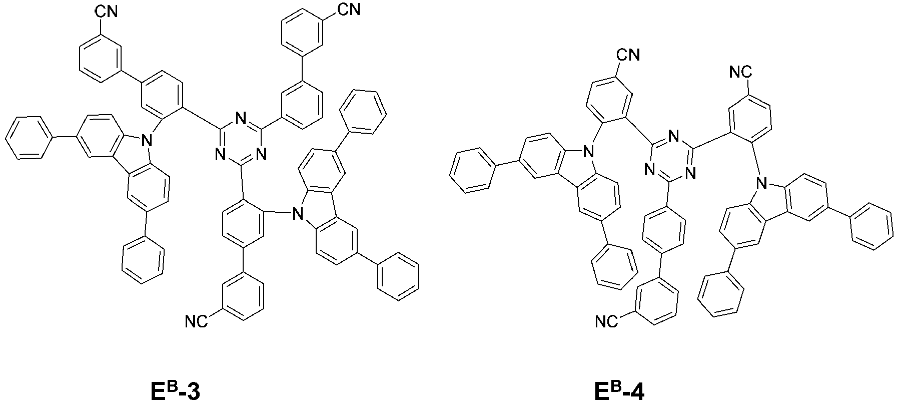

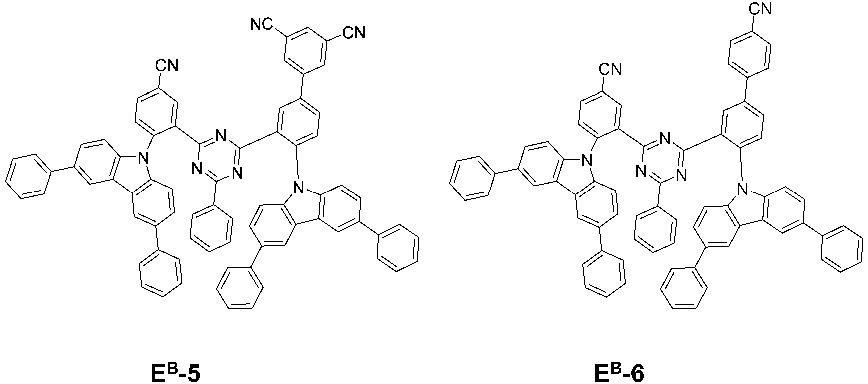

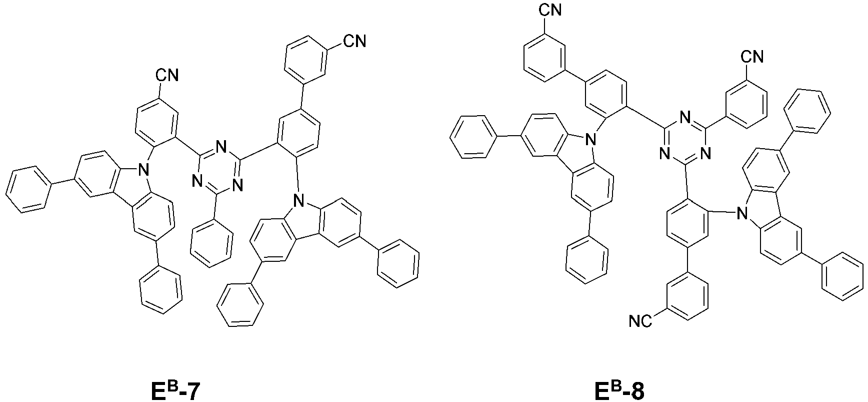

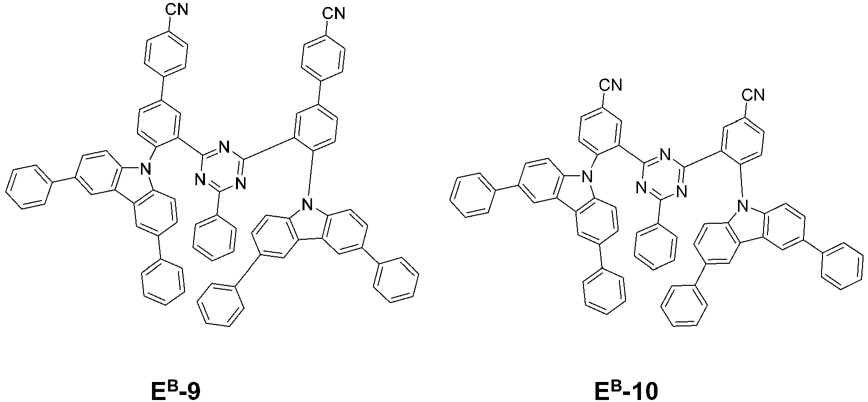

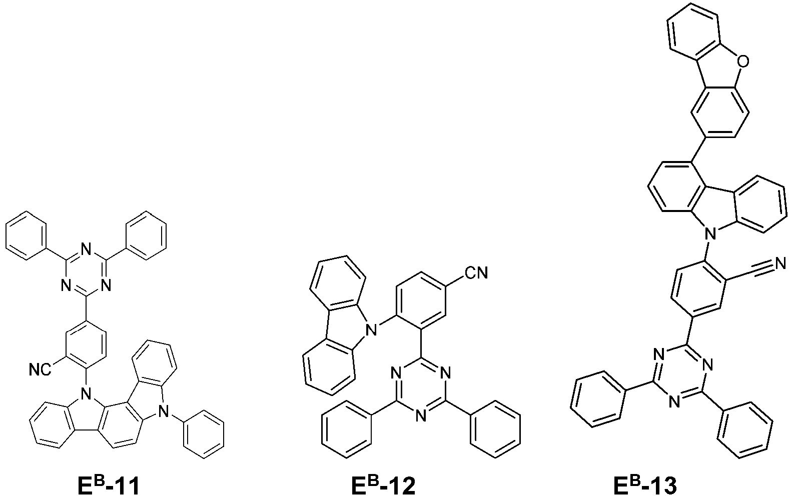

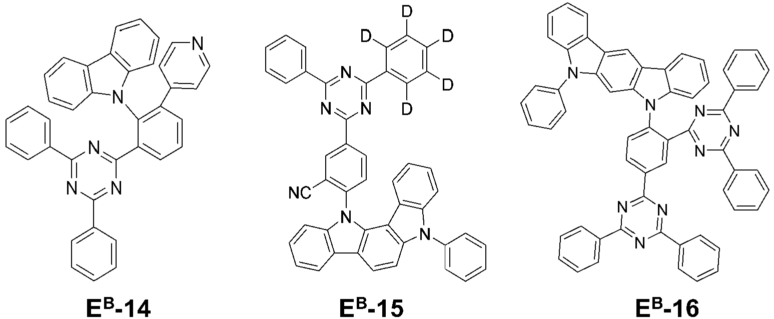

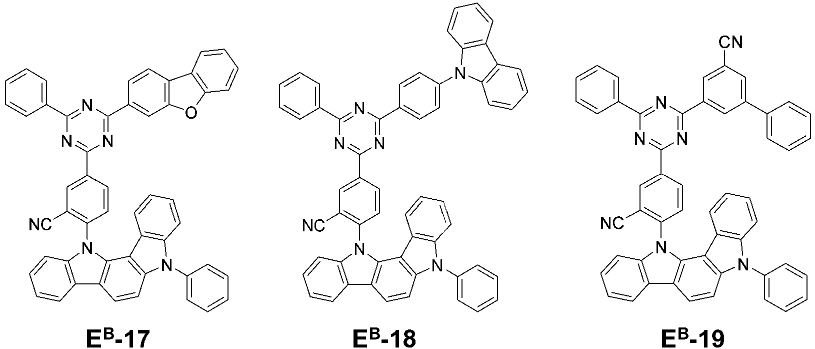

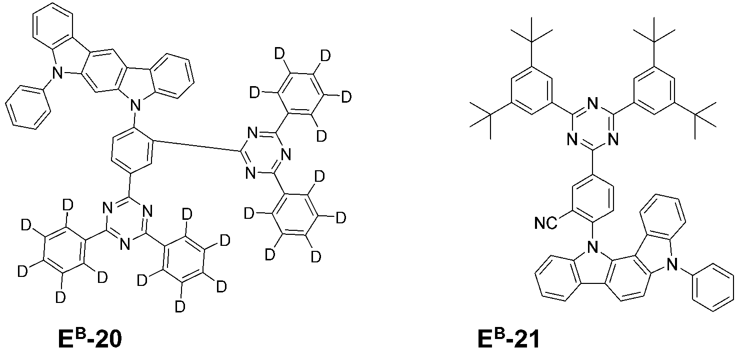

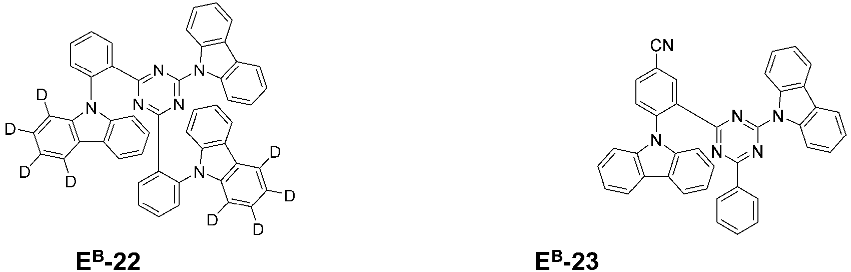

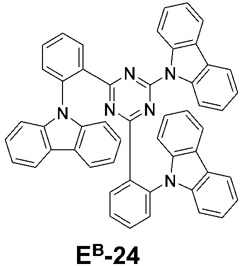

**Table 1E. Properties of the TADF materials E^{B}.**

| | **Example compound** | **E^{HOMO} [eV]** | **E^{LUMO} [eV]** | **E(S1) [eV]** | **E(T1) [eV]** | **λₘₐₓ^{PMMA} [nm]** | **FWHM [eV]** | **PLQY [%]** |
|---|---|---|---|---|---|---|---|---|
| **E^{B}** | **E^{B}-1** | -5.97 | -3.28 | 2.69 | 2.63 | 518 | 0.43 | 61 |
| | **E^{B}-2** | -5.97 | -3.31 | 2.66 | 2.72 | 526 | 0.43 | 43 |
| | **E^{B}-3** | -5.92 | -3.25 | 2.67 | 2.65 | 517 | 0.40 | 73 |
| | **E^{B}-4** | -6.00 | -3.37 | 2.63 | 2.65 | 525 | 0.40 | 54 |
| | **E^{B}-5** | -5.95 | -3.27 | 2.68 | 2.64 | 508 | 0.41 | 72 |
| | **E^{B}-6** | -5.94 | -3.24 | 2.70 | 2.64 | 509 | 0.41 | 74 |
| | **E^{B}-7** | -5.94 | -3.24 | 2.70 | 2.66 | 509 | 0.41 | 71 |
| | **E^{B}-8** | -5.93 | -3.33 | 2.60 | 2.59 | 525 | 0.39 | 71 |
| | **E^{B}-9** | -5.89 | -3.15 | 2.74 | 2.64 | 498 | 0.40 | 81 |
| | **E^{B}-10** | -5.99 | -3.34 | 2.65 | 2.65 | 520 | 0.42 | 54 |
| | **E^{B}-11** | -5.79 | -3.15 | 2.77 | 2.81 | 514 | 0.50 | 63 |
| | **E^{B}-12** | -6.07 | -3.19 | 2.88 | 2.80 | 477 | 0.42 | 83 |
| | **E^{B}-13** | -6.15 | -3.13 | 3.02 | 2.79 | 454 | 0.44 | 72 |
| | **E^{B}-14** | -6.03 | -3.01 | 3.02 | 2.97 | 459 | 0.45 | 72 |
| | **E^{B}-15** | -5.79 | -3.02 | 2.77 | 2.82 | 511 | 0.49 | 64 |
| | **E^{B}-16** | -5.71 | -3.07 | 2.64 | 2.59 | 517 | 0.38 | 68 |
| | **E^{B}-17** | -5.79 | -3.02 | 2.77 | 2.77 | 523 | 0.51 | 49 |
| | **E^{B}-18** | -5.80 | -3.04 | 2.76 | | 522 | 0.52 | 52 |
| | **E^{B}-19** | -5.80 | -3.14 | 2.67 | | 540 | 0.50 | 38 |
| | **E^{B}-20** | -5.71 | -3.06 | 2.65 | 2.60 | 510 | 0.37 | 69 |
| | **E^{B}-21** | -5.79 | -2.96 | 2.84 | 2.88 | 502 | 0.51 | 66 |
| | **E^{B}-22** | -5.97 | -2.94 | 2.92 | 2.87 | 473 | 0.44 | 79 |
| | **E^{B}-23** | -6.05 | -3.17 | 2.88 | 2.81 | 478 | 0.43 | 79 |
| | **E^{B}-24** | -5.92 | -3.00 | 2.92 | 2.87 | 475 | 0.44 | 79 |

### Phosphorescence materials P^{B}

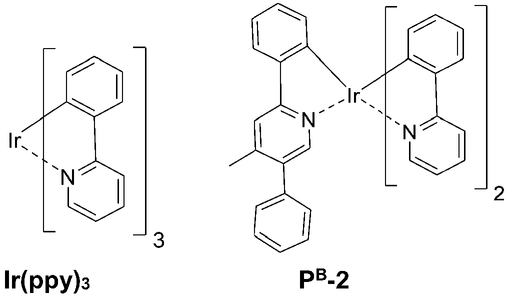

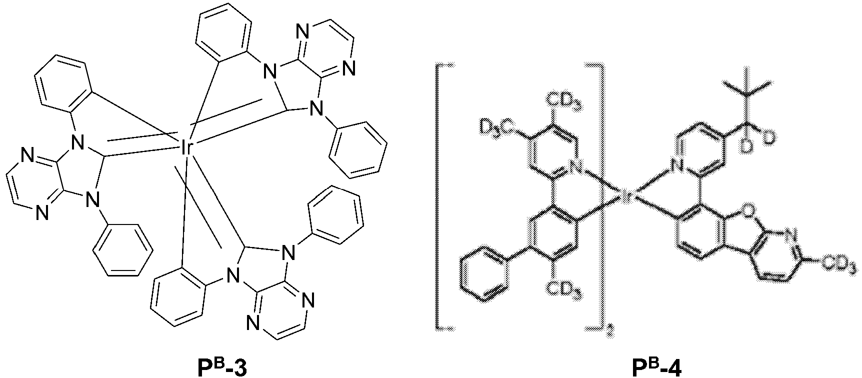

**Table 1P. Properties of the materials.**

| | Example compound | **HOMO [eV]** | **LUMO_{CV} [eV]** | **E^{LUMO} [eV]** | **E(S1) [eV]** | **E(T1) [eV]** | **λₘₐₓ^{PMMA} [nm]** | **FWHM [eV]** |
|---|---|---|---|---|---|---|---|---|
| **P^{B}** | **Ir(ppy)₃** | -5.36 | | | | 2.56a | 509 | 0.38 |
| | **P^{B}-2** | -5.33 | -2.32 | | | 2.57^{b} | 522 | 0.34 |
| | **P^{B}-3** | -5.80 | -2.67 | | | 2.88^{c} | 482 | 0.40 |
| | **P^{B}-4** | -5.24 | | | | | | |

wherein LUMOcv is the energy of the lowest unoccupied molecular orbital, which is determined by Cyclic voltammetry. ^{a}The emission spectrum was recorded from a solution of Ir(ppy)₃ in chloroform. ^{b}The emission spectrum was recorded from a 0.001 mg/mL solution of P^{B}-2 in dichloromethane. ^{c}The emission spectrum was recorded from a 0.001 mg/mL solution of P^{B}-3 in toluene.

### Small FWHM emitters S^{B}

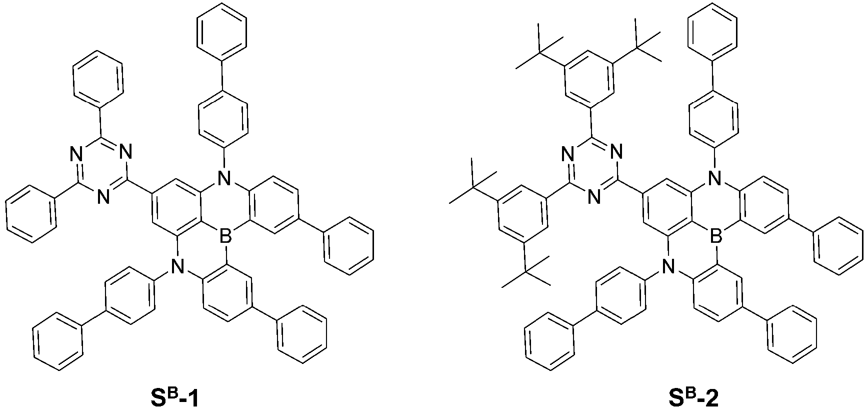

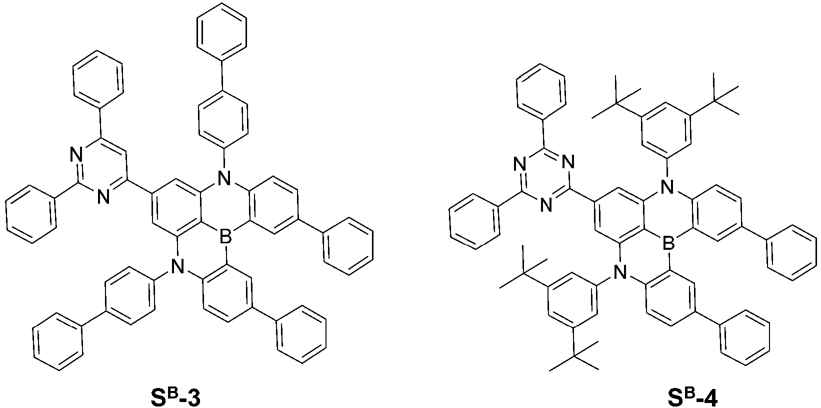

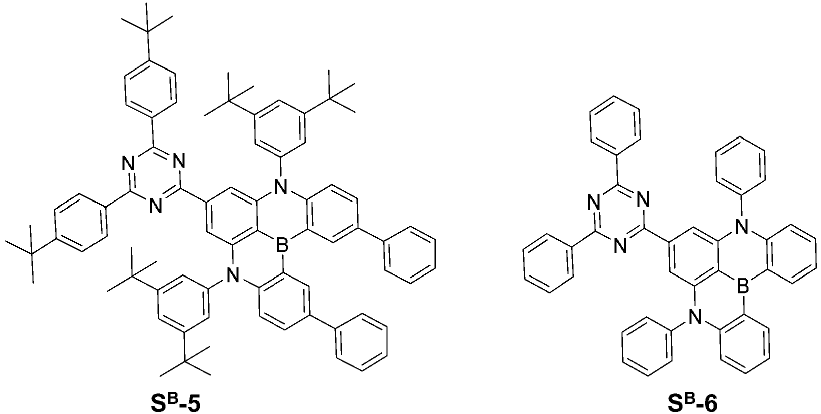

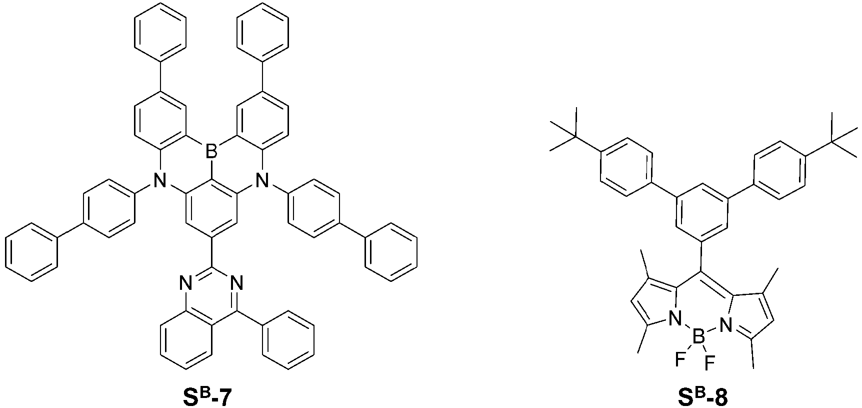

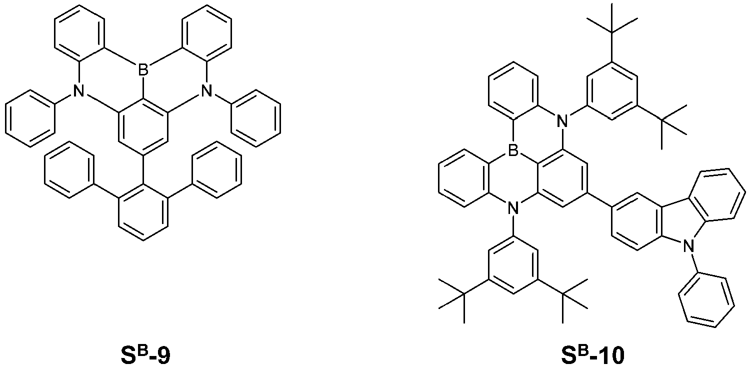

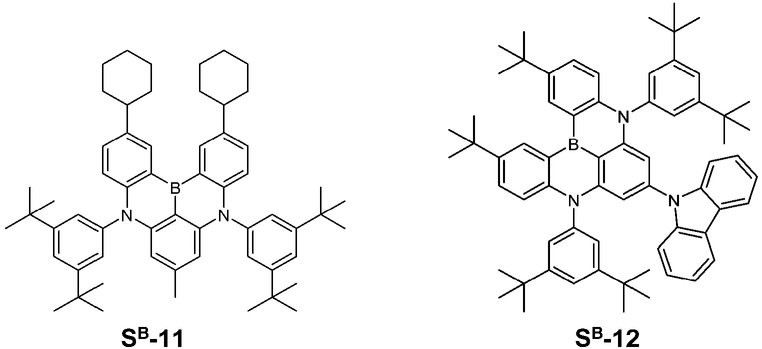

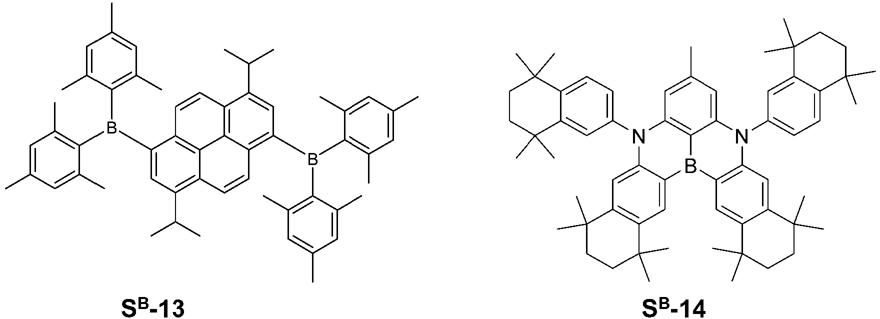

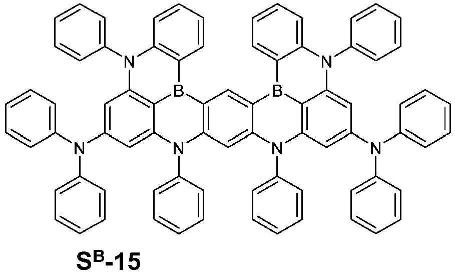

**Table 1S. Properties of the Small FWHM emitters S^{B}.**

| | **Example compound** | **E^{HOMO} [eV]** | **E^{LUMO} [eV]** | **E(S1) [eV]** | **E(T1) [eV]** | **λₘₐₓ^{PMMA} [nm]** | **FWHM [eV]** |
|---|---|---|---|---|---|---|---|
| **S^{B}** | **S^{B}-1** | -5.54 | -3.10 | 2.44 | 2.12 | 538 | 0.21 |
| | **S^{B}-2** | -5.53 | -3.04 | 2.49 | 2.26 | 525 | 0.18 |
| | **S^{B}-3** | -5.55 | -3.05 | 2.50 | 2.22 | 520 | 0.18 |
| | **S^{B}-4** | -5.48 | -3.05 | 2.43 | 2.25 | 537 | 0.17 |
| | **S^{B}-5** | -5.47 | -3.01 | 2.46 | 2.58 | 527 | 0.15 |
| | **S^{B}-6** | -5.56 | -3.03 | 2.53 | 2.19 | 518 | 0.22 |
| | **S^{B}-7** | -5.48 | -2.97 | 2.53 | 2.23 | 521 | 0.25 |
| | **S^{B}-8*** | -5.86 | -3.40 | 2.46 | | 517 | 0.10 |
| | **S^{B}-9** | -5.47 | -.2.66 | 2.81 | | 460 | 0.14 |
| | **S^{B}-10** | -5.46 | -2.65 | 2.81 | | 459 | 0.15 |
| | **S^{B}-11** | -5.33 | -2.51 | 2.82 | | 458 | 0.16 |
| | **S^{B}-12** | -5.49 | -2.63 | 2.86 | | 451 | 0.14 |
| | **S^{B}-13** | | | 2.79 | | 464 | 0.24 |
| | **S^{B}-14** | -5.31 | -2.50 | 2.81 | 2.61 | 459 | 0.16 |
| | **S^{B}-15** | -5.40 | -2.66 | 2.74 | | 468 | 0.12 |

| | | | | | | | |
|---|---|---|---|---|---|---|---|
| * measured in DCM (0.01 mg/mL; such a solution was used for photophysical measurements). | | | | | | | |

**Table 2. Setup 1 of exemplary organic electroluminescent devices (OLEDs).**

| **Layer** | **Thickness** | **Material** |
|---|---|---|
| **10** | 100 nm | Al |
| **9** | 2 nm | Liq |
| **8** | 20 nm | NBPhen |
| **7** | 10 nm | HBM1 |
| **6** | 50 nm | H^{B} : |
| | | E^{B}. |
| | | P^{B}: |
| | | S^{B} |
| **5** | 10 nm | H^{P} |
| **4** | 10 nm | TCTA |
| **3** | 50 nm | NPB |
| **2** | 5 nm | HAT-CN |
| **1** | 50 nm | ITO |
| **substrate** | | glass |

In order to evaluate the results of the invention, comparison experiments were performed, wherein solely the composition of the emission layer (6) was varied. Additionally, the ratio of E^{B} and S^{B} was kept constant in the comparison experiments.

### Results I: Variation of the content of the phosphorescence material P^{B} in the light-emitting layer (emission layer, 6)

### Composition of the light-emitting layer B of devices D1 to D4 (the percentages refer to weight percent):

| **Layer** | **D1** | **D2** | **D3** | **D4** |
|---|---|---|---|---|
| **Emission layer (6)** | H^{B} (79%): | H^{B} (78%): | H^{B} (75%): | H^{B} (69%): |
| | E^{B} (20%): | E^{B} (20%): | E^{B} (20%): | E^{B} (20%): |
| | P^{B} (0%): | P^{B} (1%): | P^{B} (4%): | P^{B} (10%): |
| | S^{B} (1 %) | S^{B}(1%) | S^{B} (1%) | S^{B} (1%) |

Setup 1 from Table 2 was used, wherein H^{B}-4 was used as host material H^{B} (p-host H^{P}; also used as material for the electron blocking layer 5), E^{B}-10 was used as TADF material E^{B}, Ir(ppy)₃ was used as phosphorescence material P^{B}, and S^{B}-1 was used as the small FWHM emitter S^{B}. A weight percentage of 0% means the absence of the material in the light-emitting layer B.

### Device results I

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D1** | 0.17 | 530 | 0.31 | 0.64 | 5.53 | 21.0 | 1.00 |
| **D2** | 0.18 | 532 | 0.32 | 0.64 | 6.64 | 21.2 | 2.47 |
| **D3** | 0.20 | 532 | 0.34 | 0.62 | 7.41 | 18.1 | 1.21 |
| **D4** | 0.24 | 532 | 0.37 | 0.60 | 6.96 | 13.1 | 0.99 |

Comparing the device results, D1 and D2, similar optical properties (FWHM, λₘₐₓ, CIEx and CIEy) and efficiency (EQE) can be observed, while for D2 an extension of the relative lifetime of 147% compared to D1 (from 1.00 to 2.47) can be observed. For D3 extension of the relative lifetime of 21 % compared to D1 (from 1.00 to 1.21), while the relative lifetime of D4 decreased by 1% compared to D1 (from 1.00 to 0.99).

### Results II: Variation of Composition of Components

### Composition of the light-emitting layer B of devices D5 to D13 (the percentages refer to weight percent):

| **Layer** | **D5** | **D6** | **D7** | **D8** |
|---|---|---|---|---|
| **Emission layer (6)** | H^{B} (79%): | H^{B} (76%): | H^{B} (78%): | H^{B} (75%): |
| | H^{N} (20%): | H^{N} (20%): | H^{N} (20%): | H^{N} (20%): |
| | P^{B} (1%): | P^{B} (4%): | P^{B} (1%): | P^{B} (4%): |
| | S^{B} (0%) | S^{B} (0%) | S^{B} (1%) | S^{B} (1%) |

| **Layer** | **D9** | **D10** |
|---|---|---|
| **Emission layer (6)** | H^{B} (79.5%): | H^{B} (78.5%): |
| | E^{B} (20%): | E^{B} (20%): |
| | P^{B} (0%): | P^{B} (1%): |
| | S^{B} (0.5%) | S^{B} (0.5%) |

Setup 1 from Table 2 was used, wherein H^{B}-4 was used as host material H^{B} (p-host H^{P}; also used as material for the electron blocking layer 5), H^{B}-5 was used as host material H^{N}, E^{B}-11 was used as TADF material E^{B}, Ir(ppy)₃ was used as phosphorescence material P^{B} and S^{B}-1 was used as the small FWHM emitter S^{B}. A weight percentage of 0% means the absence of the material in the light-emitting layer B.

Devices **D5** and **D6** are typical phosphorescence devices, which comprise a mixed-host system, i.e., H^{B} and H^{N}, and a phosphorescence emitter.

Device **D7** and **D8** are devices, which comprise a mixed-host system, i.e., H^{B} and H^{N}, a phosphorescence material and a small FWHM emitter S^{B}.

Device **D9** is a device, which comprises a Host H^{B}, a TADF material E^{B} and a small FWHM emitter S^{B}.

Devices **D10** is a devices, which comprises a Host H^{B}, a TADF material E^{B}, a phosphorescence material P^{B} and a small FWHM emitter S^{B}.

### Device results II

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D5** | 0.31 | 512 | 0.30 | 0.62 | 6.11 | 19.5 | 1.00 |
| **D6** | 0.31 | 514 | 0.30 | 0.63 | 5.77 | 21.7 | 1.89 |
| **D7** | 0.17 | 534 | 0.33 | 0.64 | 6.33 | 19.9 | 2.05 |
| **D8** | 0.17 | 534 | 0.33 | 0.64 | 6.19 | 22.9 | 3.50 |
| **D9** | 0.17 | 532 | 0.31 | 0.63 | 5.86 | 20.6 | 1.30 |
| **D10** | 0.18 | 532 | 0.32 | 0.64 | 6.74 | 24.9 | 13.34 |

Comparing the composition of the emission layer of devices **D5** and **D6** to **D7** and **D8, D7** and **D8** contain additionally a small FWHM emitter S^{B}, which is not present in **D5** and **D6**. A longer lifetime, similar efficiency and smaller FWHM of the emission can be observed for **D7** and **D8**.

Device **D10** according to the present invention shows a superior overall performance over D9 which lacks the phosphorescence material P^{B} (here exemplarily Ir(ppy)₃).

### Composition of the light-emitting layer B of devices D14 to D21 (the percentages refer to weight percent):

| **Layer** | **D14** | **D15** | **D16** | **D17** | **D18** |
|---|---|---|---|---|---|
| **Emission layer (6)** | H^{B} (80%): | H^{B} (79%): | H^{B} (79%): | H^{B} (78%): | H^{B} (79%): |
| | H^{N} (0%): | H^{N} (20%): | H^{N} (0%): | H^{N} (20%): | H^{N} (0%): |
| | E^{B} (20%): | E^{B} (0%): | E^{B} (20%): | E^{B} (0%): | E^{B} (20%): |
| | P^{B} (0%): | P^{B} (1%): | P^{B} (0%): | P^{B} (1%): | P^{B} (1%): |
| | S^{B} (0%) | S^{B} (0%) | S^{B} (1%) | S^{B} (1%) | S^{B} (0%) |
| | | | | | |

| **Layer** | **D19** | **D20** | **D21** | | |
|---|---|---|---|---|---|
| **Emission layer (6)** | H^{B} (78%): | H^{B} (75%): | H^{B} (72%): | | |
| | H^{N} (0%): | H^{N} (0%): | H^{N} (0%): | | |
| | E^{B} (20%): | E^{B} (20%): | E^{B} (20%): | | |
| | P^{B} (1%): | P^{B} (4%): | P^{B} (7%): | | |
| | S^{B} (1%) | S^{B} (1%) | S^{B} (1%) | | |

Setup 1 from Table 2 was used, wherein H^{B}-4 was used as host material H^{B} (p-host H^{P}; also used as material for the electron blocking layer 5), H^{B}-5 was used as host material H^{N}, E^{B}-10 was used as TADF material E^{B}, P^{B}-2 was used as phosphorescence material P^{B}, and S^{B}-1 was used as small FWHM emitter S^{B}. A weight percentage of 0% means the absence of the material in the light-emitting layer B.

### Device results III

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D14** | 0.35 | 522 | 0.32 | 0.60 | 4.76 | 16.4 | 1.00 |
| **D15** | 0.29 | 516 | 0.30 | 0.63 | 6.49 | 22.7 | 0.29 |
| **D16** | 0.16 | 532 | 0.32 | 0.65 | 5.85 | 20.4 | 2.76 |
| **D17** | 0.17 | 532 | 0.31 | 0.65 | 6.60 | 22.4 | 0.52 |
| **D18** | 0.36 | 525 | 0.36 | 0.59 | 7.02 | 15.7 | 2.17 |
| **D19** | 0.17 | 532 | 0.33 | 0.64 | 7.28 | 20.4 | 4.75 |
| **D20** | 0.20 | 532 | 0.35 | 0.62 | 7.85 | 16.3 | 2.42 |
| **D21** | 0.20 | 534 | 0.36 | 0.61 | 7.26 | 13.6 | 2.57 |

As can be concluded from device results III, the absence of the small FWHM emitter S^{B} (here exemplarily S^{B}-1) results in an undesirably broad emission reflected by the FWHM values being significantly larger than 0.25 eV in all cases (see devices D14, D15, and D18). For D15, the very high EQE of 22.7% comes along with a significantly reduced lifetime. When using a small FWHM emitter S^{B} (here exemplarily S^{B}-1) alongside either a TADF material E^{B} (here exemplarily E^{B}-10) or a phosphorescence material P^{B} (here exemplarily P^{B}-2), a narrow emission can be achieved, which is then reflected by the FWHM values being significantly smaller than 0.25 eV (see devices D16 and D17). At the same time, these devices exhibit high EQE-values of 20.4% and 22.4%, respectively. However, in terms of lifetime, all of these devices are clearly outcompeted by device D19, which was prepared according to the present invention. D19 also exhibits a very good efficiency (EQE of 20.4%) and a narrow emission (FWHM of 0.17 eV). In summary, the skilled artisan will acknowledge that D19 (according to the present invention) clearly shows the best overall device performance. The EML of D19 comprises 1% of the phosphorescence material P^{B}. Increasing this value to 4% (in D20) or even to 7% (in D21) results in a somewhat poorer device performance reflected by a slight increase of the FWHM to 0.20 eV, a reduction of the EQE to 16.3% or 13.6%, respectively, and a reduction of the device lifetime. Nevertheless, D20 and D21 still display a good overall performance, in particular with regard to the device lifetime. In the absence of the TADF material E^{B}-10, an n-host (here exemplarily H^{B}-5) was generally used to increase the electron mobility within the EML.

### Composition of the light-emitting layer B of devices D22 to D29 (the percentages refer to weight percent):

| **Layer** | **D22** | **D23** | **D24** | **D25** | **D26** |
|---|---|---|---|---|---|
| **Emission layer (6)** | H^{B} (80%): | H^{B} (79%): | H^{B} (78%): | H^{B} (78%): | H^{B} (78.5%): |
| | H^{N} (0%): | H^{N} (20%): | H^{N} (20%): | H^{N} (0%): | H^{N} (0%): |
| | E^{B} (20%): | E^{B} (0%): | E^{B} (0%): | E^{B} (20%): | E^{B} (20%): |
| | P^{B} (0%): | P^{B} (1%): | P^{B} (1%): | P^{B} (1%): | P^{B} (1%): |
| | S^{B} (0%) | S^{B} (0%) | S^{B} (1%) | S^{B} (1%) | S^{B} (0.5%) |
| | | | | | |
| **Layer** | **D27** | **D28** | **D29** | | |
| **Emission layer (6)** | H^{B} (79.5%): | H^{B} (75%): | H^{B} (75.5%): | | |
| | H^{N} (0%): | H^{N} (0%): | H^{N} (0%): | | |
| | E^{B} (20%): | E^{B} (20%): | E^{B} (20%): | | |
| | P^{B} (0%): | P^{B} (4%): | P^{B} (4%): | | |
| | S^{B} (0.5%) | S^{B} (1%) | S^{B} (0.5%) | | |

Setup 1 from Table 2 was used, wherein H^{B}-4 was used as host material H^{B} (p-host H^{P}; also used as material for the electron blocking layer 5), H^{B}-5 was used as host material H^{N}, E^{B}-11 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results IV

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D22** | 0.41 | 518 | 0.29 | 0.55 | 4.93 | 22.5 | 1.00 |
| **D23** | 0.31 | 512 | 0.30 | 0.62 | 6.11 | 19.5 | 1.10 |
| **D24** | 0.17 | 534 | 0.33 | 0.64 | 6.33 | 19.9 | 2.26 |
| **D25** | 0.17 | 534 | 0.32 | 0.64 | 6.30 | 22.5 | 11.89 |
| **D26** | 0.18 | 532 | 0.32 | 0.64 | 6.74 | 24.9 | 14.72 |
| **D27** | 0.17 | 532 | 0.31 | 0.63 | 5.86 | 20.6 | 1.44 |
| **D28** | 0.16 | 534 | 0.33 | 0.64 | 5.94 | 21.6 | 8.95 |
| **D29** | 0.18 | 532 | 0.32 | 0.64 | 6.75 | 22.6 | 11.40 |

As can be concluded from device results IV, using the TADF material E^{B} (here exemplarily E^{B}-11) or the phosphorescence material P^{B} (here exemplarily Ir(ppy)₃) as the main emitter in the absence of a small FWHM emitter S^{B} results in a relatively broad emission of the organic electroluminescent device, which is reflected by FWHM values of the main emission peak of clearly more than 0.25 eV (here 0.41 and 0.31 eV, respectively, see D22 and D23). Both, D22 and D23, exhibit high efficiencies (EQE of 22.5% and 19.5%, respectively). The addition of a small FWHM emitter S^{B} (here exemplarily S^{B}-1) to for example the phosphorescent OLED D23 results in a significantly reduced FWHM of the main emission peak (then 0.17 eV) while slightly improving the EQE and the lifetime (see D24). However, device D24 as well as the OLEDs D22 and D23 are strongly outperformed by device D25, which was prepared according to the present invention. As compared to D22, D23, and D24, device D25 exhibits a dramatically prolonged lifetime, while still displaying an equally high efficiency and a narrow FWHM. The skilled artisan will acknowledge that the overall performance of device D25 according to the present invention is clearly superior to the performance of D22, D23, and D24. The overall device performance could be improved even further by reducing the content of the small FWHM emitter S^{B} (here exemplarily S^{B}-1) from 1% (in the EML of D25) to 0.5% (in the EML of D26). Again, a comparative example D27, not fulfilling the conditions of the present invention (exemplarily lacking the phosphorescence material P^{B}) showed a drastically reduced lifetime and a somewhat reduced efficiency (EQE). Increasing the content of the phosphorescence material P^{B} (here exemplarily Ir(ppy)₃) from 1% in the devices D25 and D26 according to the present invention to 4% (in devices D28 and D29 according to the present invention) led to a reduction of the device lifetime and the efficiency. However, these devices (D28 and D29) still clearly outperform the aforementioned comparative devices which were manufactured according to the state of the art and not according to the present invention. In the absence of the TADF material E^{B}-11, an n-host (here exemplarily H^{B}-5) was generally used to increase the electron mobility within the EML.

**Table 3. Setup 2 of exemplary organic electroluminescent devices (OLEDs).**

| **Layer** | **Thickness** | **Material** |
|---|---|---|
| **10** | 100 nm | Al |
| **9** | 2 nm | Liq |
| **8** | 20 nm | NBPhen |
| **7** | 10 nm | HBM1 |
| **6** | 50 nm | H^{B} : |
| | | E^{B} : |
| | | P^{B} : |
| | | S^{B} |
| **5** | 10 nm | H^{P} |
| **4** | 10 nm | TCTA |
| **3** | 40 nm | NPB |
| **2** | 5 nm | HAT-CN |
| **1** | 50 nm | ITO |
| **substrate** | | glass |

### Composition of the light-emitting layer B of devices D30 to D32 (the percentages refer to weight percent):

| **Layer** | **D30** | **D31** | **D32** |
|---|---|---|---|
| **Emission layer (6)** | H^{B} (79%): | H^{B} (76%): | H^{B} (75%): |
| | E^{B} (20%): | E^{B} (20%): | E^{B} (20%): |
| | P^{B} (0%): | P^{B} (4%): | P^{B} (4%): |
| | S^{B} (1%) | S^{B} (0%) | S^{B} (1%) |

Setup 2 from Table 3 was used, wherein H^{B}-1 (mCBP) was used as host material H^{B} (p-host H^{P}; also used as material for the electron blocking layer 5), E^{B}-14 was used as TADF material E^{B}, P^{B}-3 was used as phosphorescence material P^{B}, and S^{B}-14 was used as small FWHM emitter S^{B}.

### Device results V

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D30** | 0.17 | 462 | 0,14 | 0.15 | 6.07 | 15.8 | 1.00 |
| **D31** | 0.33 | 474 | 0,14 | 0.23 | 5.61 | 16.8 | 2.50 |
| **D32** | 0.19 | 462 | 0,14 | 0.16 | 6.03 | 19.4 | 1.75 |

Among the organic electroluminescent devices D30-D32, D32 according to the present invention shows the best overall performance when taking the narrow emission (small FWHM), the high EQE, and the relative lifetime into account.

### Composition of the light-emitting layer B of devices D33 to D35 (the percentages refer to weight percent):

| **Layer** | **D33** | **D34** | **D35** |
|---|---|---|---|
| **Emission layer (6)** | H^{P} (79%): | H^{P} (79%): | H^{P} (78%): |
| | E^{B} (20%): | E^{B} (20%): | E^{B} (20%): |
| | P^{B} (0%): | P^{B} (1%): | P^{B} (1%): |
| | S^{B} (1%) | S^{B} (0%) | S^{B} (1%) |

Setup 2 from Table 3 was used, wherein H^{B}-14 was used as host material H^{B} (p-host H^{P}; also used as material for the electron blocking layer 5), E^{B}-14 was used as TADF material E^{B}, P^{B}-3 was used as phosphorescence material P^{B}, and S^{B}-14 was used as small FWHM emitter S^{B}.

### Device results VI

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D33** | 0.17 | 462 | 0.14 | 0.15 | 5.26 | 17.2 | 1.00 |
| **D34** | 0.35 | 474 | 0.15 | 0.25 | 6.07 | 13.5 | 0.75 |
| **D35** | 0.18 | 462 | 0.14 | 0.15 | 5.89 | 18.1 | 1.50 |

Among the organic electroluminescent devices D33-D35, D35 according to the present invention clearly shows the best overall performance when taking the narrow emission (small FWHM), the high EQE, and the relative lifetime into account.

As stated before, each light-emitting layer B according to the present invention may be a single layer or may be composed of two or more sublayers. Exemplary organic electroluminescent devices with a light-emitting layer B comprising two or more sublayers are shown below (see device results VII and VIII).

**Table 4. Setup 3 of exemplary organic electroluminescent devices (OLEDs).**

| **Layer** | **Thickness** | **Sublayers** | **Material** |
|---|---|---|---|
| **10** | 100 nm | single layer | Al |
| **9** | 2 nm | single layer | Liq |
| **8** | 20 nm | single layer | NBPhen |
| **7** | 10 nm | single layer | HBM1 |
| **6** | 2 nm | sublayer 11 | |
| | 8 nm | sublayer 10 | |
| | 2 nm | sublayer 9 | |
| | 8 nm | sublayer 8 | |
| | | | H^{B} : |
| | 2 nm | sublayer 7 | |
| | | | E^{B} : |
| | 8 nm | sublayer 6 | |
| | | | P^{B} : |
| | 2 nm | sublayer 5 | |
| | | | S^{B} |
| | 8 nm | sublayer 4 | |
| | 2 nm | sublayer 3 | |
| | 8 nm | sublayer 2 | |
| | 2 nm | sublayer 1 | |
| **5** | 10 nm | single layer | H^{P} |
| **4** | 10 nm | single layer | TCTA |
| **3** | 50 nm | single layer | NPB |
| **2** | 5 nm | single layer | HAT-CN |
| **1** | 50 nm | single layer | ITO |
| **substrate** | | | glass |

### Composition of the light-emitting layer B of devices D36 to D38 (the percentages refer to weight percent):

| **Layer** | **Sublayer** | **D36** | **D37** | **D38** |
|---|---|---|---|---|
| **Emission layer (6)** | 11 | H^{B} (79%): | H^{B} (79%): | H^{B} (79%): |
| | | H^{N} (20%): | H^{N} (20%): | H^{N} (20%): |
| | | S^{B} (1%) | S^{B} (1%) | S^{B} (1%) |
| | 10 | H^{B} (79%): | H^{B} (80%): | H^{B} (79%): |
| | | H^{N} (20%): | E^{B} (20%): | E^{B} (20%): |
| | | P^{B} (1%) | | P^{B} (1%) |
| | 9 | H^{B} (79%): | H^{B} (79%): | H^{B} (79%): |
| | | H^{N} (20%): | H^{N} (20%): | H^{N} (20%): |
| | | S^{B} (1%) | S^{B} (1%) | S^{B} (1%) |
| | 8 | H^{B} (79%): | H^{B} (80%): | H^{B} (79%): |
| | | H^{N} (20%): | | E^{B} (20%): |
| | | | E^{B} (20%): | |
| | | P^{B} (1%) | | P^{B} (1%) |
| | 7 | H^{B} (79%): | H^{B} (79%): | H^{B} (79%): |
| | | H^{N} (20%): | H^{N} (20%): | H^{N} (20%): |
| | | S^{B} (1%) | S^{B} (1%) | S^{B} (1%) |
| | 6 | H^{B} (79%): | H^{B} (80%): | H^{B} (79%): |
| | | H^{N} (20%): | | E^{B} (20%): |
| | | | E^{B} (20%): | |
| | | P^{B} (1%) | | P^{B} (1%) |
| | 5 | H^{B} (79%): | H^{B} (79%): | H^{B} (79%): |
| | | H^{N} (20%): | H^{N} (20%): | H^{N} (20%): |
| | | S^{B} (1%) | S^{B} (1%) | S^{B} (1%) |
| | 4 | H^{B} (79%): | H^{B} (80%): | H^{B} (79%): |
| | | H^{N} (20%): | | E^{B} (20%): |
| | | | E^{B} (20%): | |
| | | P^{B} (1%) | | P^{B} (1%) |
| | 3 | H^{B} (79%): | H^{B} (79%): | H^{B} (79%): |
| | | H^{N} (20%): | H^{N} (20%): | H^{N} (20%): |
| | | S^{B} (1%) | S^{B} (1%) | S^{B} (1%) |
| | 2 | H^{B} (79%): | H^{B} (80%): | H^{B} (79%): |
| | | H^{N} (20%): | | E^{B} (20%): |
| | | | E^{B} (20%): | |
| | | P^{B} (1%) | | P^{B} (1%) |
| | 1 | H^{B} (79%): | H^{B} (79%): | H^{B} (79%): |
| | | H^{N} (20%): | H^{N} (20%): | H^{N} (20%): |
| | | S^{B} (1%) | S^{B} (1%) | S^{B} (1%) |

Setup 3 from Table 4 was used, wherein H^{B}-4 was used as host material H^{B} (p-host H^{P}; also used as material for the electron blocking layer 5), H^{B}-5 was used as host material H^{N}, E^{B}-10 was used as TADF material E^{B}, Ir(ppy)₃ was used as phosphorescence material P^{B}, and S^{B}-1 was used as small FWHM emitter S^{B}.

### Device results VII

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D36** | 0.24 | 528 | 0.29 | 0.64 | 5.08 | 23.8 | 1.00 |
| **D37** | 0.21 | 530 | 0.31 | 0.63 | 5.80 | 18.0 | 3.87 |
| **D38** | 0.23 | 530 | 0.33 | 0.62 | 7.71 | 16.3 | 9.01 |

As can be concluded from device results VII, D38 according to the present invention shows a significantly prolonged lifetime as compared to D36 and D37. This comes along with a somewhat reduced, but still high efficiency (EQE). All three devices display a narrow emission which is expressed by FWHM values below 0.25 eV in all cases. D38 displays the best overall device performance, when taking the narrow emission, the still high EQE and the very long lifetime into account.

**Table 5. Setup 4 of exemplary organic electroluminescent devices (OLEDs).**

| **Layer** | **Thickness** | **Sublayers** | **Material** |
|---|---|---|---|
| **10** | 100 nm | single layer | Al |
| **9** | 2 nm | single layer | Liq |
| **8** | 20 nm | single layer | NBPhen |
| **7** | 10 nm | single layer | HBM1 |
| **6** | 5 nm | sublayer 13 | |
| | 2 nm | sublayer 12 | |
| | 5 nm | sublayer 11 | |
| | 2 nm | sublayer 10 | |
| | 5 nm | sublayer 9 | |
| | | | H^{B} : |
| | 2 nm | sublayer 8 | |
| | | | E^{B} : |
| | 5 nm | sublayer 7 | |
| | | | P^{B} : |
| | 2 nm | sublayer 6 | |
| | | | S^{B} |
| | 5 nm | sublayer 5 | |
| | | | |
| | 2 nm | sublayer 4 | |
| | 5 nm | sublayer 3 | |
| | 2 nm | sublayer 2 | |
| | 5 nm | sublayer 1 | |
| **5** | 10 nm | single layer | H^{P} |
| **4** | 10 nm | single layer | TCTA |
| **3** | 50 nm | single layer | NPB |
| **2** | 5 nm | single layer | HAT-CN |
| **1** | 50 nm | single layer | ITO |
| **substrate** | | | glass |

### Composition of the light-emitting layer B of device D39 (the percentages refer to weight percent):

| **Layer** | **Sublayer** | **D39** |
|---|---|---|
| **Emission layer (6)** | 13 | H^{B} (79%): |
| | | E^{B} (20%): |
| | | P^{B} (1%) |
| | 12 | H^{B} (79%): |
| | | H^{N} (20%): |
| | | S^{B} (1%) |
| | 11 | H^{B} (79%): |
| | | E^{B} (20%): |
| | | P^{B} (1%) |
| | 10 | H^{B} (79%): |
| | | H^{N} (20%): |
| | | S^{B} (1%) |
| | 9 | H^{B} (79%): |
| | | E^{B} (20%): |
| | | P^{B} (1%) |
| | 8 | H^{B} (79%): |
| | | H^{N} (20%): |
| | | S^{B} (1%) |
| | 7 | H^{B} (79%): |
| | | E^{B} (20%): |
| | | P^{B} (1%) |
| | 6 | H^{B} (79%): |
| | | H^{N} (20%): |
| | | S^{B} (1%) |
| | 5 | H^{B} (79%): |
| | | E^{B} (20%): |
| | | P^{B} (1%) |
| | 4 | H^{B} (79%): |
| | | H^{N} (20%): |
| | | S^{B} (1%) |
| | 3 | H^{B} (79%): |
| | | E^{B} (20%): |
| | | P^{B} (1%) |
| | 2 | H^{B} (79%): |
| | | H^{N} (20%): |
| | | S^{B} (1%) |
| | 1 | H^{B} (79%): |
| | | E^{B} (20%): |
| | | P^{B} (1%) |

Setup 4 from Table 5 was used, wherein H^{B}-4 was used as host material H^{B} (p-host H^{P}; also used as material for the electron blocking layer 5), H^{B}-5 was used as host material H^{N}, E^{B}-10 was used as TADF material E^{B}, Ir(ppy)₃ was used as phosphorescence material P^{B}, and S^{B}-1 was used as small FWHM emitter S^{B}.

### Device results VIII

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D39** | 0.23 | 528 | 0.33 | 0.62 | 6.21 | 15.3 | 0.73* |

| | | | | | | | |
|---|---|---|---|---|---|---|---|
| *The lifetime is given relative to D38. | | | | | | | |

As can be concluded from device results VIII, reducing the thickness of the H^{B}:E^{B}:P^{B}-sublayers from 8 nm (D38) to 5 nm (D39) while using a largely analogue stack architecture, did not result in an improved device performance. Nevertheless, D39 still displays a narrow emission, high EQE and good lifetime.

### Composition of the light-emitting layer B of devices D40 and D41 (the percentages refer to weight percent):

| **Layer** | **D40** | **D41** |
|---|---|---|
| **Emission layer (6)** | H^{B} (79%): | H^{B} (75%): |
| | E^{B} (20%): | E^{B} (20%): |
| | P^{B} (0%): | P^{B} (4%): |
| | S^{B} (1%) | S^{B} (1%) |

Setup 1 from Table 2 was used, wherein H^{B}-15 was used as host material H^{B} (p-host H^{P}; also used as material for the electron blocking layer 5), E^{B}-10 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results IX

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D40** | 0.16 | 534 | 0.33 | 0.64 | 3.93 | 13.1 | 1.00 |
| **D41** | 0.18 | 534 | 0.35 | 0.63 | 5.09 | 12.9 | 3.02 |

As can be concluded from device results IX, device D41 according to the present invention shows a superior overall performance as compared to device D40 which lacks the TADF material E^{B} (here exemplarily E^{B}-10) when taking the narrow emission (FWHM), the efficiency (EQE), and most the device lifetime (LT95) into account.

**Table 6. Setup 5 of exemplary organic electroluminescent devices (OLEDs).**

| **Layer** | **Thickness** | **Material** |
|---|---|---|
| **10** | 100 nm | Al |
| **9** | 2 nm | Liq |
| **8** | 20 nm | NBPhen |
| **7** | 10 nm | HBM1 |
| **6** | 50 nm | H^{B} : |
| | | E^{B} : |
| | | P^{B} : |
| | | S^{B} |
| **5** | 10 nm | EBM1 |
| **4** | 10 nm | TCTA |
| **3** | 60 nm | NPB |
| **2** | 5 nm | HAT-CN |
| **1** | 50 nm | ITO |
| **substrate** | | glass |

### Composition of the light-emitting layer B of devices D42 to D44 (the percentages refer to weight percent):

| **Layer** | **D42** | **D43** | **D44** |
|---|---|---|---|
| **Emission layer (6)** | H^{B} (79%): | H^{B} (78%): | H^{B} (78%): |
| | H^{N} (0%): | H^{N} (20%): | H^{N} (0%): |
| | E^{B} (20%): | E^{B} (0%): | E^{B} (20%): |
| | P^{B} (0%): | P^{B} (1%): | P^{B} (1%): |
| | S^{B} (1%) | S^{B} (1%) | S^{B} (1%) |

Setup 5 from Table 6 was used, wherein H^{B}-15 was used as host material H^{B} (p-host H^{P}), H^{B}-5 was used as host material H^{N}, E^{B}-10 was used as TADF material E^{B}, P^{B}-2 was used as phosphorescence material P^{B}, and S^{B}-1 was used as small FWHM emitter S^{B}. A weight percentage of 0% means the absence of the material in the light-emitting layer B.

### Device results X

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D42** | 0.18 | 532 | 0.33 | 0.64 | 3.81 | 14.4 | 1.00 |
| **D43** | 0.18 | 532 | 0.32 | 0.65 | 4.00 | 14.9 | 0.17 |
| **D44** | 0.18 | 534 | 0.33 | 0.64 | 4.31 | 14.8 | 1.77 |

As can be concluded from device results X, device D44 according to the present invention shows a superior overall performance as compared to device D43 which lacks the TADF material E^{B} (here exemplarily E^{B}-10) and device D42 which lacks the phosphorescence material P^{B} (here exemplarily P^{B}-2) when taking the narrow emission (FWHM), the efficiency (EQE), and the device lifetime (LT95) into account. In the absence of the TADF material E^{B}-10, an n-host (here exemplarily H^{B}-5) was used to increase the electron mobility within the EML.

### Composition of the light-emitting layer B of devices D45 to D49 (the percentages refer to weight percent):

| **Layer** | **D45** | **D46** | **D47** | **D48** | **D49** |
|---|---|---|---|---|---|
| **Emission layer (6)** | H^{B} (80%): | H^{B} (79%): | H^{B} (79%): | H^{B} (78%): | H^{B} (78%): |
| | H^{N} (0%): | H^{N} (20%): | H^{N} (0%): | H^{N} (20%): | H^{N} (0%): |
| | E^{B} (20%): | E^{B} (0%): | E^{B} (20%): | E^{B} (0%): | E^{B} (20%): |
| | P^{B} (0%): | P^{B} (1%): | P^{B} (0%): | P^{B} (1%): | P^{B} (1%): |
| | S^{B} (0%) | S^{B} (0%) | S^{B} (1%) | S^{B} (1%) | S^{B} (1%) |

Setup 1 from Table 2 was used, wherein H^{B}-4 was used as host material H^{B} (p-host H^{P}; also used as material for the electron blocking layer 5), H^{B}-5 was used as host material H^{N}, E^{B}-10 was used as TADF material E^{B}, P^{B}-4 was used as phosphorescence material P^{B}, and S^{B}-1 was used as small FWHM emitter S^{B}. A weight percentage of 0% means the absence of the material in the light-emitting layer B.

### Device results XI

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D45** | 0.34 | 521 | 0.31 | 0.60 | 5.04 | 17.5 | 1.00 |
| **D46** | 0.25 | 522 | 0.32 | 0.63 | 5.91 | 27.0 | 0.72 |
| **D47** | 0.16 | 532 | 0.31 | 0.65 | 6.02 | 20.0 | 2.27 |
| **D48** | 0.17 | 531 | 0.32 | 0.65 | 6.56 | 22.5 | 0.64 |
| **D49** | 0.17 | 532 | 0.33 | 0.64 | 7.70 | 19.2 | 4.39 |

As can be concluded from device results XI, device D49 according to the present invention shows a superior overall performance as compared to device D48 which lacks the TADF material E^{B} (here exemplarily E^{B}-10) and device D47 which lacks the phosphorescence material P^{B} (here exemplarily P^{B}-4) and device D46 which employs P^{B}-4 as the emitter material in spite of S^{B}-1 and device D45 which employs E^{B}-10 as the emitter material in spite of S^{B}-1, when taking the narrow emission (FWHM), the efficiency (EQE), and the device lifetime (LT95) into account. In the absence of the TADF material E^{B}-10, an n-host (here exemplarily H^{B}-5) was used to increase the electron mobility within the EML.

### Composition of the light-emitting layer B of devices D50 to D64 (the percentages refer to weight percent):

| **Layer** | **D50** | **D51** | **D52** | **D53** | **D54** |
|---|---|---|---|---|---|
| **Emission layer (6)** | H^{B} (80%): | H^{B} (79%): | H^{B} (79%): | H^{B} (78%): | H^{B} (78%): |
| | H^{N} (0%): | H^{N} (20%): | H^{N} (0%): | H^{N} (20%): | H^{N} (0%): |
| | E^{B} (20%): | E^{B} (0%): | E^{B} (20%): | E^{B} (0%): | E^{B} (20%): |
| | P^{B} (0%): | P^{B} (1%): | P^{B} (0%): | P^{B} (1%): | P^{B} (1%): |
| | S^{B} (0%) | S^{B} (0%) | S^{B} (1%) | S^{B} (1%) | S^{B} (1%) |
| | | | | | |

| **Layer** | **D55** | **D56** | **D57** | **D58** | **D59** |
|---|---|---|---|---|---|
| **Emission layer (6)** | H^{B} (75%): | H^{B} (75.5%): | H^{B} (72%): | H^{B} (72.5%): | H^{B} (65.5%): |
| | H^{N} (0%): | H^{N} (0%): | H^{N} (0%): | H^{N} (0%): | H^{N} (0%): |
| | E^{B} (20%): | E^{B} (20%): | E^{B} (20%): | E^{B} (20%): | E^{B} (30%): |
| | P^{B} (4%): | P^{B} (4%): | P^{B} (7%): | P^{B} (7%): | P^{B} (4%): |
| | S^{B} (1%) | S^{B} (0.5%) | S^{B} (1%) | S^{B} (0.5%) | S^{B} (0.5%) |
| | | | | | |

| | **D60** | **D61** | | | |
|---|---|---|---|---|---|
| **Emission layer (6)** | H^{B} (55.5%): | H^{B} (67.5%): | | | |
| | H^{N} (0%): | H^{N} (0%): | | | |
| | E^{B} (40%): | E^{B} (30%): | | | |
| | P^{B} (4%): | P^{B} (3%): | | | |
| | S^{B} (0.5%) | S^{B} (0.5%) | | | |

Setup 5 from Table 6 was used, wherein H^{B}-15 was used as host material H^{B} (p-host H^{P}), H^{B}-5 was used as host material H^{N}, E^{B}-11 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results XII

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D50** | 0.35 | 530 | 0.34 | 0.57 | 3.51 | 11.0 | 1.00 |
| **D51** | 0.28 | 508 | 0.27 | 0.63 | 3.85 | 18.7 | 0.47 |
| **D52** | 0.17 | 534 | 0.32 | 0.64 | 3.67 | 12.7 | 0.90 |
| **D53** | 0.16 | 532 | 0.31 | 0.65 | 3.83 | 14.5 | 0.84 |
| **D54** | 0.19 | 532 | 0.32 | 0.65 | 4.29 | 17.5 | 1.91 |
| **D55** | 0.16 | 534 | 0.33 | 0.64 | 4.71 | 20.2 | 6.72 |
| **D56** | 0.17 | 532 | 0.32 | 0.65 | 4.75 | 19.0 | 10.71 |
| **D57** | 0.17 | 534 | 0.33 | 0.64 | 4.70 | 18.3 | 6.18 |
| **D58** | 0.18 | 532 | 0.32 | 0.64 | 4.69 | 16.9 | 7.21 |
| **D59** | 0.19 | 532 | 0.33 | 0.64 | 4.54 | 18.7 | 14.51 |
| **D60** | 0.20 | 532 | 0.34 | 0.63 | 4.22 | 16.9 | 14.27 |
| **D61** | 0.21 | 532 | 0.34 | 0.63 | 4.54 | 18.0 | 17.15 |

As can be concluded from device results XII, device D54 according to the present invention shows a superior overall performance as compared to device D53 which lacks the TADF material E^{B} (here exemplarily E^{B}-11) and device D52 which lacks the phosphorescence material P^{B} (here exemplarily Ir(ppy)₃) and device D51 which employs Ir(ppy)₃ as the emitter material in spite of S^{B}-1 and device D50 which employs E^{B}-11 as the emitter material in spite of S^{B}-1, when taking the narrow emission (FWHM), the efficiency (EQE), and the device lifetime (LT95) into account. When comparing the performance of devices D55 to D58, it can be concluded that the reduction of the concentration of the small FWHM emitter (here exemplarily S^{B}-1) in the EML from 1% to 0.5% may result in a prolonged device lifetime. Devices D59 to D61 were also prepared according to the present invention and, especially in comparison with D55 according to the present invention, indicate that increasing the concentration of the TADF material E^{B} (here exemplarily E^{B}-11) from 20% to 30% or even to 40% may result in an improved overall device performance. The comparison between the devices D55 to D58 and between D60 and D61 indicates that in contrast, a low concentration of the phosphorescence material P^{B} (here exemplarily Ir(ppy)₃) is beneficial for the device performance. In the absence of the TADF material E^{B}-11, an n-host (here exemplarily H^{B}-5) was used to increase the electron mobility within the EML.

### Composition of the light-emitting layer B of devices D62 to D71 (the percentages refer to weight percent):

| **Layer** | **D62** | **D63** | **D64** | **D65** | **D66** |
|---|---|---|---|---|---|
| **Emission layer (6)** | H^{B} (80%): | H^{B} (79%): | H^{B} (79%): | H^{B} (78%): | H^{B} (79%): |
| | H^{N} (0%): | H^{N} (20%): | H^{N} (0%): | H^{N} (20%): | H^{N} (0%): |
| | E^{B} (20%): | E^{B} (0%): | E^{B} (20%): | E^{B} (0%): | E^{B} (20%): |
| | P^{B} (0%): | P^{B} (1%): | P^{B} (0%): | P^{B} (1%): | P^{B} (1%): |
| | S^{B} (0%) | S^{B} (0%) | S^{B} (1%) | S^{B} (1%) | S^{B} (0%) |
| | | | | | |

| **Layer** | **D67** | **D68** | **D69** | **D70** | **D71** |
|---|---|---|---|---|---|
| **Emission layer (6)** | H^{B} (78%): | H^{B} (75%): | H^{B} (67%): | H^{B} (57%): | H^{B} (47%): |
| | H^{N} (0%): | H^{N} (0%): | H^{N} (0%): | H^{N} (0%): | H^{N} (0%): |
| | E^{B} (20%): | E^{B} (20%): | E^{B} (30%): | E^{B} (40%): | E^{B} (50%): |
| | P^{B} (1%): | P^{B} (4%): | P^{B} (2.5%): | P^{B} (2.5%): | P^{B} (2.5%): |
| | S^{B} (1%) | S^{B} (1%) | S^{B} (0.5%) | S^{B} (0.5%) | S^{B} (0.5%) |

Setup 5 from Table 6 was used, wherein H^{B}-15 was used as host material H^{B} (p-host H^{P}), H^{B}-5 was used as host material H^{N}, E^{B}-11 was used as TADF material E^{B}, P^{B}-2 was used as phosphorescence material P^{B}, and S^{B}-1 was used as small FWHM emitter S^{B}. A weight percentage of 0% means the absence of the material in the light-emitting layer B.

### Device results XIII

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D62** | 0.35 | 530 | 0.34 | 0.57 | 3.51 | 10.98 | 1.00 |
| **D63** | 0.28 | 516 | 0.30 | 0.63 | 3.94 | 21.33 | 2.47 |
| **D64** | 0.17 | 534 | 0.32 | 0.64 | 3.64 | 13.74 | 1.81 |
| **D65** | 0.17 | 534 | 0.32 | 0.65 | 3.96 | 19.87 | 3.76 |
| **D66** | 0.16 | 520 | 0.33 | 0.61 | 4.30 | 15.09 | 5.17 |
| **D67** | 0.17 | 534 | 0.33 | 0.64 | 4.35 | 20.89 | 9.59 |
| **D68** | 0.17 | 534 | 0.34 | 0.64 | 4.65 | 21.9 | 19.51 |
| **D69** | 0.20 | 532 | 0.34 | 0.63 | 4.56 | 19.3 | 23.18 |
| **D70** | 0.22 | 532 | 0.35 | 0.62 | 4.24 | 17.2 | 17.96 |
| **D71** | 0.24 | 532 | 0.36 | 0.61 | 3.96 | 14.6 | 8.61 |

As can be concluded from device results XIII, device D67 according to the present invention shows a superior overall performance as compared to device D66 which lacks the small FWHM emitter S^{B} (here exemplarily S^{B}-1) and device D65 which lacks the TADF material E^{B} (here exemplarily E^{B}-11) and device D64 which lacks the phosphorescence material P^{B} (here exemplarily P^{B}-2) and device D63 which employs P^{B}-2 as the emitter material in spite of S^{B}-1 and device D62 which employs E^{B}-11 as the emitter material in spite of S^{B}-1, when taking the narrow emission (FWHM), the efficiency (EQE), and the device lifetime (LT95) into account. When comparing the performance of devices D67 to D71, it can be concluded that for the given set of materials, a concentration of 30% of E^{B}-11 and 2.5% of P^{B}-2 and of 0.5% of S^{B}-1 afforded the best performing device (D69).

### Composition of the light-emitting layer B of devices D72 to D79 (the percentages refer to weight percent):

| **Layer** | **D72** | **D73** | **D74** | **D75** | **D76** |
|---|---|---|---|---|---|
| **Emission layer (6)** | H^{B} (80%): | H^{B} (79%): | H^{B} (79%): | H^{B} (78%): | H^{B} (78%): |
| | H^{N} (0%): | H^{N} (20%): | H^{N} (0%): | H^{N} (20%): | H^{N} (0%): |
| | E^{B} (20%): | E^{B} (0%): | E^{B} (20%): | E^{B} (0%): | E^{B} (20%): |
| | P^{B} (0%): | P^{B} (1%): | P^{B} (0%): | P^{B} (1%): | P^{B} (1%): |
| | S^{B} (0%) | S^{B} (0%) | S^{B} (1%) | S^{B} (1%) | S^{B} (1%) |
| | | | | | |

| **Layer** | **D77** | **D78** | **D79** | | |
|---|---|---|---|---|---|
| **Emission layer (6)** | H^{B} (78.5%): | H^{B} (75%): | H^{B} (75.5%): | | |
| | H^{N} (0%): | H^{N} (0%): | H^{N} (0%): | | |
| | E^{B} (20%): | E^{B} (20%): | E^{B} (20%): | | |
| | P^{B} (1%): | P^{B} (4%): | P^{B} (4%): | | |
| | S^{B} (0.5%) | S^{B} (1%) | S^{B} (0.5%) | | |

Setup 5 from Table 6 was used, wherein H^{B}-15 was used as host material H^{B} (p-host H^{P}), H^{B}-5 was used as host material H^{N}, E^{B}-11 was used as TADF material E^{B}, P^{B}-4 was used as phosphorescence material P^{B}, and S^{B}-1 was used as small FWHM emitter S^{B}. A weight percentage of 0% means the absence of the material in the light-emitting layer B.

### Device results XIV

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D72** | 0.26 | 528 | 0.34 | 0.57 | 3.67 | 10.6 | 1.00 |
| **D73** | 0.24 | 520 | 0.30 | 0.64 | 4.36 | 25.0 | 0.54 |
| **D74** | 0.17 | 534 | 0.32 | 0.64 | 3.78 | 14.0 | 1.18 |
| **D75** | 0.16 | 532 | 0.32 | 0.65 | 4.39 | 13.2 | 0.57 |
| **D76** | 0.17 | 534 | 0.33 | 0.64 | 4.72 | 19.6 | 3.65 |
| **D77** | 0.18 | 530 | 0.32 | 0.64 | 4.66 | 19.8 | 7.29 |
| **D78** | 0.17 | 534 | 0.34 | 0.64 | 5.71 | 23.5 | 19.39 |
| **D79** | 0.19 | 530 | 0.33 | 0.64 | 5.57 | 22.6 | 35.59 |

As can be concluded from device results XIV, device D76 according to the present invention shows a superior overall performance as compared to device D75 which lacks the TADF material E^{B} (here exemplarily E^{B}-11) and device D74 which lacks the phosphorescence material P^{B} (here exemplarily P^{B}-4) and device D73 which employs P^{B}-4 as the emitter material in spite of S^{B}-1 and device D72 which employs E^{B}-11 as the emitter material in spite of S^{B}-1, when taking the narrow emission (FWHM), the efficiency (EQE), and the device lifetime (LT95) into account. When comparing the performance of devices D76 to D79, it can be concluded that the reduction of the concentration of the small FWHM emitter S^{B} (here exemplarily S^{B}-1 from 1% to 0.5% may improve the overall device performance.

### Composition of the light-emitting layer B of devices D80 to D85 (the percentages refer to weight percent):

| **Layer** | **D80** | **D81** | **D82** | **D83** | **D84** |
|---|---|---|---|---|---|
| **Emission layer (6)** | H^{B} (70%): | H^{B} (79.5%): | H^{B} (69.5%): | H^{B} (66%): | H^{B} (75.5%): |
| | E^{B} (30%): | E^{B} (20%): | E^{B} (30%): | E^{B} (30%): | E^{B} (20%): |
| | P^{B} (0%): | P^{B} (0%): | P^{B} (0%): | P^{B} (4%): | P^{B} (4%): |
| | S^{B} (0%) | S^{B} (0.5%) | S^{B} (0.5%) | S^{B} (0%) | S^{B} (0.5%) |
| | | | | | |

| **Layer** | **D85** | | | | |
|---|---|---|---|---|---|
| **Emission layer (6)** | H^{B} (65.5%): | | | | |
| | E^{B} (30%): | | | | |
| | P^{B} (4%): | | | | |
| | S^{B} (0.5%) | | | | |

Setup 5 from Table 6 was used, wherein H^{B}-15 was used as host material H^{B} (p-host H^{P}), E^{B}-15 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results XV

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D80** | 0.41 | 532 | 0.35 | 0.57 | 3.43 | 10.2 | 1.00 |
| **D81** | 0.19 | 530 | 0.32 | 0.63 | 3.45 | 12.8 | 0.88 |
| **D82** | 0.19 | 530 | 0.32 | 0.63 | 3.44 | 12.3 | 1.50 |
| **D83** | 0.38 | 518 | 0.36 | 0.59 | 4.50 | 13.2 | 4.50 |
| **D84** | 0.19 | 532 | 0.32 | 0.64 | 4.81 | 18.3 | 5.12 |
| **D85** | 0.19 | 532 | 0.33 | 0.63 | 4.54 | 17.7 | 9.23 |

As can be concluded from device results XV, device D84 according to the present invention shows a superior overall performance as compared to device D81 which lacks the phosphorescence material P^{B} (here exemplarily Ir(ppy)₃). Furthermore, D85 according to the present invention shows a superior overall performance as compared to device D83 which lacks the small FWHM emitter S^{B} (here exemplarily S^{B}-1) and device D81 which lacks the phosphorescence material P^{B} (here exemplarily P^{B}-4) and device D80 which employs E^{B}-15 as the emitter material in spite of S^{B}-1, when taking the narrow emission (FWHM), the efficiency (EQE), and the device lifetime (LT95) into account.

### Composition of the light-emitting layer B of devices D86 to D90 (the percentages refer to weight percent):

| **Layer** | **D86** | **D87** | **D88** | **D89** | **D90** |
|---|---|---|---|---|---|
| **Emission layer (6)** | H^{B} (70%): | H^{B} (79.5%): | H^{B} (69.5%): | H^{B} (75.5%): | H^{B} (65.5%): |
| | E^{B} (30%): | E^{B} (20%): | E^{B} (30%): | E^{B} (20%): | E^{B} (30%): |
| | P^{B} (0%): | P^{B} (0%): | P^{B} (0%): | P^{B} (4%): | P^{B} (4%): |
| | S^{B} (0%) | S^{B} (0.5%) | S^{B} (0.5%) | S^{B} (0.5%) | S^{B} (0.5%) |

Setup 5 from Table 6 was used, wherein H^{B}-15 was used as host material H^{B} (p-host H^{P}), E^{B}-15 was used as TADF material E^{B}, P^{B}-2 was used as phosphorescence material P^{B}, and S^{B}-1 was used as small FWHM emitter S^{B}. A weight percentage of 0% means the absence of the material in the light-emitting layer B.

### Device results XVI

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D86** | 0.41 | 532 | 0.35 | 0.57 | 3.43 | 10.2 | 1.00 |
| **D87** | 0.19 | 530 | 0.32 | 0.63 | 3.45 | 12.8 | 0.55 |
| **D88** | 0.19 | 532 | 0.32 | 0.63 | 3.44 | 12.3 | 0.96 |
| **D89** | 0.19 | 532 | 0.32 | 0.64 | 5.14 | 19.0 | 1.98 |
| **D90** | 0.20 | 532 | 0.34 | 0.63 | 4.64 | 19.3 | 3.44 |

As can be concluded from device results XVI, devices D89 and D90 according to the present invention show a superior overall performance as compared to device D87 and D88 which lack the phosphorescence material P^{B} (here exemplarily P^{B}-2) and device D86 which employs E^{B}-15 as the emitter material in spite of S^{B}-1, when taking the narrow emission (FWHM), the efficiency (EQE), and the device lifetime (LT95) into account.

### Composition of the light-emitting layer B of devices D91 to D94 (the percentages refer to weight percent):

| **Layer** | **D91** | **D92** | **D93** | **D94** |
|---|---|---|---|---|
| **Emission layer (6)** | H^{B} (70%): | H^{B} (69.5%): | H^{B} (66%): | H^{B} (65.5%): |
| | E^{B} (30%): | E^{B} (30%): | E^{B} (30%): | E^{B} (30%): |
| | P^{B} (0%): | P^{B} (0%): | P^{B} (4%): | P^{B} (4%): |
| | S^{B} (0%) | S^{B} (0.5%) | S^{B} (0%) | S^{B} (0.5%) |

Setup 5 from Table 6 was used, wherein H^{B}-15 was used as host material H^{B} (p-host H^{P}), E^{B}-16 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results XVII

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D91** | 0.33 | 518 | 0.30 | 0.61 | 3.08 | 19.4 | 1.00 |
| **D92** | 0.18 | 532 | 0.31 | 0.64 | 3.25 | 18.7 | 1.72 |
| **D93** | 0.33 | 520 | 0.33 | 0.61 | 3.61 | 20.6 | 7.61 |
| **D94** | 0.18 | 534 | 0.33 | 0.64 | 3.83 | 24.7 | 18.21 |

As can be concluded from device results XVII, device D94 according to the present invention shows a superior overall performance as compared to device D93 which lacks the small FWHM emitter S^{B} (here exemplarily S^{B}-1) and device D92 which lacks the phosphorescence material P^{B} (here exemplarily Ir(ppy)₃) and device D91 which employs E^{B}-16 as the emitter material in spite of S^{B}-1, when taking the narrow emission (FWHM), the efficiency (EQE), and the device lifetime (LT95) into account.

### Composition of the light-emitting layer B of devices D91 to D94 (the percentages refer to weight percent):

| **Layer** | **D95** | **D96** | **D97** |
|---|---|---|---|
| **Emission layer (6)** | H^{B} (69.5%): | H^{B} (66%): | H^{B} (65.5%): |
| | E^{B} (30%): | E^{B} (30%): | E^{B} (30%): |
| | P^{B} (0%): | P^{B} (4%): | P^{B} (4%): |
| | S^{B} (0.5%) | S^{B} (0%) | S^{B} (0.5%) |

Setup 5 from Table 6 was used, wherein H^{B}-15 was used as host material H^{B} (p-host H^{P}), E^{B}-17 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results XVIII

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D95** | 0.20 | 532 | 0.33 | 0.63 | 3.64 | 11.3 | 1.00 |
| **D96** | 0.44 | 550 | 0.40 | 0.56 | 4.27 | 8.4 | 3.77 |
| **D97** | 0.24 | 534 | 0.37 | 0.61 | 4.42 | 13.5 | 4.49 |

As can be concluded from device results XVIII, device D97 according to the present invention shows a superior overall performance as compared to device D96 which lacks the small FWHM emitter S^{B} (here exemplarily S^{B}-1) and device D95 which lacks the phosphorescence material P^{B} (here exemplarily Ir(ppy)₃), when taking the narrow emission (FWHM), the efficiency (EQE), and the device lifetime (LT95) into account.

### Composition of the light-emitting layer B of devices D98 to D101 (the percentages refer to weight percent):

| **Layer** | **D98** | **D99** | **D100** | **D101** |
|---|---|---|---|---|
| **Emission layer (6)** | H^{B} (70%): | H^{B} (69.5%): | H^{B} (66%): | H^{B} (65.5%): |
| | E^{B} (30%): | E^{B} (30%): | E^{B} (30%): | E^{B} (30%): |
| | P^{B} (0%): | P^{B} (0%): | P^{B} (4%): | P^{B} (4%): |
| | S^{B} (0%) | S^{B} (0.5%) | S^{B} (0%) | S^{B} (0.5%) |

Setup 5 from Table 6 was used, wherein H^{B}-15 was used as host material H^{B} (p-host H^{P}), E^{B}-18 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results XIX

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D98** | 0.40 | 535 | 0.37 | 0.57 | 3.68 | 8.7 | 1.00 |
| **D99** | 0.20 | 531 | 0.34 | 0.62 | 3.87 | 8.7 | 1.22 |
| **D100** | 0.43 | 546 | 0.39 | 0.57 | 4.52 | 9.8 | 5.85 |
| **D101** | 0.22 | 532 | 0.36 | 0.61 | 4.80 | 11.4 | 8.24 |

As can be concluded from device results XIX, device D101 according to the present invention shows a superior overall performance as compared to device D100 which lacks the small FWHM emitter S^{B} (here exemplarily S^{B}-1) and device D99 which lacks the phosphorescence material P^{B} (here exemplarily Ir(ppy)₃) and device D98 which employs E^{B}-1 8 as the emitter material in spite of S^{B}-1, when taking the narrow emission (FWHM), the efficiency (EQE), and the device lifetime (LT95) into account.

### Composition of the light-emitting layer B of devices D102 to D105 (the percentages refer to weight percent):

| **Layer** | **D102** | **D103** | **D104** | **D105** |
|---|---|---|---|---|
| **Emission layer (6)** | H^{B} (70%): | H^{B} (69.5%): | H^{B} (66%): | H^{B} (65.5%): |
| | E^{B} (30%): | E^{B} (30%): | E^{B} (30%): | E^{B} (30%): |
| | P^{B} (0%): | P^{B} (0%): | P^{B} (4%): | P^{B} (4%): |
| | S^{B} (0%) | S^{B} (0.5%) | S^{B} (0%) | S^{B} (0.5%) |

Setup 5 from Table 6 was used, wherein H^{B}-15 was used as host material H^{B} (p-host H^{P}), E^{B}-19 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results XX

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D102** | 0.41 | 532 | 0.353 | 0.573 | 3.56 | 9.25 | 1.00 |
| **D103** | 0.19 | 531 | 0.324 | 0.631 | 3.64 | 12.31 | 1.70 |
| **D104** | 0.41 | 535 | 0.373 | 0.582 | 4.31 | 11.68 | 4.07 |
| **D105** | 0.20 | 532 | 0.339 | 0.628 | 4.51 | 16.97 | 8.31 |

As can be concluded from device results XX, device D105 according to the present invention shows a superior overall performance as compared to device D104 which lacks the small FWHM emitter S^{B} (here exemplarily S^{B}-1) and device D103 which lacks the phosphorescence material P^{B} (here exemplarily Ir(ppy)₃) and device D102 which employs E^{B}-19 as the emitter material in spite of S^{B}-1, when taking the narrow emission (FWHM), the efficiency (EQE), and the device lifetime (LT95) into account.

### Composition of the light-emitting layer B of devices D106 to D108 (the percentages refer to weight percent):

| **Layer** | **D106** | **D107** | **D108** |
|---|---|---|---|
| **Emission layer (6)** | H^{B} (70%): | H^{B} (69.5%): | H^{B} (65.5%): |
| | E^{B} (30%): | E^{B} (30%): | E^{B} (30%): |
| | P^{B} (0%): | P^{B} (0%): | P^{B} (4%): |
| | S^{B} (0%) | S^{B} (0.5%) | S^{B} (0.5%) |

Setup 5 from Table 6 was used, wherein H^{B}-15 was used as host material H^{B} (p-host H^{P}), E^{B}-21 was used as TADF material E^{B}, Ir(ppy)₃ was used as phosphorescence material P^{B}, and S^{B}-1 was used as small FWHM emitter S^{B}. A weight percentage of 0% means the absence of the material in the light-emitting layer B.

### Device results XXI

| Device | FWHM [eV] | λₘₐₓ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D106** | 0.41 | 520 | 0.30 | 0.56 | 3.65 | 11.2 | 1.00 |
| **D107** | 0.18 | 528 | 0.29 | 0.63 | 3.61 | 12.4 | 1.69 |
| **D108** | 0.18 | 530 | 0.31 | 0.65 | 5.10 | 19.4 | 15.88 |

As can be concluded from device results XXI, device D108 according to the present invention shows a superior overall performance as compared to device D107 which lacks the phosphorescence material P^{B} (here exemplarily Ir(ppy)₃) and device D106 which employs E^{B}-21 as the emitter material in spite of S^{B}-1, when taking the narrow emission (FWHM), the efficiency (EQE), and the device lifetime (LT95) into account.

## Claims

1. An organic electroluminescent device comprising at least one light-emitting layer B which is composed of one or more sublayers, wherein the one or more sublayers are adjacent to each other and as a whole contain:
(i) at least one host material H^{B}, which has a lowermost excited singlet state energy level E(S1^{H}) and a lowermost excited triplet state energy level E(T1^{H});
(ii) at least one phosphorescence material P^{B}, which has a lowermost excited singlet state energy level E(S1^{P}) and a lowermost excited triplet state energy level E(T1^{P}); and
(iii) at least one small full width at half maximum (FWHM) emitter S^{B}, which has a lowermost excited singlet state energy level E(S1^{S}) and a lowermost excited triplet state energy level E(T1^{S}), wherein S^{B} emits light with a full width at half maximum (FWHM) of less than or equal to 0.25 eV; and optionally
(iv) at least one thermally activated delayed fluorescence (TADF) material E^{B}, which has a lowermost excited singlet state energy level E(S1^{E}) and a lowermost excited triplet state energy level E(T1^{E}),
wherein the one or more sublayers which are located at the outer surface of the light-emitting layer B contain at least one material selected from the group consisting of phosphorescence material P^{B}, small FWHM emitter S^{B}, and TADF material E^{B},
wherein the optional at least one TADF material E^{B} exhibits an excited state lifetime τ(E^{B}) equal to or shorter than 75 µs, preferably wherein each TADF material E^{B} exhibits an excited state lifetime τ(E^{B}) equal to or shorter than 75 µs, **characterized in that** the small full width at half maximum (FWHM) emitter S^{B} emits light with a full width at half maximum (FWHM) of less than or equal to 0.25 eV as determinable at approximately 20 °C measured from a film of 2% by weight of the small full width at half maximum emitter in poly(methyl methacrylate) (PMMA).

2. The organic electroluminescent device according to claim 1, wherein at least one of the one or more sublayers of the at least one light-emitting layer B, preferably each light-emitting layer B, comprises:
(iv) at least one thermally activated delayed fluorescence (TADF) material E^{B}, which has a lowermost excited singlet state energy level E(S1^{E}) and a lowermost excited triplet state energy level E(T1^{E}).

3. The organic electroluminescent device according to one or both of claims 1 and 2, wherein the at least one TADF material E^{B} exhibits an excited state lifetime τ(E^{B}) equal to or shorter than 50 µs, preferably wherein each TADF material E^{B} exhibits an excited state lifetime τ(E^{B}) equal to or shorter than 50 µs.

4. The organic electroluminescent device according to one or more of claims 1 to 3, wherein the at least one TADF material E^{B} exhibits an excited state lifetime τ(E^{B}) equal to or shorter than 10 µs, preferably wherein each TADF material E^{B} exhibits an excited state lifetime τ(E^{B}) equal to or shorter than 10 µs.

5. The organic electroluminescent device according to one or more of claims 1 to 4, wherein at least one sublayer comprises exactly one TADF material E^{B} and exactly one phosphorescence material P^{B}.

6. The organic electroluminescent device according to one or more of claims 1 to 5, wherein a sublayer comprises exactly one TADF material E^{B} and another or the same sublayer comprises exactly one phosphorescence material P^{B} and exactly one small FWHM emitter S^{B}.

7. The organic electroluminescent device according to one or more of claims 1 to 6, wherein the relations expressed by the following formulas (1) and (2) apply: $E \left(T{1}^{H}\right) > E \left(T{1}^{P}\right)$ $E \left(T{1}^{P}\right) > E \left(S{1}^{S}\right)$

8. The organic electroluminescent device according to one or more of claims 1 to 7, wherein the relations expressed by the following formulas (3) and (4) apply: $E \left(T{1}^{H}\right) > E \left(T{1}^{E}\right)$ $E \left(T{1}^{E}\right) > E \left(T{1}^{P}\right)$

9. The organic electroluminescent device according to one or more of claims 1 to 8, wherein each TADF material E^{B}
(i) is **characterized by** exhibiting a ΔE_{ST} value, which corresponds to the energy difference between the lowermost excited singlet state energy level E(S1^{E}) and the lowermost excited triplet state energy level E(T1^{E}), of less than 0.4 eV; and
(ii) displays a photoluminescence quantum yield (PLQY) of more than 30%.

10. The organic electroluminescent device according to one or more of claims 1 to 9, wherein the at least one phosphorescence material P^{B} exhibits an excited state lifetime τ(P^{B}) equal to or shorter than 50 µs, preferably wherein each phosphorescence material P^{B} exhibits an excited state lifetime τ(P^{B}) equal to or shorter than 50 µs.

11. The organic electroluminescent device according to one or more of claims 1 to 10, wherein the at least one phosphorescence material P^{B} exhibits an excited state lifetime τ(P^{B}) equal to or shorter than 10 µs, preferably wherein each phosphorescence material P^{B} exhibits an excited state lifetime τ(P^{B}) equal to or shorter than 10 µs.

12. The organic electroluminescent device according to one or more of claims 1 to 11, wherein the one or more sublayers as a whole comprise or consist of:
(i) 30-99.8 % by weight of one or more host compound H^{B};
(ii) 0.1-30 % by weight of one or more phosphorescence material P^{B}; and
(iii) 0.1-10 % by weight of one or more small FWHM emitter S^{B}; and optionally
(iv) 0-69.8 % by weight of one or more TADF material E^{B}; and optionally
(v) 0-69.8 % by weight of one or more solvents.

13. The organic electroluminescent device according to one or more of claims 1 to 12, wherein the at least one light-emitting layer B, preferably each light-emitting layer B, is composed of exactly one (sub)layer.

14. A method for generating light, comprising the steps of:
(i) providing an organic electroluminescent device according to any of claims 1 to 13; and
(ii) applying an electrical current to said organic electroluminescent device.

15. The method according to claim 14, wherein the method is for generating light at a wavelength range selected from one of the following wavelength ranges:
(i) from 510 nm to 550 nm, or
(ii) from 440 nm to 470 nm, or
(iii) from 610 nm to 665 nm.

## Patentansprüche

1. Organische elektrolumineszente Vorrichtung umfassend mindestens eine lichtemittierende Schicht B, die aus einer oder mehreren Unterschichten zusammengesetzt ist, wobei die eine oder mehreren Unterschichten einander angrenzen und als Ganzes enthalten:
(i) mindestens ein Wirtsmaterial H^{B}, das ein niedrigstes angeregtes Singulett-Zustands-Energieniveau E(S1^{H}) und ein niedrigstes angeregtes Triplett-Zustands-Energieniveau E(T1^{H}) aufweist;
(ii) mindestens ein Phosphoreszenzmaterial P^{B}, das ein niedrigstes angeregtes Singulett-Zustands-Energieniveau E(S1^{P}) und ein niedrigstes angeregtes Triplett-Zustands-Energieniveau E(T1^{P}) aufweist; und
(iii) mindestens einen Emitter S^{B} mit kleiner Halbwertsbreite (FWHM), der ein niedrigstes angeregtes Singulett-Zustands-Energieniveau E(S1^{B}) und ein niedrigstes angeregtes Triplett-Zustands-Energieniveau E(T1^{S}) aufweist, wobei S^{B} Licht mit einer Halbwertsbreite (FWHM) von weniger als oder gleich 0,25 eV emittiert; und optional
(iv) mindestens ein thermisch aktiviertes verzögertes Fluoreszenz (TADF)-Material E^{B}, das ein niedrigstes angeregtes Singulett-Zustands-Energieniveau E(S1^{E}) und ein niedrigstes angeregtes Triplett-Zustands-Energieniveau E(T1^{E}) aufweist,
wobei die eine oder mehrere Unterschichten, die sich an der äußersten Oberfläche der lichtemittierenden Schicht B befinden, mindestens ein Material enthalten ausgewählt aus der Gruppe bestehend aus Phosphoreszenzmaterial P^{B}, Emitter S^{B} mit kleiner FWHM und TADF-Material E^{B},
wobei das optionale mindestens eine TADF-Material E^{B} eine Lebensdauer im angeregten Zustand τ(E^{B}) gleich oder kürzer als 75 µs aufweist, vorzugsweise wobei jedes TADF-Material E^{B} eine Lebensdauer im angeregten Zustand τ(E^{B}) gleich oder kürzer als 75 µs aufweist, **dadurch gekennzeichnet, dass** der Emitter S^{B} mit kleiner Halbwertsbreite (FWHM) Licht mit einer Halbwertsbreite (FWHM) von weniger als oder gleich 0,25 eV emittiert, bestimmbar bei etwa 20 °C, gemessen an einem Film aus 2 Gew.-% des Emitters mit geringer Halbwertsbreite in Poly(methylmethacrylat) (PMMA).

2. Organische elektrolumineszente Vorrichtung nach Anspruch 1, wobei mindestens eine der einen oder mehreren Unterschichten der mindestens einen lichtemittierenden Schicht B, vorzugsweise jeder lichtemittierenden Schicht B, umfasst:
(iv) mindestens ein thermisch aktiviertes verzögertes Fluoreszenz (TADF)-Material E^{B}, das ein niedrigstes angeregtes Singulett-Zustands-Energieniveau E(S1^{E}) und ein niedrigstes angeregtes Triplett-Zustands-Energieniveau E(T1^{E}) aufweist.

3. Organische elektrolumineszente Vorrichtung nach einem oder beiden der Ansprüche 1 und 2, wobei das mindestens eine TADF-Material E^{B} eine Lebensdauer des angeregten Zustands τ(E^{B}) gleich oder kürzer als 50 µs aufweist, vorzugsweise wobei jedes TADF-Material E^{B} eine Lebensdauer des angeregten Zustands τ(E^{B}) gleich oder kürzer als 50 µs aufweist.

4. Organische elektrolumineszente Vorrichtung nach einem oder mehreren der Ansprüche 1 bis 3, wobei das mindestens eine TADF-Material E^{B} eine Lebensdauer des angeregten Zustands τ(E^{B}) gleich oder kürzer als 10 µs aufweist, vorzugsweise wobei jedes TADF-Material E^{B} eine Lebensdauer des angeregten Zustands τ(E^{B}) gleich oder kürzer als 10 µs aufweist.

5. Organische elektrolumineszente Vorrichtung nach einem oder mehreren der Ansprüche 1 bis 4, wobei mindestens eine Unterschicht genau ein TADF-Material E^{B} und genau ein Phosphoreszenzmaterial P^{B} umfasst.

6. Organische elektrolumineszente Vorrichtung nach einem oder mehreren der Ansprüche 1 bis 5, wobei eine Unterschicht genau ein TADF-Material E^{B} und eine andere oder dieselbe Unterschicht genau ein Phosphoreszenzmaterial P^{B} und genau einen Emitter S^{B} mit kleiner FWHM umfasst.

7. Organische elektrolumineszente Vorrichtung nach einem oder mehreren der Ansprüche 1 bis 6, wobei die durch die folgenden Formeln (1) und (2) ausgedrückten Beziehungen gelten: $E \left(T{1}^{H}\right) > E \left(T{1}^{P}\right)$ $E \left(T{1}^{P}\right) > E \left(S{1}^{S}\right)$

8. Organische elektrolumineszente Vorrichtung nach einem oder mehreren der Ansprüche 1 bis 7, wobei die durch die folgenden Formeln (3) und (4) ausgedrückten Beziehungen gelten: $E \left(T{1}^{H}\right) > E \left(T{1}^{E}\right)$ $E \left(T{1}^{E}\right) > E \left(T{1}^{P}\right)$

9. Organische elektrolumineszente Vorrichtung nach einem oder mehreren der Ansprüche 1 bis 8, wobei jedes TADF-Material E^{B}
(i) **dadurch gekennzeichnet ist, dass** es einen ΔE_{ST}-Wert, der der Energiedifferenz zwischen dem niedrigsten angeregten Singulett-Zustands-Energieniveau E(S1^{E}) und dem niedrigsten angeregten Triplett-Zustands-Energieniveau E(T1^{E}) entspricht, von weniger als 0,4 eV aufweist; und
(ii) eine Photolumineszenz-Quantenausbeute (PLQY) von mehr als 30 % aufweist.

10. Organische elektrolumineszente Vorrichtung nach einem oder mehreren der Ansprüche 1 bis 9, wobei das mindestens eine Phosphoreszenzmaterial P^{B} eine Lebensdauer des angeregten Zustands τ(P^{B}) gleich oder kürzer als 50 µs aufweist, vorzugsweise wobei jedes Phosphoreszenzmaterial P^{B} eine Lebensdauer des angeregten Zustands τ(P^{B}) gleich oder kürzer als 50 µs aufweist.

11. Organische elektrolumineszente Vorrichtung nach einem oder mehreren der Ansprüche 1 bis 10, wobei das mindestens eine Phosphoreszenzmaterial P^{B} eine Lebensdauer im angeregten Zustand τ(P^{B}) von gleich oder kürzer als 10 µs aufweist, vorzugsweise wobei jedes Phosphoreszenzmaterial P^{B} eine Lebensdauer im angeregten Zustand τ(P^{B}) von gleich oder kürzer als 10 µs aufweist.

12. Organische elektrolumineszente Vorrichtung nach einem oder mehreren der Ansprüche 1 bis 11, wobei die eine oder die mehreren Unterschichten als Ganzes umfassen oder bestehen aus:
(i) 30-99,8 Gew.-% einer oder mehrerer Wirtsverbindungen H^{B};
(ii) 0,1-30 Gew.-% eines oder mehrerer phosphoreszierender Materialien P^{B}; und
(iii) 0,1-10 Gew.-% eines oder mehrerer Emitter S^{B} mit kleiner FWHM; und optional
(iv) 0-69,8 Gew.-% eines oder mehrerer TADF-Materialien E^{B}; und optional
(v) 0-69,8 Gew.-% eines oder mehrerer Lösungsmittel.

13. Organische elektrolumineszente Vorrichtung nach einem oder mehreren der Ansprüche 1 bis 12, wobei die mindestens eine lichtemittierende Schicht B, vorzugsweise jede lichtemittierende Schicht B, aus genau einer (Unter-)Schicht besteht.

14. Verfahren zur Lichterzeugung, umfassend die Schritte:
(i) Bereitstellen einer organischen elektrolumineszenten Vorrichtung nach einem der Ansprüche 1 bis 13; und
(ii) Anlegen eines elektrischen Stroms an die organische elektrolumineszente Vorrichtung.

15. Verfahren nach Anspruch 14, wobei das Verfahren für die Erzeugung von Licht in einem Wellenlängenbereich ausgewählt aus einem der folgenden Wellenlängenbereiche ist:
(i) von 510 nm bis 550 nm, oder
(ii) von 440 nm bis 470 nm, oder
(iii) von 610 nm bis 665 nm.

## Revendications

1. Dispositif électroluminescent organique comprenant au moins une couche émettrice de lumière B qui est composée d'une ou de plusieurs sous-couches, les une ou plusieurs sous-couches étant adjacentes les unes aux autres et à elles toutes contenant :
(i) au moins un matériau hôte H^{B}, qui a un niveau d'énergie d'état singulet excité le plus bas E(S1^{H}) et un niveau d'énergie d'état triplet excité le plus bas E(T1^{H}) ;
(ii) au moins un matériau de phosphorescence P^{B}, qui a un niveau d'énergie d'état singulet excité le plus bas E(S1^{P}) et un niveau d'énergie d'état triplet excité le plus bas E(T1^{P}) ; et
(iii) au moins un émetteur de faible largeur totale à mi-hauteur (FWHM) S^{B}, qui a un niveau d'énergie d'état singulet excité le plus bas E(S1^{S}) et un niveau d'énergie d'état triplet excité le plus bas E(T1^{S}), dans lequel S^{B} émet de la lumière avec une largeur totale à mi-hauteur (FWHM) inférieure ou égale à 0,25 eV ; et éventuellement
(iv) au moins un matériau à fluorescence retardée activée thermiquement (TADF) E^{B}, qui a un niveau d'énergie d'état singulet excité le plus bas E(S1^{E}) et un niveau d'énergie d'état triplet excité le plus bas E(T1^{E}),
les une ou plusieurs sous-couches qui sont situées au niveau de la surface externe de la couche émettrice de lumière B contenant au moins un matériau sélectionné dans le groupe constitué d'un matériau de phosphorescence PB, d'un émetteur de faible FWHM S^{B}, et d'un matériau TADF E^{B}, dans lequel l'au moins un matériau TADF E^{B} éventuel présente une durée de vie à l'état excité τ(E^{B}) égale ou plus courte que 75 µs, de préférence dans lequel chaque matériau TADF E^{B} présente une durée de vie à l'état excité τ(E^{B}) égale ou plus courte que 75 µs, **caractérisé en ce que** l'émetteur de faible largeur totale à mi-hauteur (FWHM) S^{B} émet de la lumière avec une largeur totale à mi-hauteur (FWHM) inférieure ou égale à 0,25 eV telle que déterminable à environ 20 °C mesurée partir d'un film de 2 % en poids de l'émetteur de faible largeur totale à mi-hauteur dans du poly(méthacrylate de méthyle) (PMMA).

2. Dispositif électroluminescent organique selon la revendication 1, dans lequel au moins l'une parmi la ou les sous-couches de l'au moins une couche émettrice de lumière B, de préférence chaque couche émettrice de lumière B, comprend :
(iv) au moins un matériau à fluorescence retardée activée thermiquement (TADF) E^{B}, qui a un niveau d'énergie d'état singulet excité le plus bas E(S1^{E}) et un niveau d'énergie d'état triplet excité le plus bas E(T1^{E}).

3. Dispositif électroluminescent organique selon l'une ou les deux des revendications 1 et 2, dans lequel l'au moins un matériau TADF E^{B} présente une durée de vie à l'état excité τ(E^{B}) égale ou plus courte que 50 µs, de préférence dans lequel chaque matériau TADF E^{B} présente une durée de vie à l'état excité τ(E^{B}) égale ou plus courte que 50 µs.

4. Dispositif électroluminescent organique selon une ou plusieurs des revendications 1 à 3, dans lequel l'au moins un matériau TADF E^{B} présente une durée de vie à l'état excité τ(E^{B}) égale ou plus courte que 10 µs, de préférence dans lequel chaque matériau TADF E^{B} présente une durée de vie à l'état excité τ(E^{B}) égale ou plus courte que 10 µs.

5. Dispositif électroluminescent organique selon une ou plusieurs des revendications 1 à 4, dans lequel au moins une sous-couche comprend exactement un matériau TADF E^{B} et exactement un matériau de phosphorescence P^{B}.

6. Dispositif électroluminescent organique selon une ou plusieurs des revendications 1 à 5, dans lequel une sous-couche comprend exactement un matériau TADF E^{B} et une autre ou la même sous-couche comprend exactement un matériau de phosphorescence P^{B} et exactement un émetteur de faible FWHM S^{B}.

7. Dispositif électroluminescent organique selon une ou plusieurs des revendications 1 à 6, dans lequel les relations exprimées par les formules (1) et (2) suivantes s'appliquent : $E \left(T{1}^{H}\right) > E \left(T{1}^{P}\right)$ $E \left(T{1}^{P}\right) > E \left(S{1}^{s}\right)$

8. Dispositif électroluminescent organique selon une ou plusieurs des revendications 1 à 7, dans lequel les relations exprimées par les formules (3) et (4) suivantes s'appliquent : $E \left(T{1}^{H}\right) > E \left(T{1}^{E}\right)$ $E \left(T{1}^{E}\right) > E \left(T{1}^{P}\right)$

9. Dispositif électroluminescent organique selon une ou plusieurs des revendications 1 à 8, dans lequel chaque matériau TADF E^{B}
(i) est **caractérisé en ce qu'**il présente une valeur ΔE_{ST}, qui correspond à la différence d'énergie entre le niveau d'énergie d'état singulet excité le plus bas E(S1^{E}) et le niveau d'énergie d'état triplet excité le plus bas E(T1^{E}), de moins de 0,4 eV ; et
(ii) affiche un rendement quantique de photoluminescence (PLQY) supérieur à 30 %.

10. Dispositif électroluminescent organique selon une ou plusieurs des revendications 1 à 9, dans lequel l'au moins un matériau de phosphorescence P^{B} présente une durée de vie à l'état excité τ(P^{B}) égale ou plus courte que 50 µs, de préférence dans lequel chaque matériau de phosphorescence P^{B} présente une durée de vie à l'état excité τ(P^{B}) égale ou plus courte que 50 µs.

11. Dispositif électroluminescent organique selon une ou plusieurs des revendications 1 à 10, dans lequel l'au moins un matériau de phosphorescence P^{B} présente une durée de vie à l'état excité τ(P^{B}) égale ou plus courte que 10 µs, de préférence dans lequel chaque matériau de phosphorescence P^{B} présente une durée de vie à l'état excité τ(P^{B}) égale ou plus courte que 10 µs.

12. Dispositif électroluminescent organique selon une ou plusieurs des revendications 1 à 11, dans lequel les une ou plusieurs sous-couches à elles toutes comprennent ou sont constituées de :
(i) 30 à 99,8 % en poids d'un ou plusieurs composés hôtes H^{B} ;
(ii) 0,1 à 30 % en poids d'un ou plusieurs matériaux de phosphorescence P^{B} ; et
(iii) 0,1 à 10 % en poids d'un ou plusieurs émetteurs de faible FWHM S^{B} ; et éventuellement
(iv) 0 à 69,8 % en poids d'un ou plusieurs matériaux TADF E^{B} ; et éventuellement
(v) 0 à 69,8 % en poids d'un ou plusieurs solvants.

13. Dispositif électroluminescent organique selon une ou plusieurs des revendications 1 à 12, dans lequel l'au moins une couche émettrice de lumière B, de préférence chaque couche émettrice de lumière B, est composée exactement d'une (sous-)couche.

14. Procédé pour la génération de lumière, comprenant les étapes de :
(i) fourniture d'un dispositif électroluminescent organique selon l'une quelconque des revendications 1 à 13 ; et
(ii) application d'un courant électrique audit dispositif électroluminescent organique.

15. Procédé selon la revendication 14, dans lequel le procédé est destiné à générer de la lumière dans une plage de longueurs d'onde sélectionnée parmi l'une des plages de longueurs d'onde suivantes :
(i) de 510 nm à 550 nm, ou
(ii) de 440 nm à 470 nm, ou
(iii) de 610 nm à 665 nm.
